# EUROPEAN PATENT APPLICATION

(11) **EP 4 243 102 A1**
(43) Date of publication of application: **13.09.2023**
(21) Application number: 22796154.7
(22) Date of filing: 27.04.2022
(51) Int. Cl.: H01L 51/00, H01L 51/50, C09K 11/06

(54) **ORGANIC LIGHT-EMITTING DEVICE**

(30) Priority: 27.04.2021 KR 20210054555
(71) Applicant: Lg Chem, Ltd., Seoul 07336 (KR)
(72) Inventor: KIM, Minjun, Daejeon 34122 (KR); LEE, Dong Hoon, Daejeon 34122 (KR); SUH, Sang Duk, Daejeon 34122 (KR); KIM, Young Seok, Daejeon 34122 (KR); KIM, Donghee, Daejeon 34122 (KR); OH, Joongsuk, Daejeon 34122 (KR); LEE, Da Jung, Daejeon 34122 (KR)
(74) Representative: Hoffmann Eitle
(86) International application number: PCT/KR2022/006056
(87) International publication number: WO 2022/231322

(57) **Abstract**

The present disclosure provides an organic light emitting device having improved driving voltage, efficiency and lifetime.

## Description

### [TECHNICAL FIELD]

### CROSS-REFERENCE TO RELATED APPLICATION(S)

This application claims the benefit of Korean Patent Application No. 10-2021-0054555 filed on April 27, 2021 and Korean Patent Application No. 10-2022-0052257 filed on April 27, 2022 in the Korean Intellectual Property Office, the contents of which are incorporated herein by reference in their entirety.

The present disclosure relates to relates to an organic light emitting device having improved driving voltage, efficiency and lifetime.

### [BACKGROUND ART]

In general, an organic light emitting phenomenon refers to a phenomenon where electric energy is converted into light energy by using an organic material. The organic light emitting device using the organic light emitting phenomenon has characteristics such as a wide viewing angle, an excellent contrast, a fast response time, an excellent luminance, driving voltage and response speed, and thus many studies have proceeded.

The organic light emitting device generally has a structure which comprises an anode, a cathode, and an organic material layer interposed between the anode and the cathode. The organic material layer frequently has a multilayered structure that comprises different materials in order to enhance efficiency and stability of the organic light emitting device, and for example, the organic material layer may be formed of a hole injection layer, a hole transport layer, a light emitting layer, an electron transport layer, an electron injection layer and the like. In the structure of the organic light emitting device, if a voltage is applied between two electrodes, the holes are injected from an anode into the organic material layer and the electrons are injected from the cathode into the organic material layer, and when the injected holes and electrons meet each other, an exciton is formed, and light is emitted when the exciton falls to a ground state again.

There is a continuing need for the development of a new material for an organic material used in the organic light emitting device as described above.

### [Prior Art Literature]

### [Patent Literature]

(Patent Literature 1) Korean Unexamined Patent Publication No. 10-2000-0051826

### [DETAILED DESCRIPTION OF THE INVENTION]

### [Technical Problem]

It is an object of the present disclosure to provide an organic light emitting device having improved driving voltage, efficiency and lifetime.

### [Technical Solution]

Provided herein is the following organic light emitting device.

An organic light emitting device including an anode, a cathode, and a light emitting layer interposed between the anode and the cathode,
wherein the light emitting layer includes a compound represented by the following Chemical Formula 1 and a compound represented by the following Chemical Formula 2: 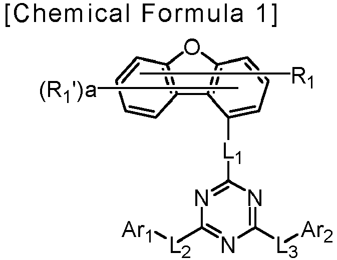 in the Chemical Formula 1,
Ar₁ and Ar₂ are each independently a substituted or unsubstituted C₆₋₆₀ aryl; or a substituted or unsubstituted C₂₋₆₀ heteroaryl containing at least one selected from the group consisting of N, O and S.
L₁ to L₃ are each independently a single bond; or a substituted or unsubstituted C₆₋₆₀ arylene,
each R₁ is independently a substituted or unsubstituted C₆₋₆₀ aryl; or a substituted or unsubstituted C₂₋₆₀ heteroaryl containing at least one selected from the group consisting of N, O and S,
each R₁' is independently hydrogen or deuterium, and
   a is an integer of 0 to 6, 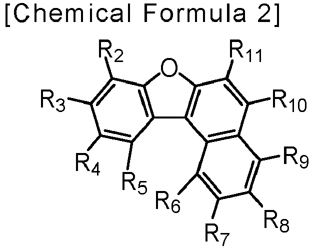 in the Chemical Formula 2,
   R₂ to R₆ and R₉ to R₁₁ are each independently hydrogen or deuterium, any one of R₇ and R₈ is 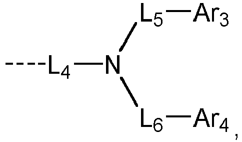 the rest is hydrogen or deuterium,
   Ar₃ and Ar₄ are each independently a substituted or unsubstituted C₆₋₆₀ aryl; or a substituted or unsubstituted C₂₋₆₀ heteroaryl containing at least one selected from the group consisting of N, O and S,
   L₄ is a substituted or unsubstituted phenylene, a substituted or unsubstituted biphenyldiyl, or a substituted or unsubstituted naphthalenediyl, and
   L₅ and L₆ are each independently a single bond; a substituted or unsubstituted C₆₋₆₀ arylene; or a substituted or unsubstituted C₂₋₆₀ heteroarylene containing at least one selected from the group consisting of N, O and S.

### [Advantageous Effects]

The above-mentioned organic light emitting device includes the compound represented by Chemical Formula 1 and the compound represented by Chemical Formula 2 in the light emitting layer, and thus can improve the efficiency, achieve low driving voltage and/or improve lifetime characteristics in the organic light emitting device.

### [BRIEF DESCRIPTION OF THE DRAWINGS]

FIG. 1 shows an example of an organic light emitting device comprising a substrate 1, an anode 2, a light emitting layer 3, and a cathode 4.
FIG. 2 shows an example of an organic light emitting device comprising a substrate 1, an anode 2, a hole injection layer 5, a hole transport layer 6, an electron blocking layer 7, a light emitting layer 3, a hole blocking layer 8, an electron injection and transport layer 9, and a cathode 4.

### [DETAILED DESCRIPTION OF THE EMBODIMENTS]

Hereinafter, embodiments of the present disclosure will be described in more detail to facilitate understanding of the invention.

As used herein, the notation 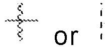 means a bond linked to another substituent group.

As used herein, the term "substituted or unsubstituted" means being unsubstituted or substituted with one or more substituents selected from the group consisting of deuterium; a halogen group; a nitrile group; a nitro group; a hydroxy group; a carbonyl group; an ester group; an imide group; an amino group; a phosphine oxide group; an alkoxy group; an aryloxy group; an alkylthioxy group; an arylthioxy group; an alkylsulfoxy group; an arylsulfoxy group; a silyl group; a boron group; an alkyl group; a cycloalkyl group; an alkenyl group; an aryl group; an aralkyl group; an aralkenyl group; an alkylaryl group; an alkylamine group; an aralkylamine group; a heteroarylamine group; an arylamine group; an arylphosphine group; and a heterocyclic group containing at least one of N, O and S atoms, or being unsubstituted or substituted with a substituent to which two or more substituents of the above-exemplified substituents are connected. For example, "a substituent in which two or more substituents are connected" may be a biphenyl group. Namely, a biphenyl group may be an aryl group, or it may be interpreted as a substituent in which two phenyl groups are connected.

In the present disclosure, the carbon number of a carbonyl group is not particularly limited, but is preferably 1 to 40. Specifically, the carbonyl group may be a compound having the following structural formulas, but is not limited thereto.

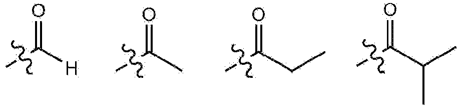

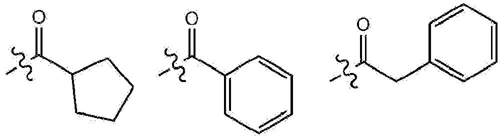

In the present disclosure, an ester group may have a structure in which oxygen of the ester group may be substituted by a straight-chain, branched-chain, or cyclic alkyl group having 1 to 25 carbon atoms, or an aryl group having 6 to 25 carbon atoms. Specifically, the ester group may be a compound having the following structural formulas, but is not limited thereto.

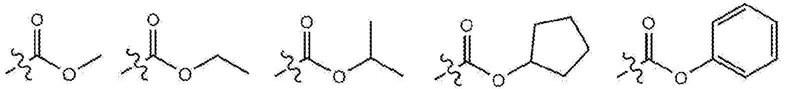

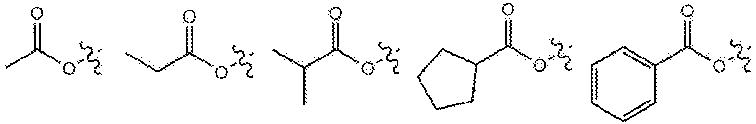

In the present disclosure, the carbon number of an imide group is not particularly limited, but is preferably 1 to 25. Specifically, the imide group may be a compound having the following structural formulas, but is not limited thereto.

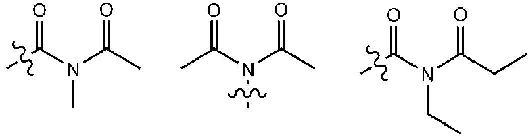

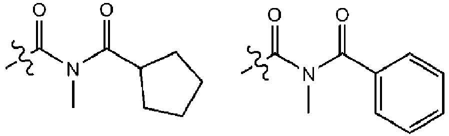

In the present disclosure, a silyl group specifically includes a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group and the like, but is not limited thereto.

In the present disclosure, a boron group specifically includes a trimethylboron group, a triethylboron group, a t-butyldimethylboron group, a triphenylboron group, and a phenylboron group, but is not limited thereto.

In the present disclosure, examples of a halogen group include fluorine, chlorine, bromine, or iodine.

In the present disclosure, the alkyl group may be straight-chain or branched-chain, and the carbon number thereof is not particularly limited, but is preferably 1 to 40. According to one embodiment, the carbon number of the alkyl group is 1 to 20. According to another embodiment, the carbon number of the alkyl group is 1 to 10. According to another embodiment, the carbon number of the alkyl group is 1 to 6. Specific examples of the alkyl group include methyl, ethyl, propyl, n-propyl, isopropyl, butyl, n-butyl, isobutyl, tert-butyl, sec-butyl, 1-methylbutyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 2-methylpentyl, 4-methylhexyl, 5-methylhexyl, and the like, but are not limited thereto.

In the present disclosure, the alkenyl group may be straight-chain or branched-chain, and the carbon number thereof is not particularly limited, but is preferably 2 to 40. According to one embodiment, the carbon number of the alkenyl group is 2 to 20. According to another embodiment, the carbon number of the alkenyl group is 2 to 10. According to still another embodiment, the carbon number of the alkenyl group is 2 to 6. Specific examples thereof include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group, and the like, but are not limited thereto.

In the present disclosure, a cycloalkyl group is not particularly limited, but the carbon number thereof is preferably 3 to 60. According to one embodiment, the carbon number of the cycloalkyl group is 3 to 30. According to another embodiment, the carbon number of the cycloalkyl group is 3 to 20. According to still another embodiment, the carbon number of the cycloalkyl group is 3 to 6. Specific examples thereof include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl, and the like, but are not limited thereto.

In the present disclosure, an aryl group is not particularly limited, but the carbon number thereof is preferably 6 to 60, and it may be a monocyclic aryl group or a polycyclic aryl group. According to one embodiment, the carbon number of the aryl group is 6 to 30. According to one embodiment, the carbon number of the aryl group is 6 to 20. The aryl group may be a phenyl group, a biphenyl group, a terphenyl group or the like as the monocyclic aryl group, but is not limited thereto. The polycyclic aryl group includes a naphthyl group, an anthracenyl group, a phenanthrenyl group, a pyrenyl group, a perylenyl group, a chrysenyl group, or the like, but is not limited thereto.

In the present disclosure, the fluorenyl group may be substituted, and two substituents may be linked with each other to form a spiro structure. In the case where the fluorenyl group is substituted, 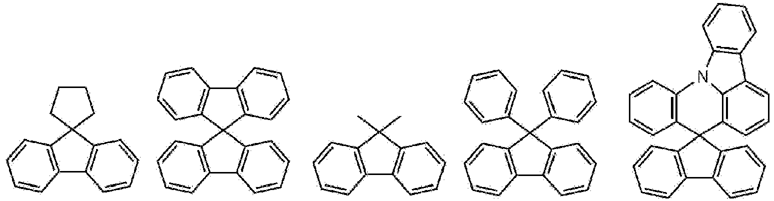 and the like can be formed. However, the structure is not limited thereto.

In the present disclosure, a heterocyclic group is a heterocyclic group containing one or more of O, N, Si and S as a heteroatom, and the carbon number thereof is not particularly limited, but is preferably 2 to 60. Examples of the heterocyclic group include a thiophene group, a furan group, a pyrrole group, an imidazole group, a thiazole group, an oxazol group, an oxadiazol group, a triazol group, a pyridyl group, a bipyridyl group, a pyrimidyl group, a triazine group, an acridyl group, a pyridazine group, a pyrazinyl group, a quinolinyl group, a quinazoline group, a quinoxalinyl group, a phthalazinyl group, a pyridopyrimidinyl group, a pyridopyrazinyl group, a pyrazinopyrazinyl group, an isoquinoline group, an indole group, a carbazole group, a benzoxazole group, a benzoimidazole group, a benzothiazol group, a benzocarbazole group, a benzothiophene group, a dibenzothiophene group, a benzofuranyl group, a phenanthroline group, an isoxazolyl group, a thiadiazolyl group, a phenothiazinyl group, a dibenzofuranyl group, and the like, but are not limited thereto.

In the present disclosure, the aryl group in the aralkyl group, the aralkenyl group, the alkylaryl group and the arylamine group is the same as the aforementioned examples of the aryl group. In the present disclosure, the alkyl group in the aralkyl group, the alkylaryl group and the alkylamine group is the same as the aforementioned examples of the alkyl group. In the present disclosure, the heteroaryl in the heteroarylamine can be applied to the aforementioned description of the heterocyclic group. In the present disclosure, the alkenyl group in the aralkenyl group is the same as the aforementioned examples of the alkenyl group. In the present disclosure, the aforementioned description of the aryl group may be applied except that the arylene is a divalent group. In the present disclosure, the aforementioned description of the heterocyclic group can be applied except that the heteroarylene is a divalent group. In the present disclosure, the aforementioned description of the aryl group or cycloalkyl group can be applied except that the hydrocarbon ring is not a monovalent group but formed by combining two substituent groups. In the present disclosure, the aforementioned description of the heterocyclic group can be applied, except that the heterocycle is not a monovalent group but formed by combining two substituent groups.

In the present disclosure, the compound represented by '[structural formula] _{Dn}' means a compound in which n hydrogens are substituted with deuterium among compounds having the corresponding 'structural formula'.

Hereinafter, the present disclosure will be described in detail for each configuration.

### Anode and Cathode

An anode and a cathode used in the present disclosure mean electrodes used in an organic light emitting device.

As the anode material, generally, a material having a large work function is preferably used so that holes can be smoothly injected into the organic material layer. Specific examples of the anode material include metals such as vanadium, chrome, copper, zinc, and gold, or an alloy thereof; metal oxides such as zinc oxides, indium oxides, indium tin oxides (ITO), and indium zinc oxides (IZO); a combination of metals and oxides, such as ZnO:Al or SNO₂:Sb; conductive polymers such as poly(3-methylthiophene), poly[3,4-(ethylene-1,2-dioxy)thiophene](PEDOT), polypyrrole, and polyaniline, and the like, but are not limited thereto.

As the cathode material, generally, a material having a small work function is preferably used so that electrons can be easily injected into the organic material layer. Specific examples of the cathode material include metals such as magnesium, calcium, sodium, potassium, titanium, indium, yttrium, lithium, gadolinium, aluminum, silver, tin, and lead, or an alloy thereof; a multilayered structure material such as LiF/Al or LiO₂/Al, and the like, but are not limited thereto.

### Hole Injection Layer

The organic light emitting device according to the present disclosure may further include a hole injection layer on the anode, if necessary.

The hole injection layer is a layer for injecting holes from the electrode, and the hole injection material is preferably a compound which has a capability of transporting the holes, thus has a hole injecting effect in the anode and an excellent hole injecting effect to the light emitting layer or the light emitting material, prevents excitons produced in the light emitting layer from moving to an electron injection layer or the electron injection material, and further is excellent in the ability to form a thin film. Further, it is preferable that a HOMO (highest occupied molecular orbital) of the hole injection material is between the work function of the anode material and a HOMO of a peripheral organic material layer.

Specific examples of the hole injection material include metal porphyrine, oligothiophene, an arylamine-based organic material, a hexanitrilehexaazatriphenylene-based organic material, a quinacridone-based organic material, a perylene-based organic material, anthraquinone, polyaniline and polythiophene-based conductive compound, and the like, but are not limited thereto.

### Hole Transport Layer

The organic light emitting device according to the present disclosure may include a hole transport layer on the anode (or on the hole injection layer if the hole injection layer exists), if necessary.

The hole transport layer is a layer that can receive the holes from the anode or the hole injection layer and transport the holes to the light emitting layer, and the hole transport material is suitably a material having large mobility to the holes, which may receive holes from the anode or the hole injection layer and transfer the holes to the light emitting layer.

Specific examples thereof include an arylamine-based organic material, a conductive polymer, a block copolymer in which a conjugate portion and a non-conjugate portion are present together, and the like, but are not limited thereto.

### Electron Blocking Layer

The electron blocking layer is a layer provided between the hole transport layer and the light emitting layer in order to prevent the electrons injected in the cathode from being transferred to the hole transport layer without being recombined in the light emitting layer, which may also be referred to as an electron inhibition layer or an electron stopping layer. The electron blocking layer is preferably a material having a smaller electron affinity than the electron transport layer.

### Light Emitting Layer

The light emitting layer used in the present disclosure is a layer that can emit light in the visible light region by combining holes and electrons transported from the anode and the cathode. Generally, the light emitting layer includes a host material and a dopant material, and in the present disclosure, the compound represented by Chemical Formula 1 and the compound represented by Chemical Formula 2 are included as a host

Preferably, the compound represented by Chemical Formula 1 may be represented by any one of the following Chemical Formula 1-1 and Chemical Formula 1-2: 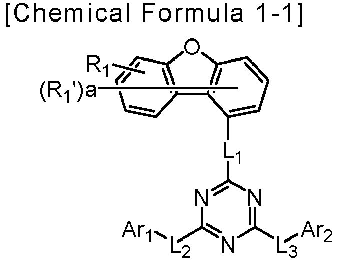 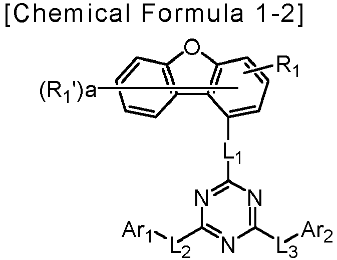 in the Chemical Formula 1-1 and Chemical Formula 1-2,
Ar₁ and Ar₂, L₁ to L₃, R₁, R₁' and a are as defined in Chemical Formula 1.

Preferably, Ar₁ and Ar₂ may be each independently a substituted or unsubstituted C₆₋₂₀ aryl; or a substituted or unsubstituted C₂₋₂₀ heteroaryl containing at least one selected from the group consisting of N, O and S.

More preferably, Ar₁ and Ar₂ may be each independently phenyl, biphenylyl, terphenylyl, naphthyl, phenanthrenyl, dibenzofuranyl, or dibenzothiophenyl, and the hydrogens of Ar₁ and Ar₂ may be each independently unsubstituted or substituted with deuterium.

Preferably, Ar₁ and Ar₂ may be each independently any one selected from the group consisting of:

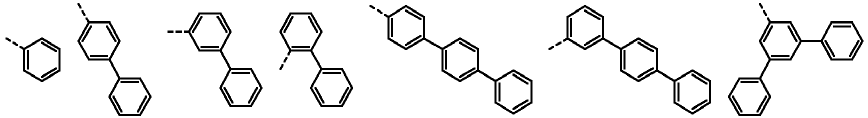

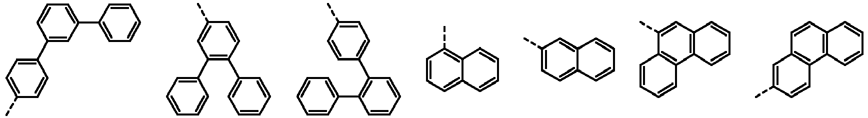

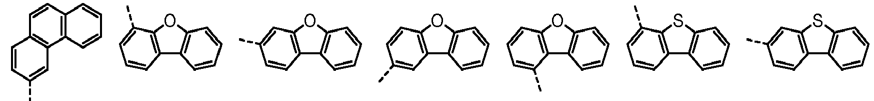

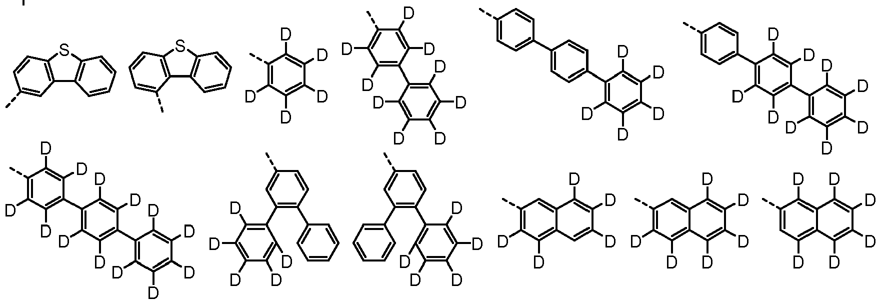

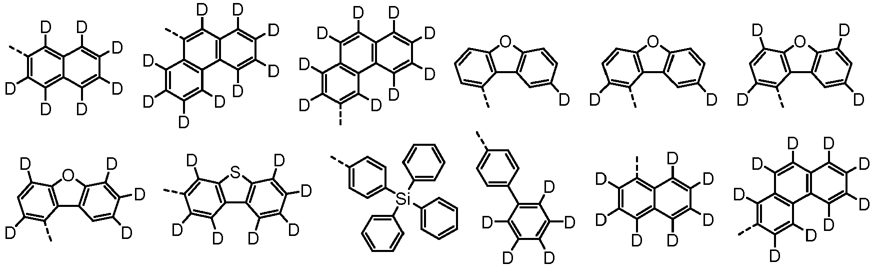

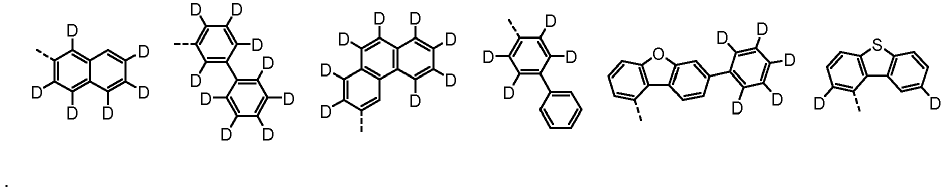

Preferably, L₁ to L₃ may be each independently a single bond; or a substituted or unsubstituted C₆₋₂₀ arylene.

More preferably, L₁ to L₃ may be each independently a single bond, phenylene, biphenyldiyl, or naphthalenediyl, and the hydrogens of L₁ to L₃ may be each independently unsubstituted or substituted with deuterium.

Preferably, L₁ to L₃ may be each independently a single bond, or any one selected from the group consisting of:

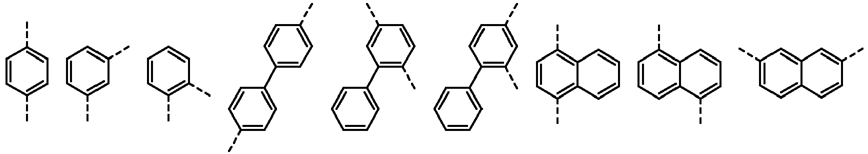

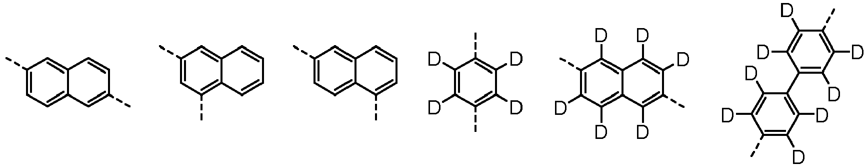

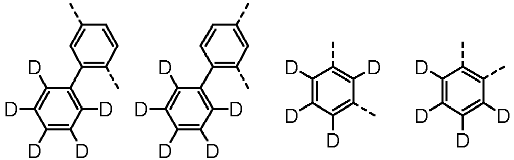

Preferably, R₁ may be a substituted or unsubstituted C₆₋₂₀ aryl; or a substituted or unsubstituted C₂₋₂₀ heteroaryl containing at least one selected from the group consisting of N, O and S.

More preferably, R₁ may be phenyl, biphenylyl, terphenylyl, naphthyl, phenanthrenyl, triphenylenyl, naphthyl phenyl, phenyl naphthyl, fluoranthenyl, dihydroindenyl, dibenzofuranyl, dibenzothiophenyl, benzonaphthofuranyl, or benzonaphthothiophenyl, and the hydrogens of the R₁ may be each independently unsubstituted or substituted with deuterium.

In Chemical Formula 1, a represents the number of R₁', and when a is two or more, two or more R₁'s may be the same as or different from each other.

Representative examples of the compound represented by Chemical Formula 1 are as follows:

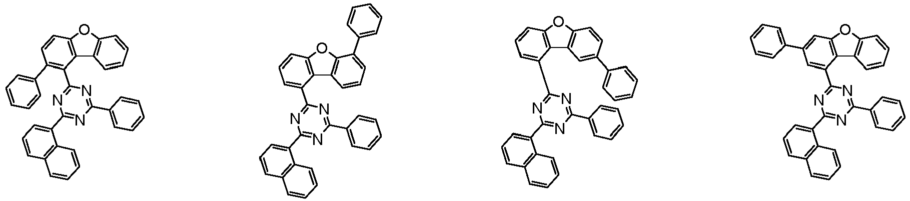

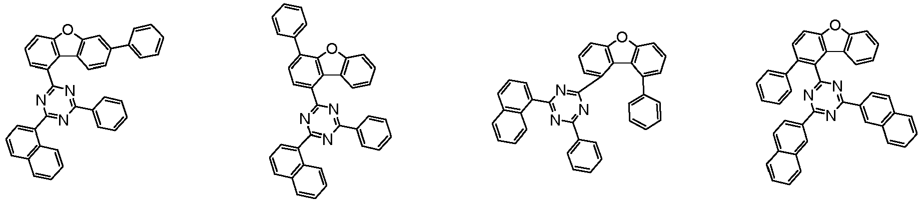

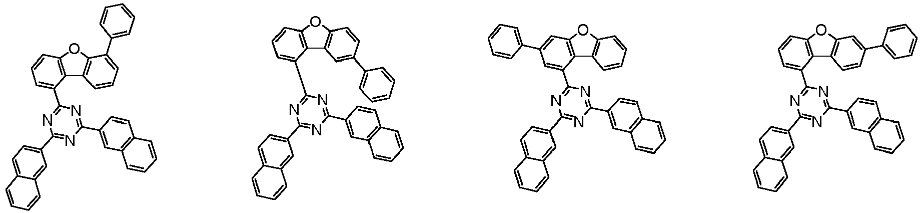

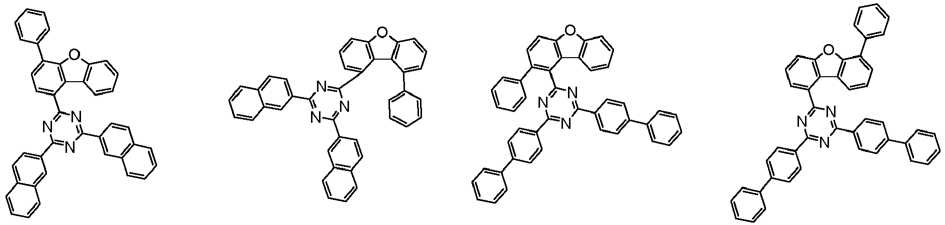

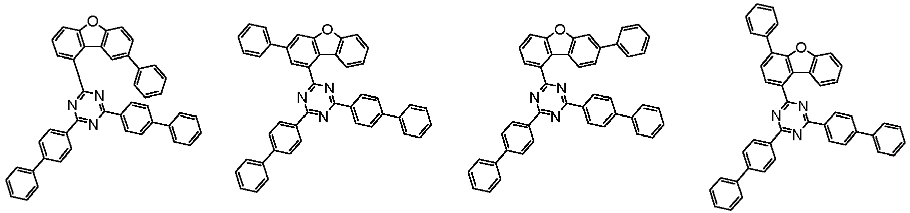

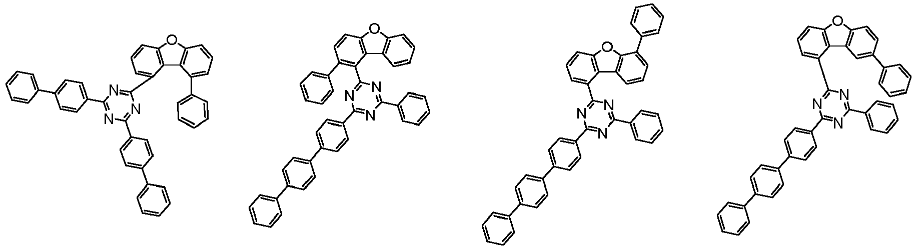

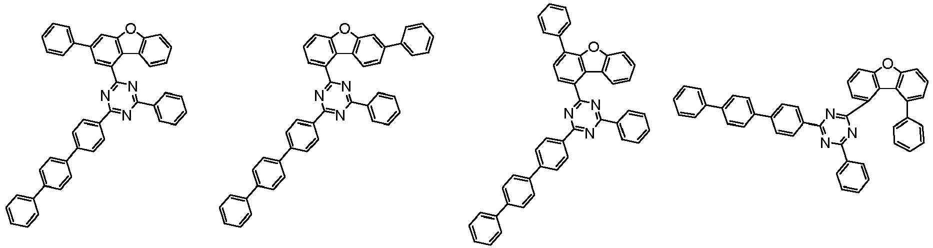

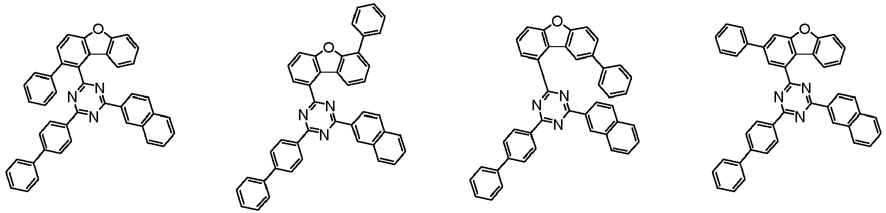

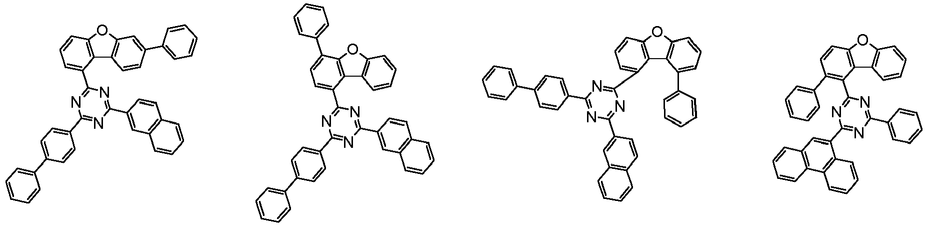

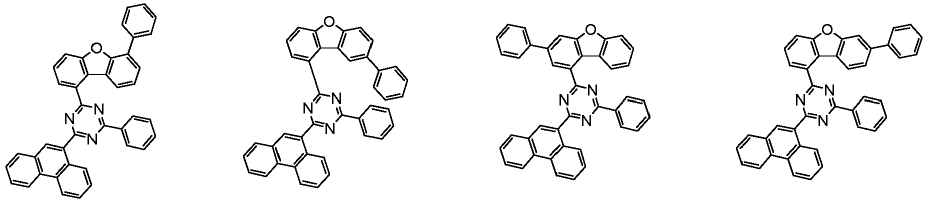

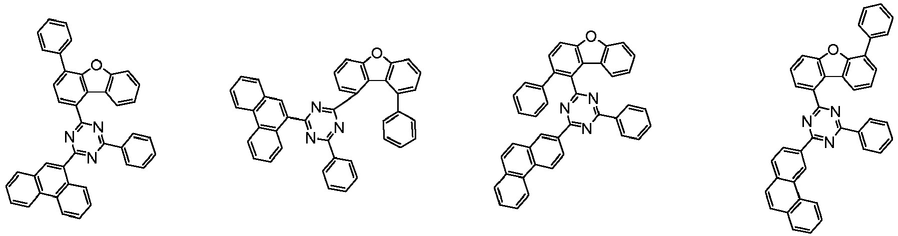

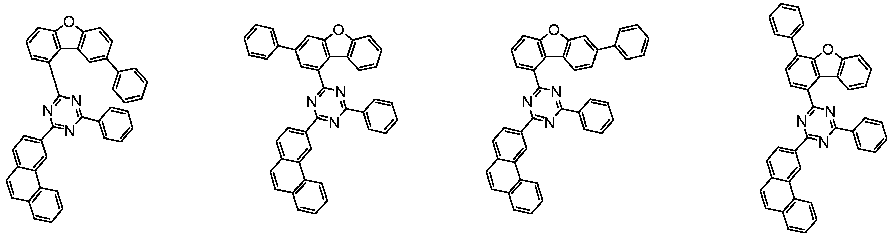

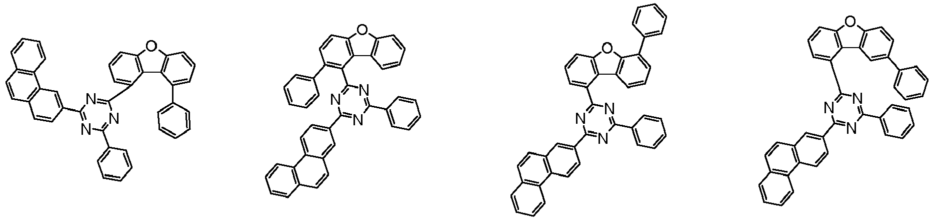

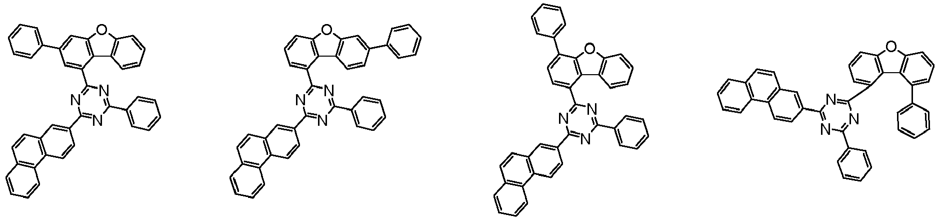

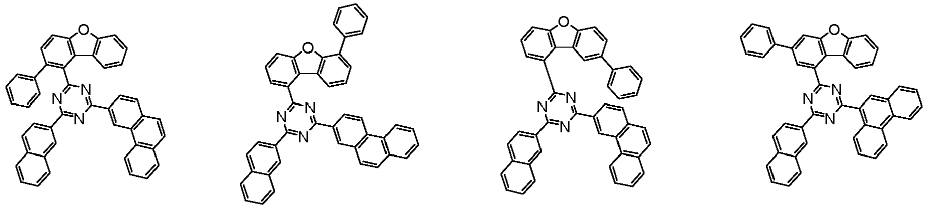

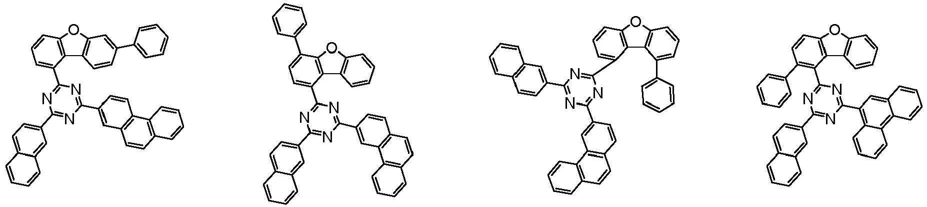

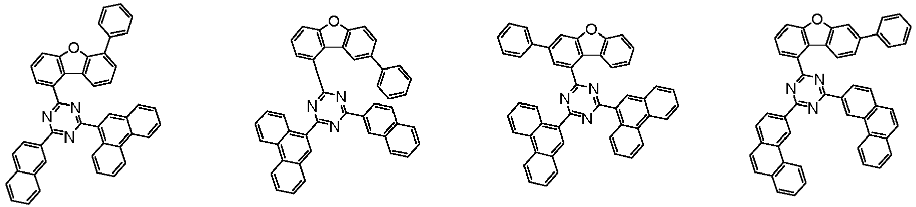

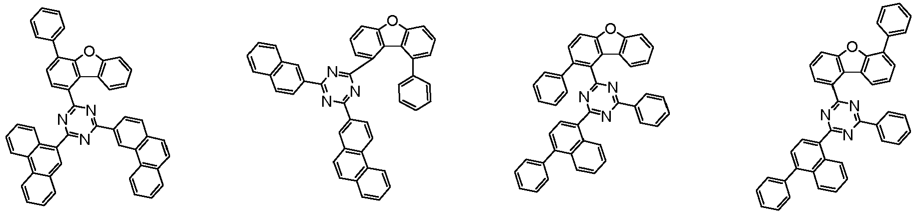

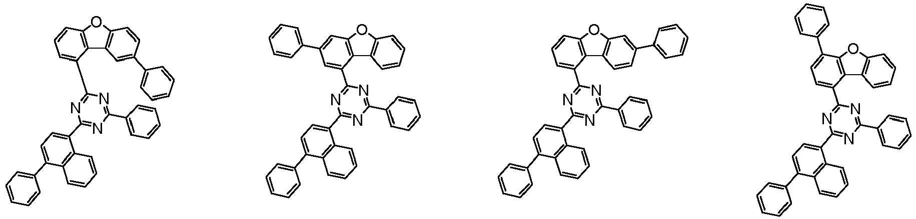

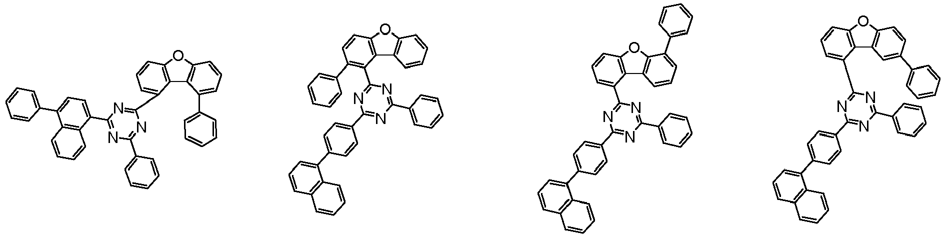

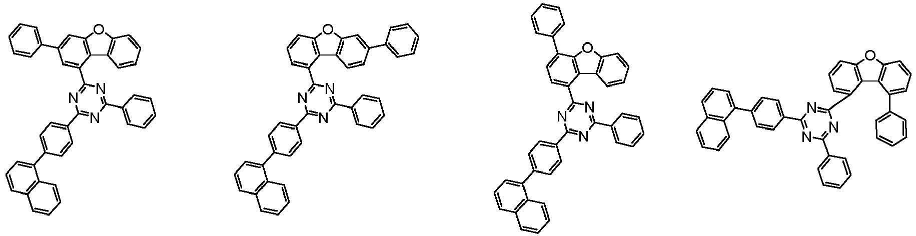

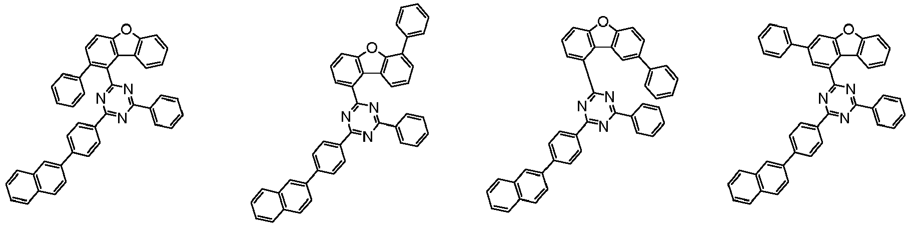

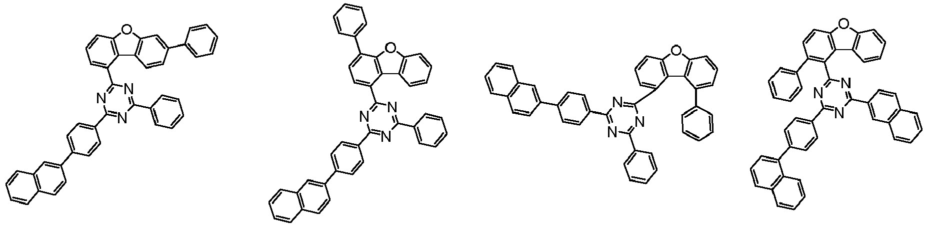

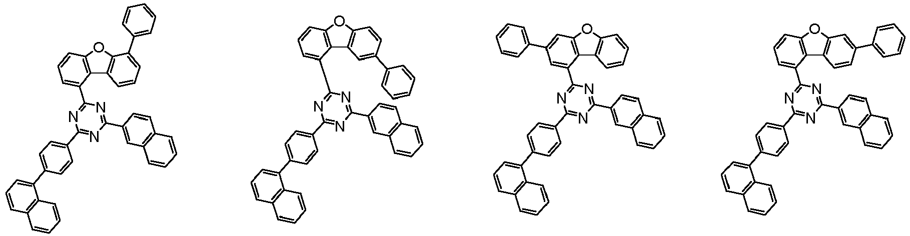

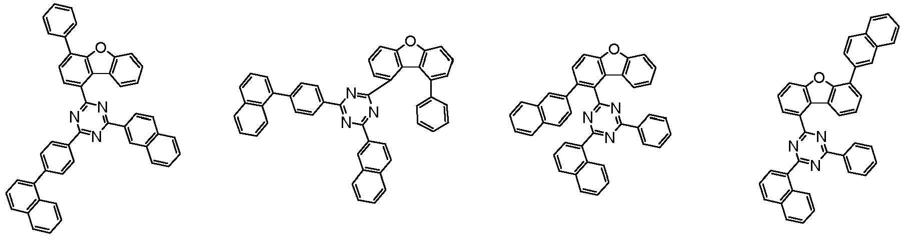

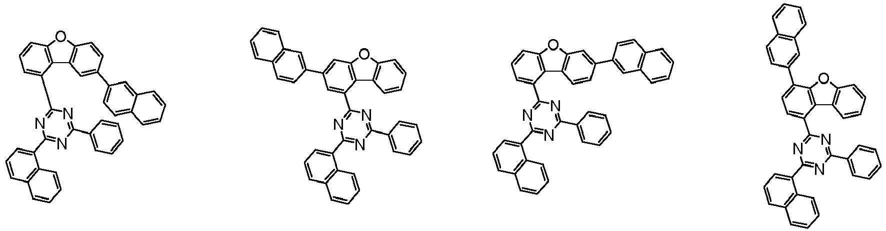

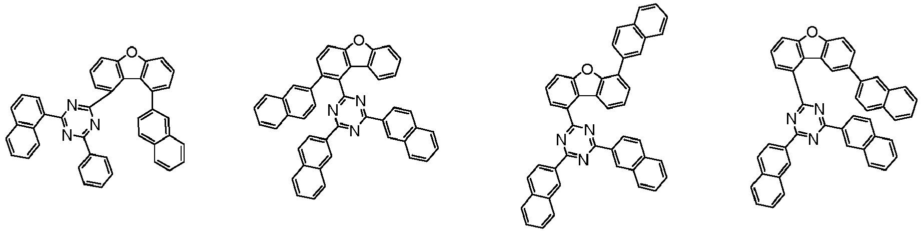

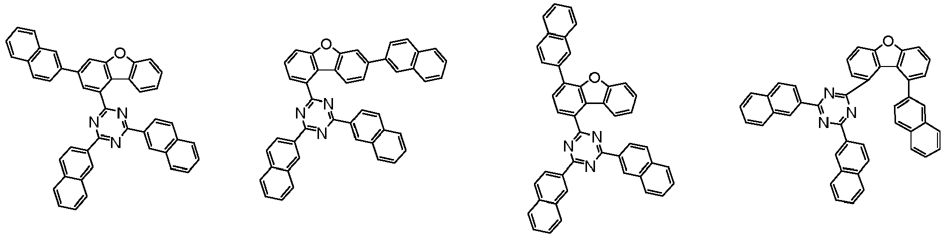

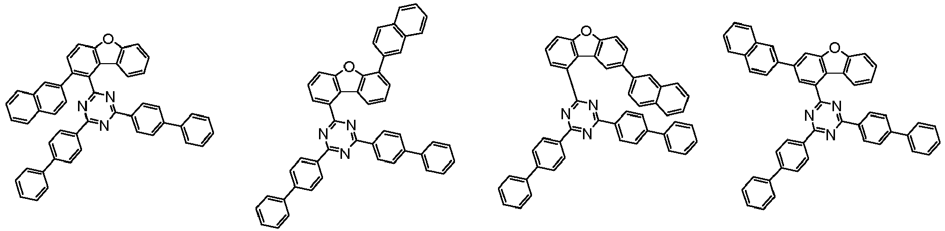

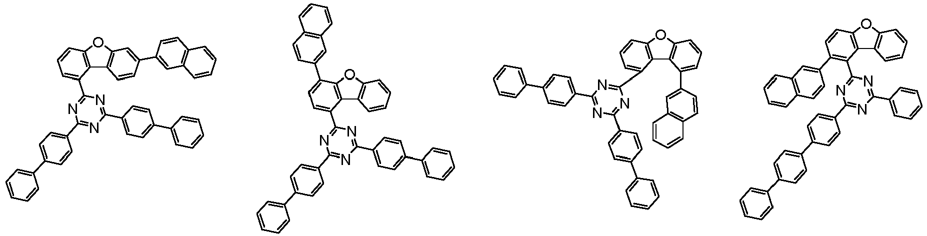

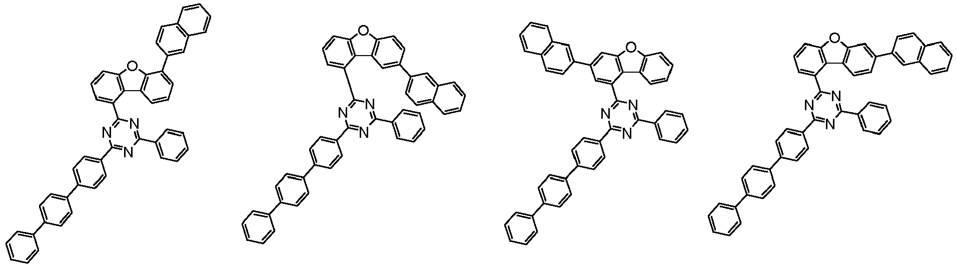

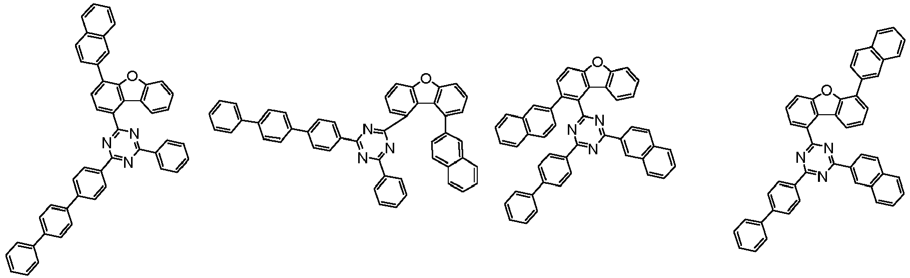

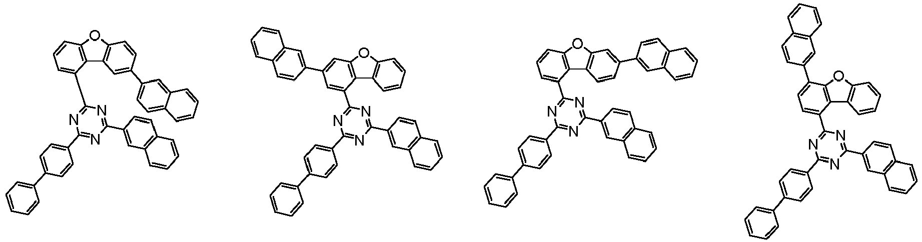

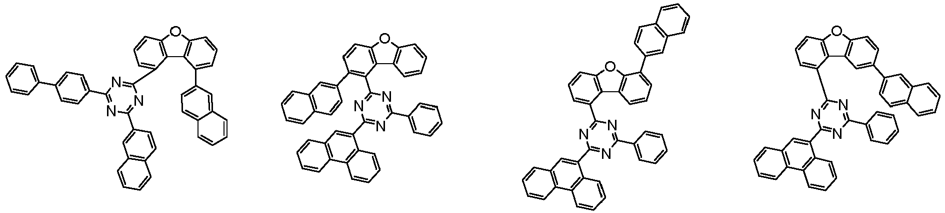

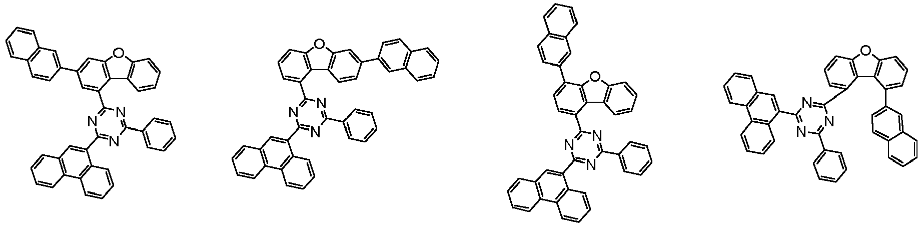

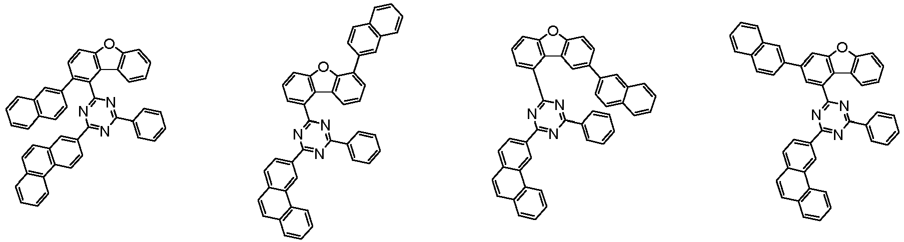

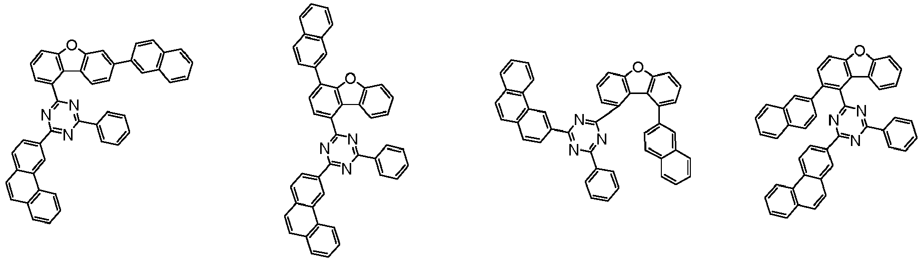

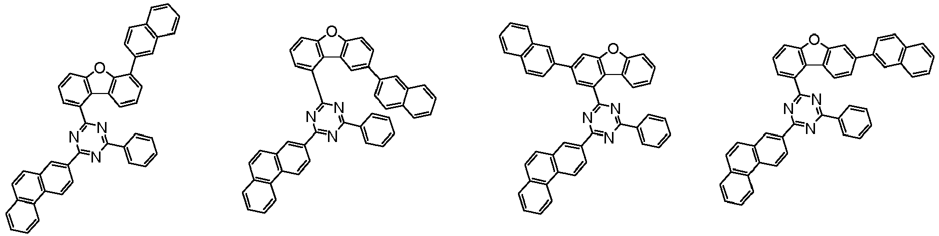

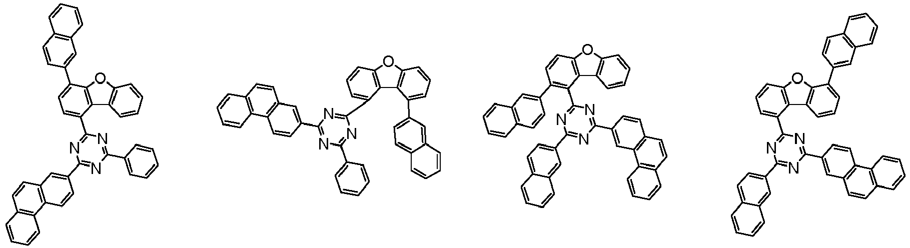

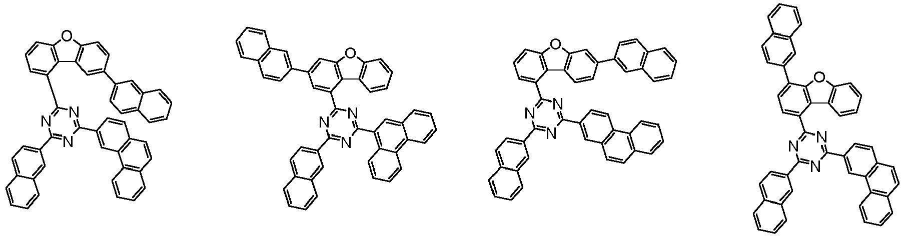

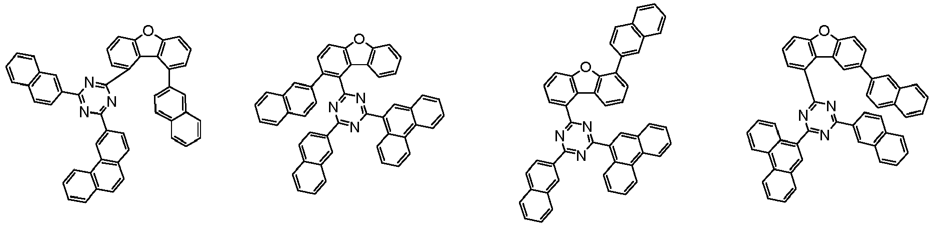

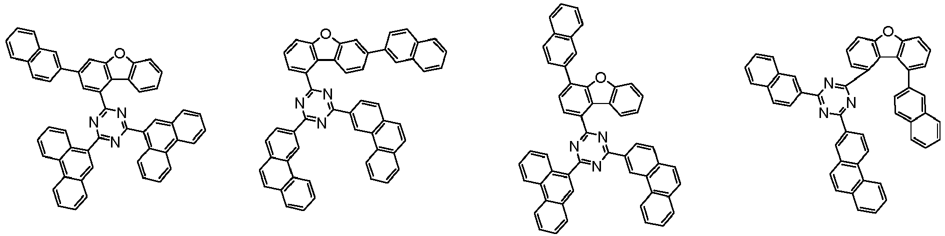

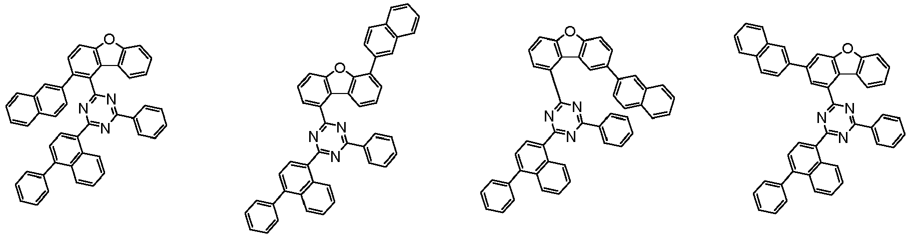

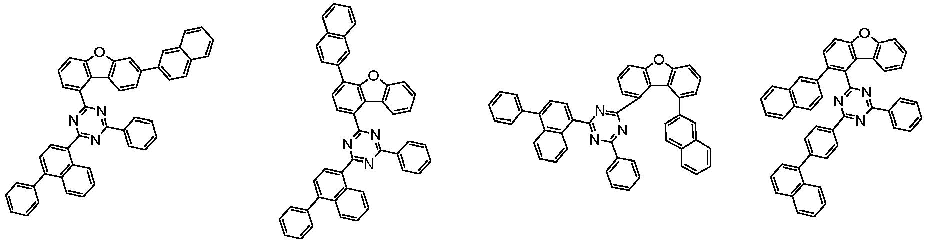

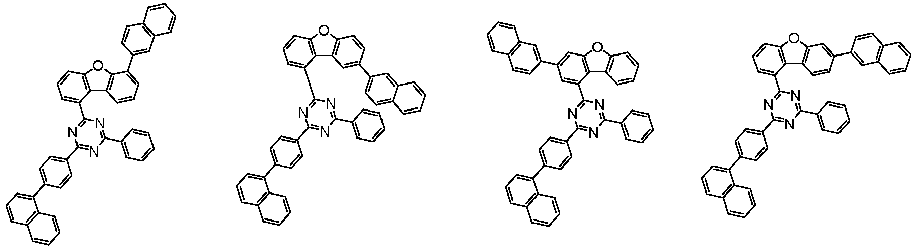

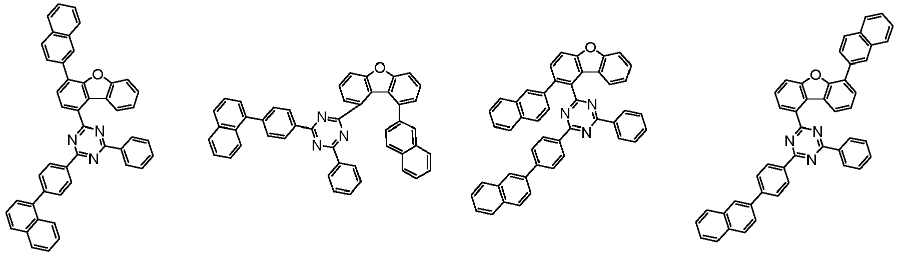

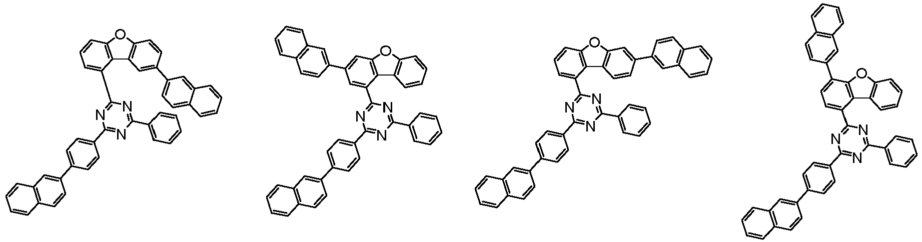

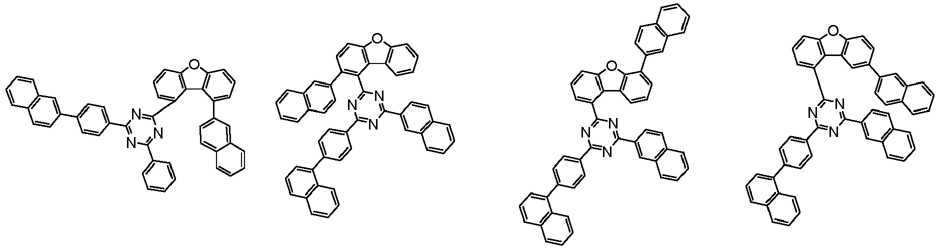

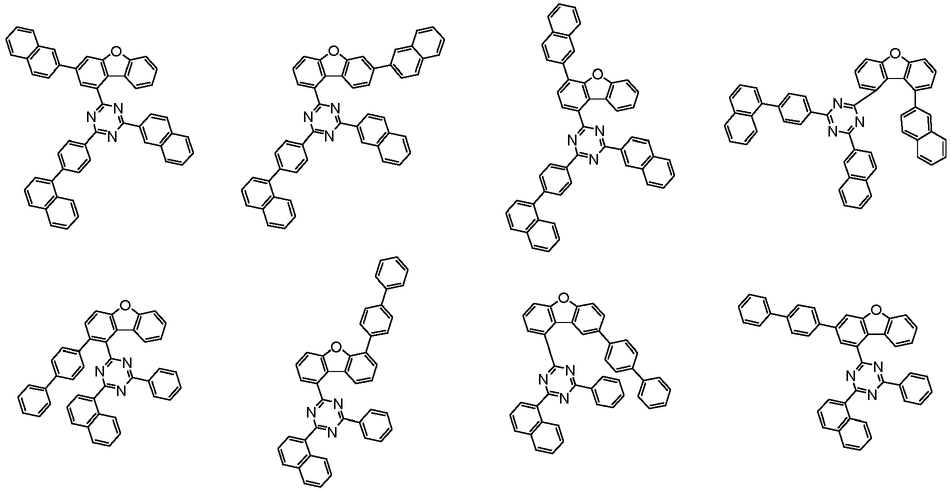

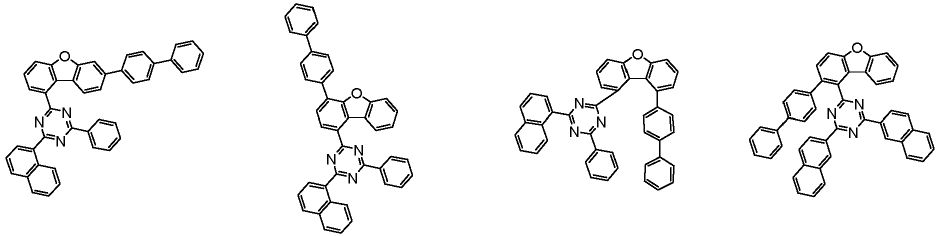

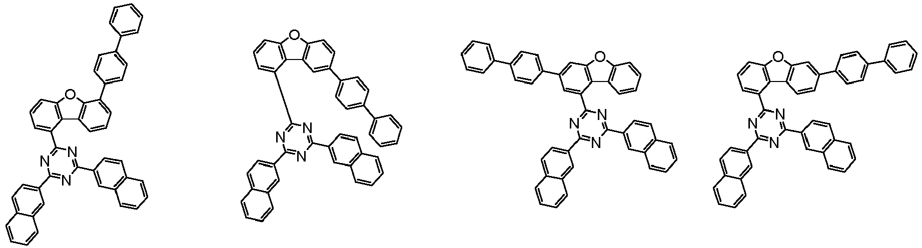

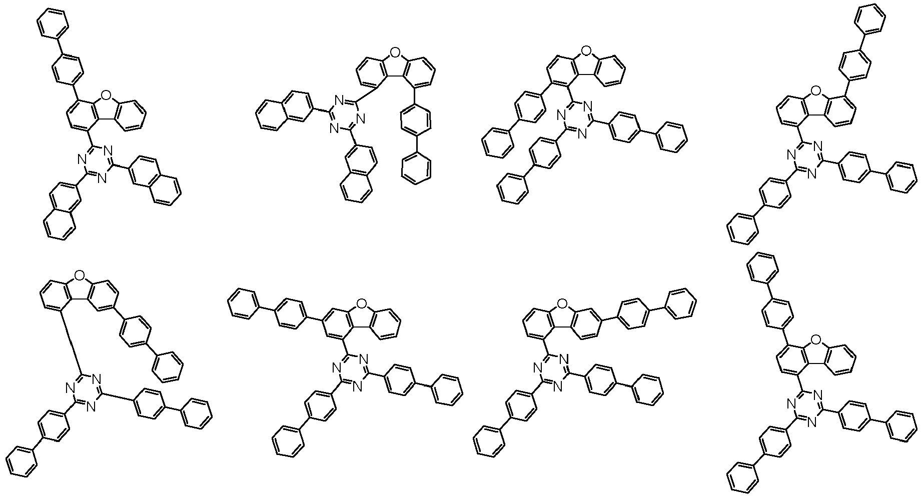

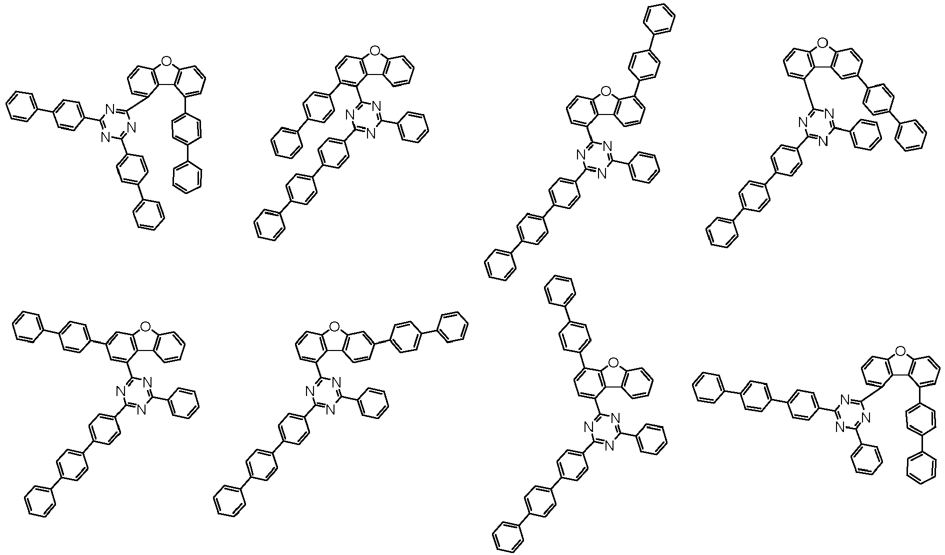

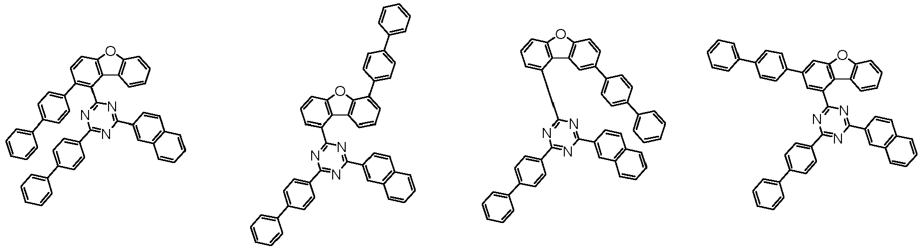

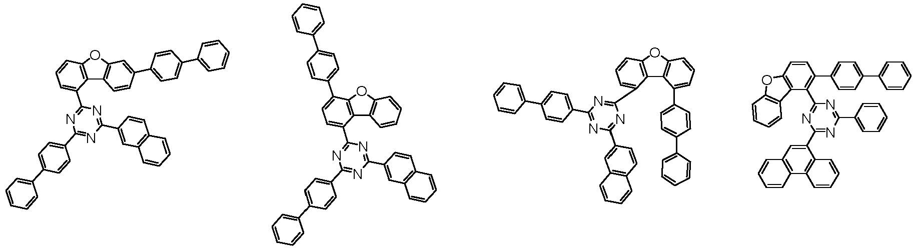

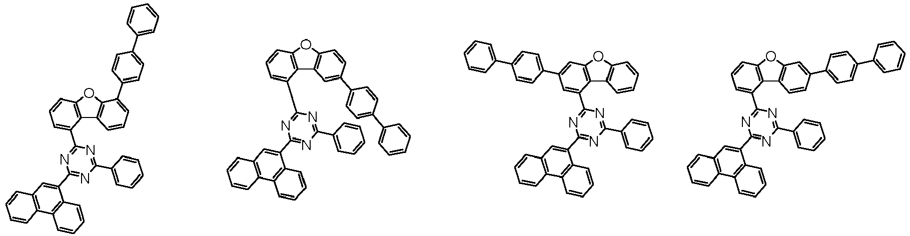

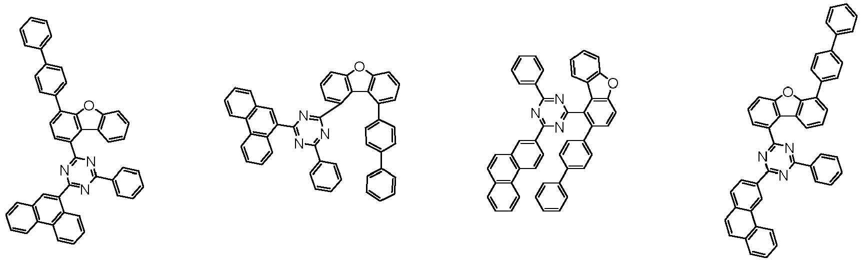

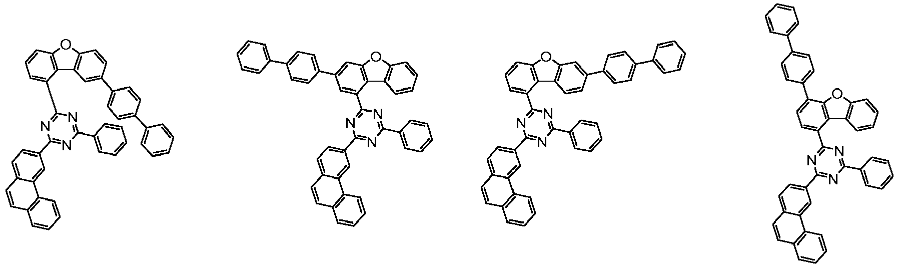

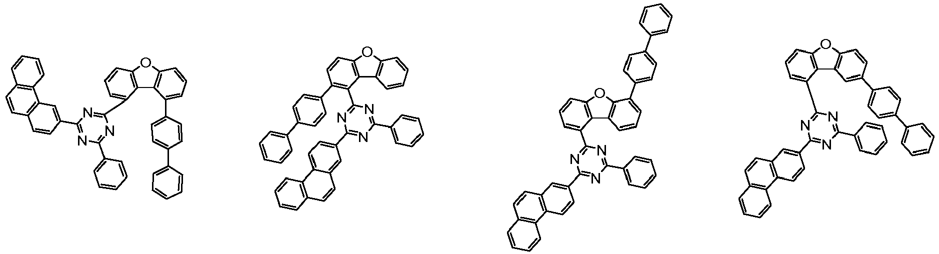

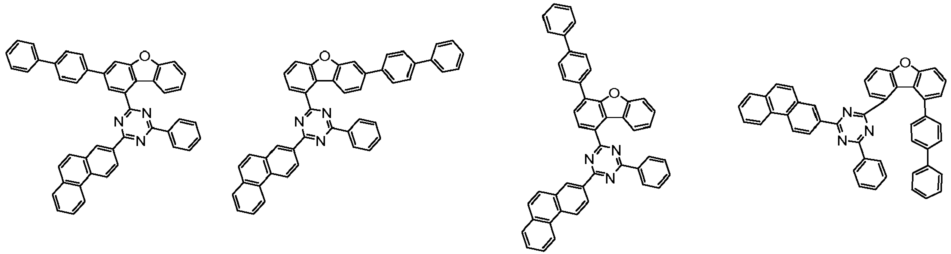

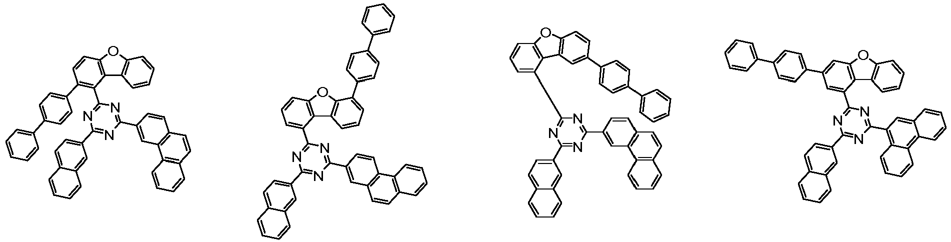

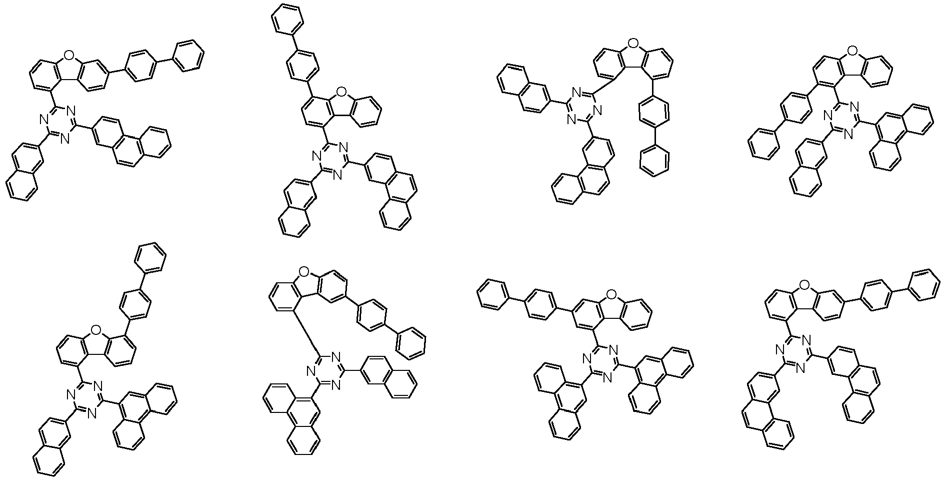

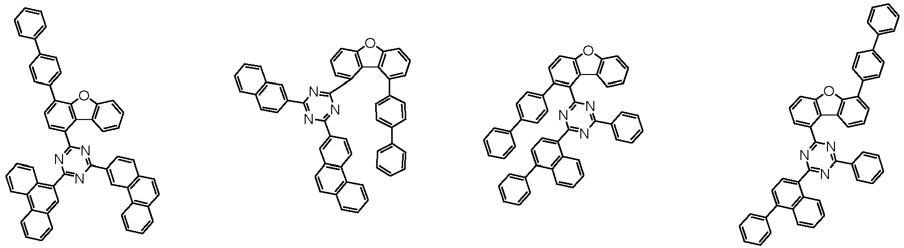

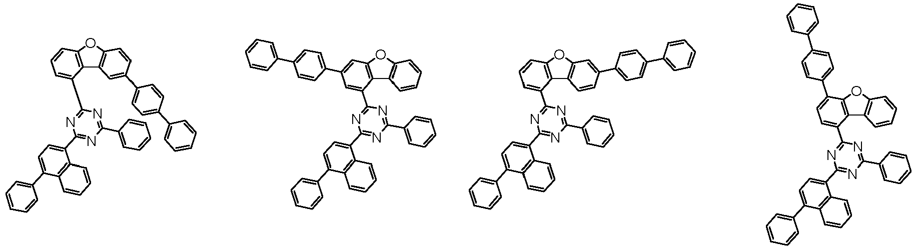

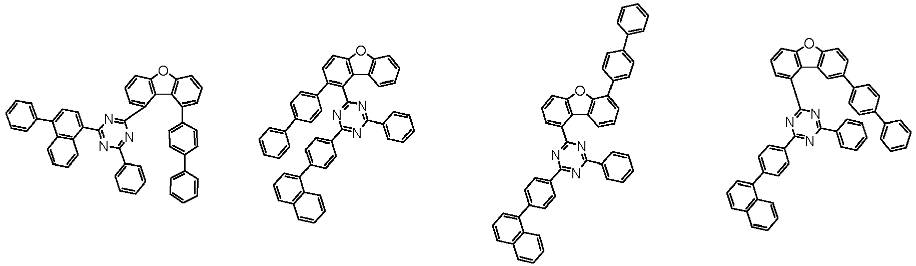

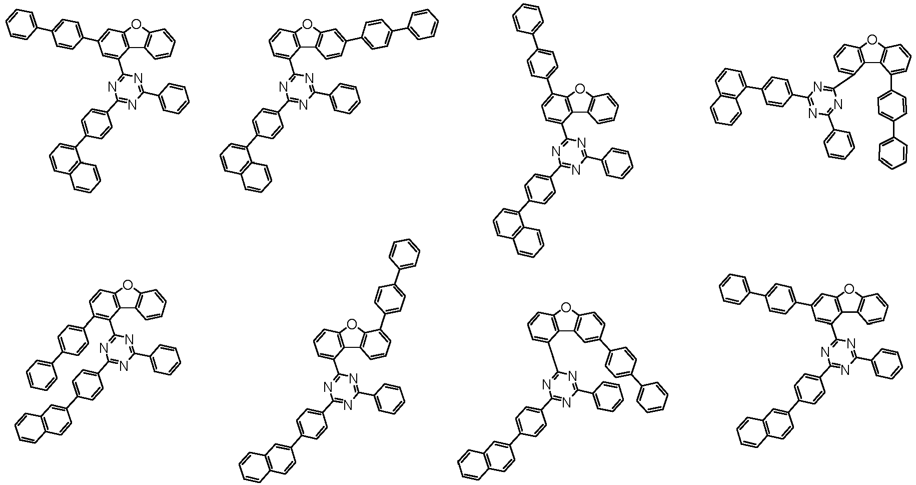

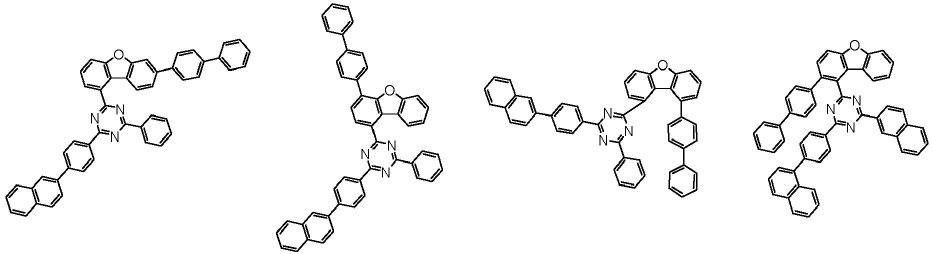

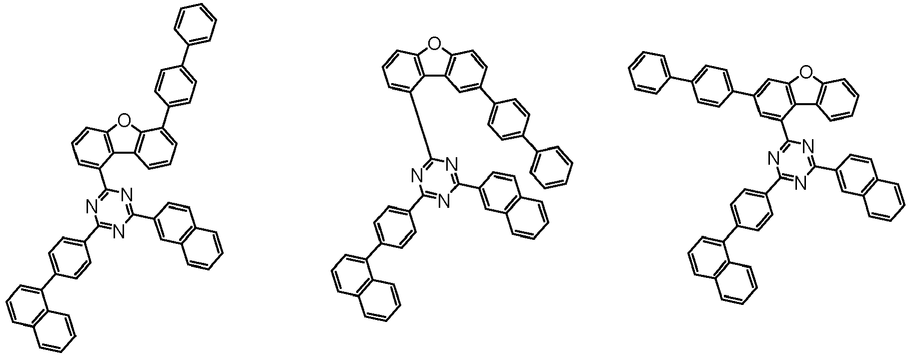

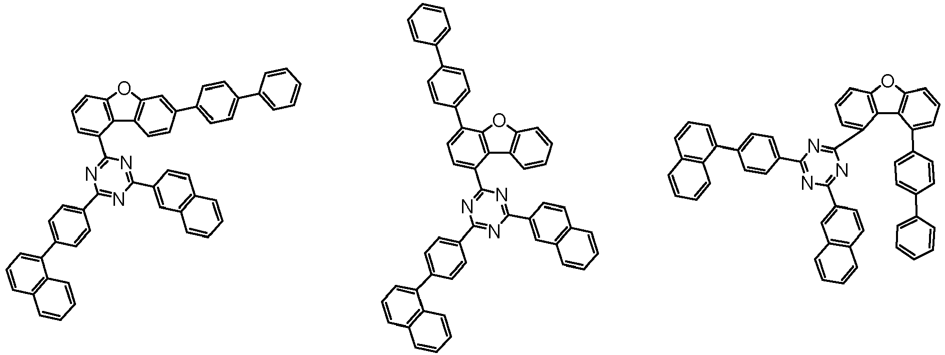

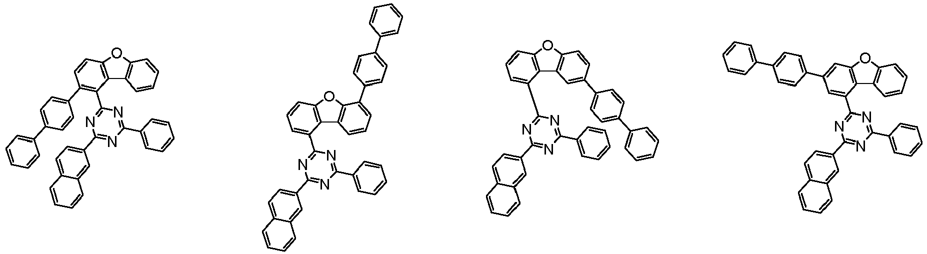

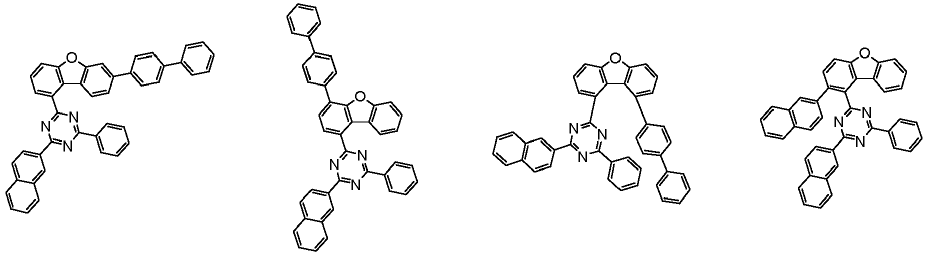

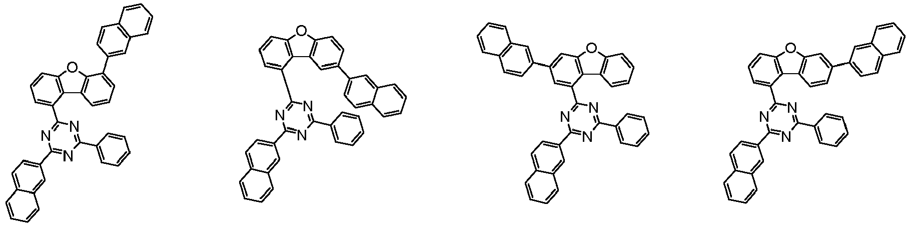

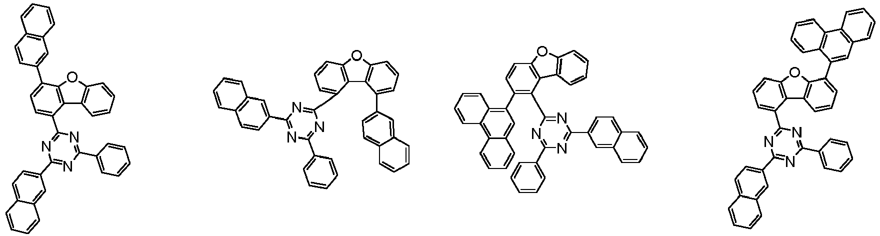

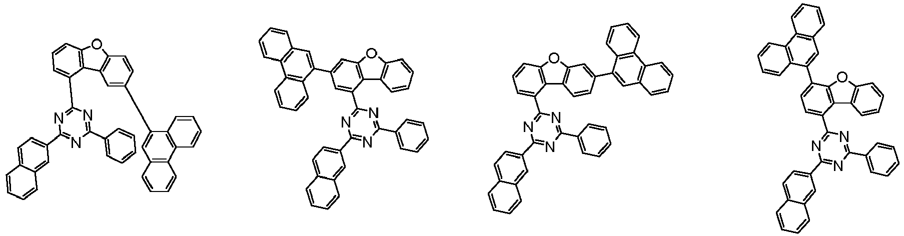

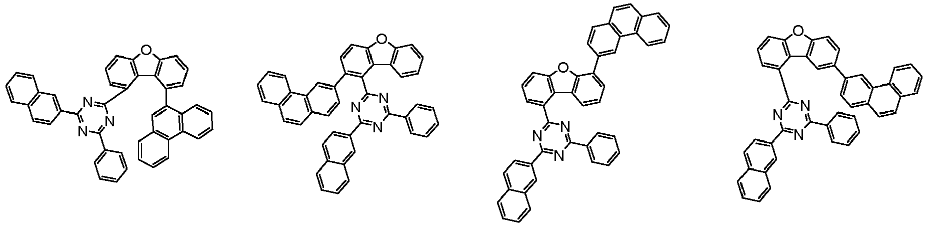

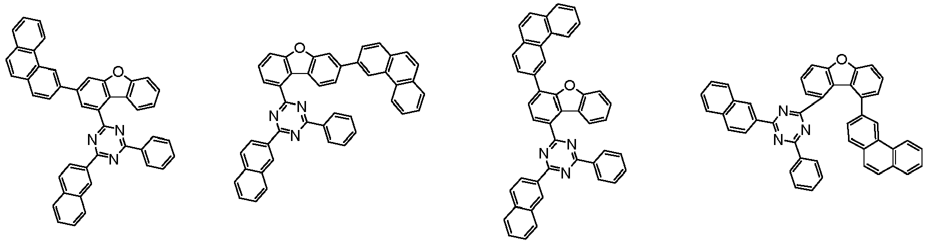

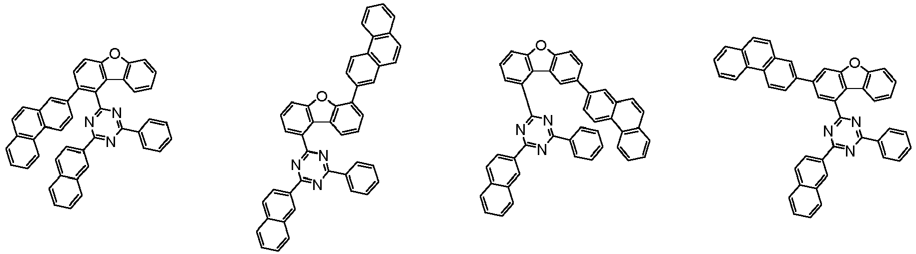

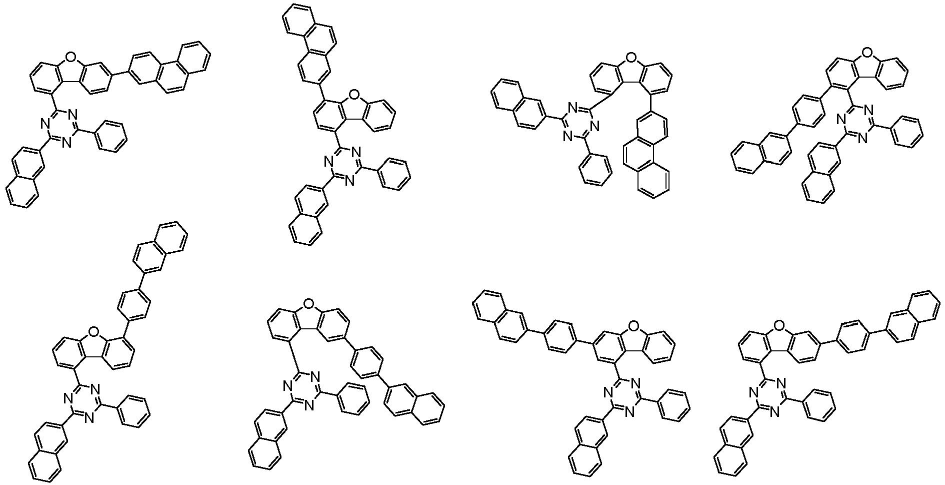

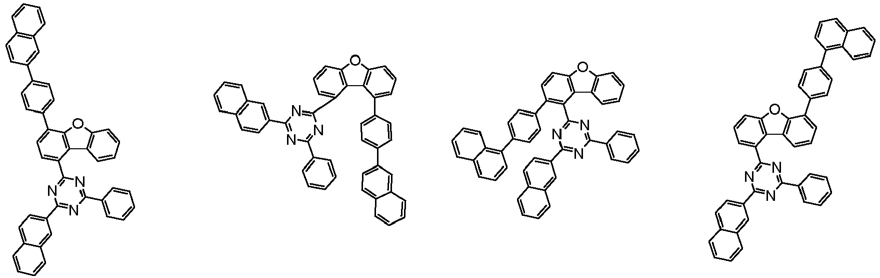

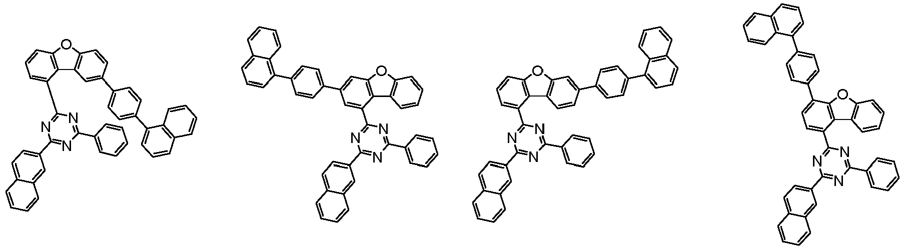

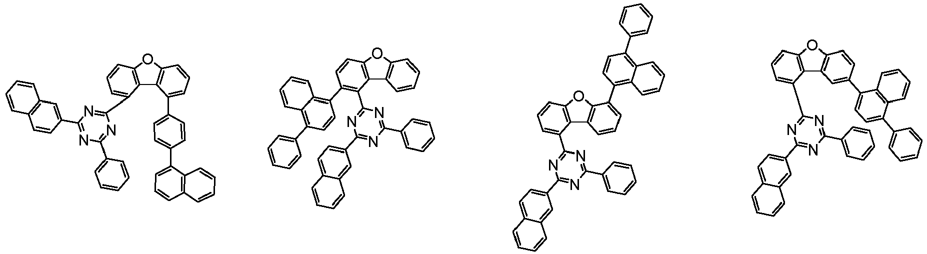

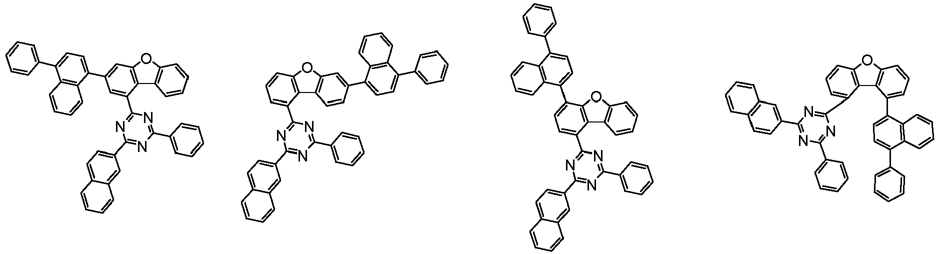

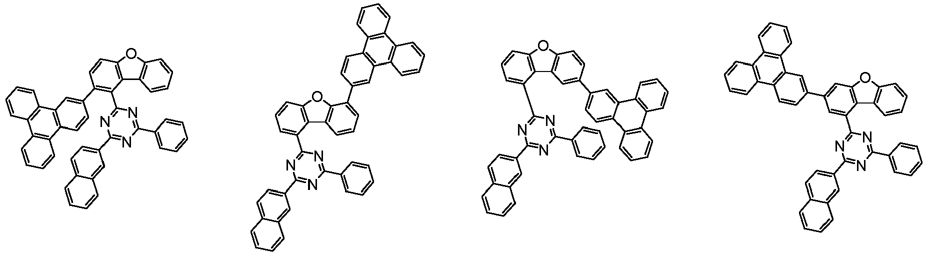

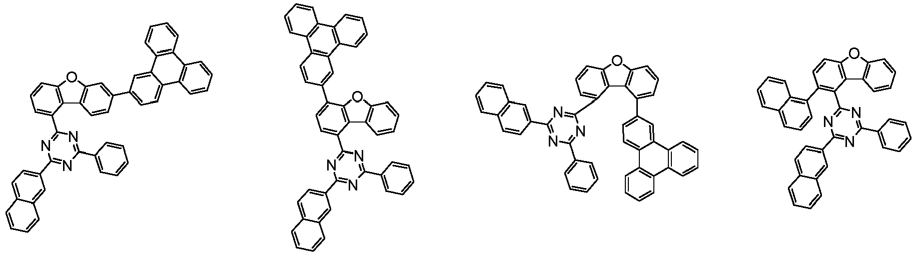

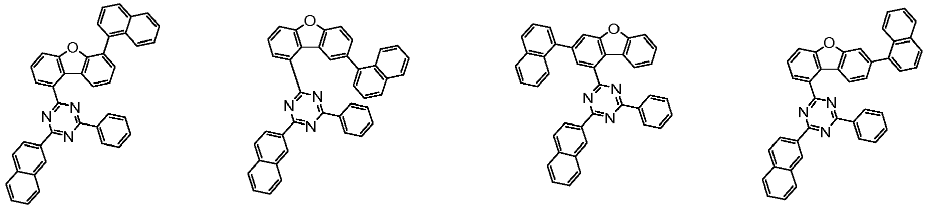

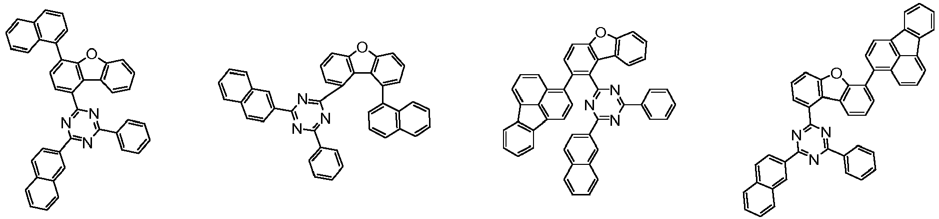

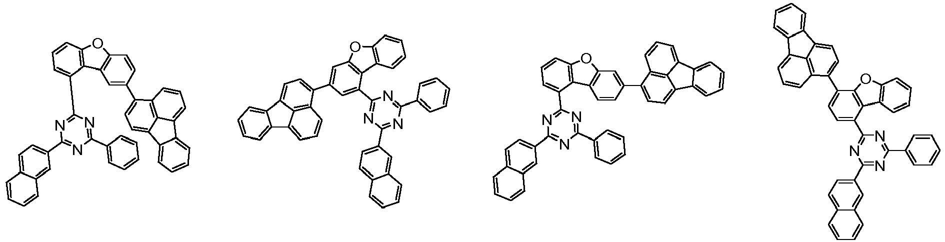

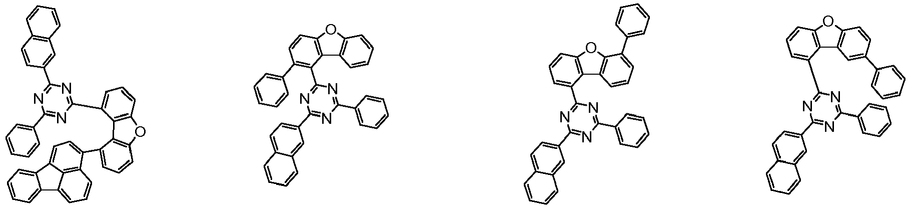

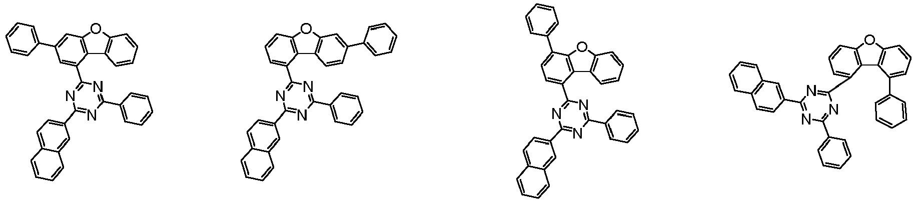

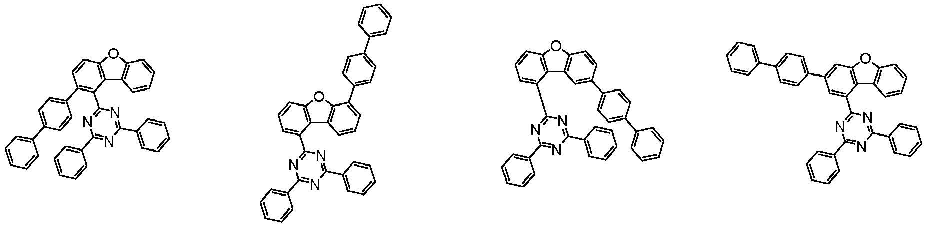

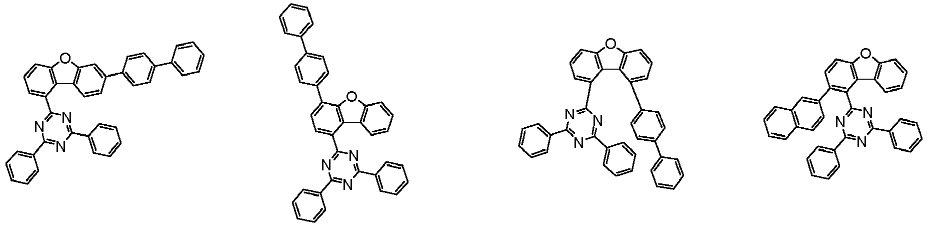

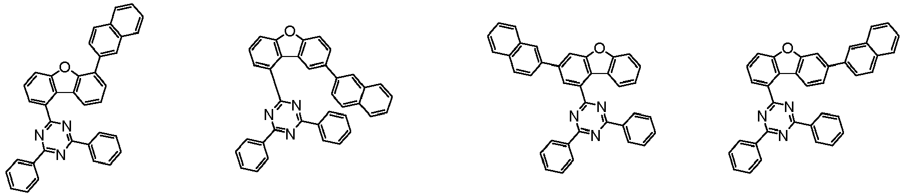

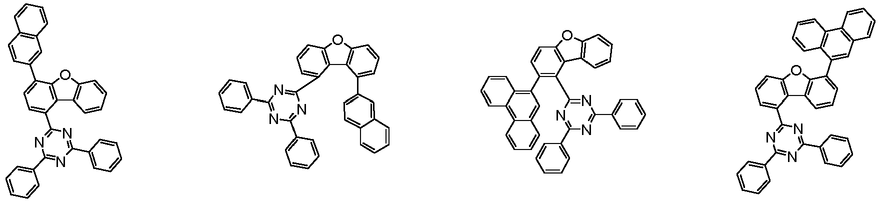

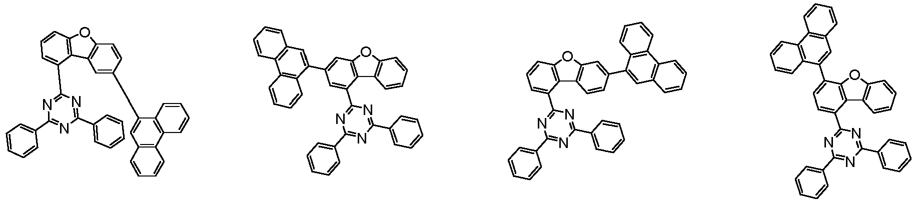

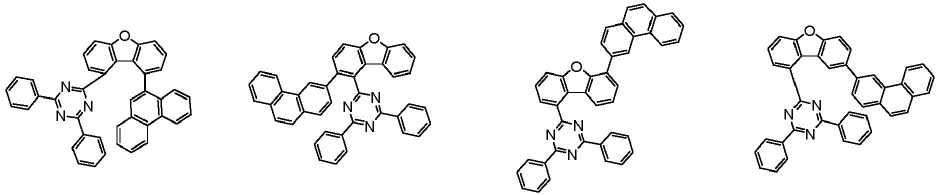

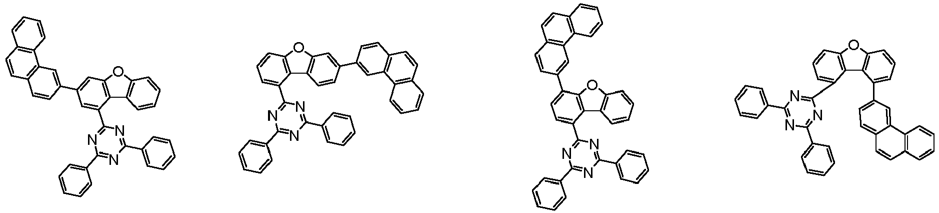

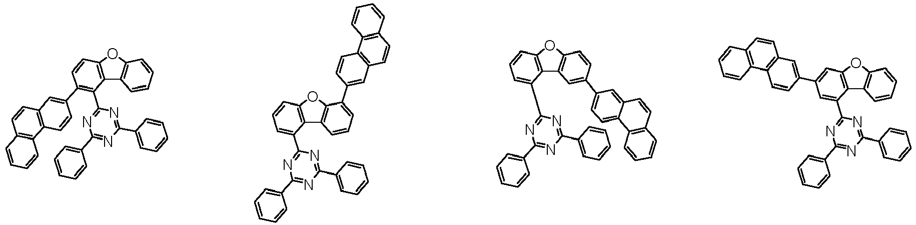

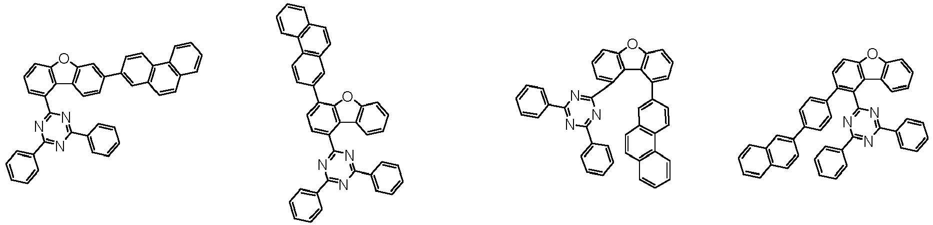

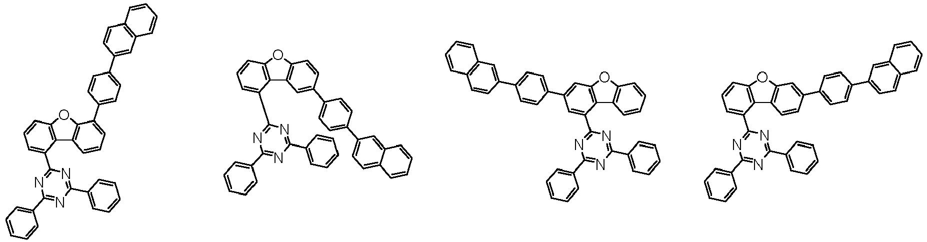

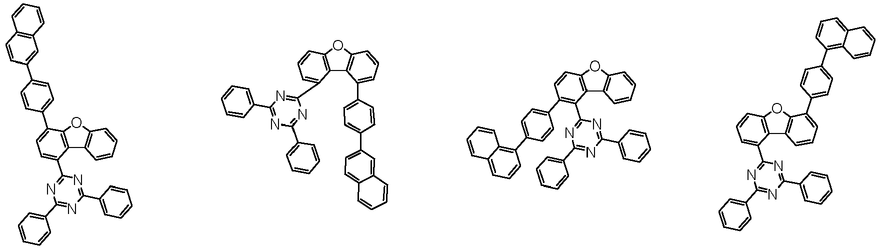

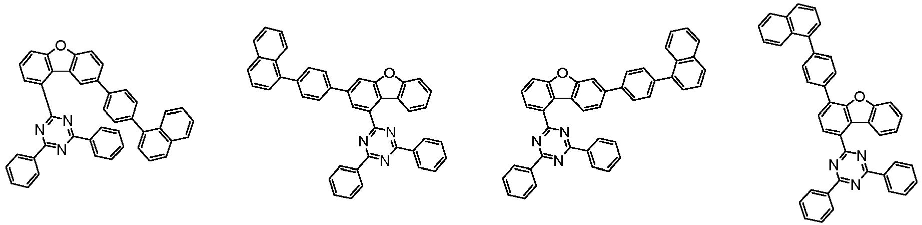

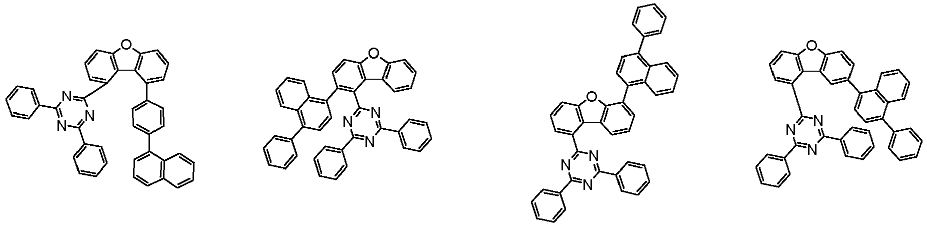

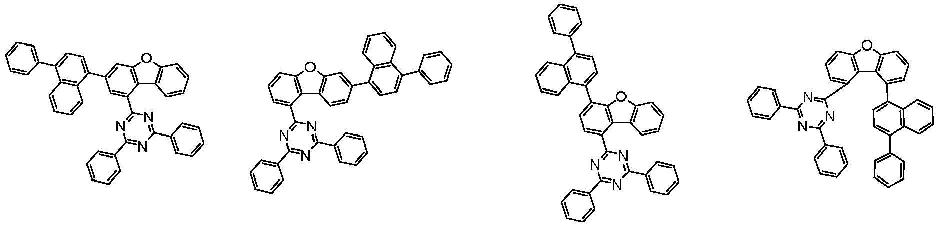

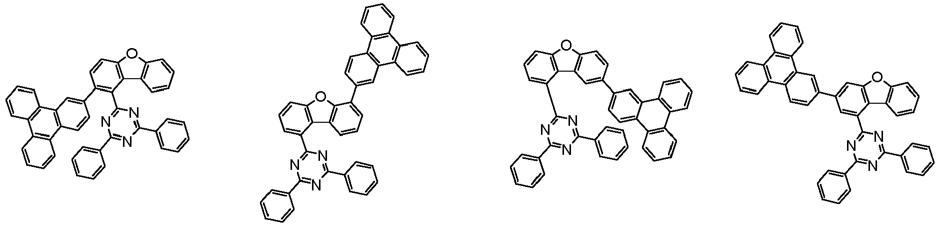

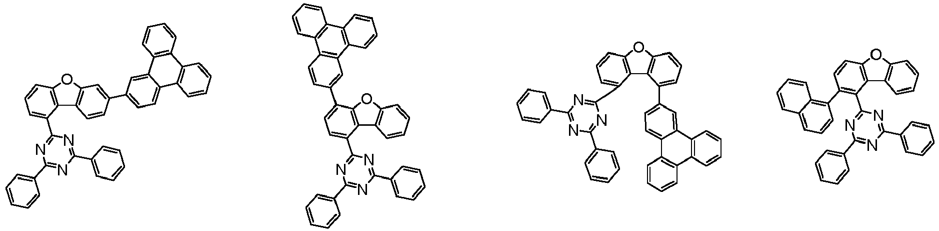

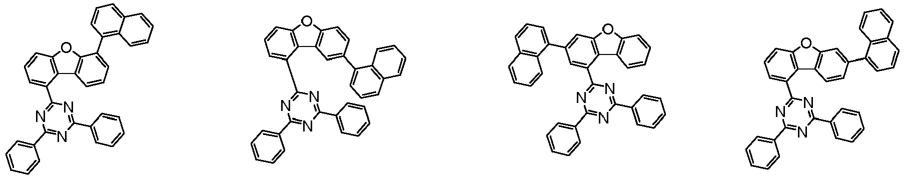

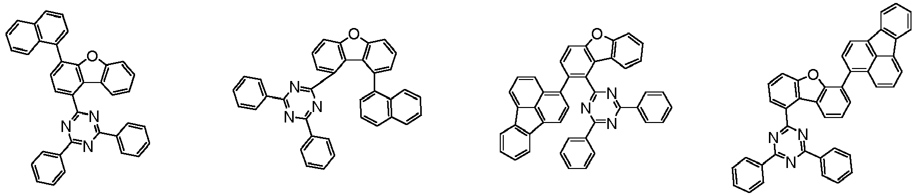

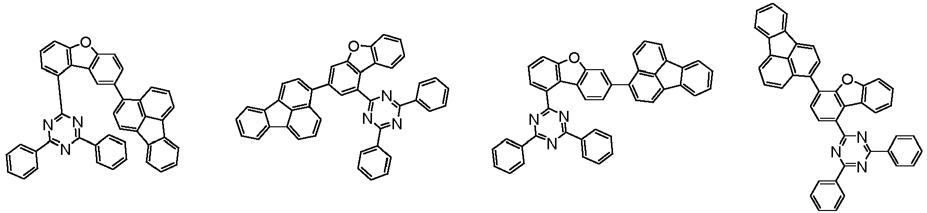

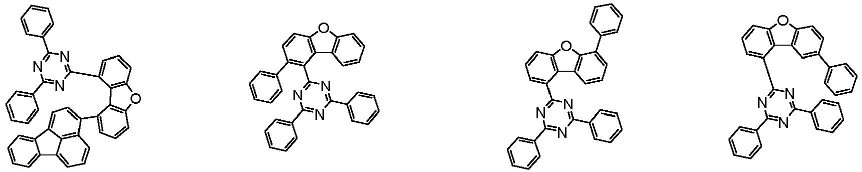

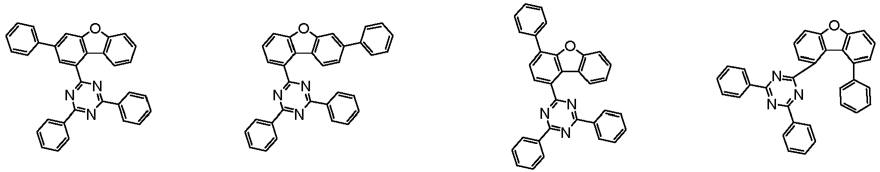

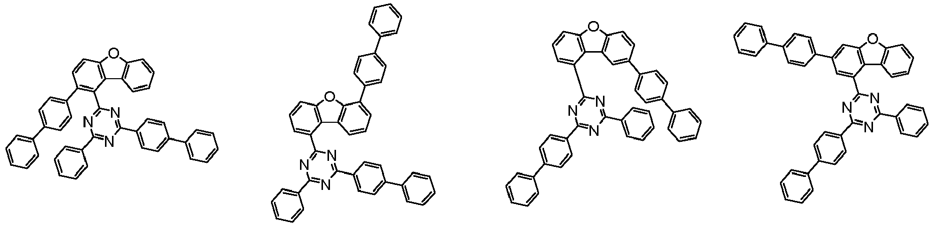

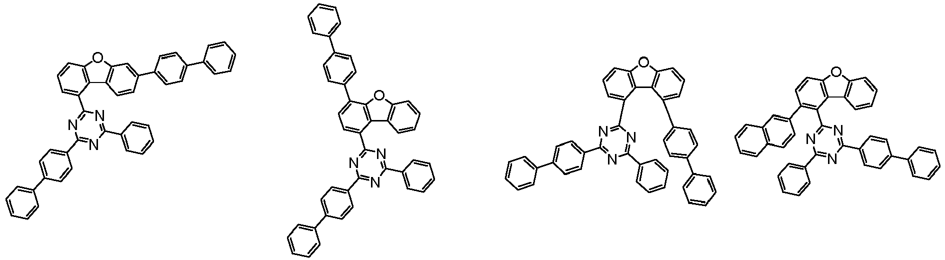

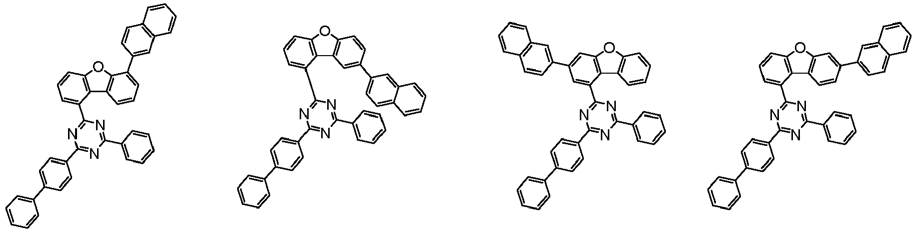

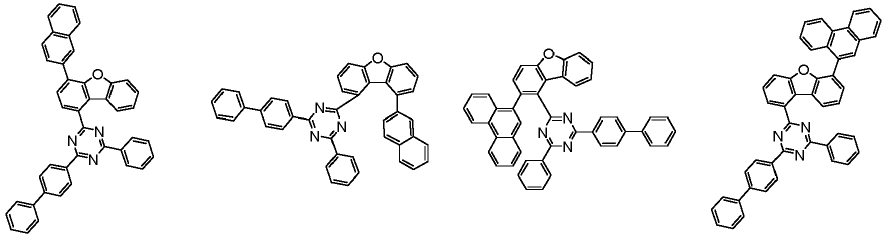

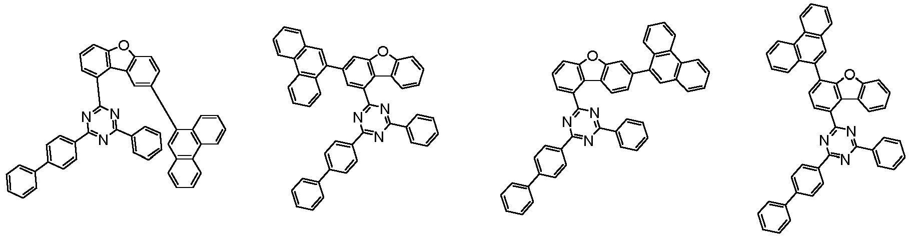

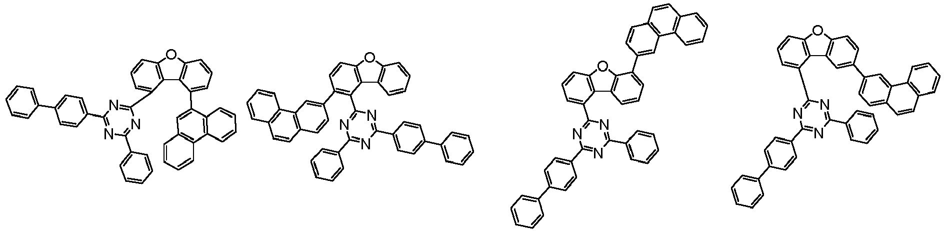

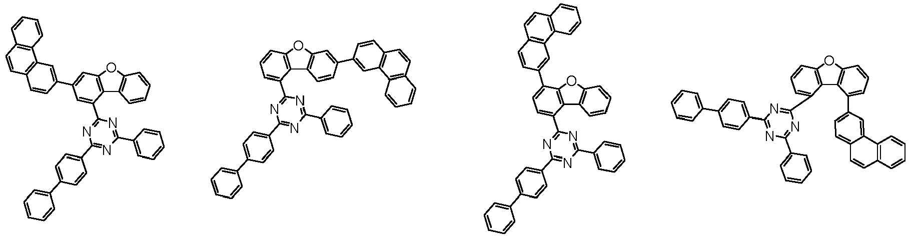

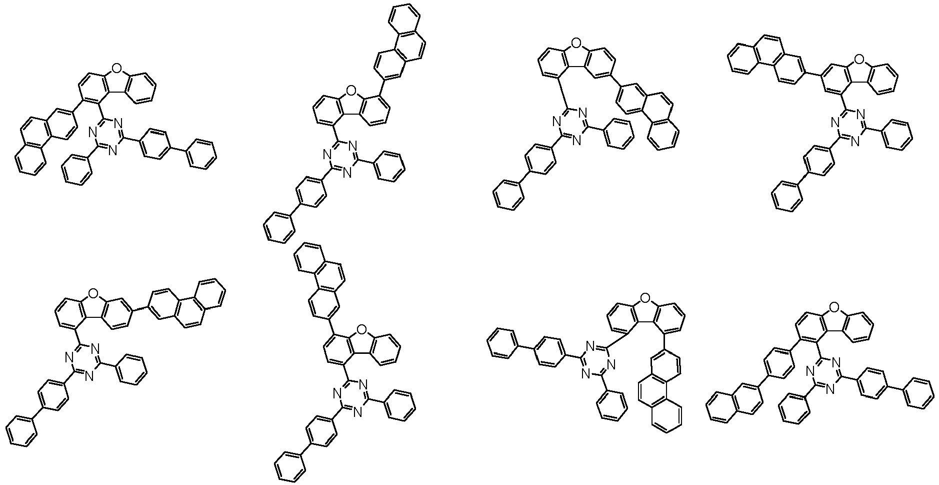

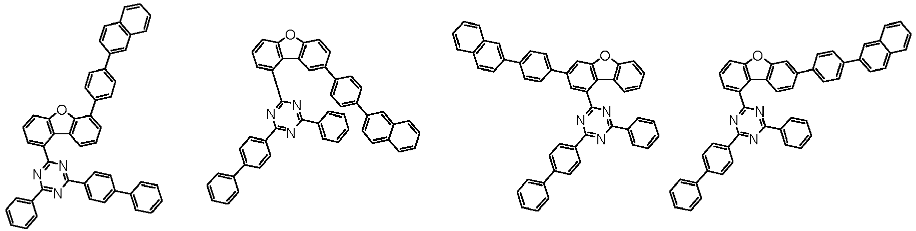

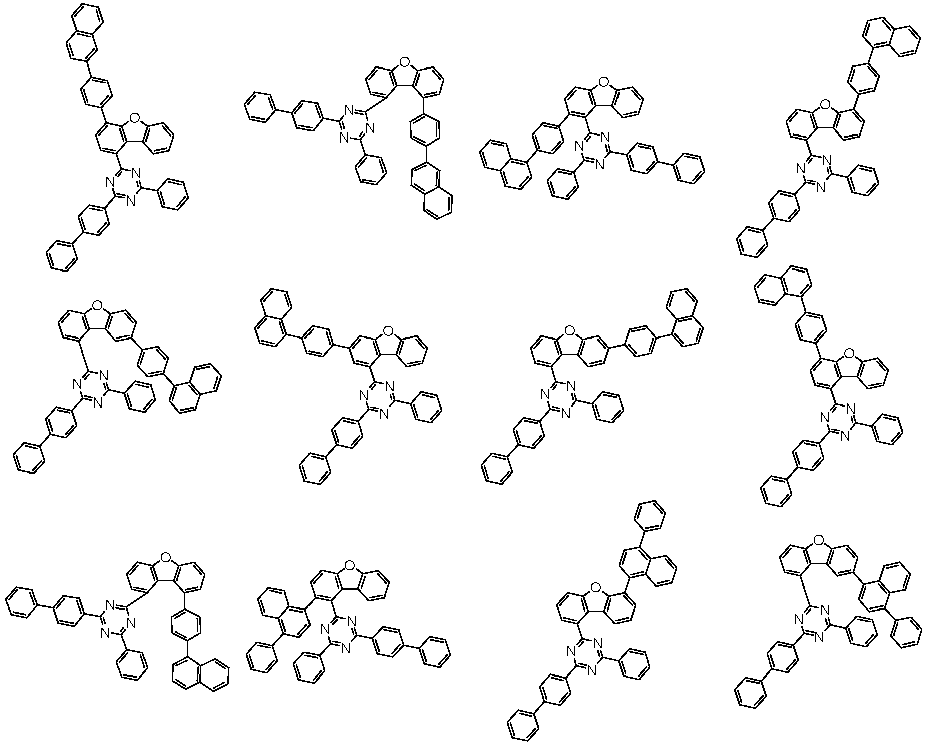

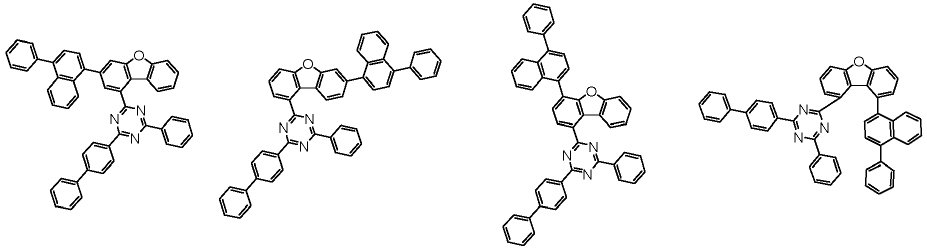

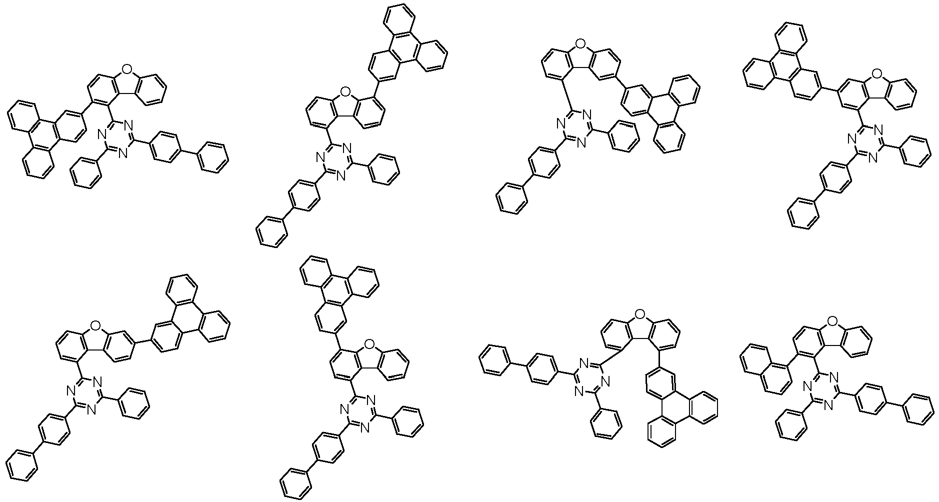

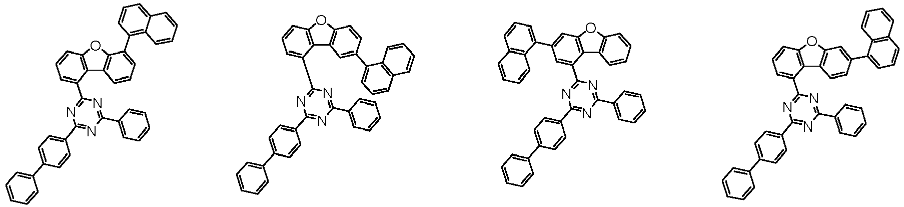

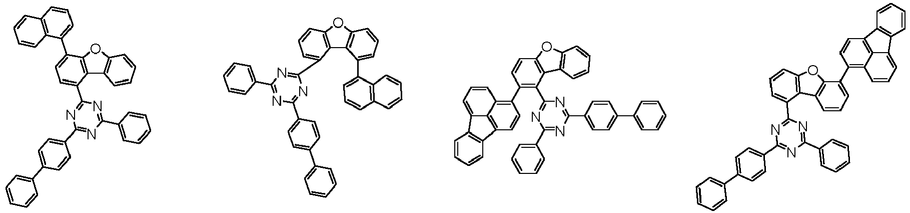

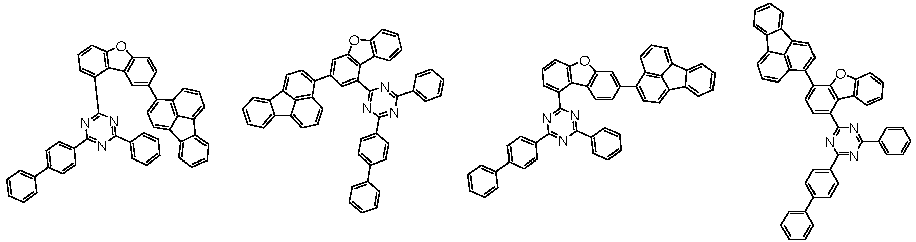

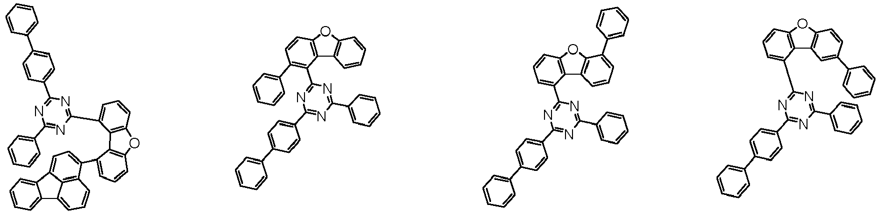

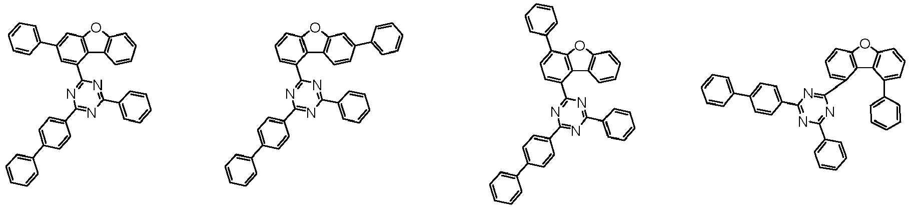

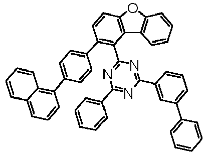

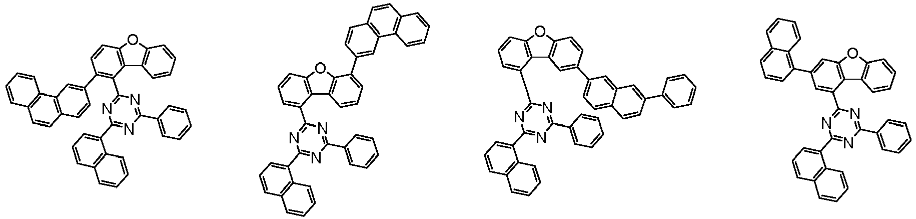

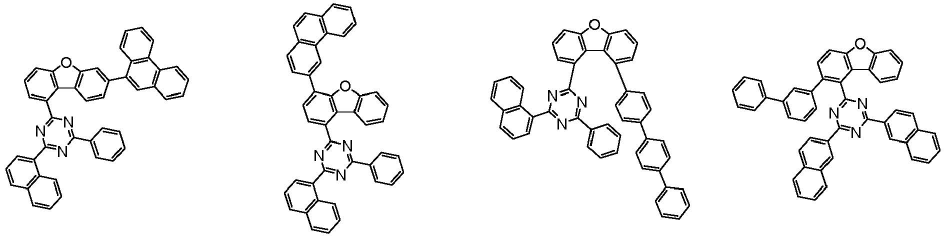

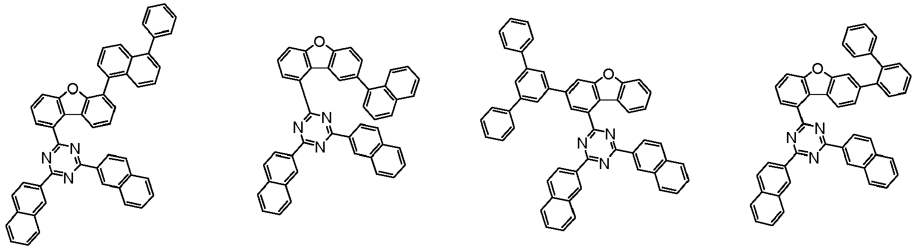

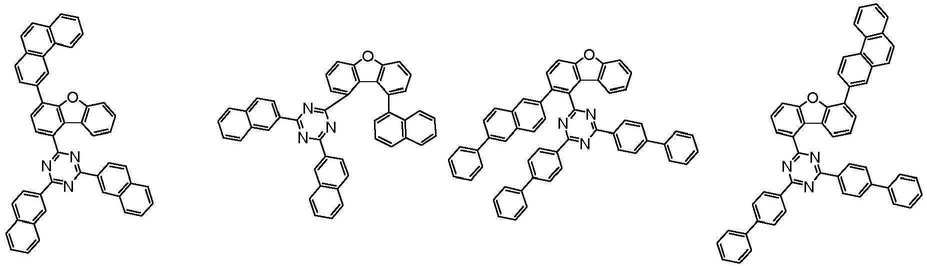

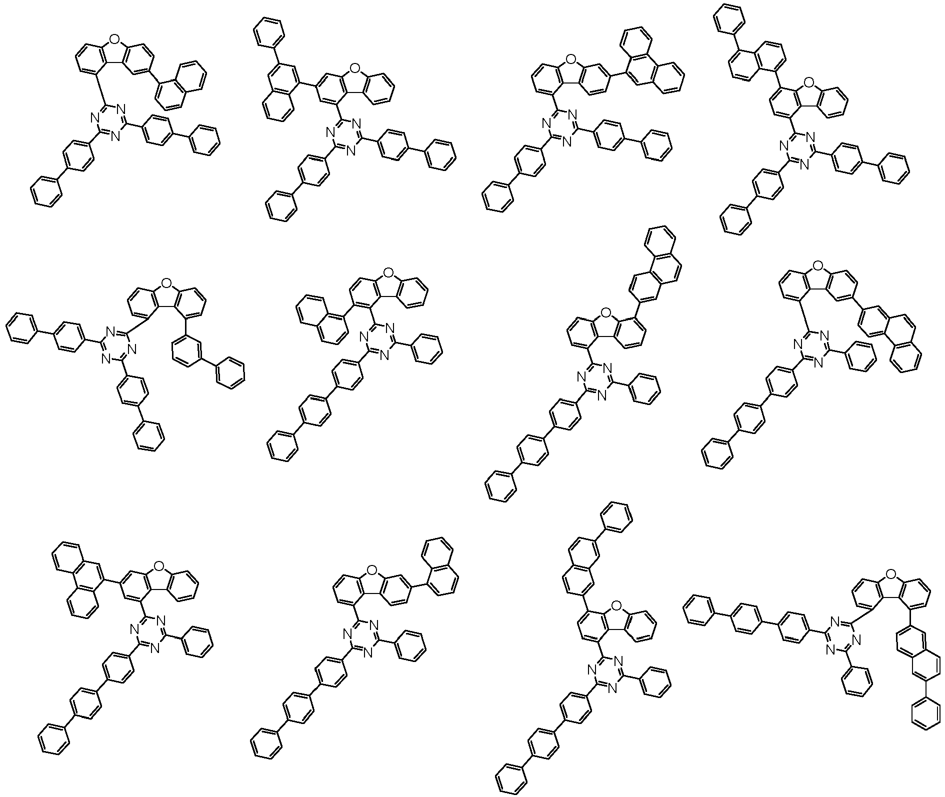

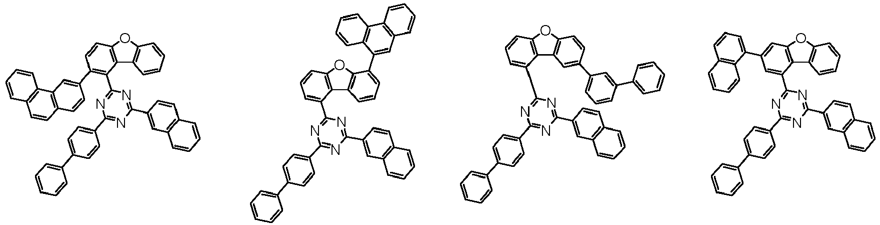

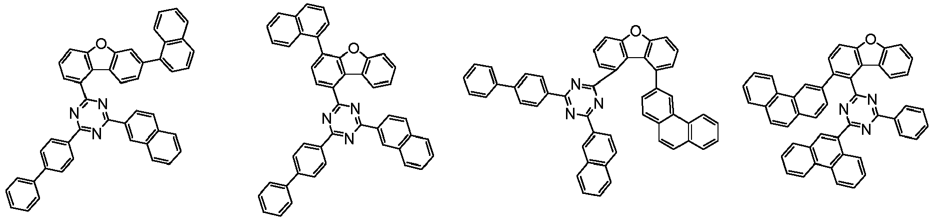

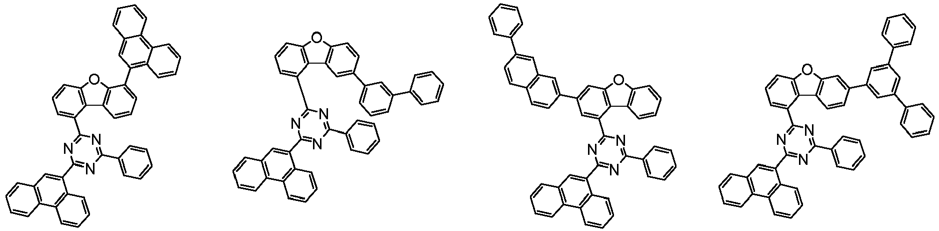

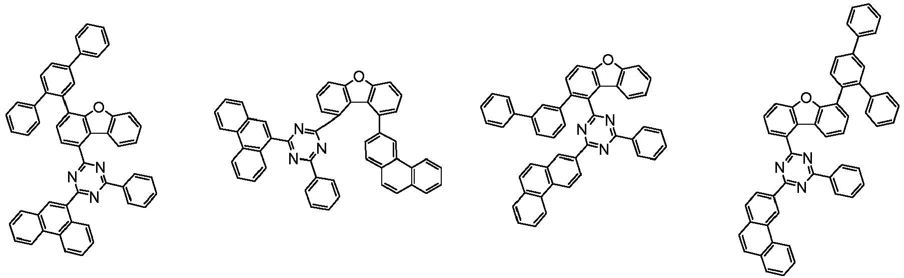

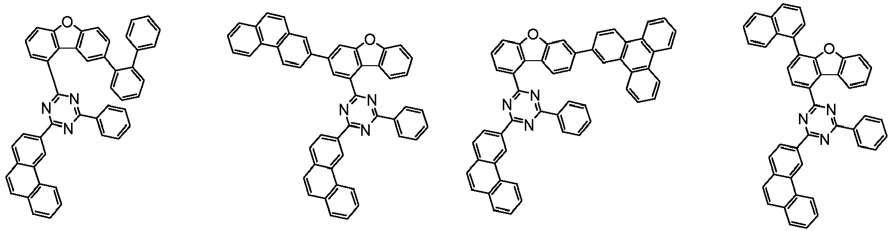

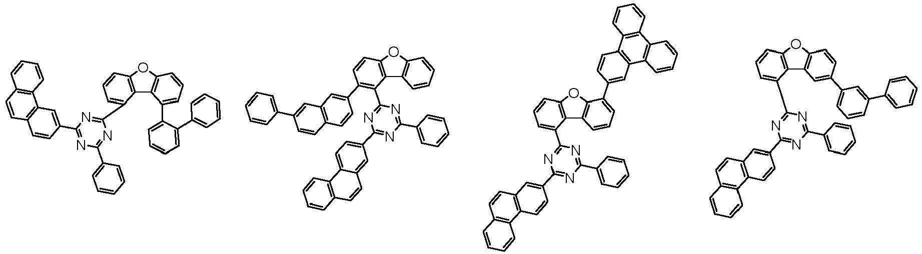

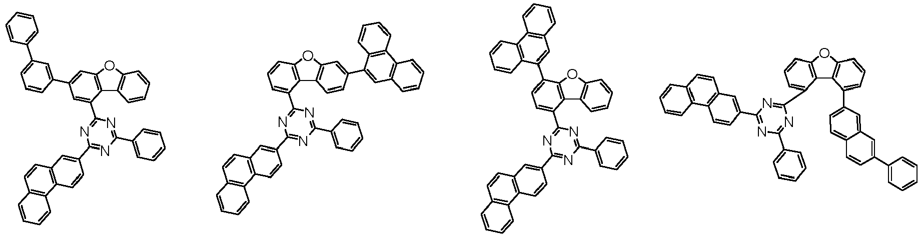

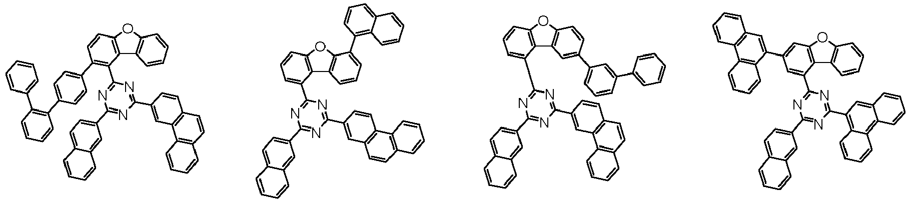

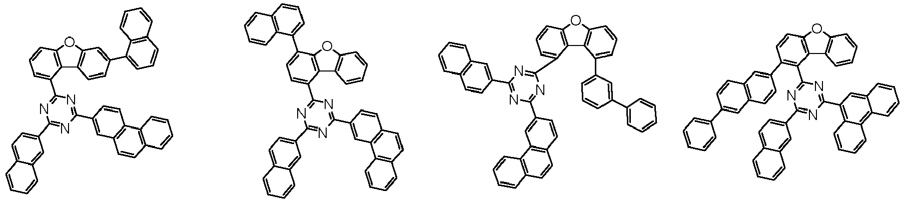

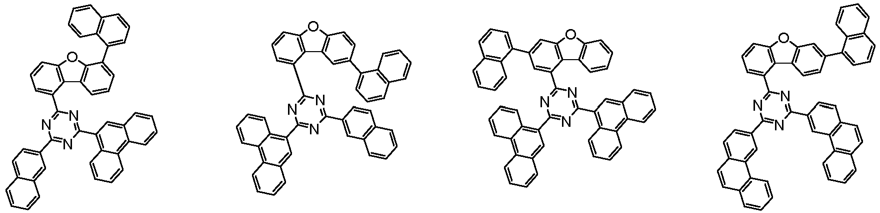

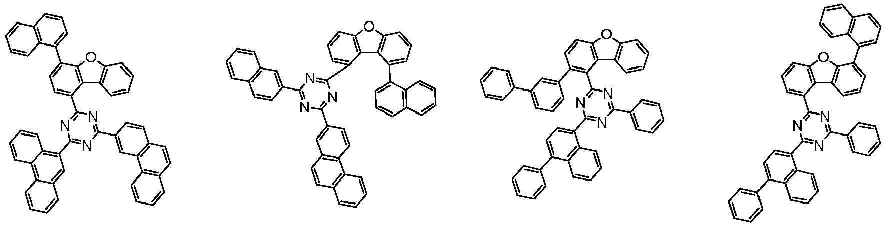

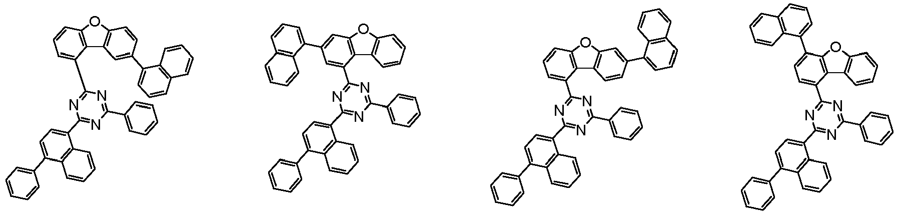

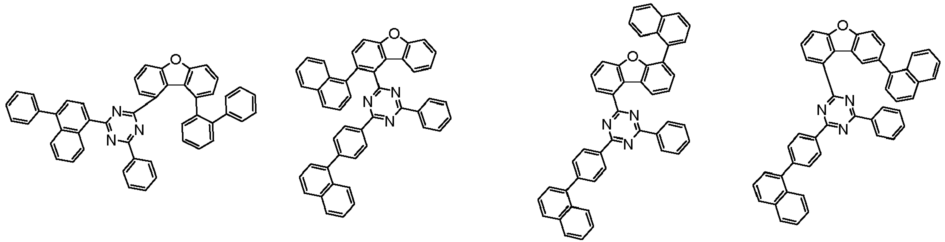

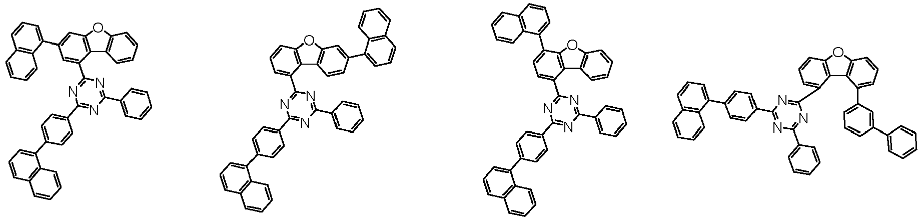

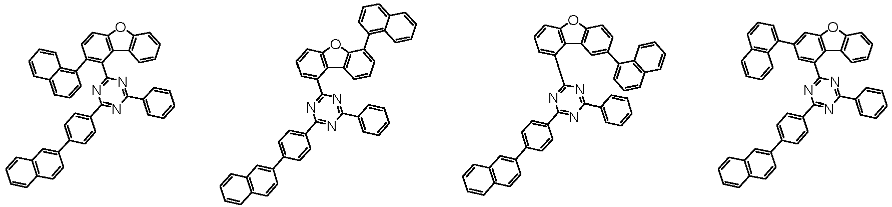

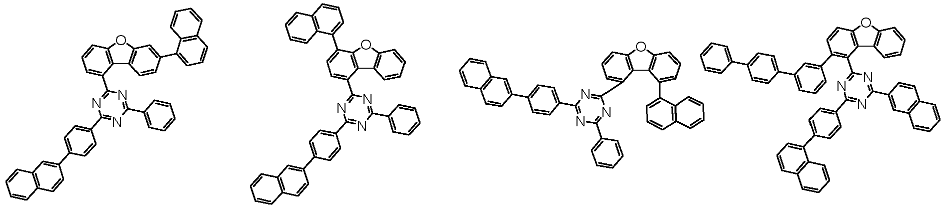

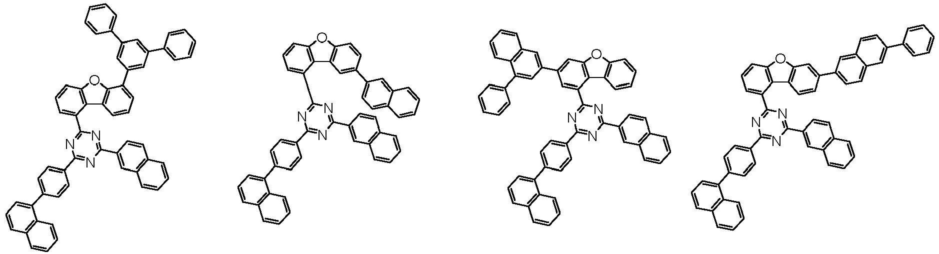

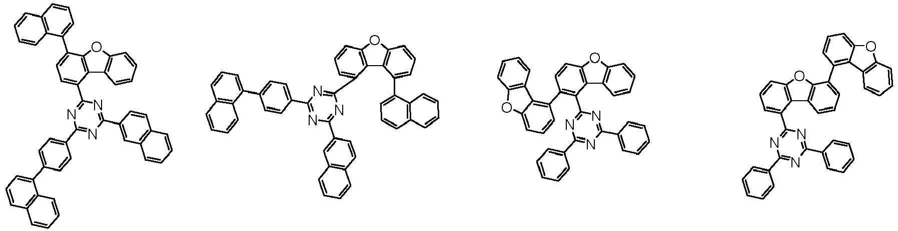

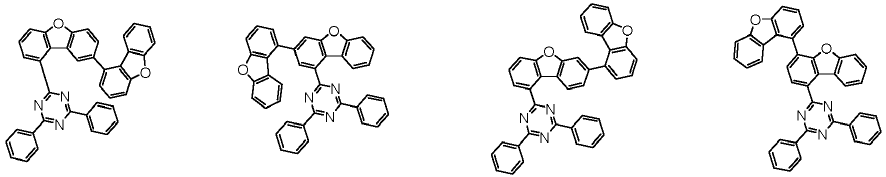

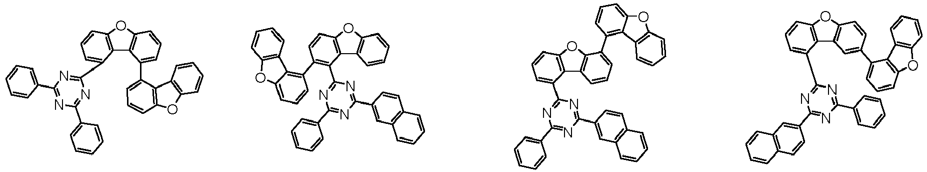

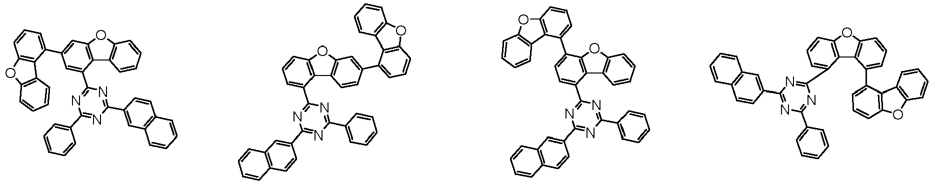

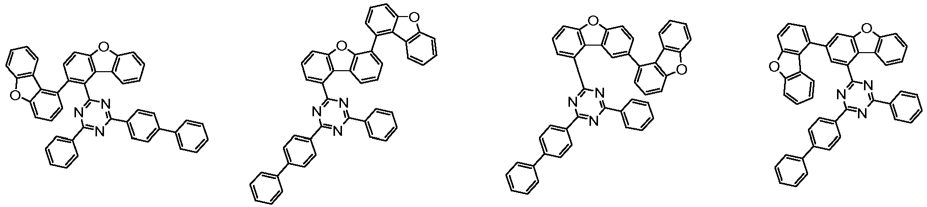

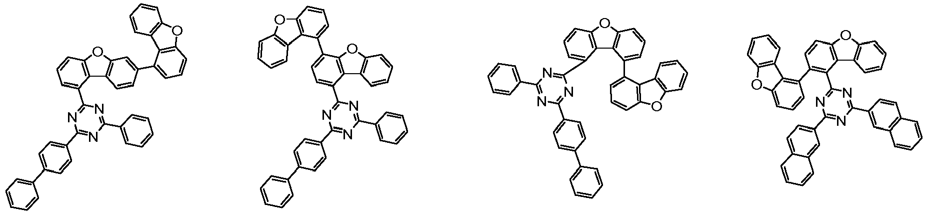

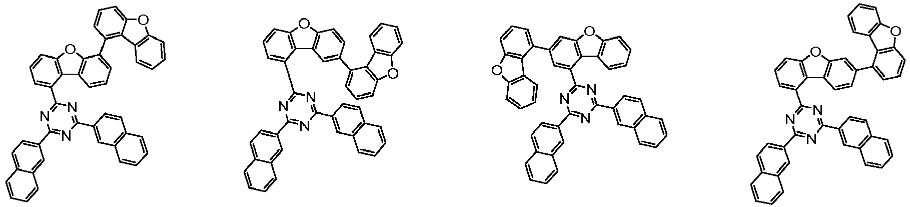

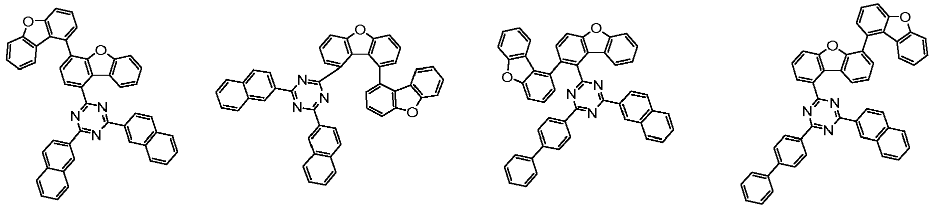

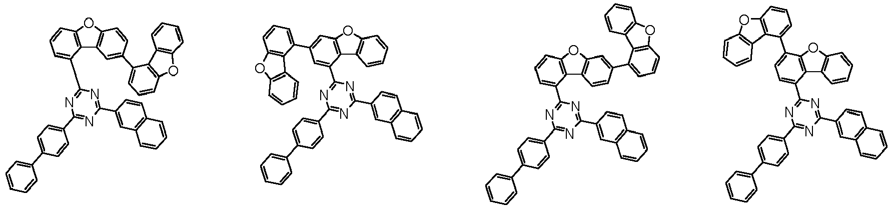

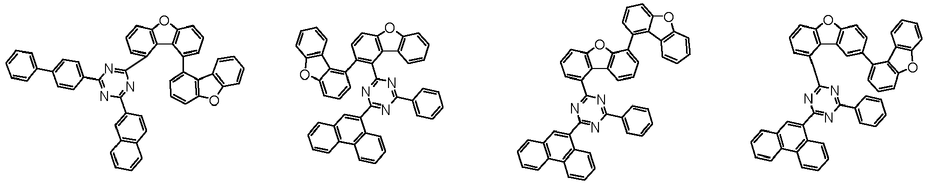

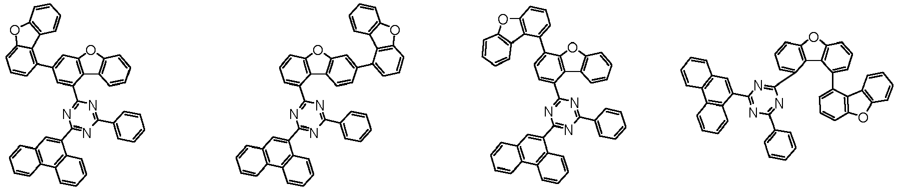

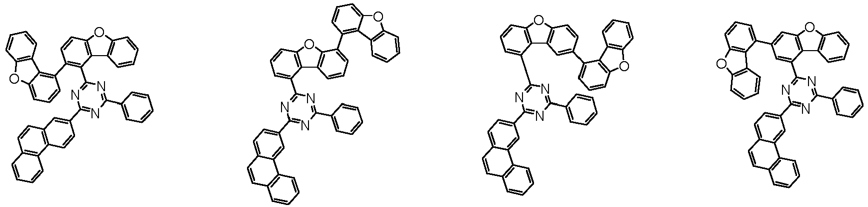

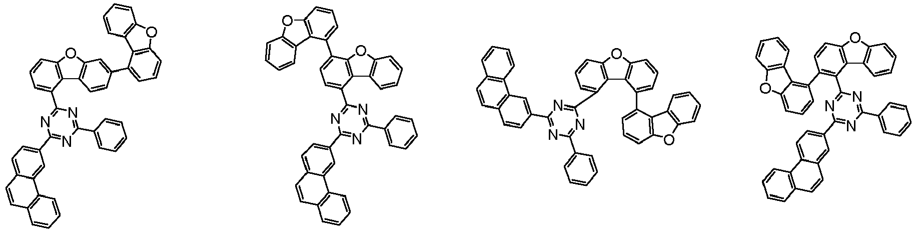

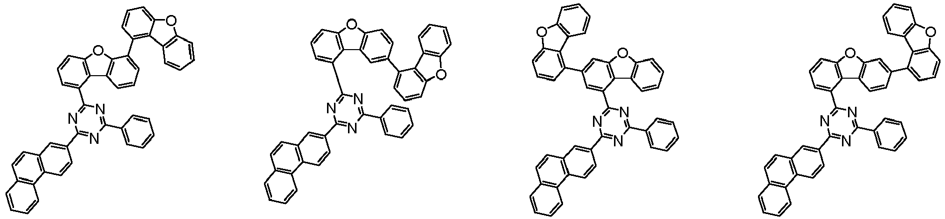

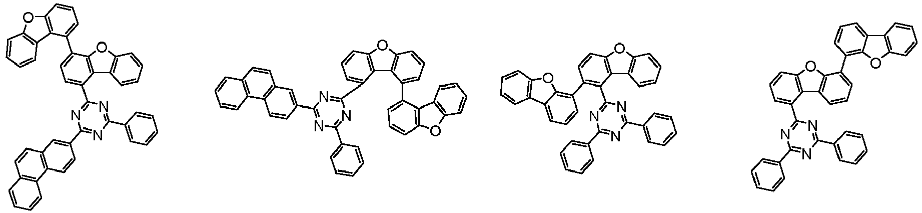

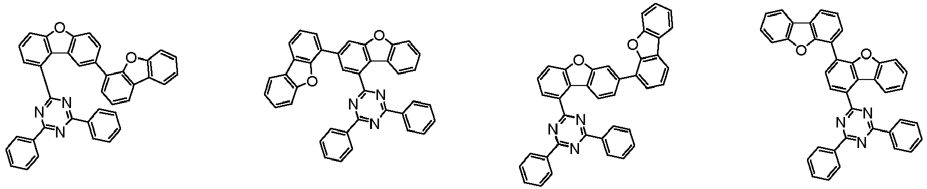

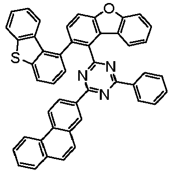

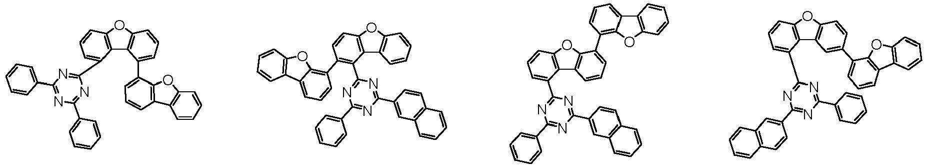

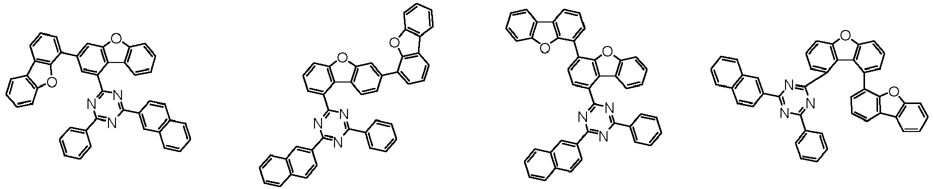

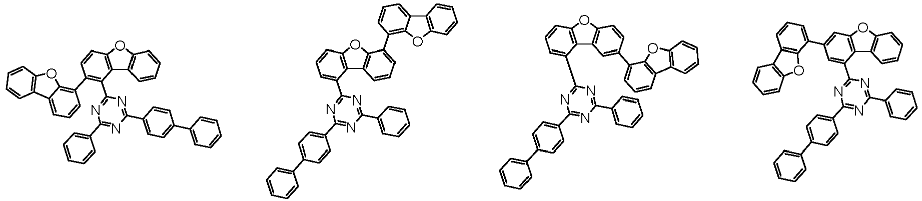

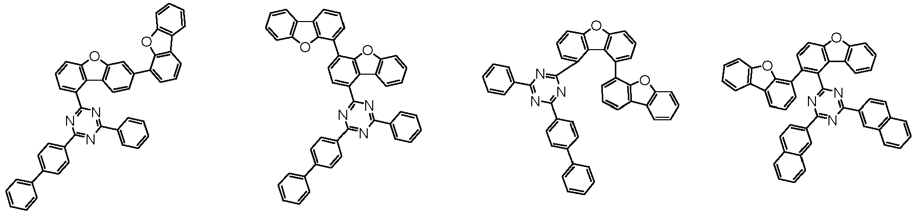

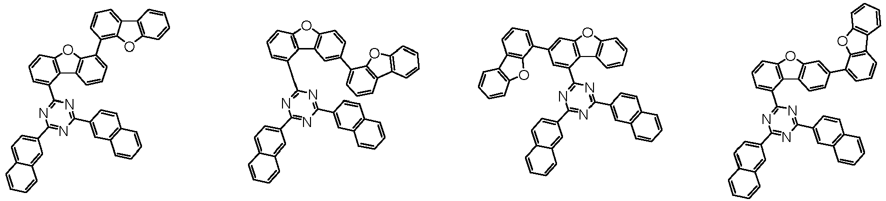

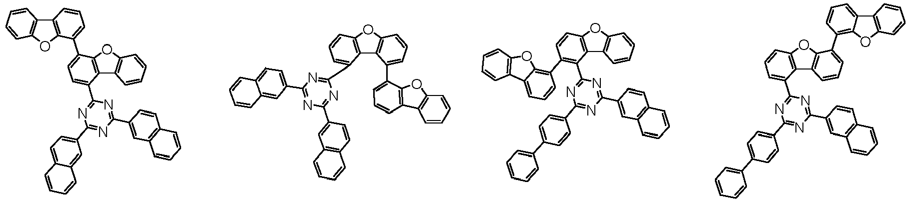

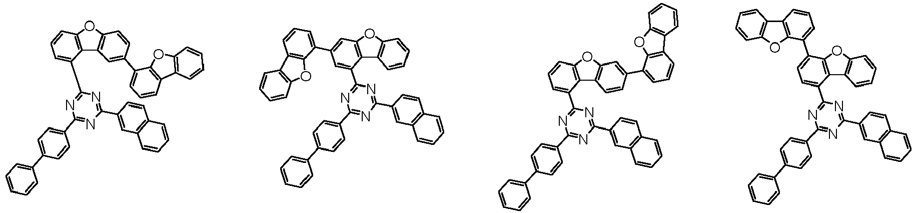

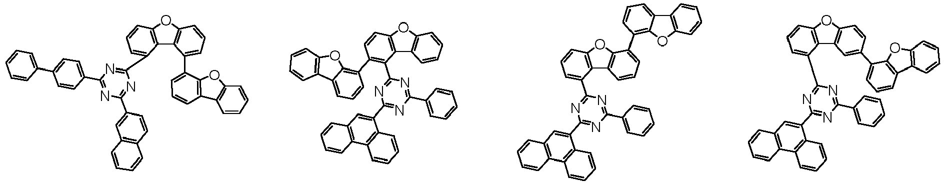

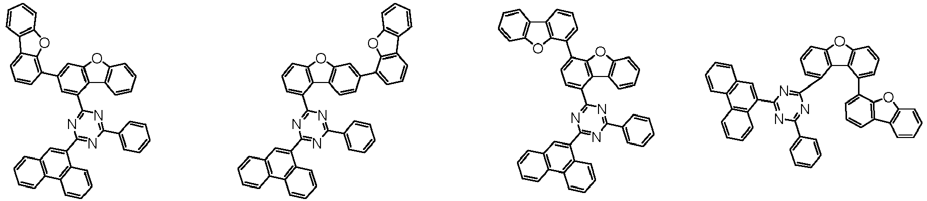

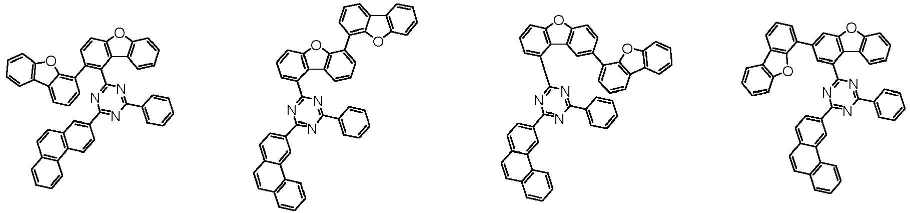

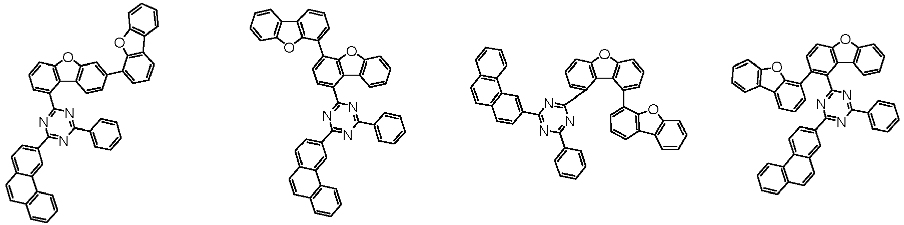

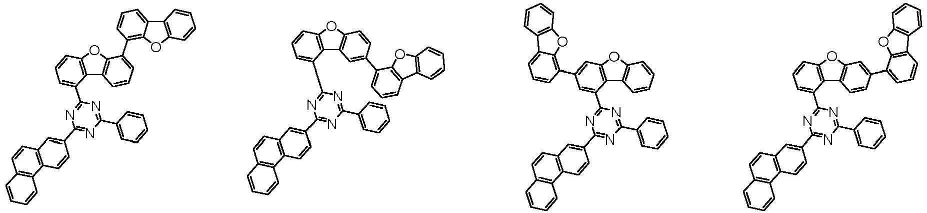

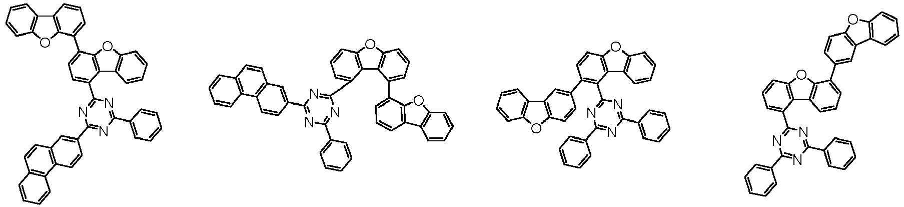

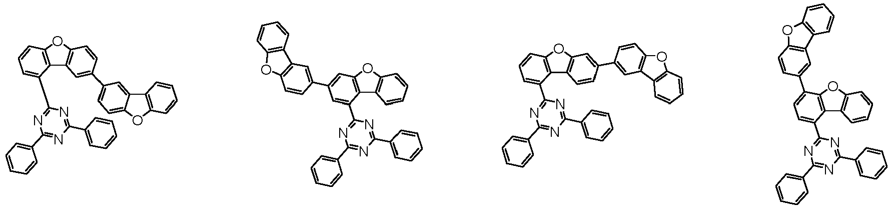

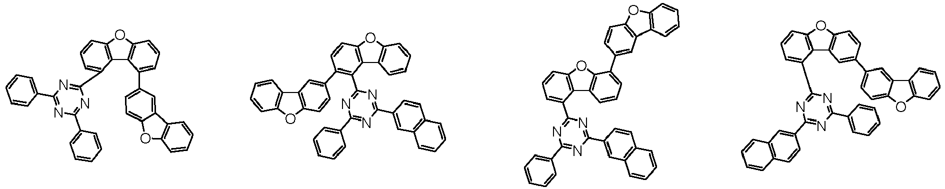

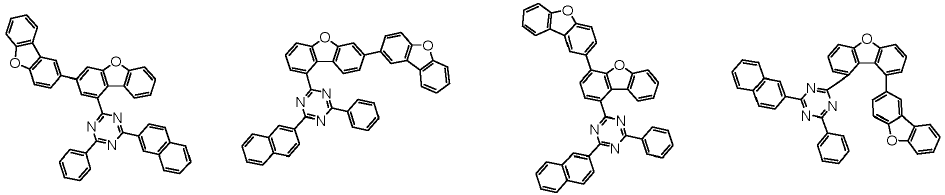

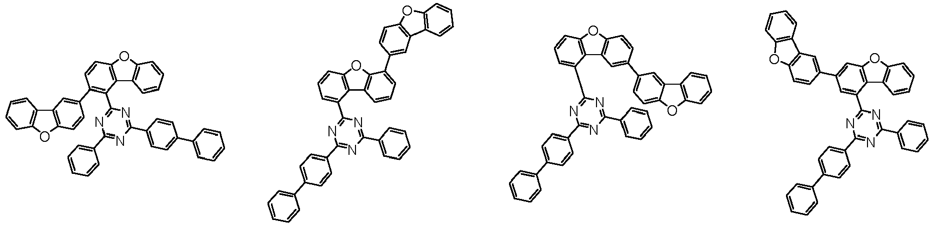

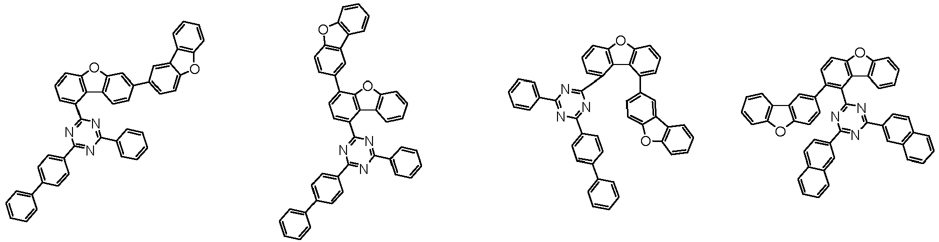

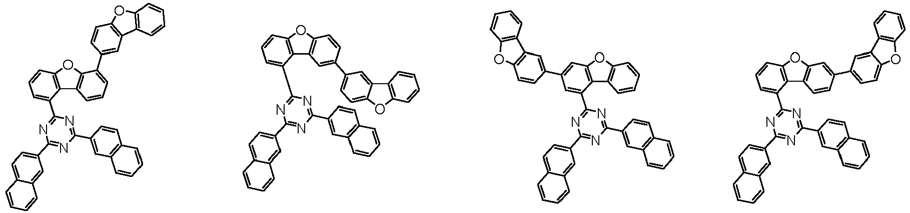

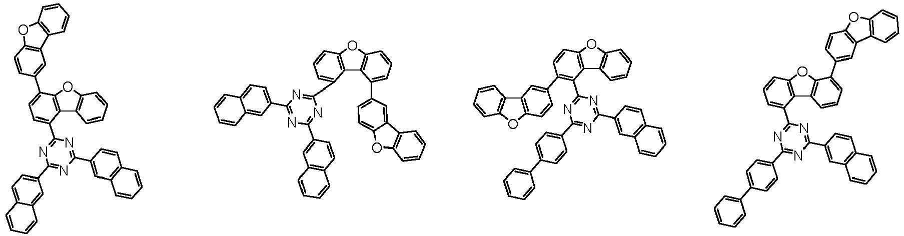

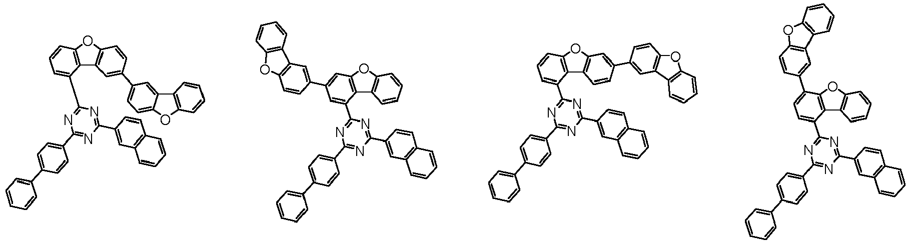

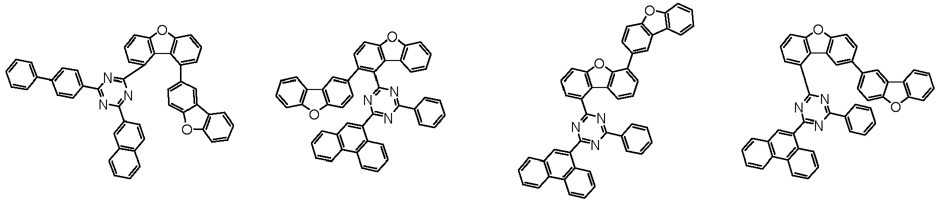

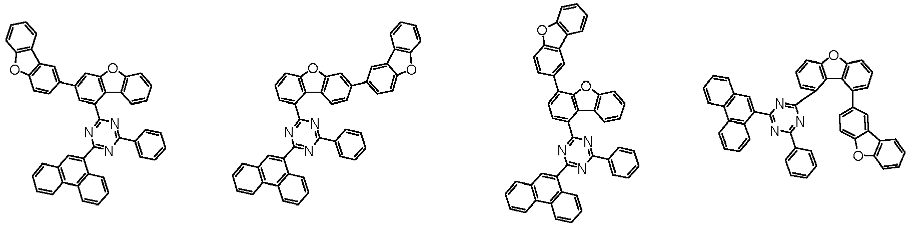

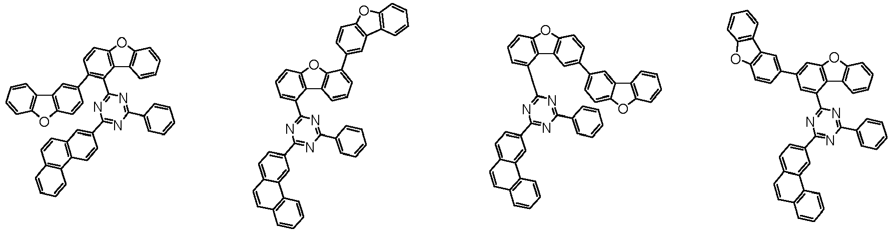

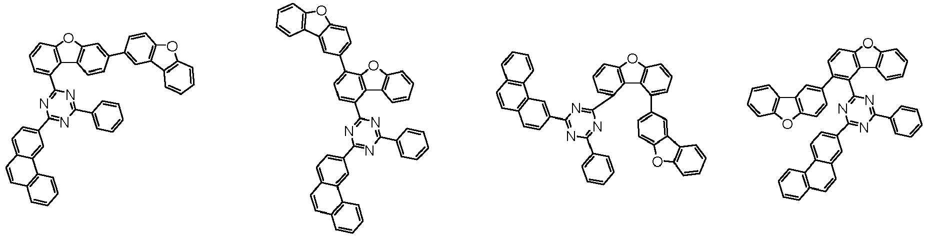

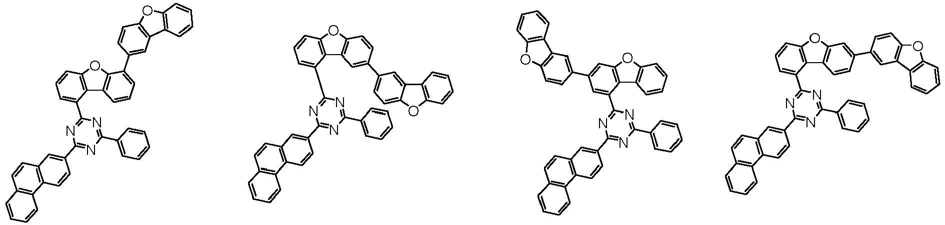

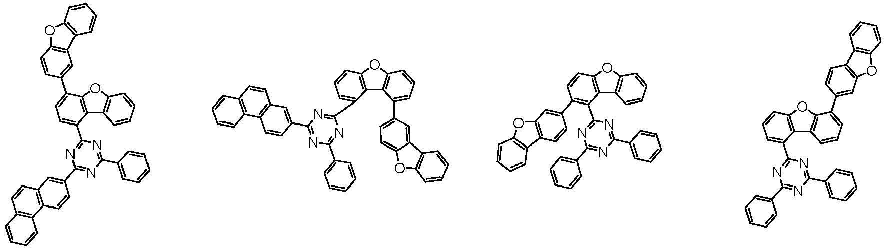

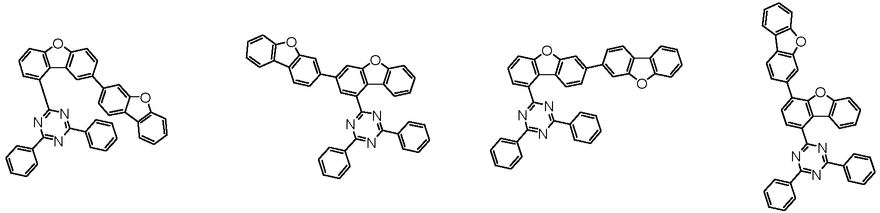

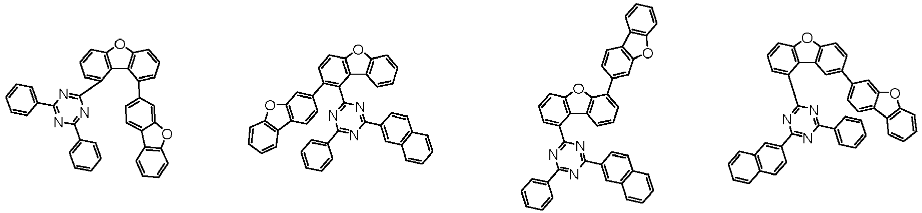

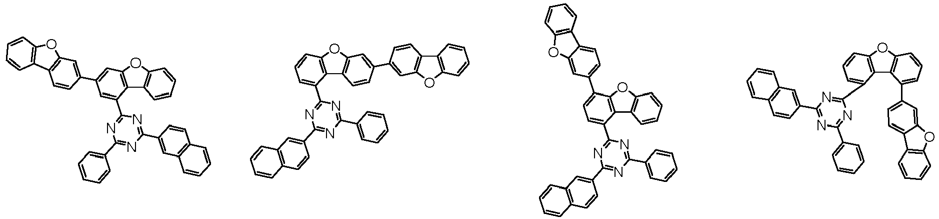

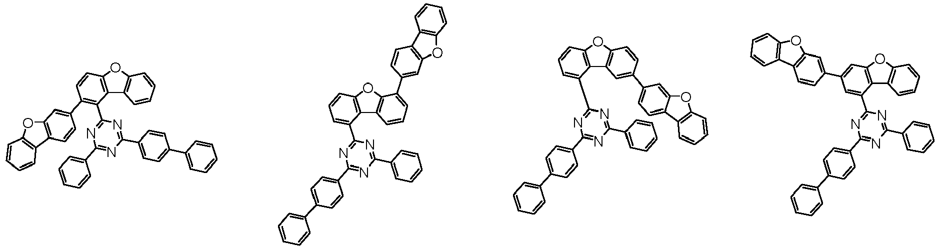

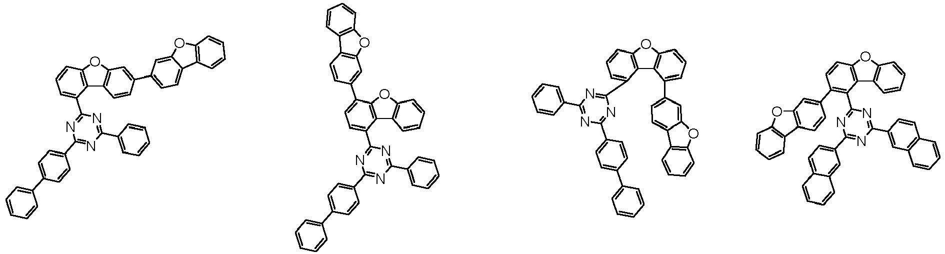

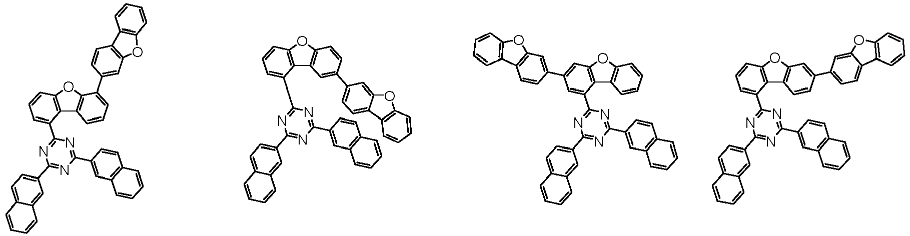

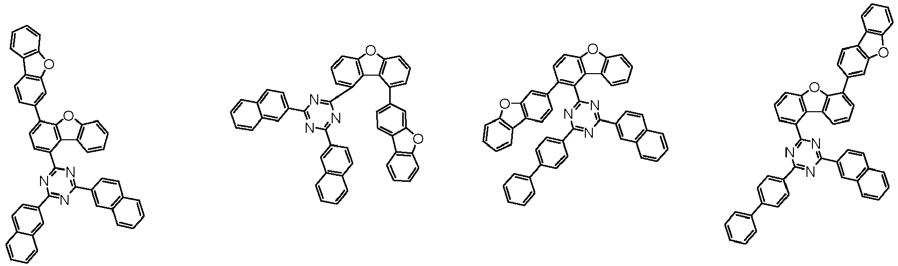

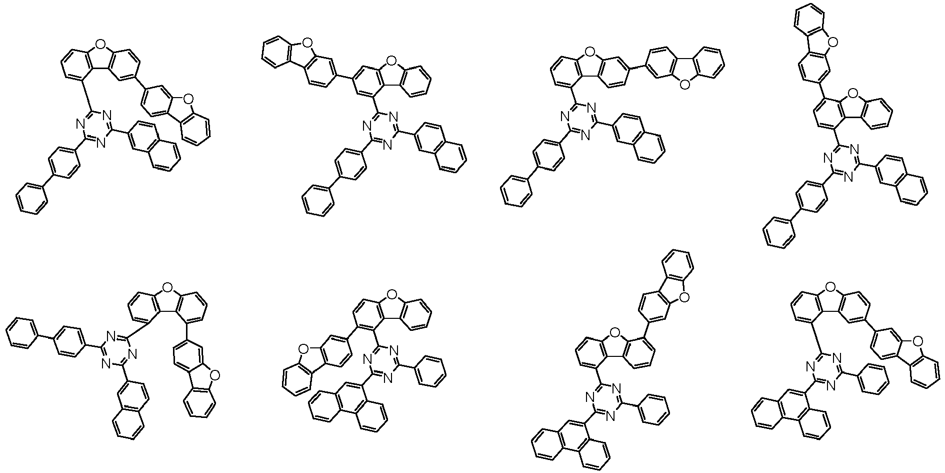

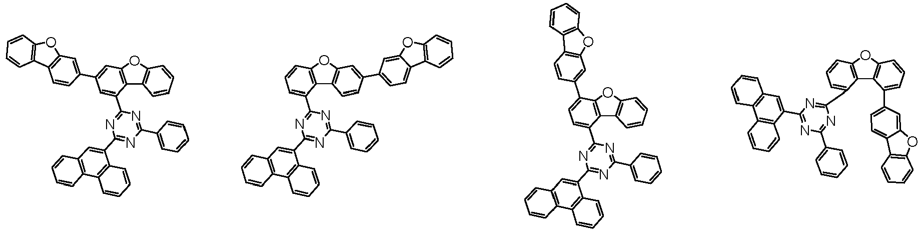

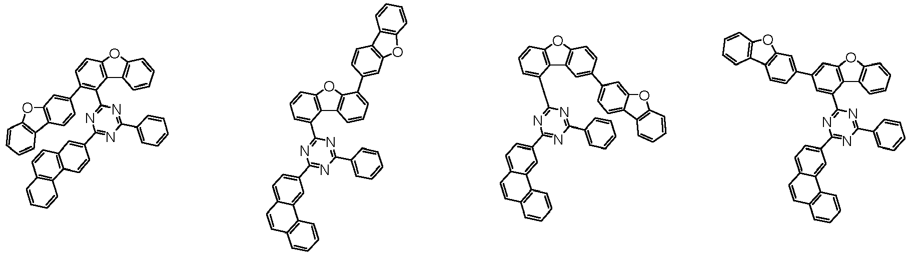

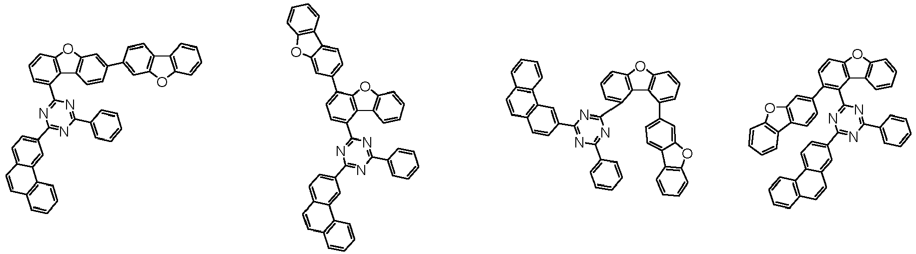

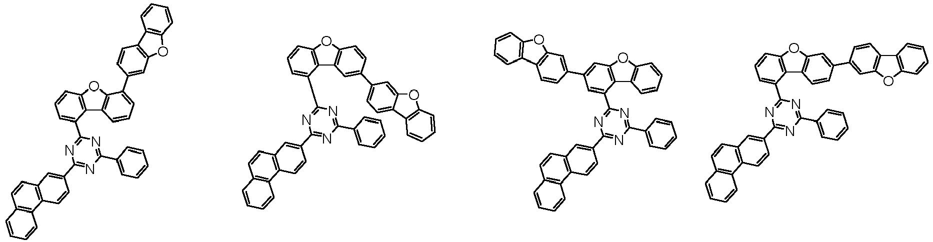

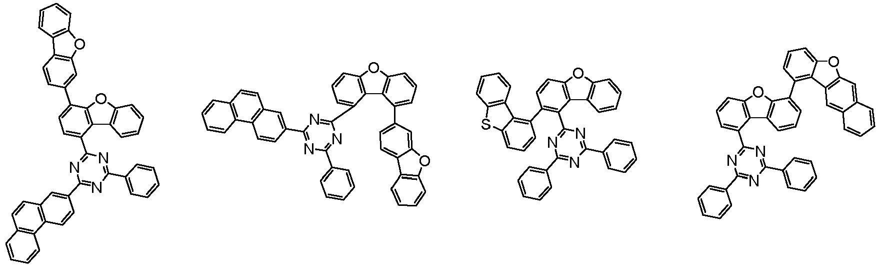

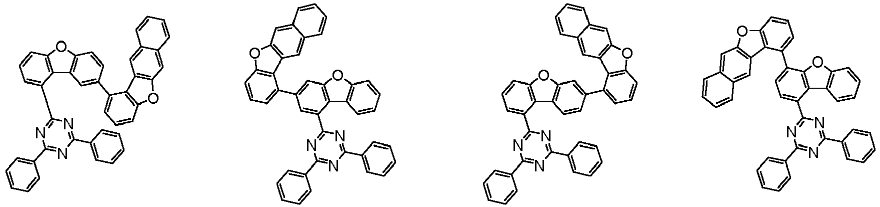

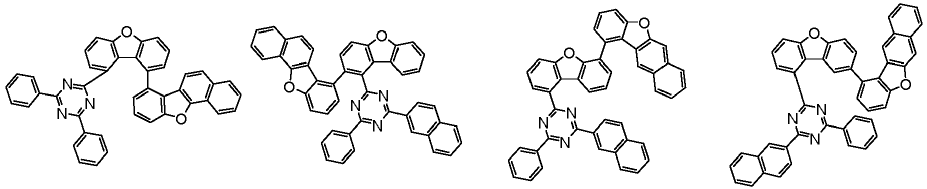

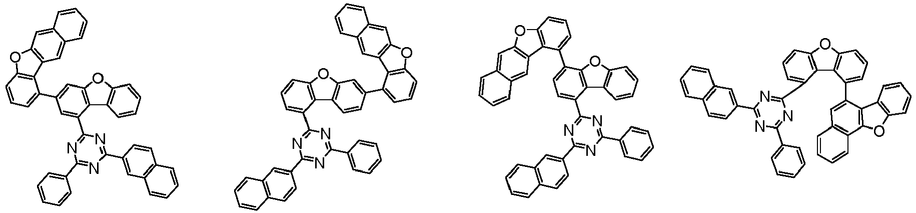

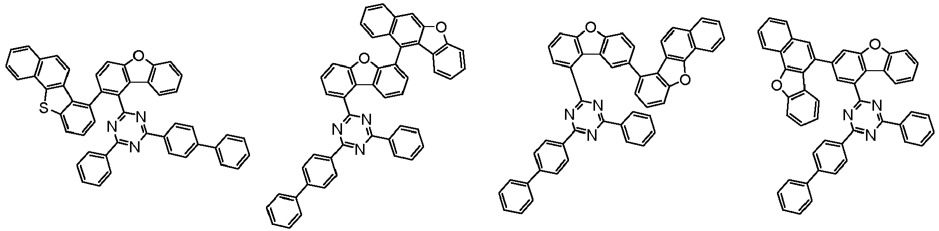

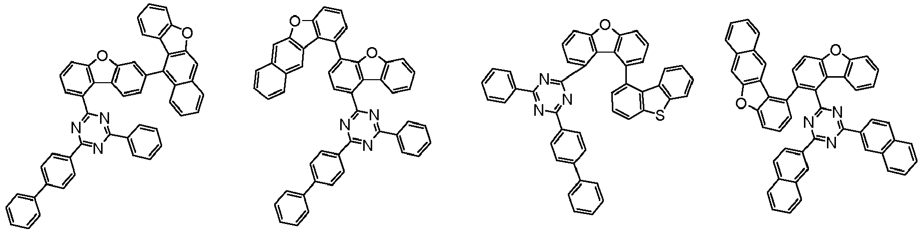

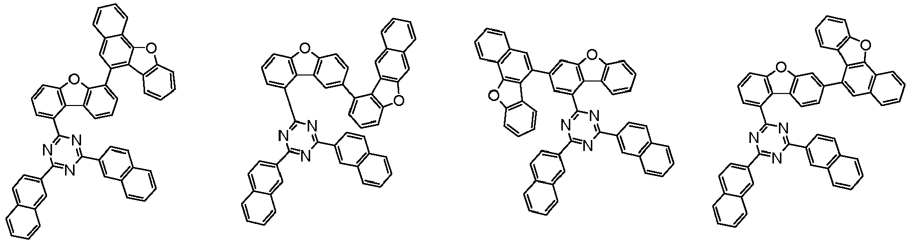

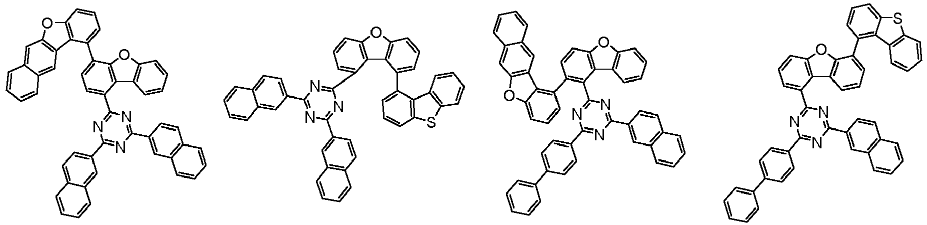

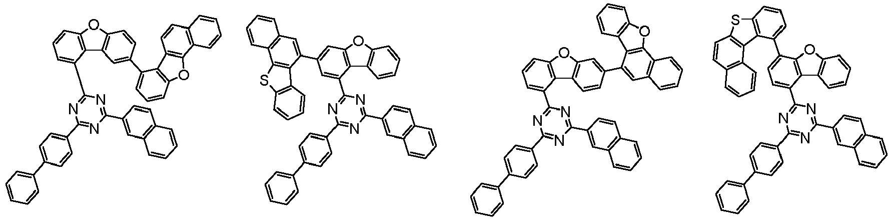

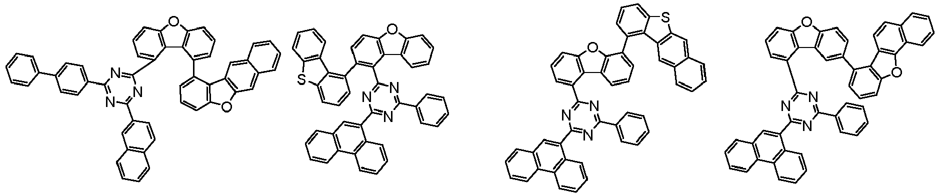

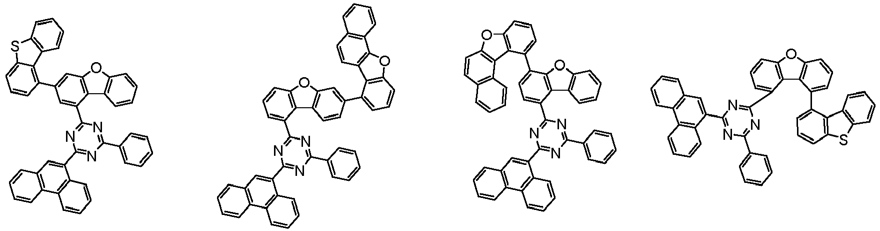

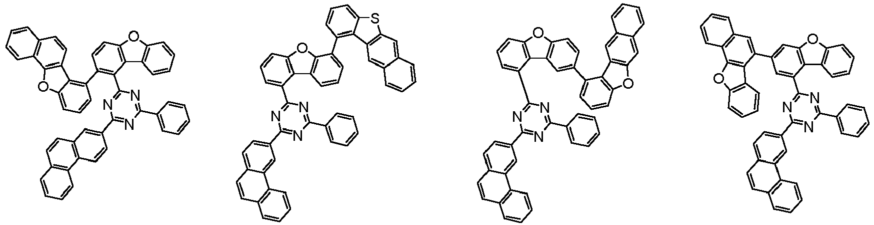

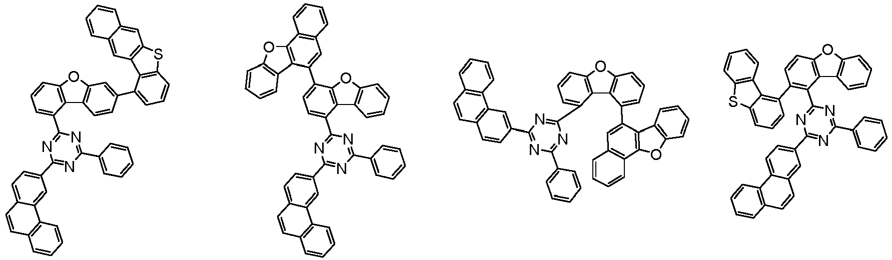

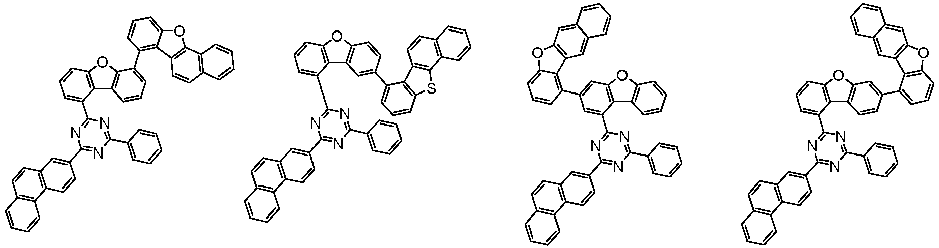

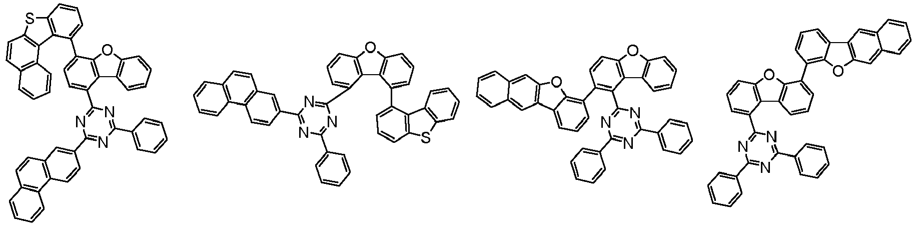

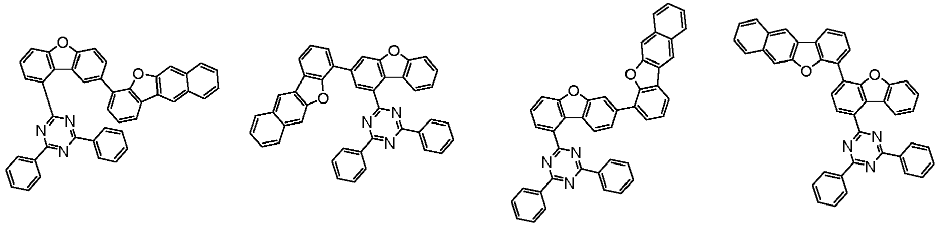

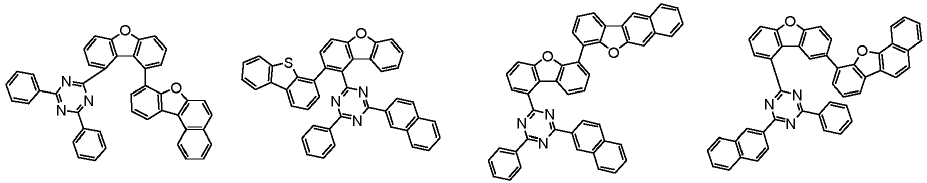

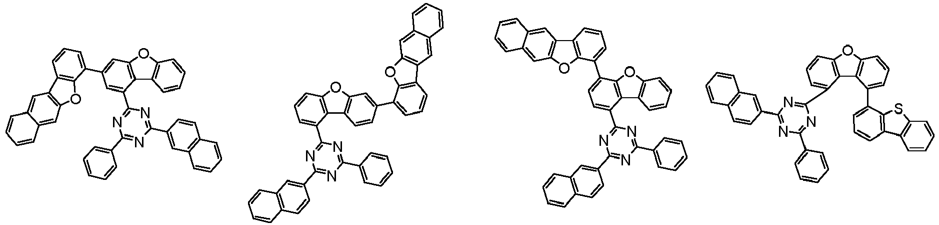

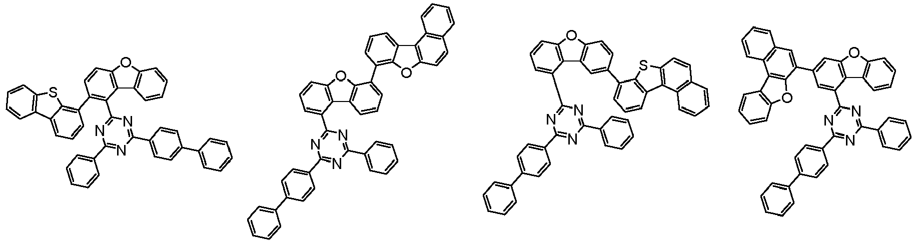

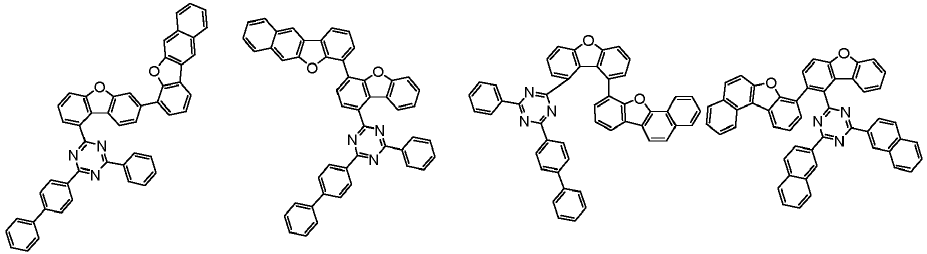

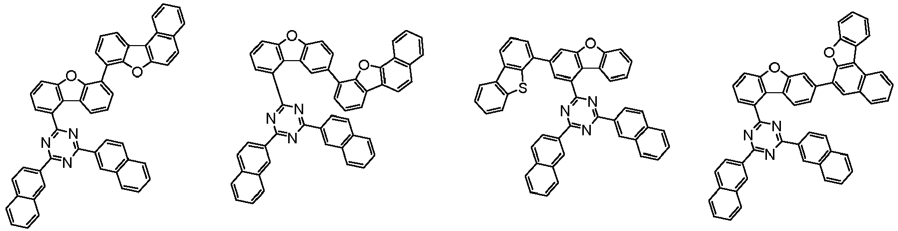

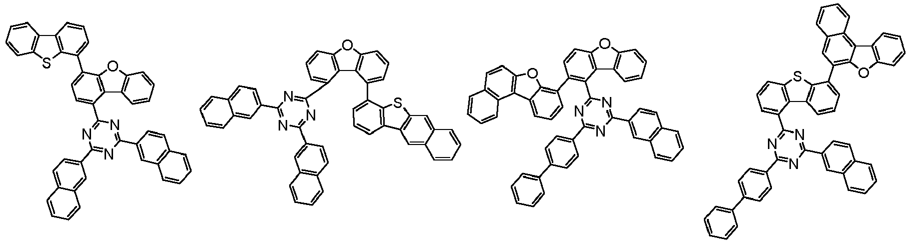

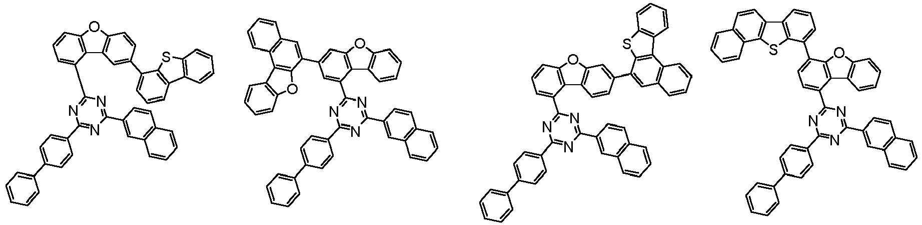

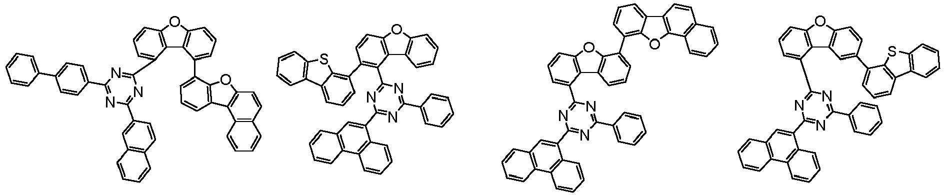

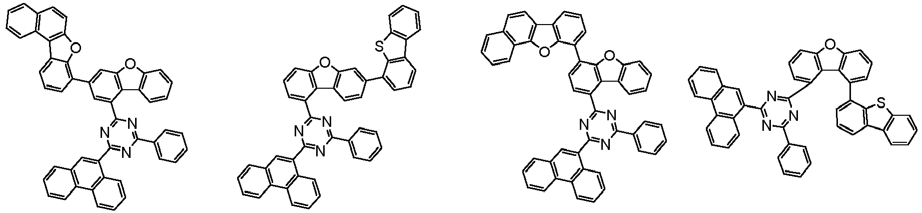

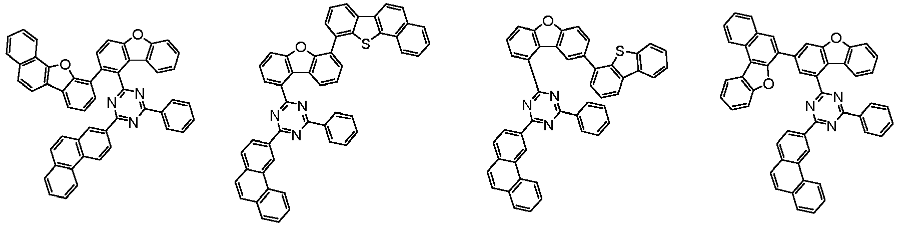

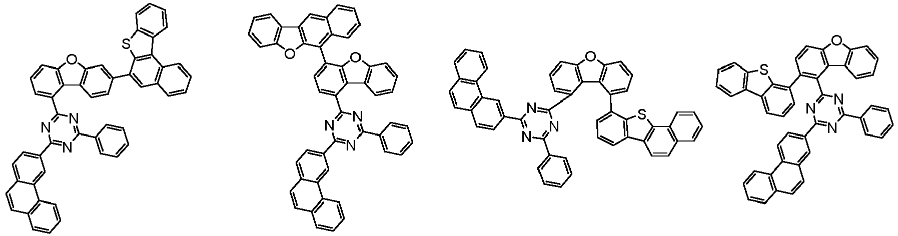

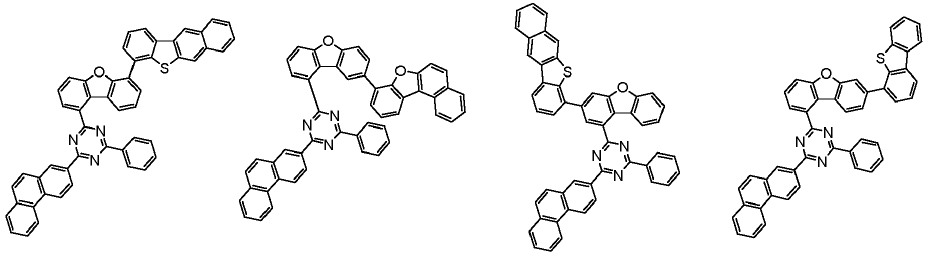

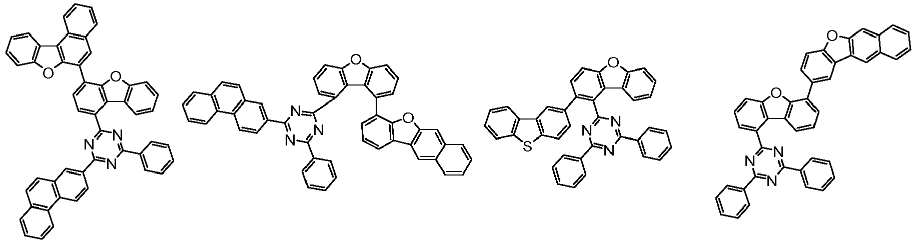

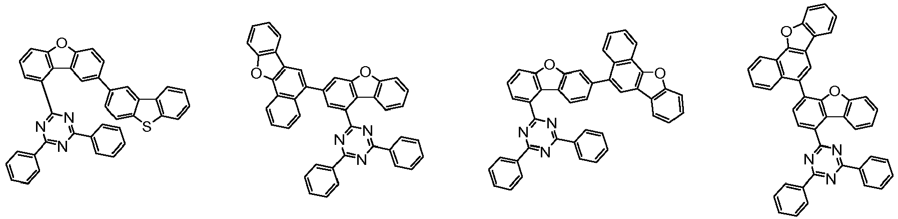

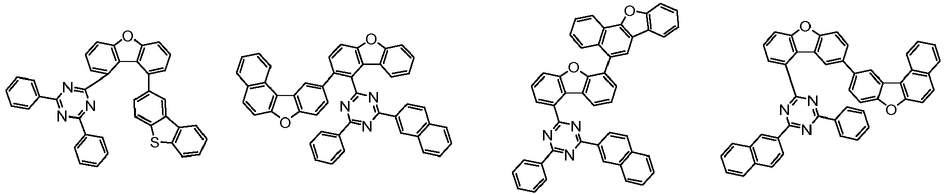

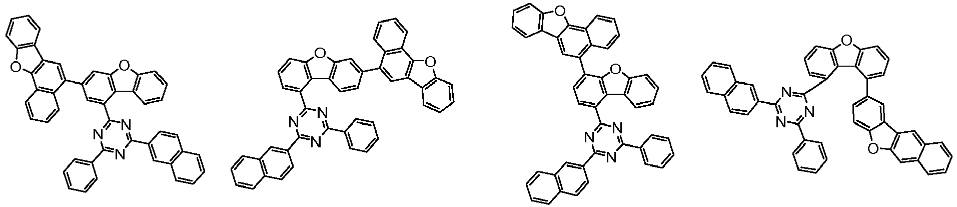

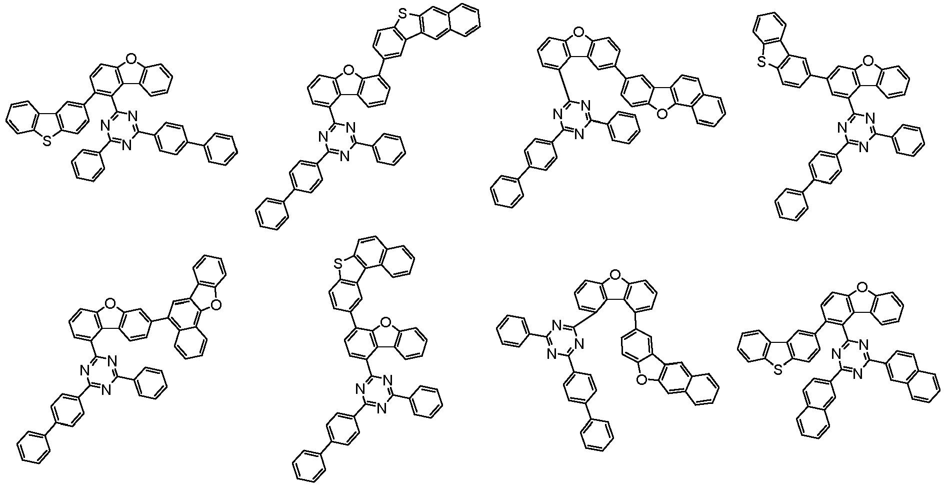

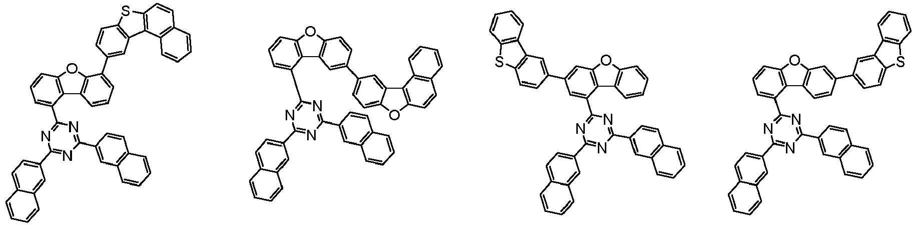

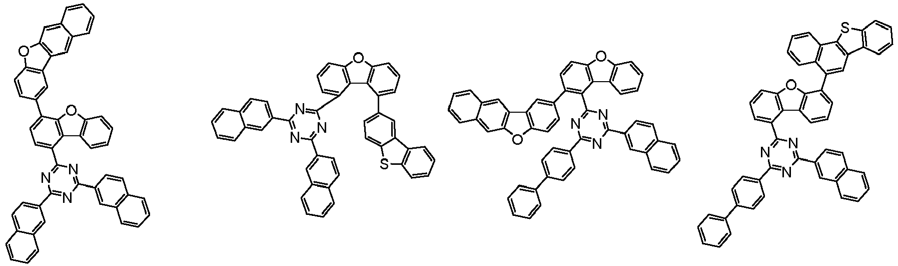

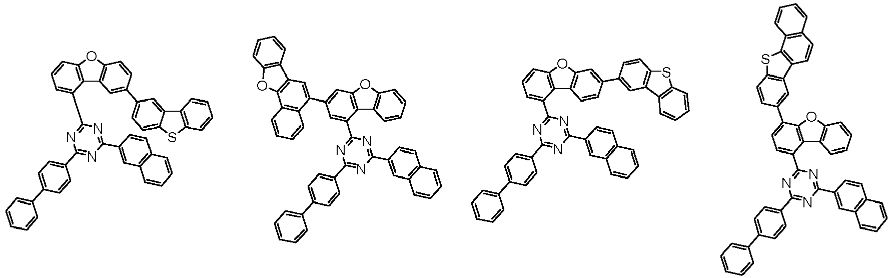

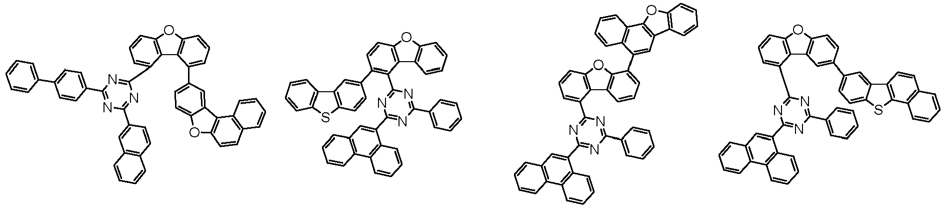

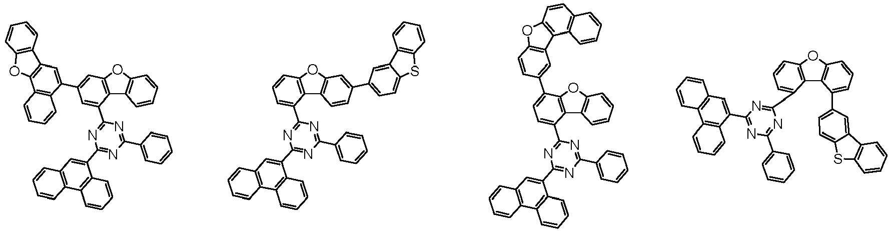

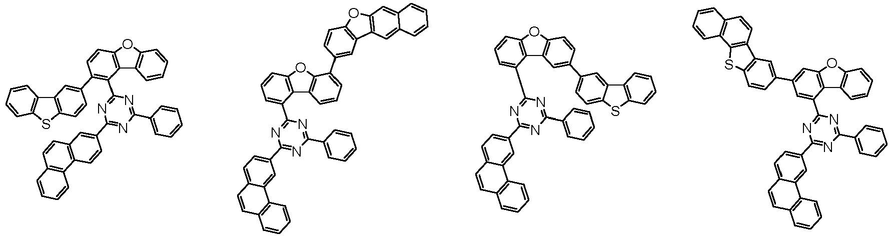

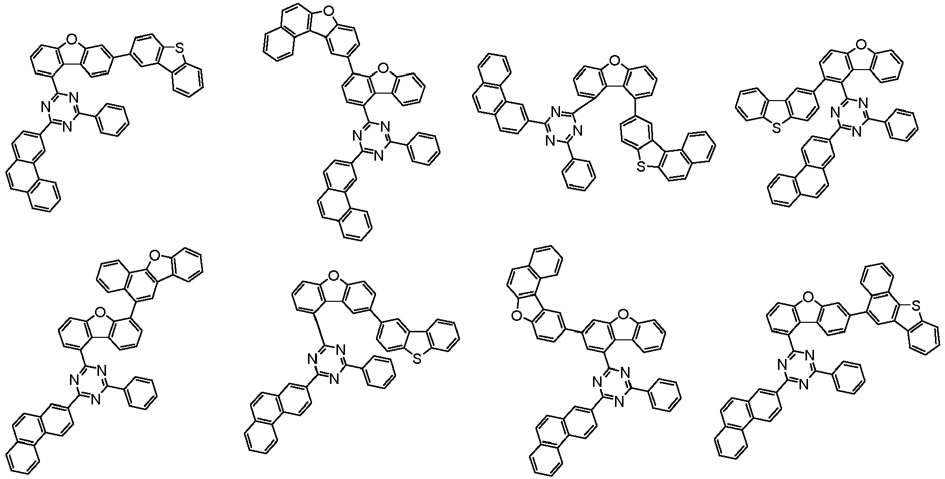

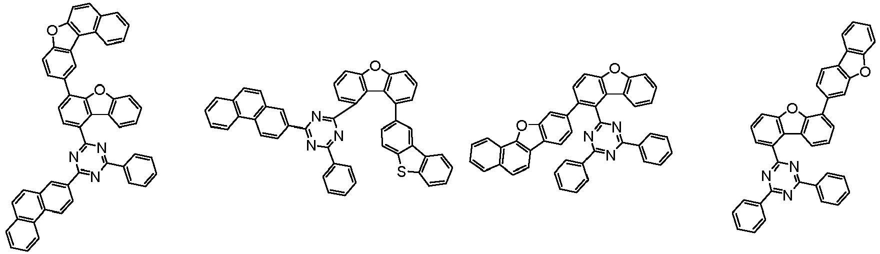

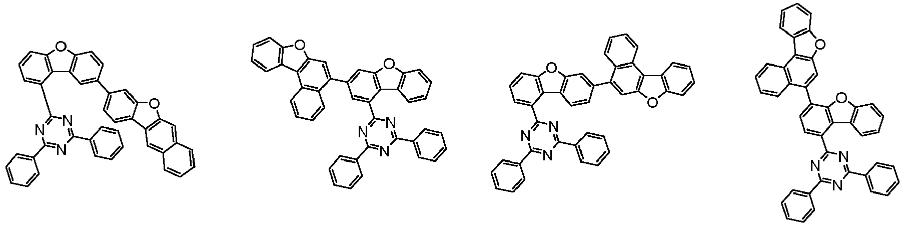

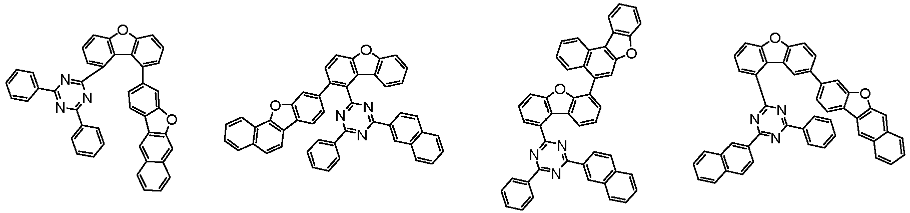

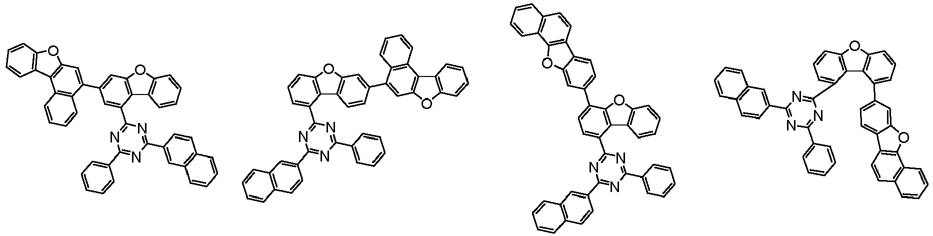

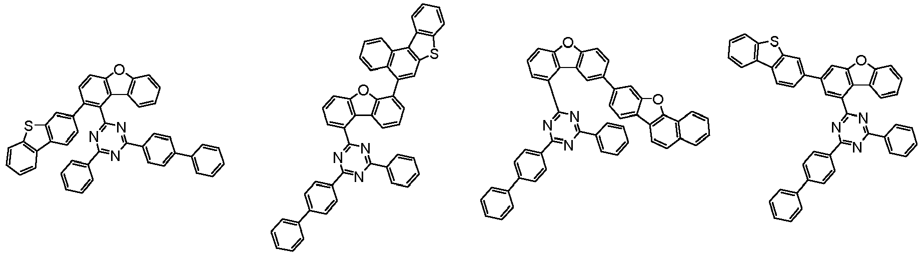

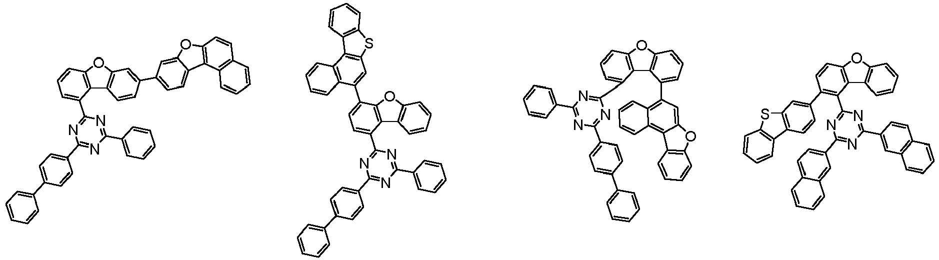

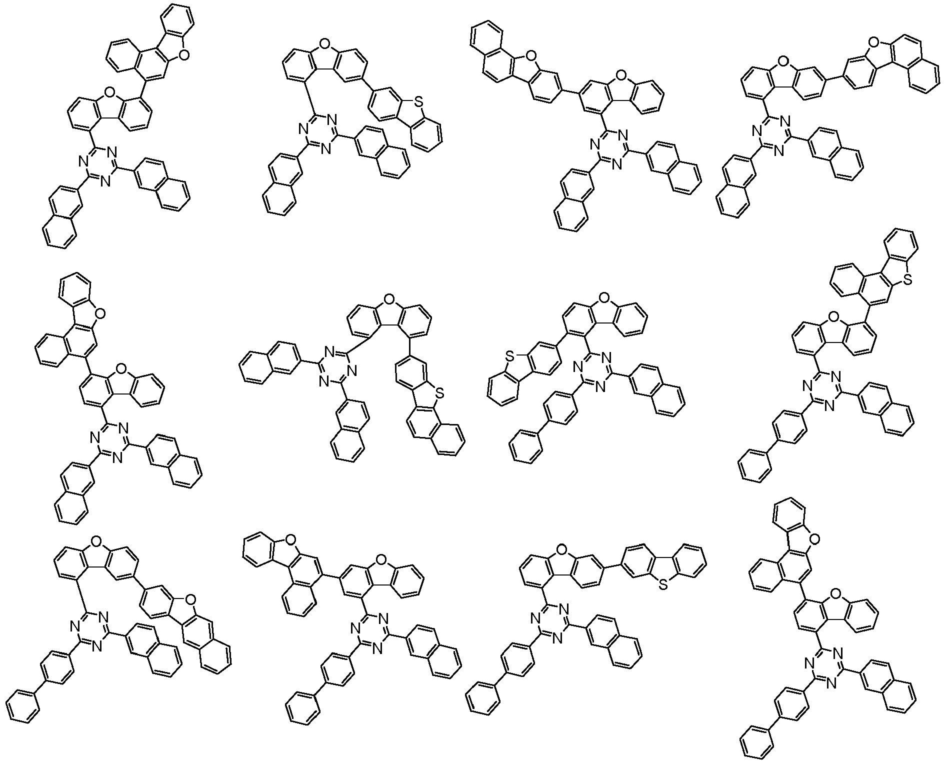

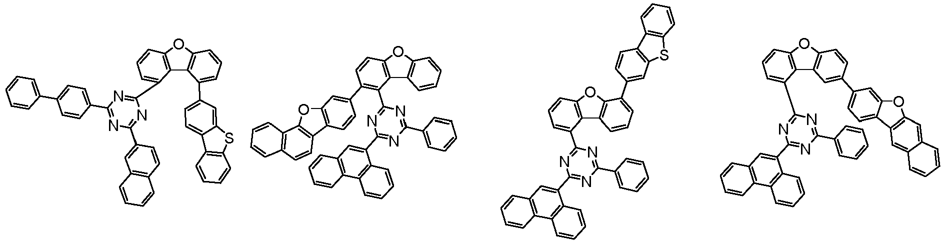

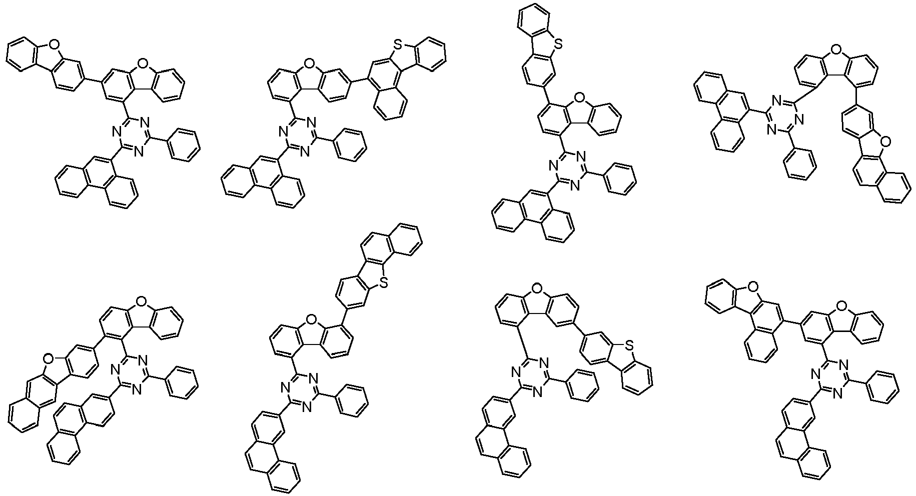

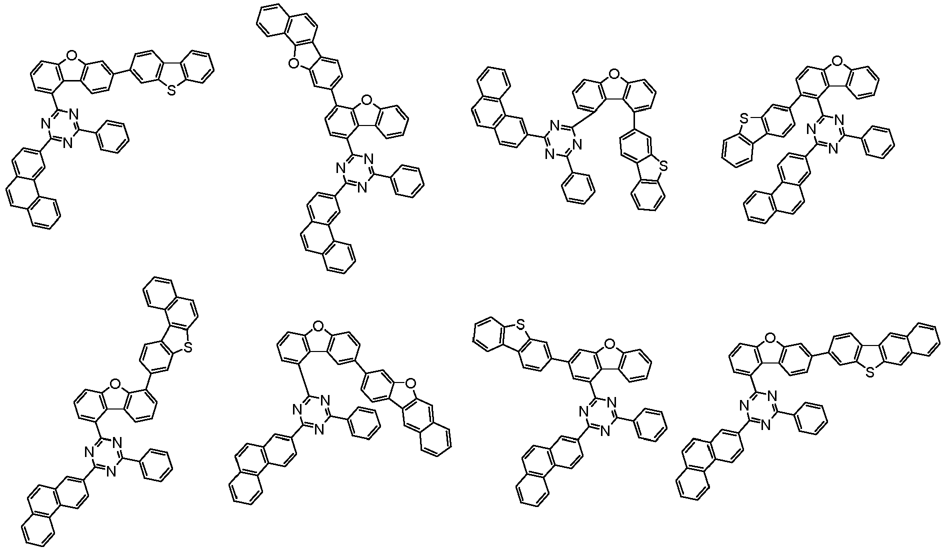

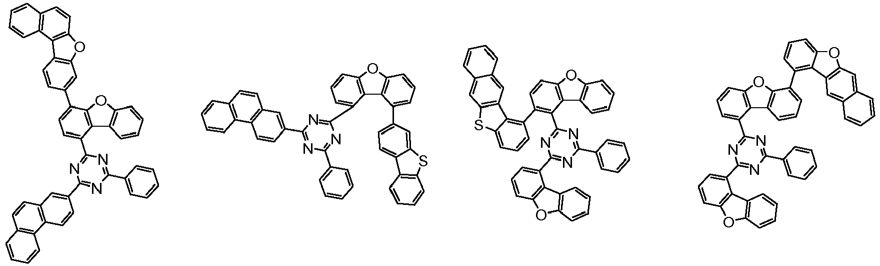

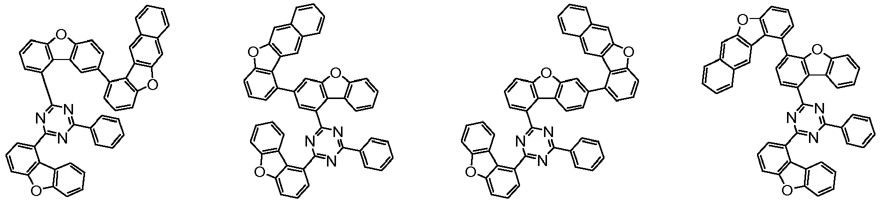

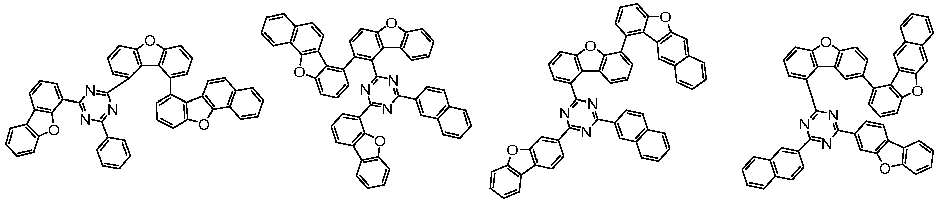

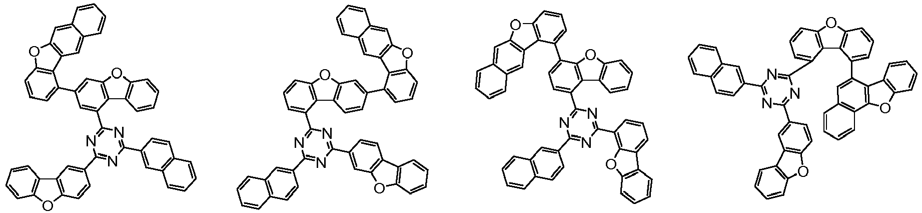

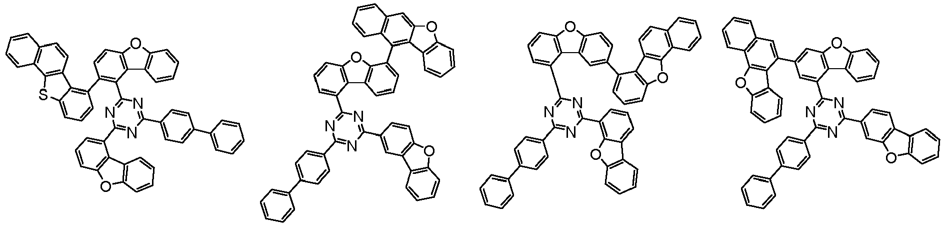

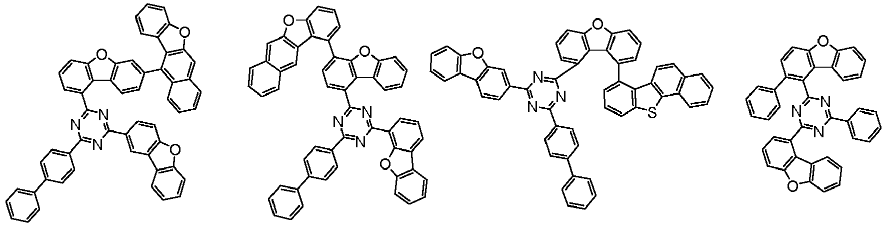

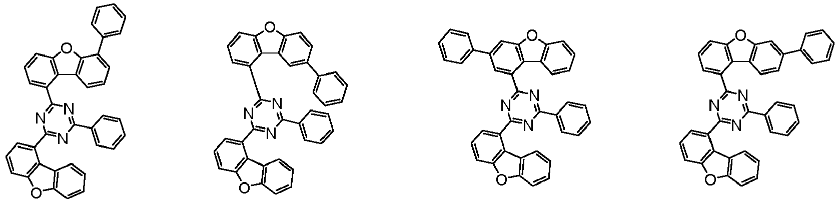

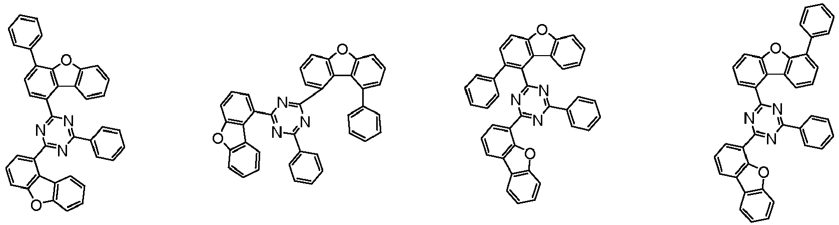

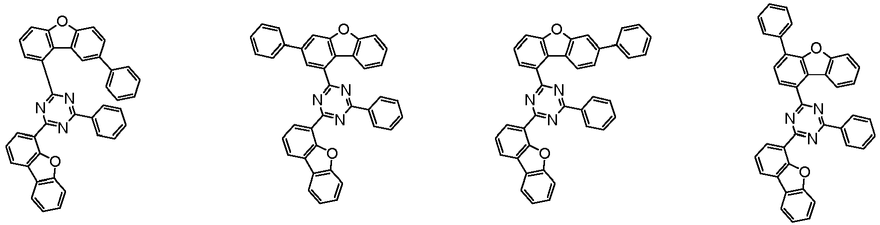

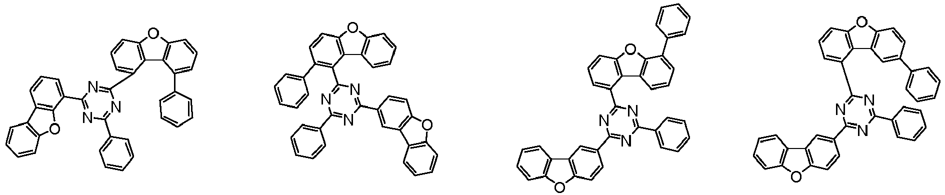

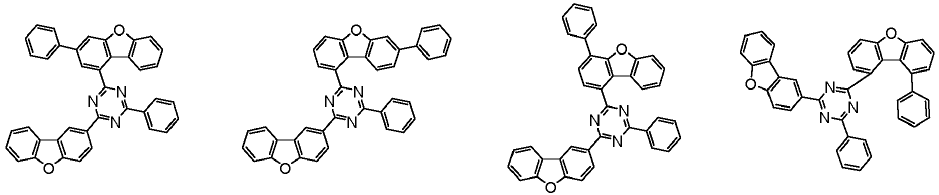

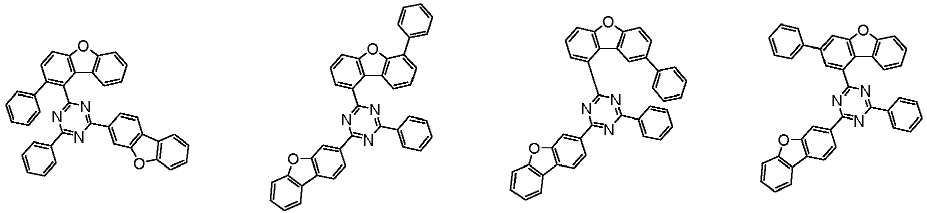

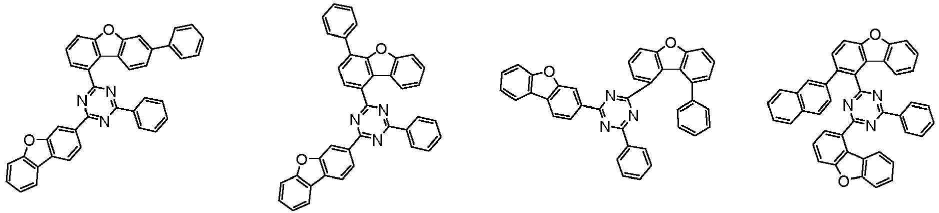

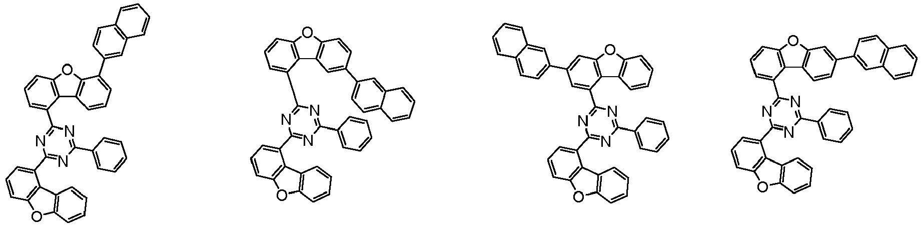

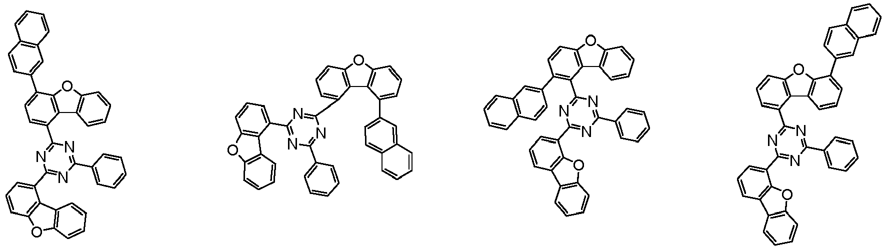

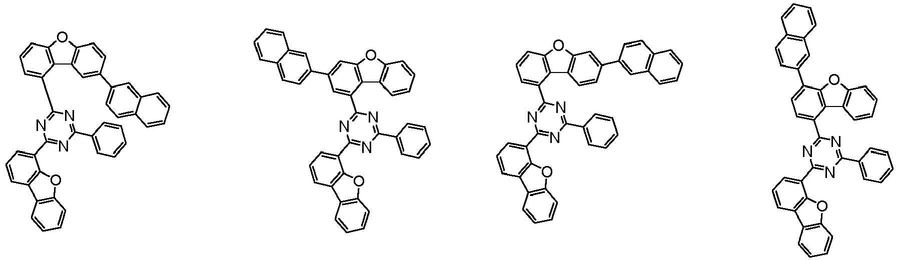

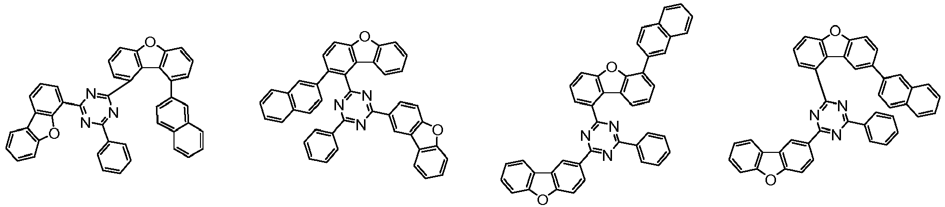

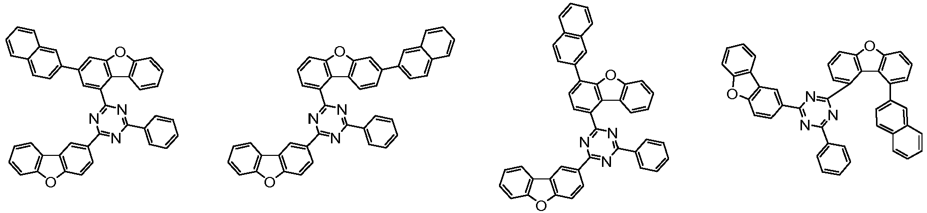

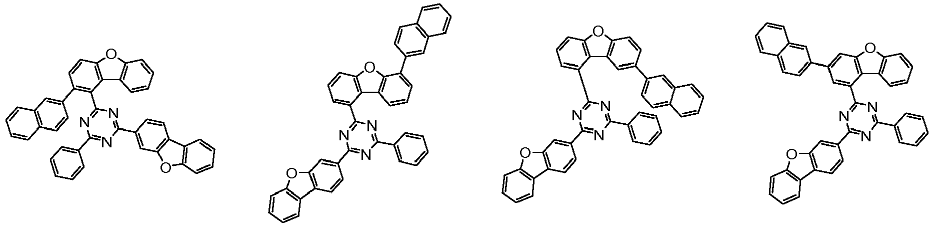

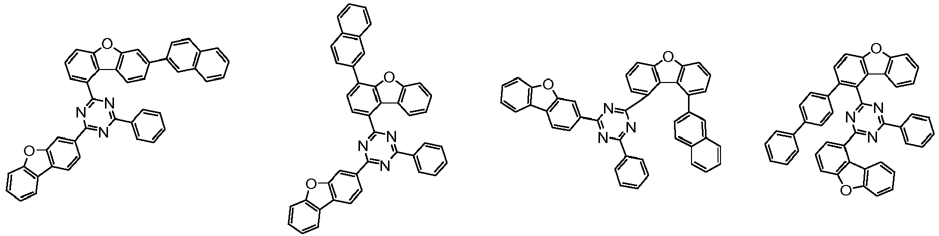

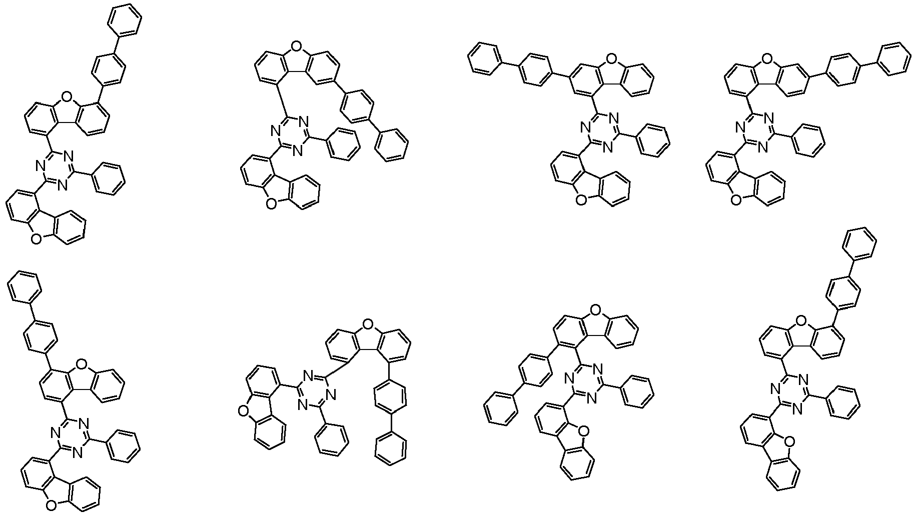

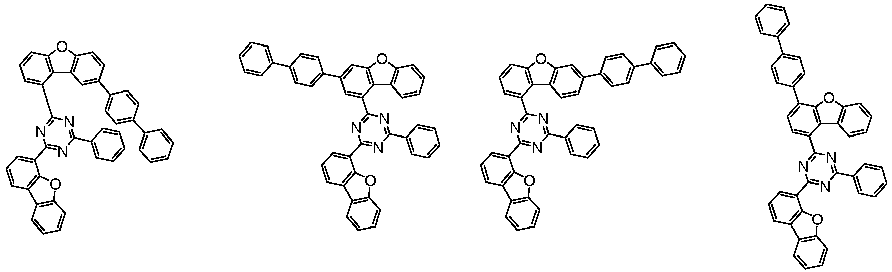

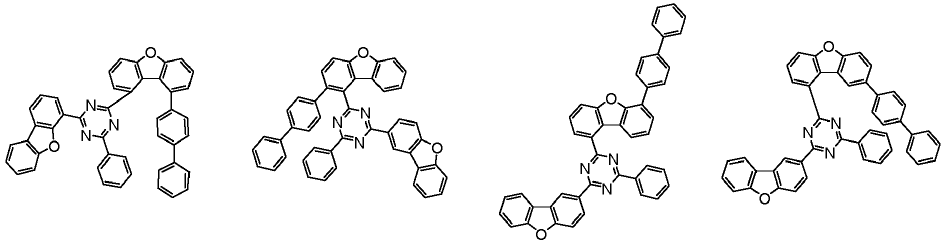

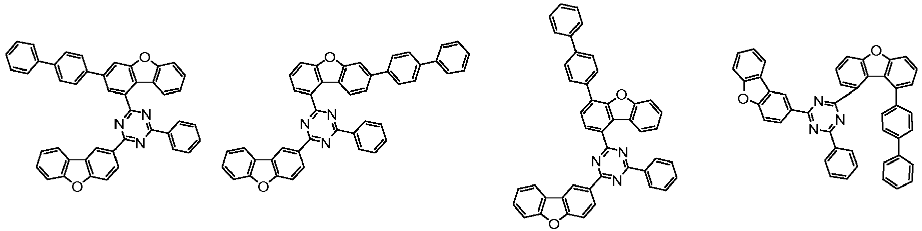

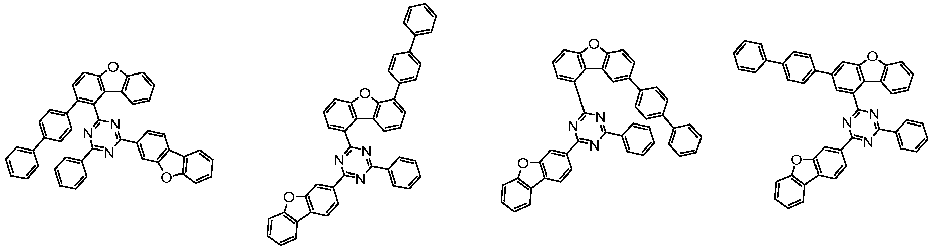

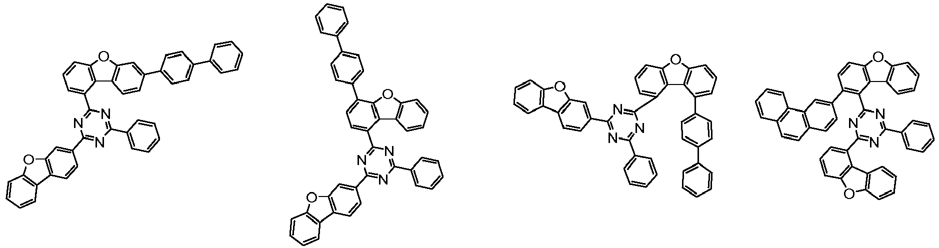

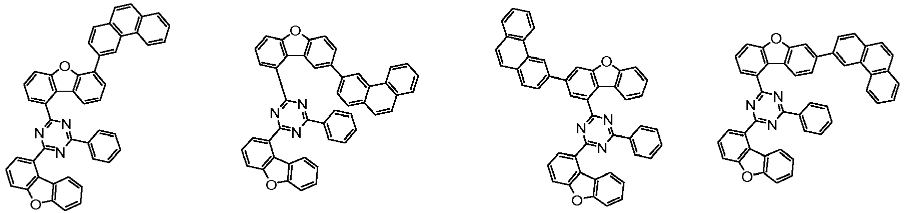

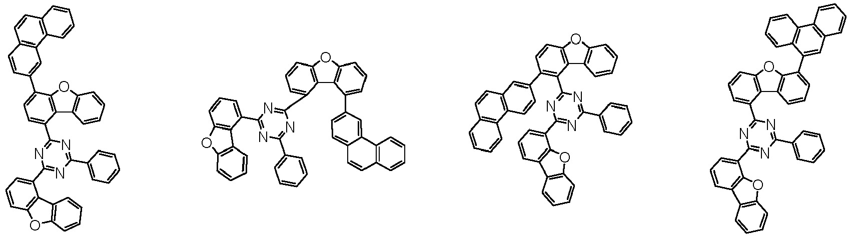

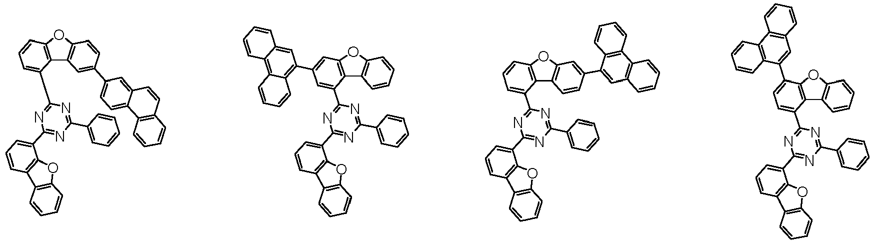

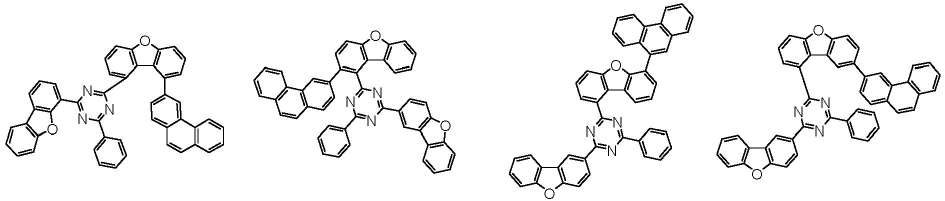

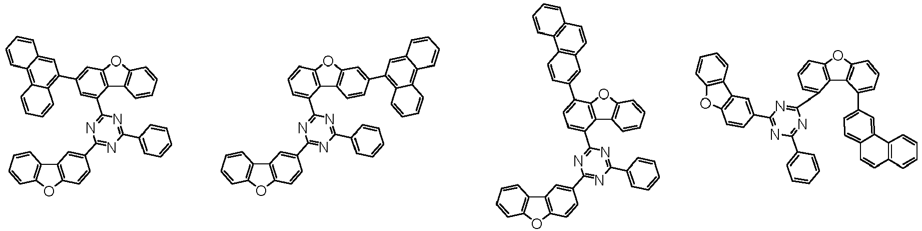

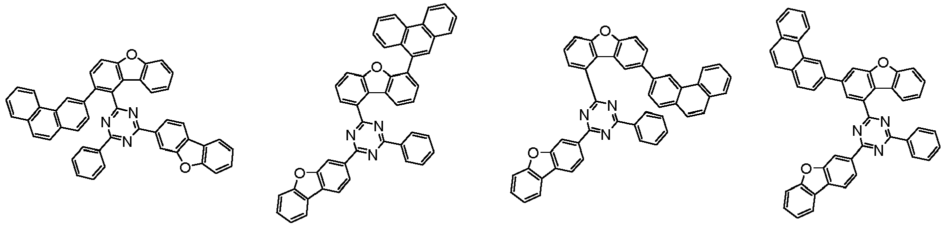

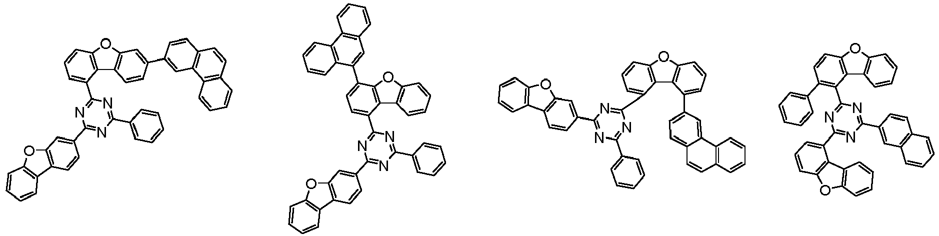

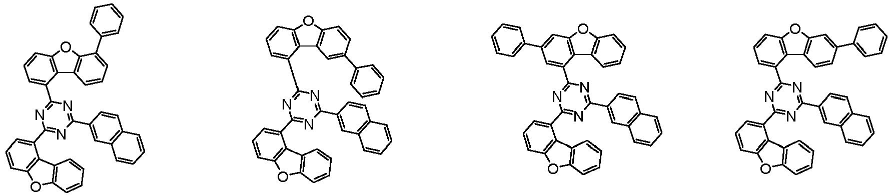

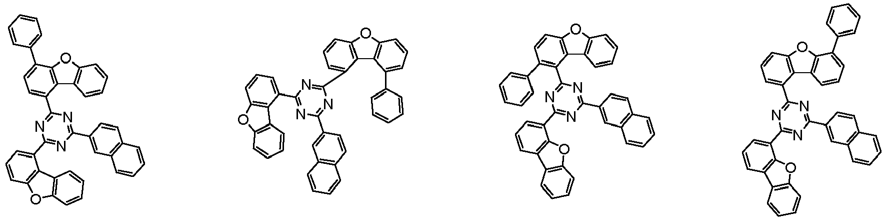

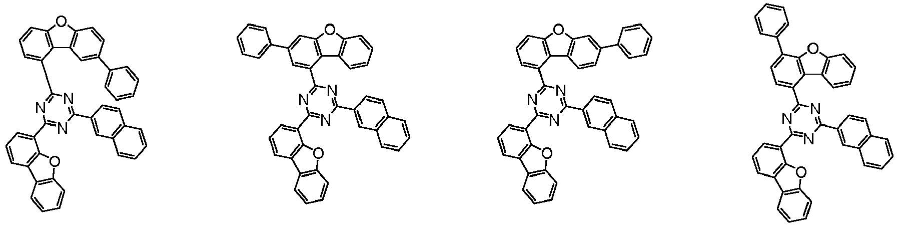

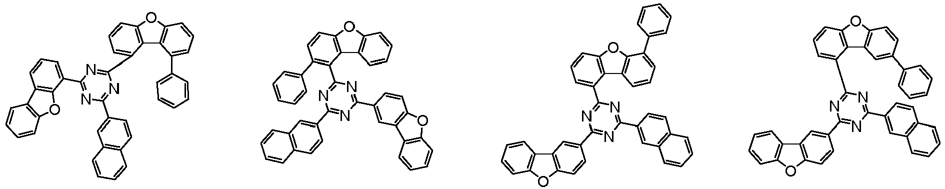

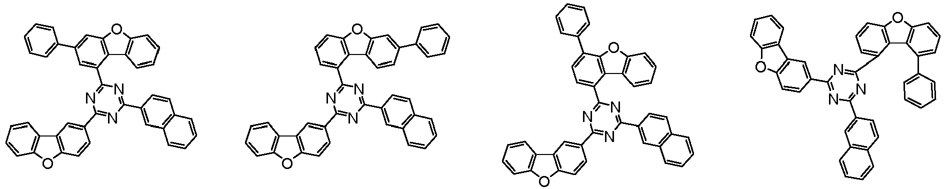

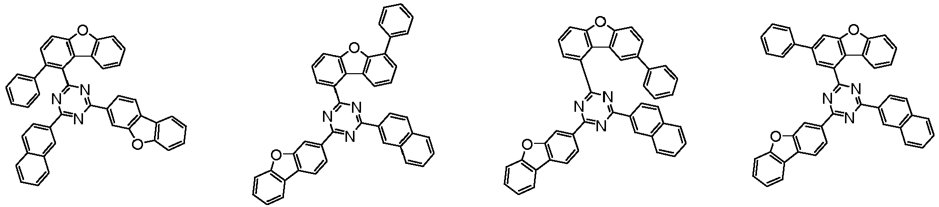

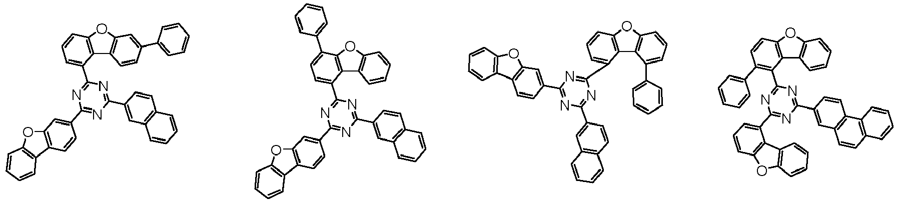

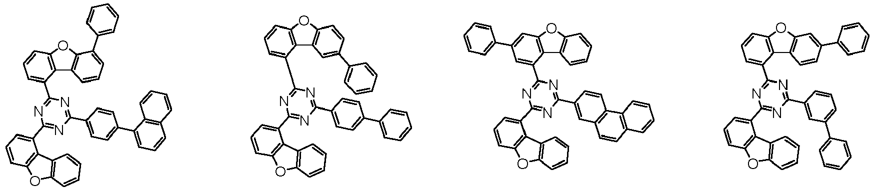

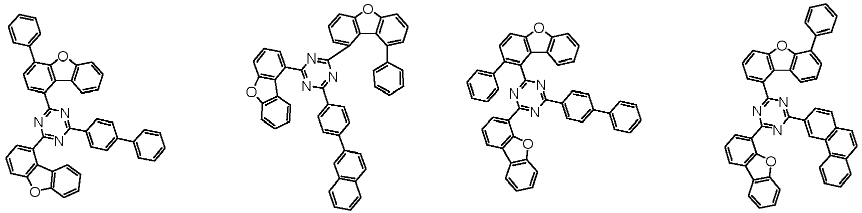

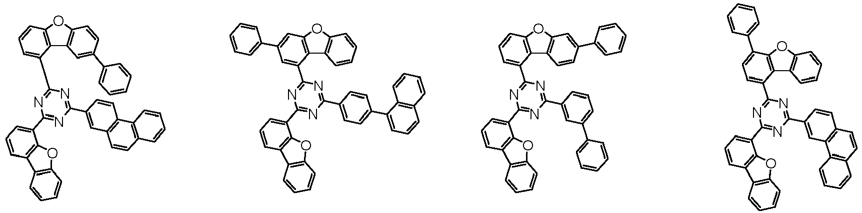

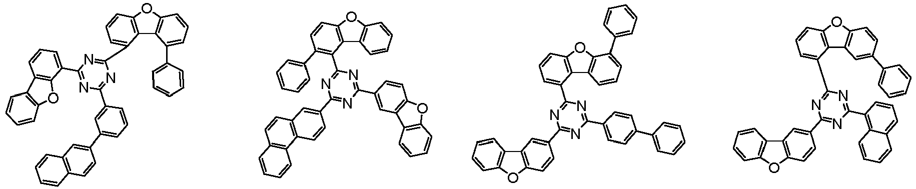

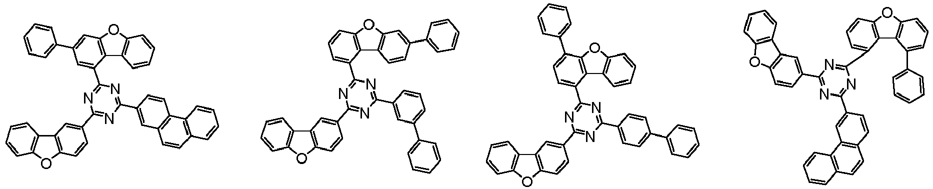

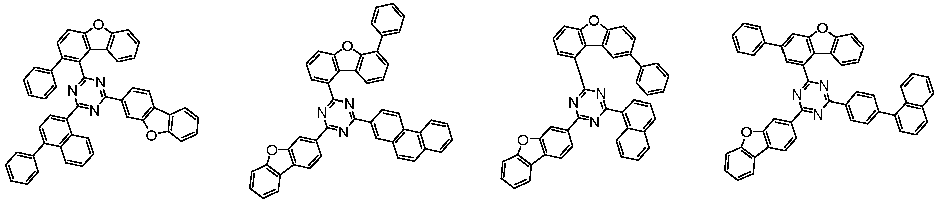

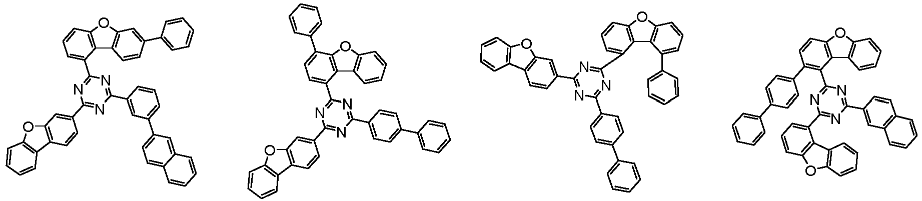

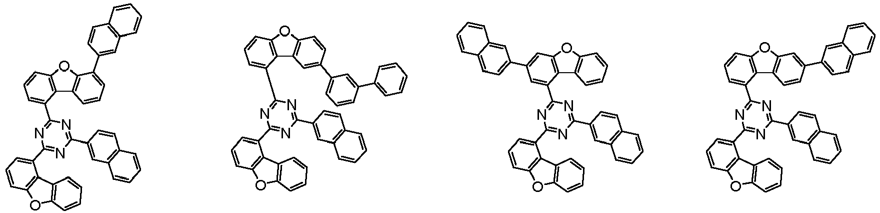

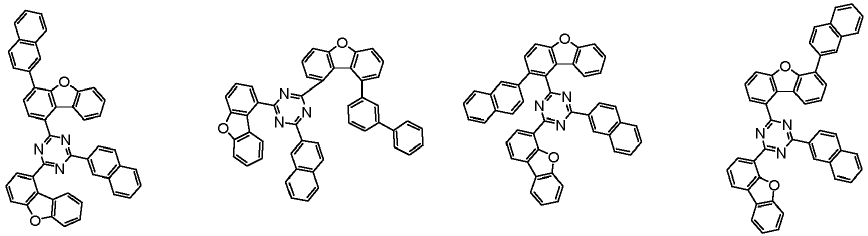

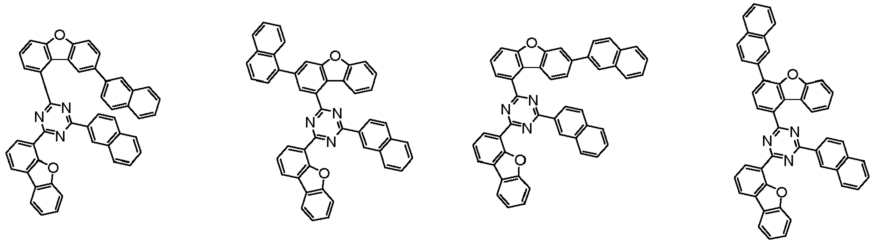

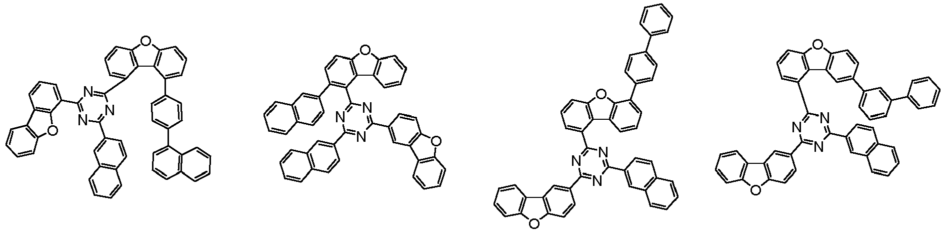

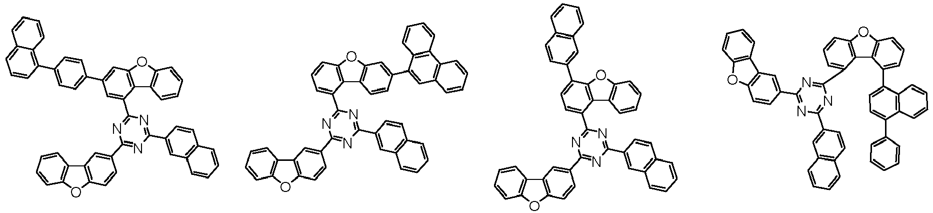

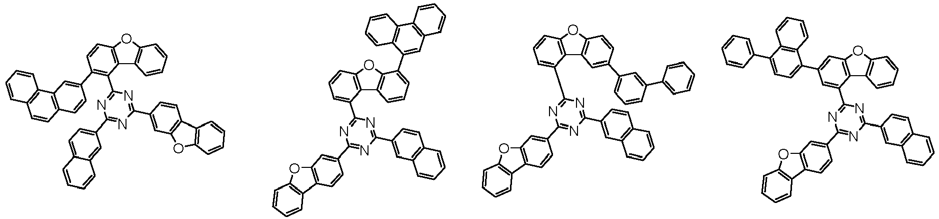

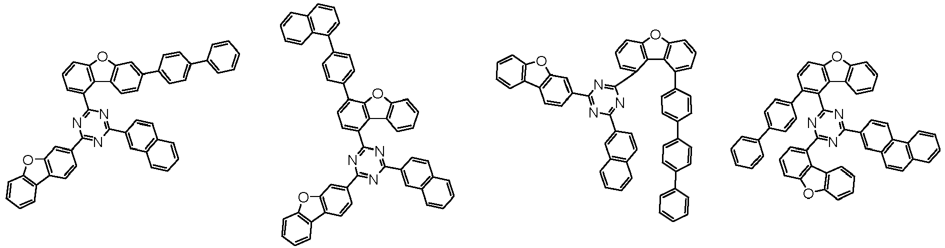

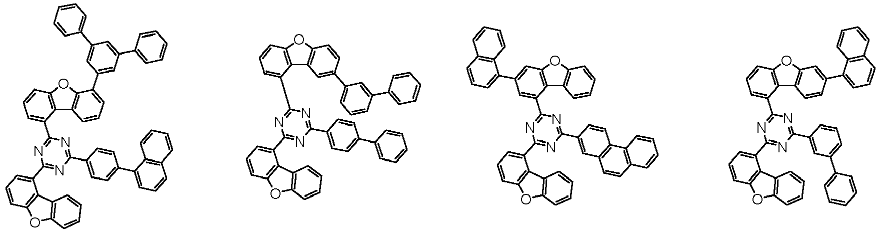

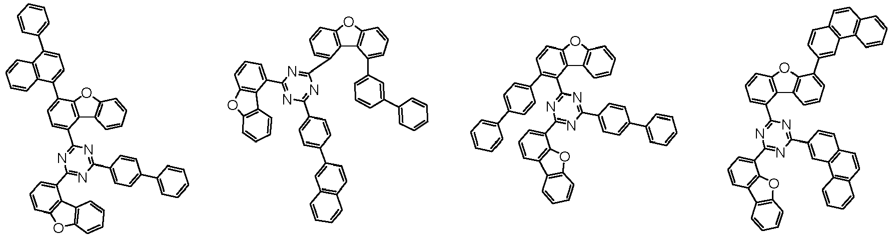

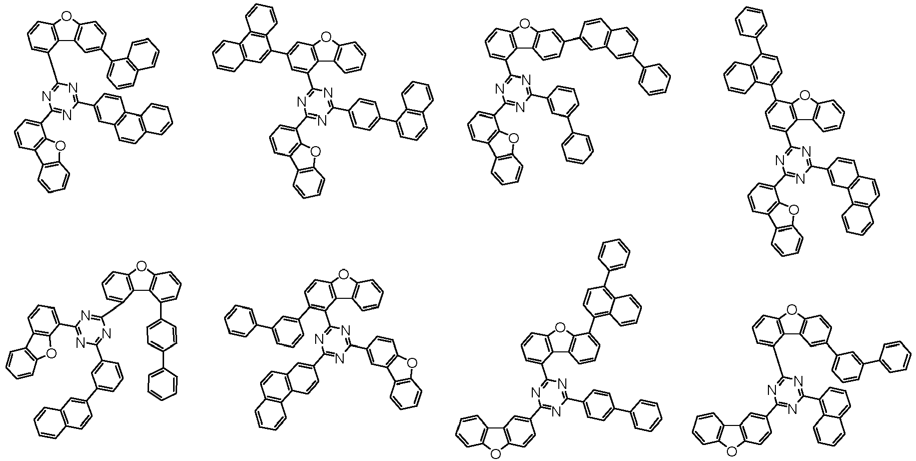

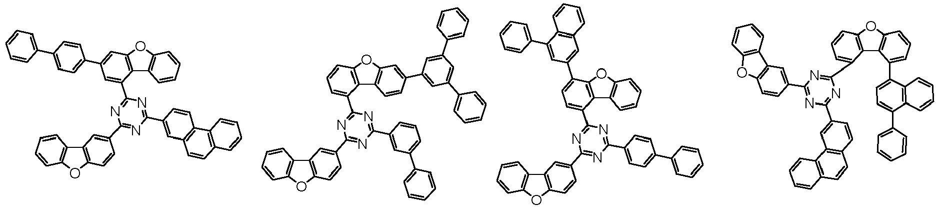

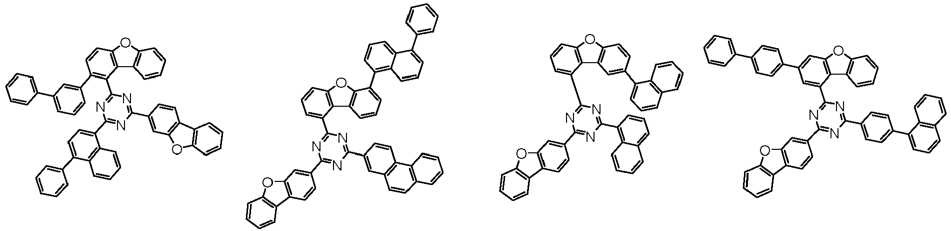

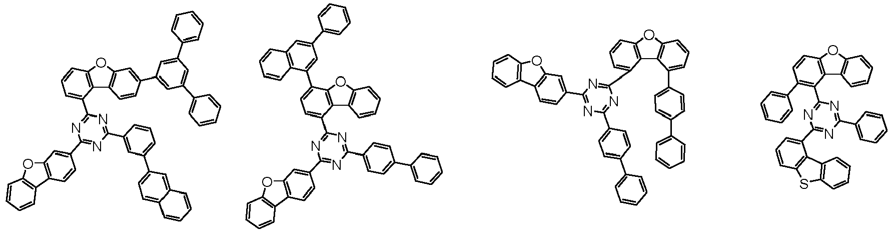

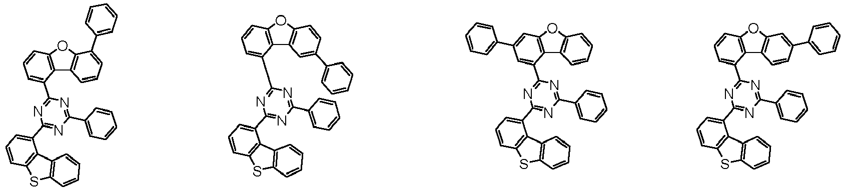

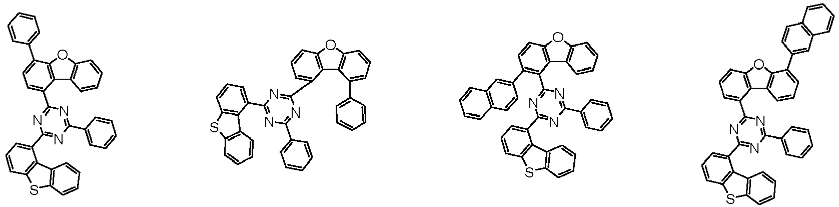

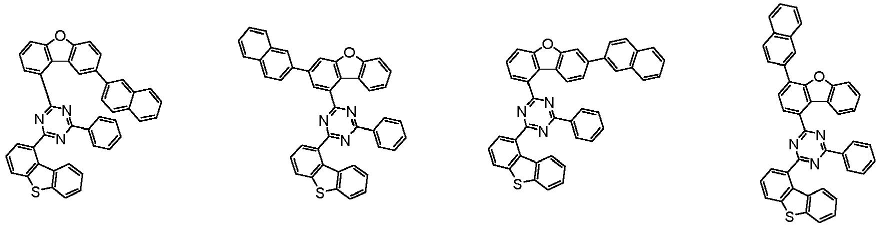

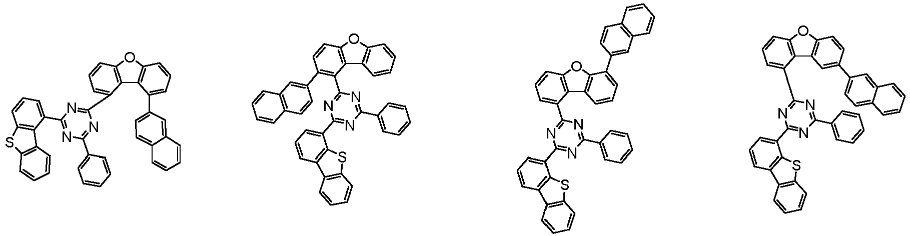

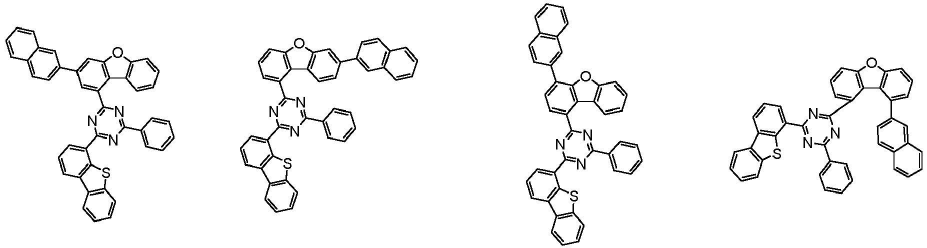

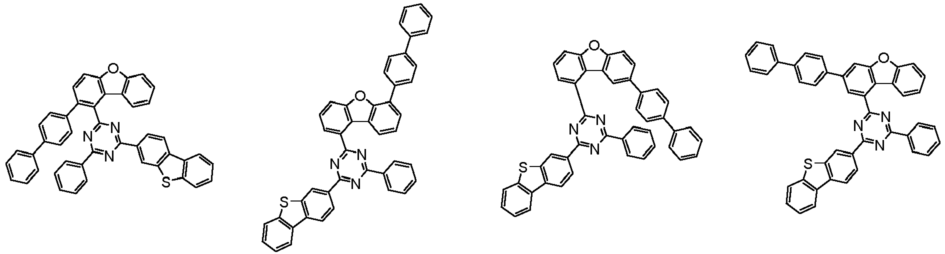

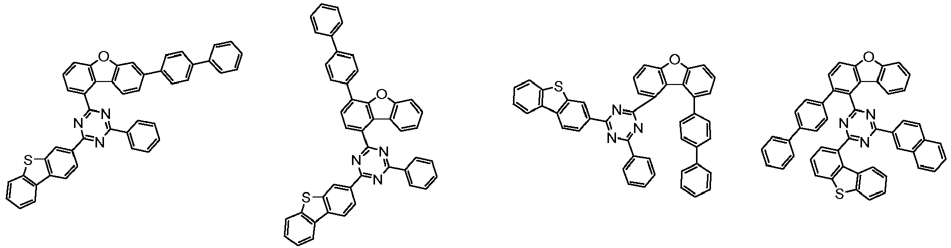

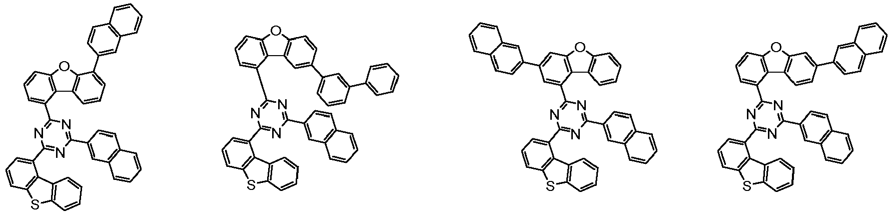

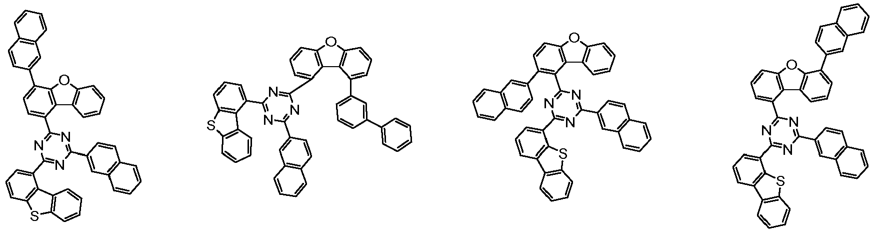

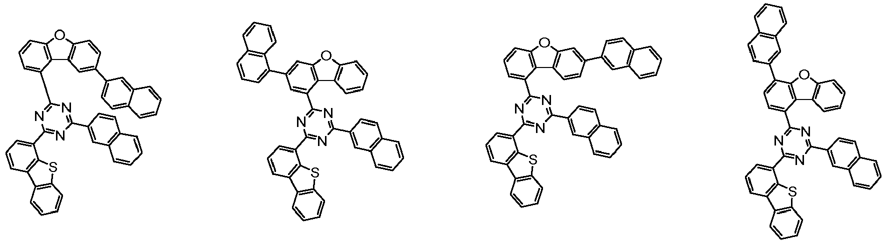

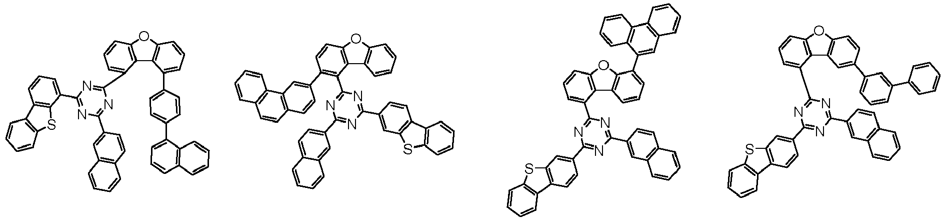

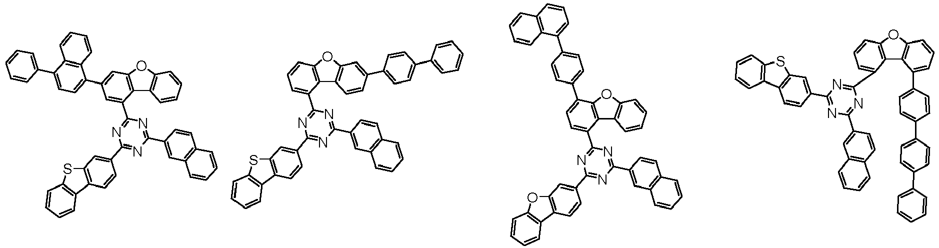

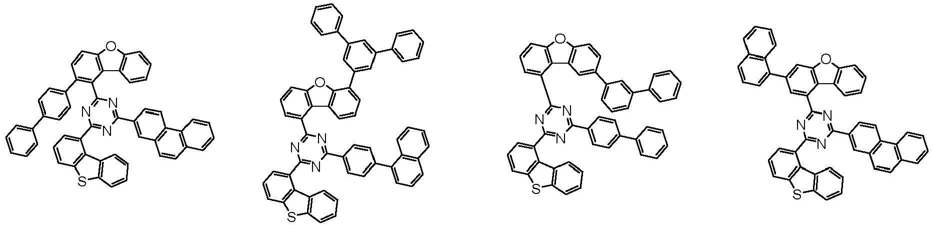

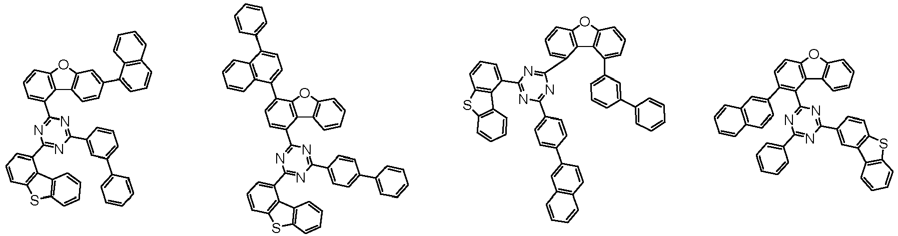

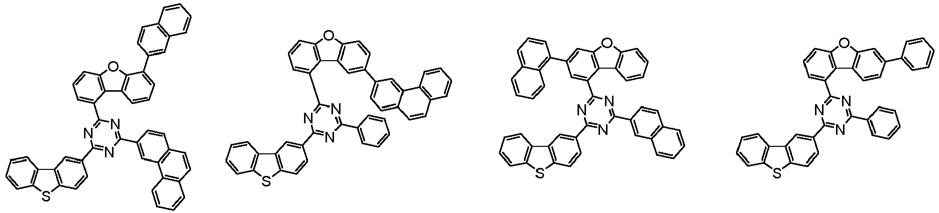

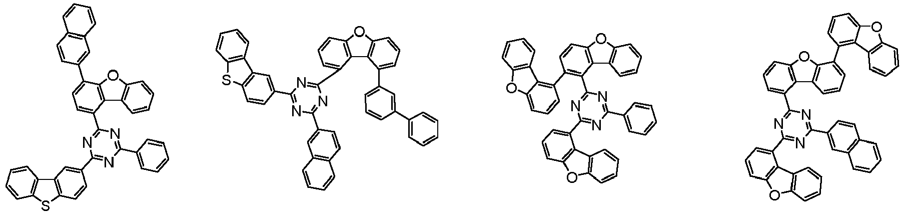

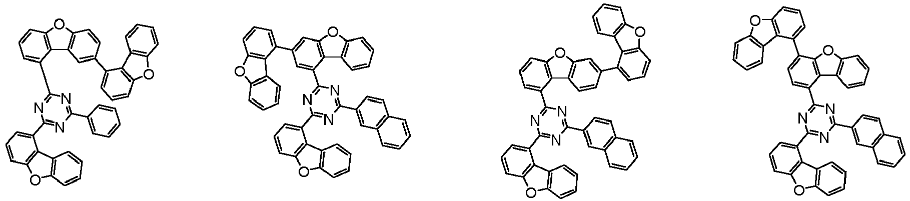

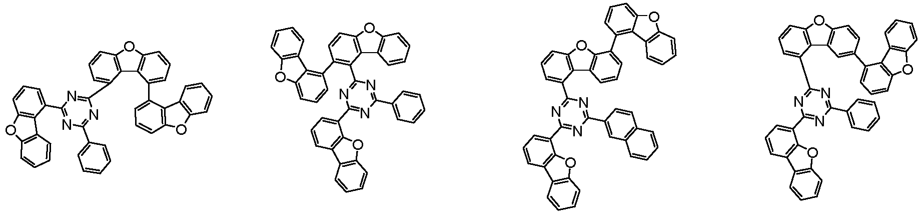

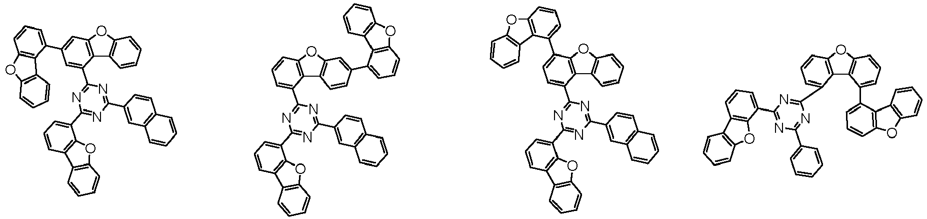

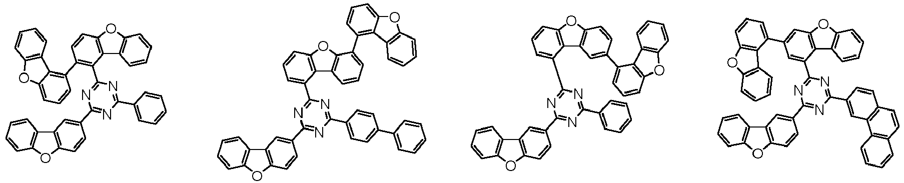

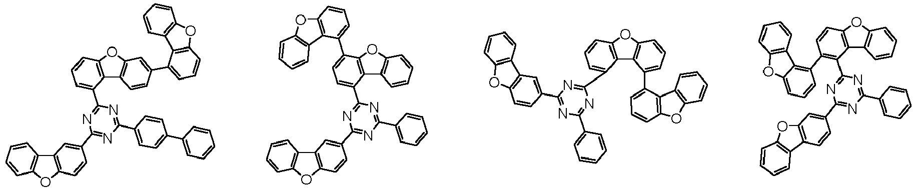

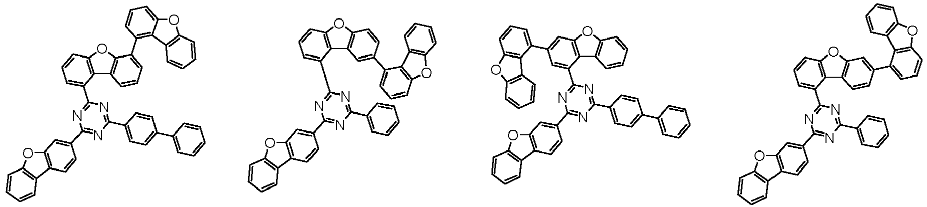

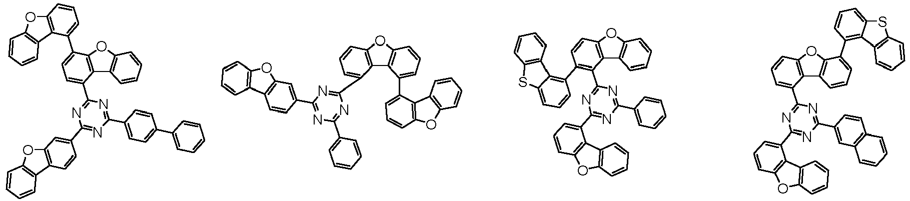

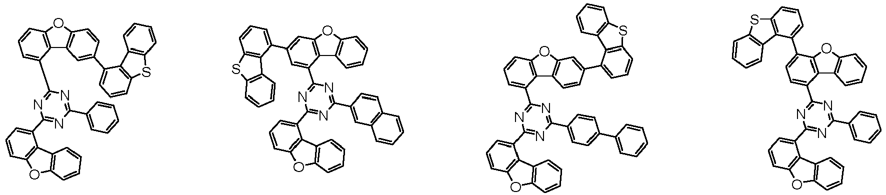

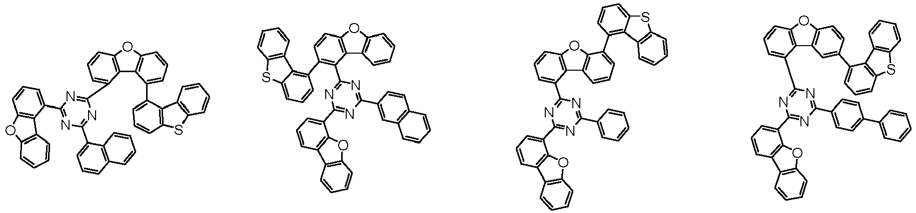

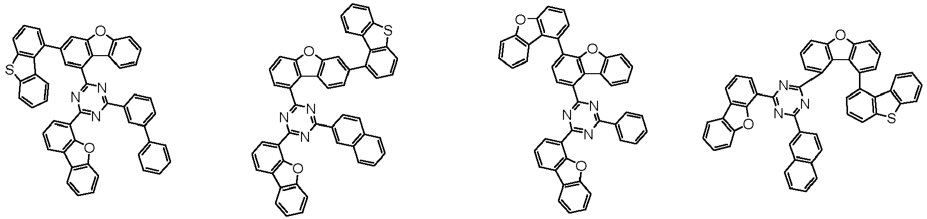

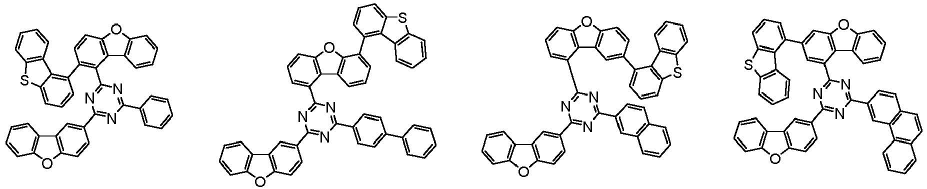

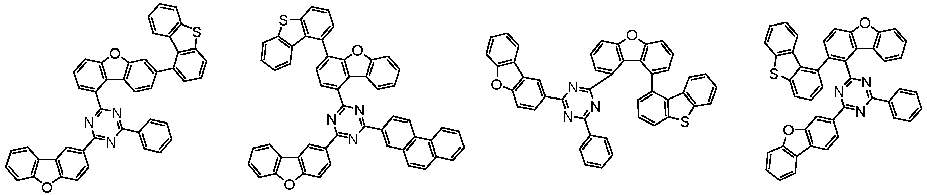

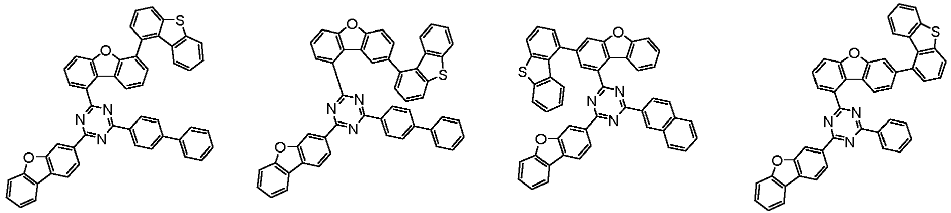

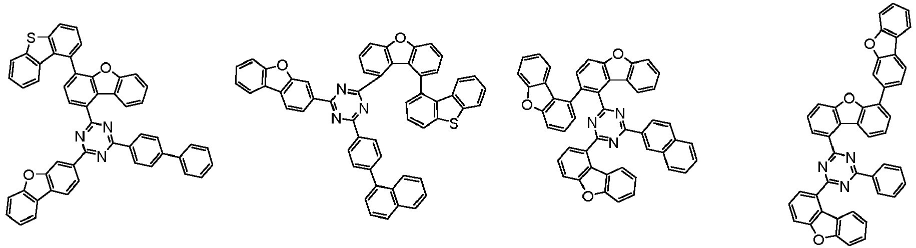

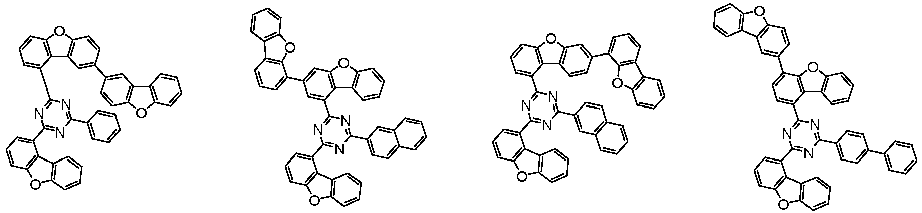

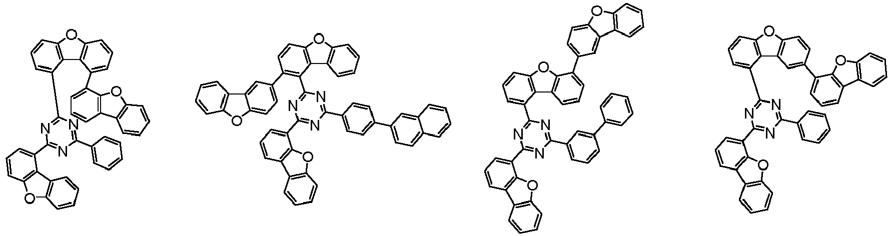

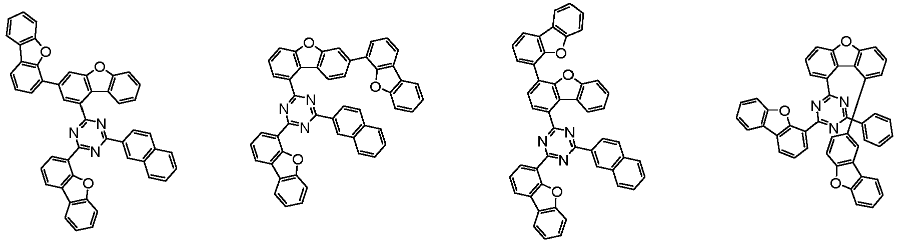

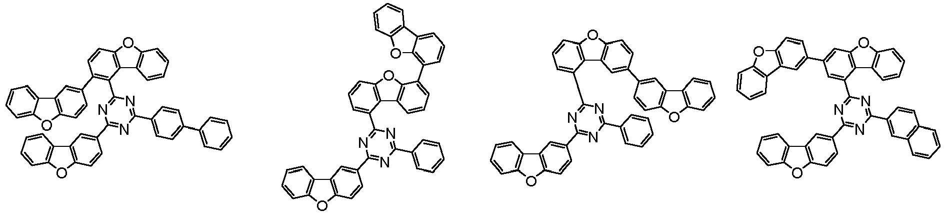

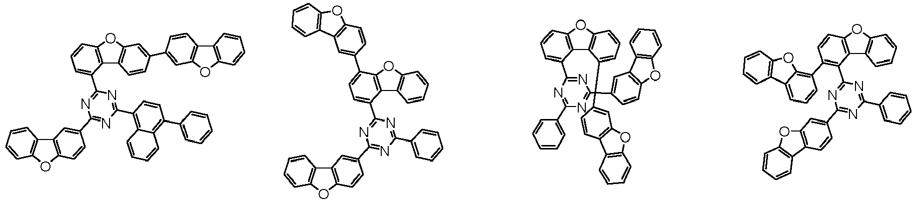

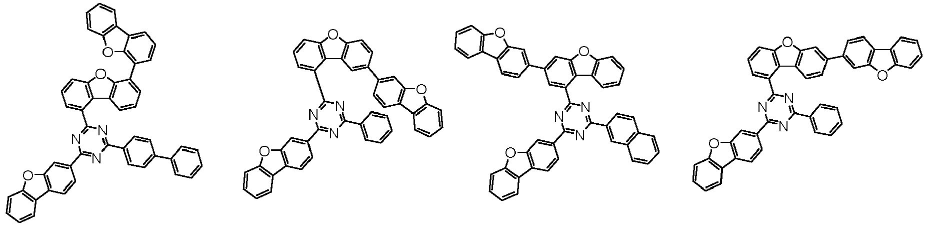

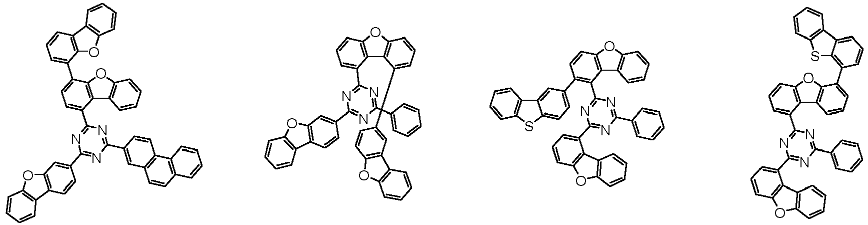

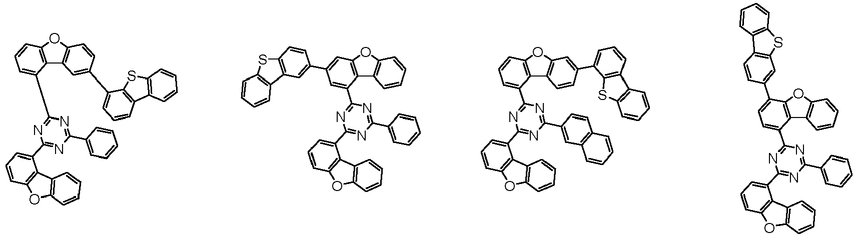

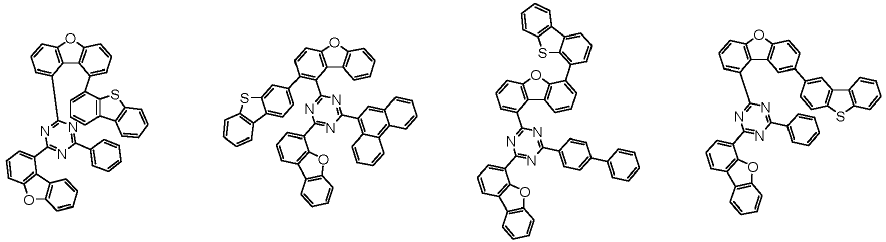

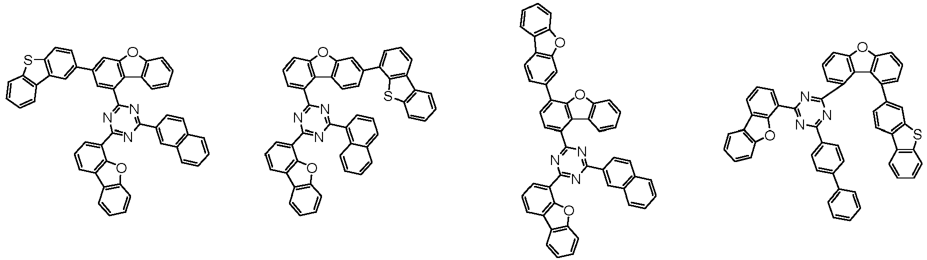

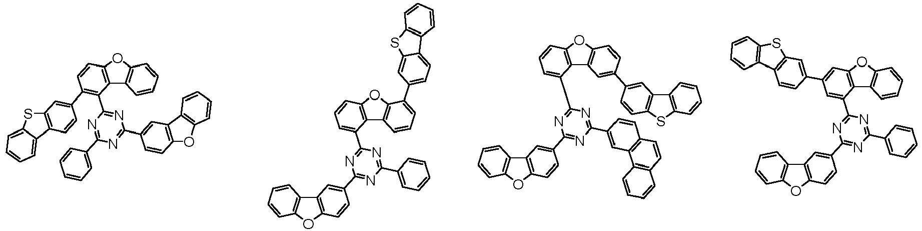

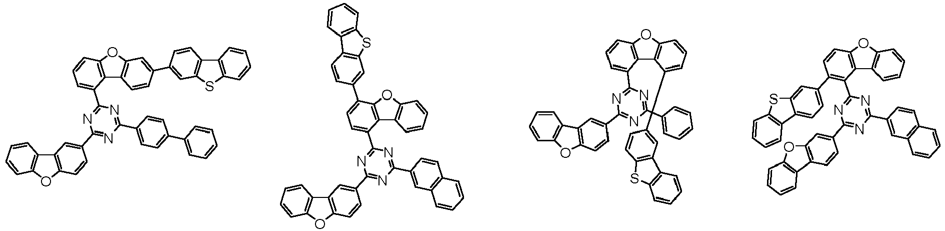

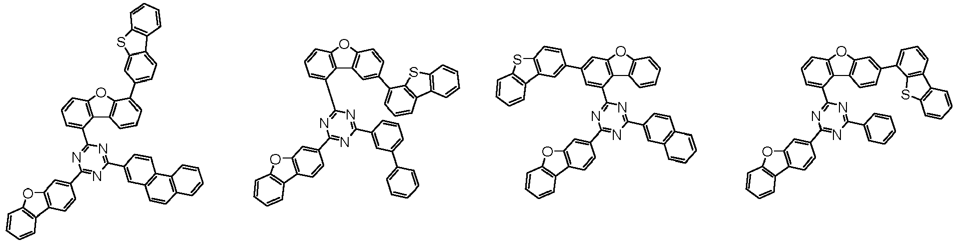

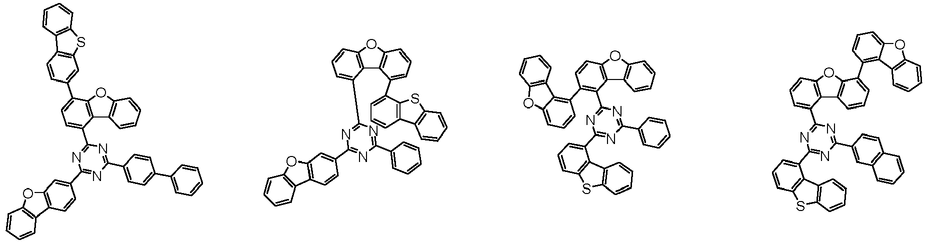

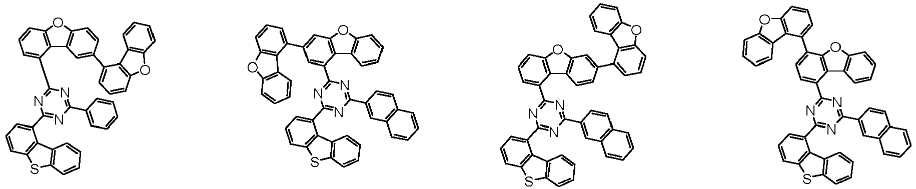

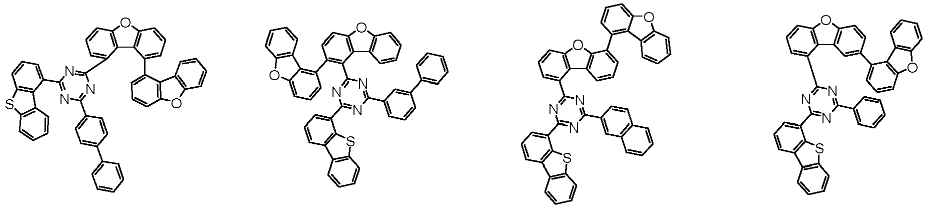

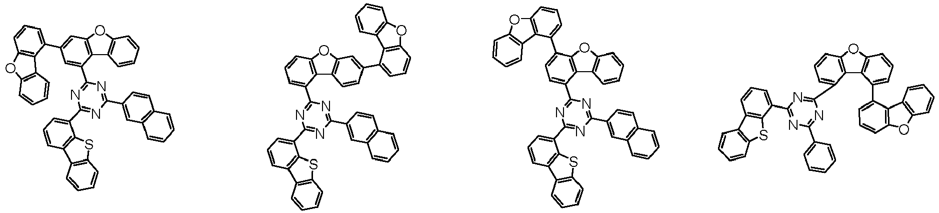

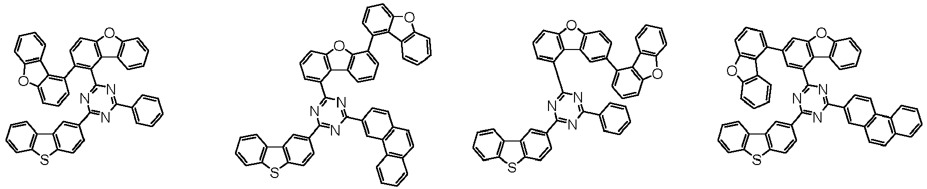

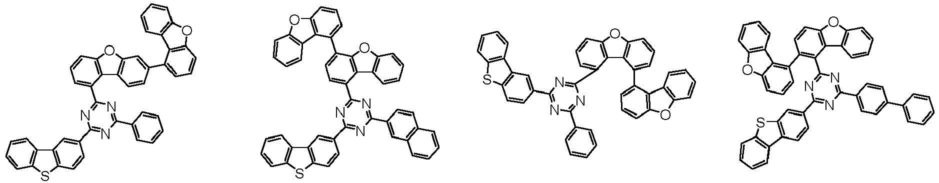

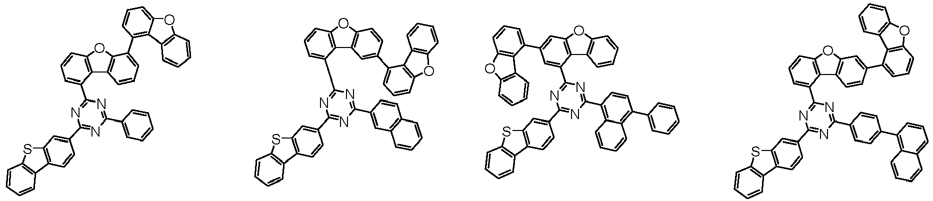

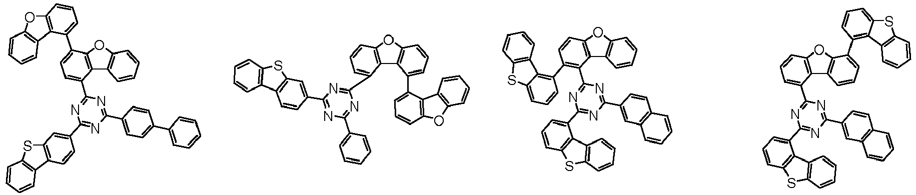

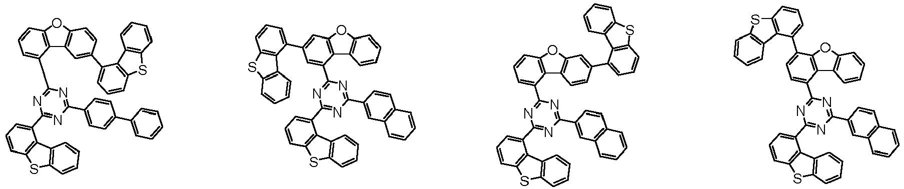

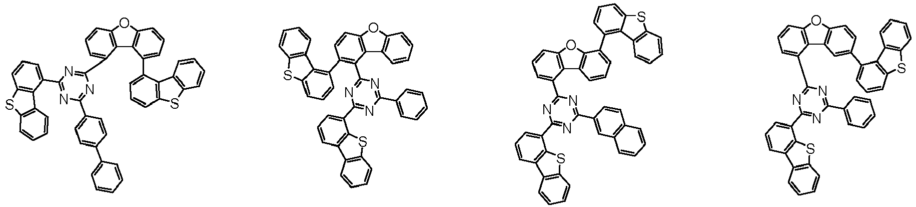

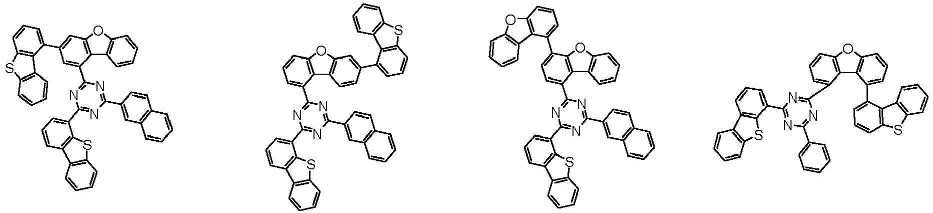

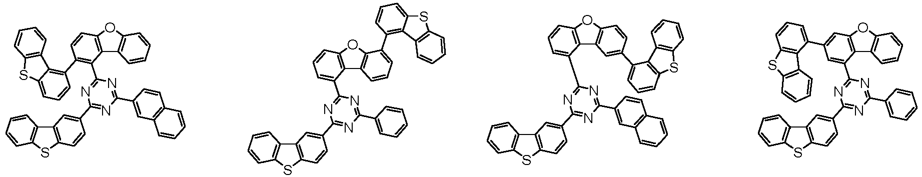

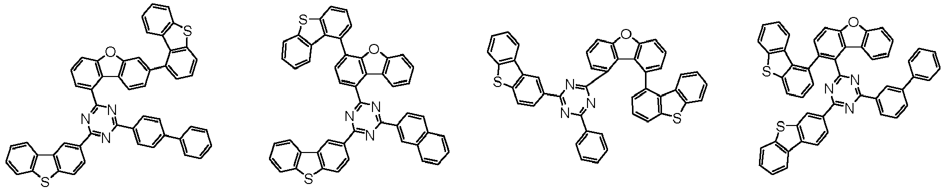

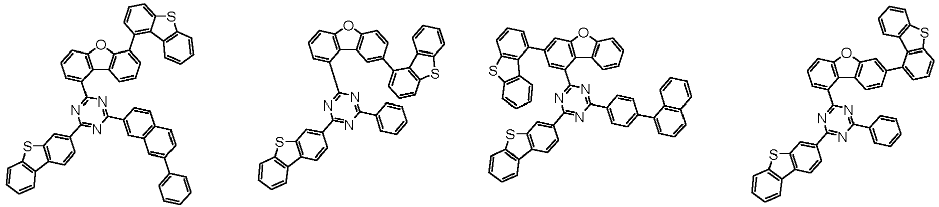

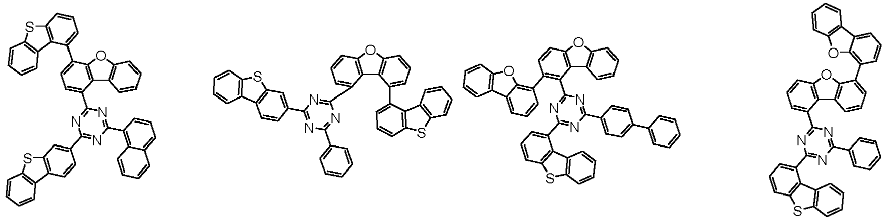

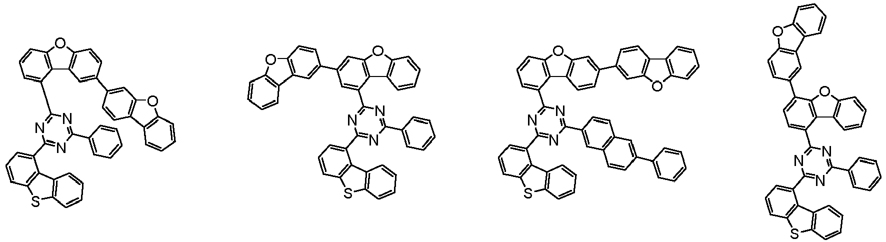

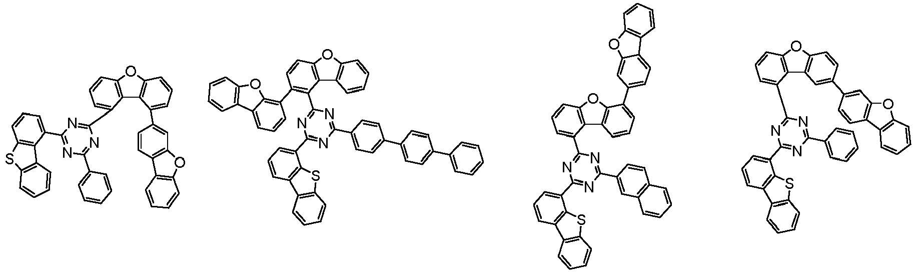

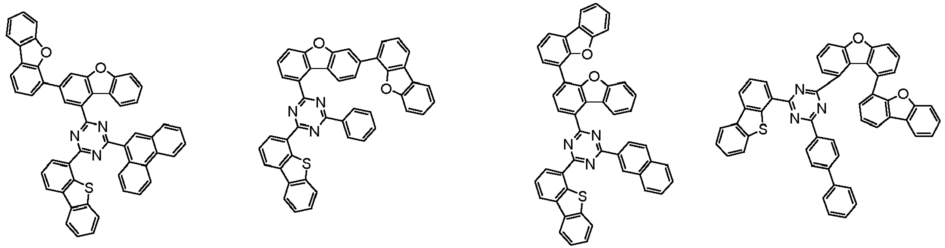

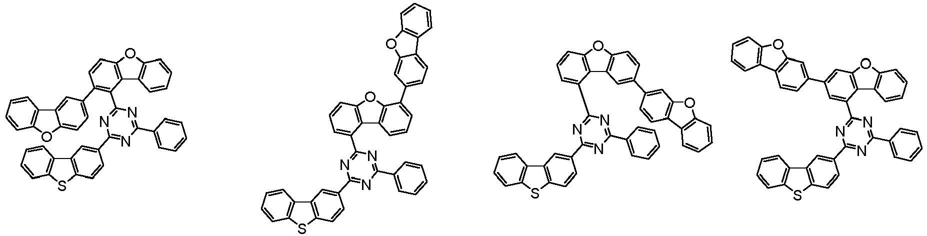

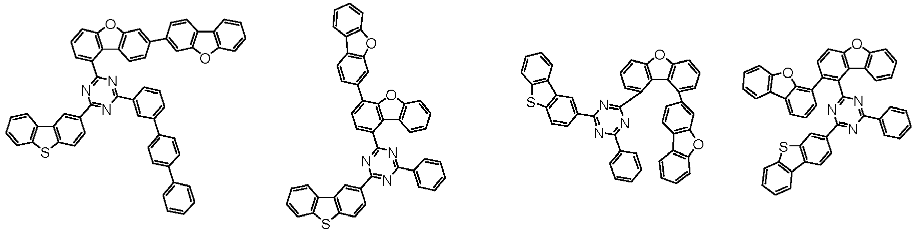

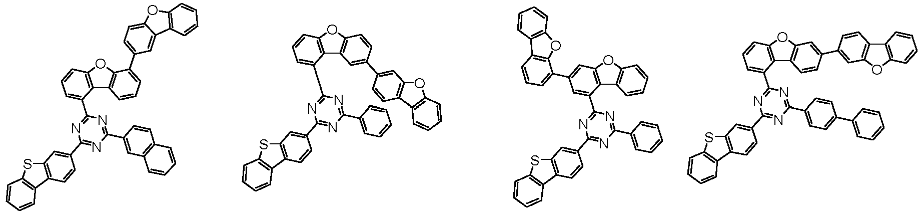

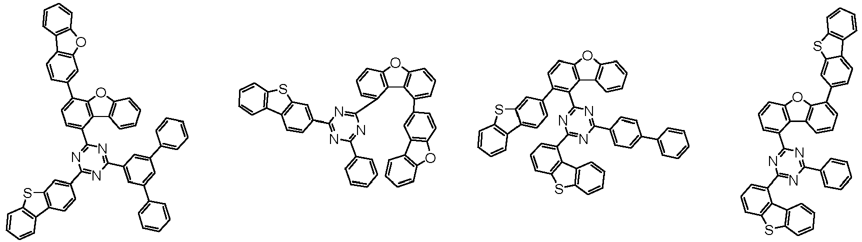

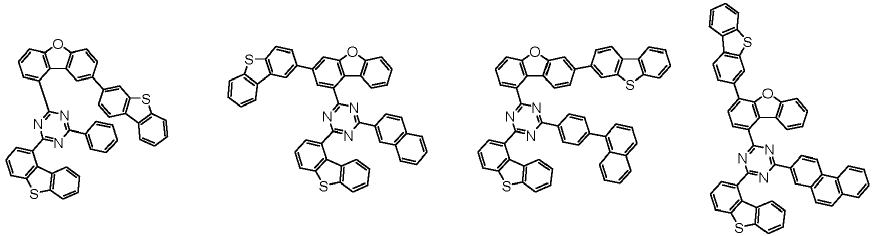

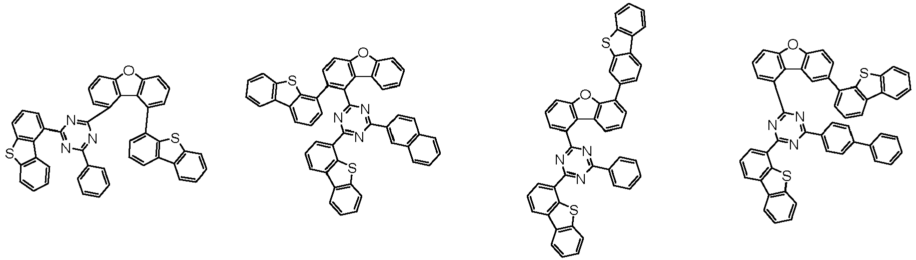

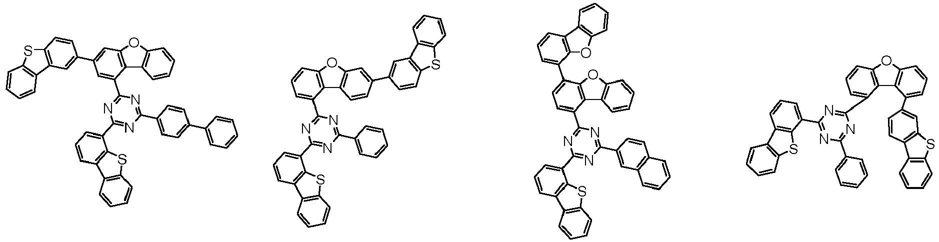

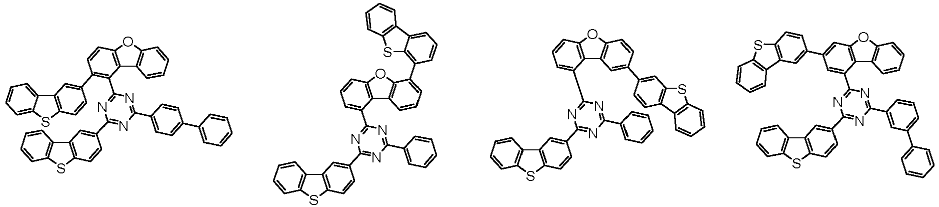

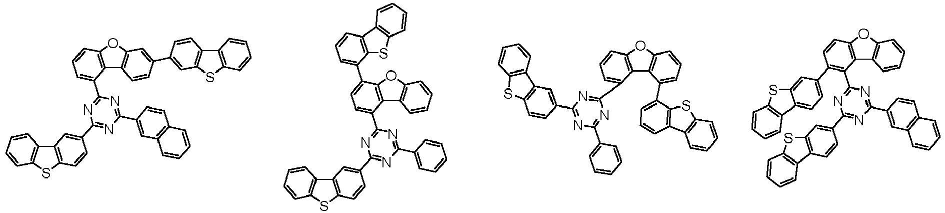

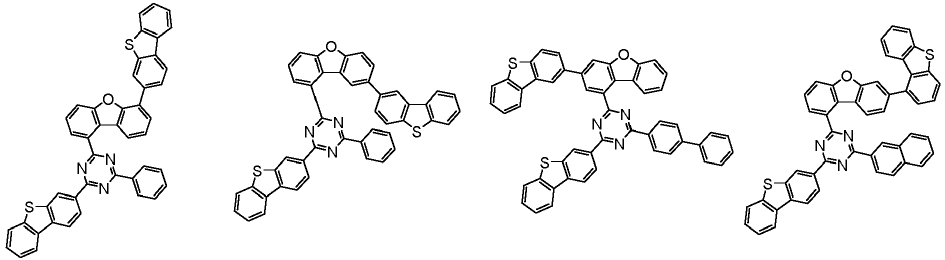

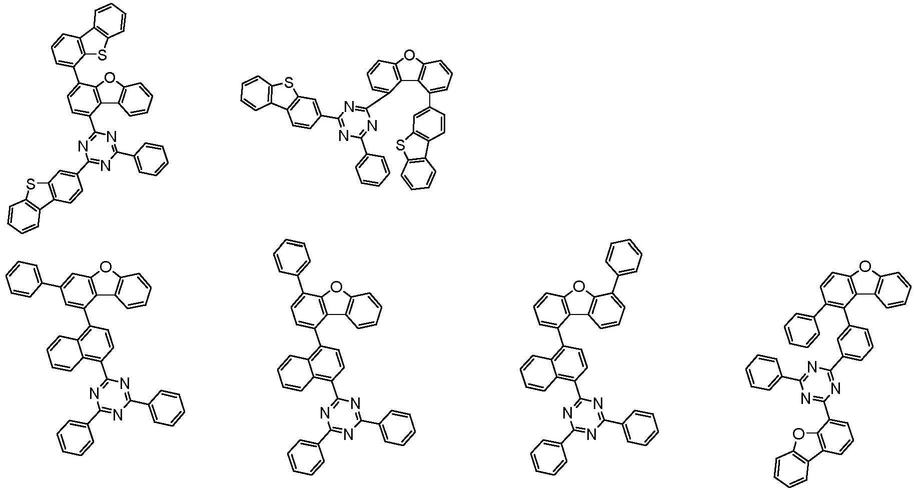

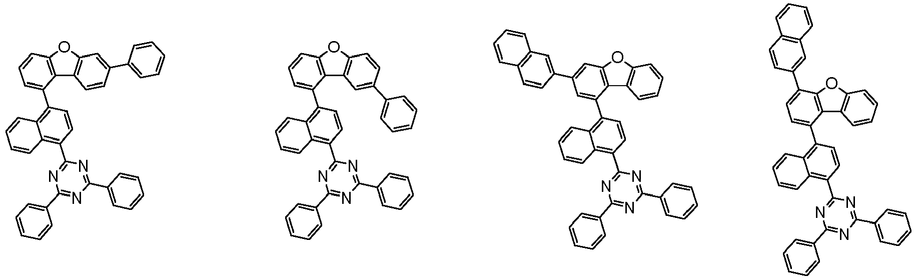

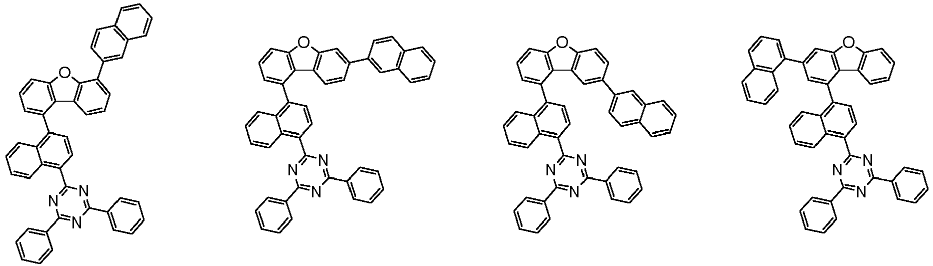

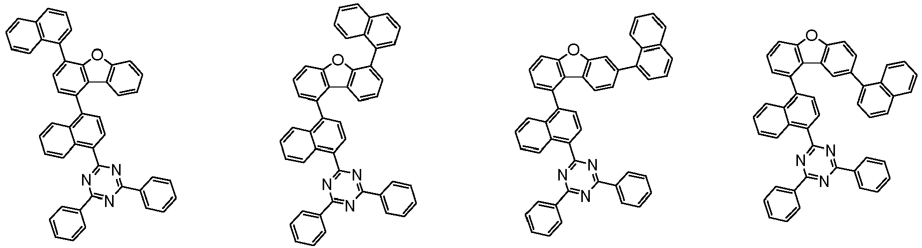

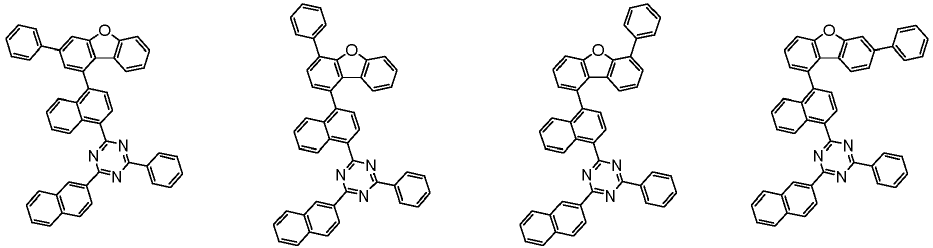

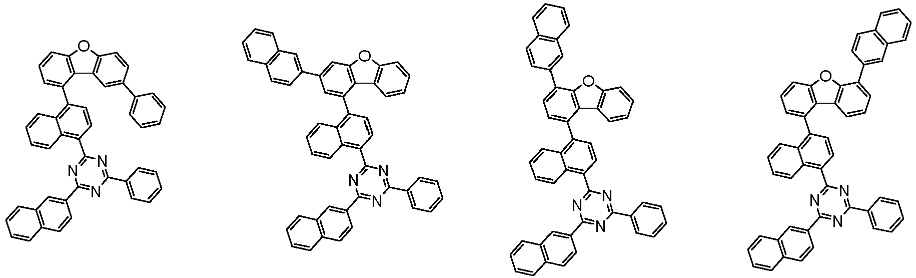

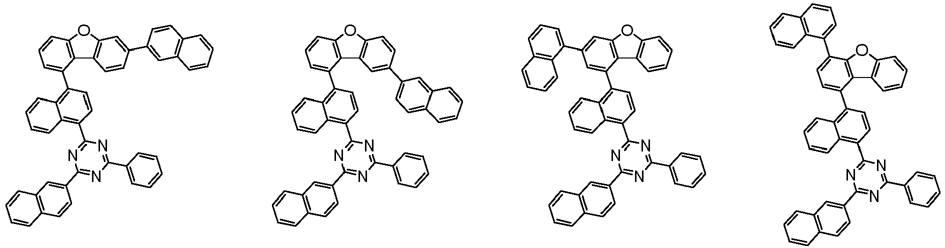

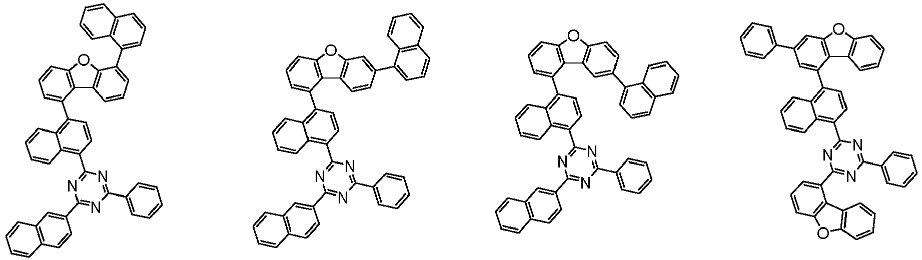

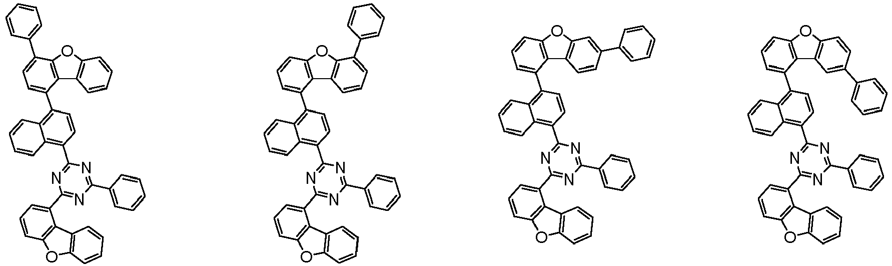

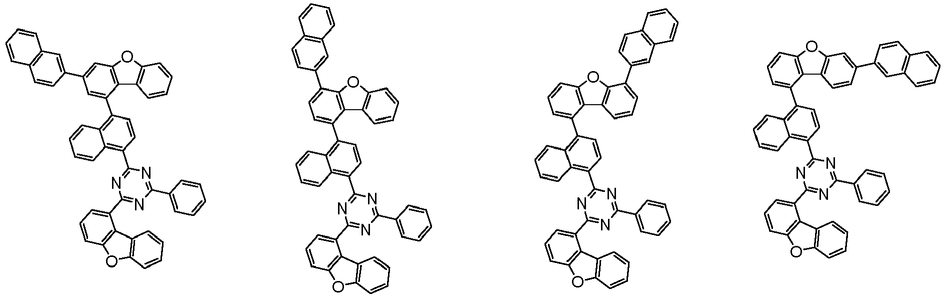

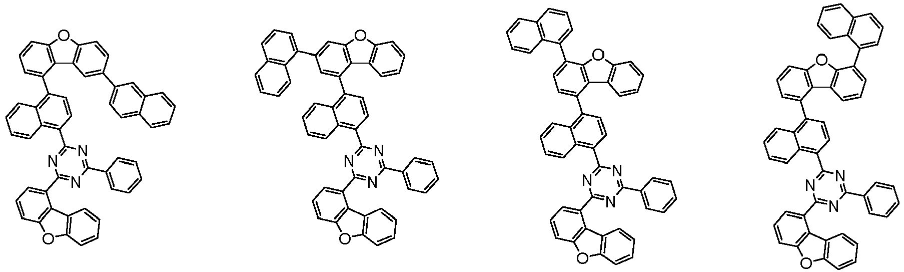

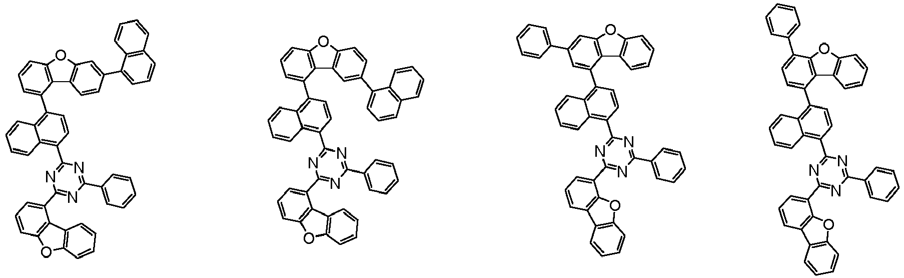

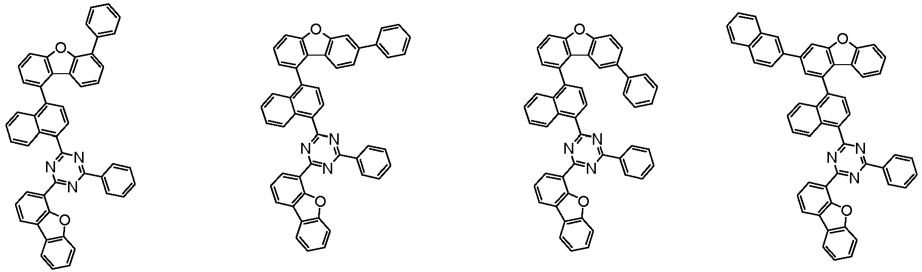

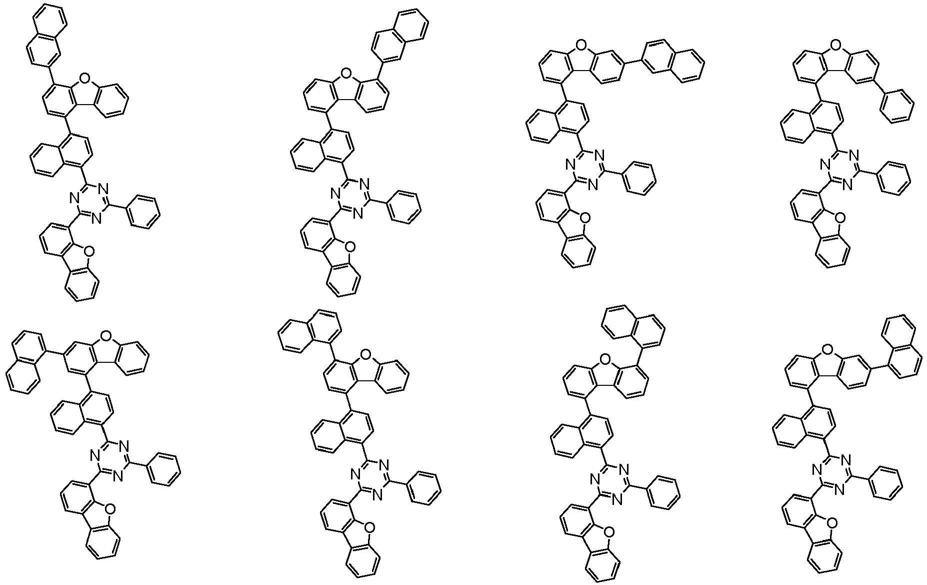

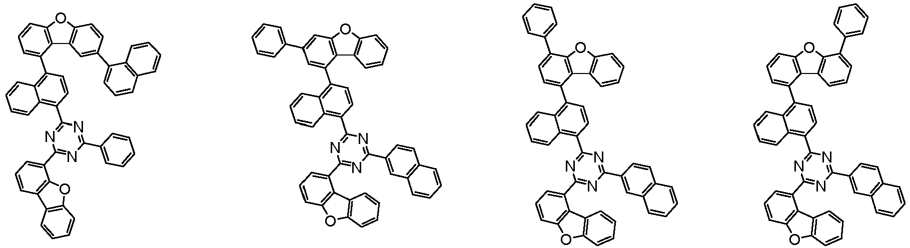

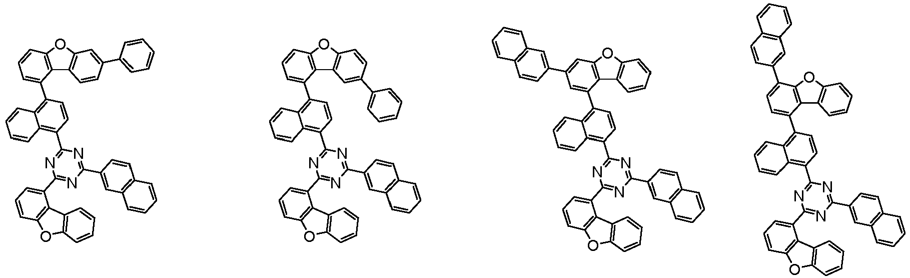

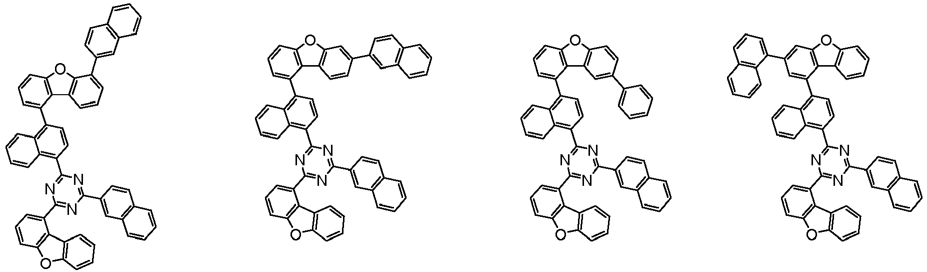

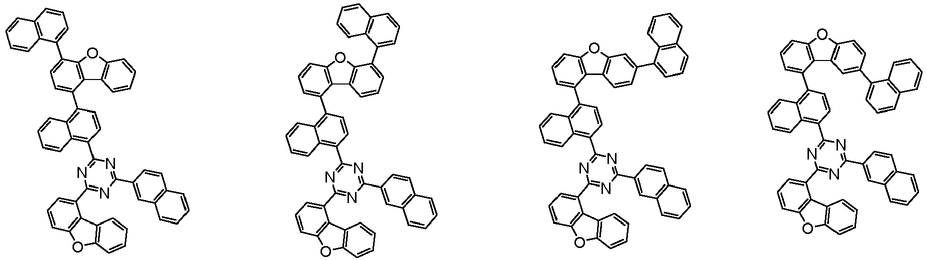

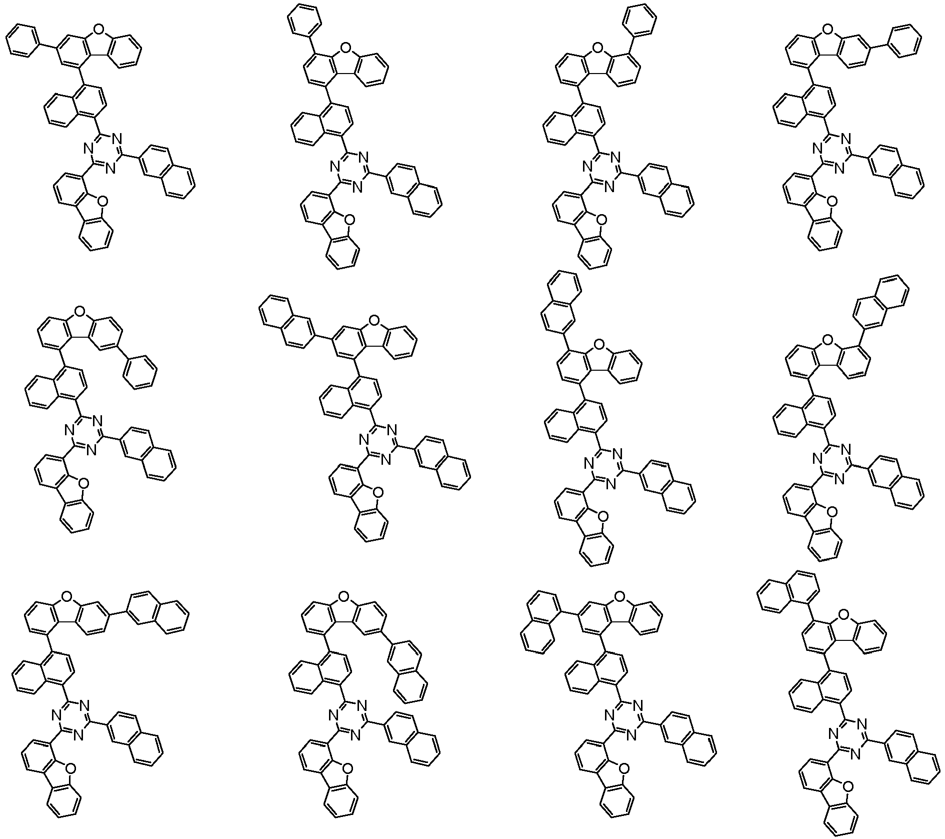

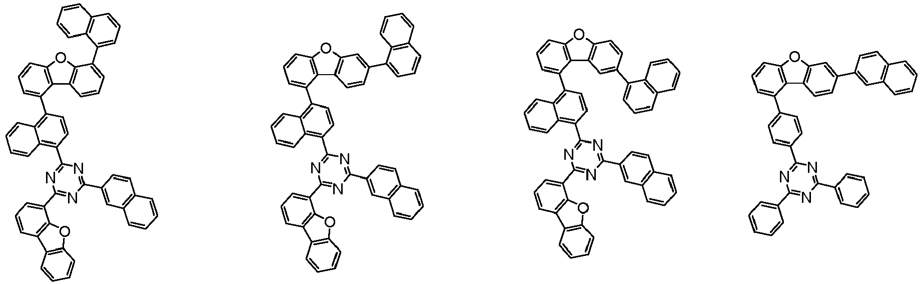

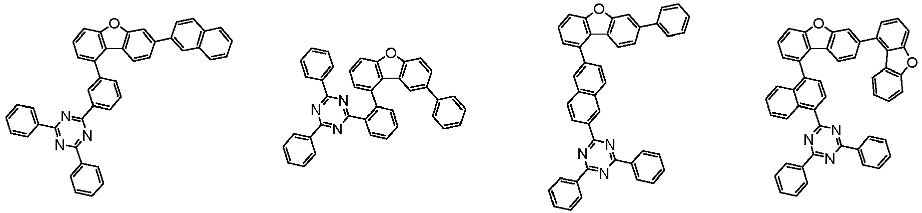

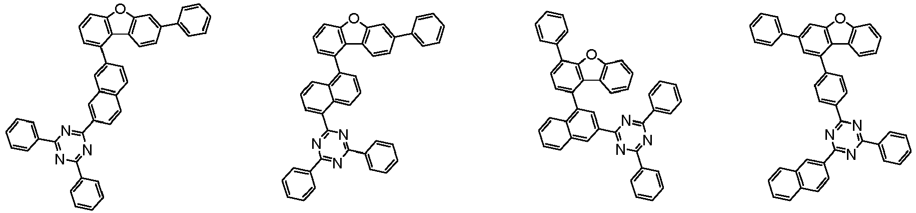

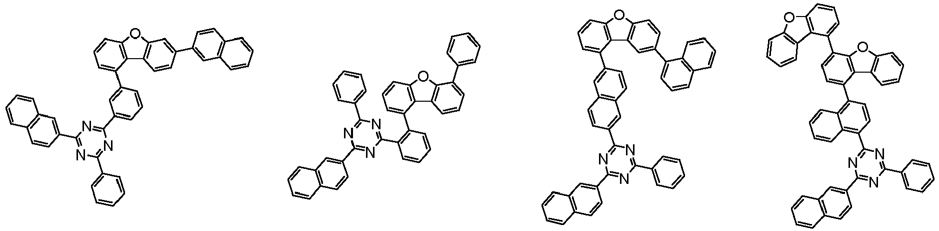

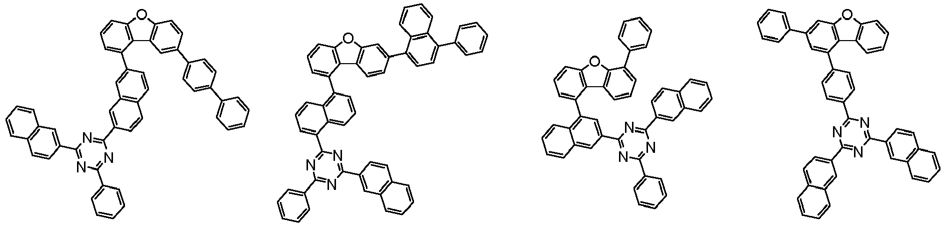

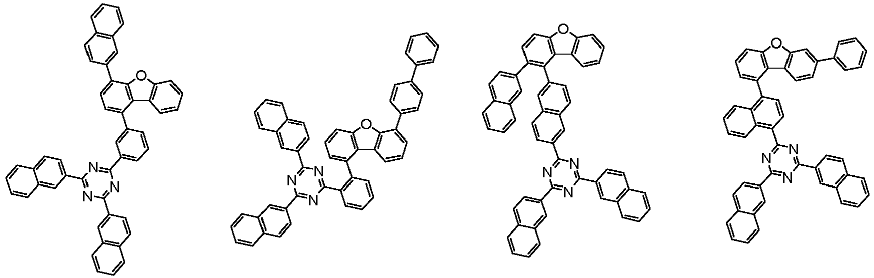

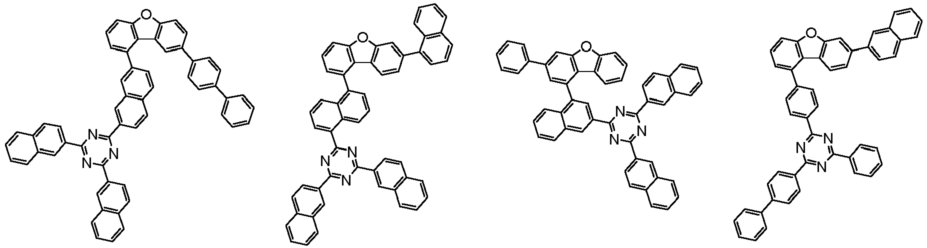

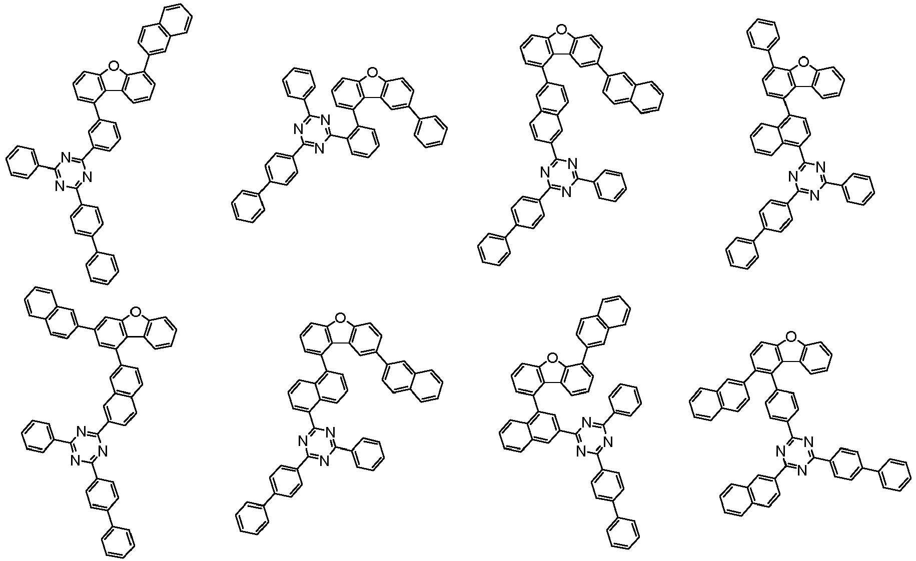

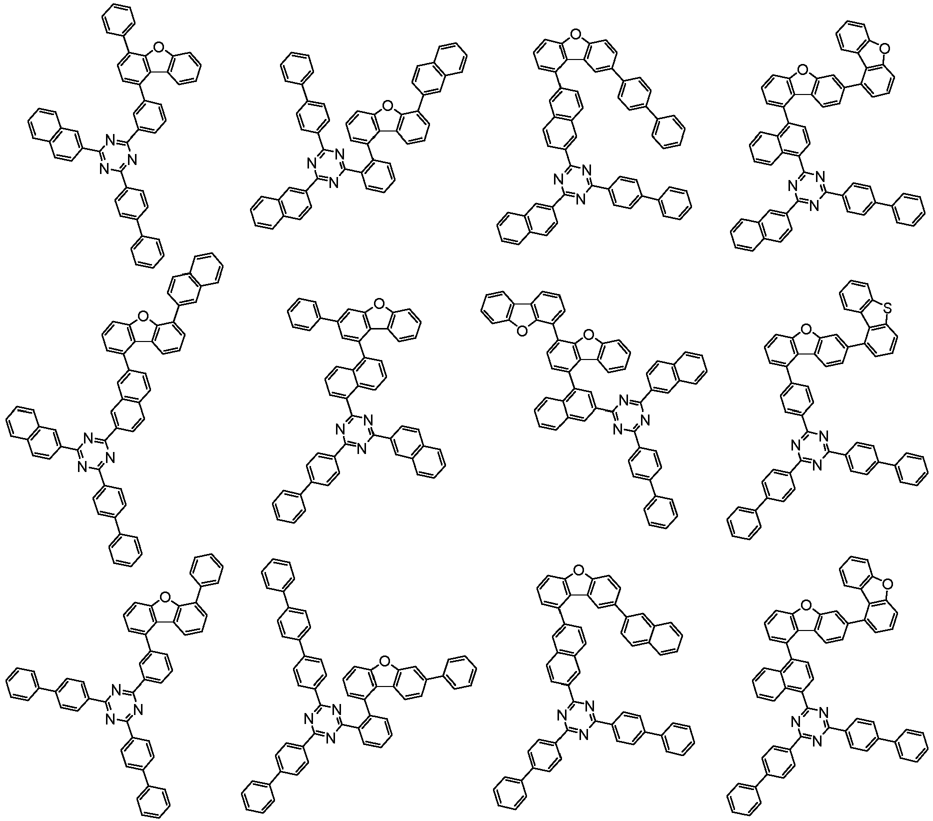

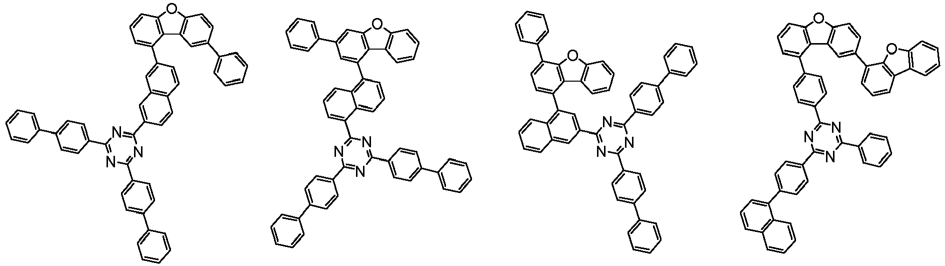

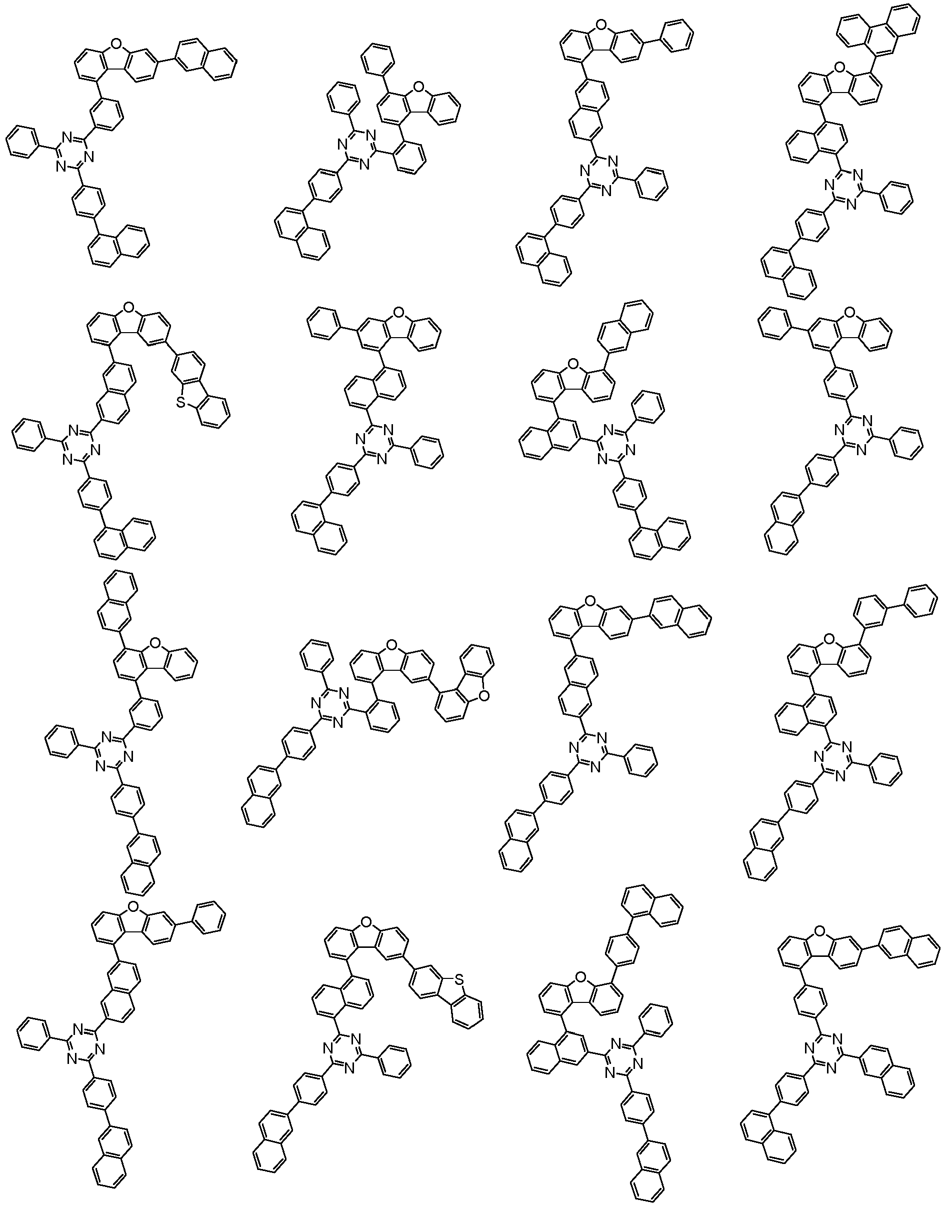

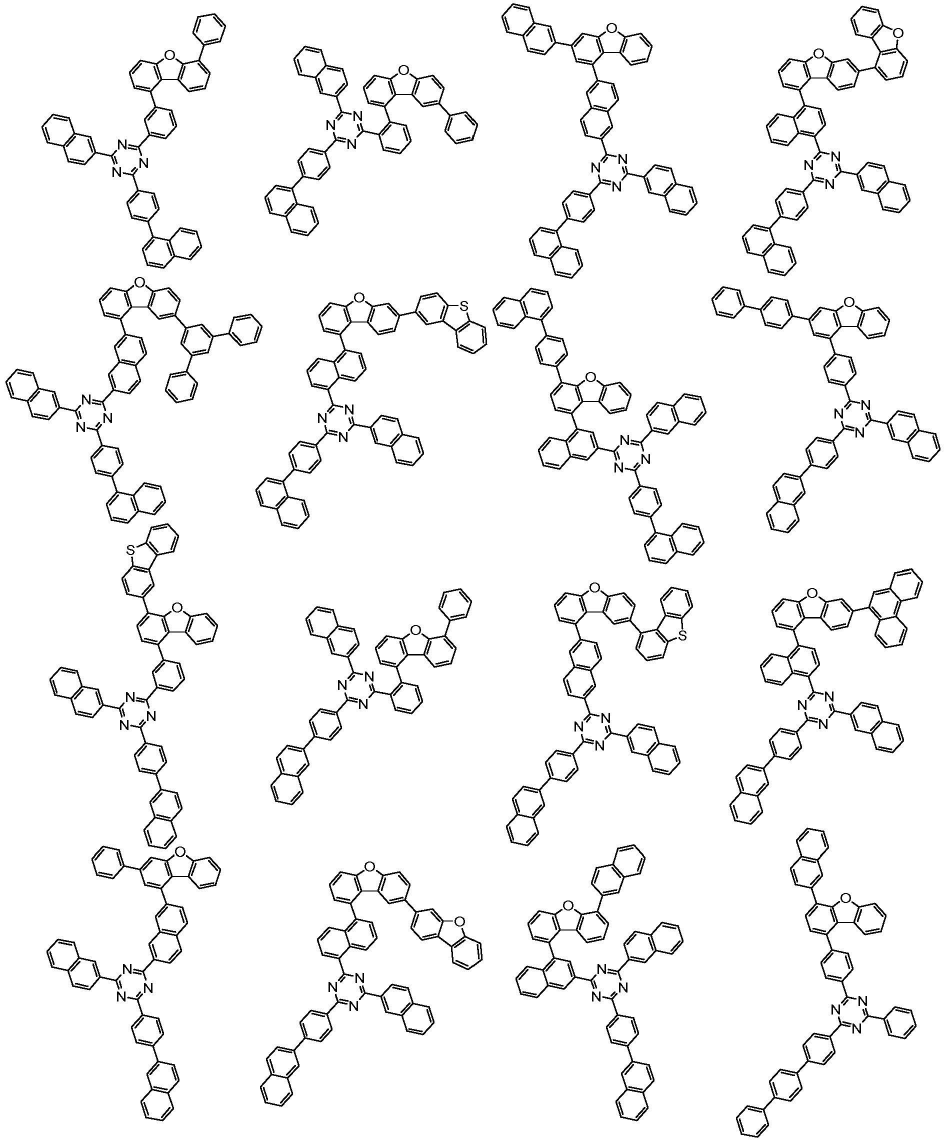

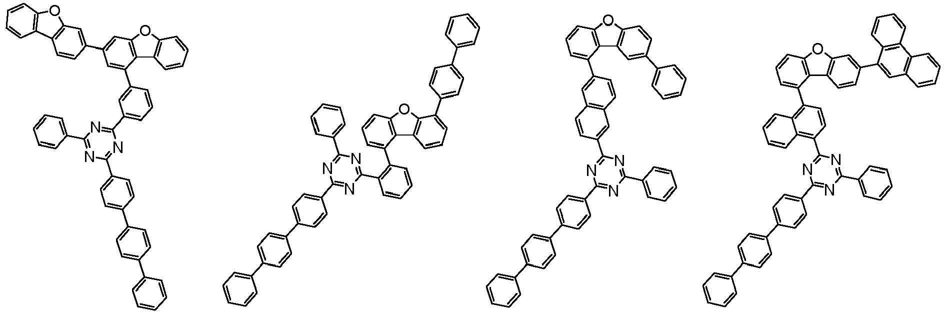

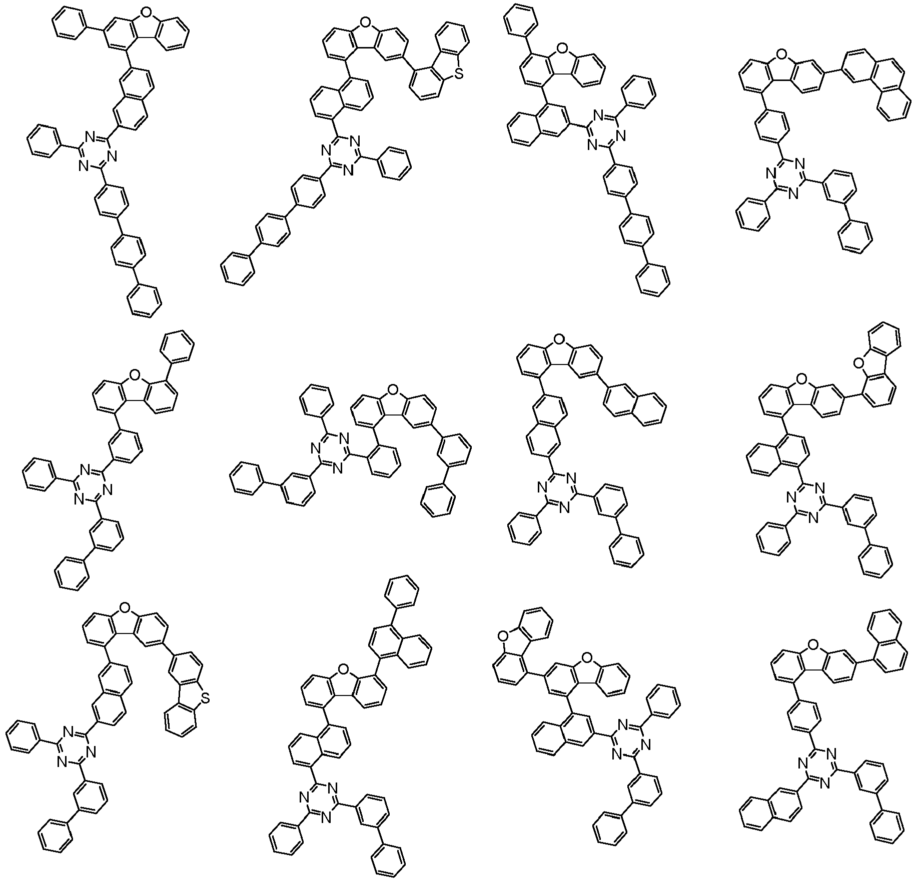

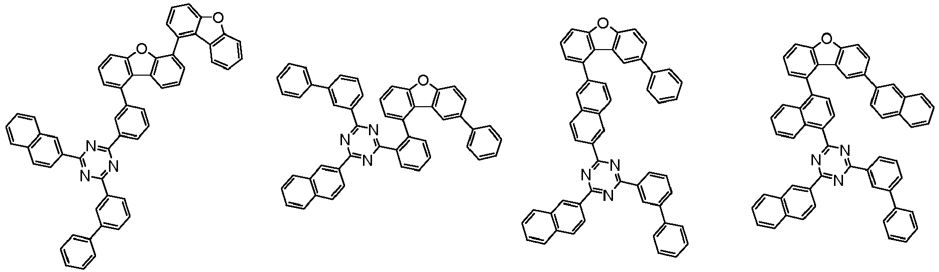

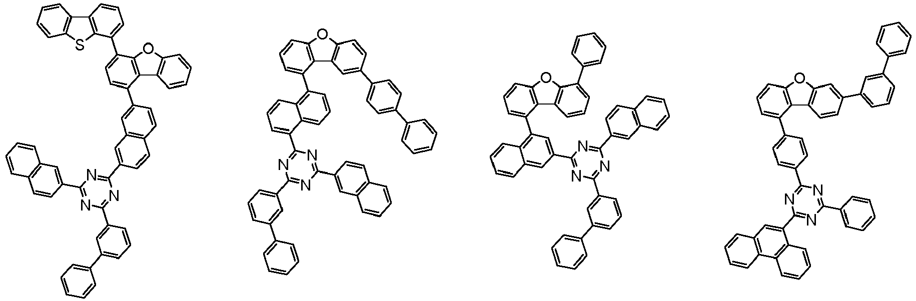

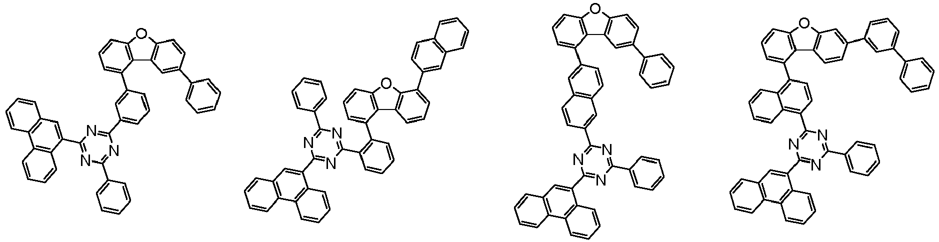

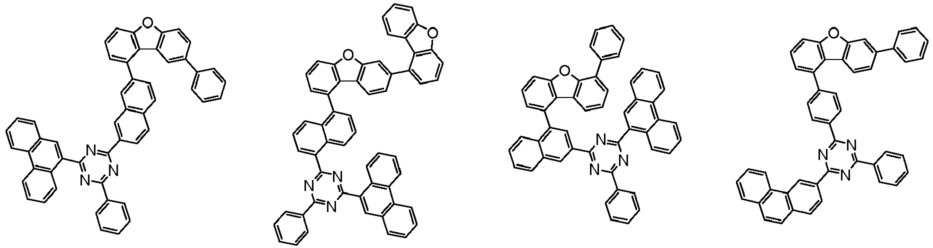

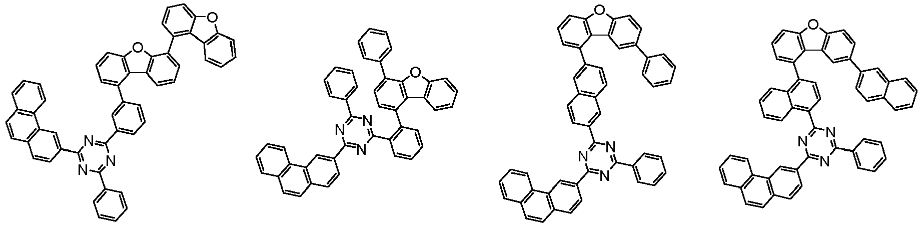

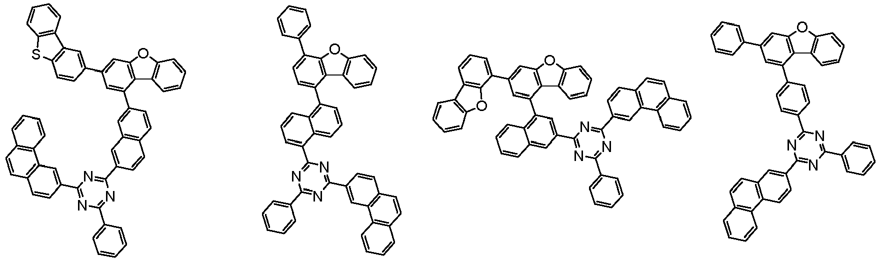

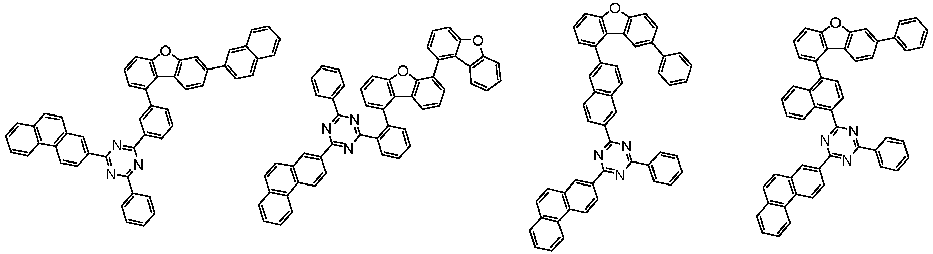

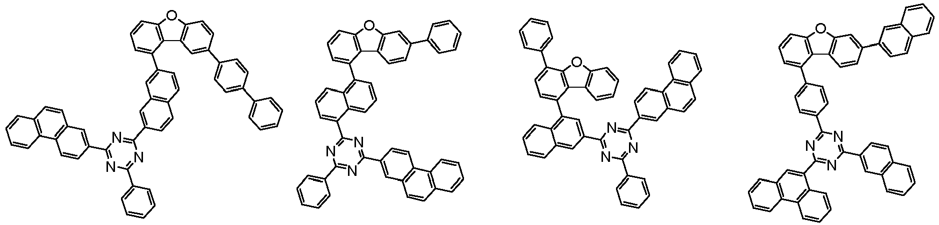

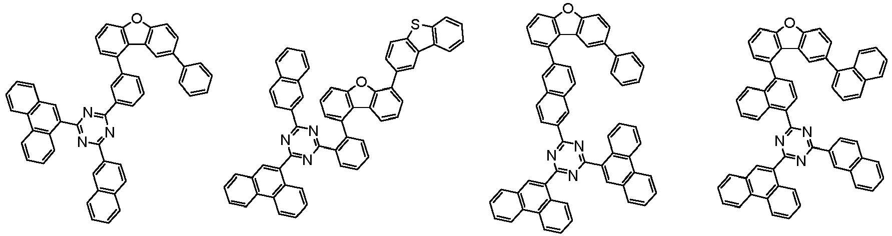

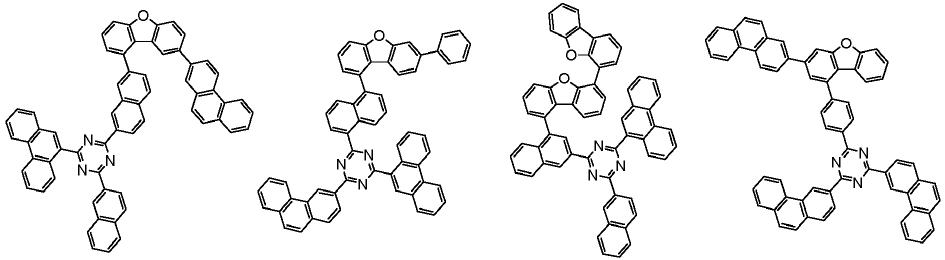

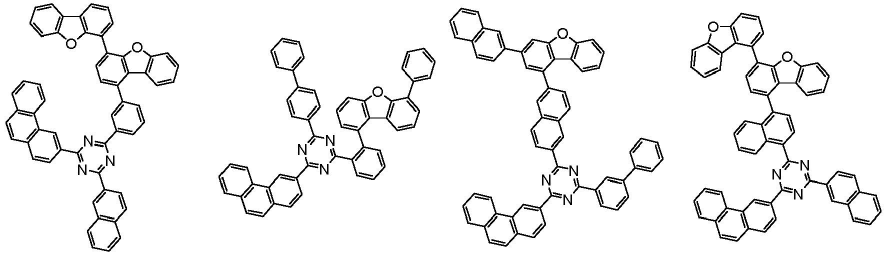

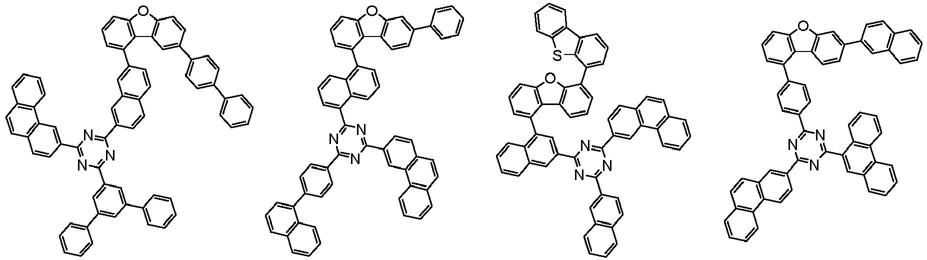

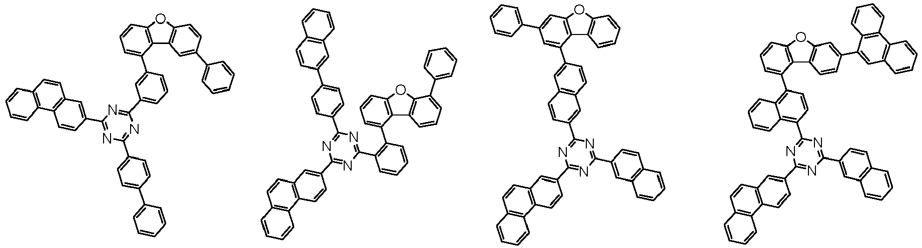

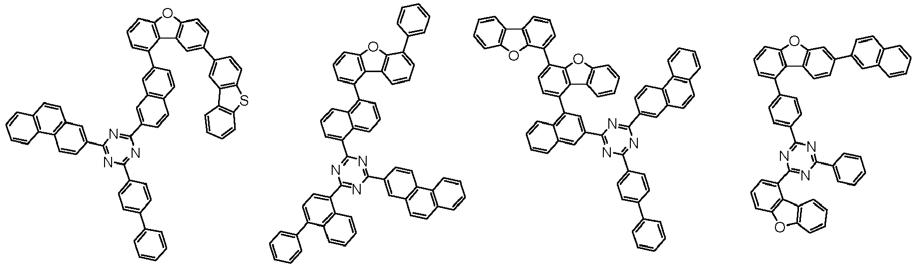

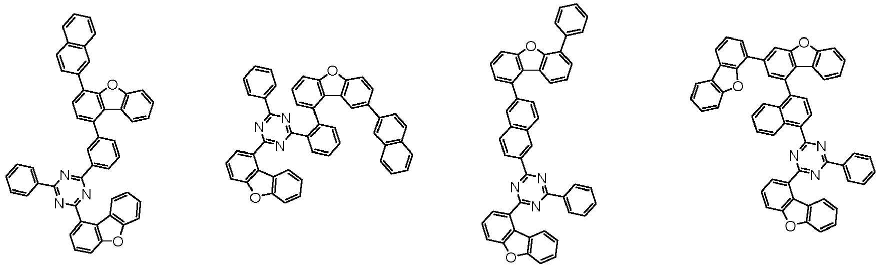

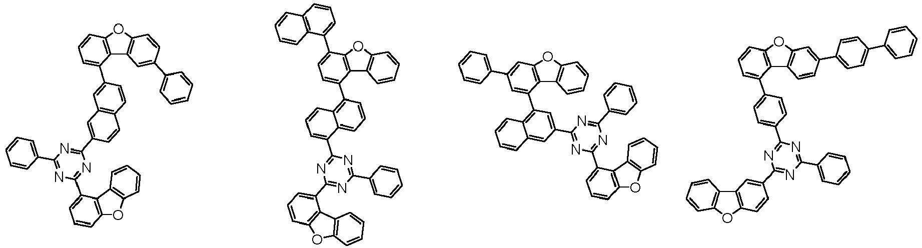

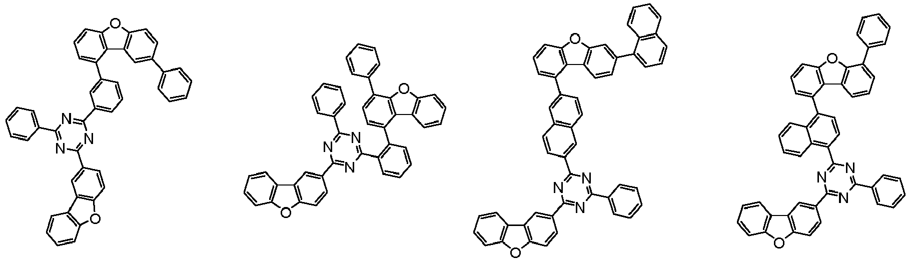

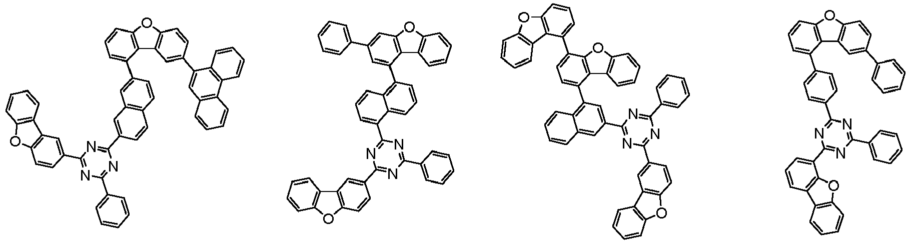

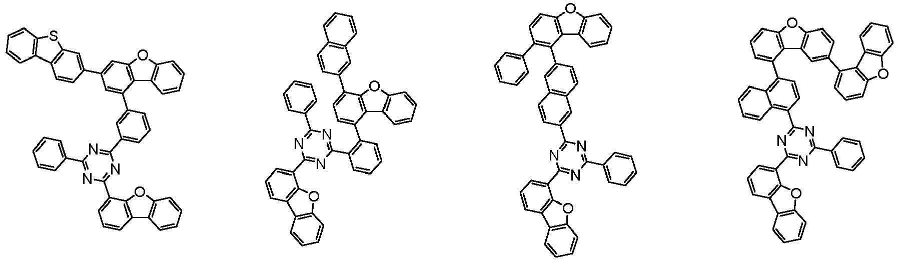

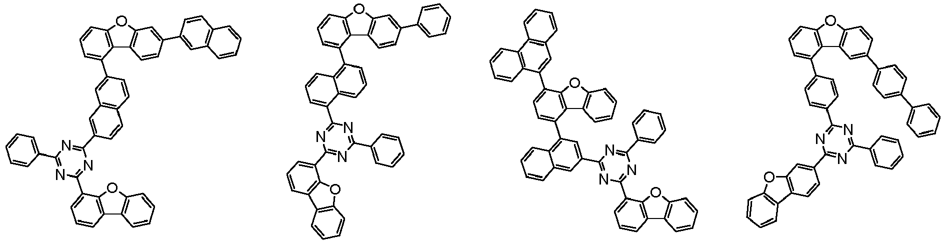

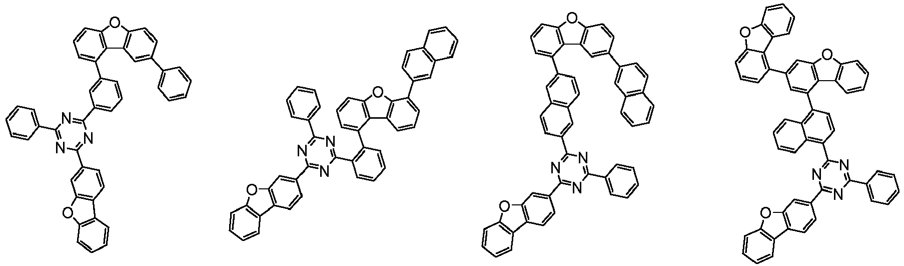

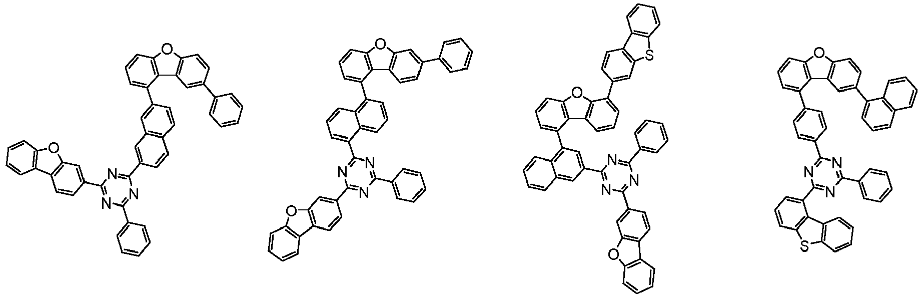

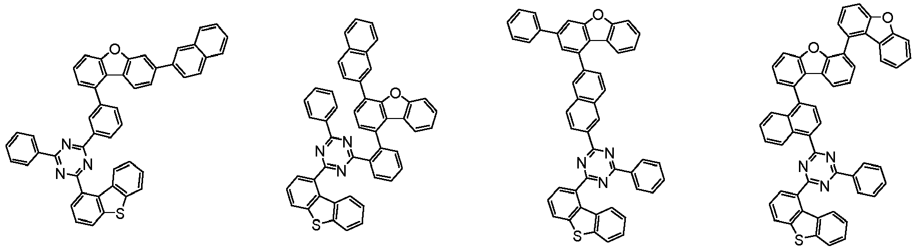

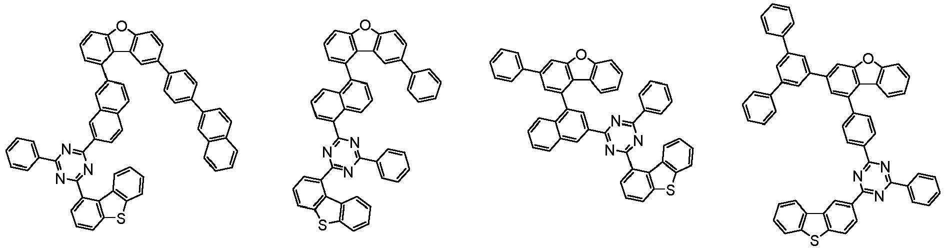

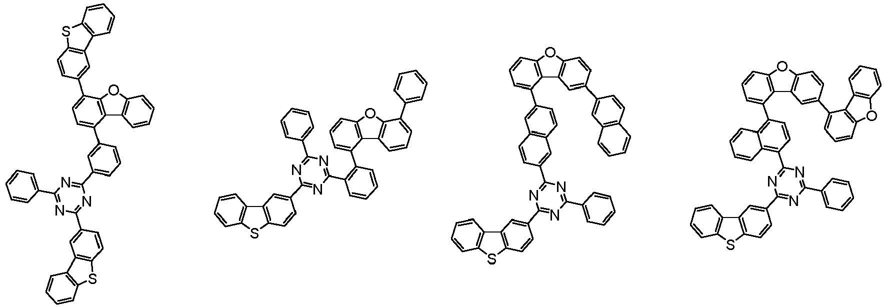

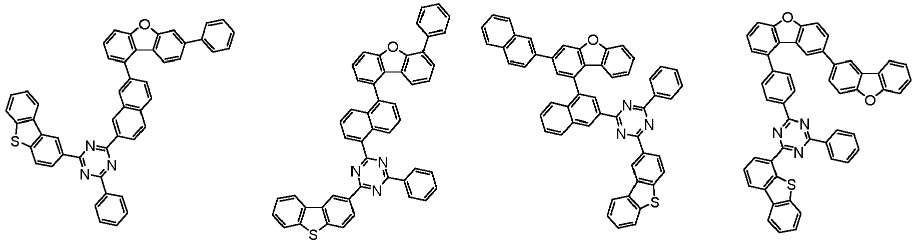

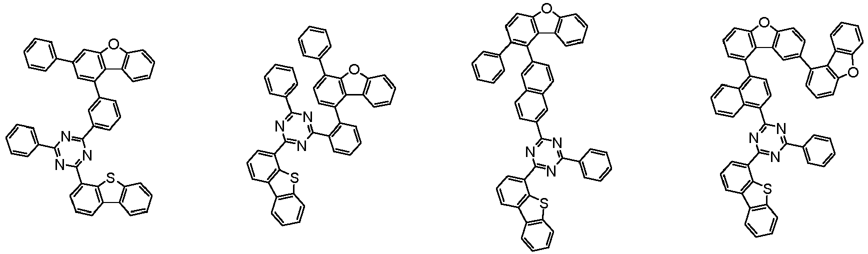

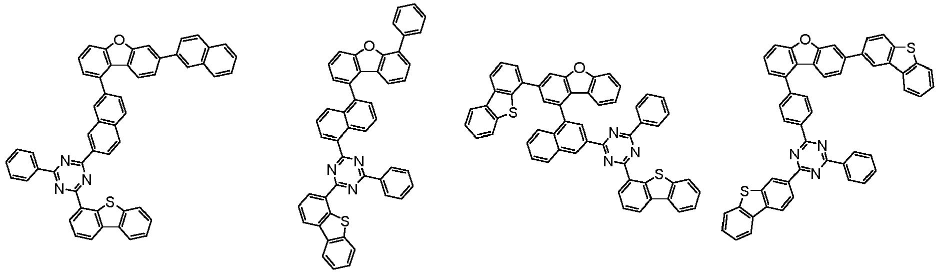

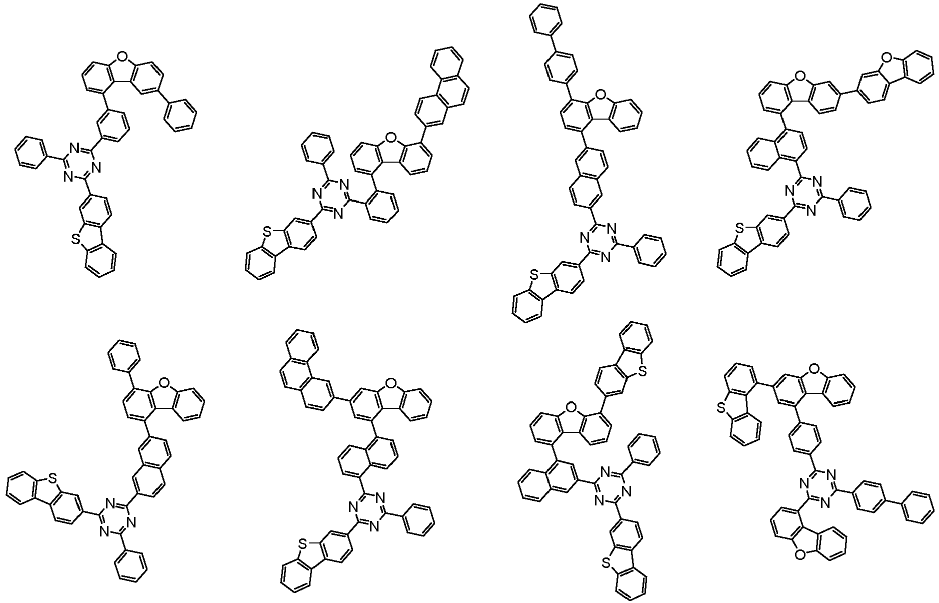

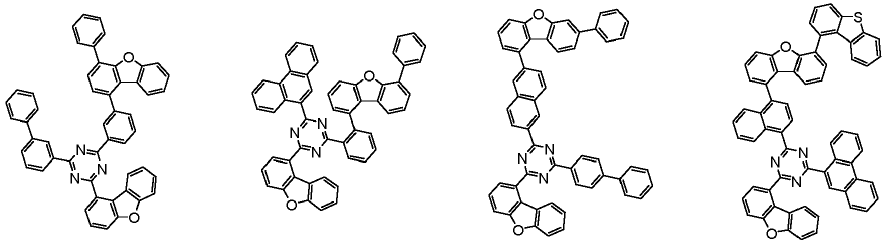

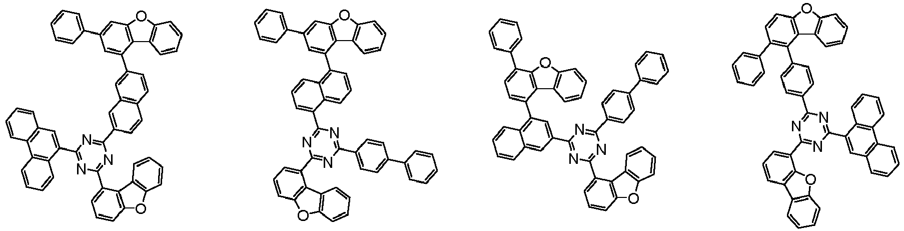

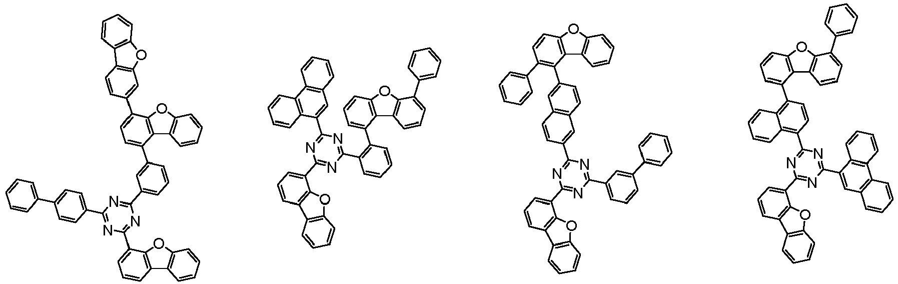

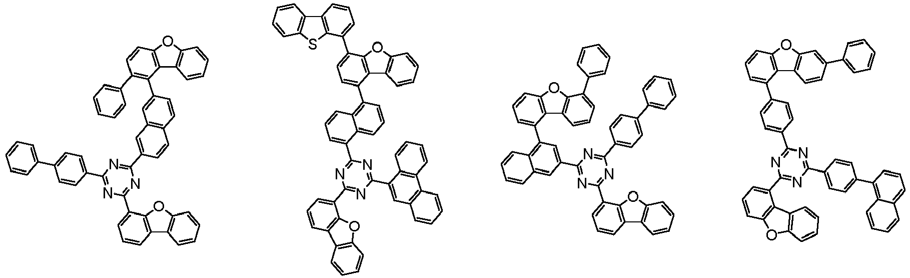

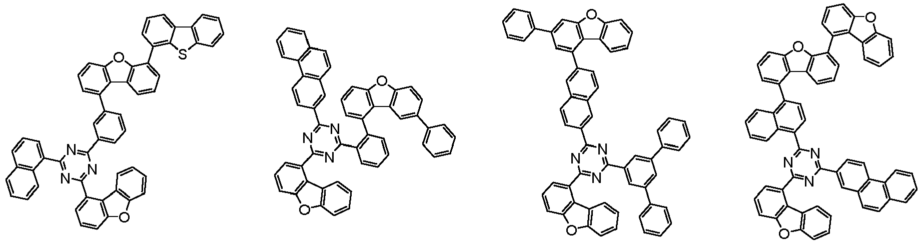

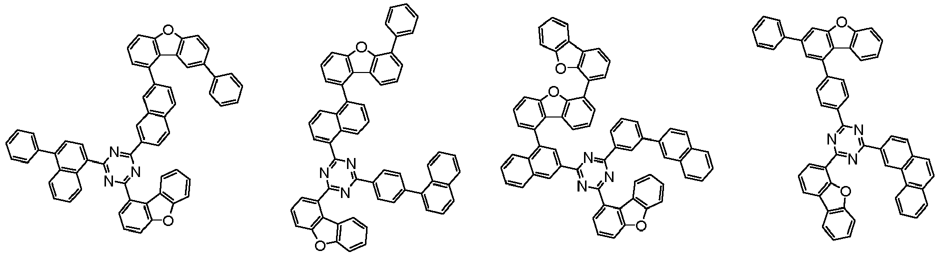

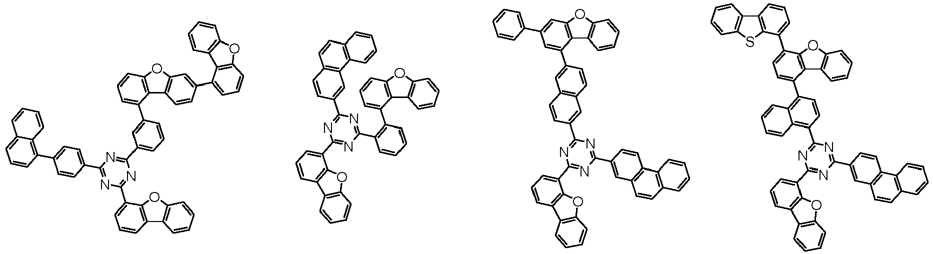

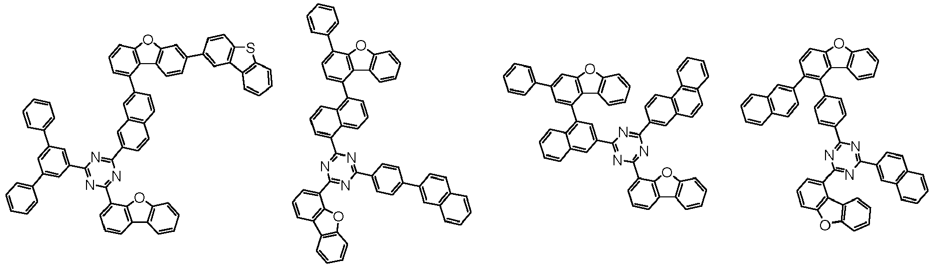

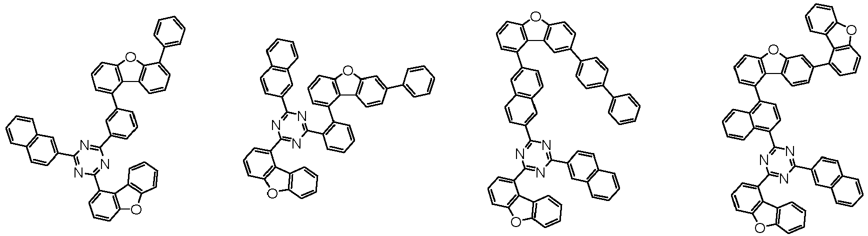

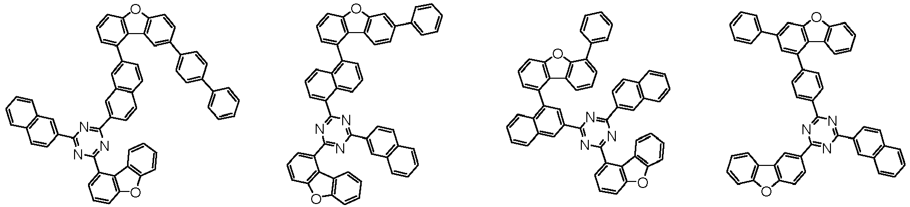

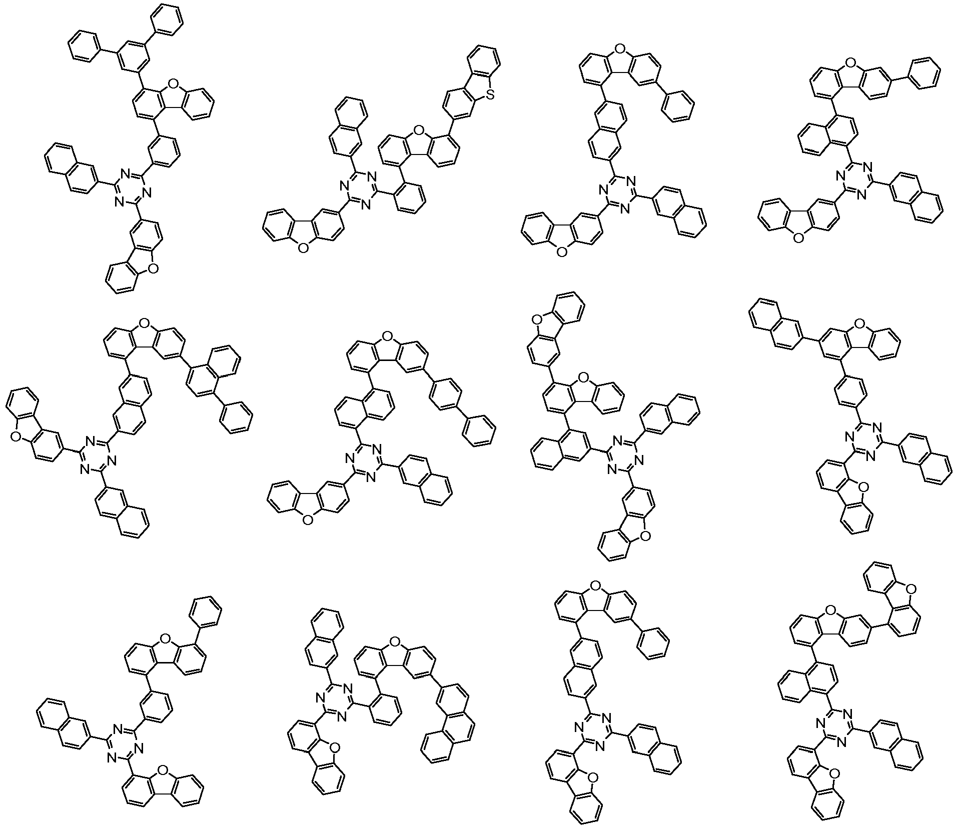

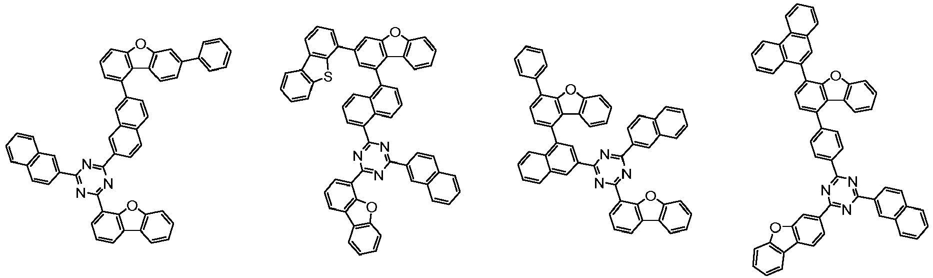

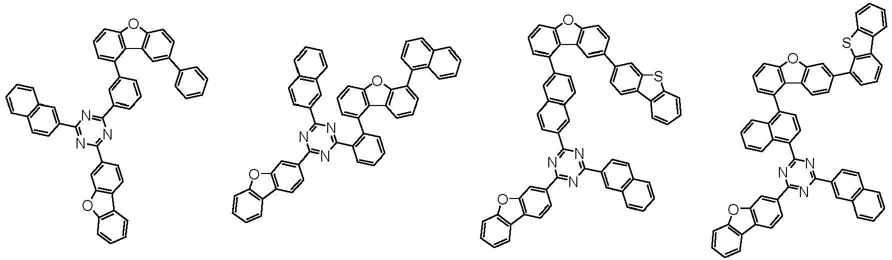

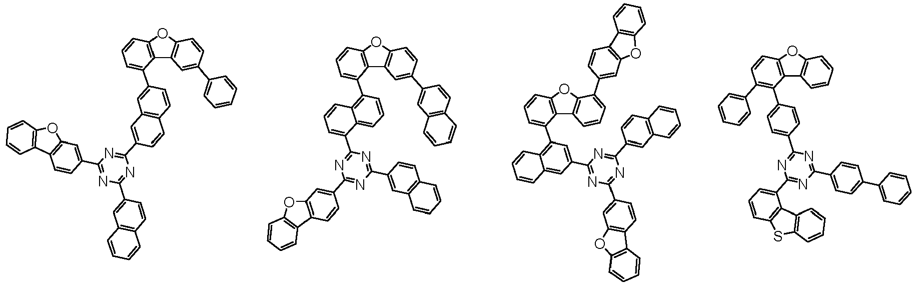

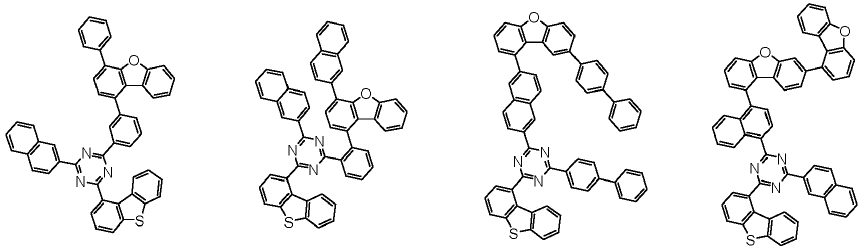

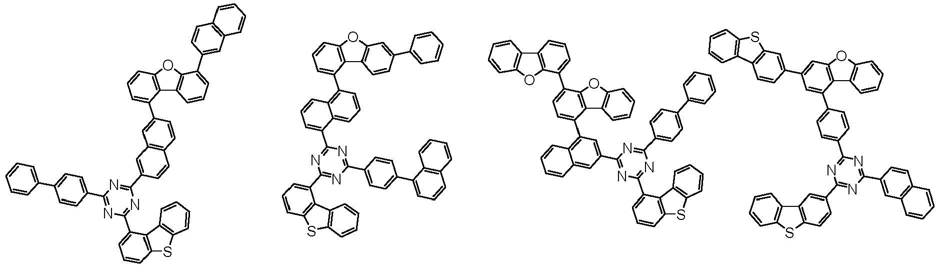

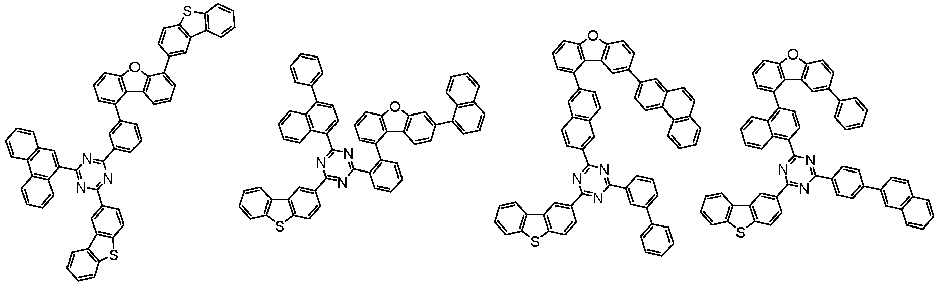

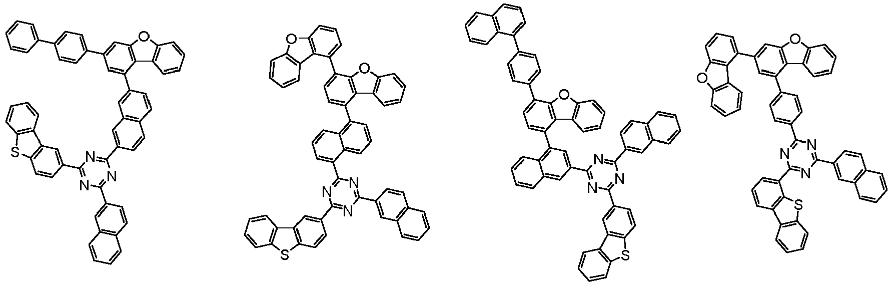

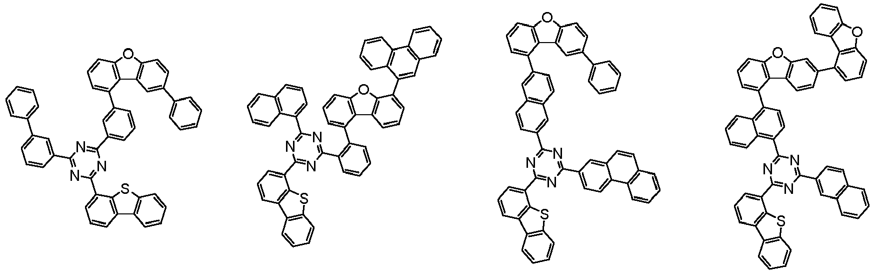

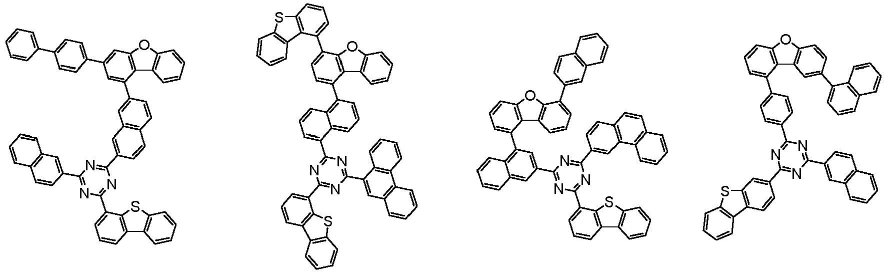

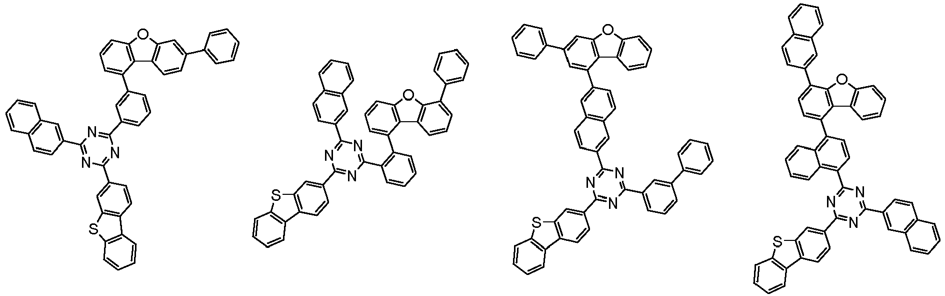

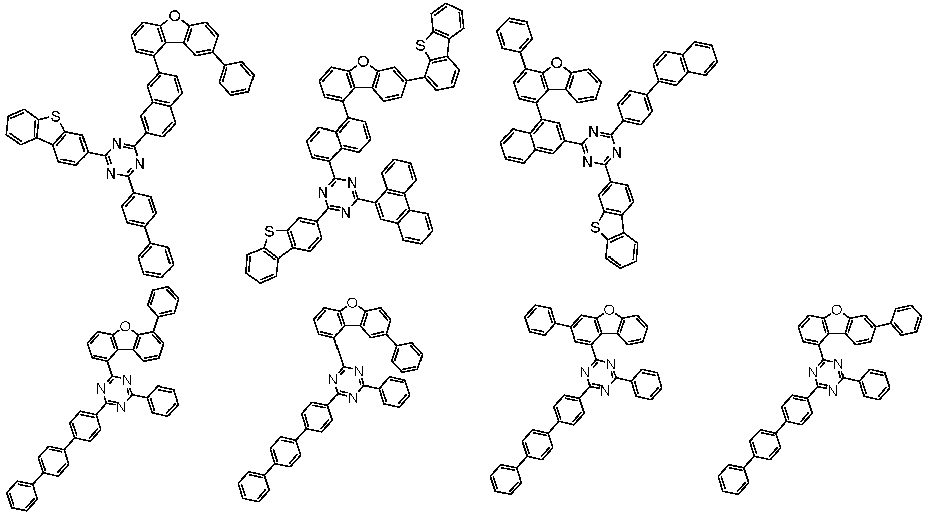

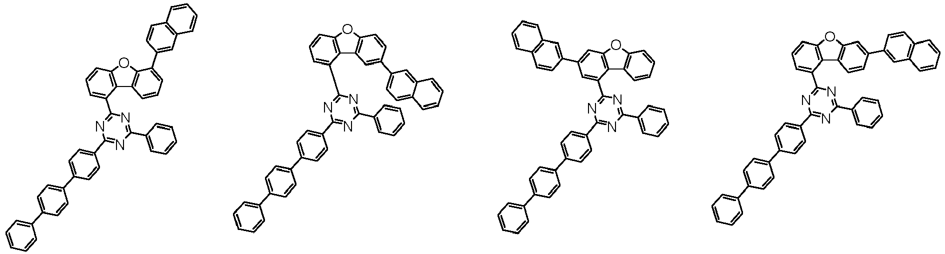

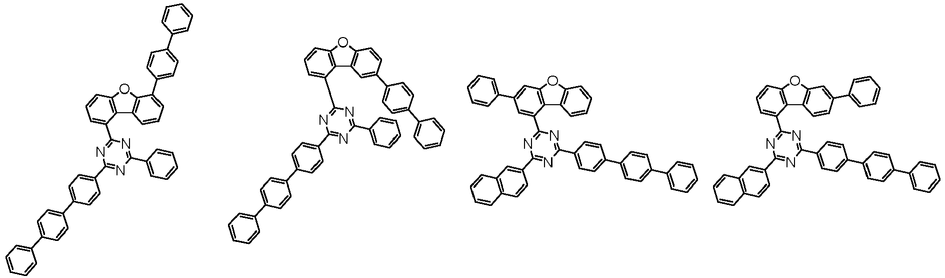

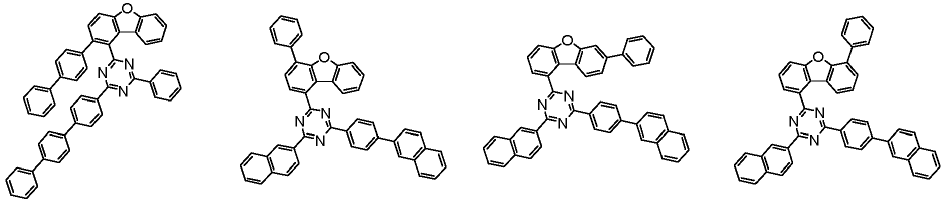

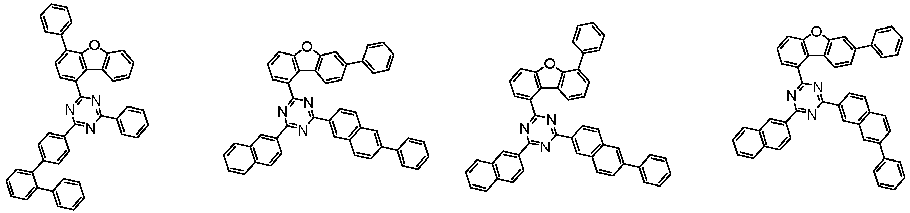

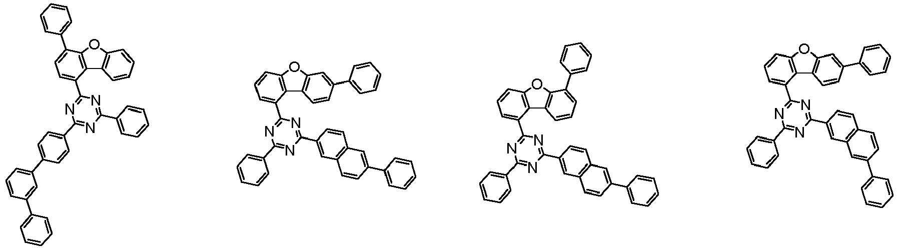

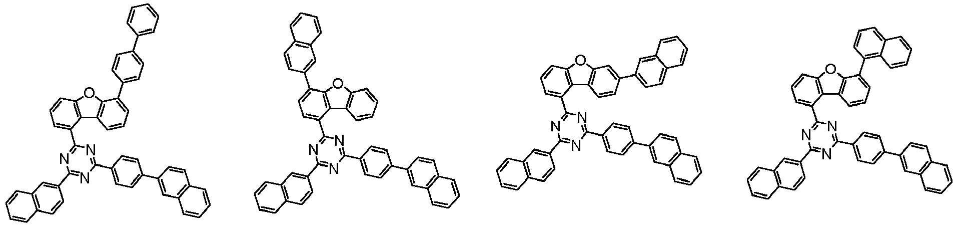

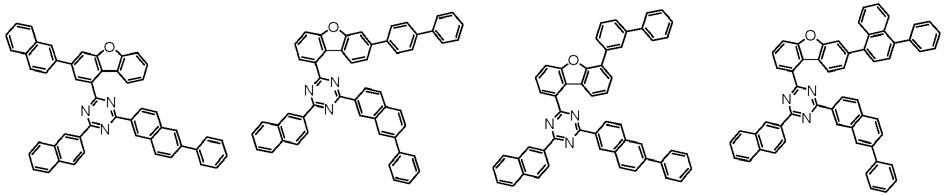

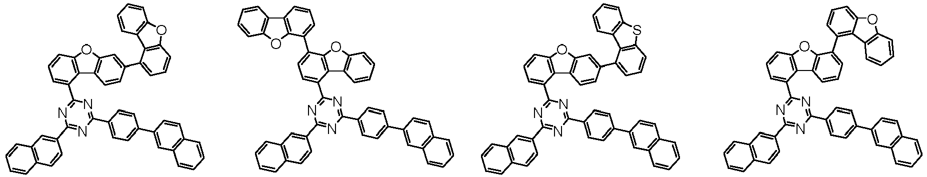

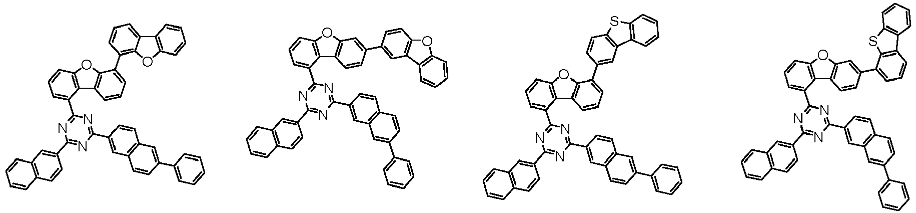

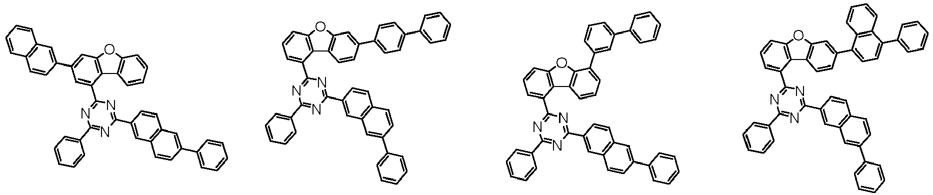

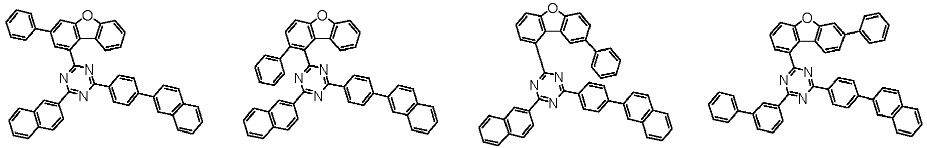

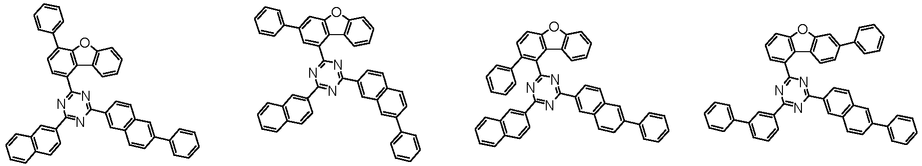

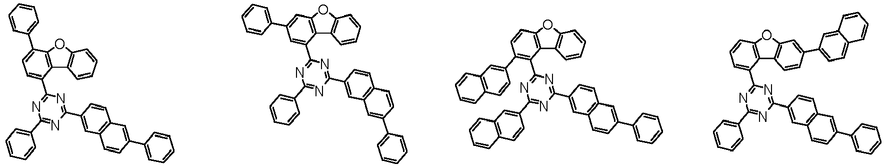

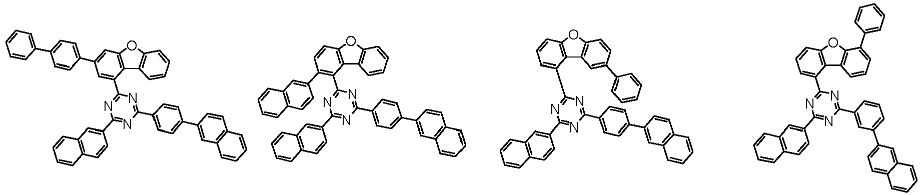

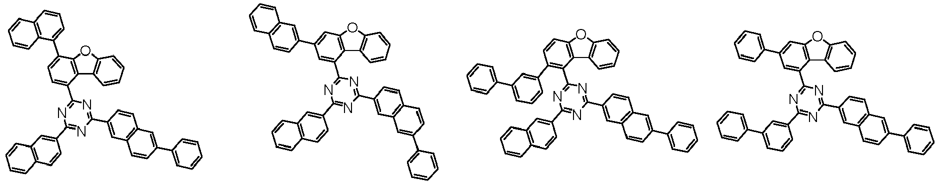

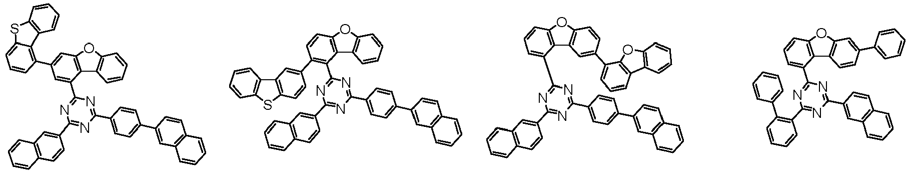

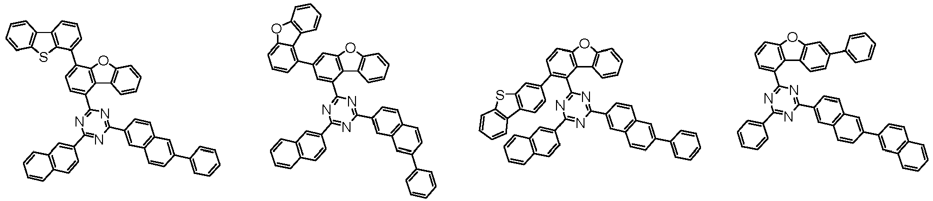

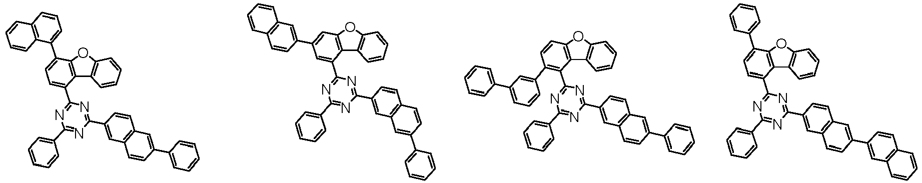

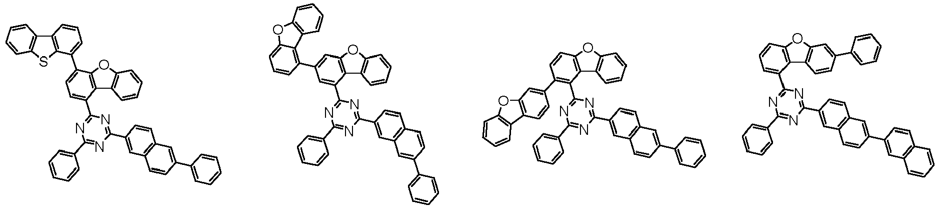

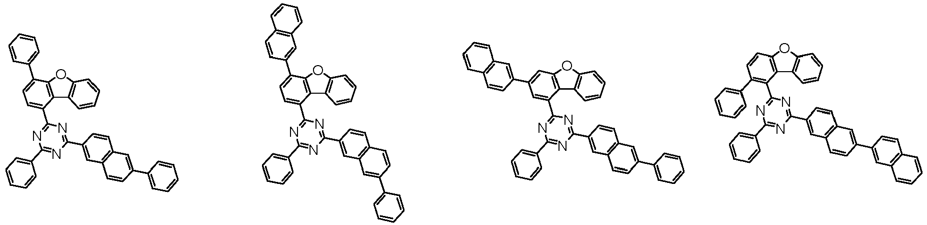

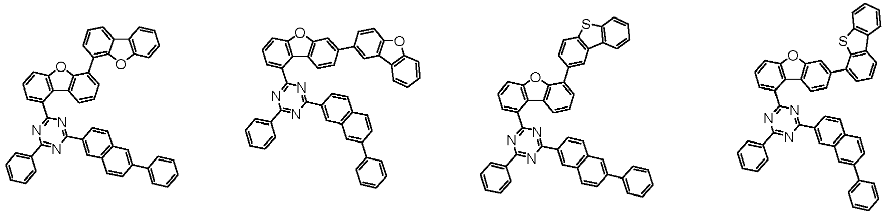

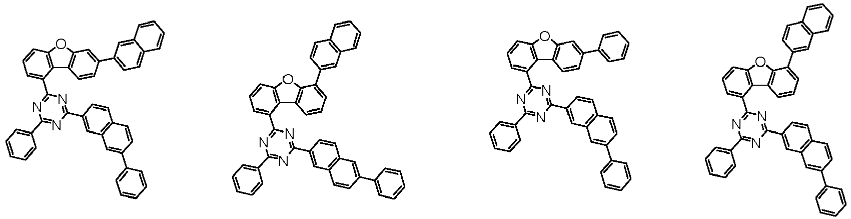

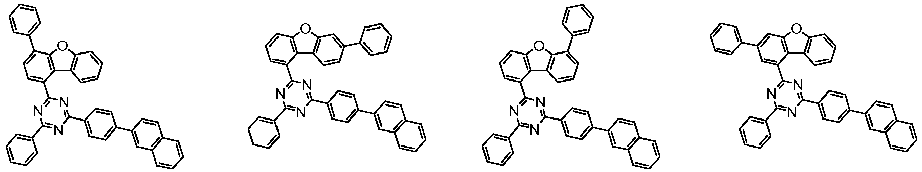

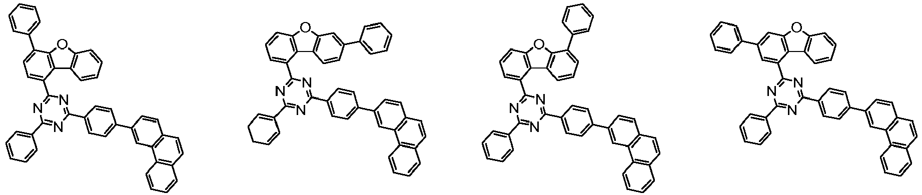

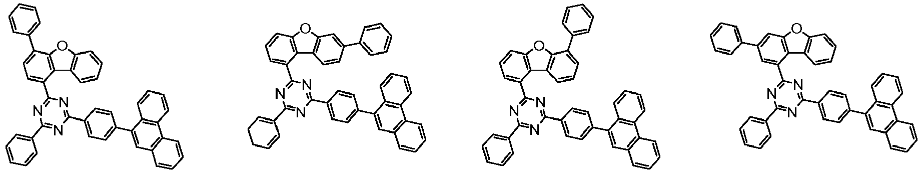

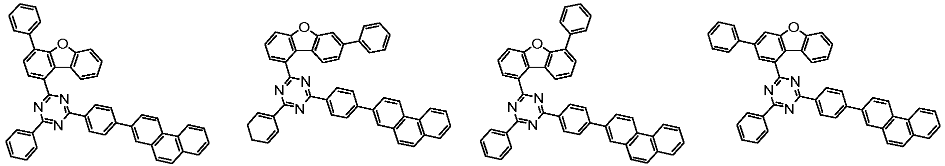

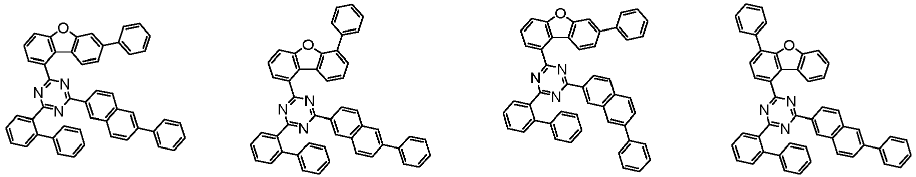

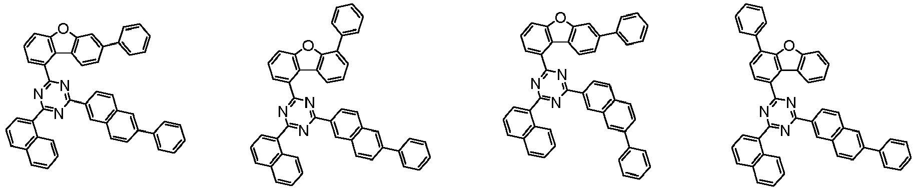

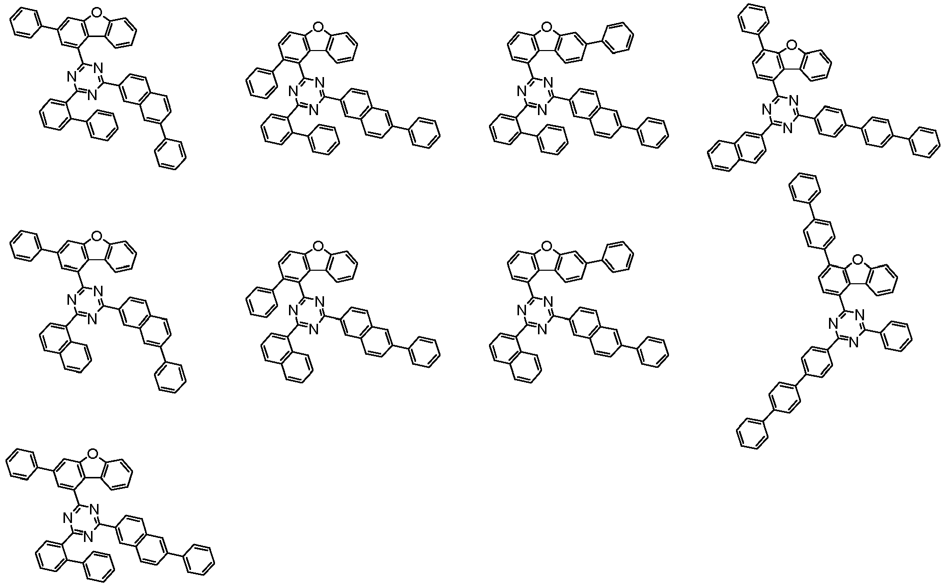

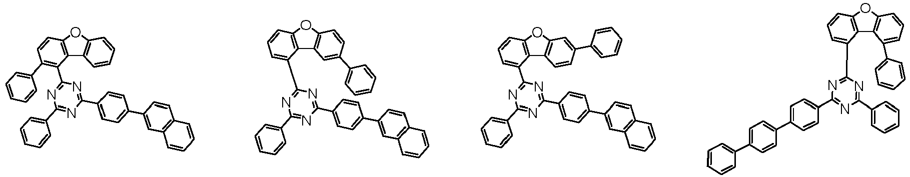

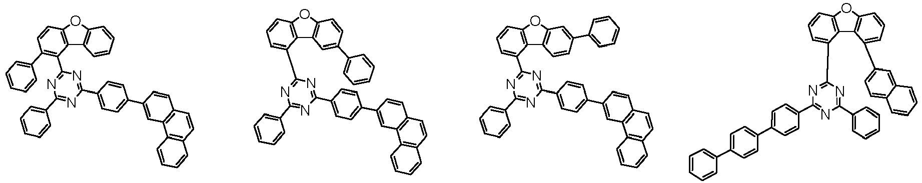

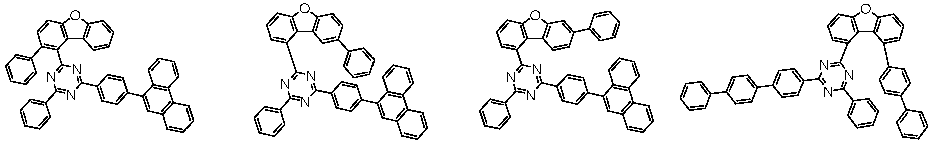

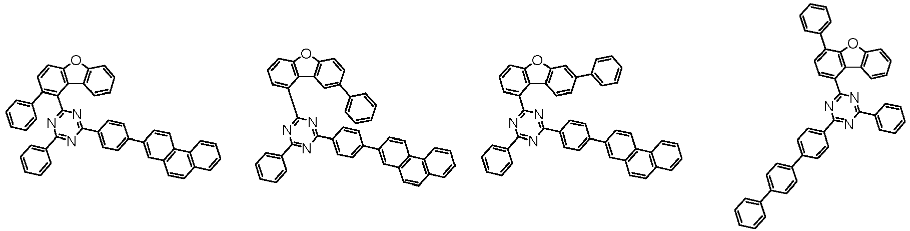

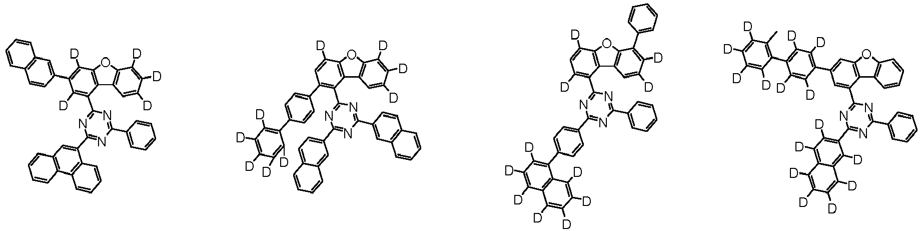

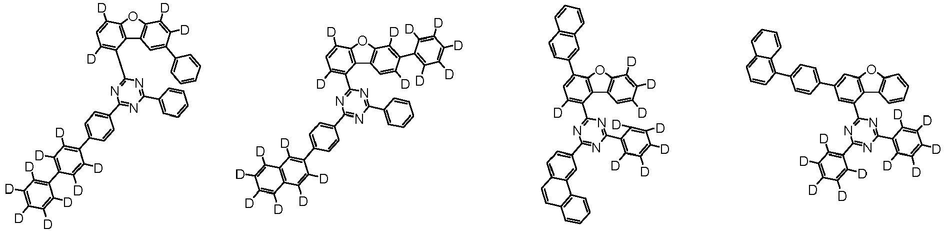

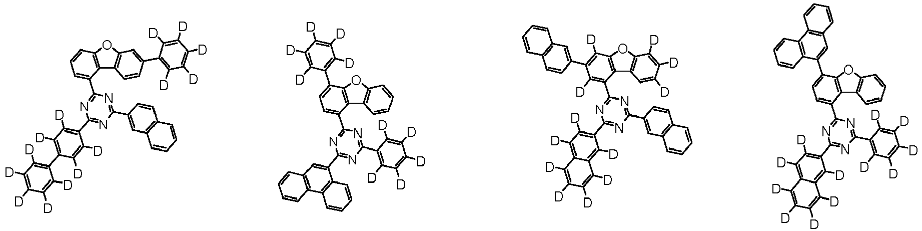

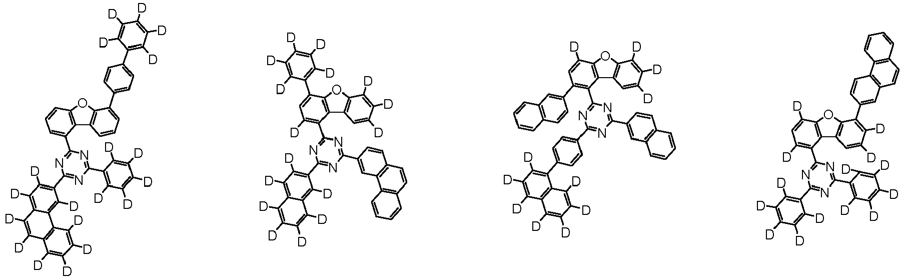

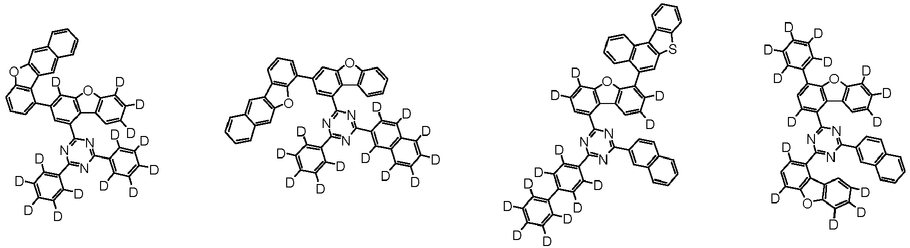

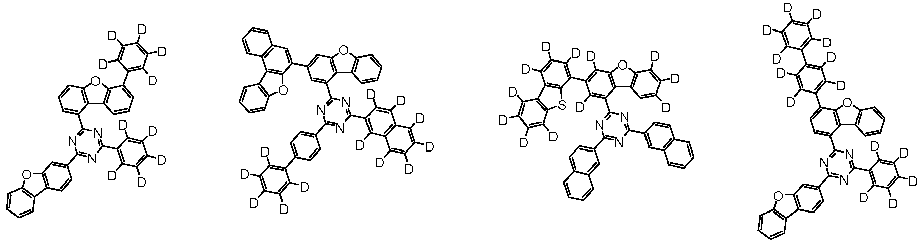

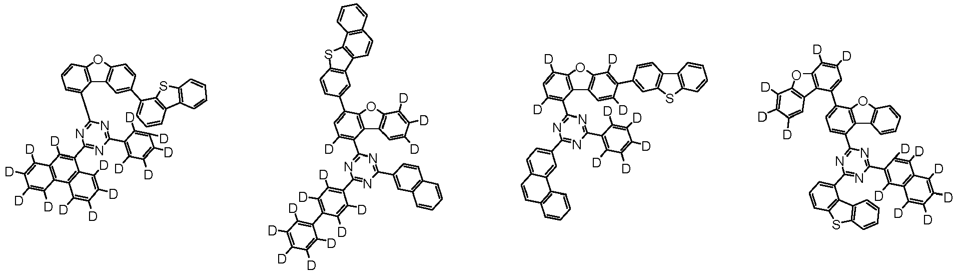

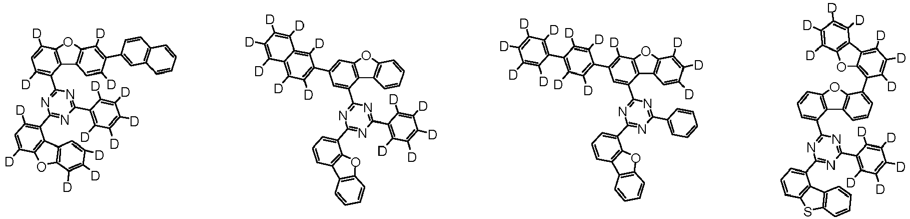

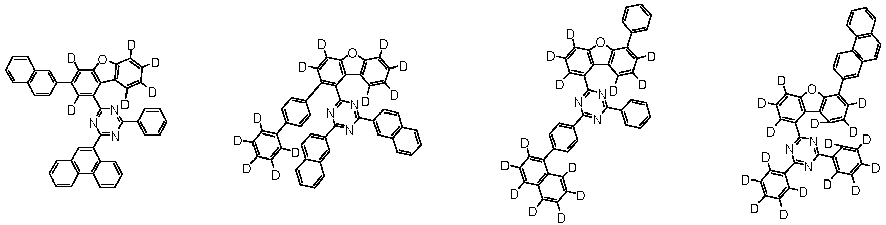

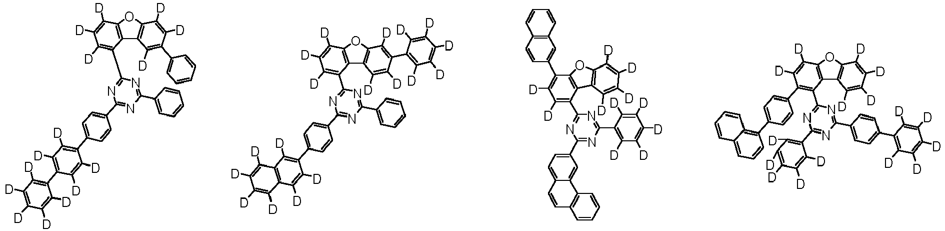

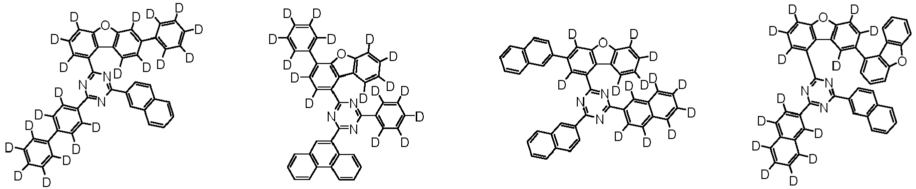

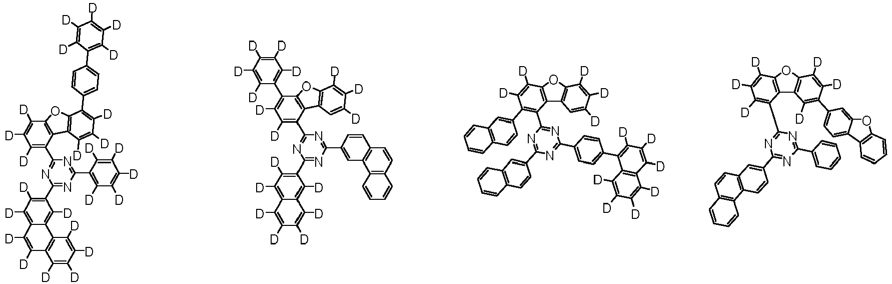

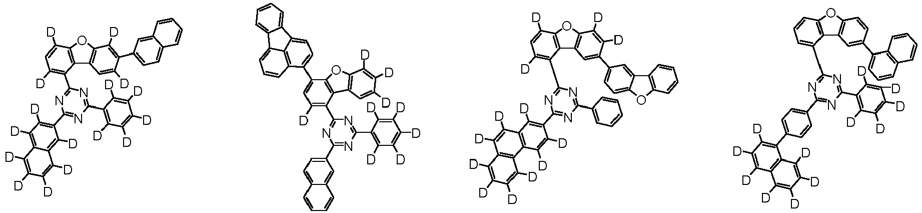

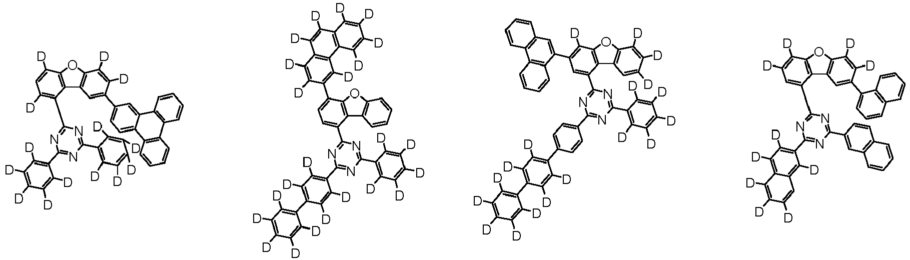

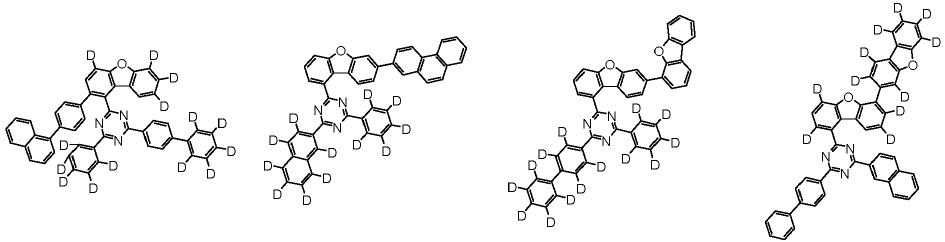

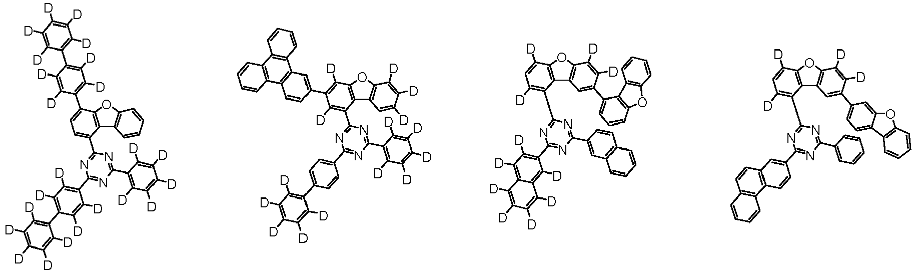

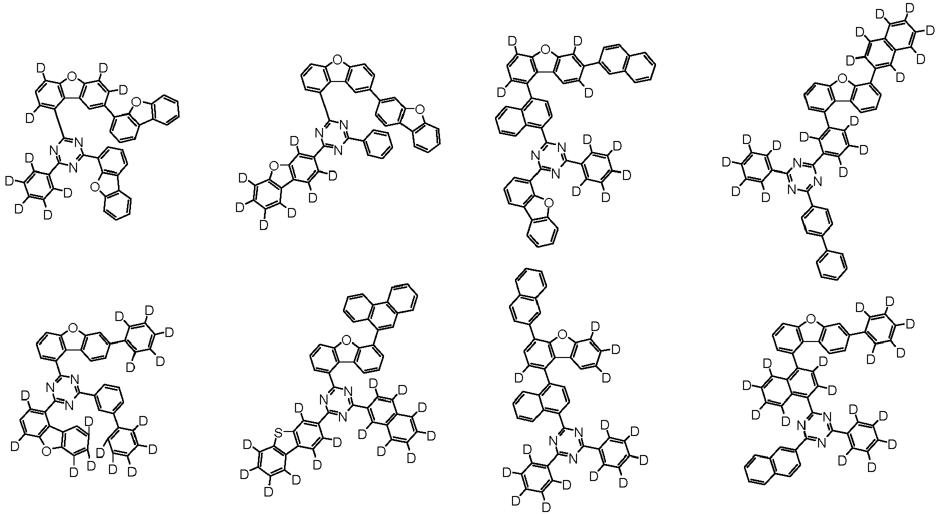

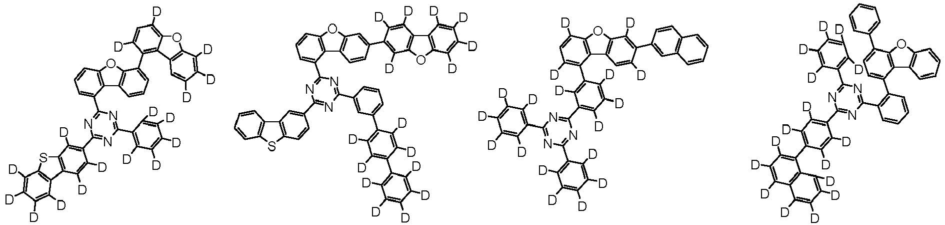

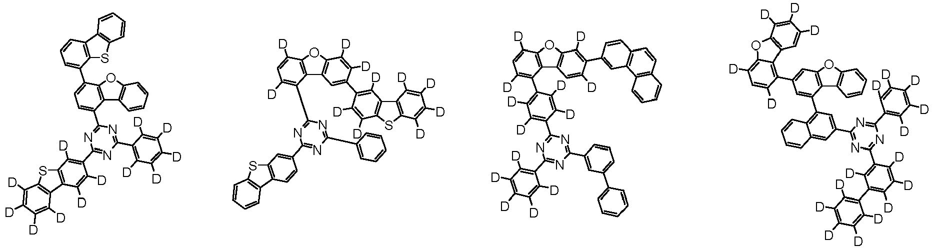

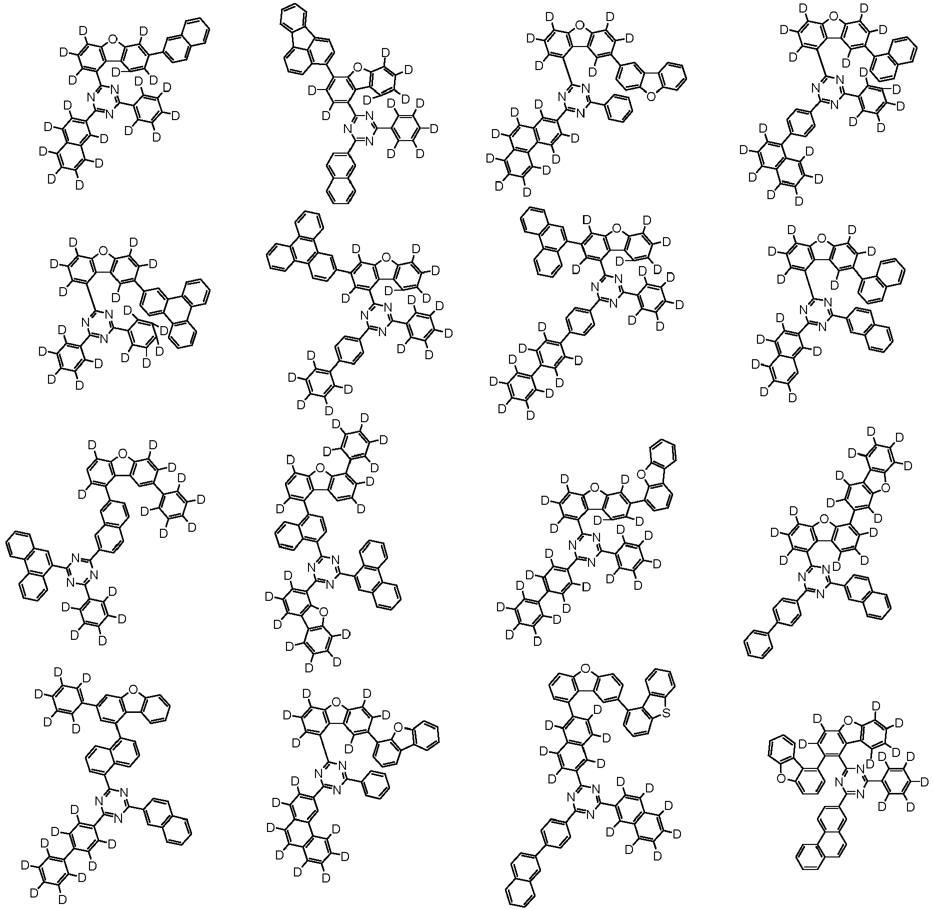

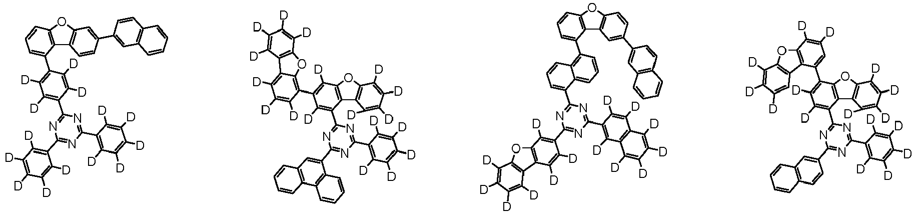

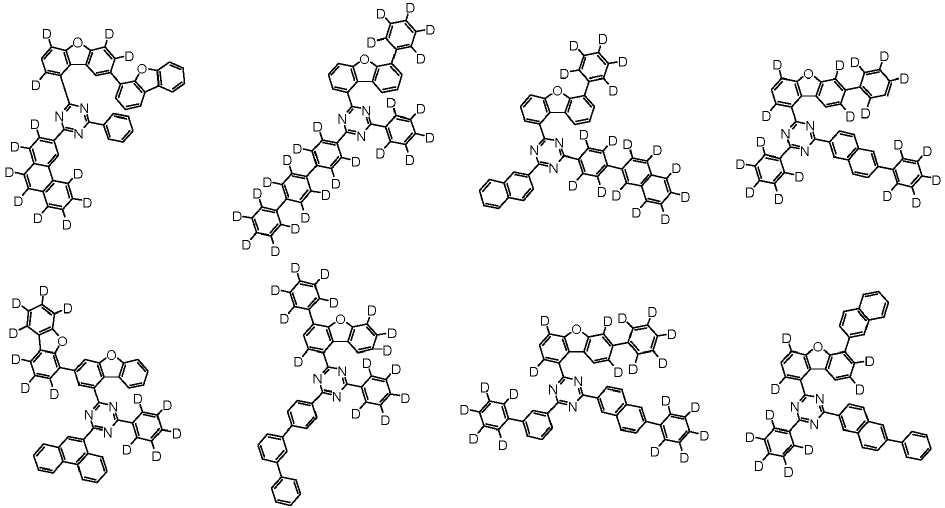

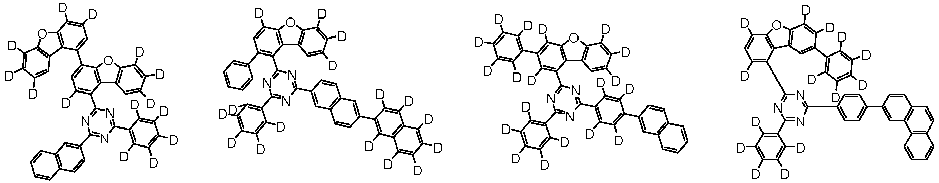

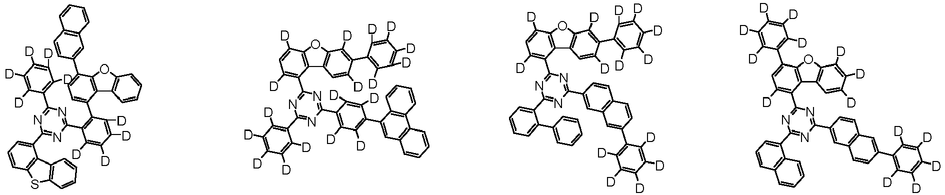

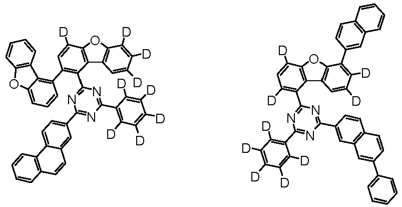

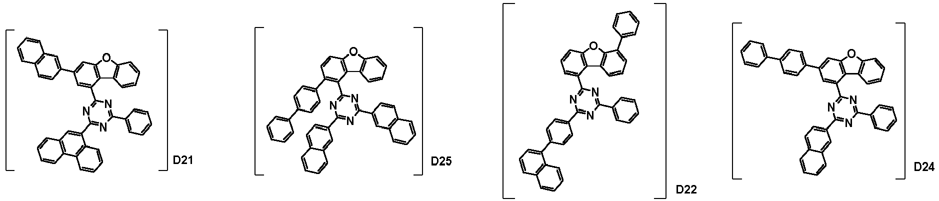

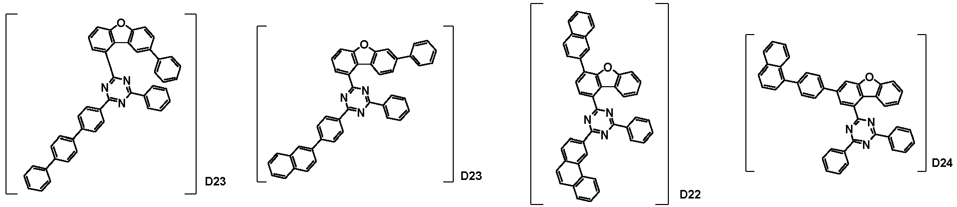

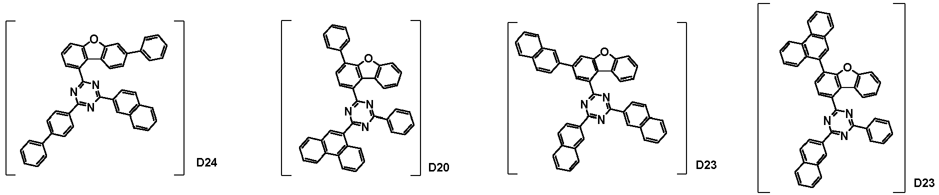

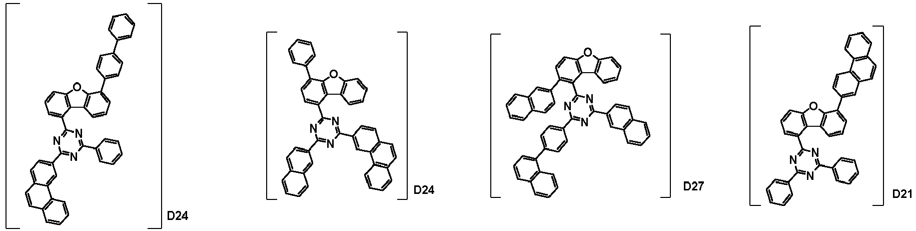

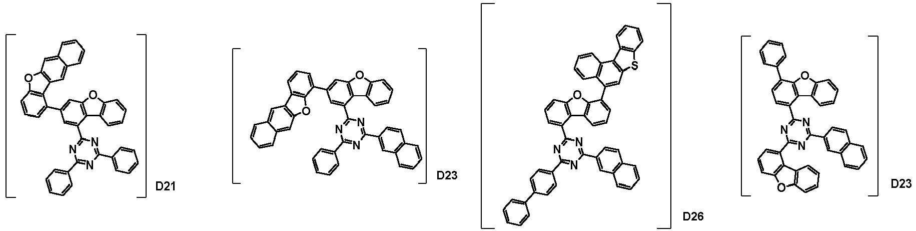

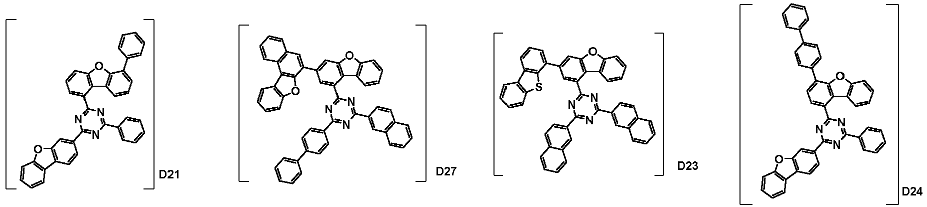

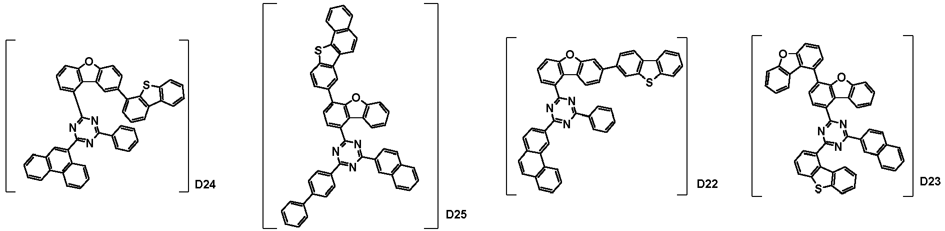

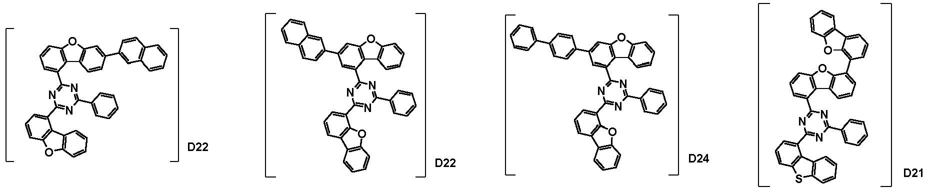

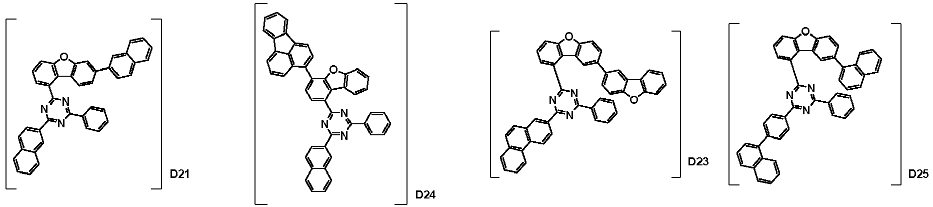

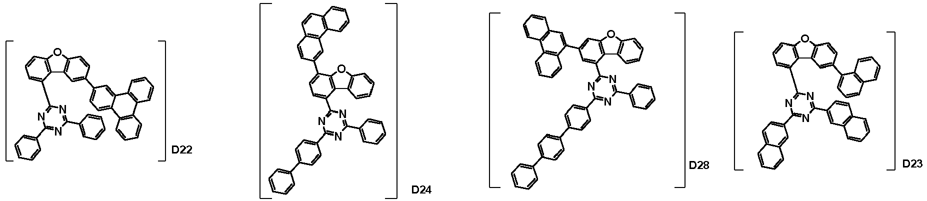

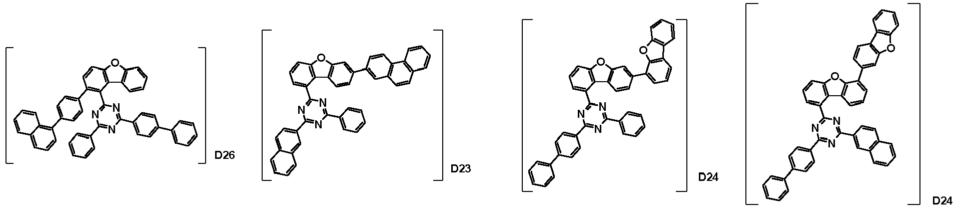

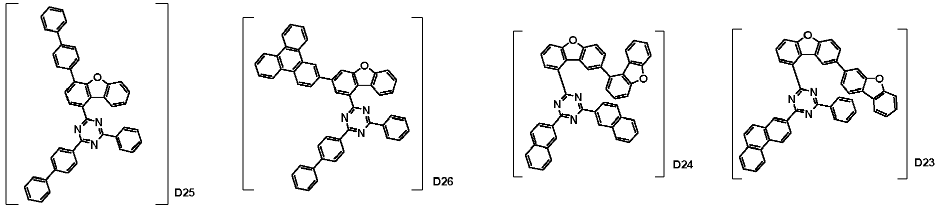

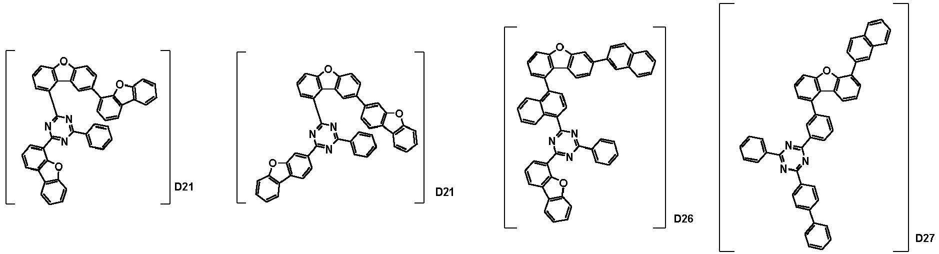

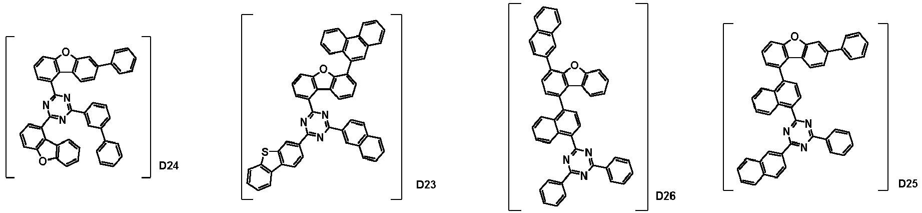

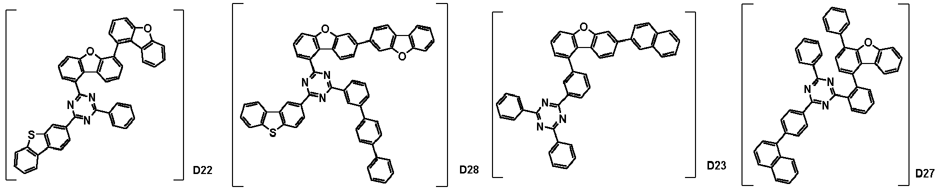

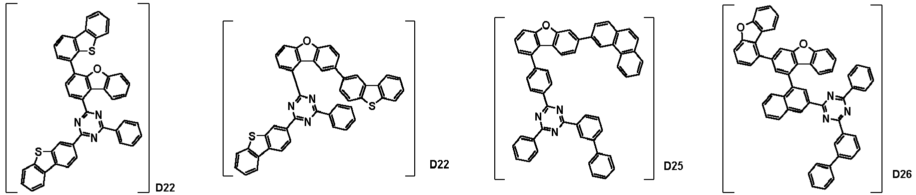

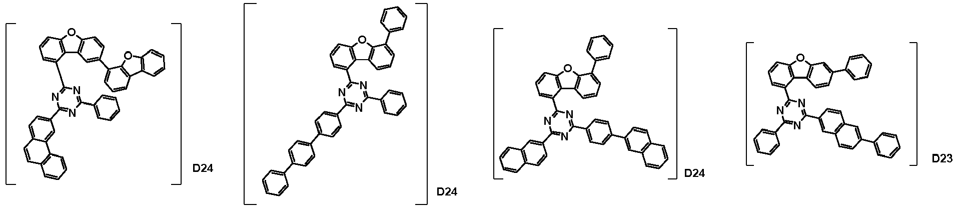

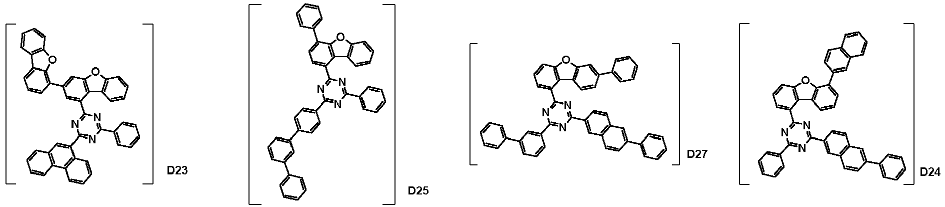

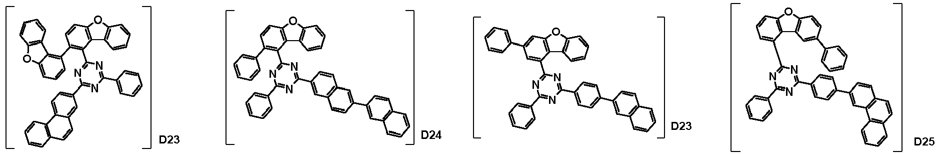

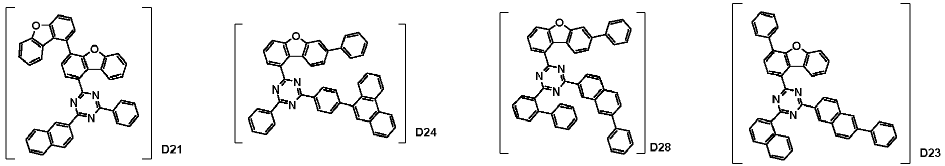

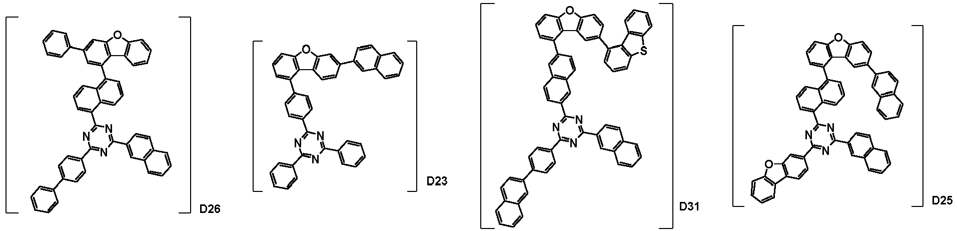

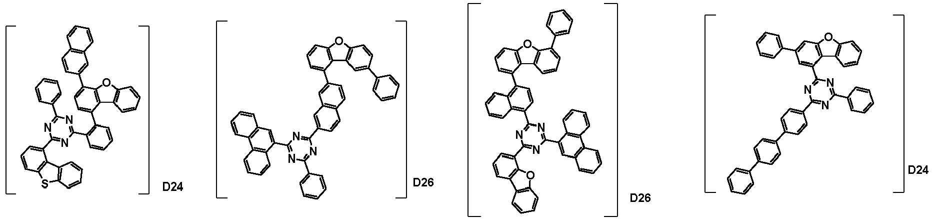

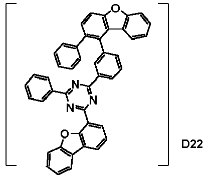

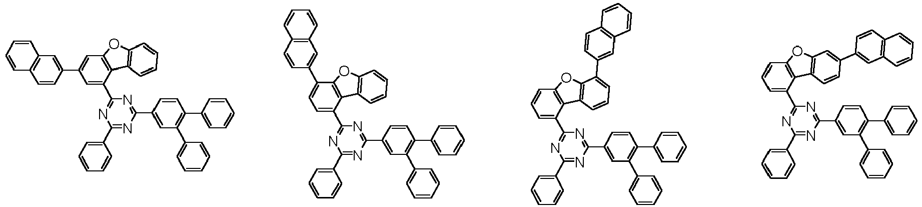

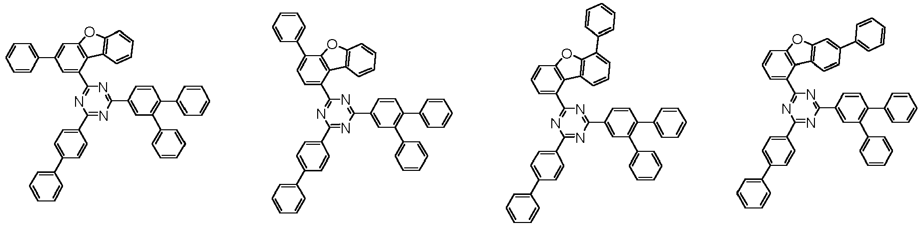

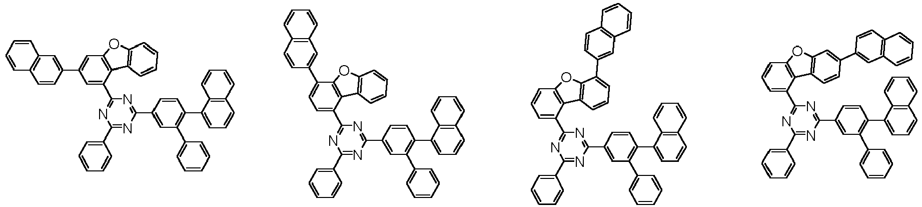

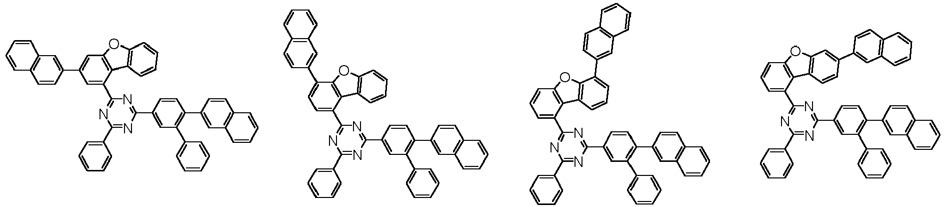

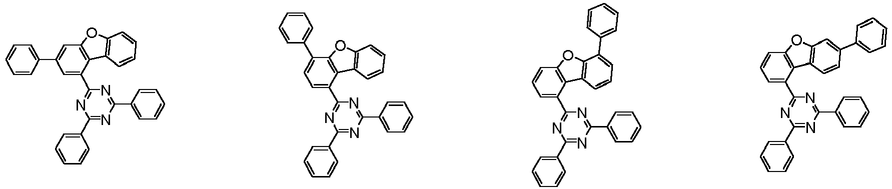

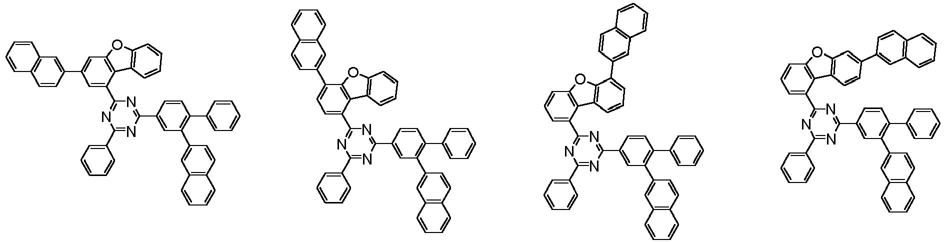

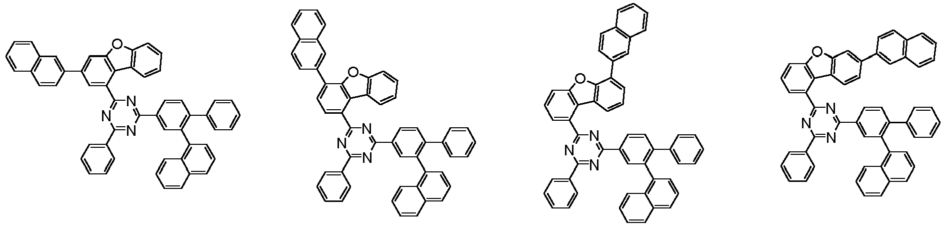

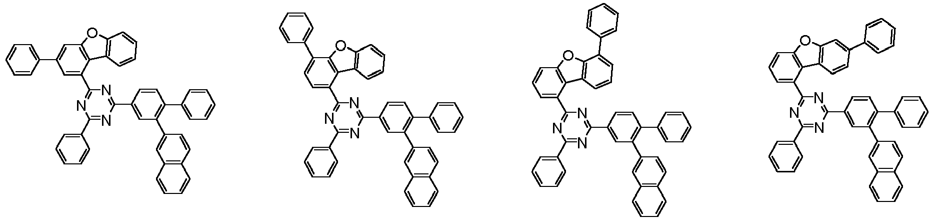

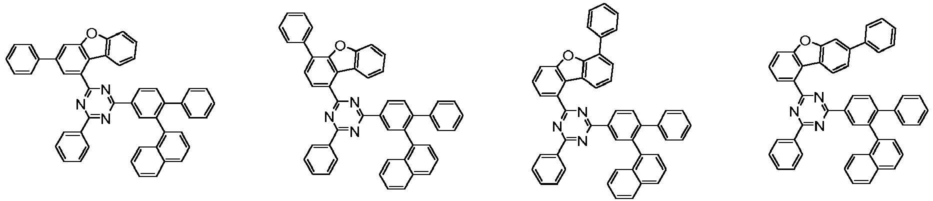

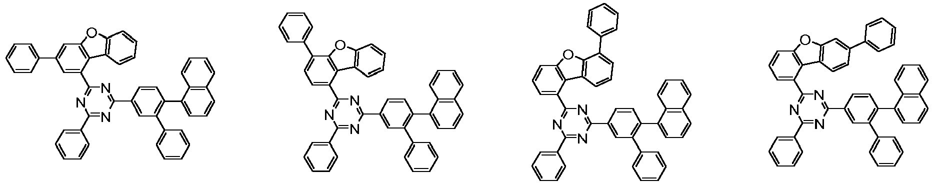

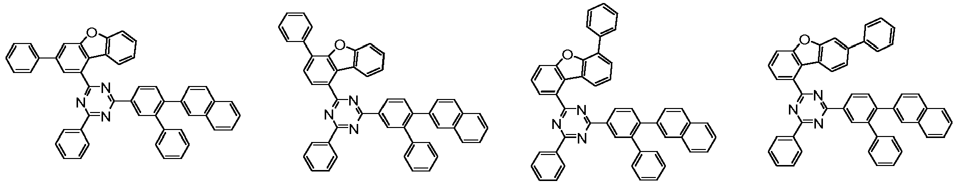

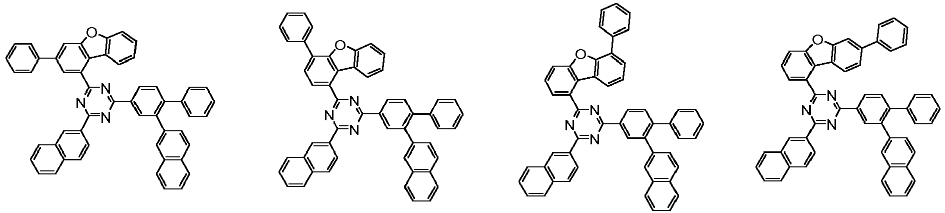

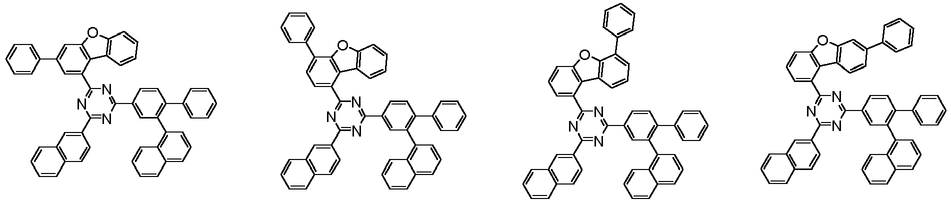

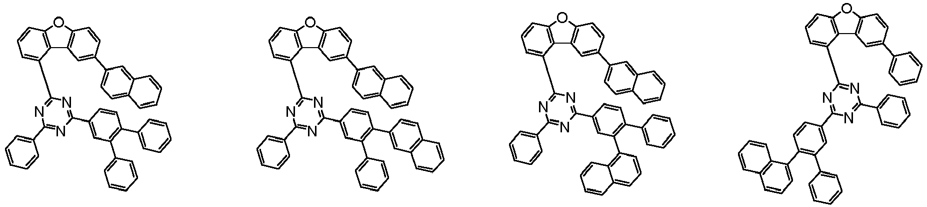

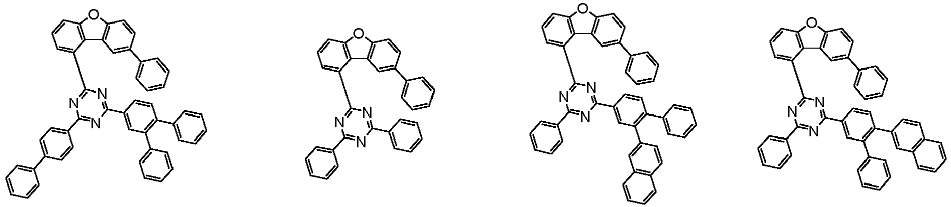

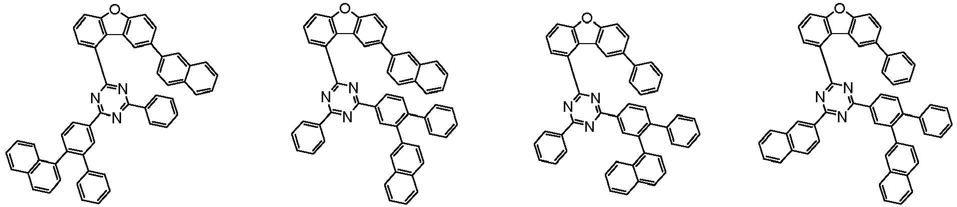

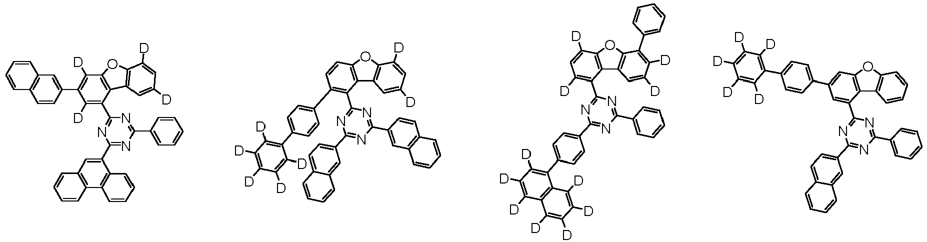

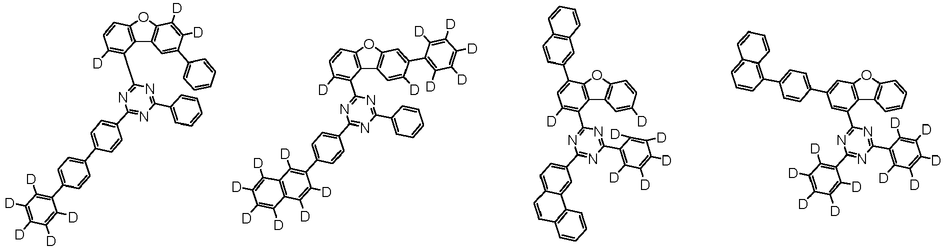

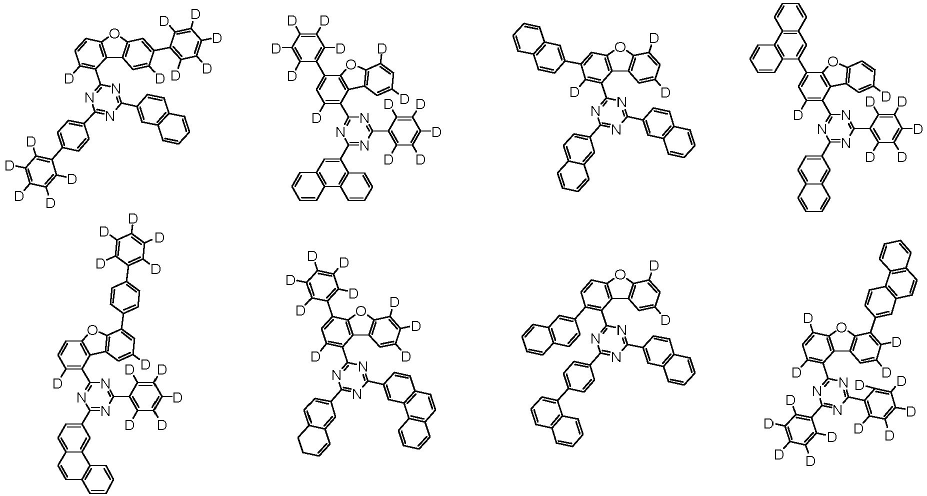

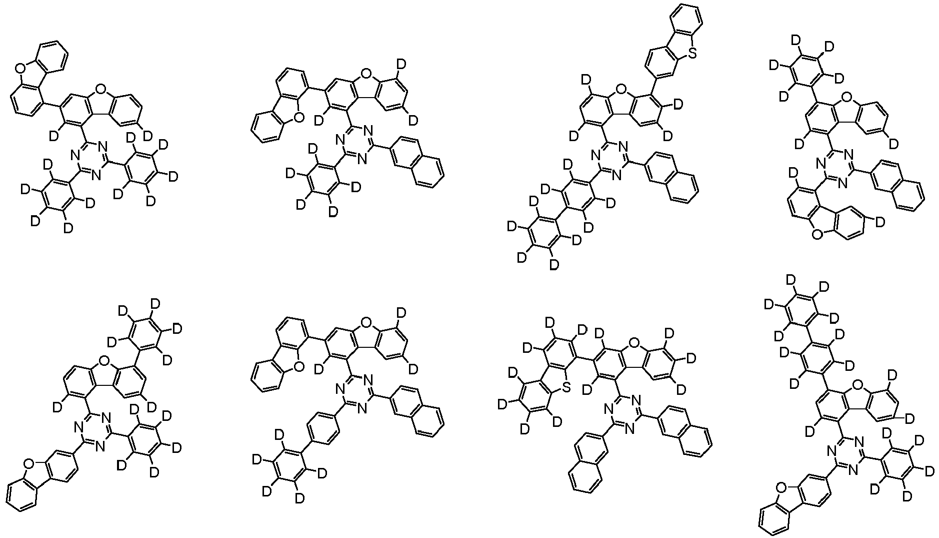

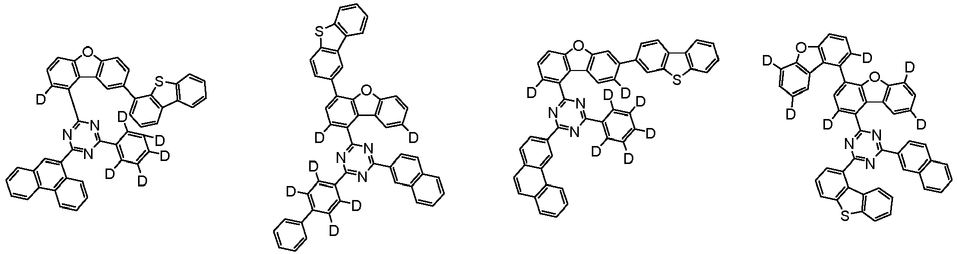

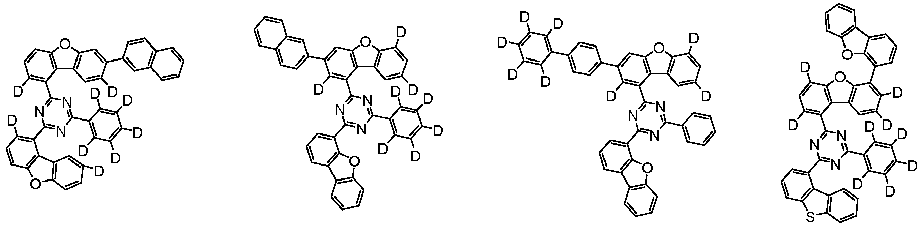

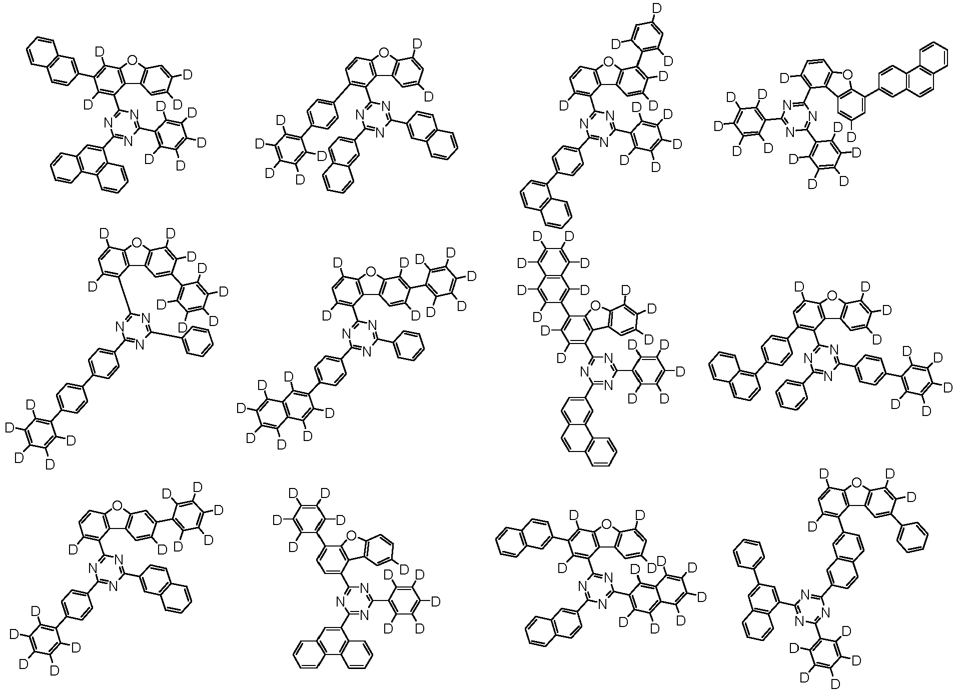

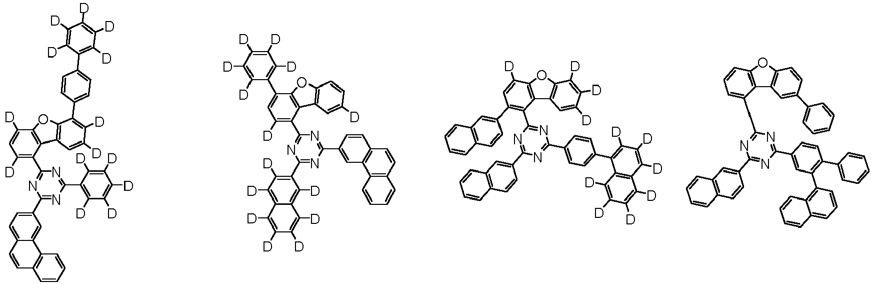

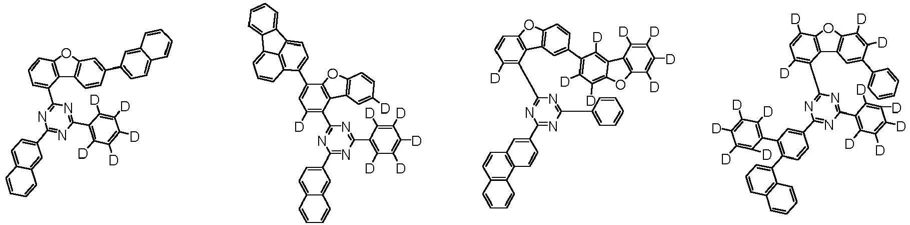

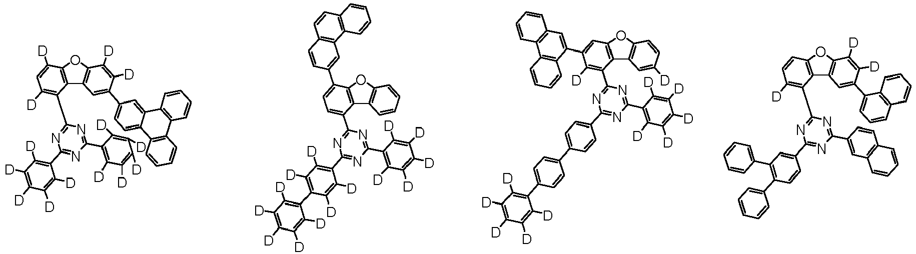

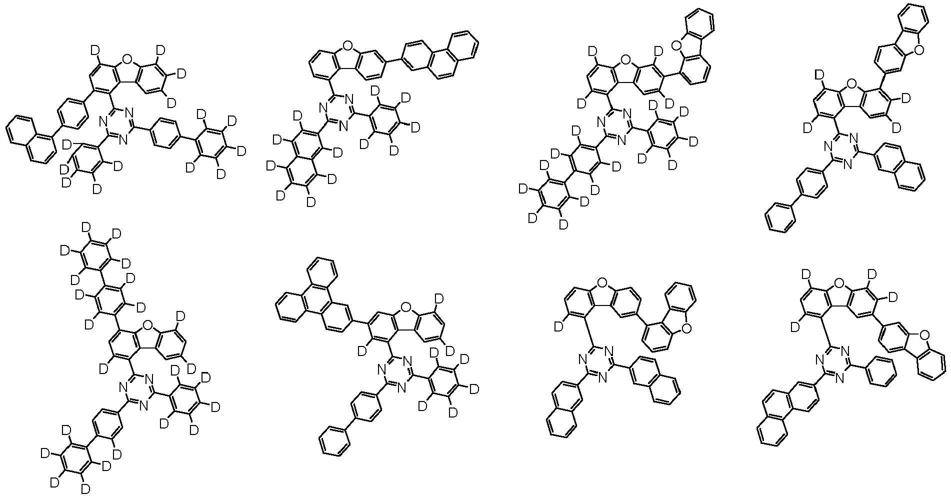

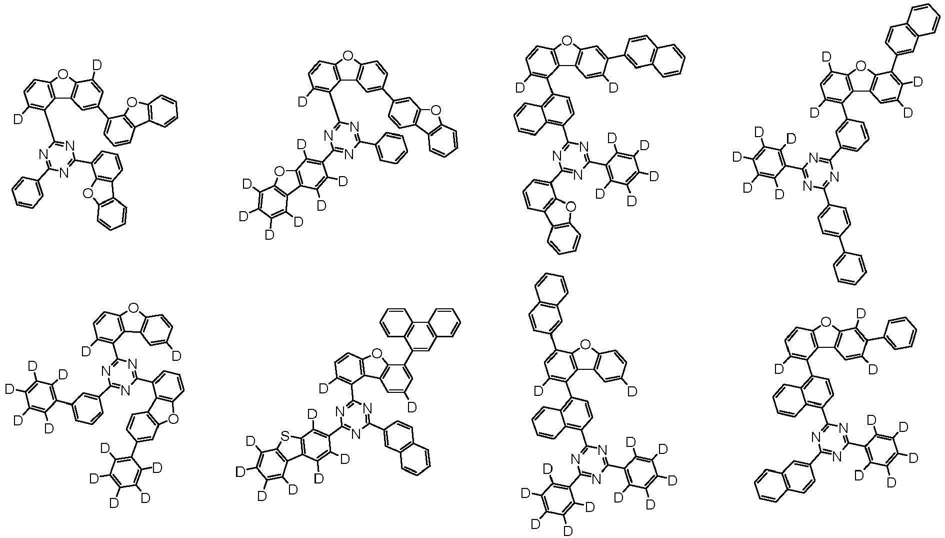

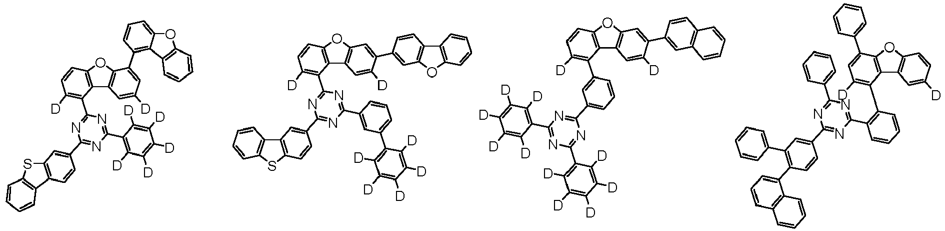

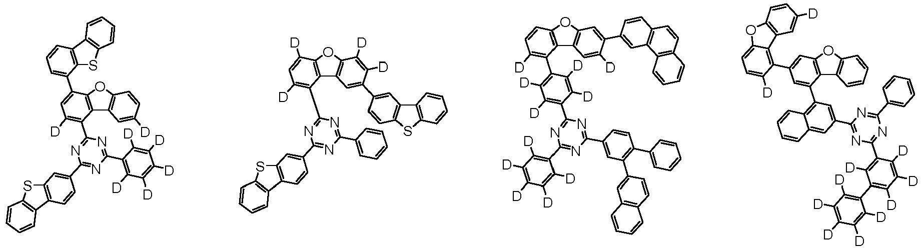

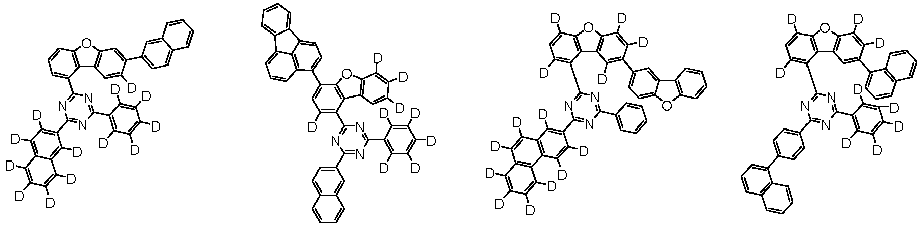

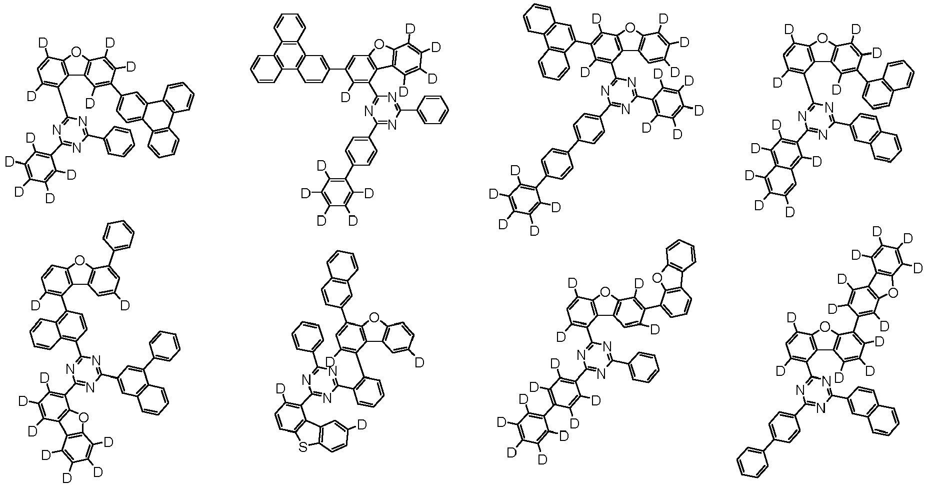

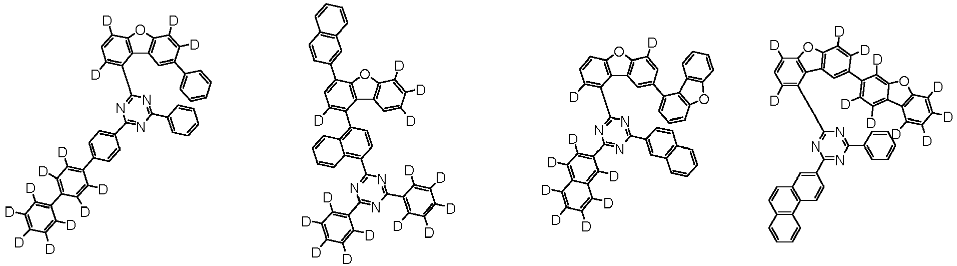

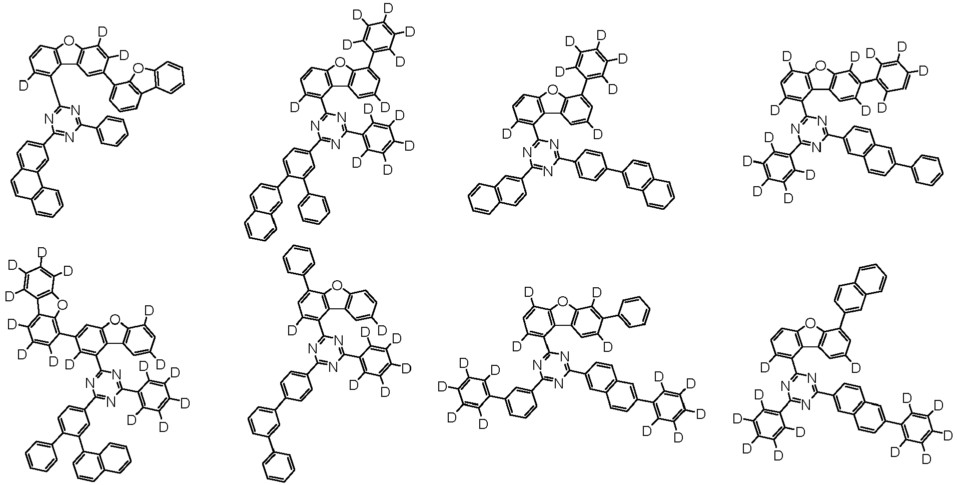

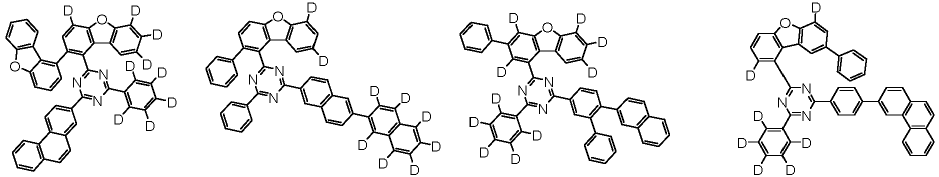

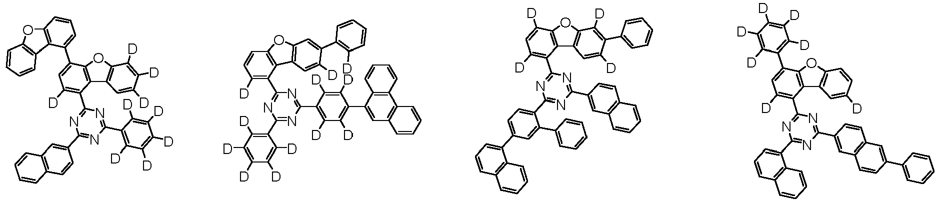

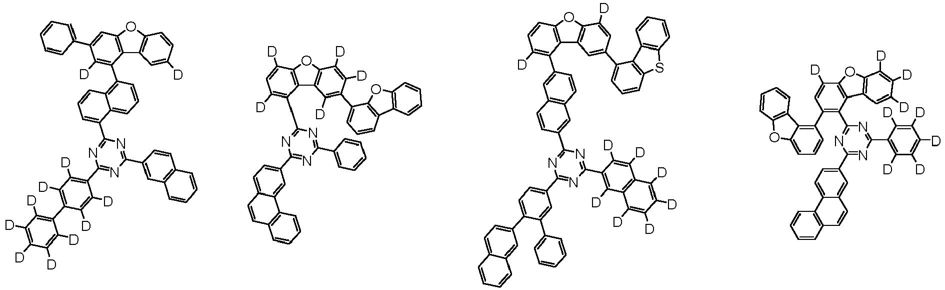

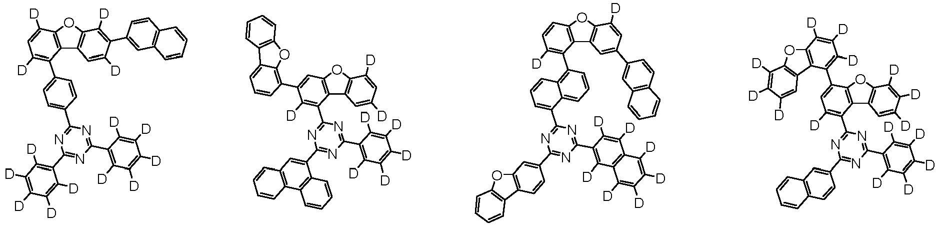

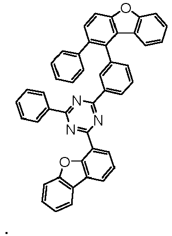

The compound represented by Chemical Formula 1 can be prepared by a preparation method as shown in the following Reaction Scheme 1 as an example, and other remaining compounds can be prepared in a similar manner.

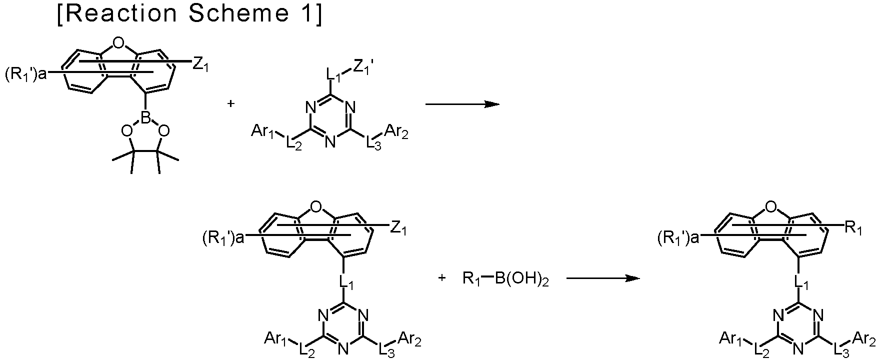

In Reaction Scheme 1, Ar₁ and Ar₂, L₁ to L₃, R₁, R₁' and a are as defined in Chemical Formula 2, and Z₁ and Z₁'are each independently halogen, preferably Z₁ and Z₁'are each independently chloro or bromo.

Reaction Scheme 1 is a Suzuki coupling reaction, which is preferably carried out in the presence of a palladium catalyst and a base, and a reactive group for the Suzuki coupling reaction can be modified as known in the art. The above preparation method may be further embodied in Preparation Examples described hereinafter.

Preferably, the compound represented by Chemical Formula 2 may be represented by any one of the following Chemical Formula 2-1 and Chemical Formula 2-2: 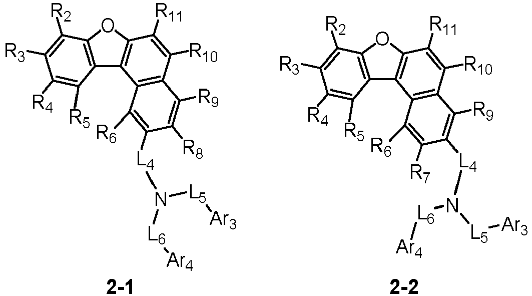 in Chemical Formula 2-1 and Chemical Formula 2-2,
R₂ to R₁₁, Ar₃, Ar₄ and L₄ to L₆ are as defined in Chemical Formula 2.

Preferably, Ar₃ and Ar₄ are each independently a substituted or unsubstituted C₆₋₂₀ aryl; or a substituted or unsubstituted C₂₋₂₀ heteroaryl containing at least one selected from the group consisting of N, O and S.

More preferably, Ar₃ and Ar₄ may be each independently phenyl, triphenylsilyl phenyl, biphenylyl, terphenylyl, naphthyl, phenyl naphthyl, phenanthrenyl, dibenzofuranyl, dibenzothiophenyl, phenyl carbazolyl, or dimethylfluorenyl, and the hydrogens of the Ar₃ and Ar₄ may be each independently unsubstituted or substituted with deuterium.

Preferably, Ar₃ and Ar₄ may be each independently any one selected from the group consisting of:

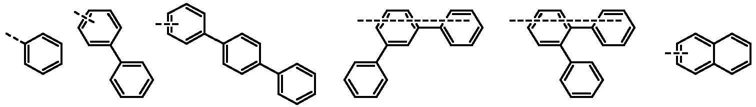

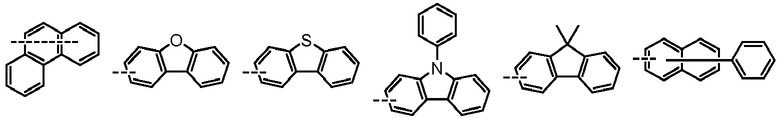

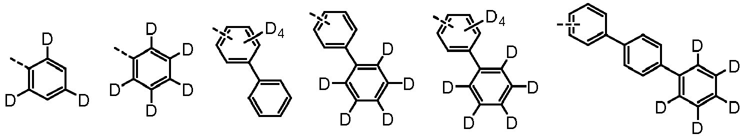

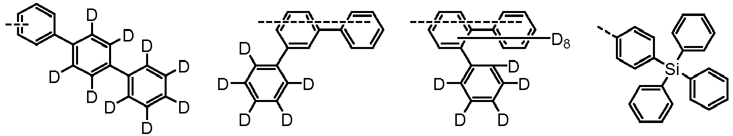

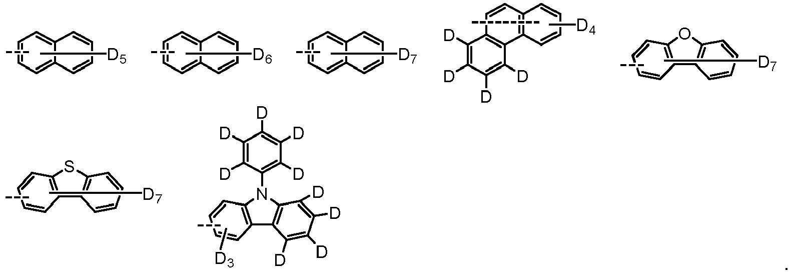

Preferably, L₄ is phenylene, biphenyldiyl, or naphthalenediyl, provided that the phenylene, biphenyldiyl and naphthalenediyl may each be unsubstituted or substituted with deuterium or a C₆₋₆₀ aryl.

More preferably, L₄ may be phenylene, biphenyldiyl, biphenyldiyl substituted with phenyl, or naphthalenediyl, and the hydrogens of the L₄ may be each independently unsubstituted or substituted with deuterium.

Preferably, L₄ may be any one selected from the group consisting of:

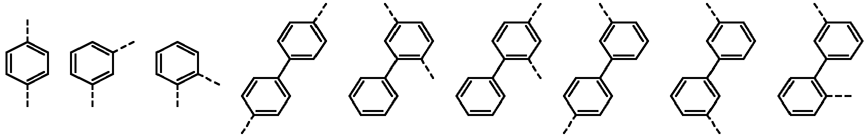

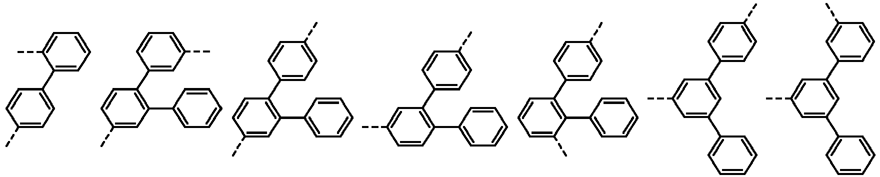

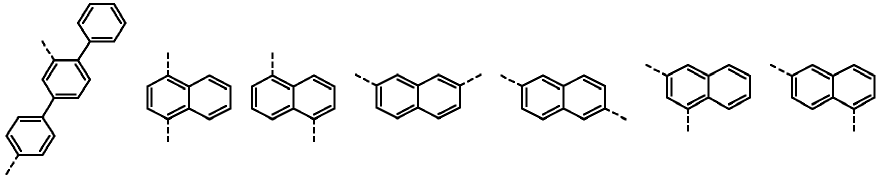

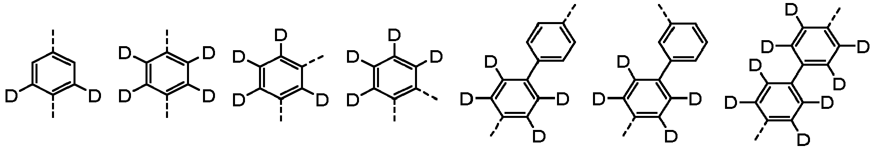

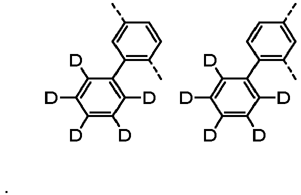

Preferably, L₅ and L₆ are each independently a single bond; a substituted or unsubstituted C₆₋₂₀ arylene; or a substituted or unsubstituted C₂₋₂₀ heteroarylene containing at least one selected from the group consisting of N, O and S.

More preferably, L₅ and L₆ may be each independently a single bond, phenylene, biphenyldiyl, naphthalenediyl, or carbazolediyl, and the hydrogens of L₅ and L₆ may be each independently unsubstituted or substituted with deuterium.

Representative examples of the compound represented by Chemical Formula 2 are as follows:

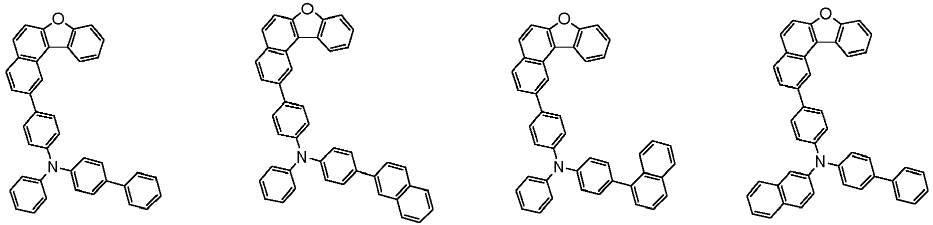

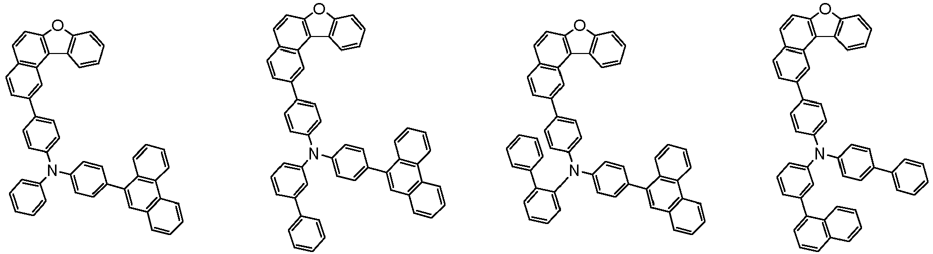

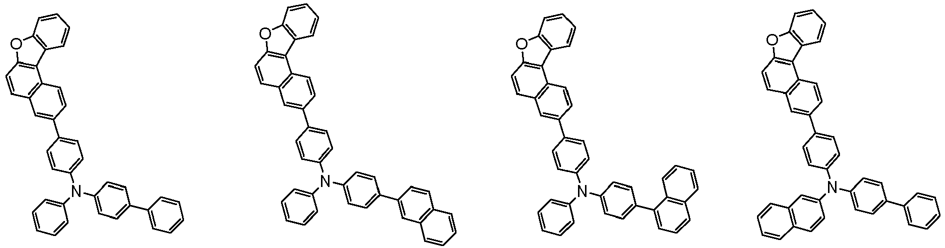

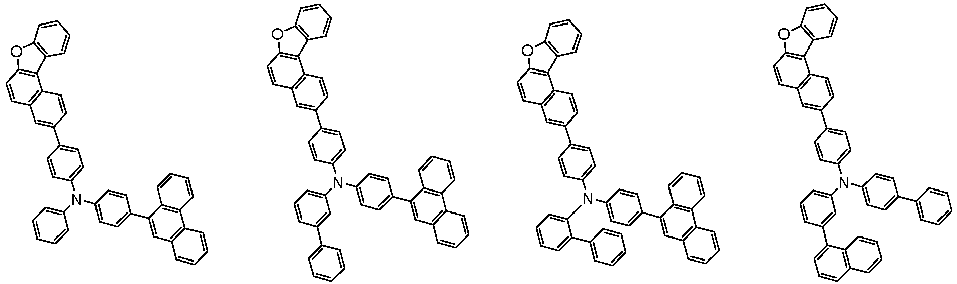

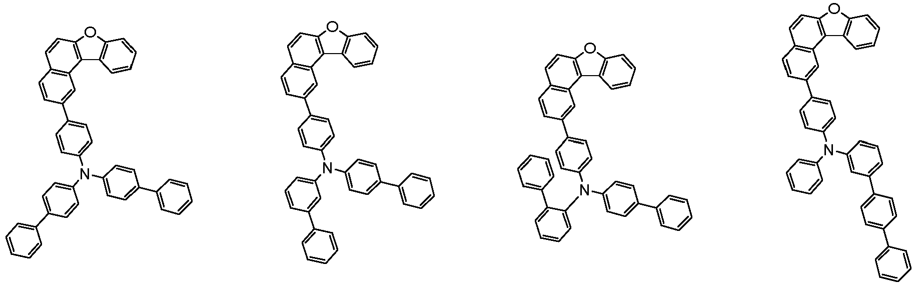

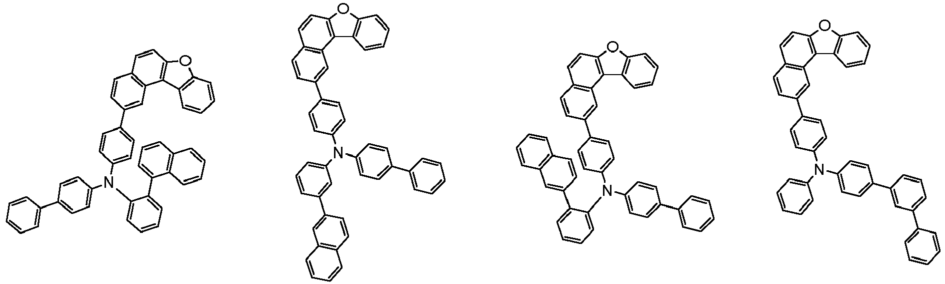

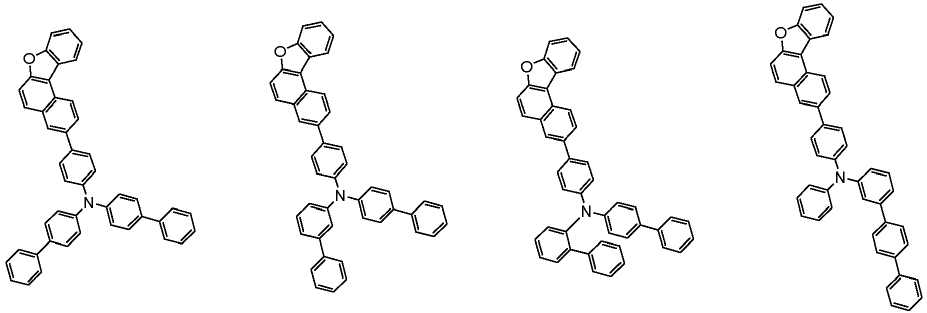

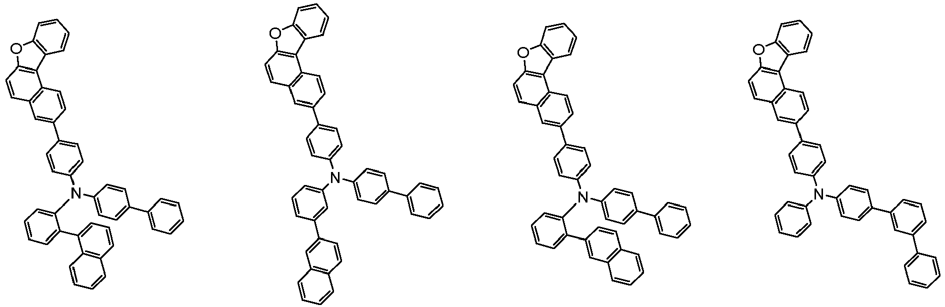

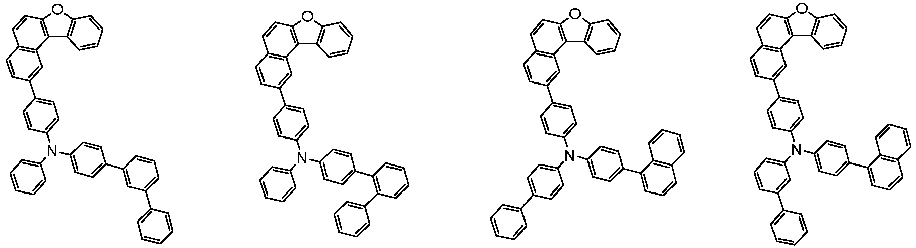

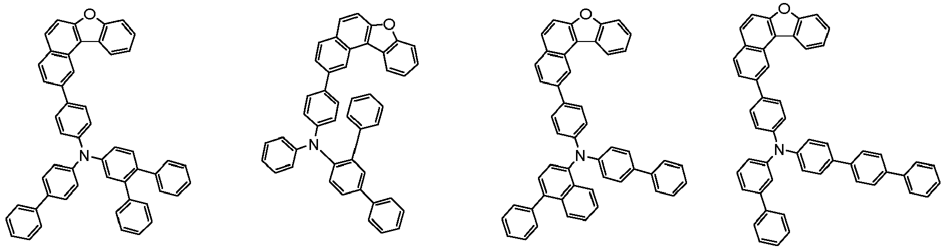

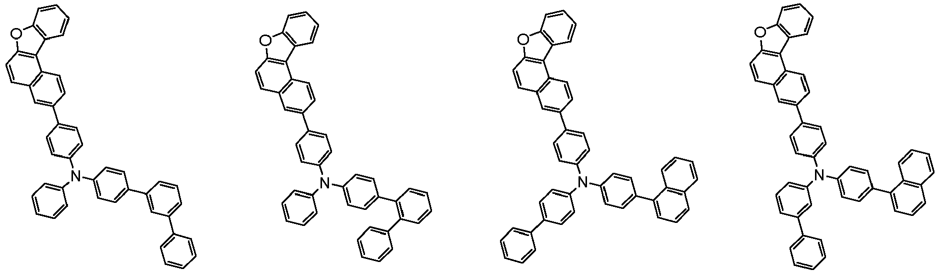

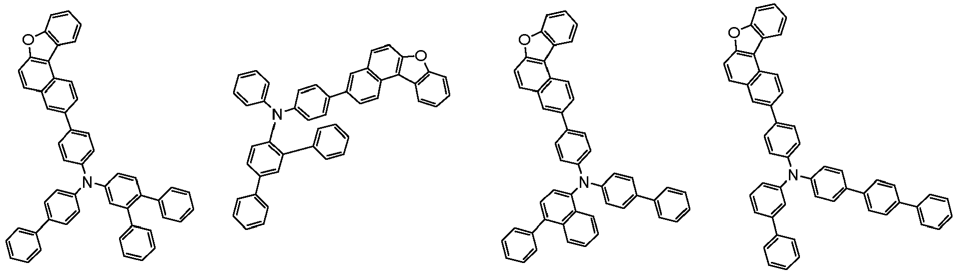

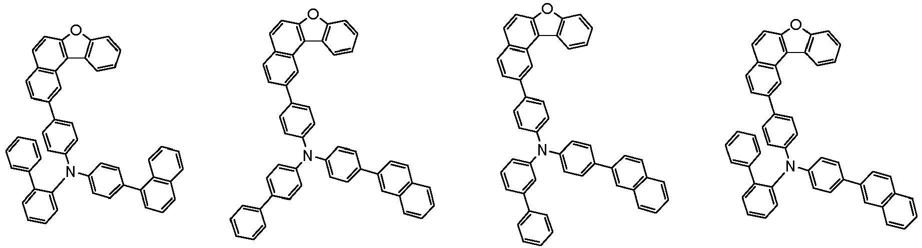

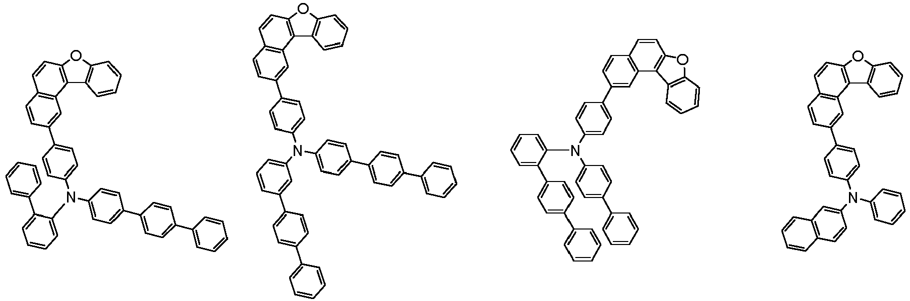

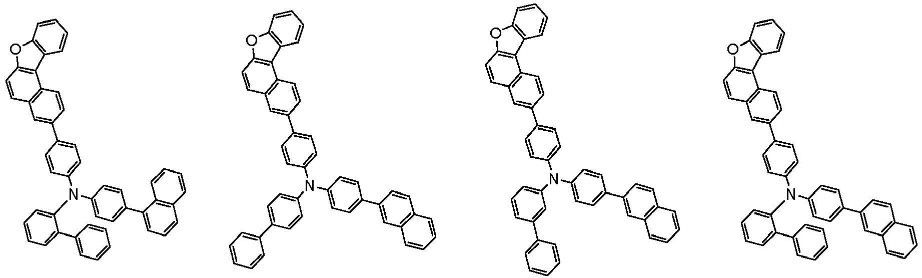

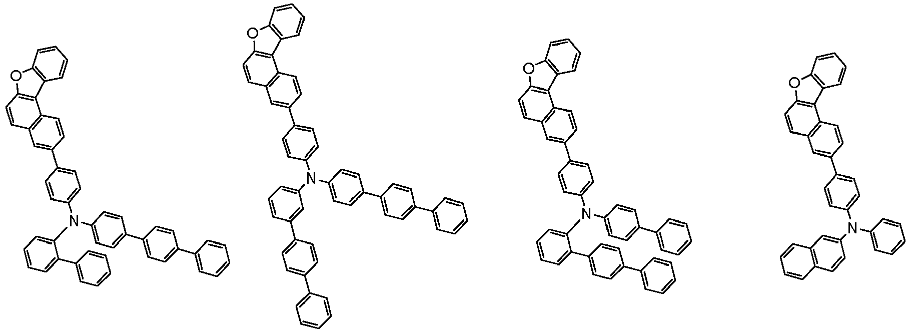

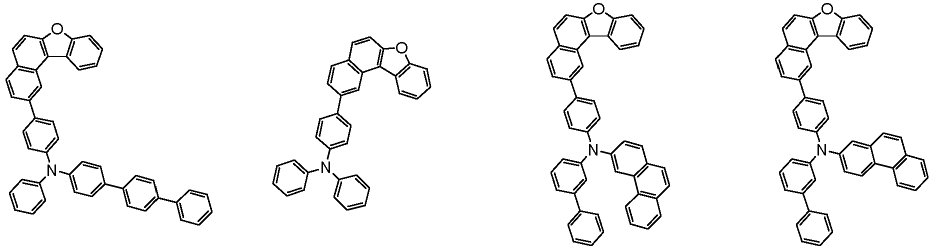

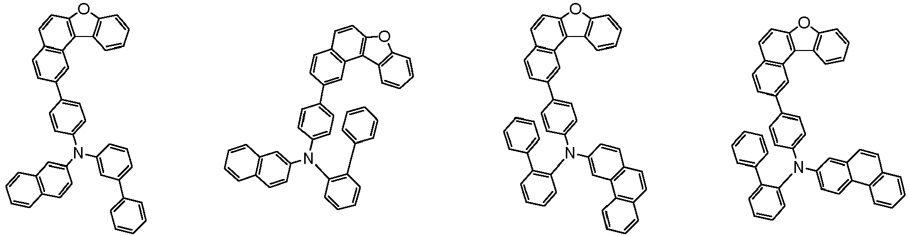

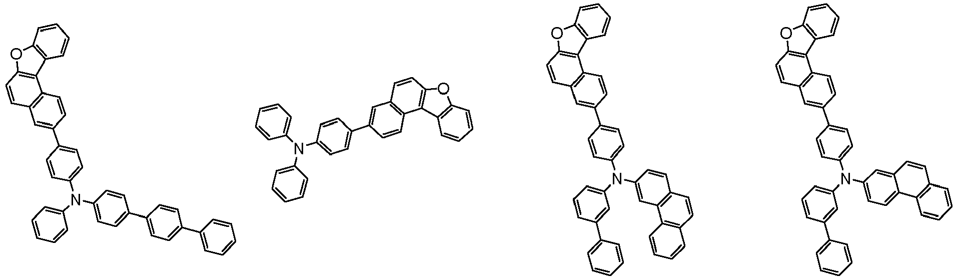

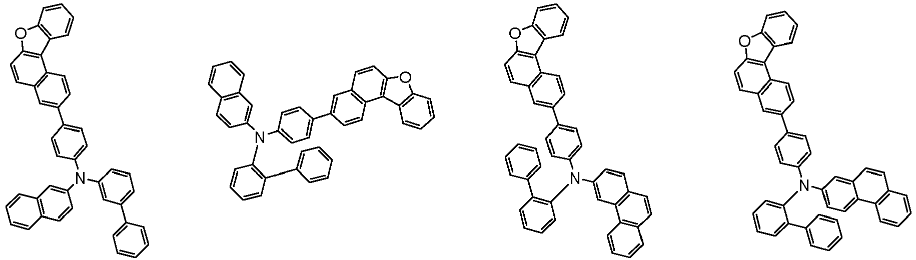

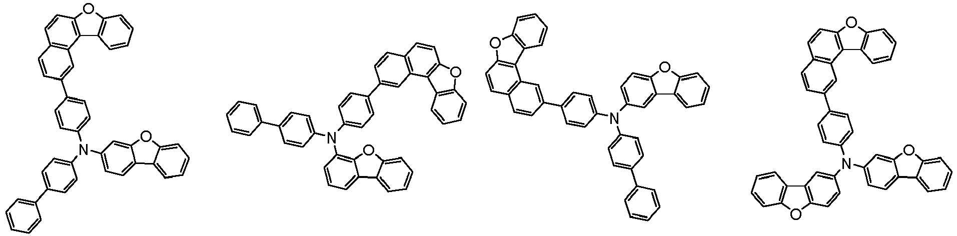

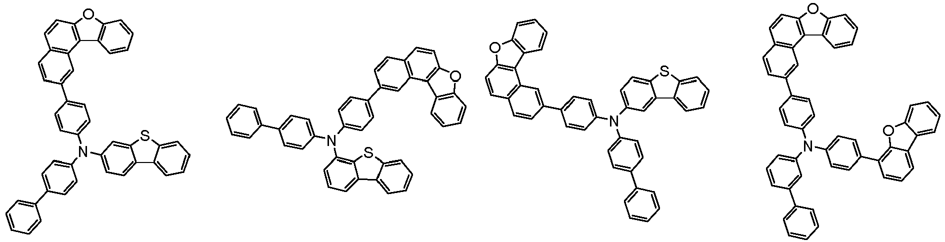

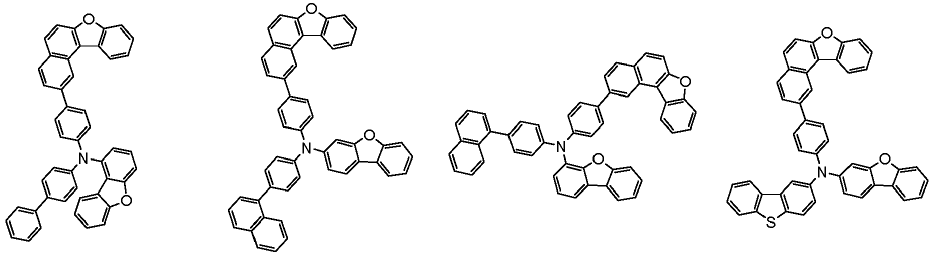

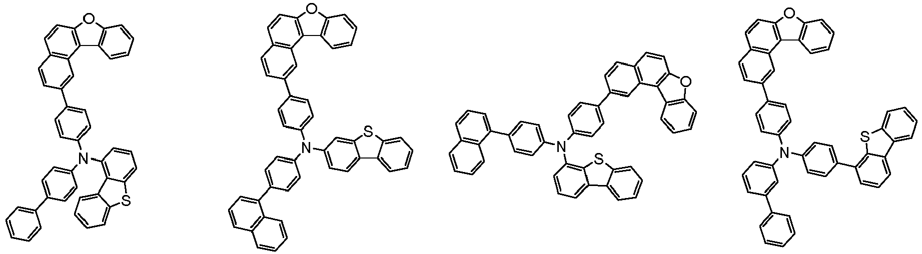

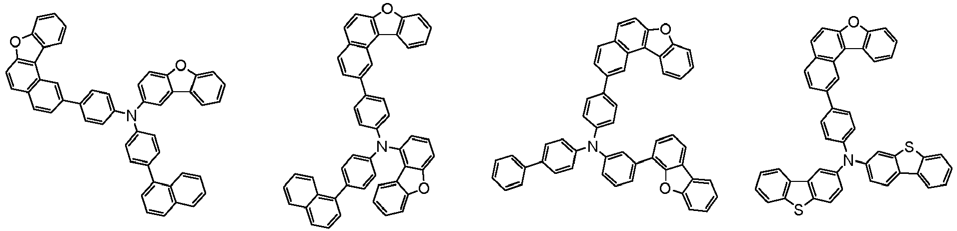

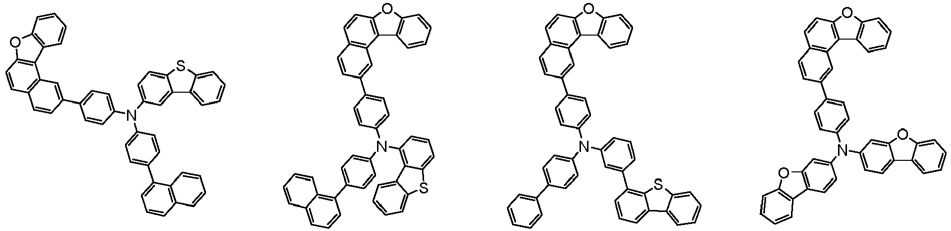

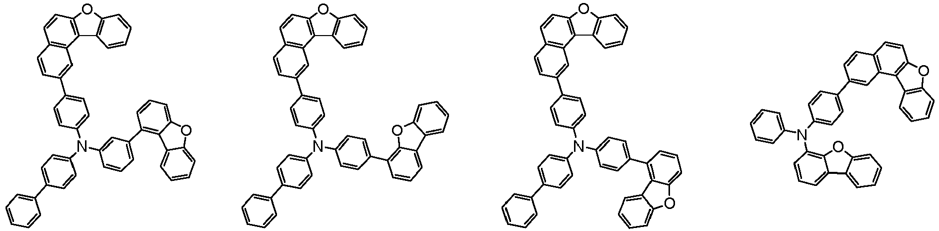

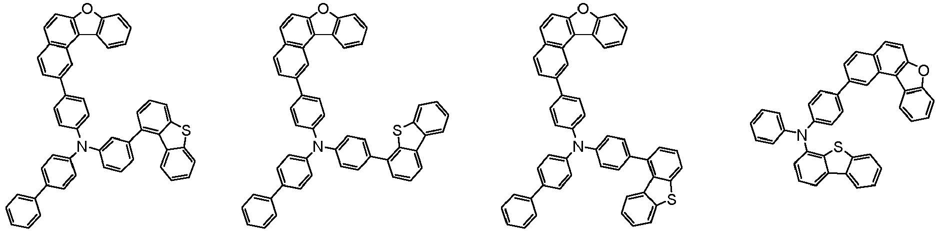

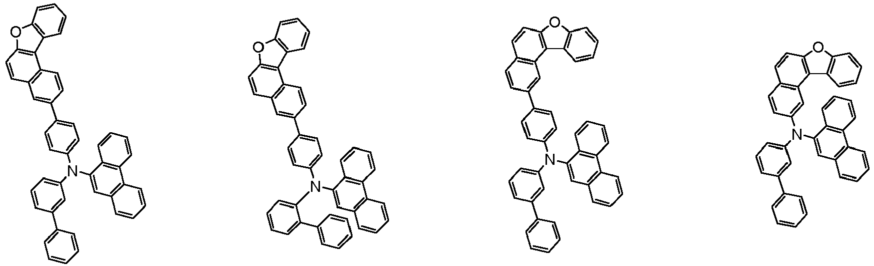

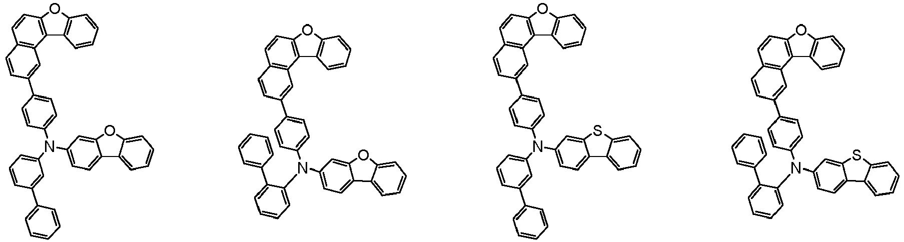

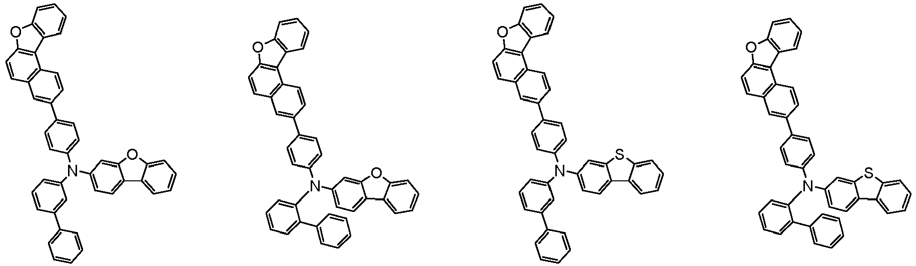

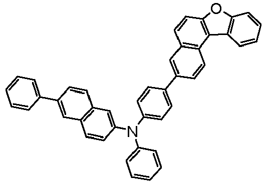

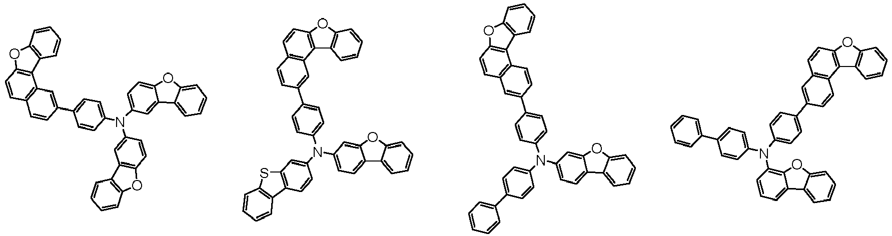

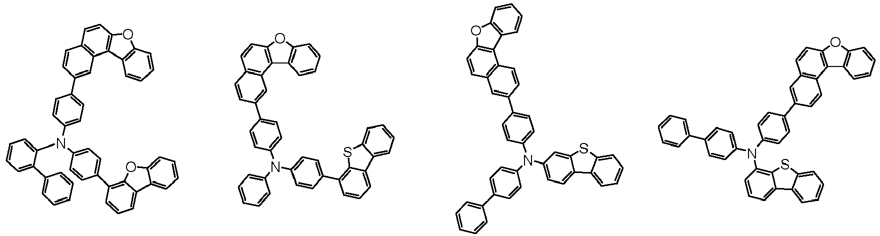

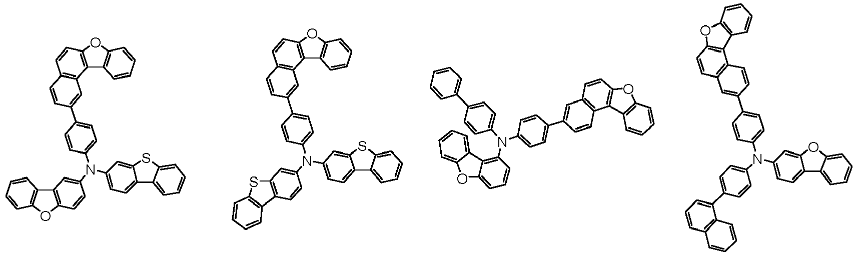

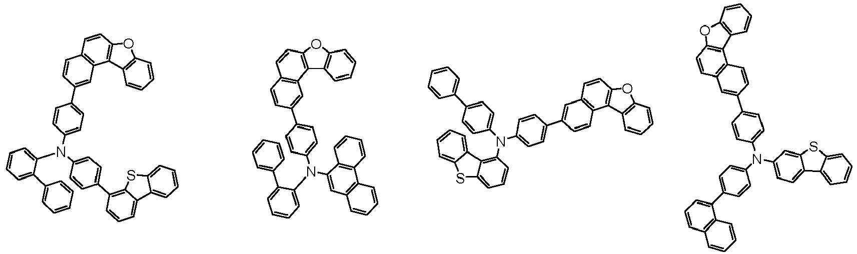

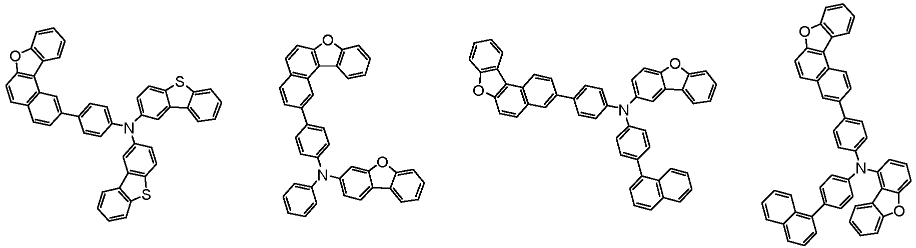

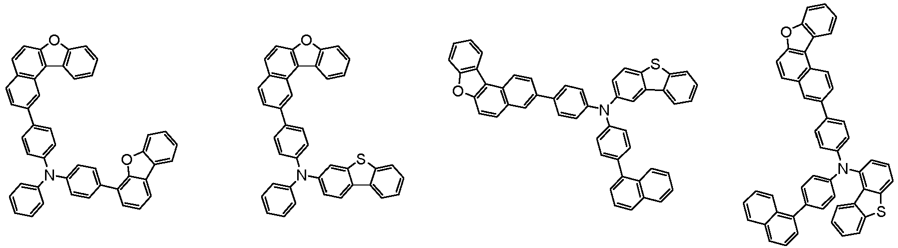

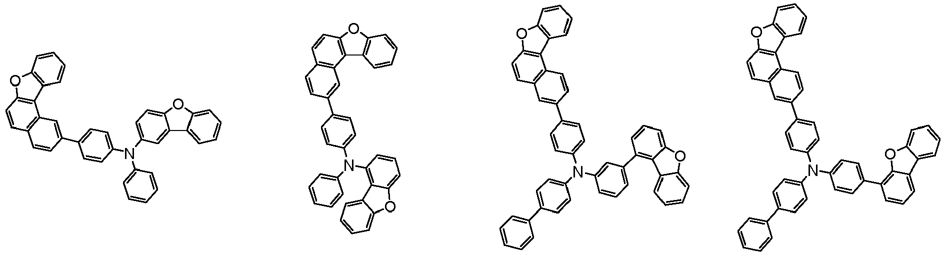

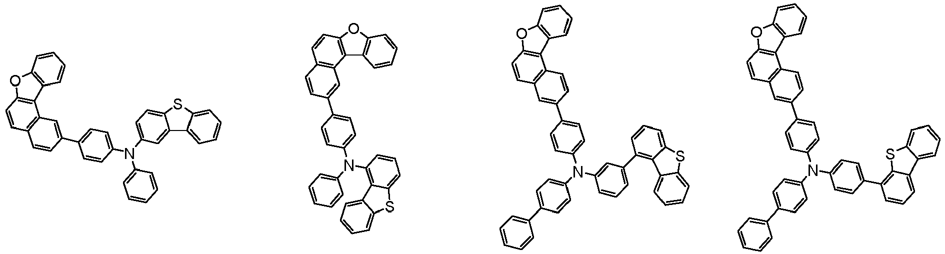

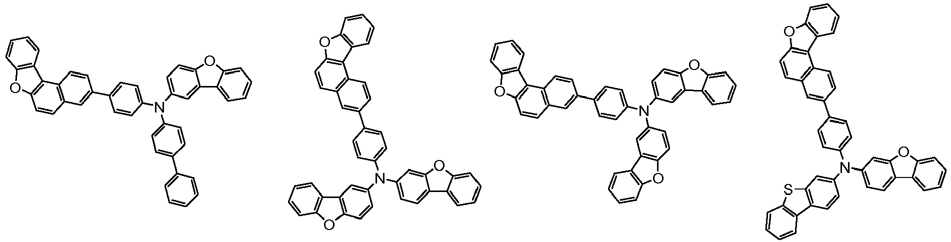

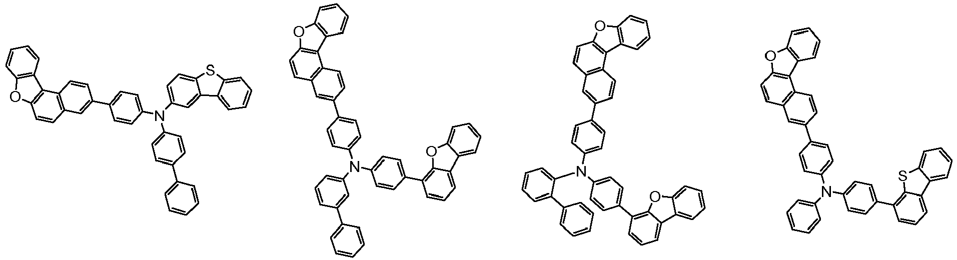

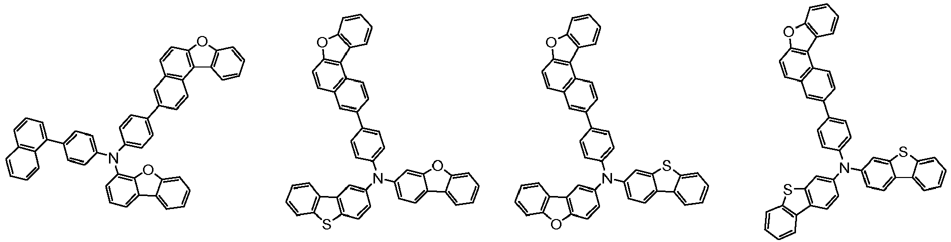

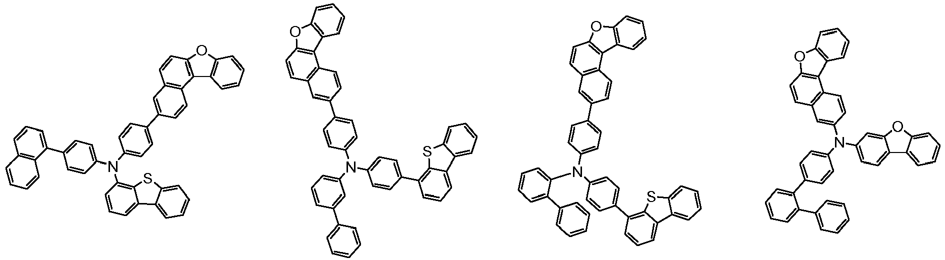

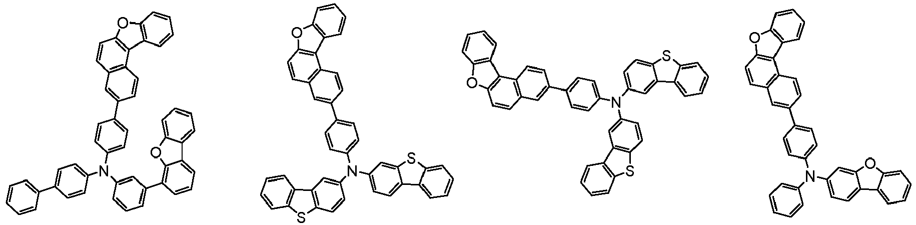

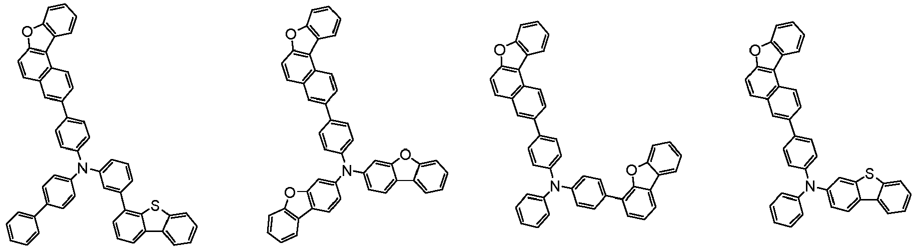

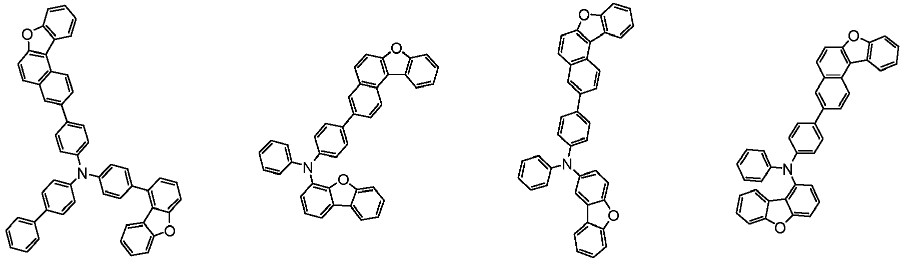

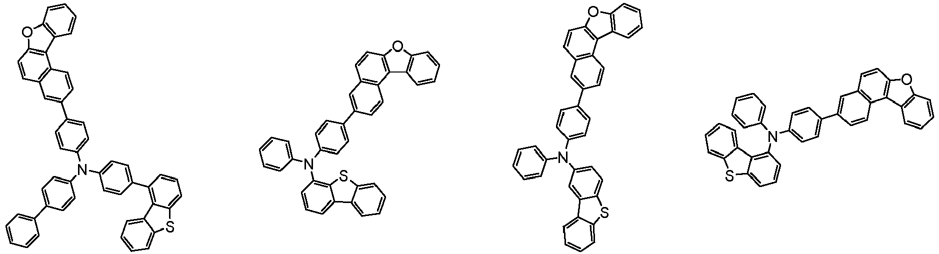

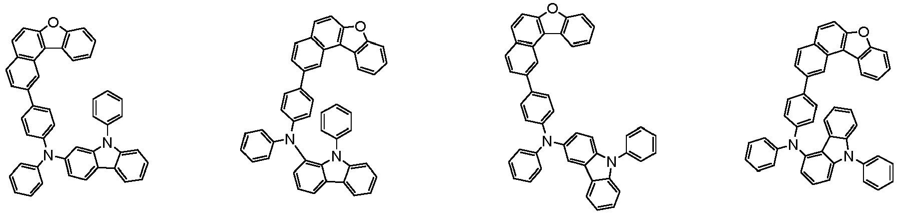

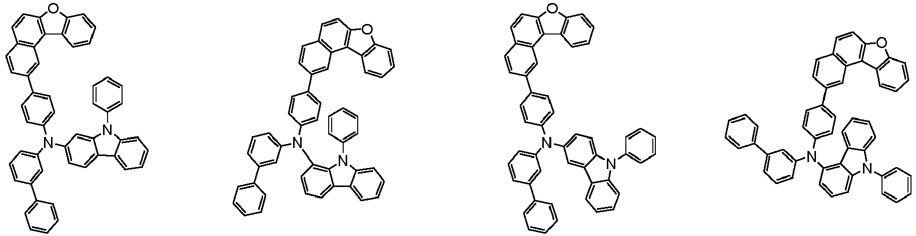

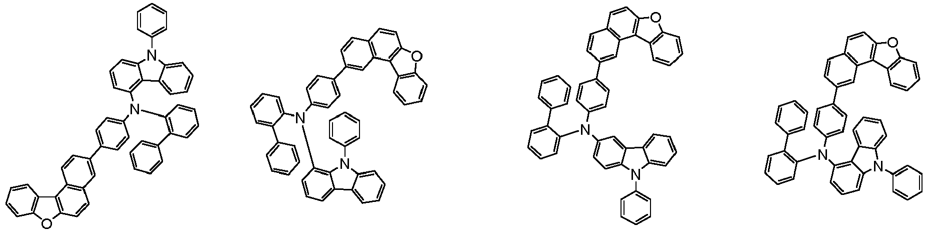

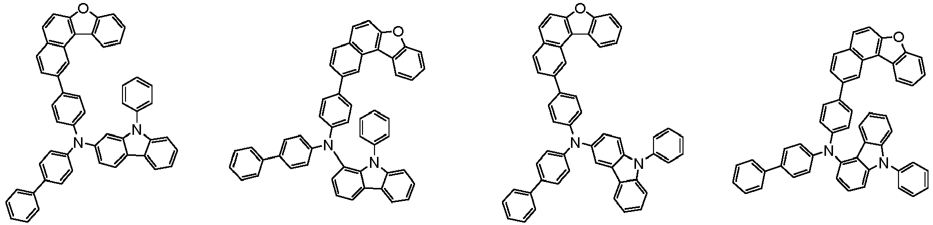

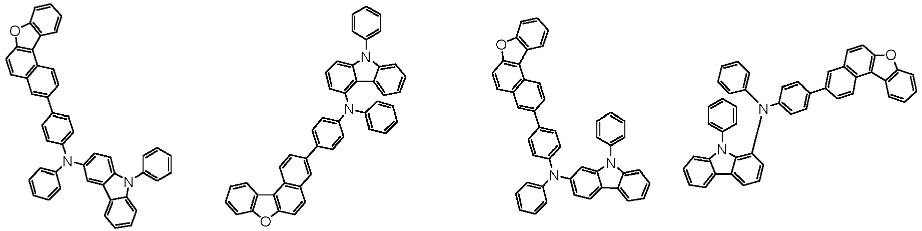

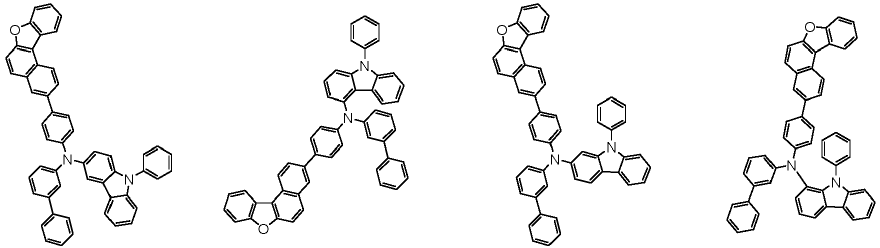

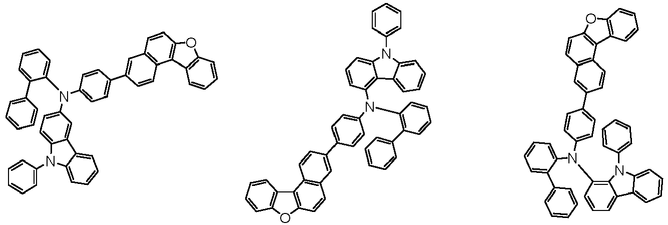

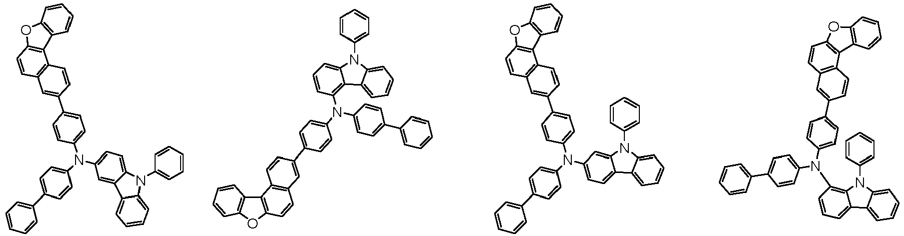

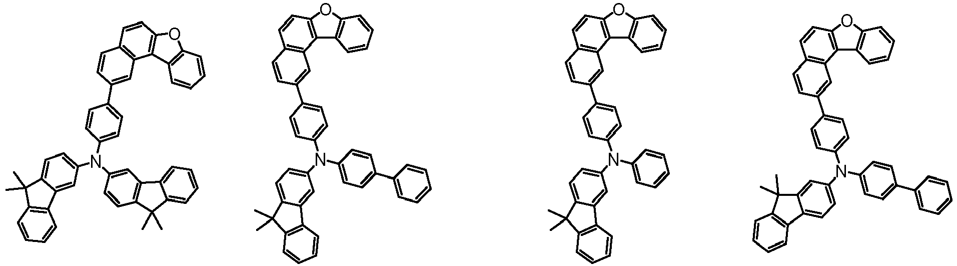

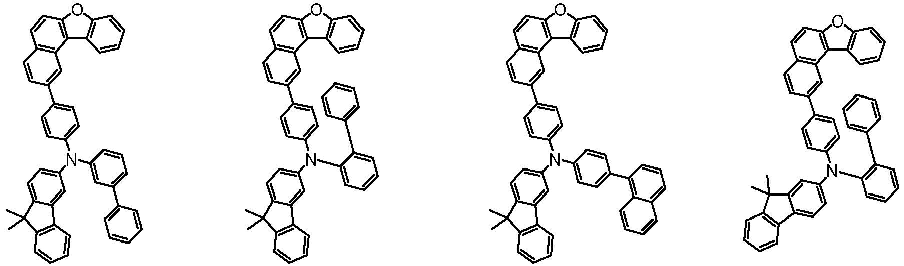

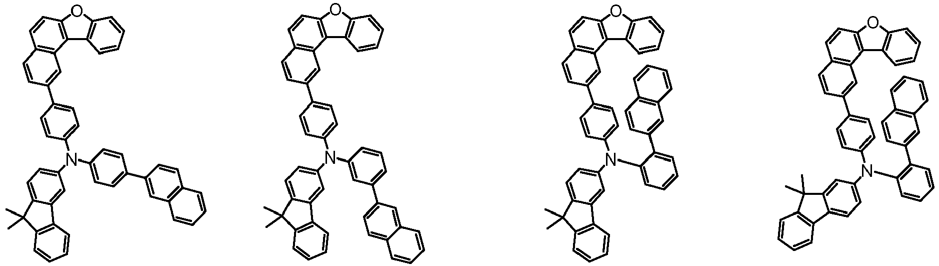

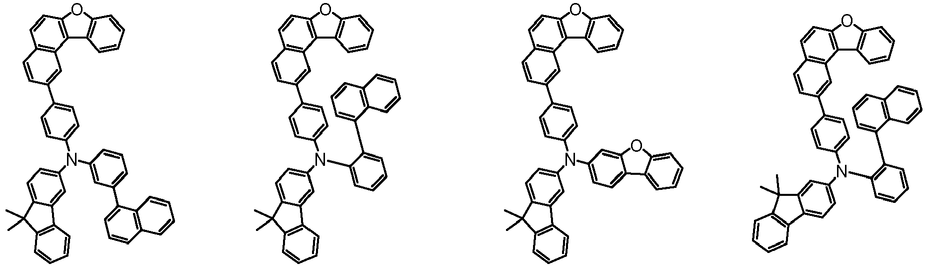

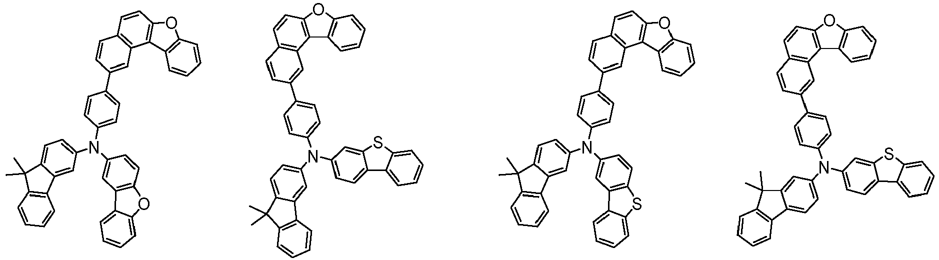

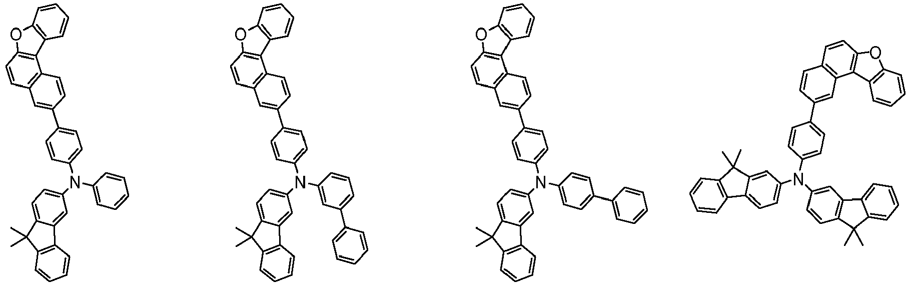

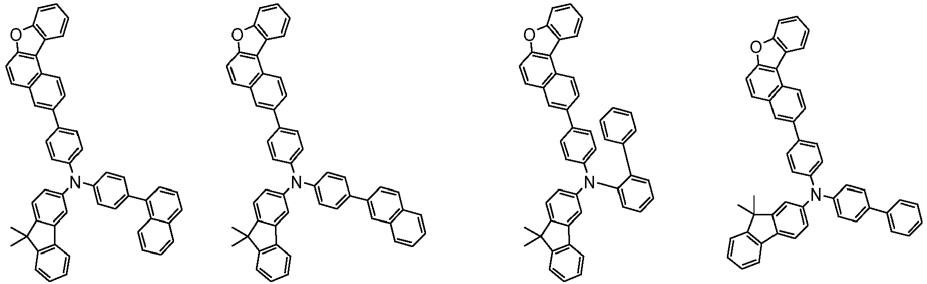

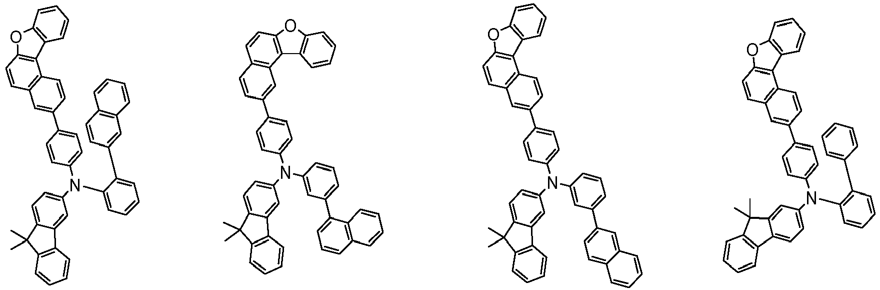

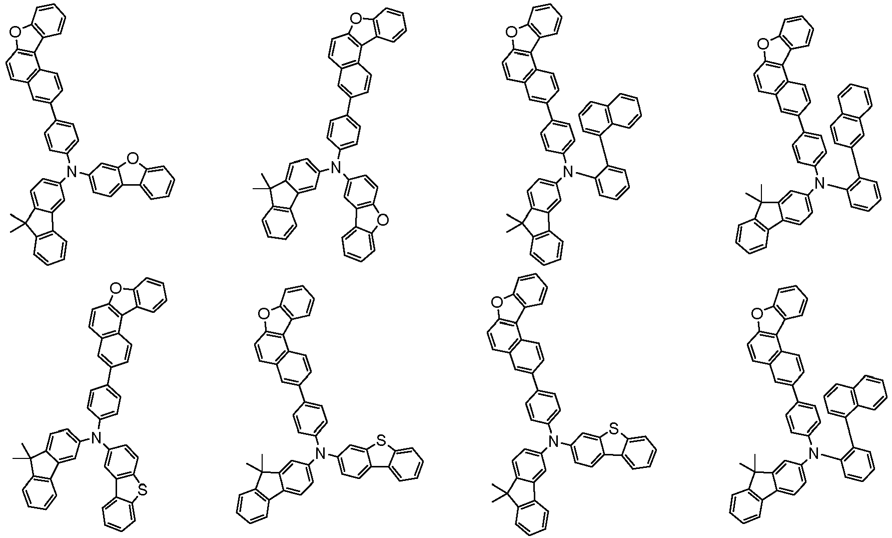

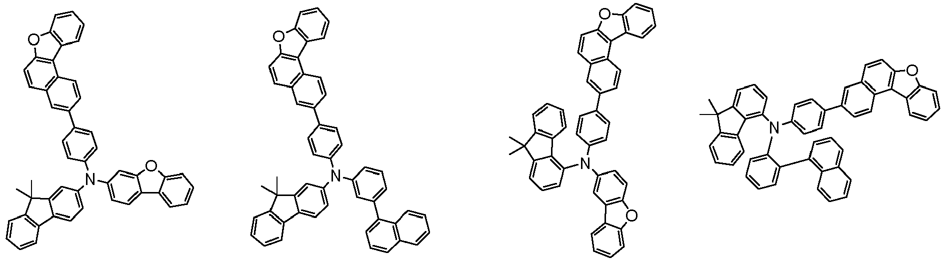

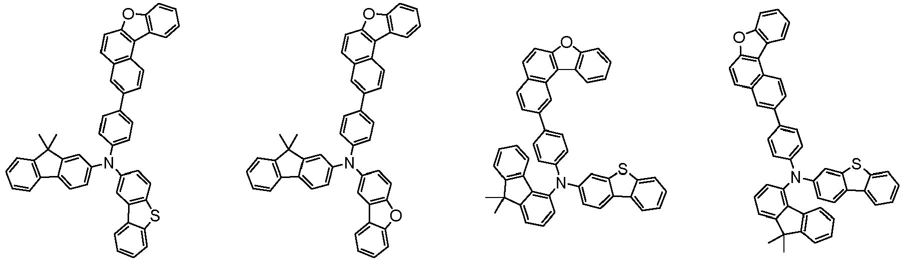

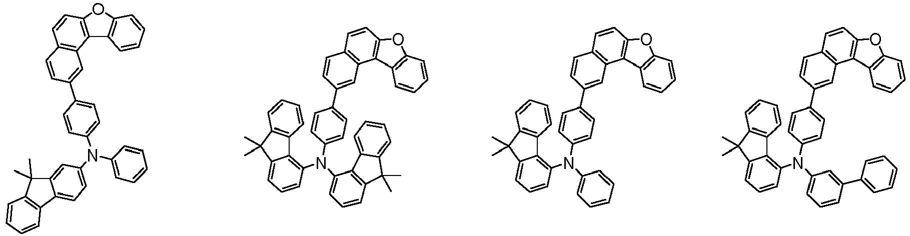

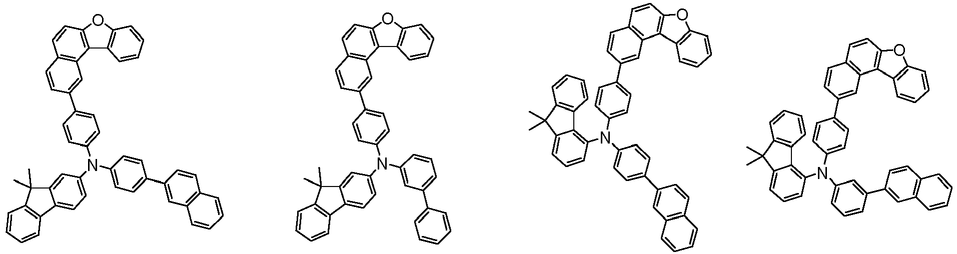

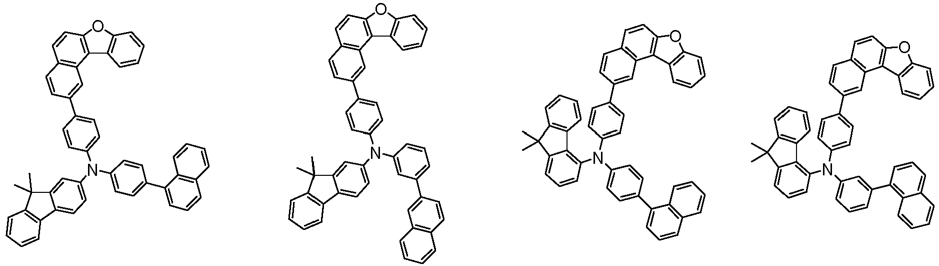

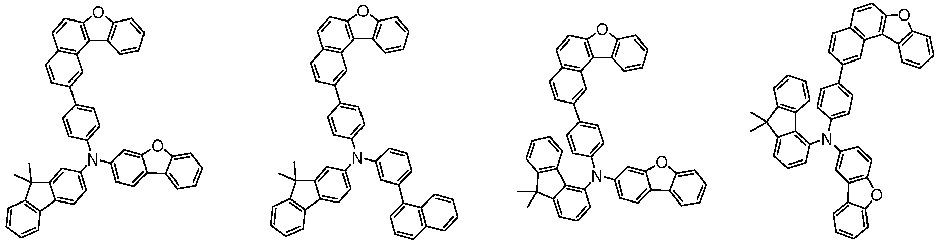

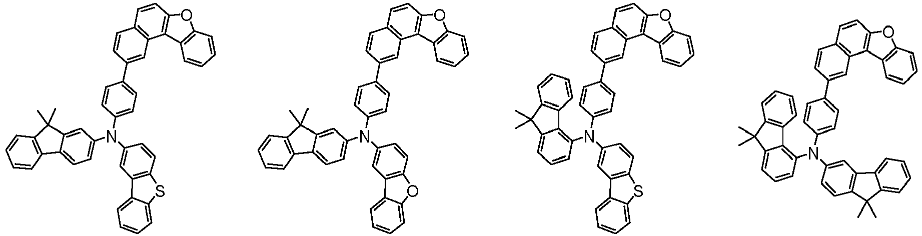

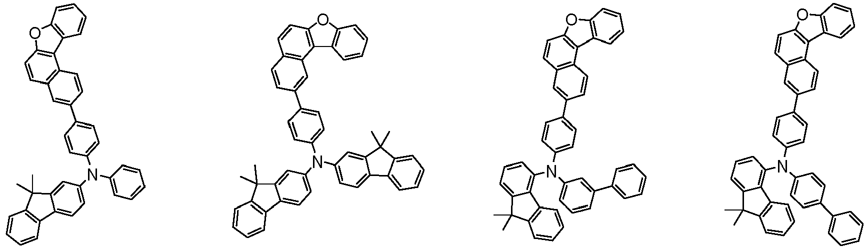

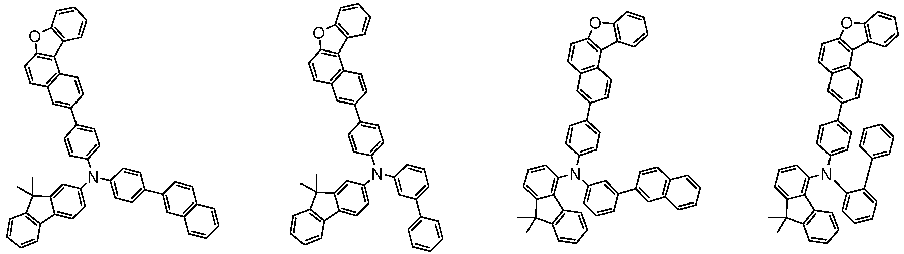

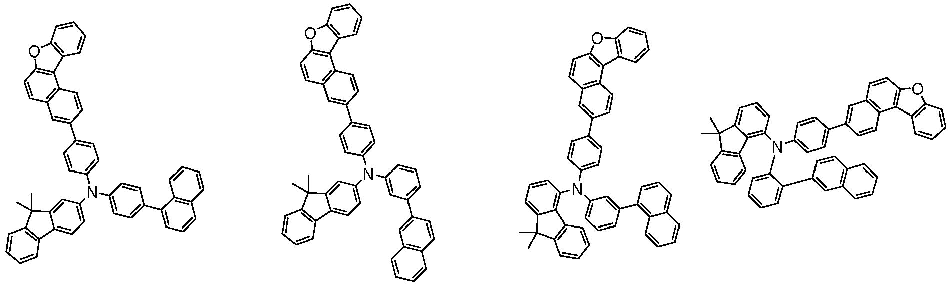

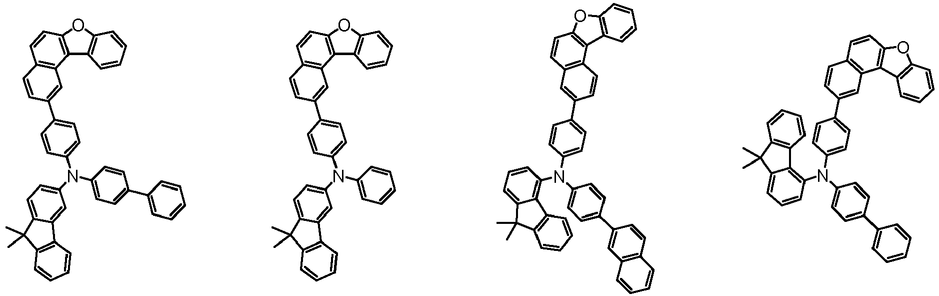

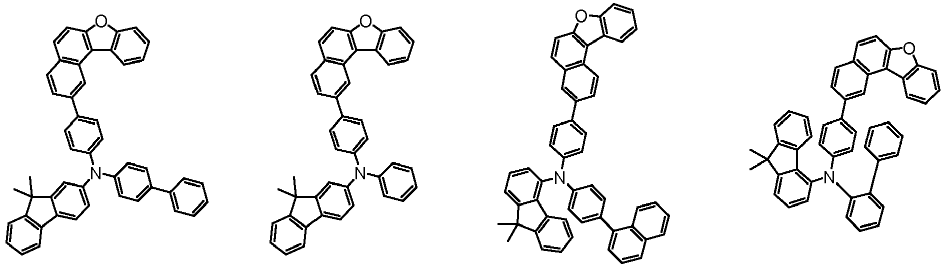

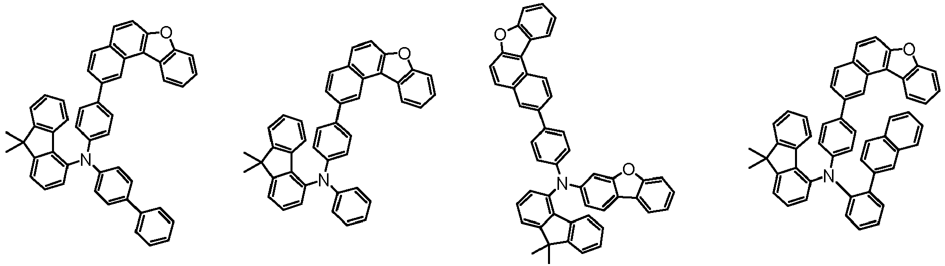

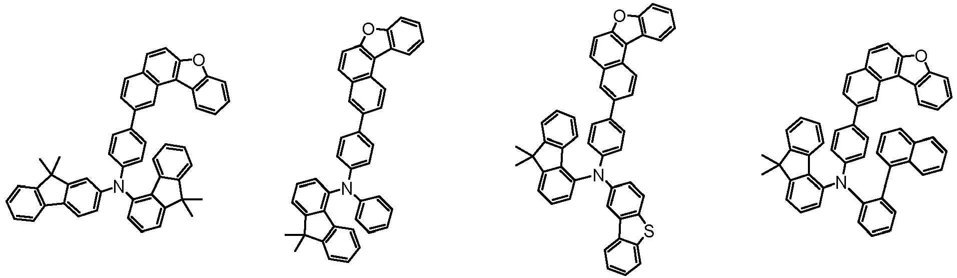

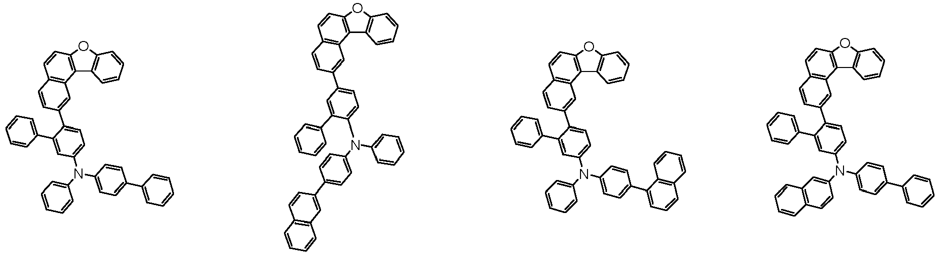

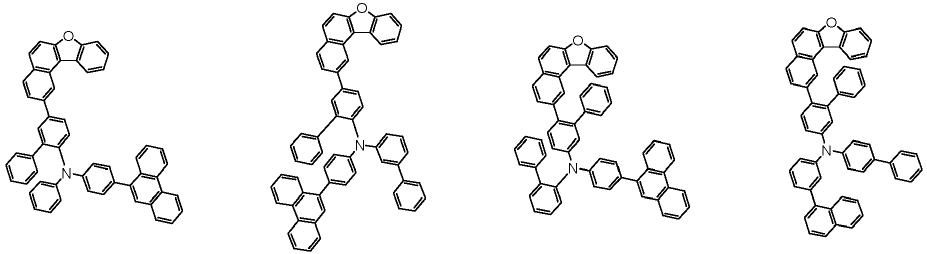

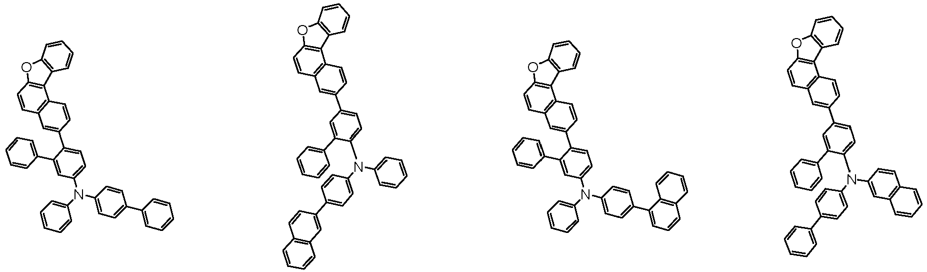

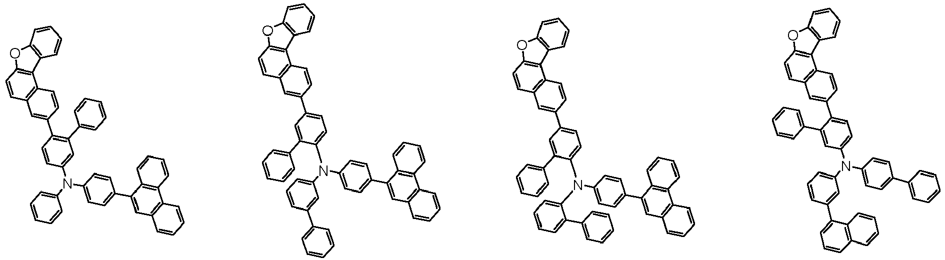

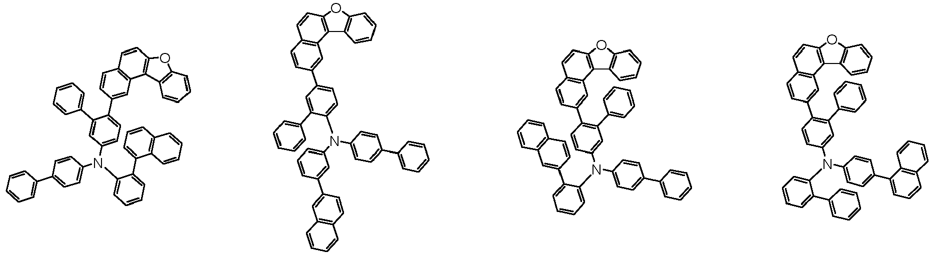

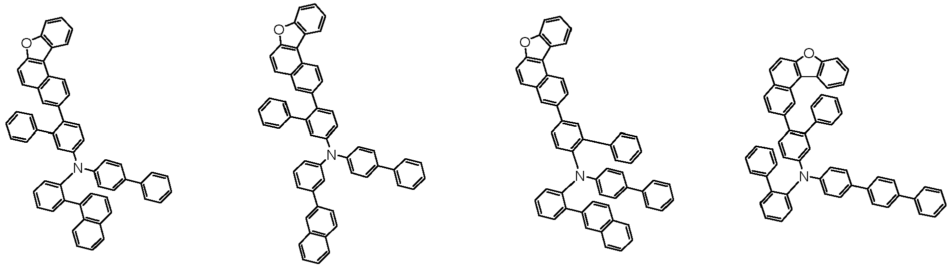

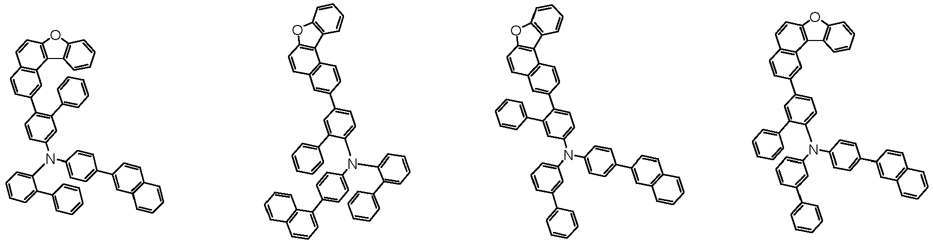

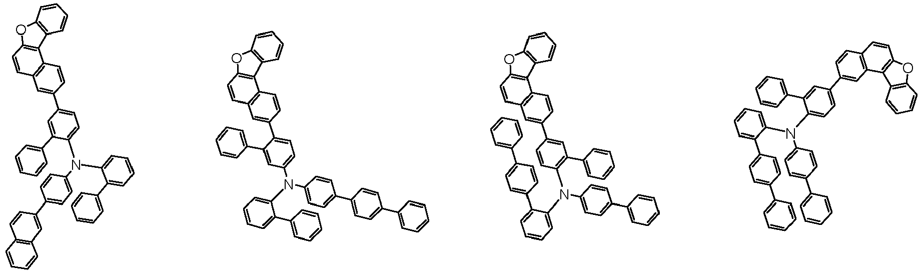

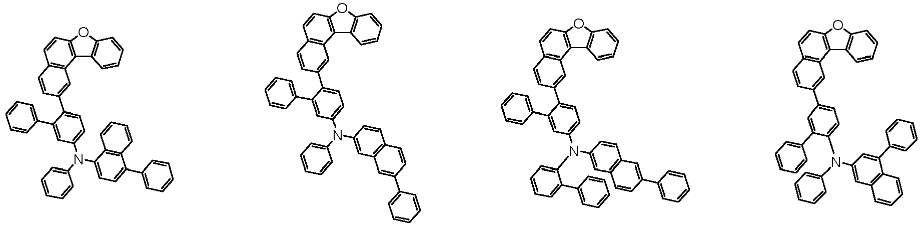

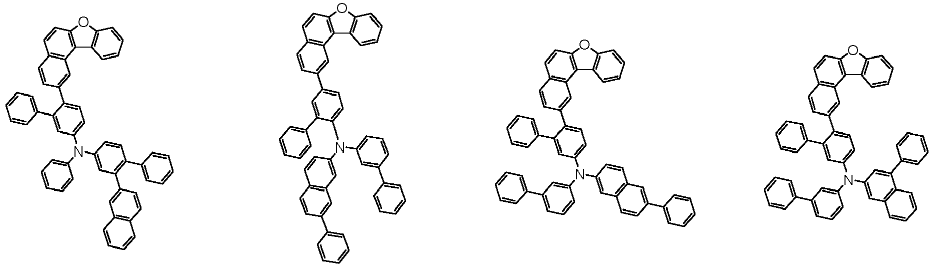

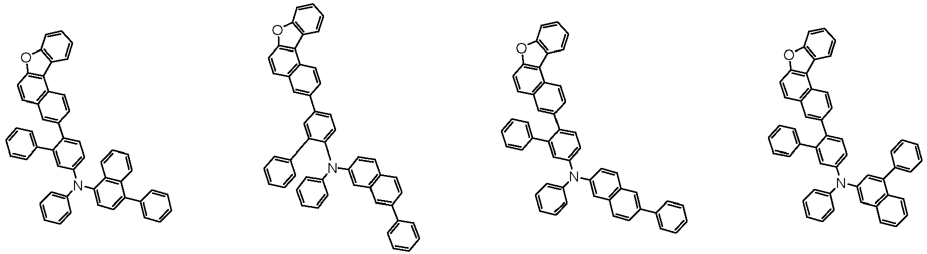

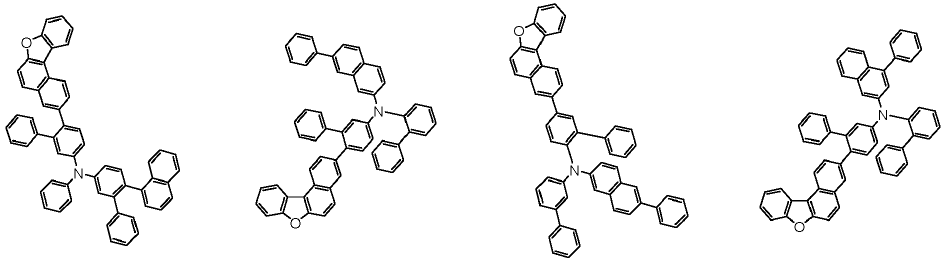

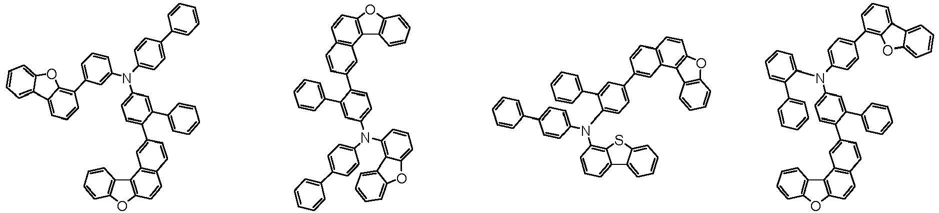

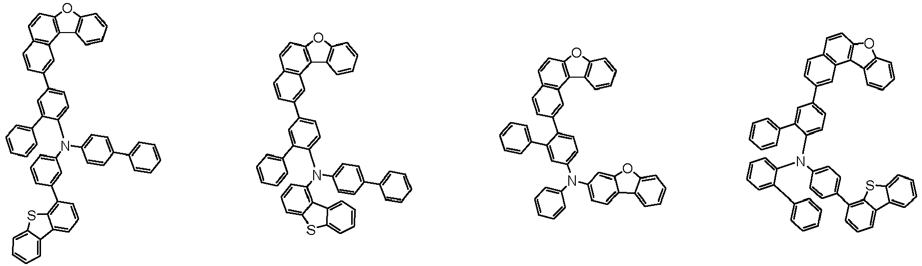

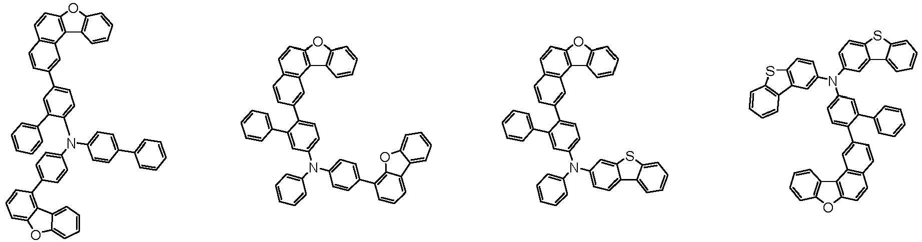

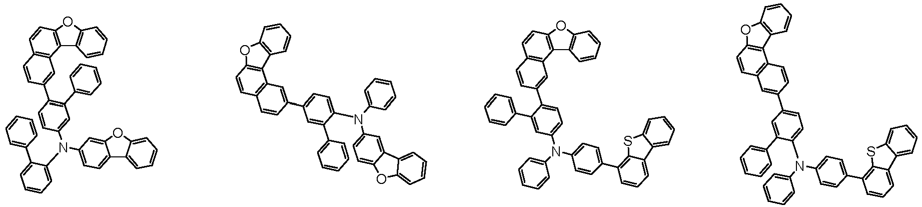

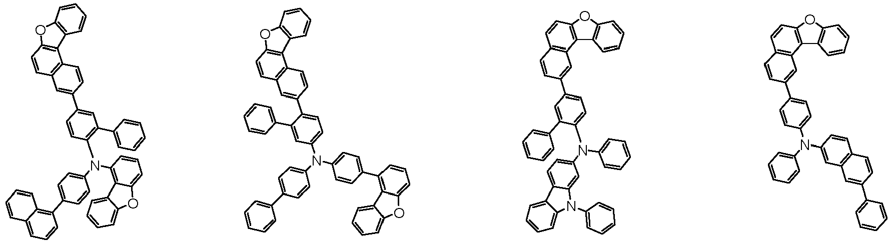

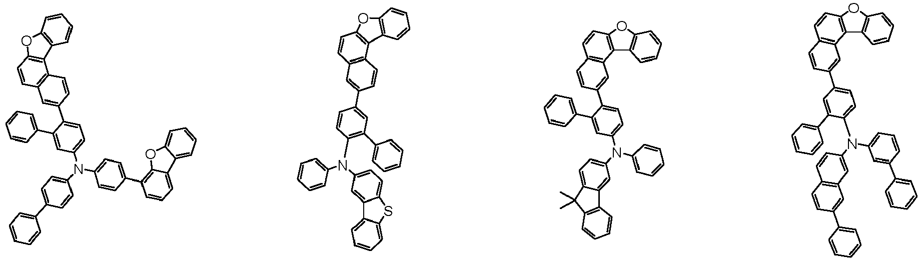

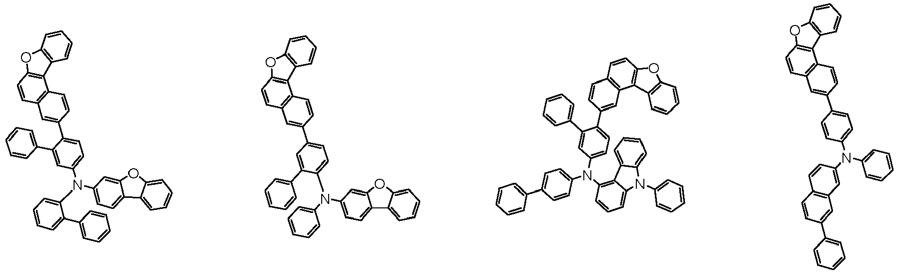

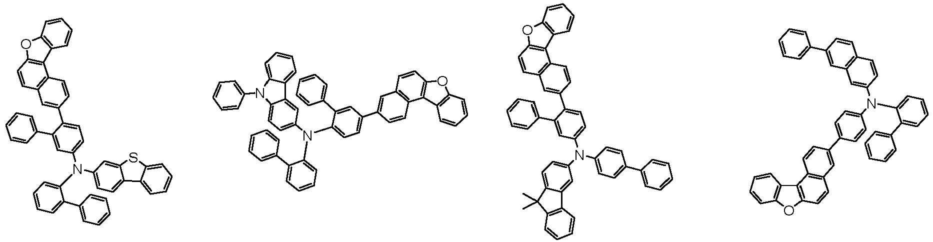

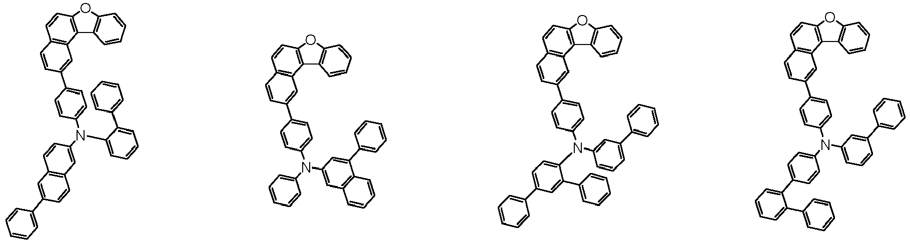

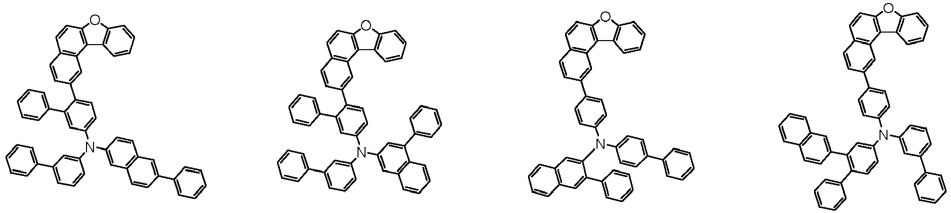

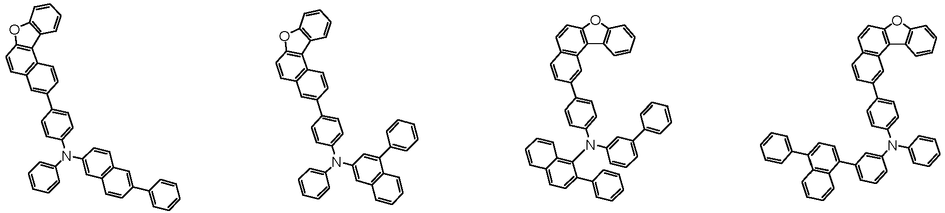

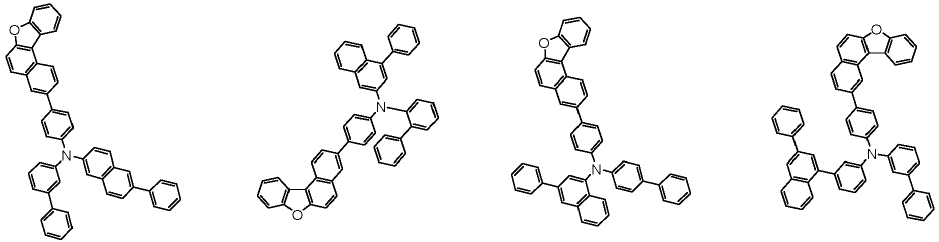

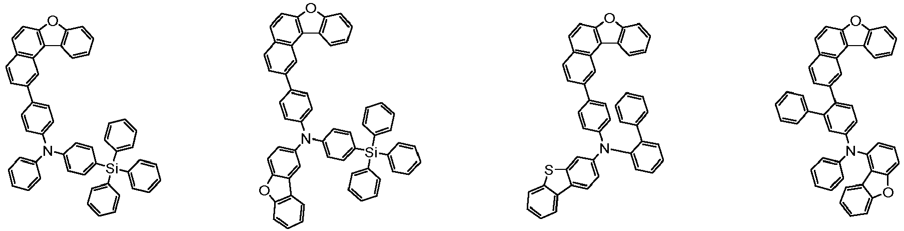

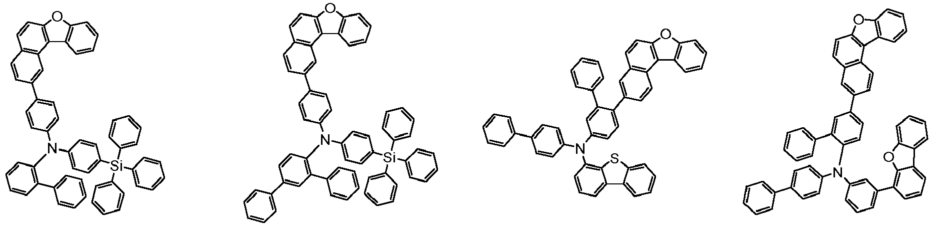

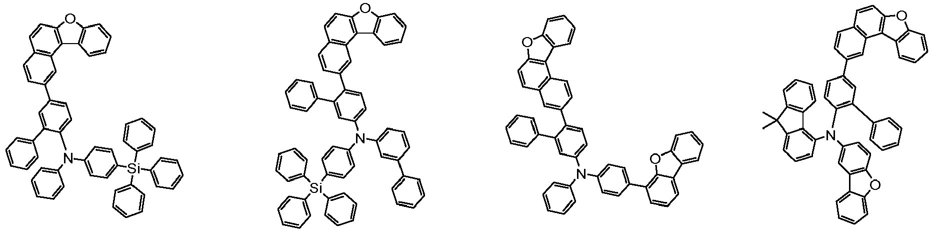

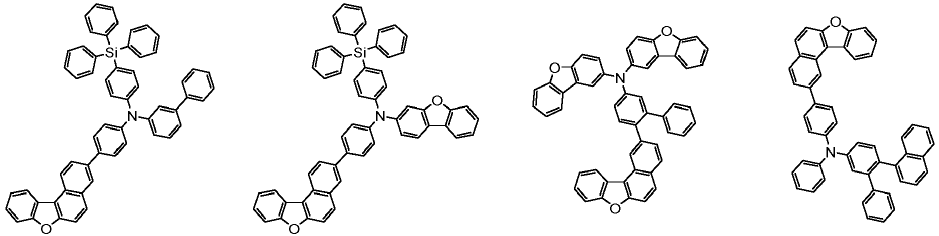

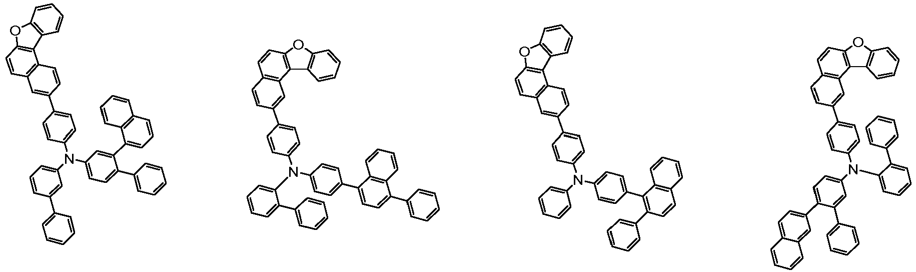

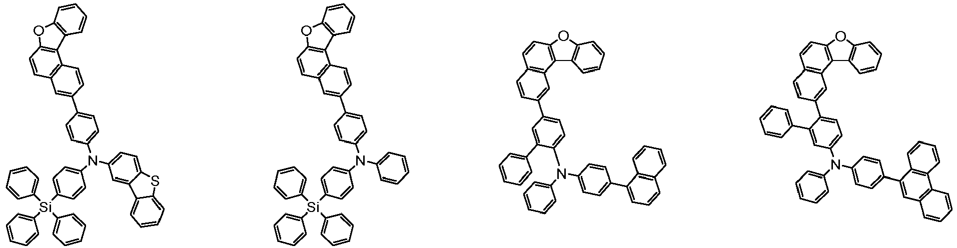

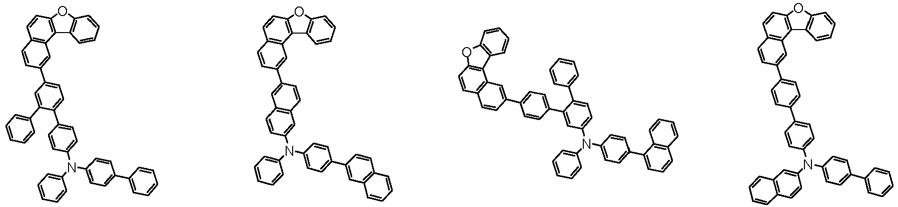

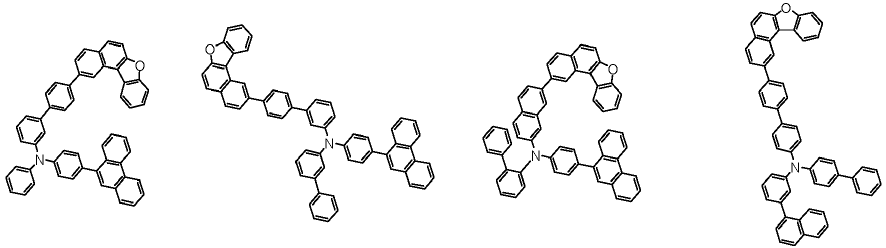

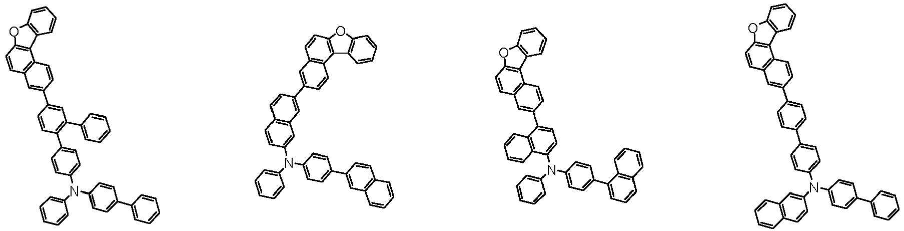

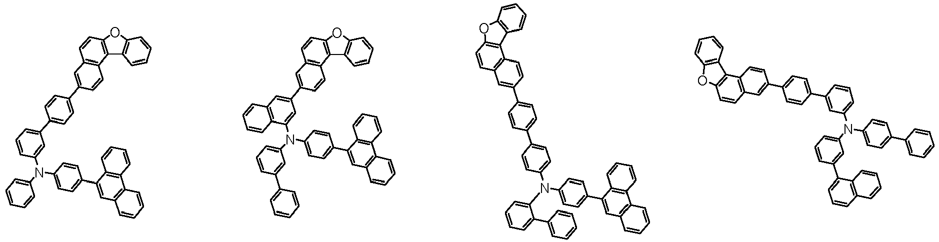

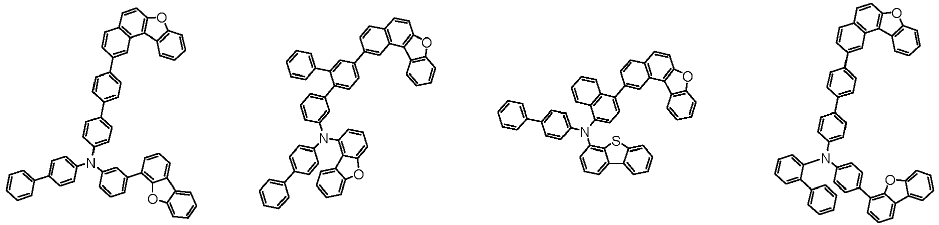

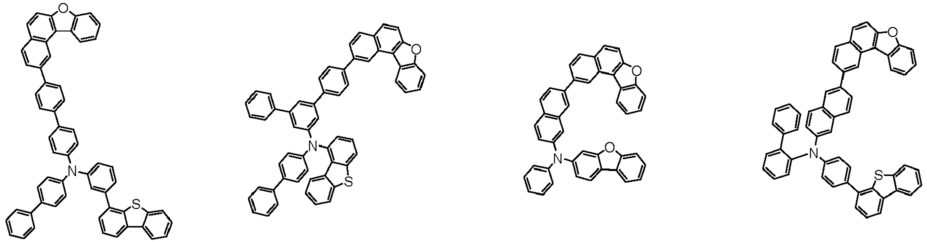

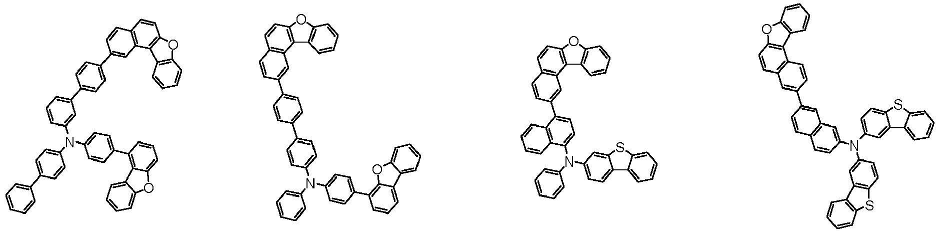

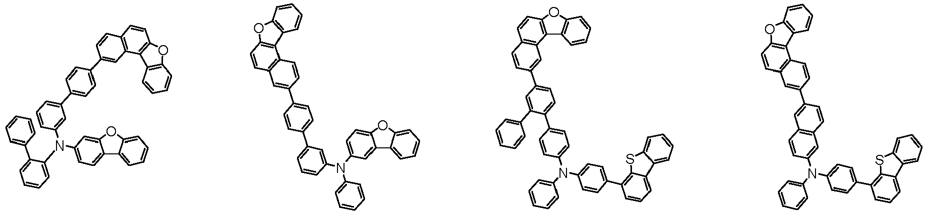

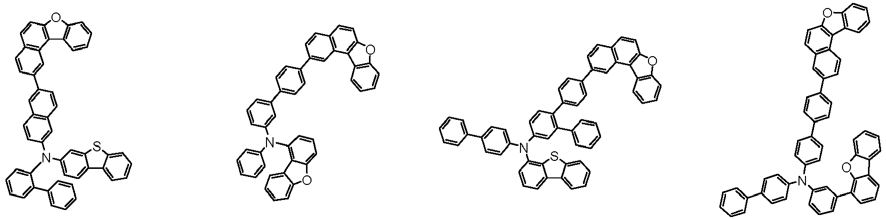

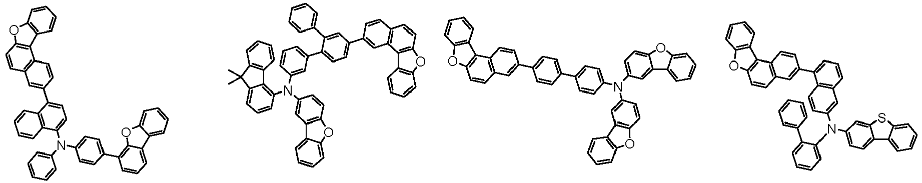

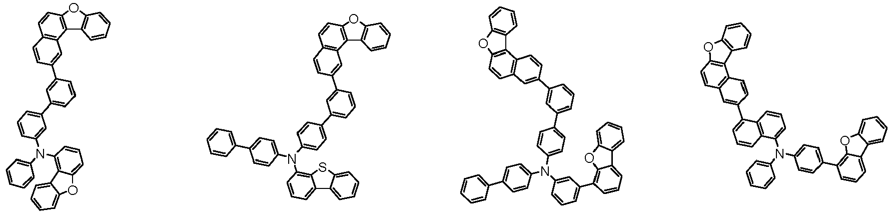

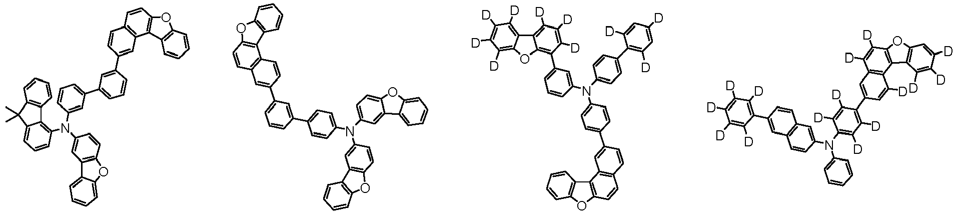

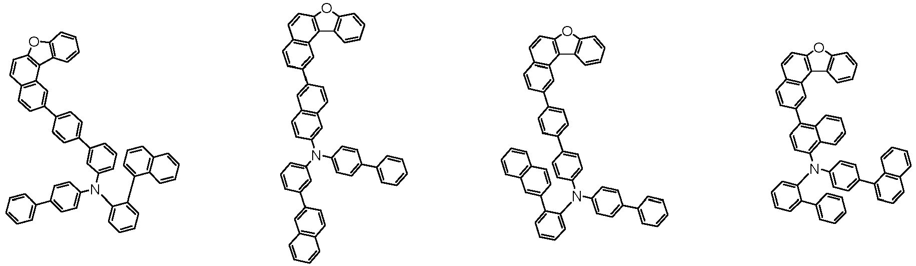

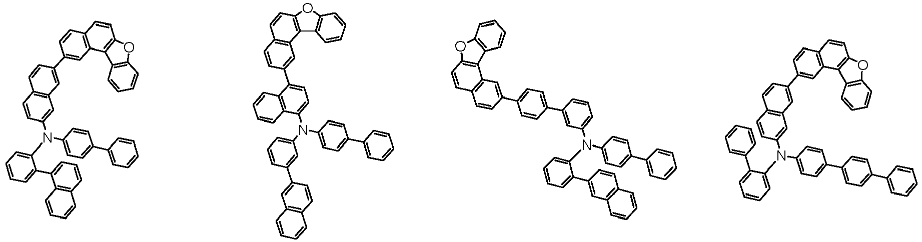

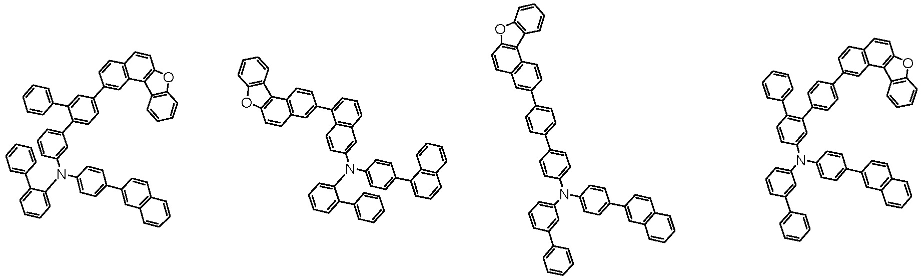

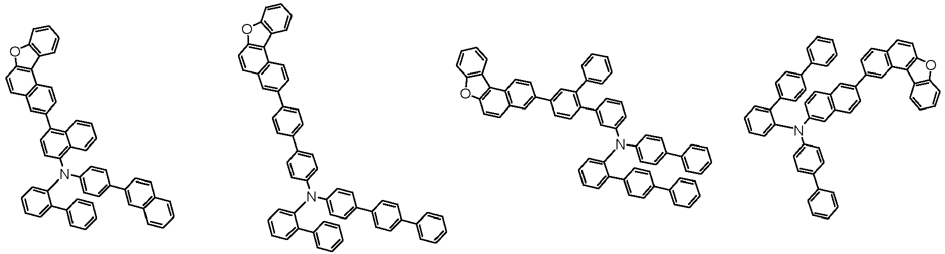

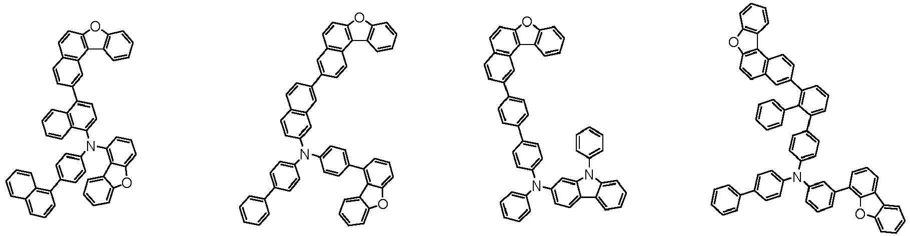

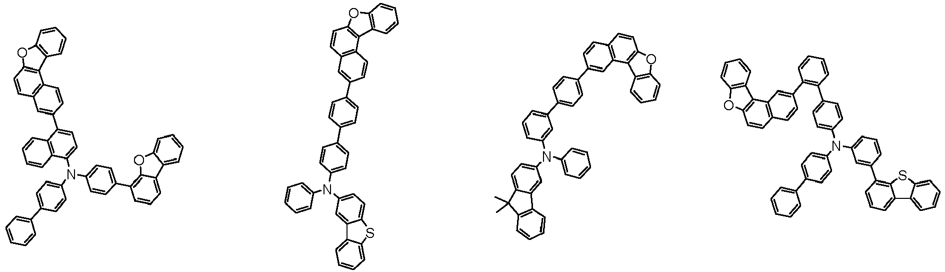

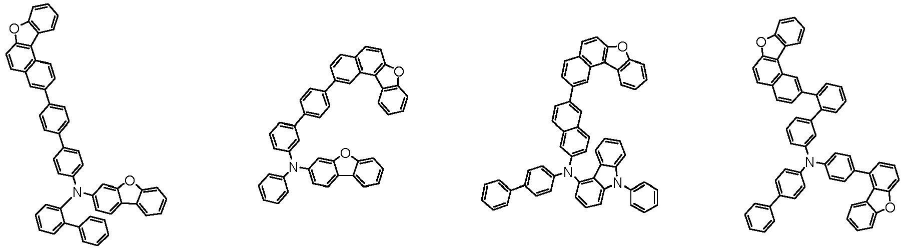

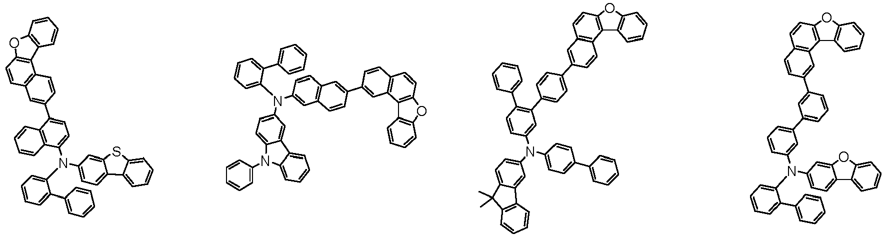

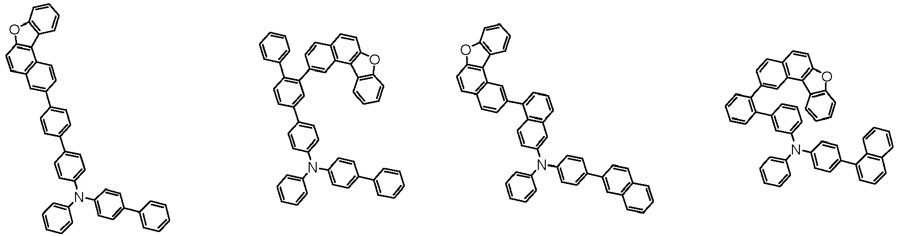

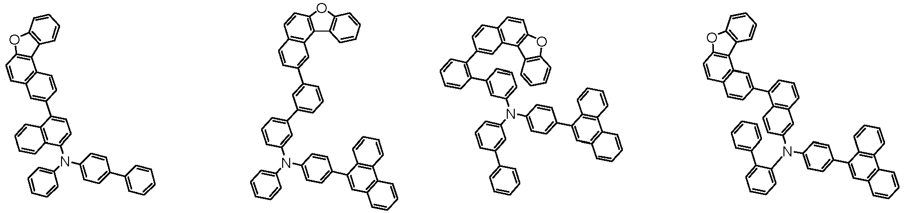

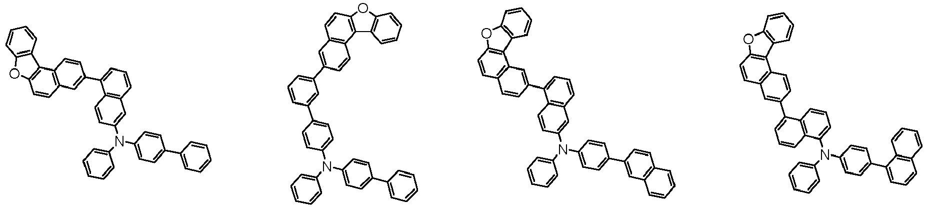

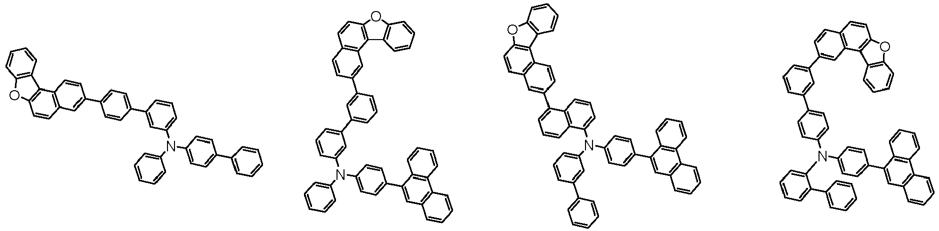

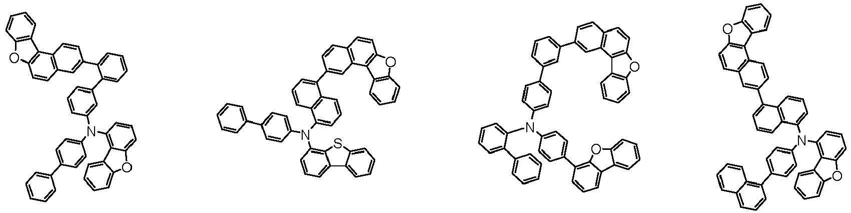

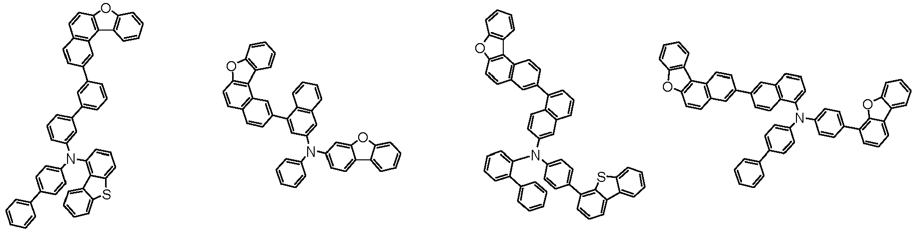

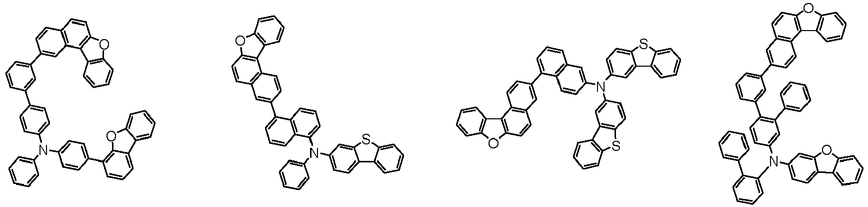

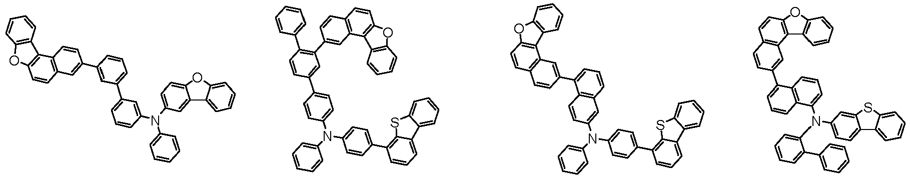

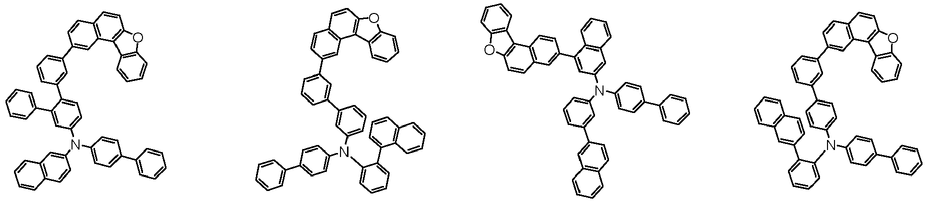

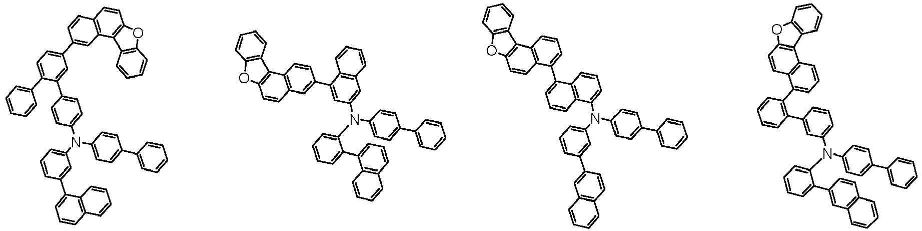

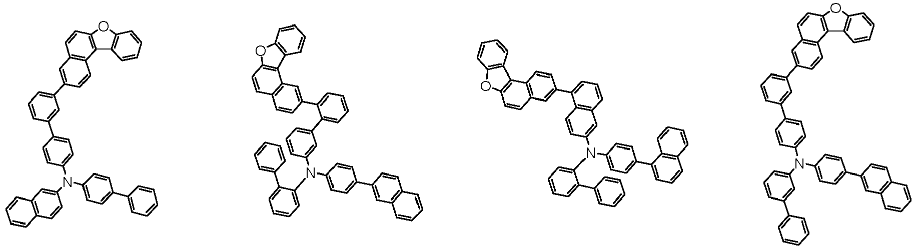

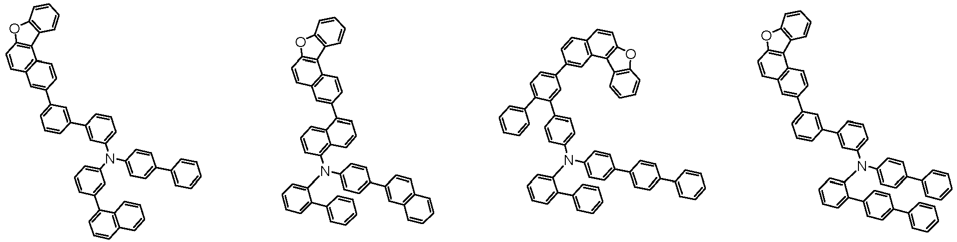

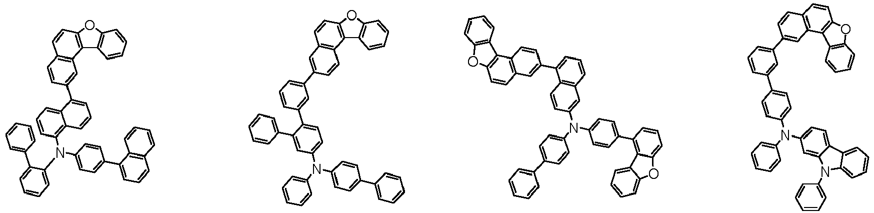

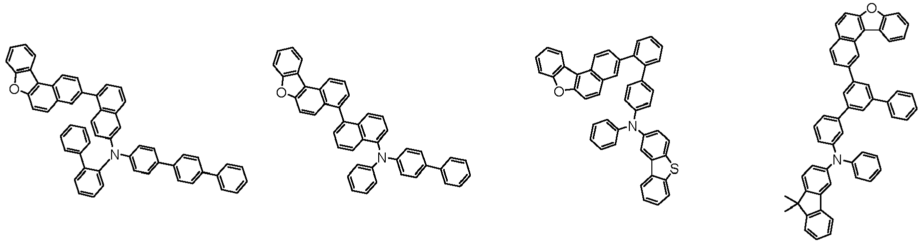

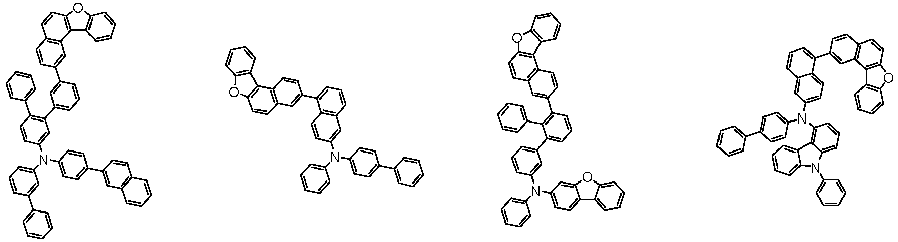

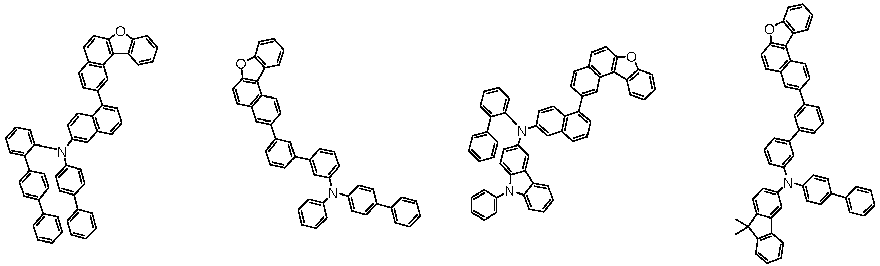

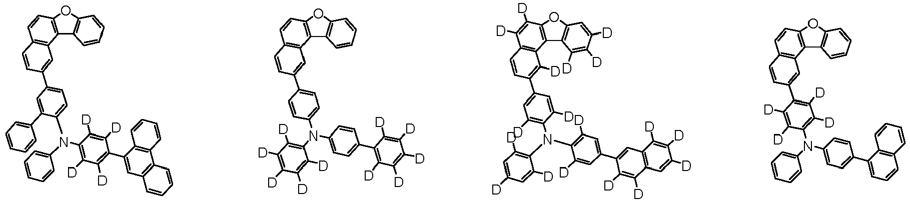

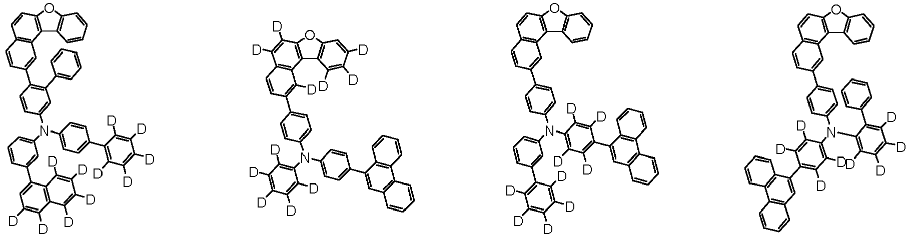

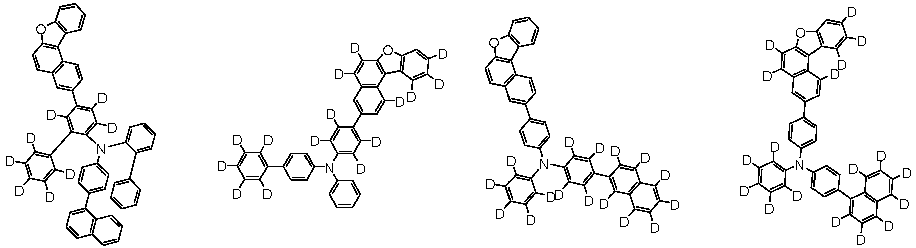

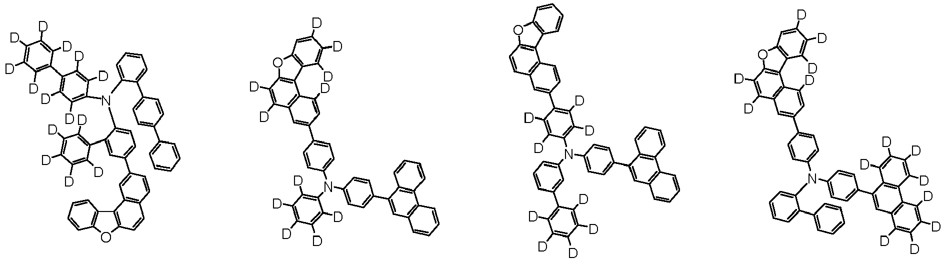

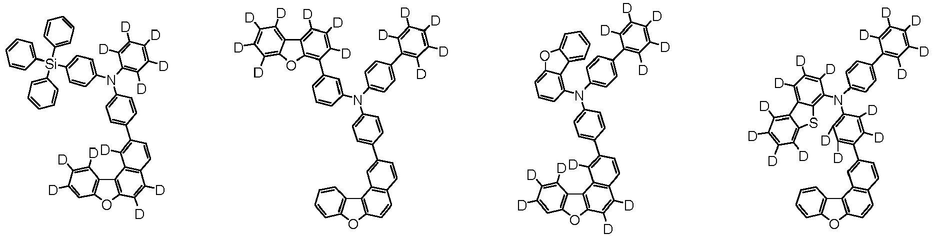

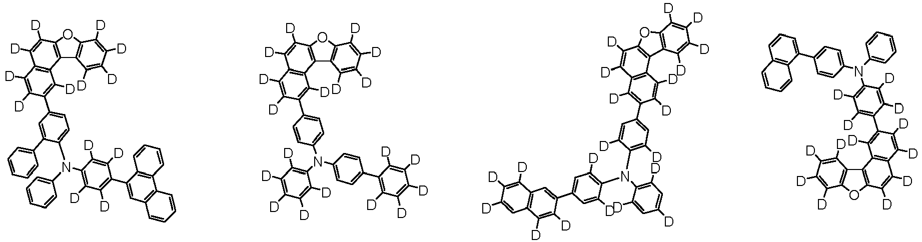

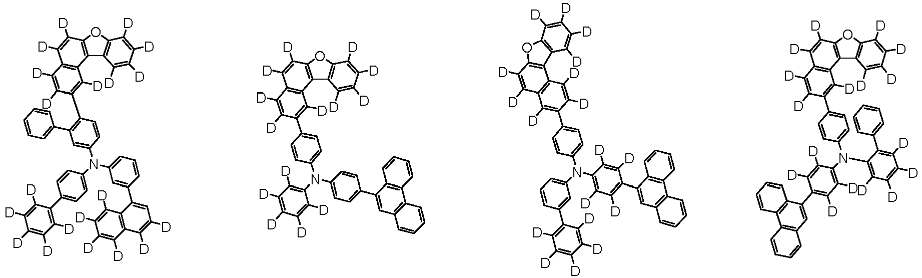

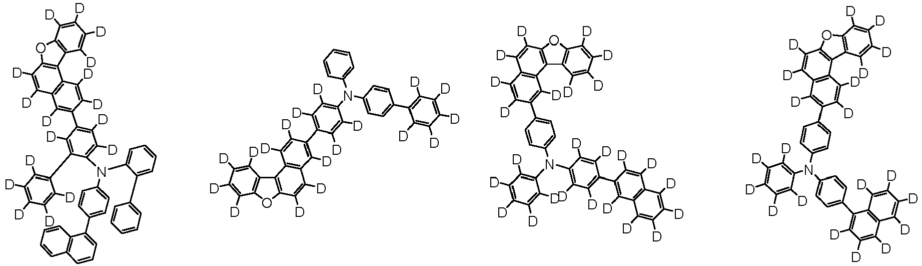

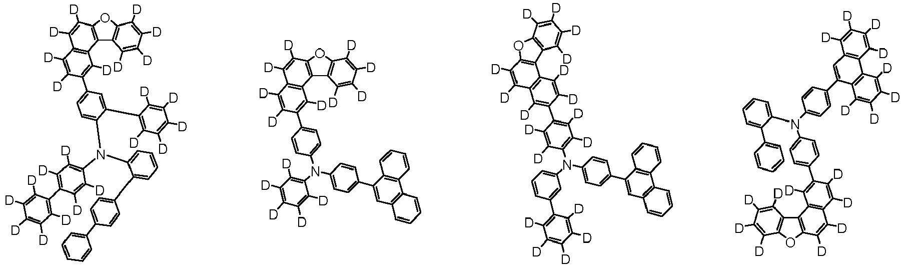

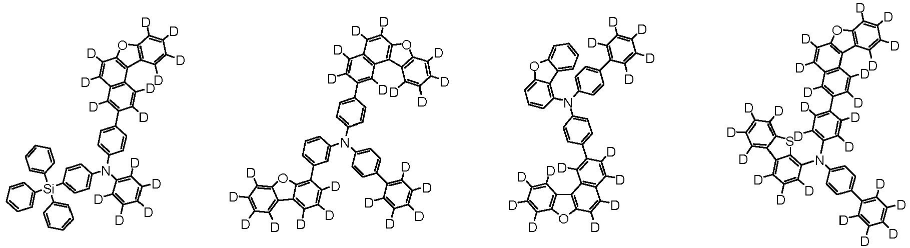

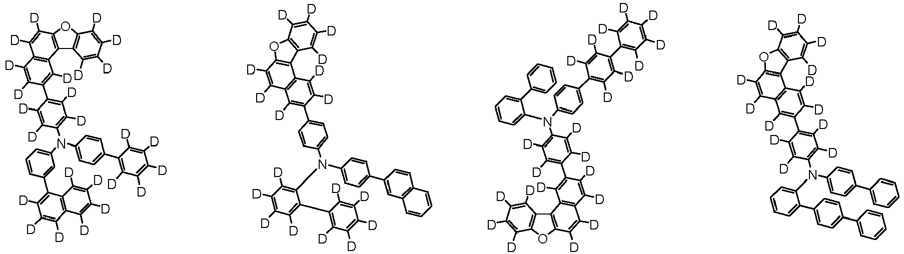

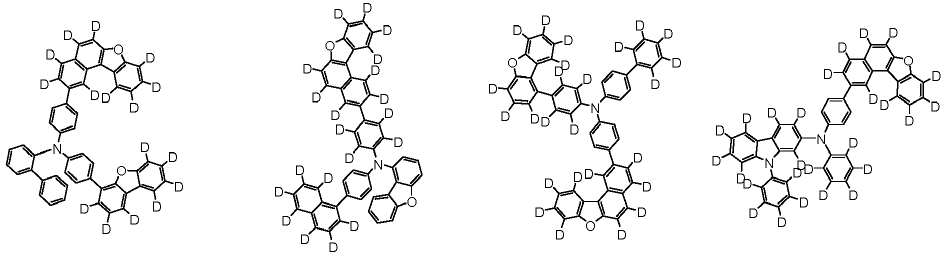

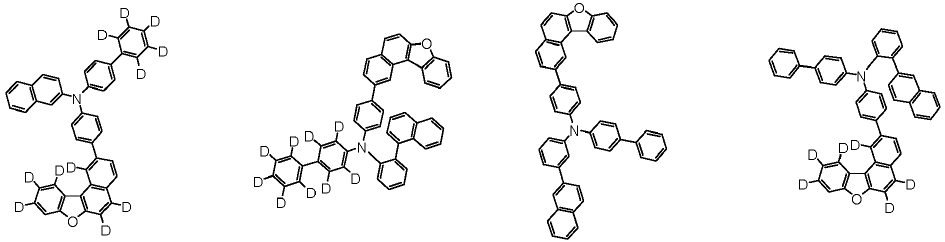

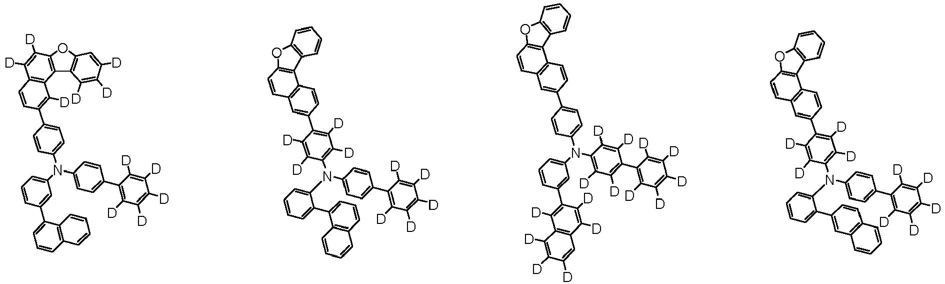

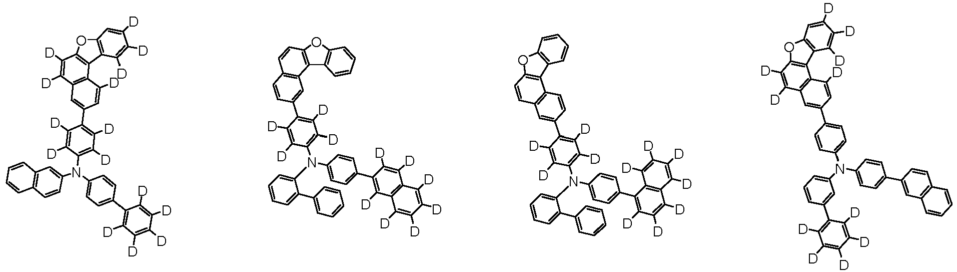

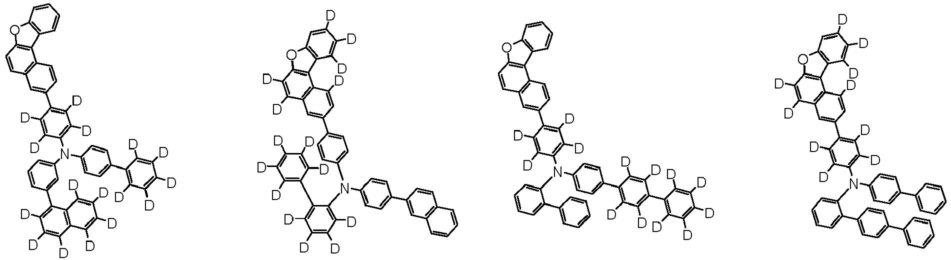

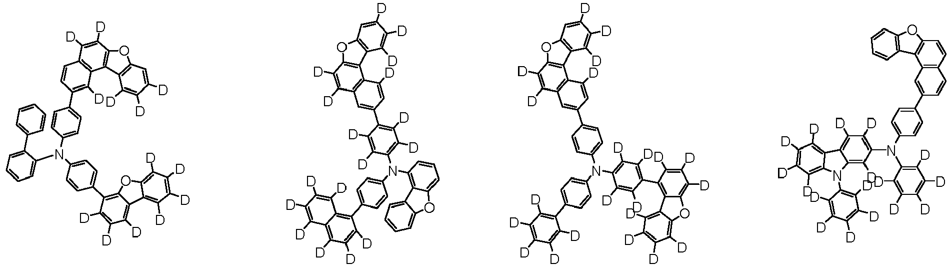

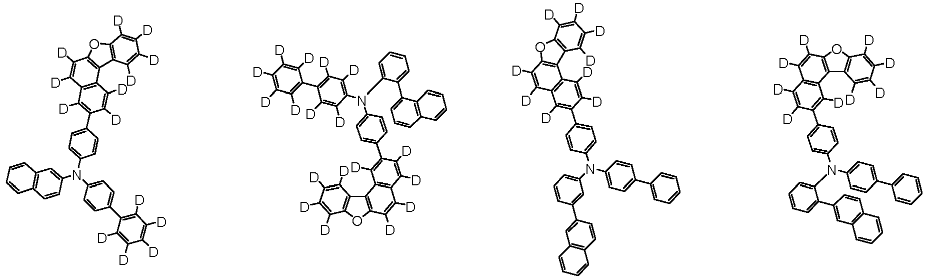

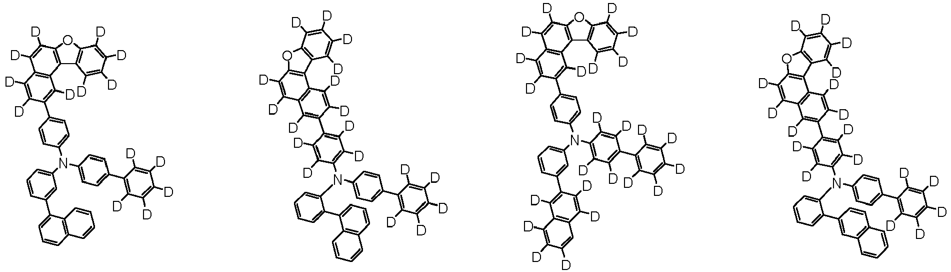

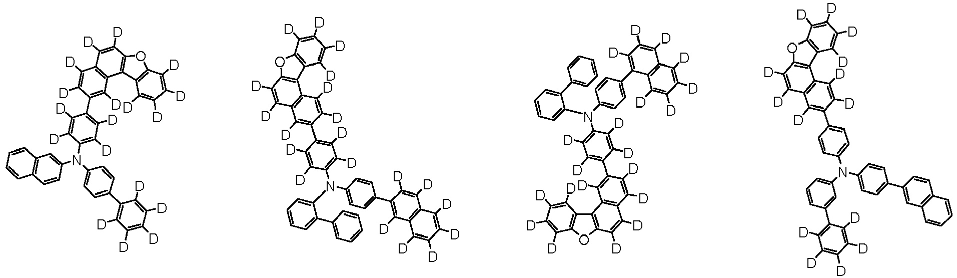

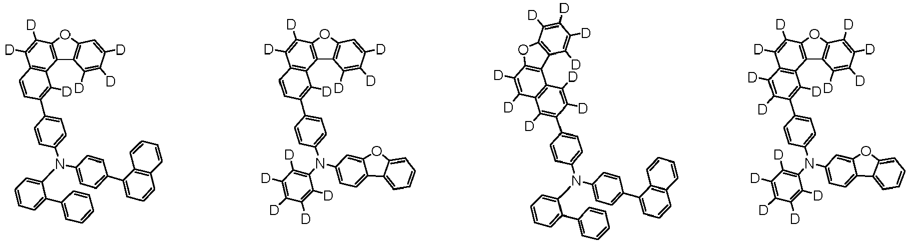

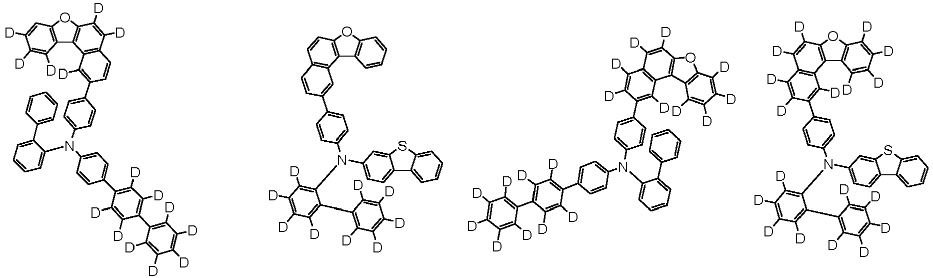

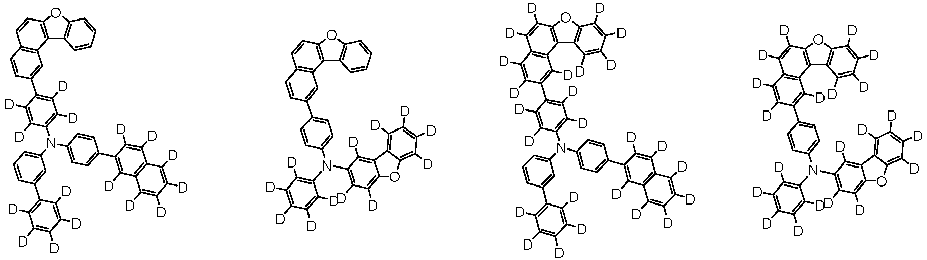

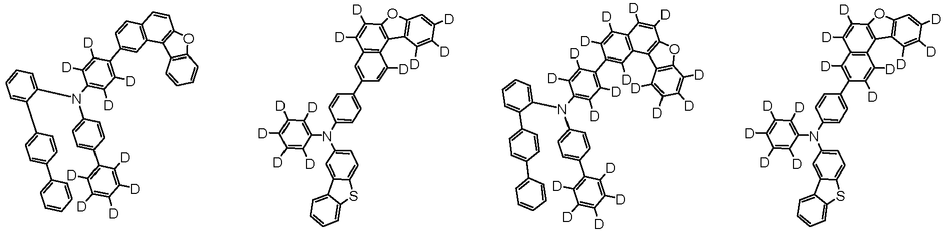

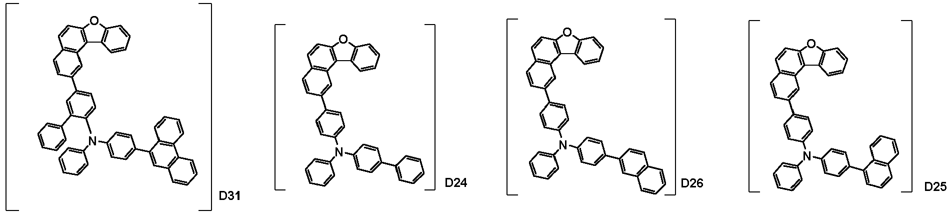

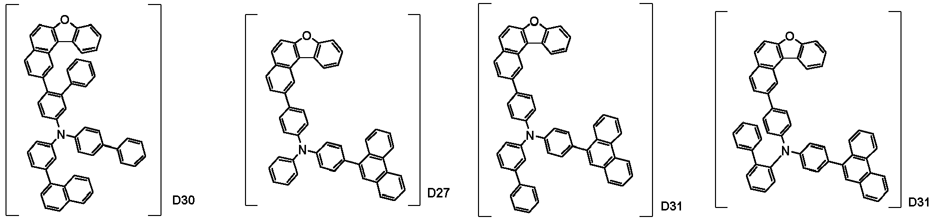

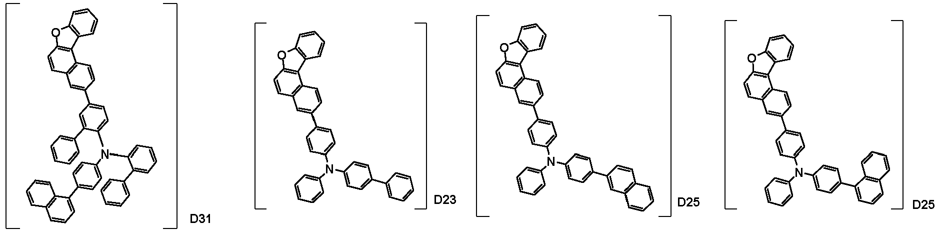

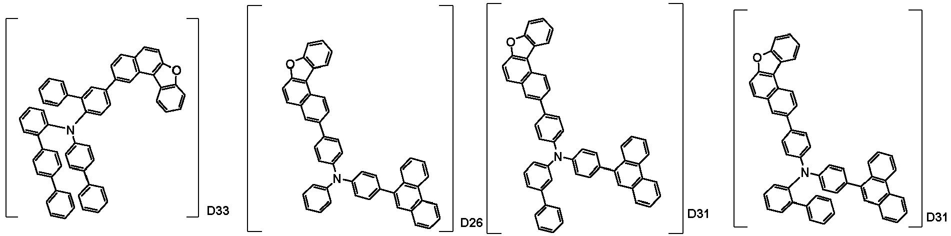

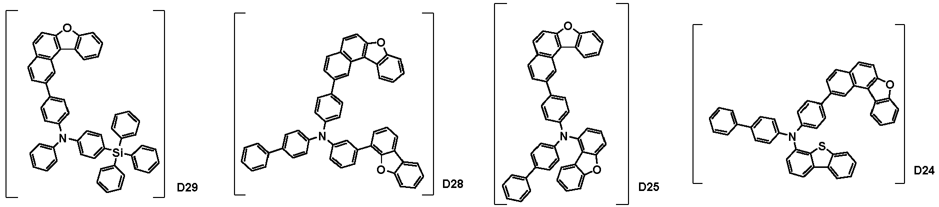

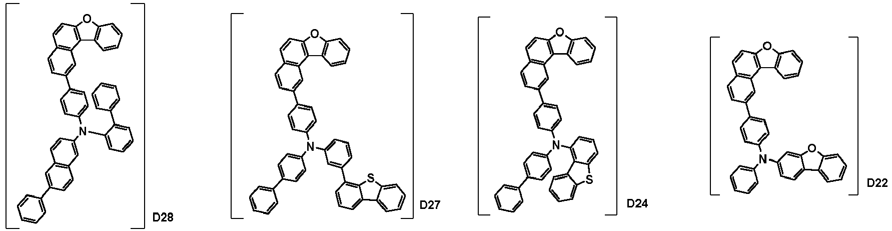

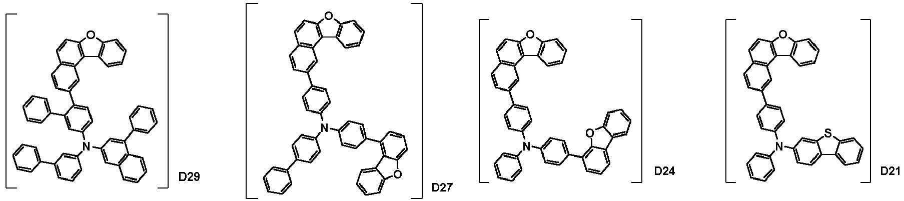

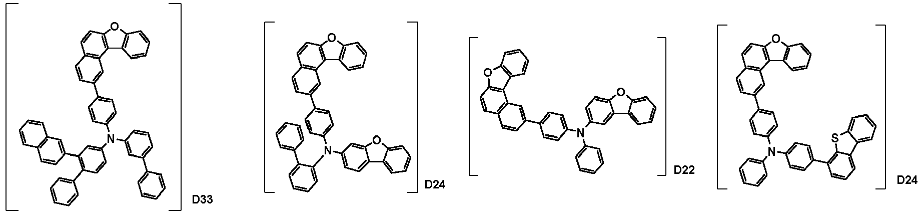

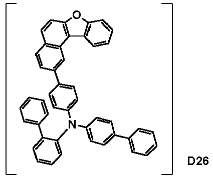

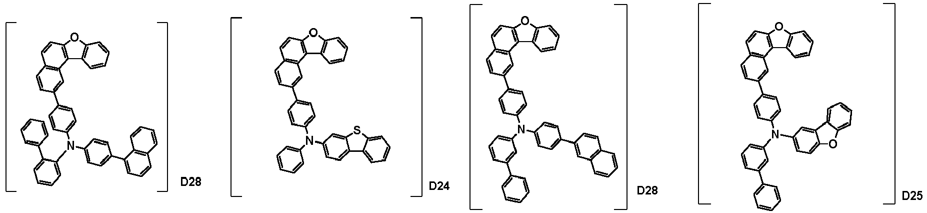

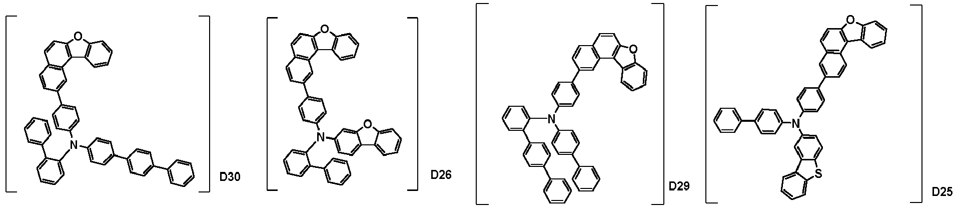

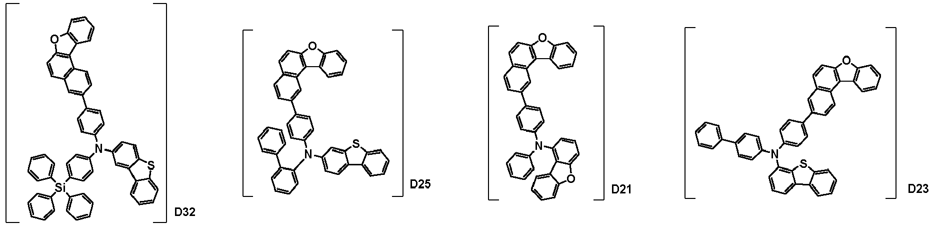

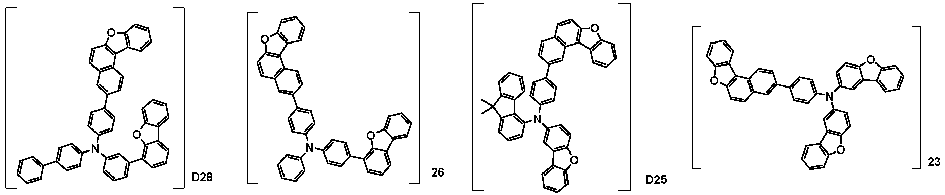

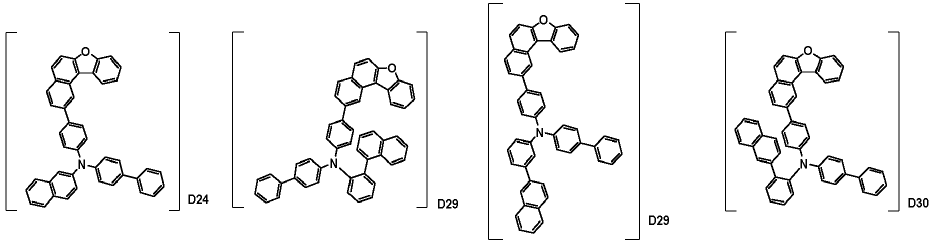

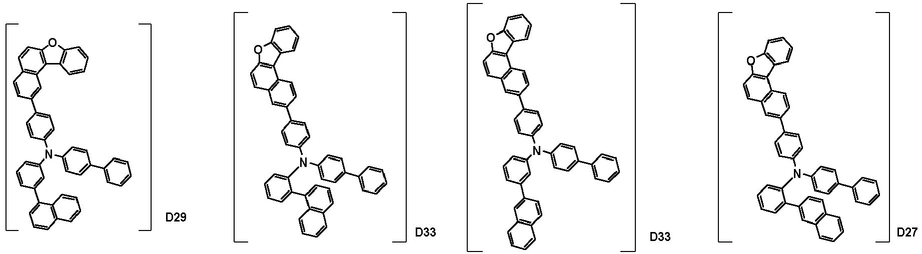

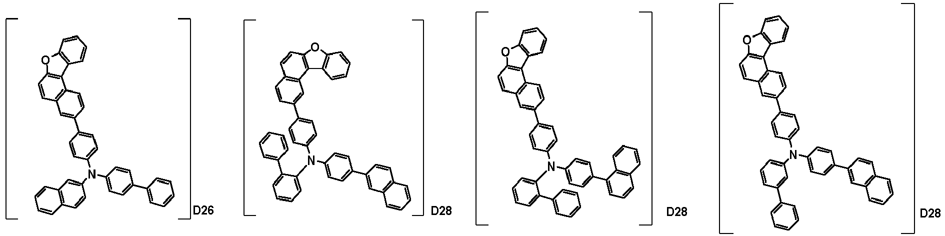

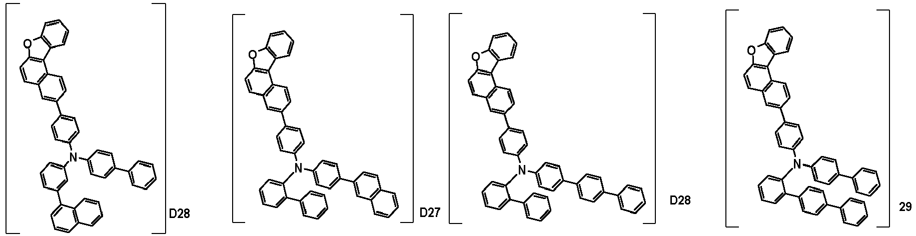

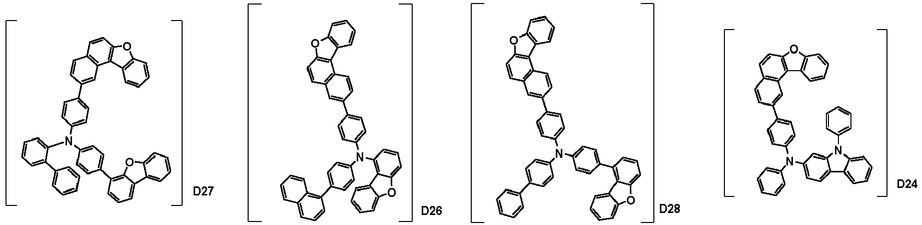

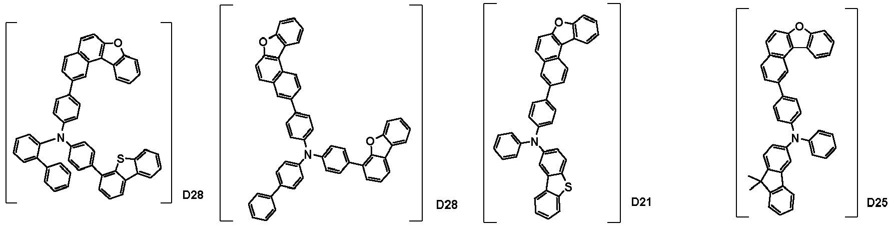

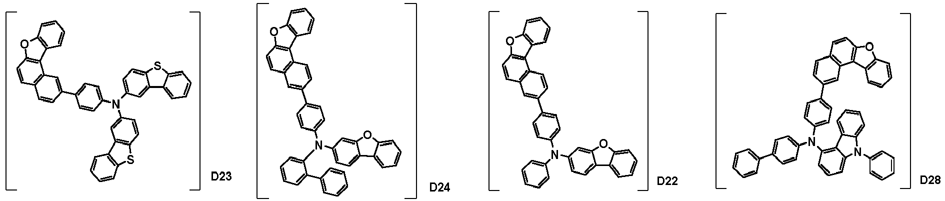

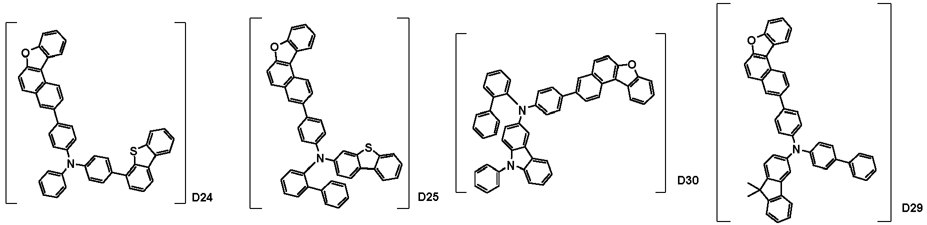

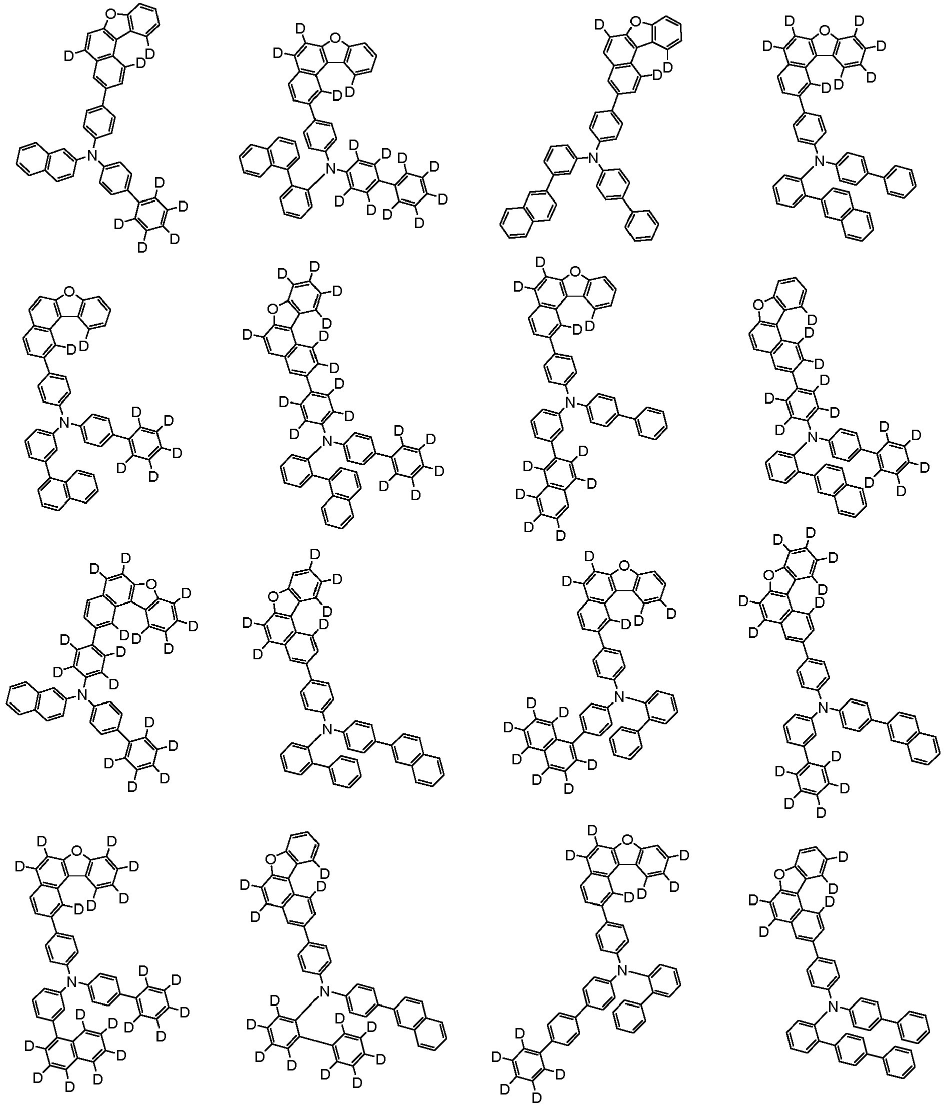

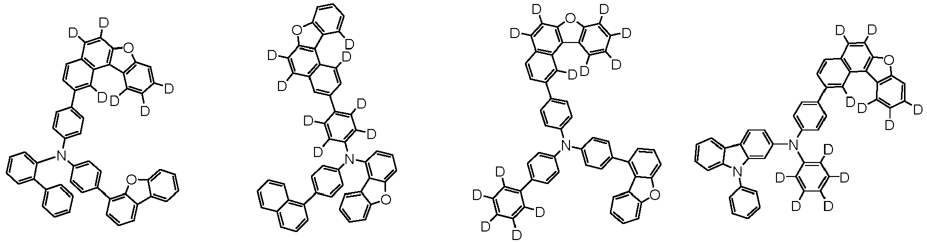

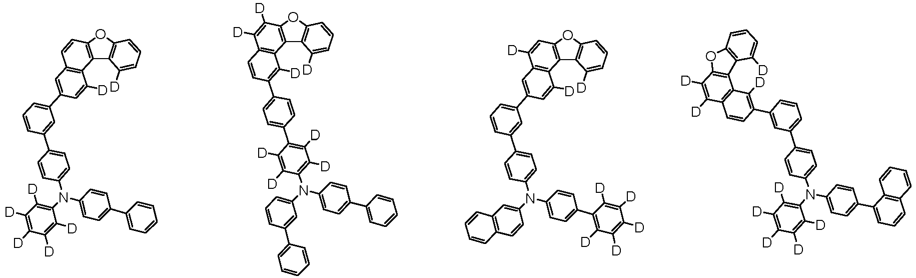

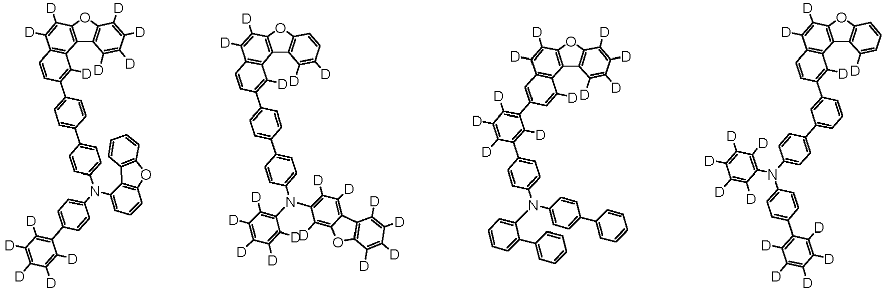

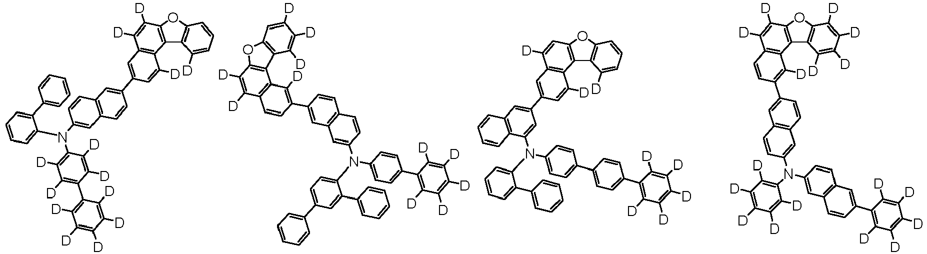

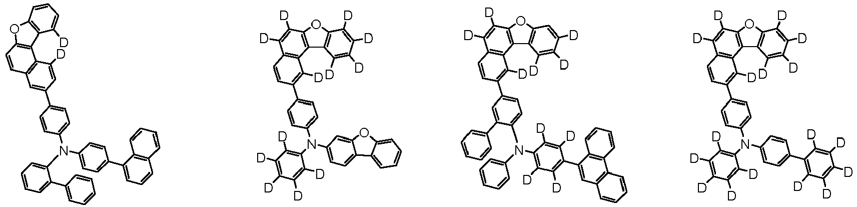

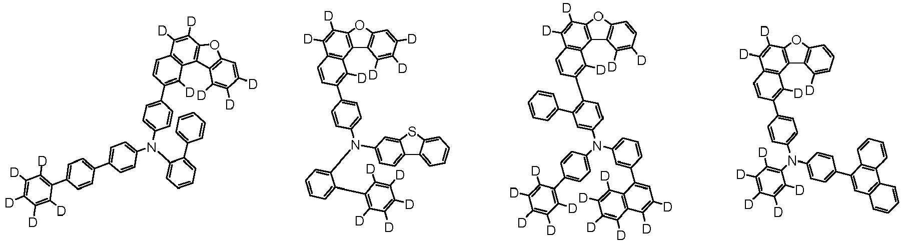

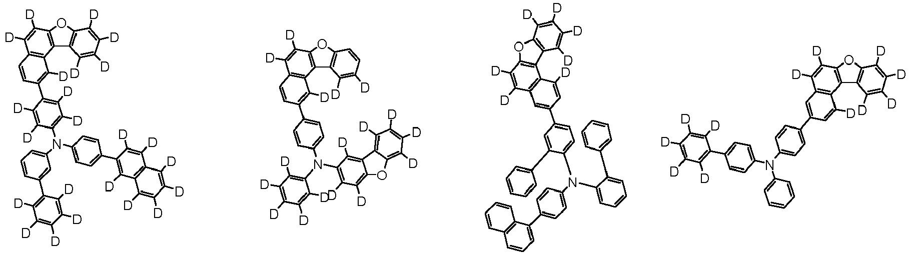

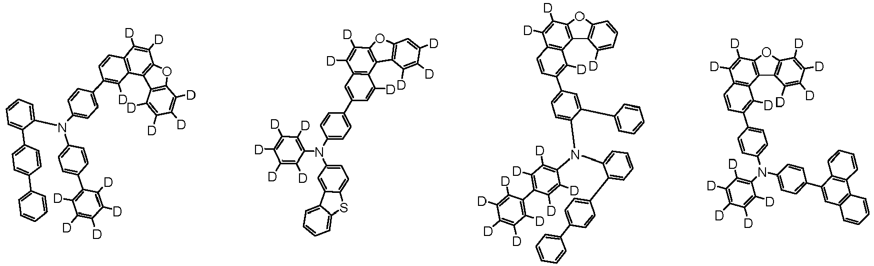

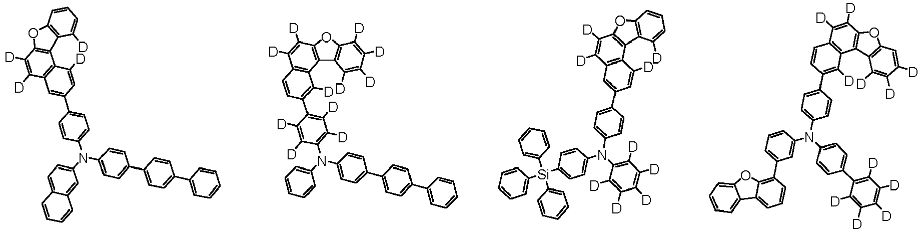

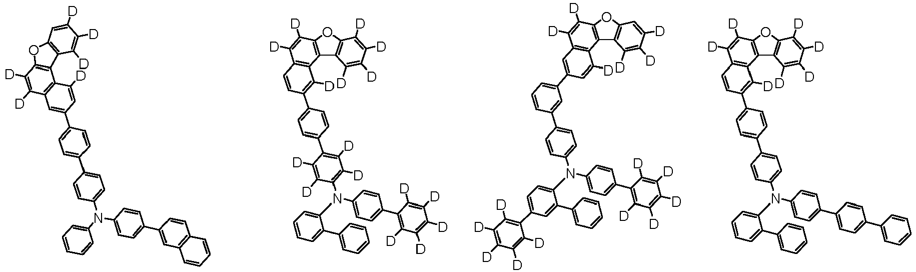

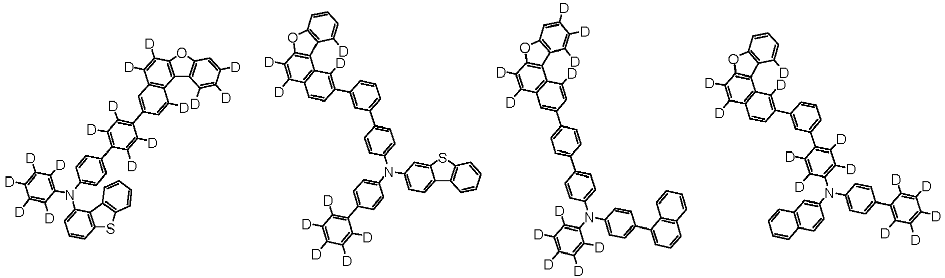

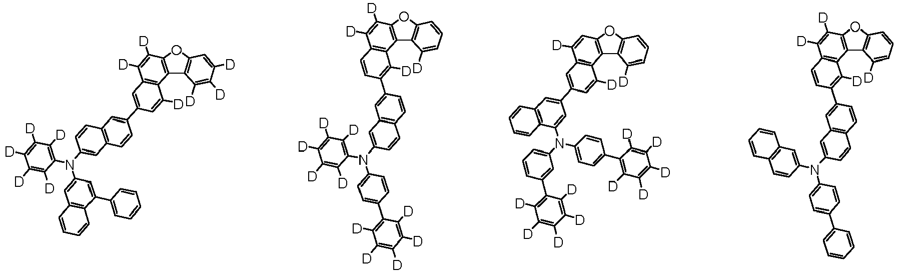

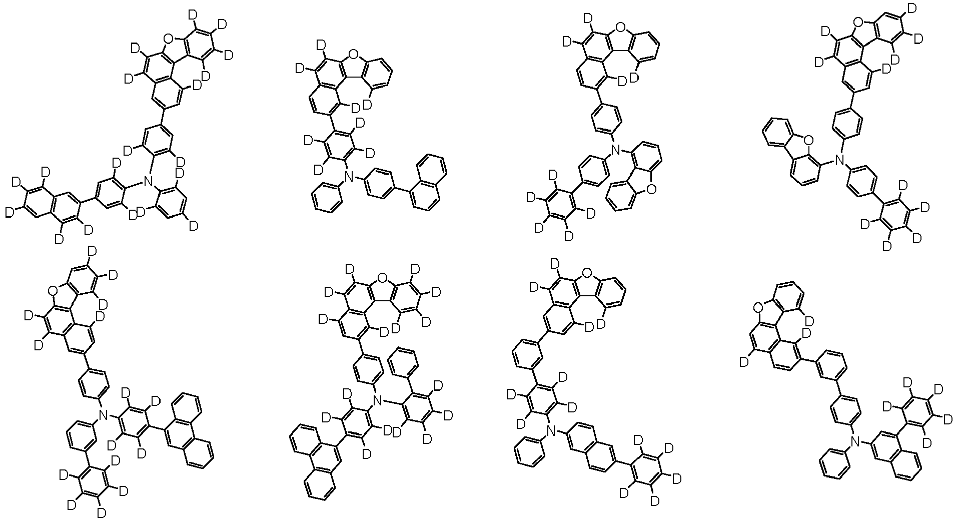

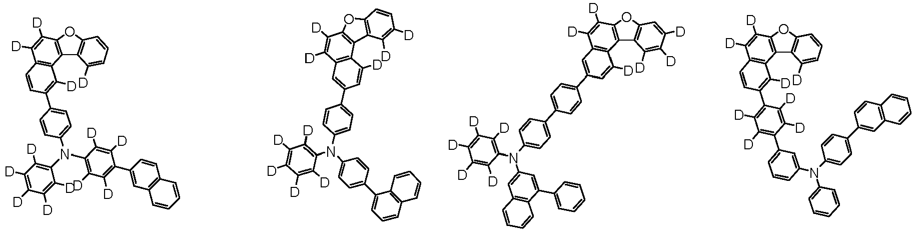

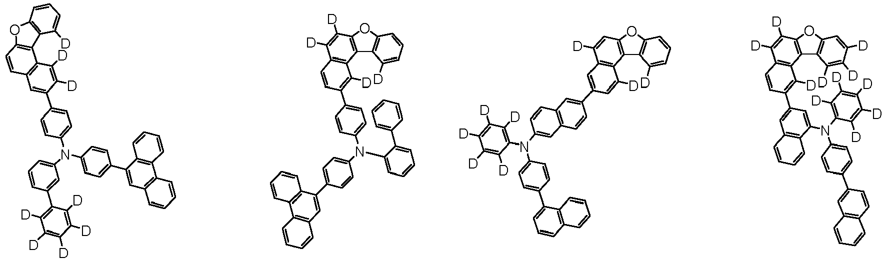

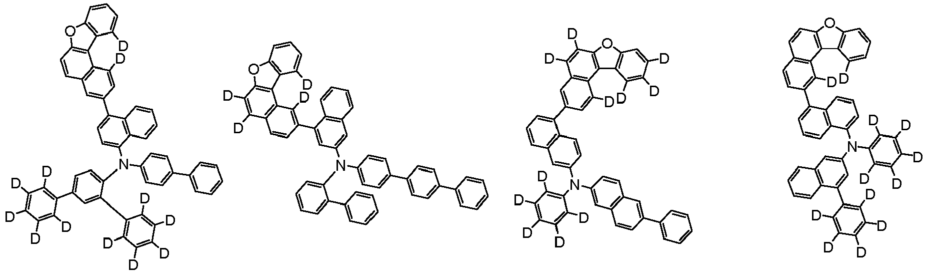

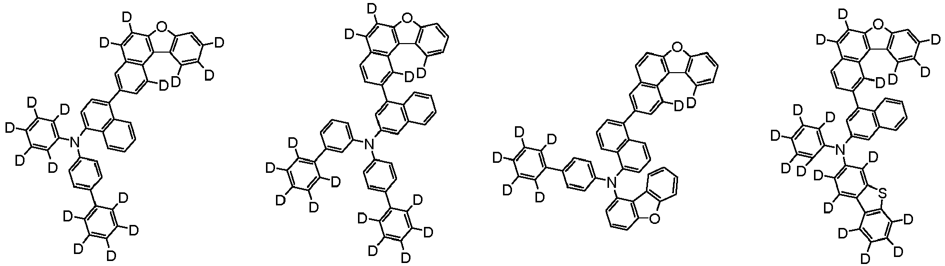

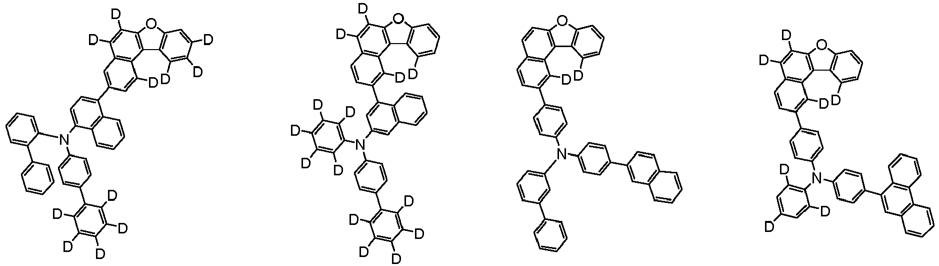

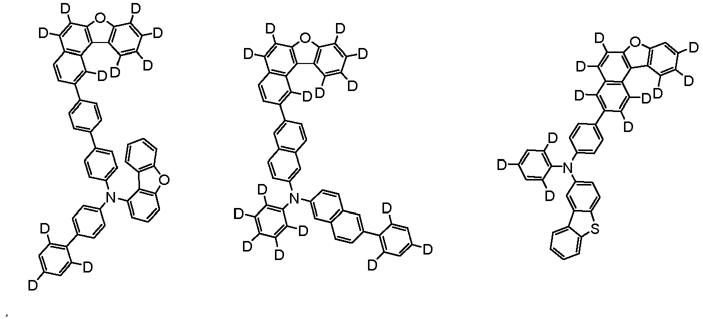

The compound represented by Chemical Formula 2, wherein R₇ is 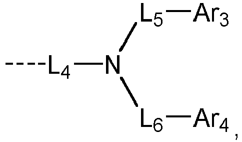 can be prepared by a preparation method as shown in the following Reaction Scheme 2 as an example, and the other remaining compounds cam be prepared in a similar manner. 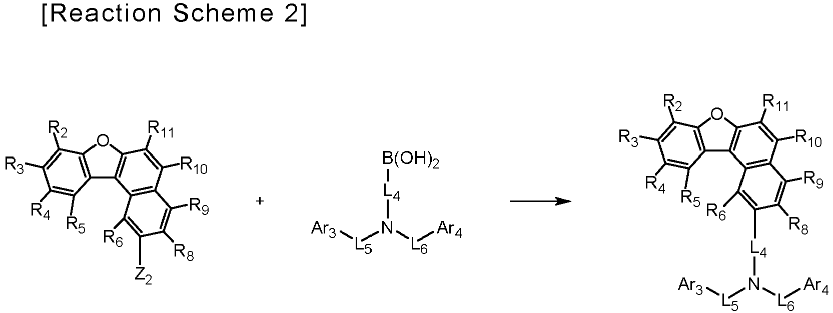 in Reaction Scheme 2, R₂ to R₁₁, Ar₃, Ar₄ and L₄ to L₆ are as defined in Chemical Formula 2, and Z₂ is halogen, preferably Z₂ is chloro or bromo.

Reaction Scheme 2 is a Suzuki coupling reaction, which is preferably carried out in the presence of a palladium catalyst and a base, and a reactive group for the Suzuki coupling reaction can be modified as known in the art. The above preparation method may be further embodied in Preparation Examples described hereinafter.

Preferably, in the light emitting layer, the weight ratio of the compound represented by Chemical Formula 1 and the compound represented by Chemical Formula 2 is 10:90 to 90:10, more preferably 20:80 to 80:20, 30:70 to 70:30 or 40:60 to 60:40.

Meanwhile, the light emitting layer may further include a dopant in addition to the host. The dopant material is not particularly limited as long as it is a material used for the organic light emitting device. As an example, an aromatic amine derivative, a styrylamine compound, a boron complex, a fluoranthene compound, a metal complex, and the like can be mentioned. Specific examples of the aromatic amine derivatives include substituted or unsubstituted fused aromatic ring derivatives having an arylamino group, examples thereof include pyrene, anthracene, chrysene, and periflanthene having the arylamino group, and the like. The styrylamine compound is a compound where at least one arylvinyl group is substituted in substituted or unsubstituted arylamine, in which one or two or more substituent groups selected from the group consisting of an aryl group, a silyl group, an alkyl group, a cycloalkyl group, and an arylamino group are substituted or unsubstituted. Specific examples thereof include styrylamine, styryldiamine, styryltriamine, styryltetramine, and the like, but are not limited thereto. Further, examples of the metal complex include an iridium complex, a platinum complex, and the like, but are not limited thereto.

In one example, the dopant material may be at least one selected from the group consisting of the following, without being limited thereto:

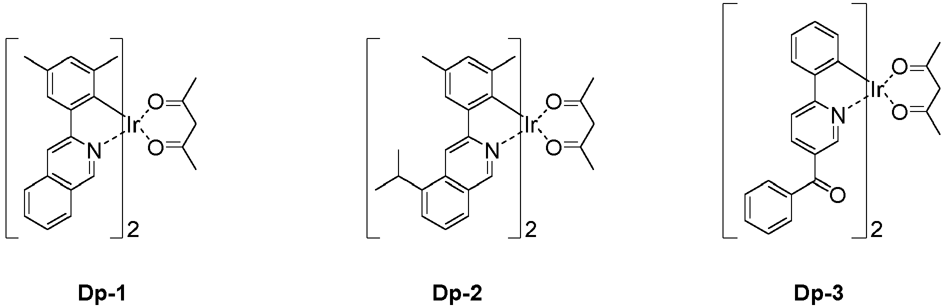

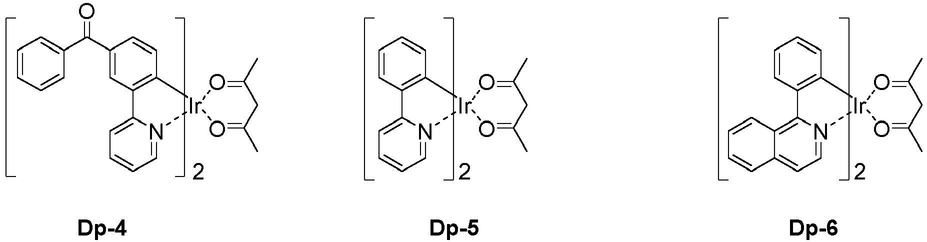

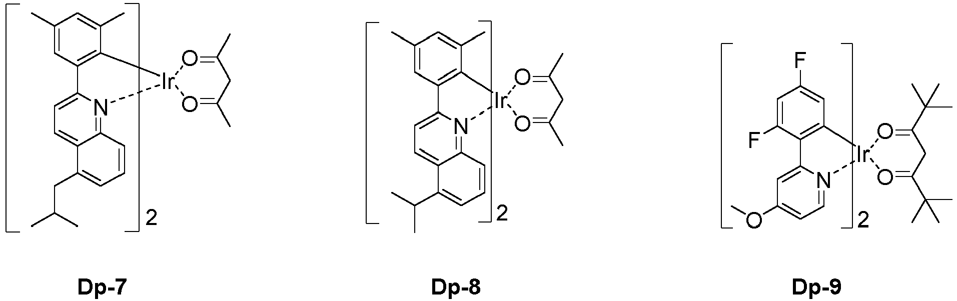

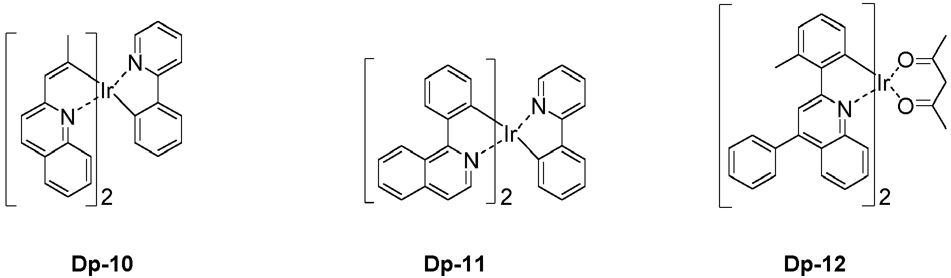

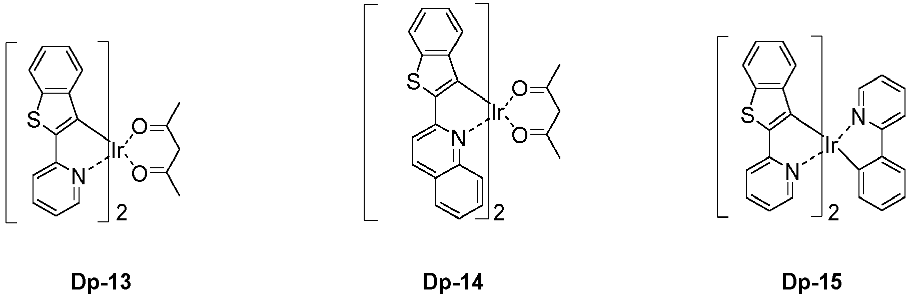

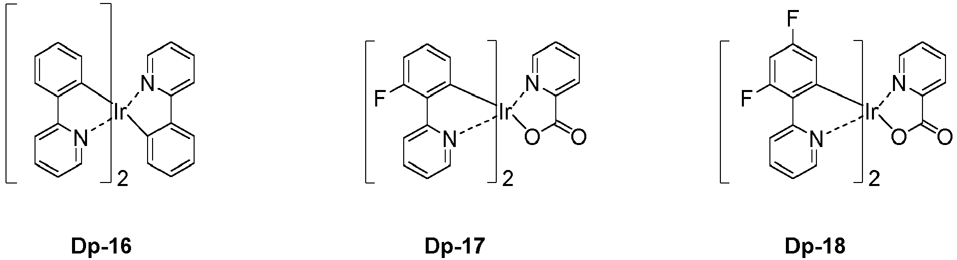

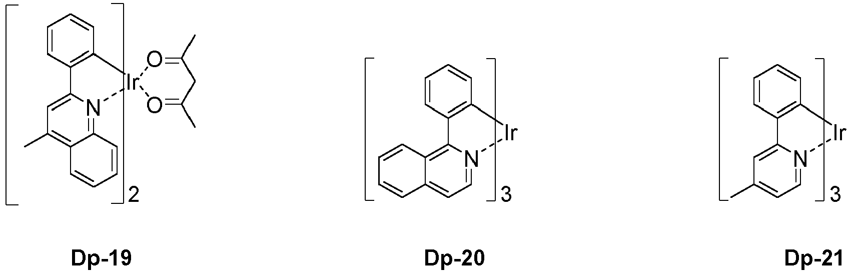

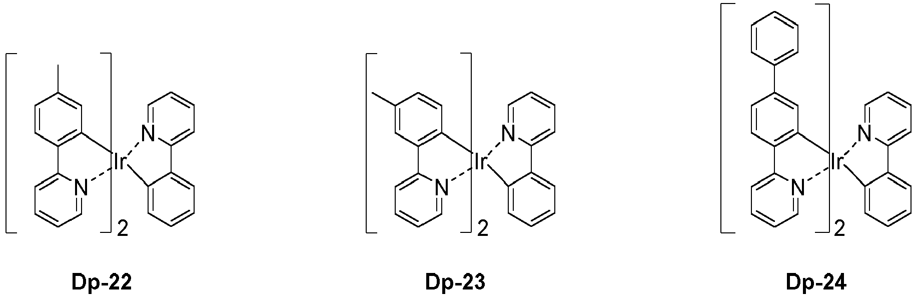

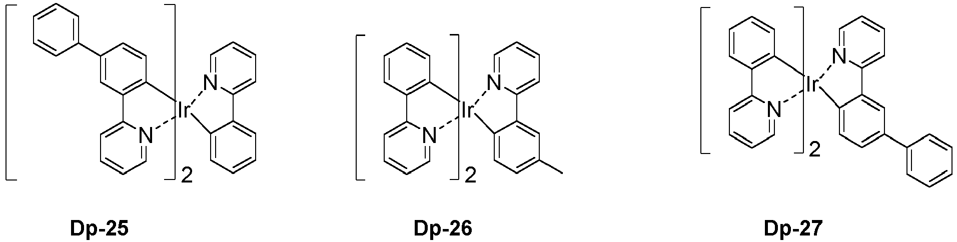

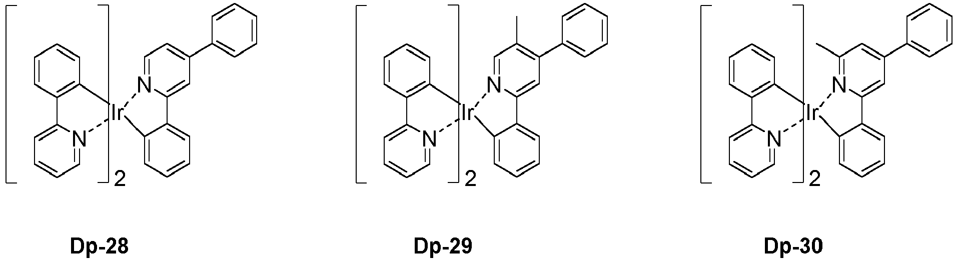

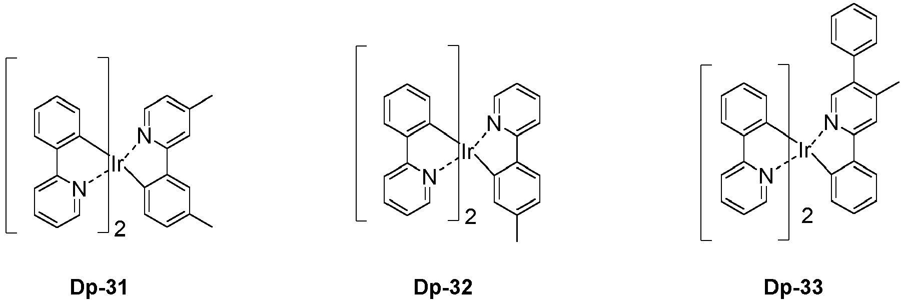

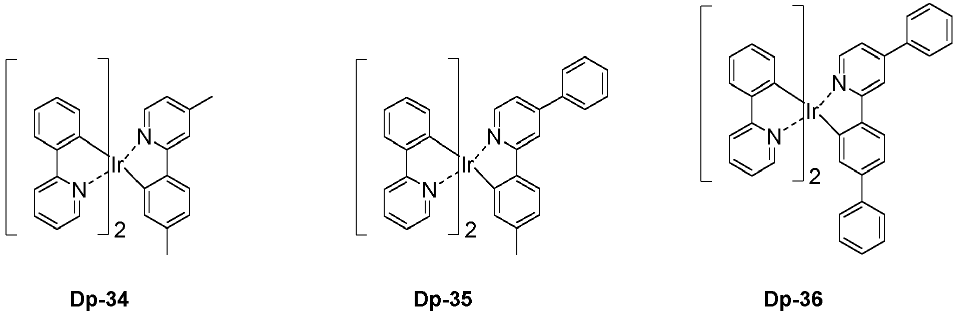

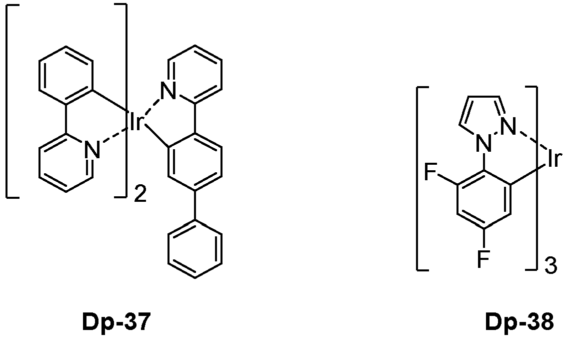

### Hole Blocking Layer

The hole blocking layer is a layer provided between the electron transport layer and the light emitting layer in order to prevent the electrons injected in the anode from being transferred to the electron transport layer without being recombined in the light emitting layer, which may also be referred to as a hole inhibition layer. The hole blocking layer is preferably a material having high ionization energy.

### Electron Transport Layer

The organic light emitting device according to the present disclosure may include an electron transport layer on the light emitting layer, if necessary.

The electron transport layer is a layer that receives the electrons from the electron injection layer formed on the cathode or the anode and transports the electrons to the light emitting layer, and that suppress the transfer of holes from the light emitting layer, and an electron transport material is suitably a material which may receive electrons well from a cathode and transfer the electrons to a light emitting layer, and has a large mobility for electrons.

Specific examples of the electron transport material include: an Al complex of 8-hydroxyquinoline; a complex including Alqs; an organic radical compound; a hydroxyflavone-metal complex, and the like, but are not limited thereto. The electron transport layer may be used with any desired cathode material, as used according to a conventional technique. In particular, appropriate examples of the cathode material are a typical material which has a low work function, followed by an aluminum layer or a silver layer. Specific examples thereof include cesium, barium, calcium, ytterbium, and samarium, in each case followed by an aluminum layer or a silver layer.

### Electron Injection Layer

The organic light emitting device according to the present disclosure may further include an electron injection layer on the light emitting layer (or on the electron transport layer, if the electron transport layer exists).

The electron injection layer is a layer which injects electrons from an electrode, and is preferably a compound which has a capability of transporting electrons, has an effect of injecting electrons from a cathode and an excellent effect of injecting electrons into a light emitting layer or a light emitting material, prevents excitons produced from the light emitting layer from moving to a hole injection layer, and is also excellent in the ability to form a thin film.

Specific examples of the electron injection layer include fluorenone, anthraquinodimethane, diphenoquinone, thiopyran dioxide, oxazole, oxadiazole, triazole, imidazole, perylenetetracarboxylic acid, fluorenylidene methane, anthrone, and the like, and derivatives thereof, a metal complex compound, a nitrogen-containing 5-membered ring derivative, and the like, but are not limited thereto.

Examples of the metal complex compound include 8-hydroxyquinolinato lithium, bis(8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, bis(2-methyl-8-quinolinato)(2-naphtholato)gallium, and the like, but are not limited thereto.

Meanwhile, in the present disclosure, the "electron injection and transport layer" is a layer that performs both the roles of the electron injection layer and the electron transport layer, and the materials that perform the roles of each layer may be used alone or in combination, without being limited thereto.

### Organic Light Emitting Device

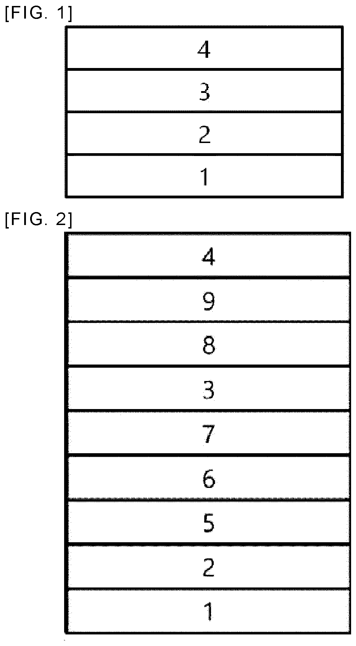

The structure of the organic light emitting device according to the present disclosure is illustrated in FIGS. 1 and 2. FIG. 1 shows an example of an organic light emitting device comprising a substrate 1, an anode 2, a light emitting layer 3, and a cathode 4. FIG. 2 shows an example of an organic light emitting device comprising a substrate 1, an anode 2, a hole injection layer 5, a hole transport layer 6, an electron blocking layer 7, a light emitting layer 3, a hole blocking layer 8, an electron injection and transport layer 9, and a cathode 4.

The organic light emitting device according to the present disclosure can be manufactured by sequentially stacking the above-described structures. In this case, the organic light emitting device may be manufactured by depositing a metal, metal oxides having conductivity, or an alloy thereof on the substrate by using a PVD (physical vapor deposition) method such as a sputtering method or an e-beam evaporation method to form the anode, forming the respective layers described above thereon, and then depositing a material that can be used as the cathode thereon. In addition to such a method, the organic light emitting device may be manufactured by sequentially depositing from the cathode material to the anode material on a substrate in the reverse order of the above-mentioned configuration (WO 2003/012890). Further, the light emitting layer may be formed by subjecting hosts and dopants to a vacuum deposition method and a solution coating method. Herein, the solution coating method means a spin coating, a dip coating, a doctor blading, an inkjet printing, a screen printing, a spray method, a roll coating, or the like, but is not limited thereto.

Meanwhile, the organic light emitting device according to the present disclosure may be a bottom emission device, a top emission device, or a double-sided light emitting device, and particularly, may be a bottom emission device that requires relatively high luminous efficiency.

Hereinafter, preferred examples are presented to assist in the understanding of the present disclosure. However, the following examples are only provided for a better understanding of the present disclosure, and is not intended to limit the content of the present disclosure.

### Synthesis Example 1-1

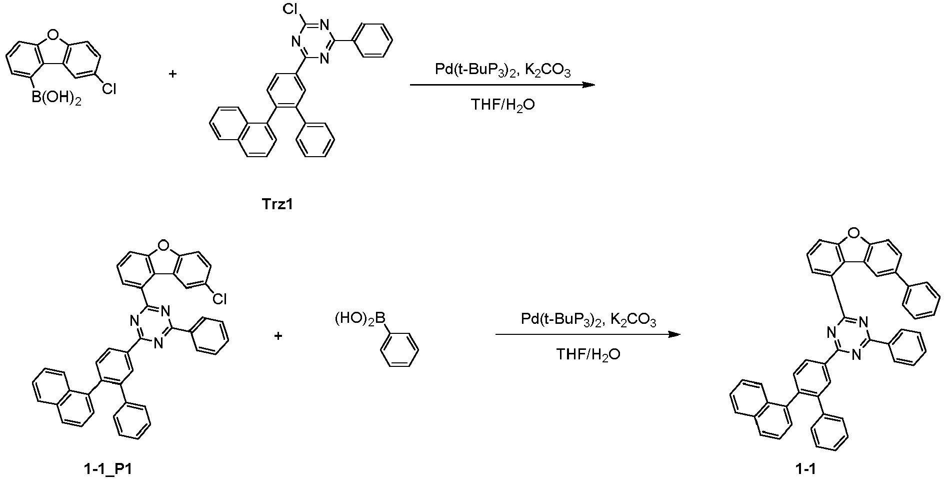

(8-Chlorodibenzo[b,d]furan-1-yl)boronic acid (15 g, 60.9 mmol) and Compound Trz1 (30 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 25.9 g of Compound 1-1_P1. (Yield: 67%, MS: [M+H]⁺= 636)

Compound 1-1_P1 (15 g, 23.6 mmol) and phenylboronic acid (3.0 g, 24.8 mmol) were added to 300 ml of THF, and the mixture was stirred and refluxed. Then, potassium carbonate (9.8 g, 70.7 mmol) was dissolved in 29 ml of water and added thereto, and the mixture was sufficiently stirred and then bis(tri-tert-butylphosphine)palladium(0) (0.1 g, 0.2 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.5 g of Compound 1-1. (Yield: 72%, MS: [M+H]⁺= 678)

### Synthesis Example 1-2

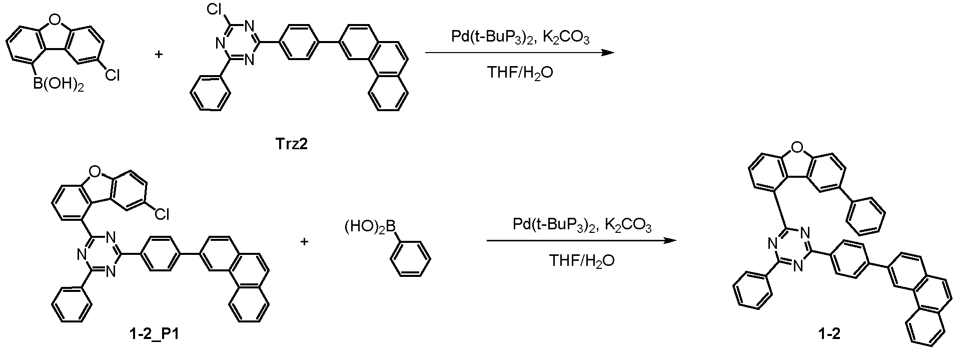

(8-Chlorodibenzo[b,d]furan-1-yl)boronic acid (15 g, 60.9 mmol) and Compound Trz2 (28.4 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 24.1 g of Compound 1-2_P1. (Yield: 65%, MS: [M+H]⁺= 610)

Compound 1-2_P1 (15 g, 24.6 mmol) and phenylboronic acid (3.1 g, 25.8 mmol) were added to 300 ml of THF, and the mixture was stirred and refluxed. Then, potassium carbonate (10.2 g, 73.8 mmol) was dissolved in 31 ml of water and added thereto, and the mixture was sufficiently stirred and then bis(tri-tert-butylphosphine)palladium(0) (0.1 g, 0.2 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.7 g of Compound 1-2. (Yield: 73%, MS: [M+H]⁺= 652)

### Synthesis Example 1-3

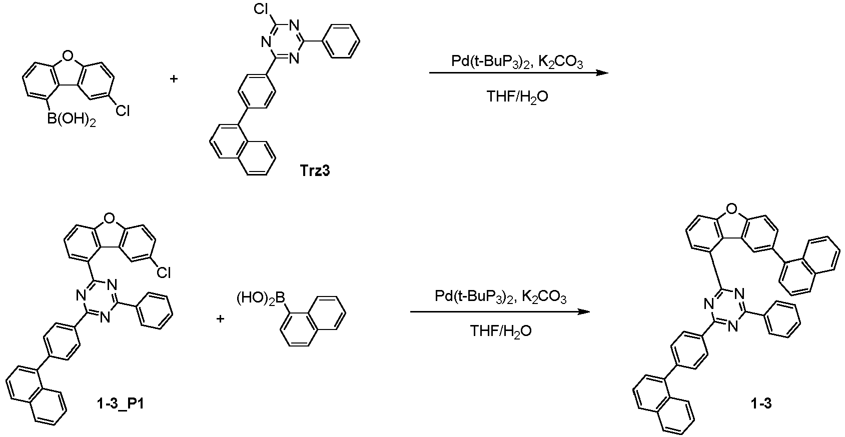

(8-Chlorodibenzo[b,d]furan-1-yl)boronic acid (15 g, 60.9 mmol) and Compound Trz3 (25.2 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.5 g of Compound 1-3_P1. (Yield: 69%, MS: [M+H]⁺= 560)

Compound 1-3_P1 (15 g, 26.8 mmol) and naphthalen-1-ylboronic acid (4.8 g, 28.1 mmol) were added to 300 ml of THF, and the mixture was stirred and refluxed. Then, potassium carbonate (11.1 g, 80.3 mmol) was dissolved in 33 ml of water and added thereto, and the mixture was sufficiently stirred and then bis(tri-tert-butylphosphine)palladium(0) (0.1 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.7 g of Compound 1-3. (Yield: 73%, MS: [M+H]⁺= 652)

### Synthesis Example 1-4

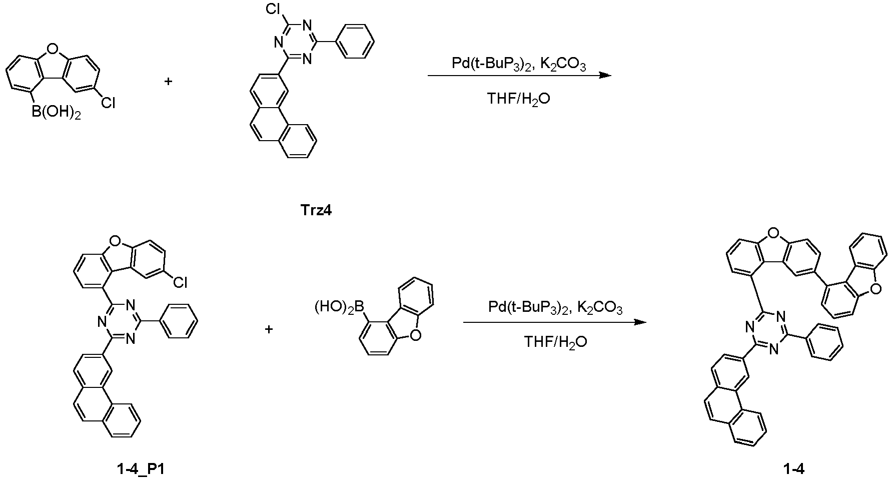

(8-Chlorodibenzo[b,d]furan-1-yl)boronic acid (15 g, 60.9 mmol) and Compound Trz4 (23.5 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 24 g of Compound 1-4_P1. (Yield: 74%, MS: [M+H]⁺= 534)

Compound 1-4_P1 (15 g, 28.1 mmol) and dibenzo[b,d]furan-1-ylboronic acid (6.3 g, 29.5 mmol) were added to 300 ml of THF, and the mixture was stirred and refluxed. Then, potassium carbonate (11.7 g, 84.4 mmol) was dissolved in 35 ml of water and added thereto, and the mixture was sufficiently stirred and then bis(tri-tert-butylphosphine)palladium(0) (0.1 g, 0.3 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.4 g of Compound 1-4. (Yield: 66%, MS: [M+H]⁺= 666)

### Synthesis Example 1-5

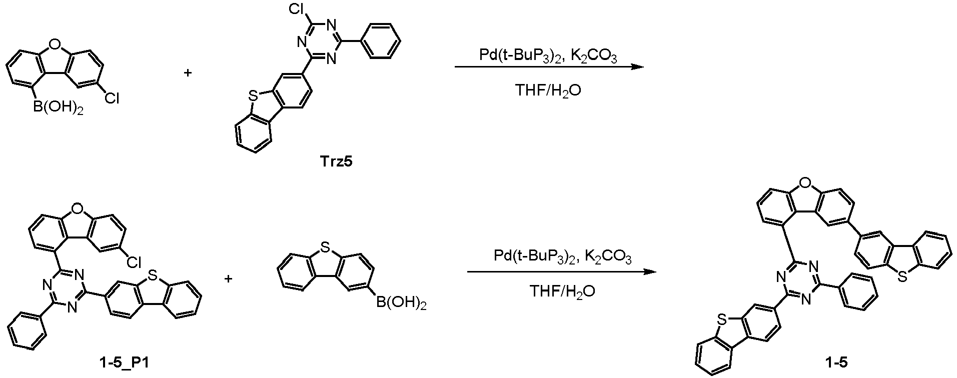

(8-Chlorodibenzo[b,d]furan-1-yl)boronic acid (15 g, 60.9 mmol) and Compound Trz5 (23.9 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.6 g of Compound 1-5_P1. (Yield: 72%, MS: [M+H]⁺= 540)

Compound 1-5_P1 (15 g, 27.8 mmol) and dibenzo[b,d]thiophen-2-ylboronic acid (6.7 g, 29.2 mmol) were added to 300 ml of THF, and the mixture was stirred and refluxed. Then, potassium carbonate (11.5 g, 83.3 mmol) was dissolved in 35 ml of water and added thereto, and the mixture was sufficiently stirred and then bis(tri-tert-butylphosphine)palladium(0) (0.1 g, 0.3 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.4 g of Compound 1-5. (Yield: 65%, MS: [M+H]⁺= 688)

### Synthesis Example 1-6

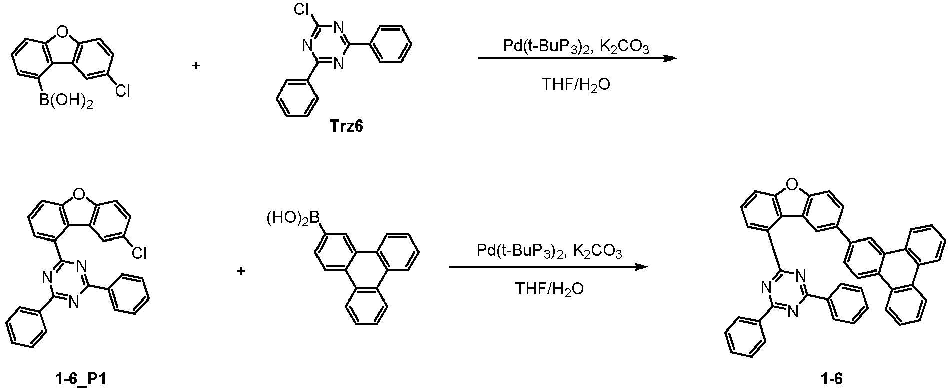

(8-Chlorodibenzo[b,d]furan-1-yl)boronic acid (15 g, 60.9 mmol) and Compound Trz6 (17.1 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 17.9 g of Compound 1-6_P1. (Yield: 68%, MS: [M+H]⁺= 434)

Compound 1-6_P1 (15 g, 34.6 mmol) and triphenylen-2-ylboronic acid (9.9 g, 36.3 mmol) were added to 300 ml of THF, and the mixture was stirred and refluxed. Then, potassium carbonate (14.3 g, 103.7 mmol) was dissolved in 43 ml of water and added thereto, and the mixture was sufficiently stirred and then bis(tri-tert-butylphosphine)palladium(0) (0.2 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 14.3 g of Compound 1-6. (Yield: 66%, MS: [M+H]⁺= 626)

### Synthesis Example 1-7

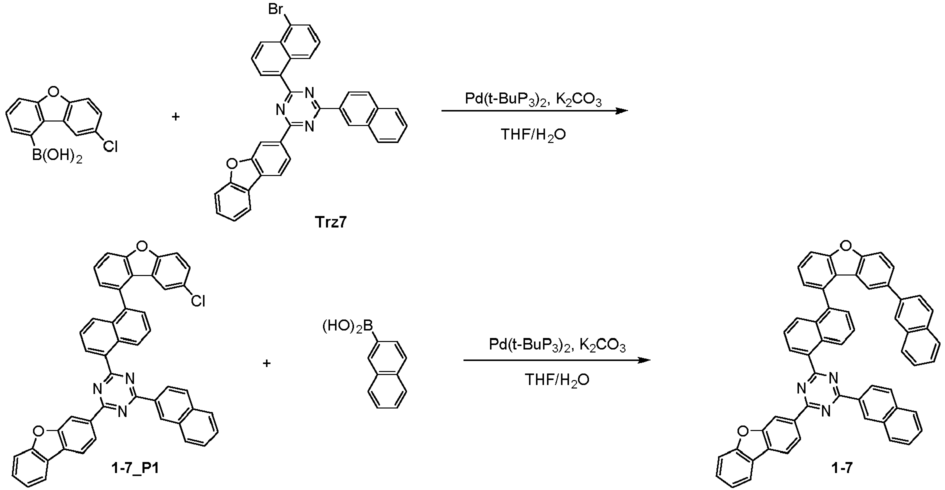

(8-Chlorodibenzo[b,d]furan-1-yl)boronic acid (15 g, 60.9 mmol) and Compound Trz7 (37 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 30.6 g of Compound 1-7_P1. (Yield: 72%, MS: [M+H]⁺= 700)

Compound 1-7_P1 (15 g, 21.4 mmol) and naphthalen-2-ylboronic acid (3.9 g, 22.5 mmol) were added to 300 ml of THF, and the mixture was stirred and refluxed. Then, potassium carbonate (8.9 g, 64.3 mmol) was dissolved in 27 ml of water and added thereto, and the mixture was sufficiently stirred and then bis(tri-tert-butylphosphine)palladium(0) (0.1 g, 0.2 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.4 g of Compound 1-7. (Yield: 67%, MS: [M+H]⁺= 792)

### Synthesis Example 1-8

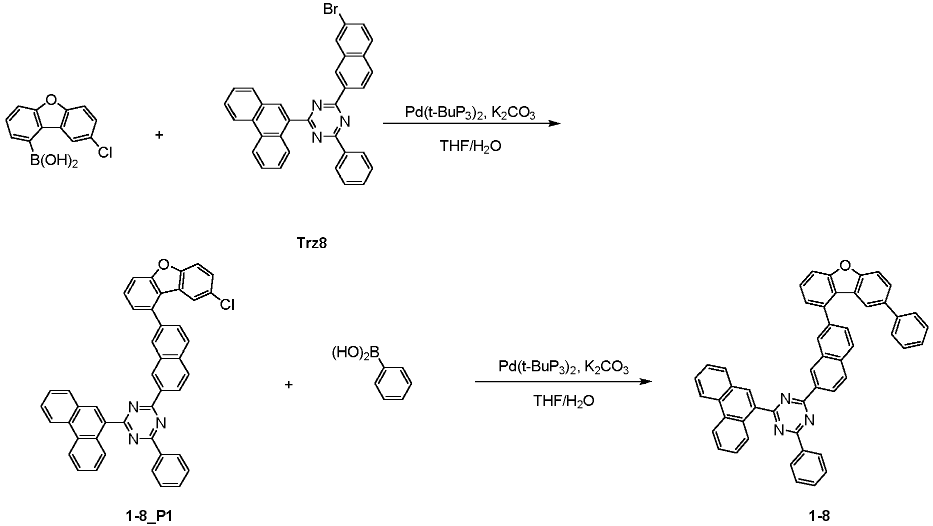

(8-Chlorodibenzo[b,d]furan-1-yl)boronic acid (15 g, 60.9 mmol) and Compound Trz8 (34.4 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 30.1 g of Compound 1-8_P1. (Yield: 75%, MS: [M+H]⁺= 660)

Compound 1-8_P1 (15 g, 22.7 mmol) and phenylboronic acid (2.9 g, 23.9 mmol) were added to 300 ml of THF, and the mixture was stirred and refluxed. Then, potassium carbonate (9.4 g, 68.2 mmol) was dissolved in 28 ml of water and added thereto, and the mixture was sufficiently stirred and then bis(tri-tert-butylphosphine)palladium(0) (0.1 g, 0.2 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.7 g of Compound 1-8. (Yield: 67%, MS: [M+H]⁺= 702)

### Synthesis Example 1-9

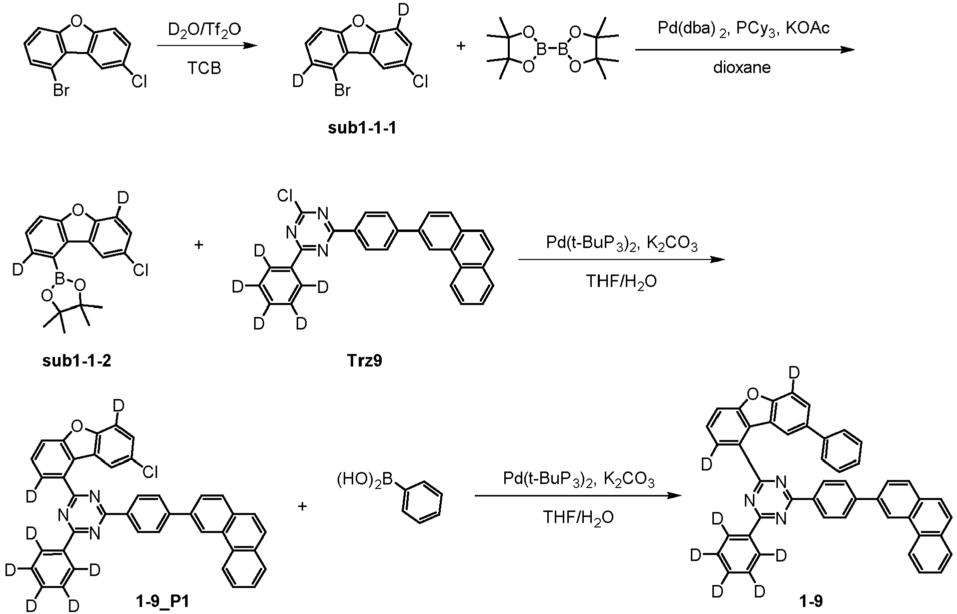

Trifluoromethanesulfonic anhydride (30.1 g, 106.6 mmol) and deuterium oxide (10.7 g, 532.8 mmol) were added at 0°C and stirred for 5 hours to prepare a solution. 1-Bromo-8-chlorodibenzo[b,d]furan (15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-8-chlorodibenzo[b,d]furan and 1,2,4-trichlorobenzene, and the mixture was stirred while heating to 140°C and then keeping that temperature. After the reaction for 4 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.5 g of compound sub1-1-1. (Yield: 43%, MS: [M+H]⁺= 283)

Compound sub1-1-1 (15 g, 52.9 mmol) and bis(pinacolato)diboron (14.8 g, 58.2 mmol) were added to 300ml of 1,4-dioxane, and the mixture was stirred under reflux. Then, potassium acetate (7.8 g, 79.4 mmol) was added thereto, and the mixture was sufficiently stirred and then bis(dibenzylideneacetone)palladium(0) (0.9 g, 1.6 mmol) and tricyclohexylphosphine (0.9 g, 3.2 mmol) were added. After the reaction for 5 hours, the reaction mixture was cooled to room temperature, and the organic layer was separated using chloroform and water, and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.5 g of Compound sub1-1-2. (Yield: 66%, MS: [M+H]⁺= 331)

Compound sub1-1-2 (15 g, 45.4 mmol) and Compound Trz9 (21.4 g, 47.6 mmol) were added to 300 ml of THF, and the mixture was stirred and refluxed. Then, potassium carbonate (18.8 g, 136.1 mmol) was dissolved in 56 ml of water and added thereto, and the mixture was sufficiently stirred and then bis(tri-tert-butylphosphine)palladium(0) (0.2 g, 0.5 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 18.2 g of Compound 1-9_P1. (Yield: 65%, MS: [M+H]⁺= 617)

Compound 1-9_P1 (15 g, 24.3 mmol) and phenylboronic acid (3.1 g, 25.5 mmol) were added to 300 ml of THF, and the mixture was stirred and refluxed. Then, potassium carbonate (10.1 g, 72.9 mmol) was dissolved in 30 ml of water and added thereto, and the mixture was sufficiently stirred and then bis(tri-tert-butylphosphine)palladium(0) (0.1 g, 0.2 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11 g of Compound 1-9. (Yield: 69%, MS: [M+H]⁺= 659)

### Synthesis Example 1-10

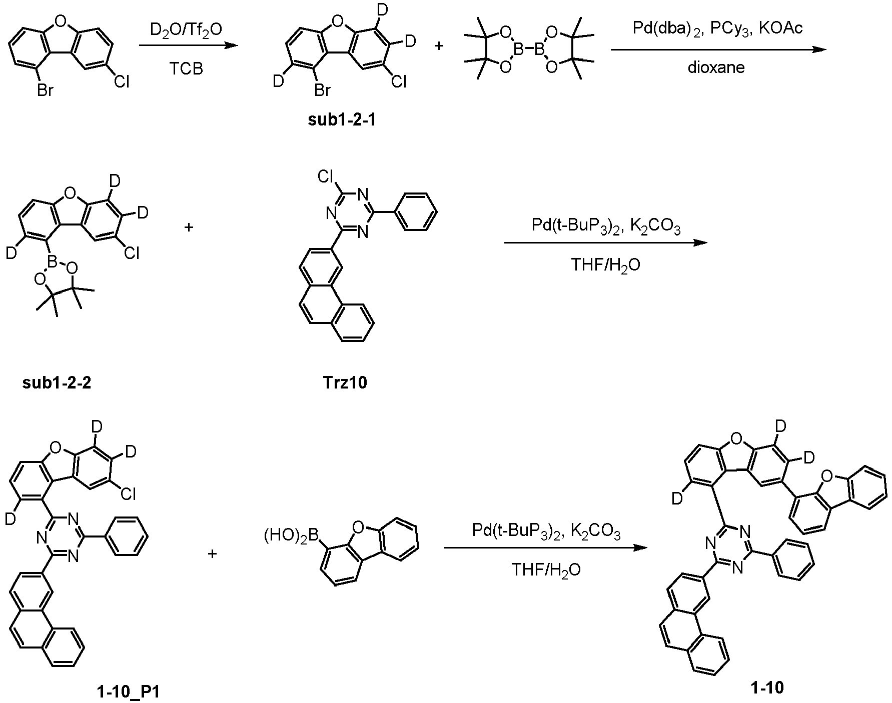

Trifluoromethanesulfonic anhydride (45.1 g, 159.8 mmol) and deuterium oxide (16 g, 799.2 mmol) were added at 0°C and stirred for 5 hours to prepare a solution. 1-Bromo-8-chlorodibenzo[b,d]furan (15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-8-chlorodibenzo[b,d]furan and 1,2,4-trichlorobenzene, and the mixture was stirred while heating to 140°C and then keeping that temperature. After the reaction for 7 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 5.6 g of Compound sub1-2-1. (Yield: 37%, MS: [M+H]⁺= 284)

Compound sub1-2-1 (15 g, 52.7 mmol) and bis(pinacolato)diboron (14.7 g, 58 mmol ) were added to 300ml of 1,4-dioxane, and the mixture was stirred under reflux. Then, potassium acetate (7.8 g, 79.1 mmol) was added thereto, and the mixture was sufficiently stirred and then bis(dibenzylideneacetone)palladium(0) (0.9 g, 1.6 mmol) and tricyclohexylphosphine (0.9 g, 3.2 mmol) were added. After the reaction for 6 hours, the reaction mixture was cooled to room temperature, and the organic layer was separated using chloroform and water, and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.1 g of Compound sub1-2-2. (Yield: 58%, MS: [M+H]⁺= 332)

Compound sub1-2-2 (15 g, 45.2 mmol) and Compound Trz10 (17.5 g, 47.5 mmol) were added to 300 ml of THF, and the mixture was stirred and refluxed. Then, potassium carbonate (18.8 g, 135.7 mmol) was dissolved in 56 ml of water and added thereto, and the mixture was sufficiently stirred and then bis(tri-tert-butylphosphine)palladium(0) (0.2 g, 0.5 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 17 g of Compound 1-10_P1. (Yield: 70%, MS: [M+H]⁺= 537)

Compound 1-9_P1 (15 g, 24.3 mmol) and phenylboronic acid (3.1 g, 25.5 mmol) were added to 300 ml of THF, and the mixture was stirred and refluxed. Then, potassium carbonate (10.1 g, 72.9 mmol) was dissolved in 30 ml of water and added thereto, and the mixture was sufficiently stirred and then bis(tri-tert-butylphosphine)palladium(0) (0.1 g, 0.2 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11 g of Compound 1-9. (Yield: 69%, MS: [M+H]⁺= 659)

### Synthesis Example 1-11

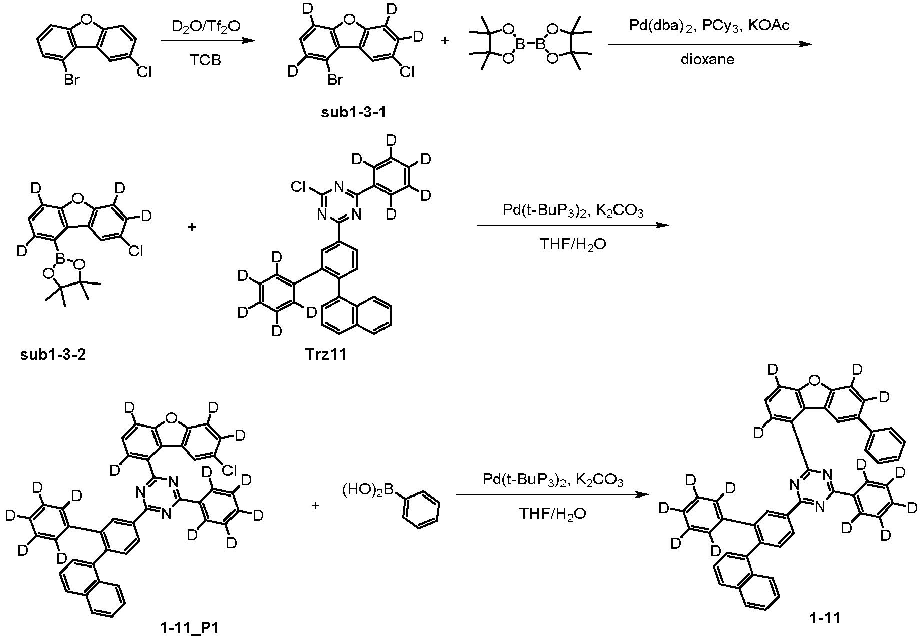

Trifluoromethanesulfonic anhydride (60.1 g, 213.1 mmol) and deuterium oxide (21.4 g, 1065.6 mmol) were added at 0°C and stirred for 5 hours to prepare a solution. 1-Bromo-8-chlorodibenzo[b,d]furan (15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-8-chlorodibenzo[b,d]furan and 1,2,4-trichlorobenzene, and the mixture was stirred while heating to 140°C and then keeping that temperature. After the reaction for 10 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.4 g of Compound sub1-3-1. (Yield: 42%, MS: [M+H]⁺= 285)

Compound sub1-3-1 (15 g, 52.5 mmol) and bis(pinacolato)diboron (14.7 g, 57.8 mmol ) were added to 300ml of 1,4-dioxane, and the mixture was stirred under reflux. Then, potassium acetate (7.7 g, 78.8 mmol) was added thereto, and the mixture was sufficiently stirred and then bis(dibenzylideneacetone)palladium(0) (0.9 g, 1.6 mmol) and tricyclohexylphosphine (0.9 g, 3.2 mmol) were added. After the reaction for 6 hours, the reaction mixture was cooled to room temperature, and the organic layer was separated using chloroform and water, and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12 g of Compound sub1-3-2. (Yield: 69%, MS: [M+H]⁺= 333)

Compound sub1-3-2 (15 g, 45.1 mmol) and Compound Trz11 (22.7 g, 47.4 mmol) were added to 300 ml of THF, and the mixture was stirred and refluxed. Then, potassium carbonate (18.7 g, 135.3 mmol) was dissolved in 56 ml of water and added thereto, and the mixture was sufficiently stirred and then bis(tri-tert-butylphosphine)palladium(0) (0.2 g, 0.5 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20.2 g of Compound 1-11_P1. (Yield: 69%, MS: [M+H]+= 650)

Compound 1-11_P1 (15 g, 23.1 mmol) and phenylboronic acid (2.9 g, 24.2 mmol) were added to 300 ml of THF, and the mixture was stirred and refluxed. Then, potassium carbonate (9.6 g, 69.2 mmol) was dissolved in 29 ml of water and added thereto, and the mixture was sufficiently stirred and then bis(tri-tert-butylphosphine)palladium(0) (0.1 g, 0.2 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.5g of Compound 1-11. (Yield: 66%, MS: [M+H]⁺= 692)

### Synthesis Example 1-12

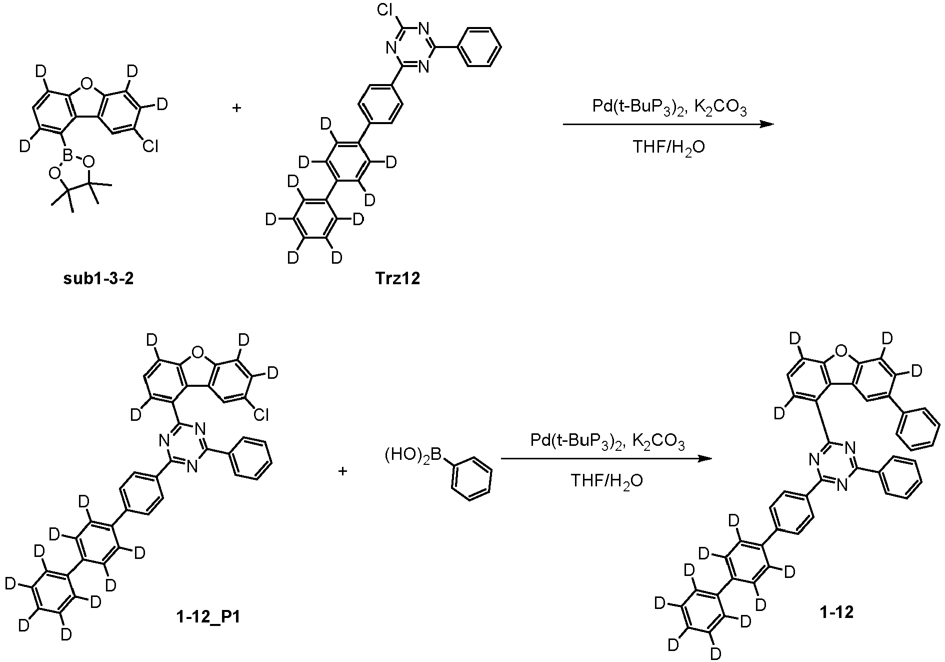

Compound sub1-3-2 (15 g, 45.1 mmol) and Compound Trz12 (20.3 g, 47.4 mmol) were added to 300 ml of THF, and the mixture was stirred and refluxed. Then, potassium carbonate (18.7 g, 135.3 mmol) was dissolved in 56 ml of water and added thereto, and the mixture was sufficiently stirred and then bis(tri-tert-butylphosphine)palladium(0) (0.2 g, 0.5 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20.2 g of Compound 1-12_P1. (Yield: 75%, MS: [M+H]⁺= 599)

Compound 1-12_P1 (15 g, 25 mmol) and phenylboronic acid (3.2 g, 26.3 mmol) were added to 300 ml of THF, and the mixture was stirred and refluxed. Then, potassium carbonate (10.4 g, 75.1 mmol) was dissolved in 31 ml of water and added thereto, and the mixture was sufficiently stirred and then bis(tri-tert-butylphosphine)palladium(0) (0.1 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.9 g of Compound 1-12. (Yield: 74%, MS: [M+H]⁺= 641)

### Synthesis Example 1-13

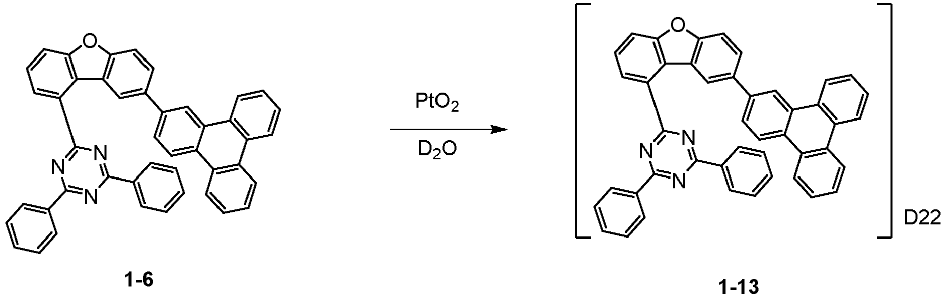

Compound 1-6 (10 g, 16 mmol), PtO₂ (1.1 g, 4.8 mmol),and D₂O (80 ml) were added to a shaker tube, and then the tube was sealed and heated at 250°C and 600 psi for 12 hours. After completion of the reaction, chloroform was added, and the reaction solution was transferred to a separatory funnel, and extracted. The extract was dried over MgSO₄ and concentrated, and then the sample was purified by silica gel column chromatography to prepare 3.9 g of Compound 1-13. (Yield: 38%, MS: [M+H]⁺= 649)

### Synthesis Example 1-14

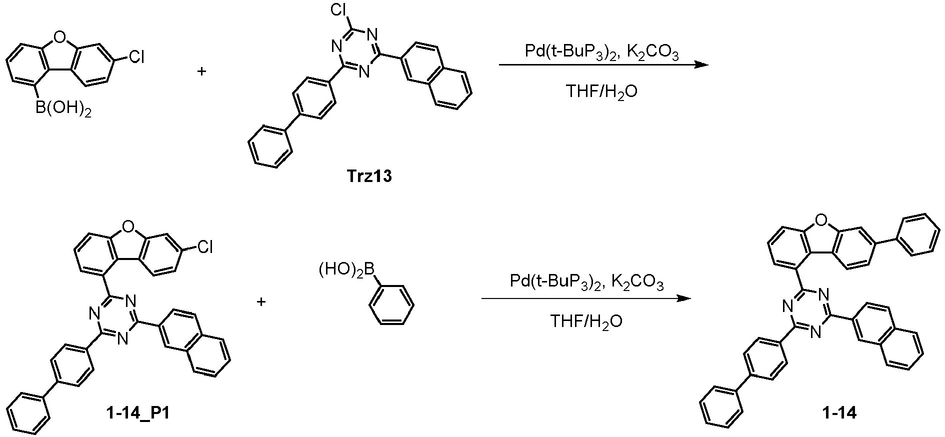

(7-Chlorodibenzo[b,d]furan-1-yl)boronic acid (15 g, 60.9 mmol) and Compound Trz13 (25.2 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.1 g of Compound 1-14_P1. (Yield: 65%, MS: [M+H]⁺= 560)

Compound 1-14_P1 (15 g, 26.8 mmol) and phenylboronic acid (3.4 g, 28.1 mmol) were added to 300 ml of THF, and the mixture was stirred and refluxed. Then, potassium carbonate (11.1 g, 80.3 mmol) was dissolved in 33 ml of water and added thereto, and the mixture was sufficiently stirred and then bis(tri-tert-butylphosphine)palladium(0) (0.1 g, 0.3 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.6 g of Compound 1-14. (Yield: 66%, MS: [M+H]⁺= 602)

### Synthesis Example 1-15

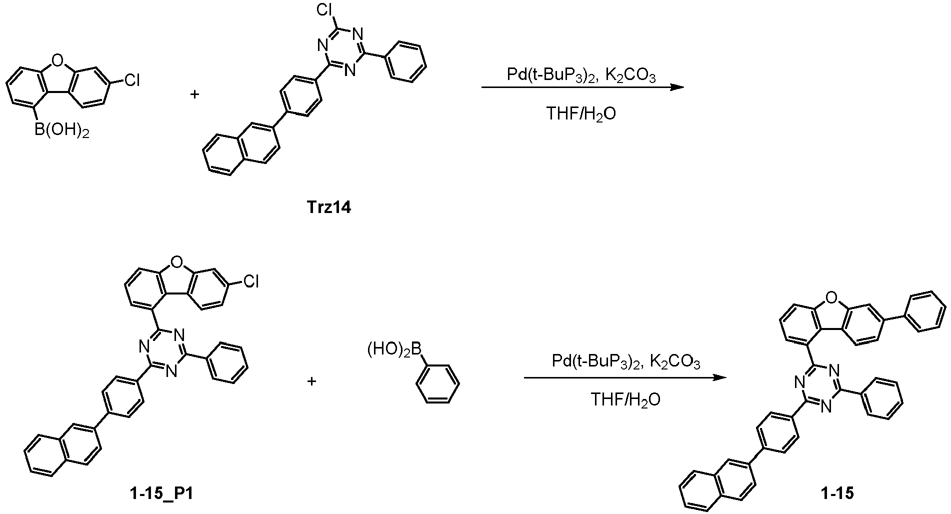

(7-Chlorodibenzo[b,d]furan-1-yl)boronic acid (15 g, 60.9 mmol) and Compound Trz14 (25.2 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 25.2 g of Compound 1-15_P1. (Yield: 74%, MS: [M+H]+= 560)

Compound 1-15_P1 (15 g, 26.8 mmol) and phenylboronic acid (3.4 g, 28.1 mmol) were added to 300 ml of THF, and the mixture was stirred and refluxed. Then, potassium carbonate (11.1 g, 80.3 mmol) was dissolved in 33 ml of water and added thereto, and the mixture was sufficiently stirred and then bis(tri-tert-butylphosphine)palladium(0) (0.1 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.6 g of Compound 1-15. (Yield: 72%, MS: [M+H]⁺= 602)

### Synthesis Example 1-16

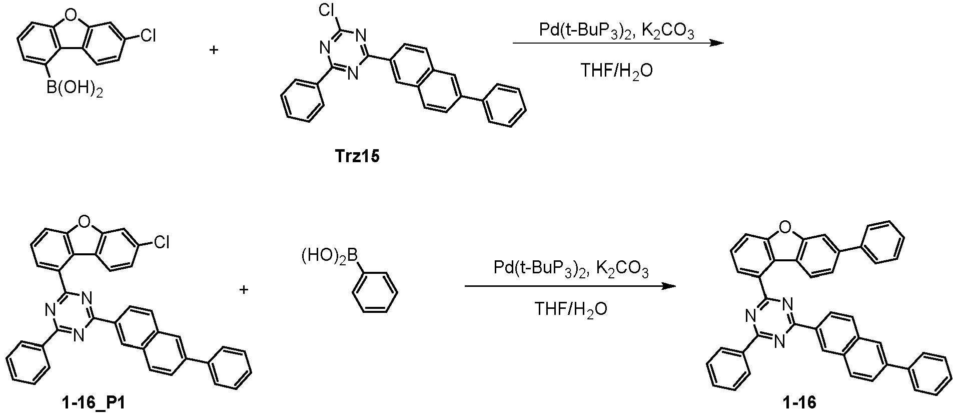

(7-Chlorodibenzo[b,d]furan-1-yl)boronic acid (15 g, 60.9 mmol) and Compound Trz15 (25.2 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 25.2 g of Compound 1-16_P1. (Yield: 74%, MS: [M+H]⁺= 560)

Compound 1-16_P1 (15 g, 26.8 mmol) and phenylboronic acid (3.4 g, 28.1 mmol) were added to 300 ml of THF, and the mixture was stirred and refluxed. Then, potassium carbonate (11.1 g, 80.3 mmol) was dissolved in 33 ml of water and added thereto, and the mixture was sufficiently stirred and then bis(tri-tert-butylphosphine)palladium(0) (0.1 g, 0.3 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.1 g of Compound 1-16. (Yield: 75%, MS: [M+H]⁺= 602)

### Synthesis Example 1-17

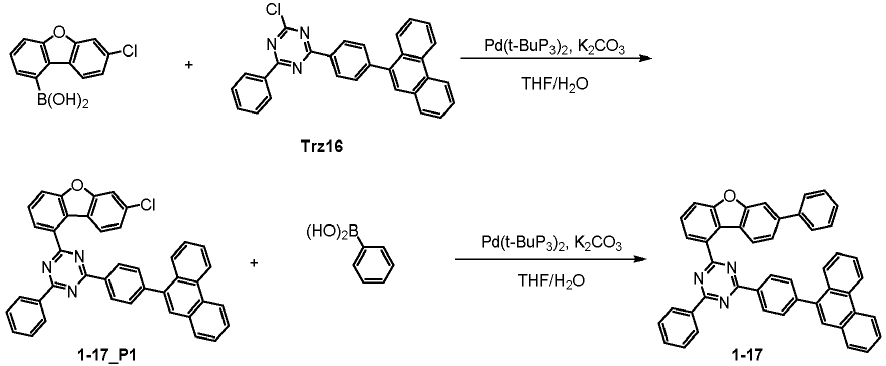

(7-Chlorodibenzo[b,d]furan-1-yl)boronic acid (15 g, 60.9 mmol) and Compound Trz16 (28.4 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 25.2 g of Compound 1-17_P1. (Yield: 68%, MS: [M+H]+= 610)

Compound 1-17_P1 (15 g, 24.6 mmol) and phenylboronic acid (3.1 g, 25.8 mmol) were added to 300 ml of THF, and the mixture was stirred and refluxed. Then, potassium carbonate (10.2 g, 73.8 mmol) was dissolved in 31 ml of water and added thereto, and the mixture was sufficiently stirred and then bis(tri-tert-butylphosphine)palladium(0) (0.1 g, 0.2 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.8 g of Compound 1-17. (Yield: 74%, MS: [M+H]⁺= 652)

### Synthesis Example 1-18

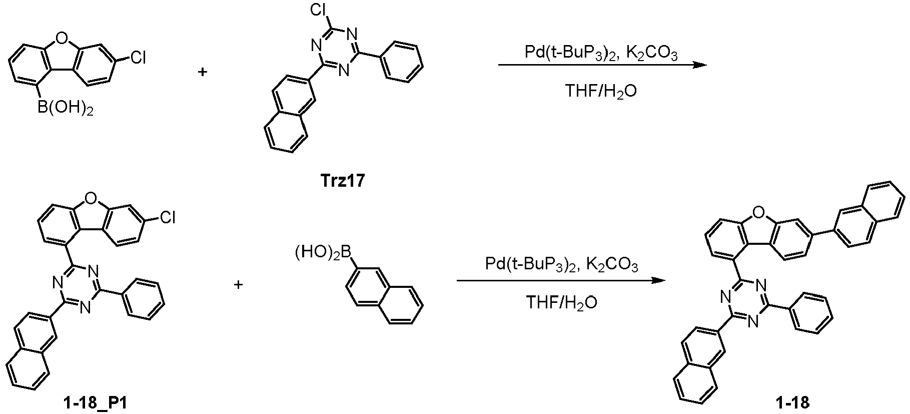

(7-Chlorodibenzo[b,d]furan-1-yl)boronic acid (15 g, 60.9 mmol) and Compound Trz17 (20.3 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21.8 g of Compound 1-18_P1. (Yield: 74%, MS: [M+H]⁺= 484)

Compound 1-18_P1 (15 g, 31 mmol) and naphthalen-2-ylboronic acid (5.6 g, 32.5 mmol) were added to 300 ml of THF, and the mixture was stirred and refluxed. Then, potassium carbonate (12.9 g, 93 mmol) was dissolved in 39 ml of water and added thereto, and the mixture was sufficiently stirred and then bis(tri-tert-butylphosphine)palladium(0) (0.2 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.3 g of Compound 1-18. (Yield: 69%, MS: [M+H]⁺= 576)

### Synthesis Example 1-19

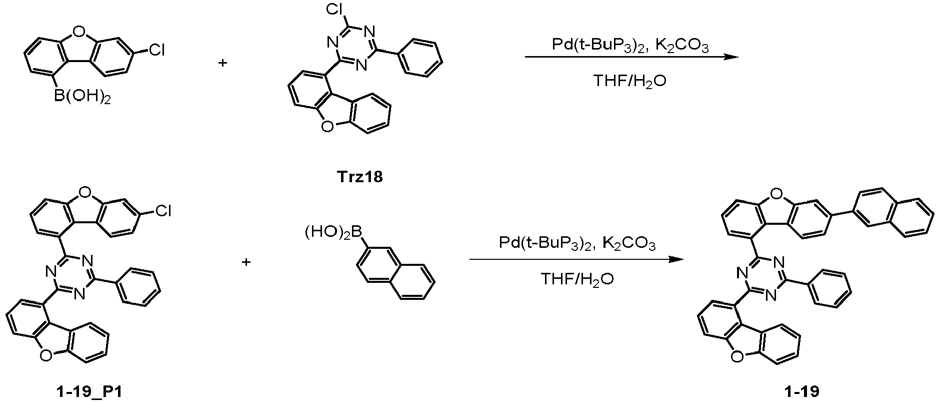

(7-Chlorodibenzo[b,d]furan-1-yl)boronic acid (15 g, 60.9 mmol) and Compound Trz18 (22.9 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21 g of Compound 1-19_P1 . (Yield: 66%, MS: [M+H]⁺= 524)

Compound 1-19_P1 (15 g, 28.6 mmol) and naphthalen-2-ylboronic acid (5.2 g, 30.1 mmol) were added to 300 ml of THF, and the mixture was stirred and refluxed. Then, potassium carbonate (11.9 g, 85.9 mmol) was dissolved in 36 ml of water and added thereto, and the mixture was sufficiently stirred and then bis(tri-tert-butylphosphine)palladium(0) (0.1 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.4 g of Compound 1-19. (Yield: 65%, MS: [M+H]⁺= 616)

### Synthesis Example 1-20

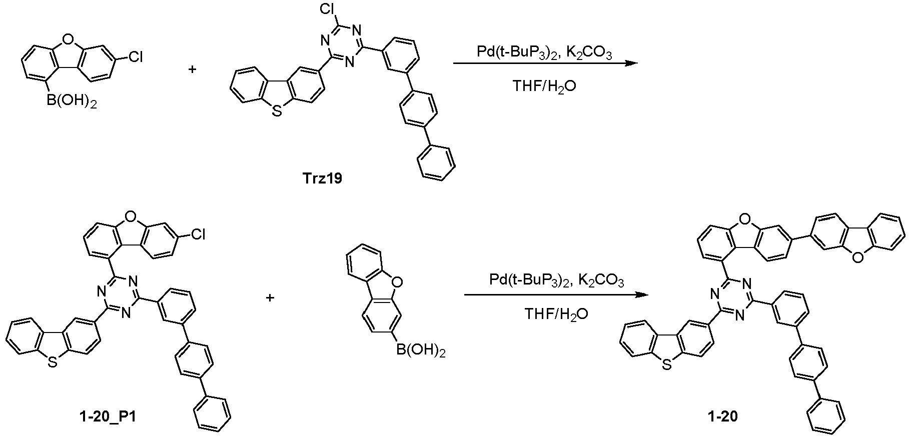

(7-Chlorodibenzo[b,d]furan-1-yl)boronic acid (15 g, 60.9 mmol) and Compound Trz19 (33.6 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 30.3 g of Compound 1-20_P1. (Yield: 72%, MS: [M+H]⁺= 692)

Compound 1-20_P1 (15 g, 21.7 mmol) and dibenzo[b,d]furan-3-ylboronic acid (4.8 g, 22.8 mmol) were added to 300 ml of THF, and the mixture was stirred and refluxed. Then, potassium carbonate (9 g, 65 mmol) was dissolved in 27 ml of water and added thereto, and the mixture was sufficiently stirred and then bis(tri-tert-butylphosphine)palladium(0) (0.1 g, 0.2 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12 g of Compound 1-20. (Yield: 67%, MS: [M+H]⁺= 824)

### Synthesis Example 1-21

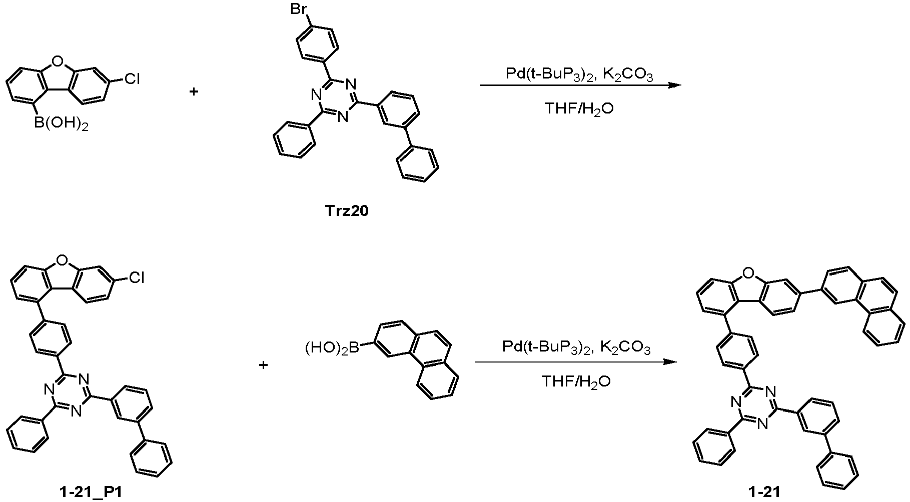

(7-Chlorodibenzo[b,d]furan-1-yl)boronic acid (15 g, 60.9 mmol) and Compound Trz20 (29.7 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.9 g of Compound 1-21_P1. (Yield: 67%, MS: [M+H]⁺= 586)

Compound 1-21_P1 (15 g, 25.6 mmol) and phenanthren-3-ylboronic acid (6 g, 26.9 mmol) were added to 300 ml of THF, and the mixture was stirred and refluxed. Then, potassium carbonate (10.6 g, 76.8 mmol) was dissolved in 32 ml of water and added thereto, and the mixture was sufficiently stirred and then bis(tri-tert-butylphosphine)palladium(0) (0.1 g, 0.3 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.3 g of Compound 1-21. (Yield: 66%, MS: [M+H]⁺= 728)

### Synthesis Example 1-22

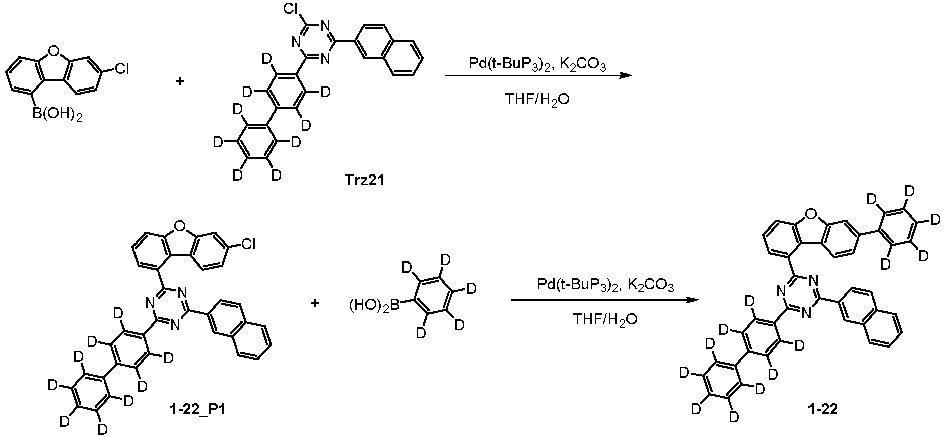

(7-Chlorodibenzo[b,d]furan-1-yl)boronic acid (15 g, 60.9 mmol) and Compound Trz21 (25.8 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 24.6 g of Compound 1-22_P1. (Yield: 71%, MS: [M+H]⁺= 569)

Compound 1-22_P1 (15 g, 26.4 mmol) and (phenyl-d5)boronic acid (3.5 g, 27.7 mmol) were added to 300 ml of THF, and the mixture was stirred and refluxed. Then, potassium carbonate (10.9 g, 79.1 mmol) was dissolved in 33 ml of water and added thereto, and the mixture was sufficiently stirred and then bis(tri-tert-butylphosphine)palladium(0) (0.1 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.7 g of Compound 1-22. (Yield: 72%, MS: [M+H]⁺= 616)

### Synthesis Example 1-23

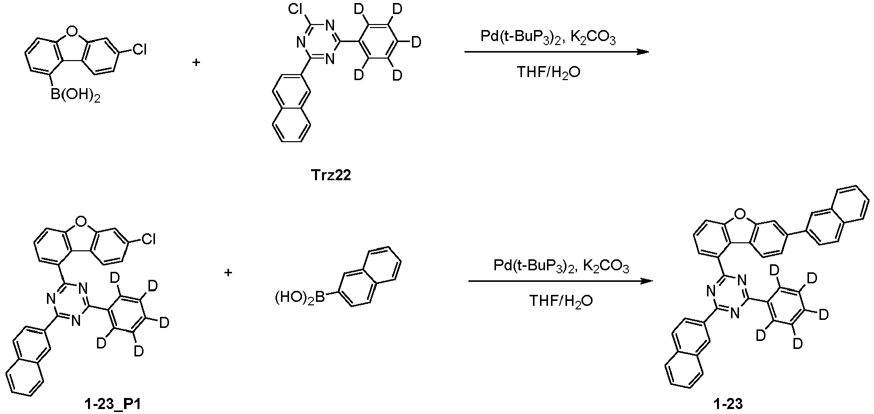

(7-Chlorodibenzo[b,d]furan-1-yl)boronic acid (15 g, 60.9 mmol) and Compound Trz22 (20.6 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20.2 g of Compound 1-23_P1. (Yield: 68%, MS: [M+H]⁺= 489)

Compound 1-23_P1 (15 g, 30.7 mmol) and naphthalen-2-ylboronic acid(5.5 g, 32.2 mmol) were added to 300 ml of THF, and the mixture was stirred and refluxed. Then, potassium carbonate (12.7 g, 92 mmol) was dissolved in 38 ml of water and added thereto, and the mixture was sufficiently stirred and then bis(tri-tert-butylphosphine)palladium(0) (0.2 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.6 g of Compound 1-23. (Yield: 71%, MS: [M+H]⁺= 581)

### Synthesis Example 1-24

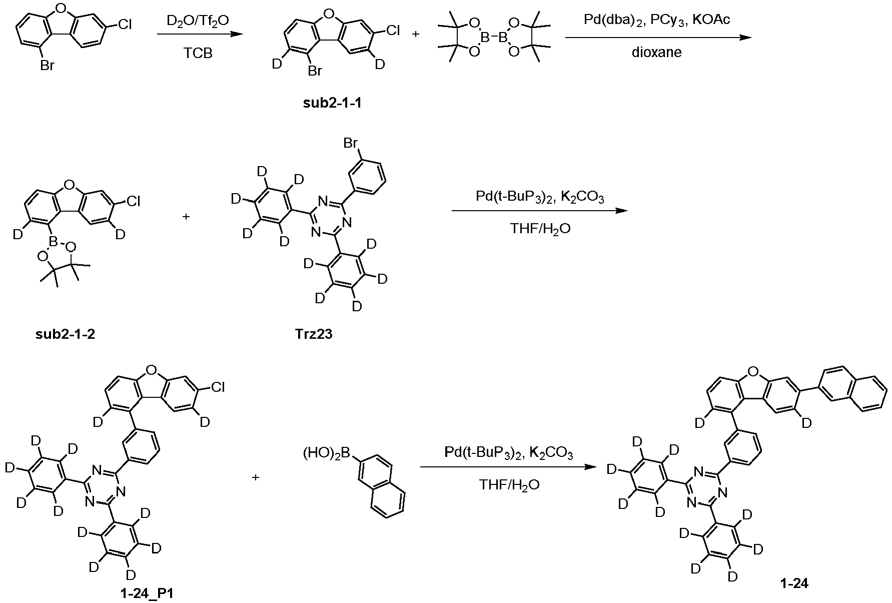

Trifluoromethanesulfonic anhydride (30.1 g, 106.6 mmol) and deuterium oxide (10.7 g, 532.8 mmol) were added at 0°C and stirred for 5 hours to prepare a solution. 1-Bromo-7-chlorodibenzo[b,d]furan(15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-7-chlorodibenzo[b,d]furan and 1,2,4-trichlorobenzene, and the mixture was stirred while heating to 140°C and then keeping that temperature. After the reaction for 3 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6 g of Compound sub2-1-1. (Yield: 40%, MS: [M+H]⁺= 283)

Compound sub2-1-1 (15 g, 52.9 mmol) and bis(pinacolato)diboron (14.8 g, 58.2 mmol) were added to 300ml of 1,4-dioxane, and the mixture was stirred under reflux. Then, potassium acetate (7.8 g, 79.4 mmol) was added thereto, and the mixture was sufficiently stirred and then bis(dibenzylideneacetone)palladium(0) (0.9 g, 1.6 mmol) and tricyclohexylphosphine (0.9 g, 3.2 mmol) were added. After the reaction for 4 hours, the reaction mixture was cooled to room temperature, and the organic layer was separated using chloroform and water, and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.4 g of Compound sub2-1-2. (Yield: 65%, MS: [M+H]+= 331)

Compound sub2-1-2 (15 g, 45.4 mmol) and Compound Trz23 (19 g, 47.6 mmol) were added to 300 ml of THF, and the mixture was stirred and refluxed. Then, potassium carbonate (18.8 g, 136.1 mmol) was dissolved in 56 ml of water and added thereto, and the mixture was sufficiently stirred and then bis(tri-tert-butylphosphine)palladium(0) (0.2 g, 0.5 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 17.3 g of Compound 1-24_P1. (Yield: 73%, MS: [M+H]⁺= 522)

Compound 1-24_P1 (15 g, 28.7 mmol) and naphthalen-2-ylboronic acid (5.2 g, 30.2 mmol) were added to 300 ml of THF, and the mixture was stirred and refluxed. Then, potassium carbonate (11.9 g, 86.2 mmol) was dissolved in 36 ml of water and added thereto, and the mixture was sufficiently stirred and then bis(tri-tert-butylphosphine)palladium(0) (0.1 g, 0.3 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.5 g of Compound 1-24. (Yield: 71%, MS: [M+H]⁺= 614)

### Synthesis Example 1-25

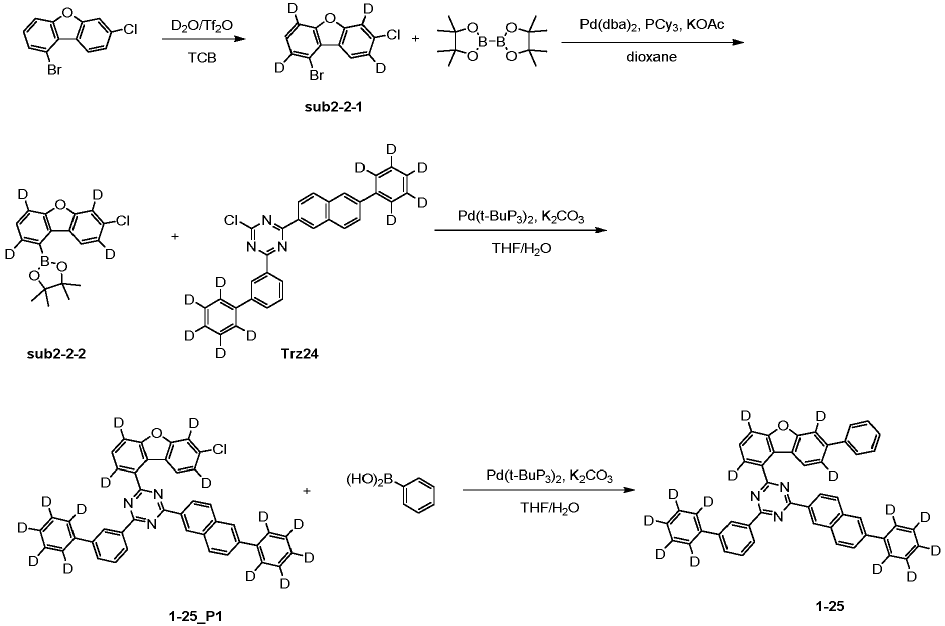

Trifluoromethanesulfonic anhydride (60.1 g, 213.1 mmol) and deuterium oxide (21.4 g, 1065.6 mmol) were added at 0°C and stirred for 5 hours to prepare a solution. 1-Bomo-7-chlorodibenzo[b,d]furan (15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-7-chlorodibenzo[b,d]furan and 1,2,4-trichlorobenzene, and the mixture was stirred while heating to 140°C and then keeping that temperature. After the reaction for 10 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.7 g of Compound sub2-2-1. (Yield: 44%, MS: [M+H]⁺= 285)

Compound sub2-2-1 (15 g, 52.5 mmol) and bis(pinacolato)diboron (14.7 g, 57.8 mmol ) were added to 300ml of 1,4-dioxane, and the mixture was stirred under reflux. Then, potassium acetate (7.7 g, 78.8 mmol) was added thereto, and the mixture was sufficiently stirred and then bis(dibenzylideneacetone)palladium(0) (0.9 g, 1.6 mmol) and tricyclohexylphosphine (0.9 g, 3.2 mmol) were added. After the reaction for 6 hours, the reaction mixture was cooled to room temperature, and the organic layer was separated using chloroform and water, and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.7 g of Compound sub2-2-2. (Yield: 67%, MS: [M+H]⁺= 333)

Compound sub2-2-2 (15 g, 45.1 mmol) and Compound Trz24 (22.7 g, 47.4 mmol) were added to 300 ml of THF, and the mixture was stirred and refluxed. Then, potassium carbonate (18.7 g, 135.3 mmol) was dissolved in 56 ml of water and added thereto, and the mixture was sufficiently stirred and then bis(tri-tert-butylphosphine)palladium(0) (0.2 g, 0.5 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 19.9 g of Compound 1-25_P1. (Yield: 68%, MS: [M+H]⁺= 650)

Compound 1-25_P1 (15 g, 23.1 mmol) and phenylboronic acid (3 g, 24.2 mmol) were added to 300 ml of THF, and the mixture was stirred and refluxed. Then, potassium carbonate (9.6 g, 69.2 mmol) was dissolved in 29 ml of water and added thereto, and the mixture was sufficiently stirred and then bis(tri-tert-butylphosphine)palladium(0) (0.1 g, 0.2 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.6 g of Compound 1-25. (Yield: 73%, MS: [M+H]⁺= 692)

### Synthesis Example 1-26

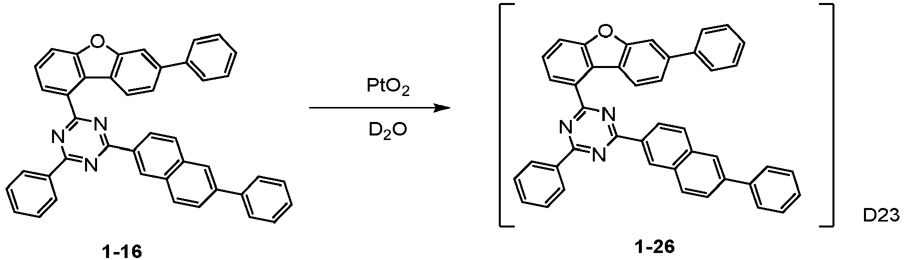

Compound 1-16 (10 g, 16.6 mmol), PtO₂ (1.1 g, 5 mmol) and D₂O (83 ml) were added to a shaker tube, and then the tube was sealed and heated at 250°C and 600 psi for 12 hours. After completion of the reaction, chloroform was added, and the reaction solution was transferred to a separatory funnel, and extracted. The extract was dried over MgSO₄ and concentrated, and then the sample was purified by silica gel column chromatography to prepare 3.1 g of Compound 1-26. (Yield: 30%, MS: [M+H]⁺= 626)

### Synthesis Example 1-27

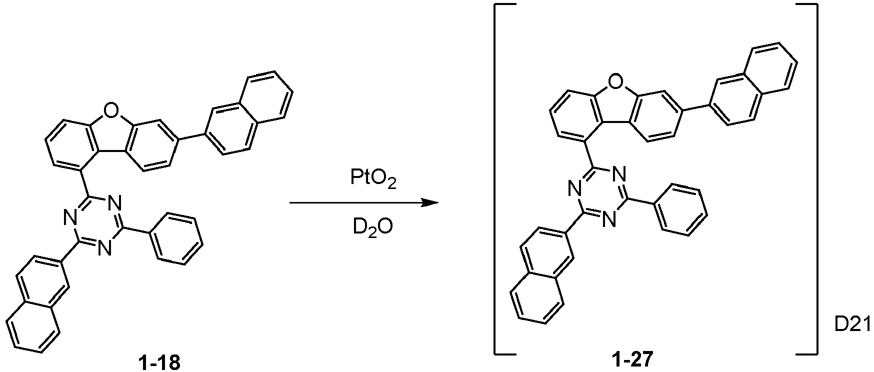

Compound 1-18 (10 g, 17.4 mmol), PtO₂ (1.2 g, 5.2 mmol) and D₂O (87 ml) were added to a shaker tube, and then the tube was sealed and heated at 250°C and 600 psi for 12 hours. After completion of the reaction, chloroform was added, and the reaction solution was transferred to a separatory funnel, and extracted. The extract was dried over MgSO₄ and concentrated, and then the sample was purified by silica gel column chromatography to prepare 3.9 g of Compound 1-27. (Yield: 38%, MS: [M+H]⁺= 598)

### Synthesis Example 1-28

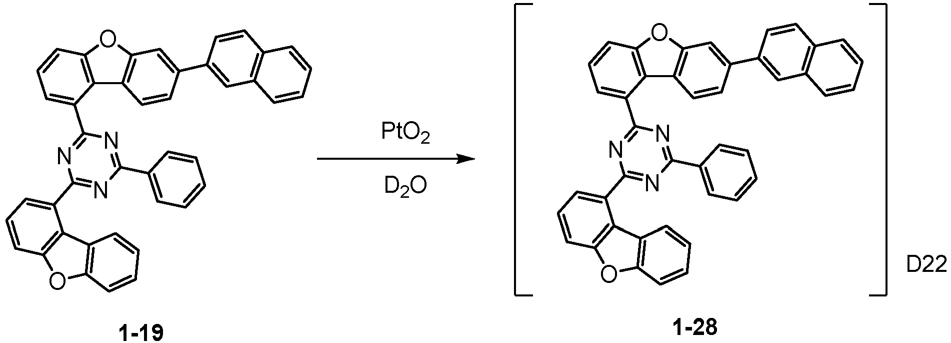

Compound 1-19 (10 g, 16.2 mmol), PtO₂ (1.1 g, 4.9 mmol) and D₂O (81 ml) were added to a shaker tube, and then the tube was sealed and heated at 250°C and 600 psi for 12 hours. After completion of the reaction, chloroform was added, and the reaction solution was transferred to a separatory funnel, and extracted. The extract was dried over MgSO₄ and concentrated, and then the sample was purified by silica gel column chromatography to prepare 4.7 g of Compound 1-28. (Yield: 45%, MS: [M+H]⁺= 639)

### Synthesis Example 1-29

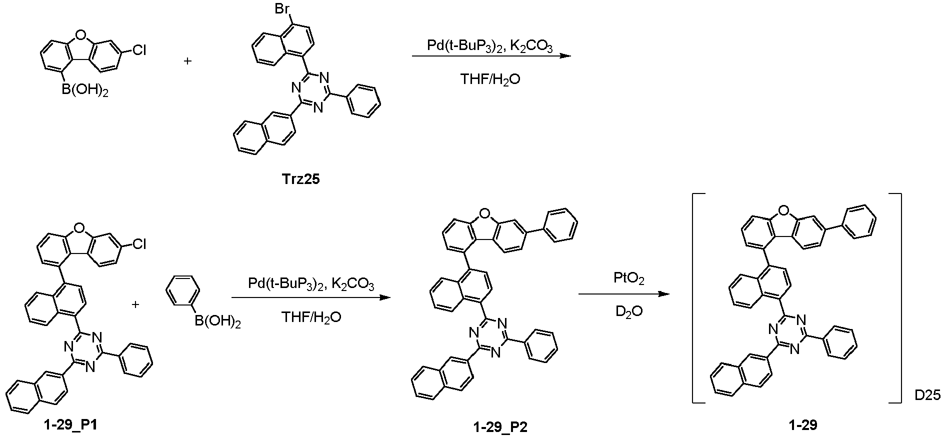

(7-Chlorodibenzo[b,d]furan-1-yl)boronic acid (15 g, 60.9 mmol) and Compound Trz25 (31.2 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 24.5 g of Compound 1-29_P1. (Yield: 66%, MS: [M+H]⁺= 610)

Compound 1-29_P1 (15 g, 24.6 mmol) and phenylboronic acid (3.1 g, 25.8 mmol) were added to 300 ml of THF, and the mixture was stirred and refluxed. Then, potassium carbonate (10.2 g, 73.8 mmol) was dissolved in 31 ml of water and added thereto, and the mixture was sufficiently stirred and then bis(tri-tert-butylphosphine)palladium(0) (0.1 g, 0.2 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.6 g of Compound 1-29_P2. (Yield: 66%, MS: [M+H]⁺= 652)

Compound 1-29_P2 (10 g, 15.3 mmol), PtO₂ (1 g, 4.6 mmol) and D₂O (77 ml) were added to a shaker tube, and then the tube was sealed and heated at 250°C and 600 psi for 12 hours. After completion of the reaction, chloroform was added, and the reaction solution was transferred to a separatory funnel, and extracted. The extract was dried over MgSO₄ and concentrated, and then the sample was purified by silica gel column chromatography to prepare 4.6 g of Compound 1-29. (Yield: 44%, MS: [M+H]⁺= 678)

### Synthesis Example 1-30

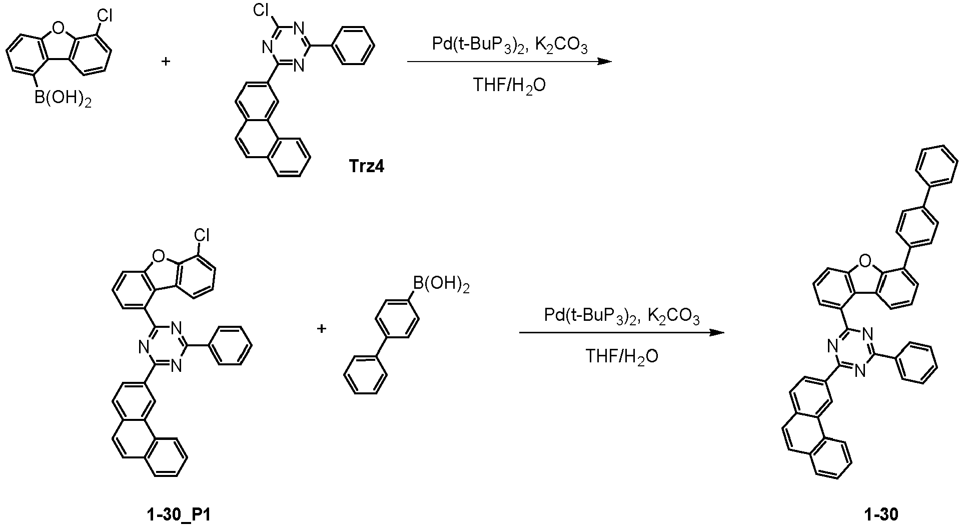

(6-Chlorodibenzo[b,d]furan-1-yl)boronic acid (15 g, 60.9 mmol) and Compound Trz4 (23.5 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.4 g of Compound 1-30_P1. (Yield: 72%, MS: [M+H]⁺= 534)

Compound 1-30_P1 (15 g, 28.1 mmol) and [1,1'-biphenyl]-4-ylboronic acid (5.8 g, 29.5 mmol) were added to 300 ml of THF, and the mixture was stirred and refluxed. Then, potassium carbonate (11.6 g, 84.3 mmol) was dissolved in 35 ml of water and added thereto, and the mixture was sufficiently stirred and then bis(tri-tert-butylphosphine)palladium(0) (0.1 g, 0.3 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.4 g of Compound 1-30. (Yield: 73%, MS: [M+H]⁺= 652)

### Synthesis Example 1-31

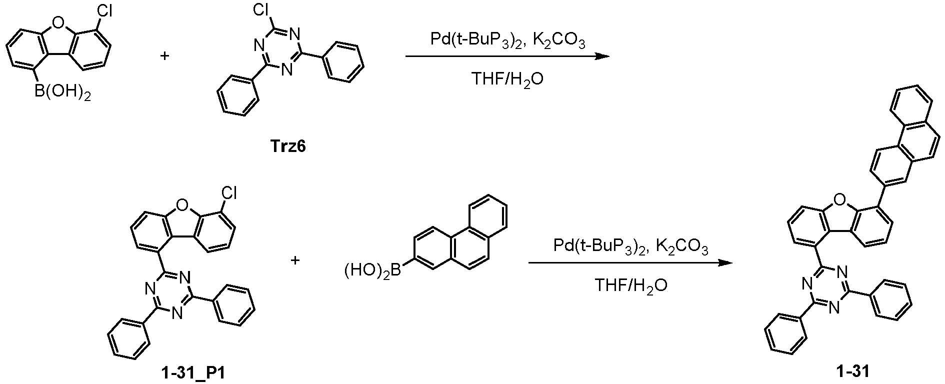

(6-Chlorodibenzo[b,d]furan-1-yl)boronic acid (15 g, 60.9 mmol) and Compound Trz6 (17.1 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 17.4 g of Compound 1-31_P1. (Yield: 66%, MS: [M+H]⁺= 434)

Compound 1-31_P1 (15 g, 34.6 mmol) and phenanthren-2-ylboronic acid (8.1 g, 36.3 mmol) were added to 300 ml of THF, and the mixture was stirred and refluxed. Then, potassium carbonate (14.3 g, 103.7 mmol) was dissolved in 43 ml of water and added thereto, and the mixture was sufficiently stirred and then bis(tri-tert-butylphosphine)palladium(0) (0.2 g, 0.3 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.3g of Compound 1-31. (Yield: 67%, MS: [M+H]⁺= 576)

### Synthesis Example 1-32

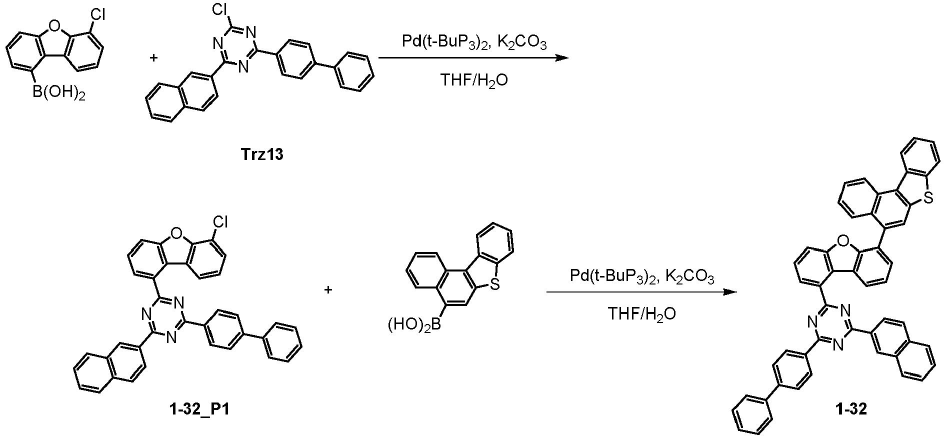

(6-Chlorodibenzo[b,d]furan-1-yl)boronic acid (15 g, 60.9 mmol) and Compound Trz13 (25.2 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 24.8 g of Compound 1-32_P1. (Yield: 73%, MS: [M+H]⁺= 560)

Compound 1-32_P1 (15 g, 26.8 mmol) and benzo[b]naphtho[1,2-d]thiophen-5-ylboronic acid (7.8 g, 28.1 mmol) were added to 300 ml of THF, and the mixture was stirred and refluxed. Then, potassium carbonate (11.1 g, 80.3 mmol) was dissolved in 33 ml of water and added thereto, and the mixture was sufficiently stirred and then bis(tri-tert-butylphosphine)palladium(0) (0.1 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 14.4g of Compound 1-32. (Yield: 71%, MS: [M+H]⁺= 758)

### Synthesis Example 1-33

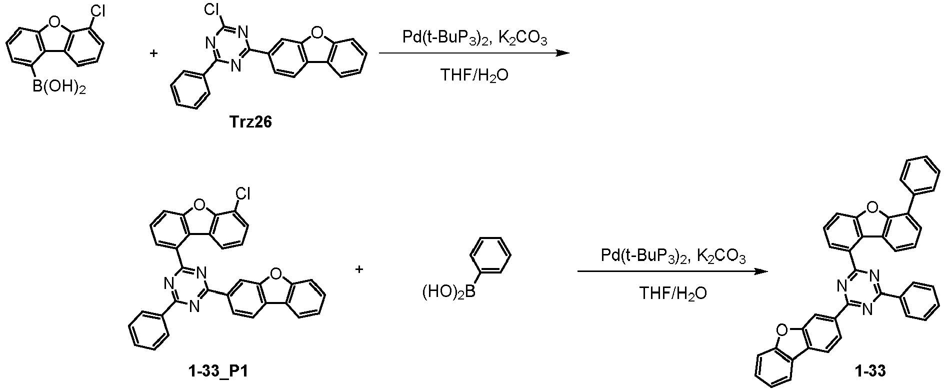

(6-Chlorodibenzo[b,d]furan-1-yl)boronic acid (15 g, 60.9 mmol) and Compound Trz26 (22.9 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21.7 g of Compound 1-33_P1. (Yield: 68%, MS: [M+H]⁺= 524)

Compound 1-33_P1 (15 g, 28.6 mmol) and phenylboronic acid (3.7 g, 30.1 mmol) were added to 300 ml of THF, and the mixture was stirred and refluxed. Then, potassium carbonate (11.9 g, 85.9 mmol) was dissolved in 36 ml of water and added thereto, and the mixture was sufficiently stirred and then bis(tri-tert-butylphosphine)palladium(0) (0.1 g, 0.3 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.8g of Compound 1-33. (Yield: 73%, MS: [M+H]⁺= 566)

### Synthesis Example 1-34

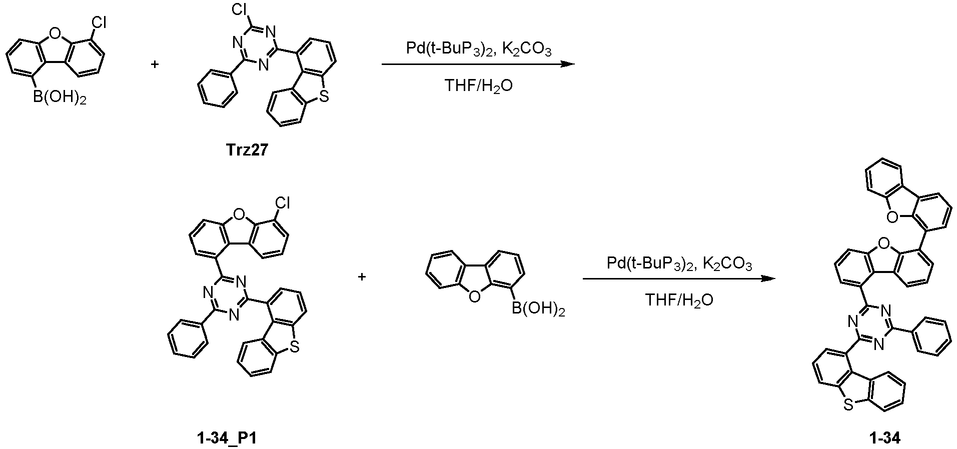

(6-Chlorodibenzo[b,d]furan-1-yl)boronic acid (15 g, 60.9 mmol) and Compound Trz27 (23.9 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 24 g of Compound 1-34_P1. (Yield: 73%, MS: [M+H]⁺= 540)

Compound 1-34_P1 (15 g, 27.8 mmol) and dibenzo[b,d]furan-4-ylboronic acid (6.2 g, 29.2 mmol) were added to 300 ml of THF, and the mixture was stirred and refluxed. Then, potassium carbonate (11.5 g, 83.3 mmol) was dissolved in 35 ml of water and added thereto, and the mixture was sufficiently stirred and then bis(tri-tert-butylphosphine)palladium(0) (0.1 g, 0.3 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.9 g of Compound 1-34. (Yield: 69%, MS: [M+H]⁺= 672)

### Synthesis Example 1-35

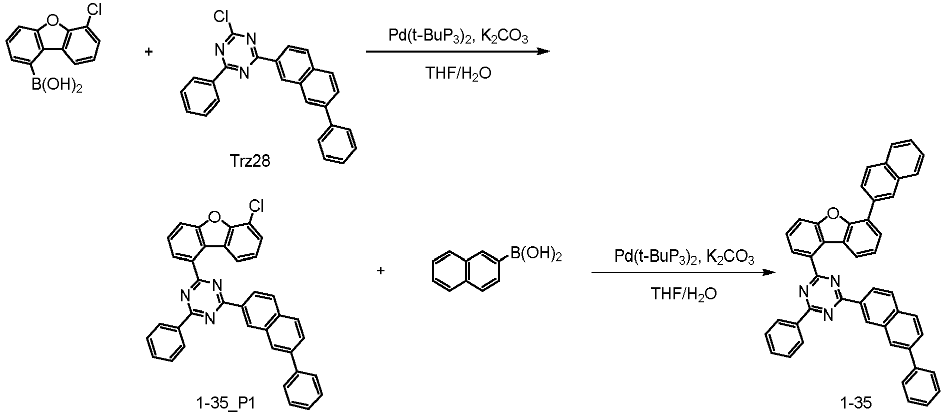

(6-Chlorodibenzo[b,d]furan-1-yl)boronic acid (15 g, 60.9 mmol) and Compound Trz28 (25.2 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.8 g of Compound 1-35_P1. (Yield: 70%, MS: [M+H]⁺= 560)

Compound 1-35_P1 (15 g, 26.8 mmol) and naphthalen-2-ylboronic acid (4.8 g, 28.1 mmol) were added to 300 ml of THF, and the mixture was stirred and refluxed. Then, potassium carbonate (11.1 g, 80.3 mmol) was dissolved in 33 ml of water and added thereto, and the mixture was sufficiently stirred and then bis(tri-tert-butylphosphine)palladium(0) (0.1 g, 0.3 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.9 g of Compound 1-35. (Yield: 74%, MS: [M+H]⁺= 652)

### Synthesis Example 1-36

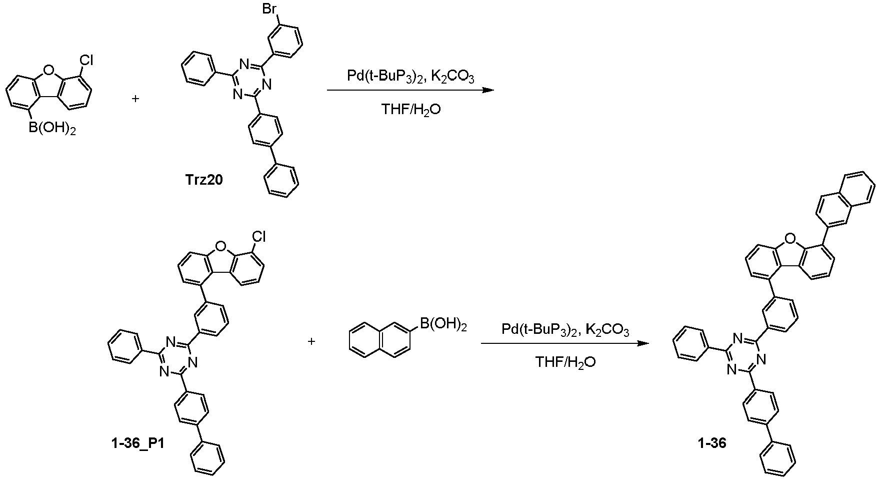

(6-Chlorodibenzo[b,d]furan-1-yl)boronic acid (15 g, 60.9 mmol) and Compound Trz20 (29.7 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.9 g of Compound 1-36_P1. (Yield: 67%, MS: [M+H]⁺= 586)

Compound 1-36_P1 (15 g, 25.6 mmol) and naphthalen-2-ylboronic acid (4.6 g, 26.9 mmol) were added to 300 ml of THF, and the mixture was stirred and refluxed. Then, potassium carbonate (10.6 g, 76.8 mmol) was dissolved in 32 ml of water and added thereto, and the mixture was sufficiently stirred and then bis(tri-tert-butylphosphine)palladium(0) (0.1 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.8 g of Compound 1-36. (Yield: 74%, MS: [M+H]⁺= 678)

### Synthesis Example 1-37

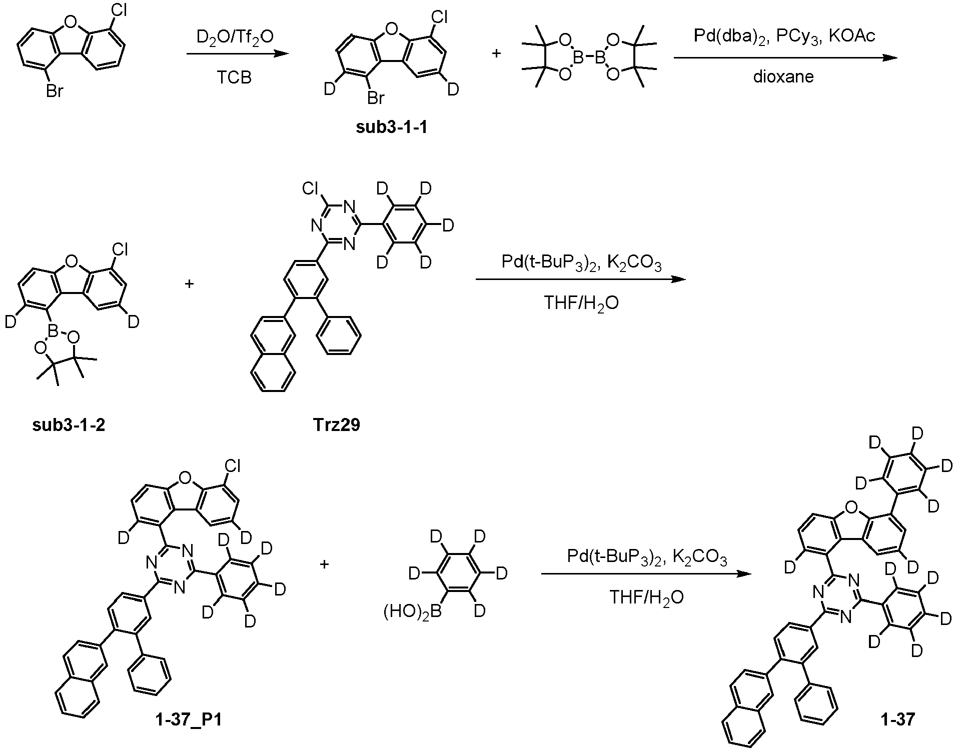

Trifluoromethanesulfonic anhydride (30.1 g, 106.6 mmol) and deuterium oxide (10.7 g, 532.8 mmol) were added at 0°C and stirred for 5 hours to prepare a solution. 1-Bromo-6-chlorodibenzo[b,d]furan (15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-6-chlorodibenzo[b,d]furan and 1,2,4-trichlorobenzene, and the mixture was stirred while heating to 140°C and then keeping that temperature. After the reaction for 3 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.8 g of Compound sub3-1-1. (Yield: 45%, MS: [M+H]⁺= 283)

Compound sub3-1-1 (15 g, 52.9 mmol) and bis(pinacolato)diboron (14.8 g, 58.2 mmol) were added to 300ml of 1,4-dioxane, and the mixture was stirred under reflux. Then, potassium acetate (7.8 g, 79.4 mmol) was added thereto, and the mixture was sufficiently stirred and then bis(dibenzylideneacetone)palladium(0) (0.9 g, 1.6 mmol) and tricyclohexylphosphine (0.9 g, 3.2 mmol) were added. After the reaction for 6 hours, the reaction mixture was cooled to room temperature, and the organic layer was separated using chloroform and water, and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.1 g of Compound sub3-1-2. (Yield: 75%, MS: [M+H]⁺= 331)

Compound sub3-1-2 (15 g, 45.4 mmol) and Compound Trz29 (22.6 g, 47.6 mmol) were added to 300 ml of THF, and the mixture was stirred and refluxed. Then, potassium carbonate (18.8 g, 136.1 mmol) was dissolved in 56 ml of water and added thereto, and the mixture was sufficiently stirred and then bis(tri-tert-butylphosphine)palladium(0) (0.2 g, 0.5 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20.4 g of Compound 1-37_P1. (Yield: 70%, MS: [M+H]⁺= 643)

Compound 1-37_P1 (15 g, 23.3 mmol) and (phenyl-d5)boronic acid (3.1 g, 24.5 mmol) were added to 300 ml of THF, and the mixture was stirred and refluxed. Then, potassium carbonate (9.7 g, 70 mmol) was dissolved in 29 ml of water and added thereto, and the mixture was sufficiently stirred and then bis(tri-tert-butylphosphine)palladium(0) (0.1 g, 0.2 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.7 g of Compound 1-37. (Yield: 73%, MS: [M+H]⁺= 690)

### Synthesis Example 1-38

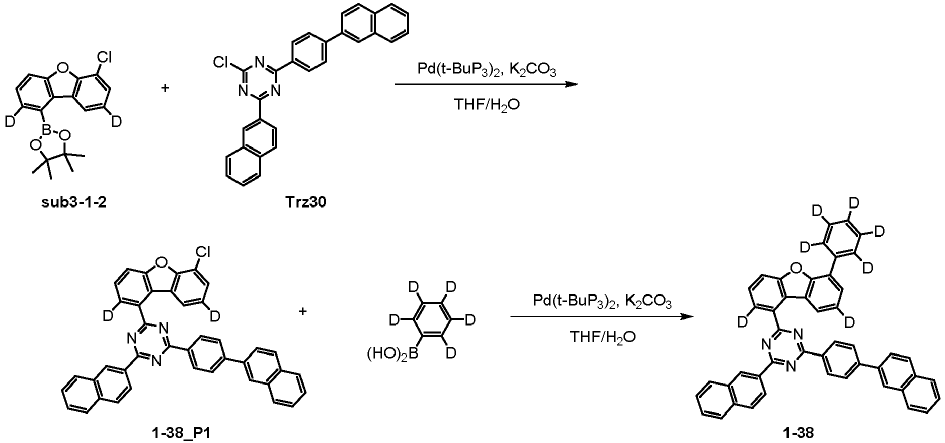

Compound sub3-1-2 (15 g, 45.4 mmol) and Compound Trz30 (21.1 g, 47.6 mmol) were added to 300 ml of THF, and the mixture was stirred and refluxed. Then, potassium carbonate (18.8 g, 136.1 mmol) was dissolved in 56 ml of water and added thereto, and the mixture was sufficiently stirred and then bis(tri-tert-butylphosphine)palladium(0) (0.2 g, 0.5 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 18 g of Compound 1-38_P1. (Yield: 65%, MS: [M+H]⁺= 612)

Compound 1-38_P1 (15 g, 24.5 mmol) and (phenyl-d5)boronic acid (3.3 g, 25.7 mmol) were added to 300 ml of THF, and the mixture was stirred and refluxed. Then, potassium carbonate (10.2 g, 73.5 mmol) was dissolved in 30 ml of water and added thereto, and the mixture was sufficiently stirred and then bis(tri-tert-butylphosphine)palladium(0) (0.1 g, 0.2 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.1 g of Compound 1-38. (Yield: 69%, MS: [M+H]⁺= 659)

### Synthesis Example 1-39

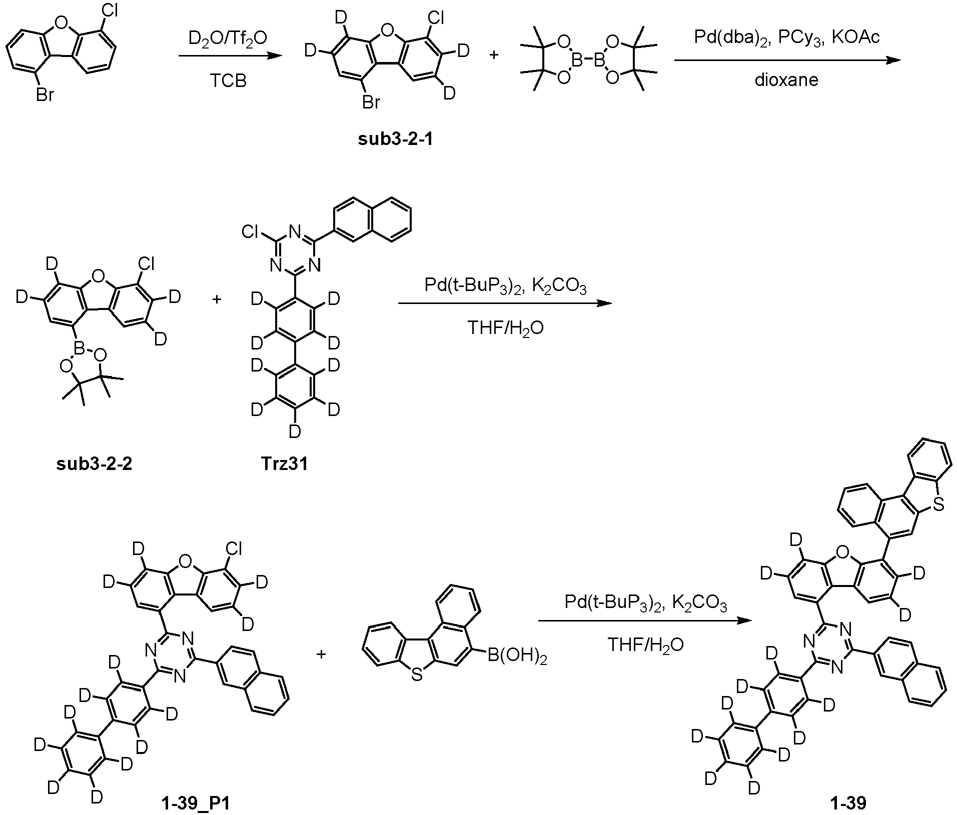

Trifluoromethanesulfonic anhydride (60.1 g, 213.1 mmol) and deuterium oxide (21.4 g, 1065.6 mmol) were added at 0°C and stirred for 5 hours to prepare a solution. 1-Bromo-6-chlorodibenzo[b,d]furan(15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-6-chlorodibenzo[b,d]furan and 1,2,4-trichlorobenzene, and the mixture was stirred while heating to 140°C and then keeping that temperature. After the reaction for 10 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.5 g of Compound sub3-2-1. (Yield: 43%, MS: [M+H]⁺= 285)

Compound sub3-2-1(15 g, 52.5 mmol) and bis(pinacolato)diboron (14.7 g, 57.8 mmol ) were added to 300ml of 1,4-dioxane, and the mixture was stirred under reflux. Then, potassium acetate (7.7 g, 78.8 mmol) was added thereto, and the mixture was sufficiently stirred and then bis(dibenzylideneacetone)palladium(0) (0.9 g, 1.6 mmol) and tricyclohexylphosphine (0.9 g, 3.2 mmol) were added. After the reaction for 5 hours, the reaction mixture was cooled to room temperature, and the organic layer was separated using chloroform and water, and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.1 g of Compound sub3-2-2. (Yield: 75%, MS: [M+H]⁺= 333)

Compound sub3-2-2 (15 g, 45.1 mmol) and Compound Trz31 (19.1 g, 47.4 mmol) were added to 300 ml of THF, and the mixture was stirred and refluxed. Then, potassium carbonate (18.7 g, 135.3 mmol) was dissolved in 56 ml of water and added thereto, and the mixture was sufficiently stirred and then bis(tri-tert-butylphosphine)palladium(0) (0.2 g, 0.5 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 19.1 g of Compound 1-39_P1. (Yield: 74%, MS: [M+H]⁺= 573)

Compound 1-39_P1 (15 g, 26.2 mmol) and benzo[b]naphtho[1,2-d]thiophen-5-ylboronic acid (7.6 g, 27.5 mmol) were added to 300 ml of THF, and the mixture was stirred and refluxed. Then, potassium carbonate (10.9 g, 78.5 mmol) was dissolved in 33 ml of water and added thereto, and the mixture was sufficiently stirred and then bis(tri-tert-butylphosphine)palladium(0) (0.1 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.7 g of Compound 1-39. (Yield: 68%, MS: [M+H]⁺= 771)

### Synthesis Example 1-40

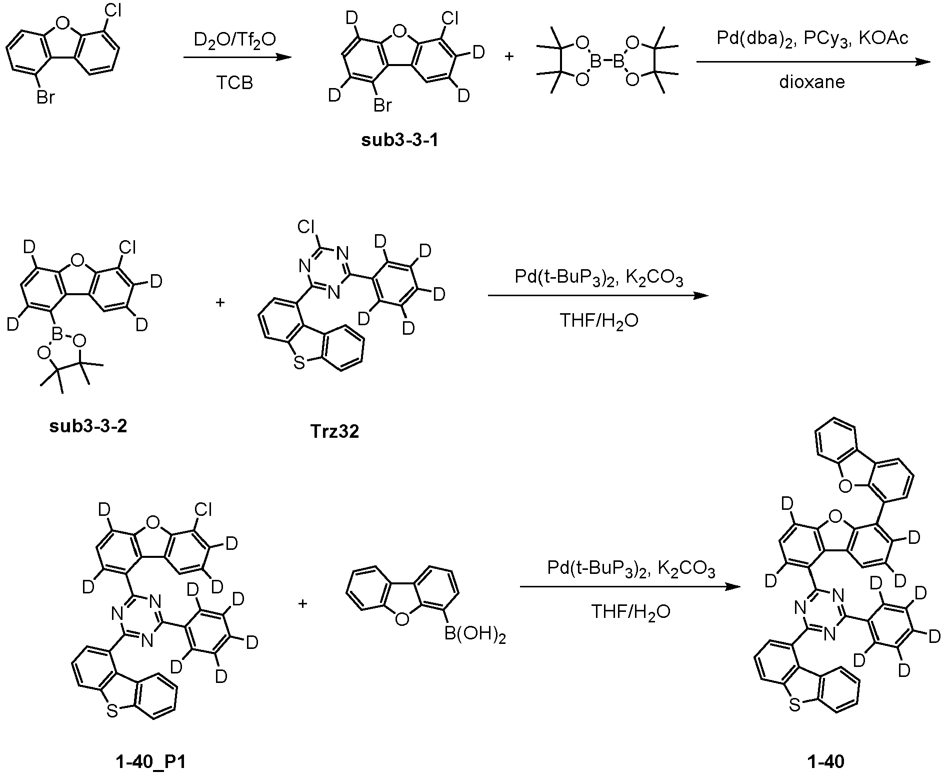

Trifluoromethanesulfonic anhydride (60.1 g, 213.1 mmol) and deuterium oxide (21.4 g, 1065.6 mmol) were added at 0°C and stirred for 5 hours to prepare a solution. 1-Bromo-6-chlorodibenzo[b,d]furan (15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-6-chlorodibenzo[b,d]furan and 1,2,4-trichlorobenzene, and the mixture was stirred while heating to 140°C and then keeping that temperature. After the reaction for 10 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.4 g of Compound sub3-3-1. (Yield: 42%, MS: [M+H]⁺= 285)

Compound sub3-3-1 (15 g, 52.5 mmol) and bis(pinacolato)diboron (14.7 g, 57.8 mmol ) were added to 300ml of 1,4-dioxane, and the mixture was stirred under reflux. Then, potassium acetate (7.7 g, 78.8 mmol) was added thereto, and the mixture was sufficiently stirred and then bis(dibenzylideneacetone)palladium(0) (0.9 g, 1.6 mmol) and tricyclohexylphosphine (0.9 g, 3.2 mmol) were added. After the reaction for 6 hours, the reaction mixture was cooled to room temperature, and the organic layer was separated using chloroform and water, and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.8 g of Compound sub3-3-2. (Yield: 62%, MS: [M+H]⁺= 333)

Compound sub3-3-2 (15 g, 45.1 mmol) and Compound Trz32 (17.9 g, 47.4 mmol) were added to 300 ml of THF, and the mixture was stirred and refluxed. Then, potassium carbonate (18.7 g, 135.3 mmol) was dissolved in 56 ml of water and added thereto, and the mixture was sufficiently stirred and then bis(tri-tert-butylphosphine)palladium(0) (0.2 g, 0.5 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 18 g of Compound 1-40_P1. (Yield: 73%, MS: [M+H]⁺= 549)

Compound 1-40_P1 (15 g, 27.4 mmol) and dibenzo[b,d]furan-4-ylboronic acid (6.1 g, 28.7 mmol) were added to 300 ml of THF, and the mixture was stirred and refluxed. Then, potassium carbonate (11.3 g, 82.1 mmol) was dissolved in 34 ml of water and added thereto, and the mixture was sufficiently stirred and then bis(tri-tert-butylphosphine)palladium(0) (0.1 g, 0.3 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.3 g of Compound 1-40. (Yield: 66%, MS: [M+H]⁺= 681)

### Synthesis Example 1-41

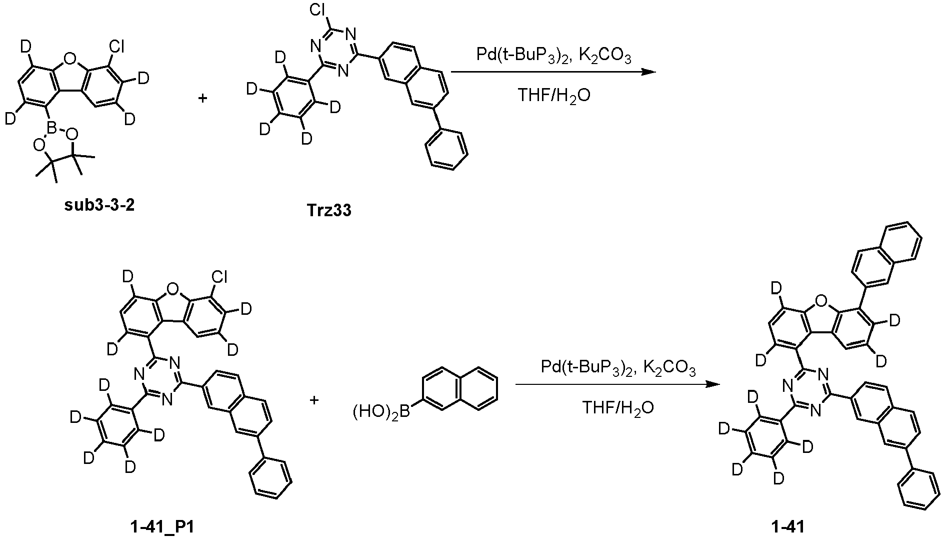

Compound sub3-3-2(15 g, 45.1 mmol) and Compound Trz33 (18.9, 47.4 mmol) were added to 300 ml of THF, and the mixture was stirred and refluxed. Then, potassium carbonate (18.7 g, 135.3 mmol) was dissolved in 56 ml of water and added thereto, and the mixture was sufficiently stirred and then bis(tri-tert-butylphosphine)palladium(0) (0.2 g, 0.5 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 19 g of Compound 1-41_P1. (Yield: 74%, MS: [M+H]⁺= 569)

Compound 1-41_P1 (15 g, 26.4 mmol) and naphthalen-2-ylboronic acid (4.8 g, 27.7 mmol) were added to 300 ml of THF, and the mixture was stirred and refluxed. Then, potassium carbonate (10.9 g, 79.1 mmol) was dissolved in 33 ml of water and added thereto, and the mixture was sufficiently stirred and then bis(tri-tert-butylphosphine)palladium(0) (0.1 g, 0.3 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.5 g of Compound 1-41. (Yield: 72%, MS: [M+H]⁺= 661)

### Synthesis Example 1-42

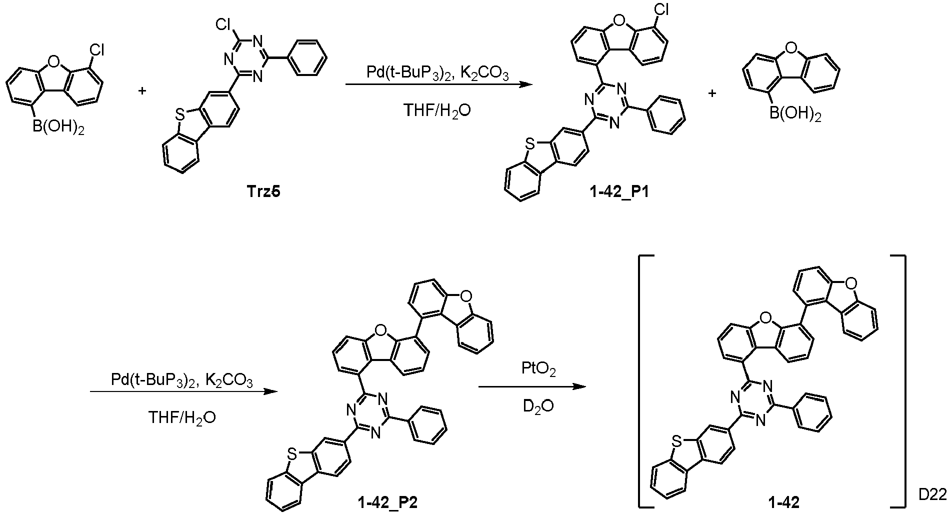

(6-Chlorodibenzo[b,d]furan-1-yl)boronic acid (15 g, 60.9 mmol) and Compound Trz5 (23.9 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.3 g of Compound 1-42_P1. (Yield: 71%, MS: [M+H]⁺= 540)

Compound 1-42_P1 (15 g, 23.3 mmol) and (phenyl-d5)boronic acid (3.1 g, 24.5 mmol) were added to 300 ml of THF, and the mixture was stirred and refluxed. Then, potassium carbonate (9.7 g, 70 mmol) was dissolved in 29 ml of water and added thereto, and the mixture was sufficiently stirred and then bis(tri-tert-butylphosphine)palladium(0) (0.1 g, 0.2 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.3 g of Compound 1-42_P2. (Yield: 70%, MS: [M+H]⁺= 690)

Compound 1-42_P2 (10 g, 14.9 mmol), PtO₂ (1 g, 4.5 mmol) and D₂O (74 ml) were added to a shaker tube, and then the tube was sealed and heated at 250°C and 600 psi for 12 hours. After completion of the reaction, chloroform was added, and the reaction solution was transferred to a separatory funnel, and extracted. The extract was dried over MgSO₄ and concentrated, and then the sample was purified by silica gel column chromatography to prepare 3.8 g of Compound 1-42. (Yield: 37%, MS: [M+H]⁺= 695)

### Synthesis Example 1-43

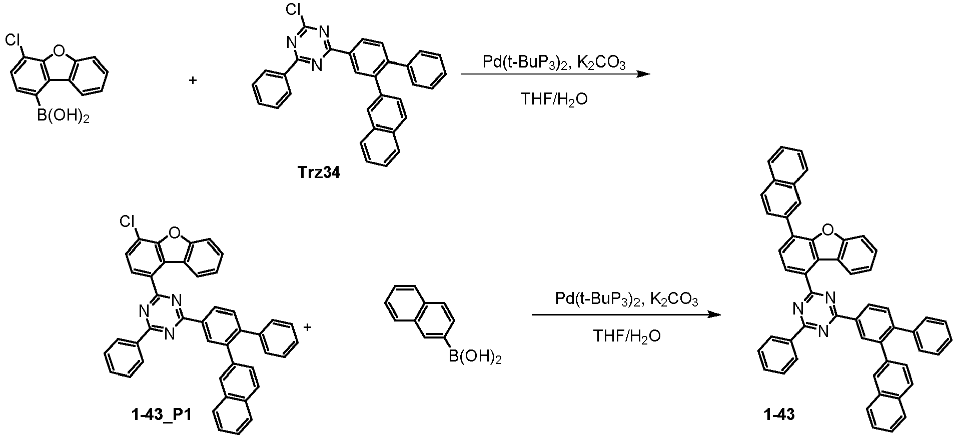

(4-Chlorodibenzo[b,d]furan-1-yl)boronic acid (15 g, 60.9 mmol) and Compound Trz34 (30 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.7 g of Compound 1-43_P1. (Yield: 69%, MS: [M+H]⁺= 636)

Compound 1-43_P1 (15 g, 23.6 mmol) and naphthalen-2-ylboronic acid (4.3 g, 24.8 mmol) were added to 300 ml of THF, and the mixture was stirred and refluxed. Then, potassium carbonate (9.8 g, 70.7 mmol) was dissolved in 29 ml of water and added thereto, and the mixture was sufficiently stirred and then bis(tri-tert-butylphosphine)palladium(0) (0.1 g, 0.2 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.7 g of Compound 1-43. (Yield: 74%, MS: [M+H]⁺= 728)

### Synthesis Example 1-44

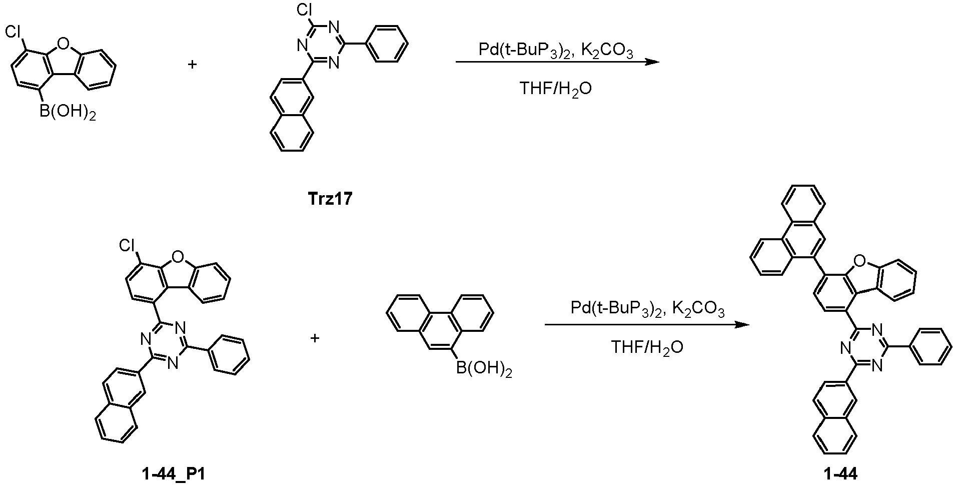

(4-Chlorodibenzo[b,d]furan-1-yl)boronic acid (15 g, 60.9 mmol) and Compound Trz17 (20.3 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 19.1 g of Compound 1-44_P1. (Yield: 65%, MS: [M+H]⁺= 484)

Compound 1-44_P1 (15 g, 31 mmol) and phenanthren-9-ylboronic acid (7.2 g, 32.6 mmol) were added to 300 ml of THF, and the mixture was stirred and refluxed. Then, potassium carbonate (12.9 g, 93.1 mmol) was dissolved in 39 ml of water and added thereto, and the mixture was sufficiently stirred and then bis(tri-tert-butylphosphine)palladium(0) (0.2 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 14.2 g of Compound 1-44. (Yield: 73%, MS: [M+H]⁺= 626)

### Synthesis Example 1-45

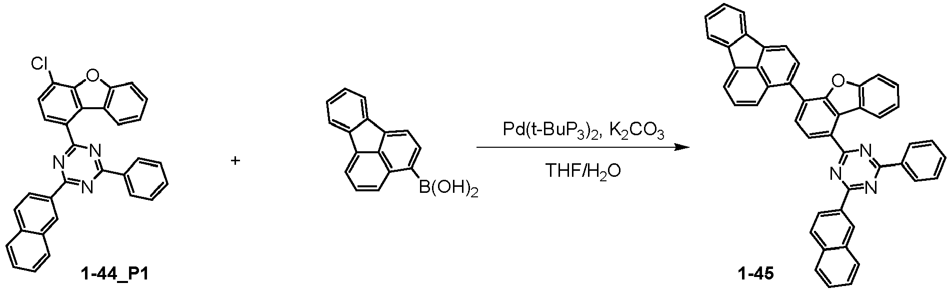

Compound 1-44_P1 (15 g, 31 mmol) and fluoranthen-3-ylboronic acid (8 g, 32.6 mmol ) were added to 300 ml of THF, and the mixture was stirred and refluxed. Then, potassium carbonate (12.9 g, 93.1 mmol) was dissolved in 39 ml of water and added thereto, and the mixture was sufficiently stirred and then bis(tri-tert-butylphosphine)palladium(0) (0.2 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.3 g of Compound 1-45. (Yield: 66%, MS: [M+H]⁺= 650)

### Synthesis Example 1-46

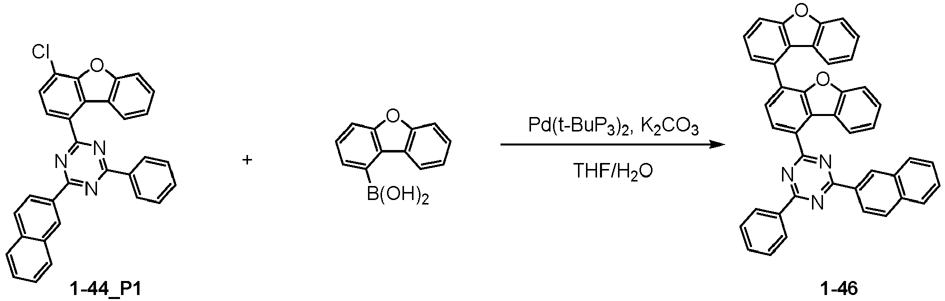

Compound 1-44_P1 (15 g, 31 mmol) and dibenzo[b,d]furan-1-ylboronic acid (6.9 g, 32.6 mmol) were added to 300 ml of THF, and the mixture was stirred and refluxed. Then, potassium carbonate (12.9 g, 93.1 mmol) was dissolved in 39 ml of water and added thereto, and the mixture was sufficiently stirred and then bis(tri-tert-butylphosphine)palladium(0) (0.2 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.8 g of Compound 1-46. (Yield: 72%, MS: [M+H]+= 616)

### Synthesis Example 1-47

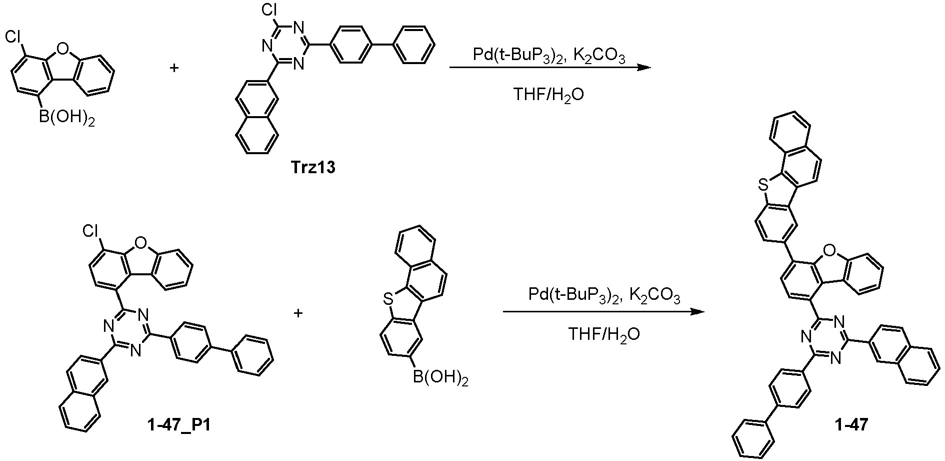

(4-Chlorodibenzo[b,d]furan-1-yl)boronic acid (15 g, 60.9 mmol) and Compound Trz13 (25.2 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 25.5 g of Compound 1-47_P1. (Yield: 75%, MS: [M+H]⁺= 560)

Compound 1-47_P1 (15 g, 26.8 mmol) and benzo[b]naphtho[2,1-d]thiophen-8-ylboronic acid (7.8 g, 28.1 mmol) were added to 300 ml of THF, and the mixture was stirred and refluxed. Then, potassium carbonate (11.1 g, 80.3 mmol) was dissolved in 33 ml of water and added thereto, and the mixture was sufficiently stirred and then bis(tri-tert-butylphosphine)palladium(0) (0.1 g, 0.3 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.4 g of Compound 1-47. (Yield: 66%, MS: [M+H]⁺= 758)

### Synthesis Example 1-48

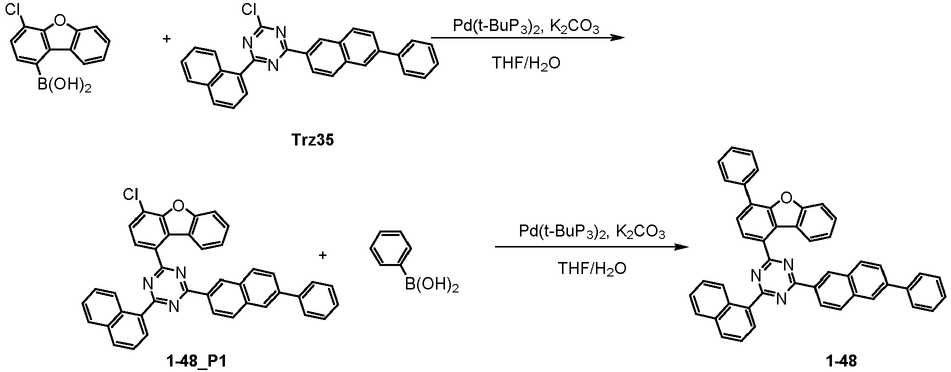

(4-Chlorodibenzo[b,d]furan-1-yl)boronic acid (15 g, 60.9 mmol) and Compound Trz35 (28.4 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 27.4 g of Compound 1-48_P1. (Yield: 74%, MS: [M+H]⁺= 610)

Compound 1-48_P1 (15 g, 24.6 mmol) and phenylboronic acid (3.1 g, 25.8 mmol) were added to 300 ml of THF, and the mixture was stirred and refluxed. Then, potassium carbonate (10.2 g, 73.8 mmol) was dissolved in 31 ml of water and added thereto, and the mixture was sufficiently stirred and then bis(tri-tert-butylphosphine)palladium(0) (0.1 g, 0.2 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.6 g of Compound 1-48. (Yield: 66%, MS: [M+H]⁺= 652)

### Synthesis Example 1-49

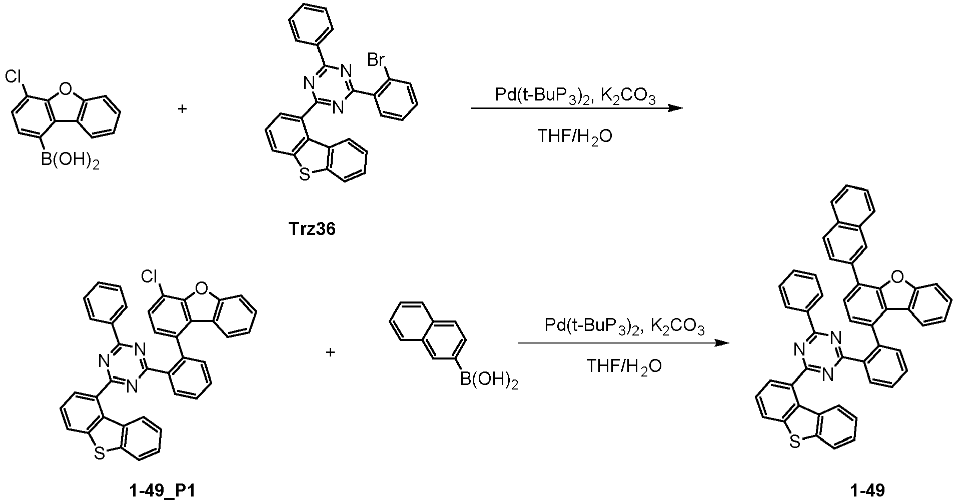

(4-Chlorodibenzo[b,d]furan-1-yl)boronic acid (15 g, 60.9 mmol) and Compound Trz36 (31.6 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 27.7 g of Compound 1-49_P1. (Yield: 74%, MS: [M+H]⁺= 616)

Compound 1-49_P1 (15 g, 24.3 mmol) and naphthalen-2-ylboronic acid (4.4 g, 25.6 mmol) were added to 300 ml of THF, and the mixture was stirred and refluxed. Then, potassium carbonate (10.1 g, 73 mmol) was dissolved in 30 ml of water and added thereto, and the mixture was sufficiently stirred and then bis(tri-tert-butylphosphine)palladium(0) (0.1 g, 0.2 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.4 g of Compound 1-49. (Yield: 72%, MS: [M+H]⁺= 708)

### Synthesis Example 1-50

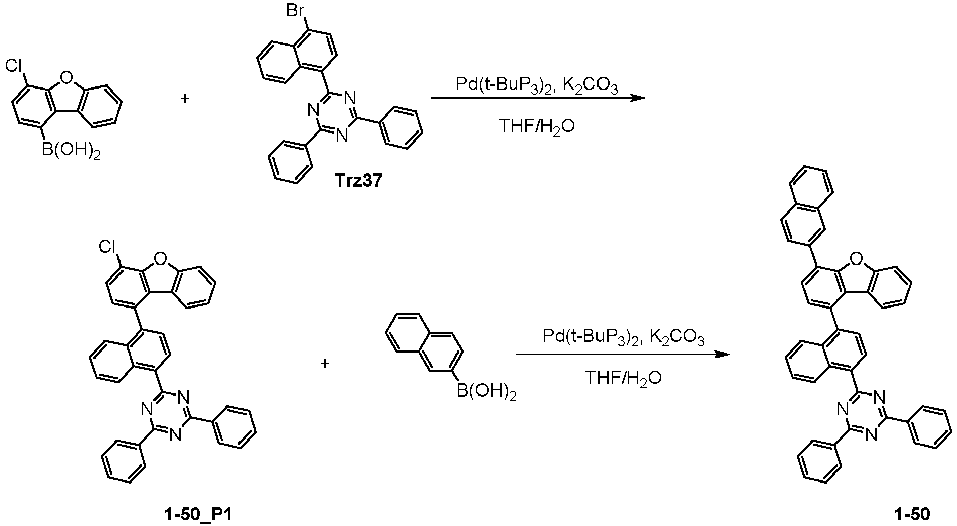

(4-Chlorodibenzo[b,d]furan-1-yl)boronic acid (15 g, 60.9 mmol) and Compound Trz37 (28 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 24.2 g of Compound 1-50_P1. (Yield: 71%, MS: [M+H]⁺= 560)

Compound 1-50_P1 (15 g, 26.8 mmol) and naphthalen-2-ylboronic acid (4.8 g, 28.1 mmol) were added to 300 ml of THF, and the mixture was stirred and refluxed. Then, potassium carbonate (11.1 g, 80.3 mmol) was dissolved in 33 ml of water and added thereto, and the mixture was sufficiently stirred and then bis(tri-tert-butylphosphine)palladium(0) (0.1 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.5 g of Compound 1-50. (Yield: 66%, MS: [M+H]⁺= 652)

### Synthesis Example 1-51

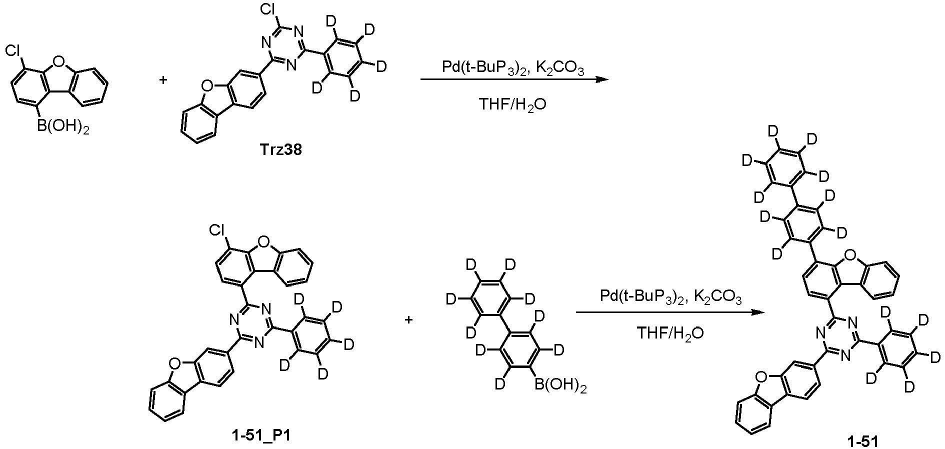

(4-Chlorodibenzo[b,d]furan-1-yl)boronic acid (15 g, 60.9 mmol) and Compound Trz38 (23.2 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21.5 g of Compound 1-51_P1. (Yield: 67%, MS: [M+H]⁺= 529)

Compound 1-51_P1 (15 g, 28.4 mmol) and ([1,1'-biphenyl]-4-yl-d9)boronic acid (6.2 g, 29.8 mmol) were added to 300 ml of THF, and the mixture was stirred and refluxed. Then, potassium carbonate (11.8 g, 85.1 mmol) was dissolved in 35 ml of water and added thereto, and the mixture was sufficiently stirred and then bis(tri-tert-butylphosphine)palladium(0) (0.1 g, 0.3 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.3 g of Compound 1-51. (Yield: 66%, MS: [M+H]⁺= 656)

### Synthesis Example 1-52

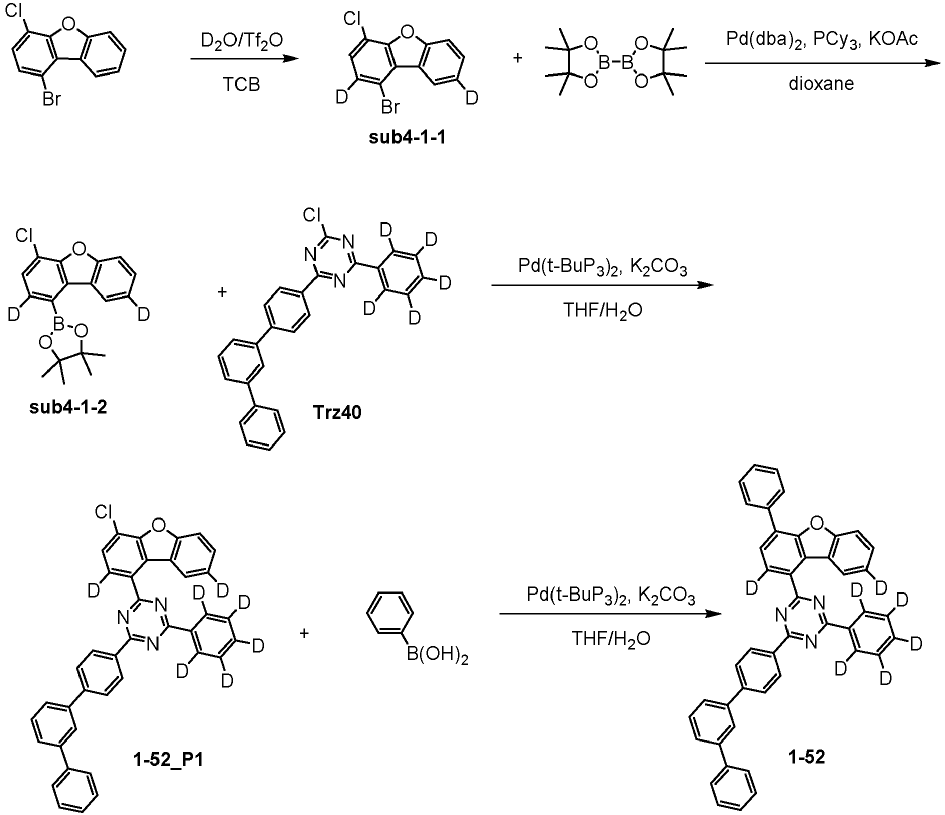

Trifluoromethanesulfonic anhydride (30.1 g, 106.6 mmol) and deuterium oxide (10.7 g, 532.8 mmol) were added at 0°C and stirred for 5 hours to prepare a solution. 1 -Bromo~4-chlorodibenzo[b,d]furan(15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-4-chlorodibenzo[b,d]furan and 1,2,4-trichlorobenzene, and the mixture was stirred while heating to 140°C and then keeping that temperature. After the reaction for 3 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.5 g of Compound sub4-1-1. (Yield: 43%, MS: [M+H]⁺= 283)

Compound sub4-1-1 (15 g, 52.9 mmol) and bis(pinacolato)diboron (14.8 g, 58.2 mmol) were added to 300ml of 1,4-dioxane, and the mixture was stirred under reflux. Then, potassium acetate (7.8 g, 79.4 mmol) was added thereto, and the mixture was sufficiently stirred and then bis(dibenzylideneacetone)palladium(0) (0.9 g, 1.6 mmol) and tricyclohexylphosphine (0.9 g, 3.2 mmol) were added. After the reaction for 6 hours, the reaction mixture was cooled to room temperature, and the organic layer was separated using chloroform and water, and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.8 g of Compound sub4-1-2. (Yield: 62%, MS: [M+H]⁺= 331)

Compound sub4-1-2 (15 g, 45.4 mmol) and Compound Trz40 (20.2 g, 47.6 mmol) were added to 300 ml of THF, and the mixture was stirred and refluxed. Then, potassium carbonate (18.8 g, 136.1 mmol) was dissolved in 56 ml of water and added thereto, and the mixture was sufficiently stirred and then bis(tri-tert-butylphosphine)palladium(0) (0.2 g, 0.5 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 19.9 g of Compound 1-52_P1. (Yield: 74%, MS: [M+H]⁺= 594)

Compound 1-52_P1 (15 g, 25.3 mmol) and phenylboronic acid(3.2 g, 26.6 mmol) were added to 300 ml of THF, and the mixture was stirred and refluxed. Then, potassium carbonate (10.5 g, 75.9 mmol) was dissolved in 31 ml of water and added thereto, and the mixture was sufficiently stirred and then bis(tri-tert-butylphosphine)palladium(0) (0.1 g, 0.3 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.7 g of Compound 1-52. (Yield: 73%, MS: [M+H]⁺= 635)

### Synthesis Example 1-53

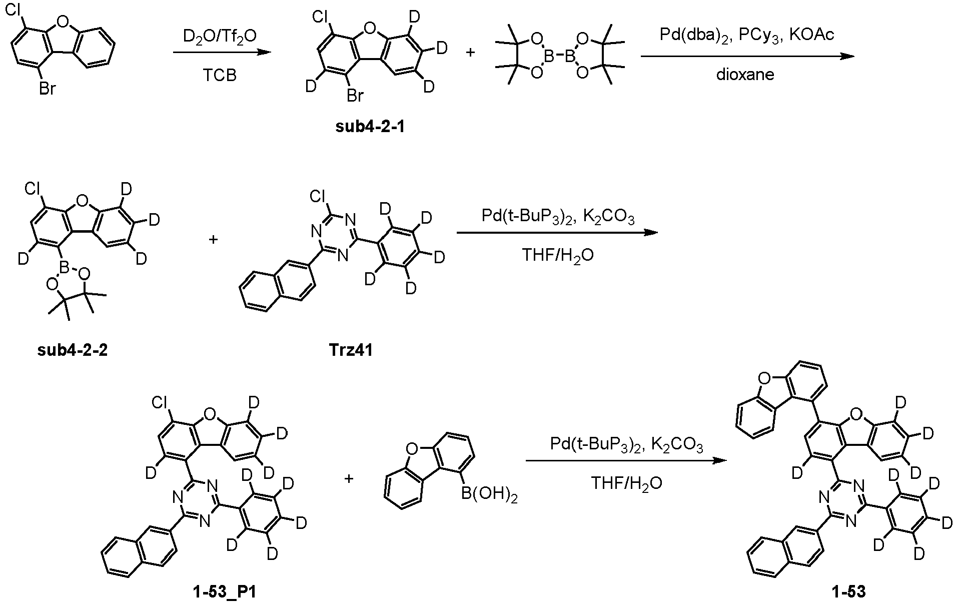

Trifluoromethanesulfonic anhydride (60.1 g, 213.1 mmol) and deuterium oxide (21.4 g, 1065.6 mmol) were added at 0°C and stirred for 5 hours to prepare a solution. 1-Bromo-4-chlorodibenzo[b,d]furan(15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-4-chlorodibenzo[b,d]furan and 1,2,4-trichlorobenzene, and the mixture was stirred while heating to 140°C and then keeping that temperature. After the reaction for 10 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 5.3 g of Compound sub4-2-1. (Yield: 35%, MS: [M+H]⁺= 285)

Compound sub4-2-1 (15 g, 52.5 mmol) and bis(pinacolato)diboron (14.7 g, 57.8 mmol) were added to 300ml of 1,4-dioxane, and the mixture was stirred under reflux. Then, potassium acetate (7.7 g, 78.8 mmol) was added thereto, and the mixture was sufficiently stirred and then bis(dibenzylideneacetone)palladium(0) (0.9 g, 1.6 mmol) and tricyclohexylphosphine (0.9 g, 3.2 mmol) were added. After the reaction for 6 hours, the reaction mixture was cooled to room temperature, and the organic layer was separated using chloroform and water, and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11 g of Compound sub4-2-2. (Yield: 63%, MS: [M+H]⁺= 333)

Compound sub4-2-2 (15 g, 45.1 mmol) and Compound Trz42 (21.2 g 47.4 mmol) were added to 300 ml of THF, and the mixture was stirred and refluxed. Then, potassium carbonate (18.7 g, 135.3 mmol) was dissolved in 56 ml of water and added thereto, and the mixture was sufficiently stirred and then bis(tri-tert-butylphosphine)palladium(0) (0.2 g, 0.5 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 18.1 g of Compound 1-54_P1. (Yield: 70%, MS: [M+H]⁺= 574)

Compound sub4-2-2 (15 g, 45.1 mmol) and Compound Trz41 (15.8 g 47.4 mmol) were added to 300 ml of THF, and the mixture was stirred and refluxed. Then, potassium carbonate (18.7 g, 135.3 mmol) was dissolved in 56 ml of water and added thereto, and the mixture was sufficiently stirred and then bis(tri-tert-butylphosphine)palladium(0) (0.2 g, 0.5 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 16.6 g of Compound 1-53_P1. (Yield: 75%, MS: [M+H]⁺= 493)

Compound 1-53_P1 (15 g, 30.4 mmol) and dibenzo[b,d]furan-1-ylboronic acid (6.8 g, 31.9 mmol ) were added to 300 ml of THF, and the mixture was stirred and refluxed. Then, potassium carbonate (12.6 g, 91.3 mmol) was dissolved in 38 ml of water and added thereto, and the mixture was sufficiently stirred and then bis(tri-tert-butylphosphine)palladium(0) (0.2 g, 0.3 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.1 g of Compound 1-53. (Yield: 69%, MS: [M+H]⁺= 625)

### Synthesis Example 1-54

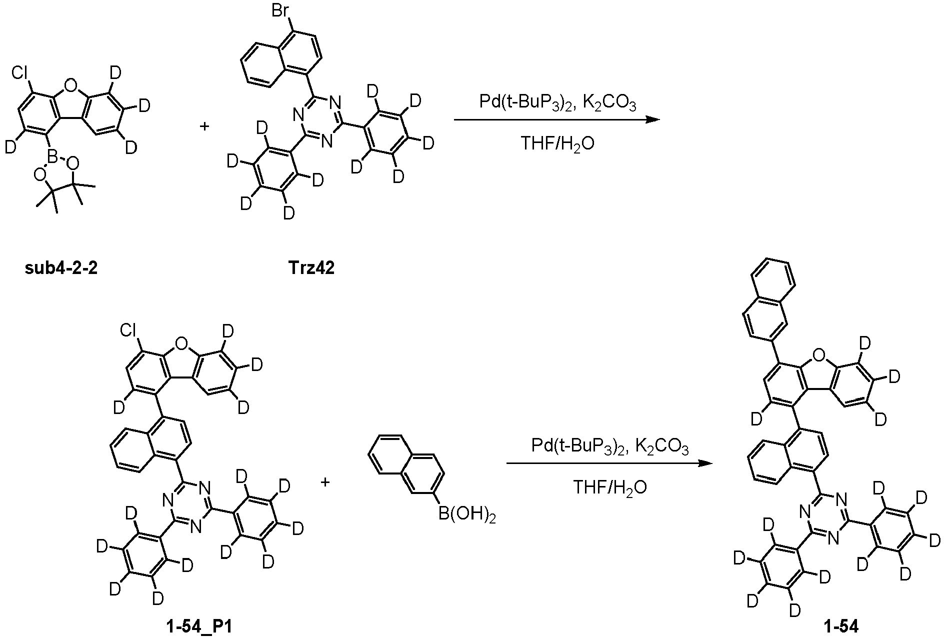

Compound sub4-2-2 (15 g, 45.1 mmol) and Compound Trz42 (21.2 g , 47.4 mmol) were added to 300 ml of THF, and the mixture was stirred and refluxed. Then, potassium carbonate (18.7 g, 135.3 mmol) was dissolved in 56 ml of water and added thereto, and the mixture was sufficiently stirred and then bis(tri-tert-butylphosphine)palladium(0) (0.2 g, 0.5 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 18.4 g of Compound 1-54_P1. (Yield: 71%, MS: [M+H]⁺= 574)

Compound 1-54_P1 (15 g, 26.1 mmol) and naphthalen-2-ylboronic acid (4.7 g, 27.4 mmol ) were added to 300 ml of THF, and the mixture was stirred and refluxed. Then, potassium carbonate (10.8 g, 78.4 mmol) was dissolved in 32 ml of water and added thereto, and the mixture was sufficiently stirred and then bis(tri-tert-butylphosphine)palladium(0) (0.1 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.6 g of Compound 1-54. (Yield: 67%, MS: [M+H]⁺= 666)

### Synthesis Example 1-55

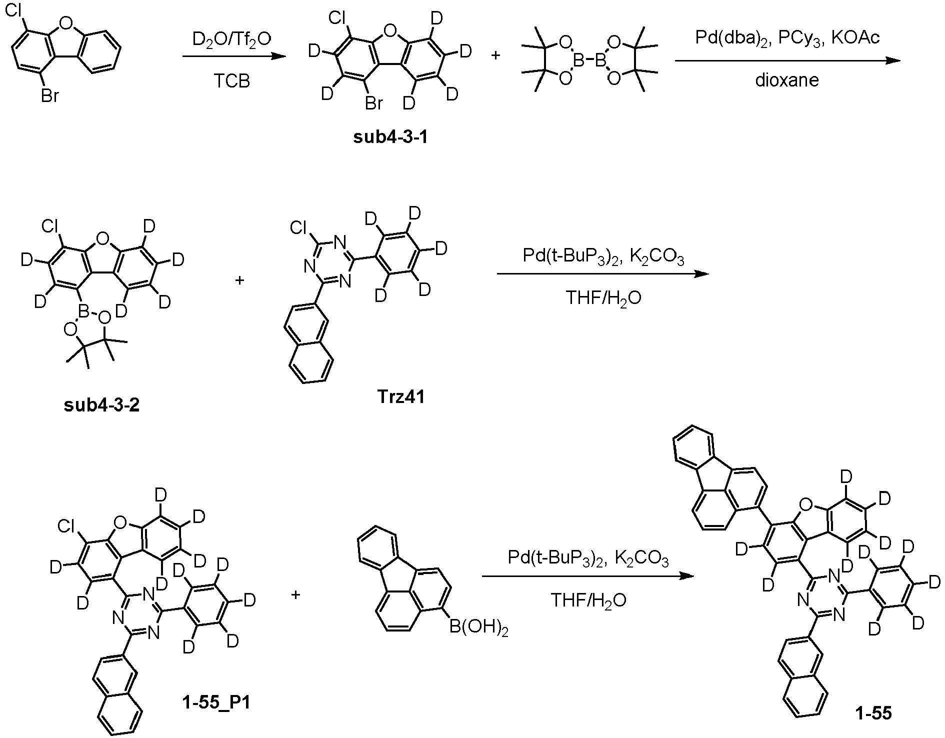

Trifluoromethanesulfonic anhydride (90.2 g, 319.7 mmol) and deuterium oxide (32 g, 1598.4 mmol) were added at 0°C and stirred for 5 hours to prepare a solution. 1-Bromo-4-chlorodibenzo[b,d]furan (15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-4-chlorodibenzo[b,d]furan and 1,2,4-trichlorobenzene, and the mixture was stirred while heating to 140°C and then keeping that temperature. After the reaction for 18 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 5.8 g of Compound sub4-3-1. (Yield: 38%, MS: [M+H]⁺= 287)

Compound sub4-3-1 (15 g, 52.2 mmol) and bis(pinacolato)diboron (14.6 g, 57.4 mmol ) were added to 300ml of 1,4-dioxane, and the mixture was stirred under reflux. Then, potassium acetate (7.7 g, 78.2 mmol) was added thereto, and the mixture was sufficiently stirred and then bis(dibenzylideneacetone)palladium(0) (0.9 g, 1.6 mmol) and tricyclohexylphosphine (0.9 g, 3.1 mmol) were added. After the reaction for 6 hours, the reaction mixture was cooled to room temperature, and the organic layer was separated using chloroform and water, and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.9 g of Compound sub4-3-2. (Yield: 74%, MS: [M+H]⁺= 335)

Compound sub4-3-2 (15 g, 44.8 mmol) and Compound Trz41 (15.7 g, 47.1 mmol) were added to 300 ml of THF, and the mixture was stirred and refluxed. Then, potassium carbonate (18.6 g, 134.5 mmol) was dissolved in 56 ml of water and added thereto, and the mixture was sufficiently stirred and then bis(tri-tert-butylphosphine)palladium(0) (0.2 g, 0.4 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 16.2 g of Compound 1-55_P1. (Yield: 73%, MS: [M+H]⁺= 495)

Compound 1-55_P1 (15 g, 30.3 mmol) and fluoranthen-3-ylboronic acid (7.8 g, 31.8 mmol) were added to 300 ml of THF, and the mixture was stirred and refluxed. Then, potassium carbonate (12.6 g, 90.9 mmol) was dissolved in 38 ml of water and added thereto, and the mixture was sufficiently stirred and then bis(tri-tert-butylphosphine)palladium(0) (0.2 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 15 g of Compound 1-55. (Yield: 75%, MS: [M+H]⁺= 661)

### Synthesis Example 1-56

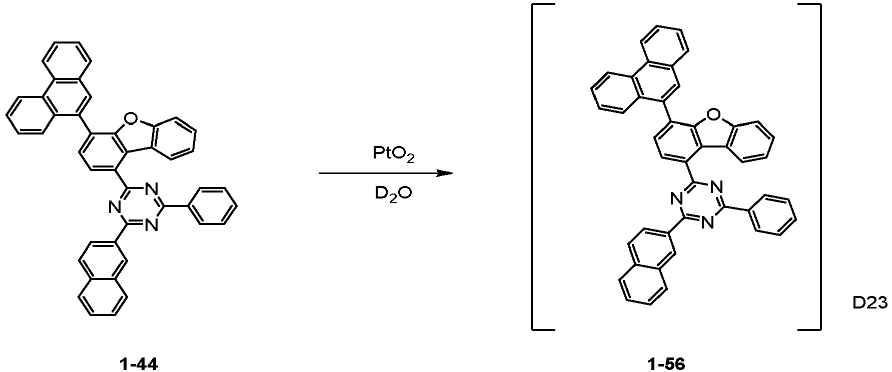

Compound 1-44 (10 g, 16 mmol), PtO₂ (1.1 g, 4.8 mmol) and D₂O (80 ml) were added to a shaker tube, and then the tube was sealed and heated at 250°C and 600 psi for 12 hours. After completion of the reaction, chloroform was added, and the reaction solution was transferred to a separatory funnel, and extracted. The extract was dried over MgSO₄ and concentrated, and then the sample was purified by silica gel column chromatography to prepare 3.9 g of Compound 1-56. (Yield: 38%, MS: [M+H]⁺= 650)

### Synthesis Example 1-57

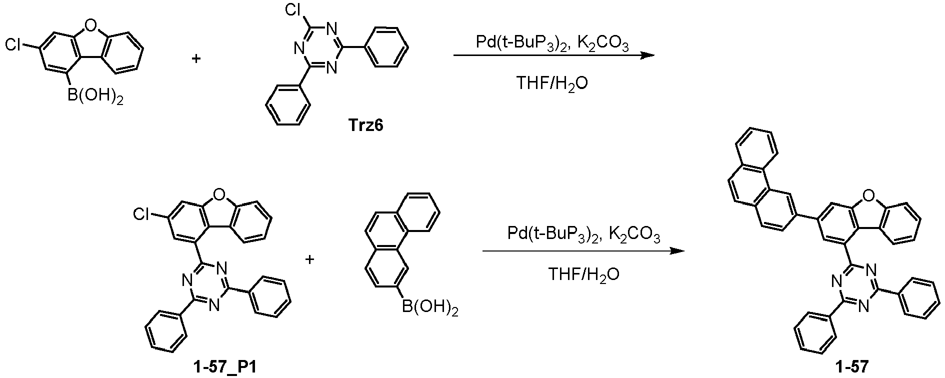

(3-Chlorodibenzo[b,d]furan-1-yl)boronic acid (15 g, 60.9 mmol) and Compound Trz6 (17.1 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 19 g of Compound 1-57_P1 . (Yield: 72%, MS: [M+H]⁺= 434)

Compound 1-57_P1 (15 g, 34.6 mmol) and phenanthren-3-ylboronic acid (8.1 g, 36.3 mmol) were added to 300 ml of THF, and the mixture was stirred and refluxed. Then, potassium carbonate (14.3 g, 103.7 mmol) was dissolved in 43 ml of water and added thereto, and the mixture was sufficiently stirred and then bis(tri-tert-butylphosphine)palladium(0) (0.2 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 14.1 g of Compound 1-57. (Yield: 71%, MS: [M+H]⁺= 576)

### Synthesis Example 1-58

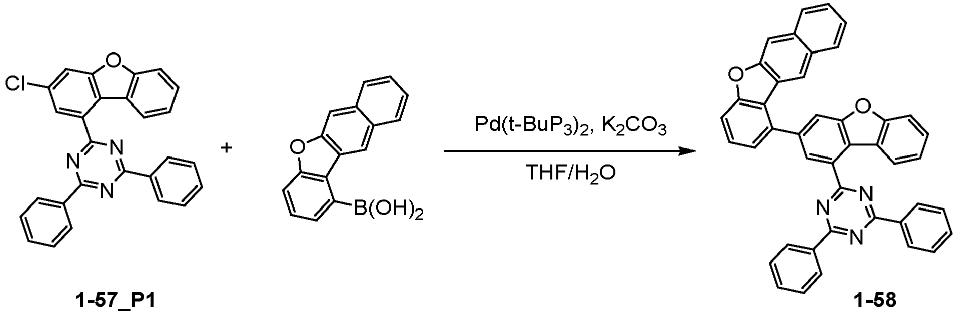

Compound 1-57_P1 (15 g, 34.6 mmol) and naphtho[2,3-b]benzofuran-1-ylboronic acid (9.5 g, 36.3 mmol) were added to 300 ml of THF, and the mixture was stirred and refluxed. Then, potassium carbonate (14.3 g, 103.7 mmol) was dissolved in 43 ml of water and added thereto, and the mixture was sufficiently stirred and then bis(tri-tert-butylphosphine)palladium(0) (0.2 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 16 g of Compound 1-58. (Yield: 75%, MS: [M+H]⁺= 616)

### Synthesis Example 1-59

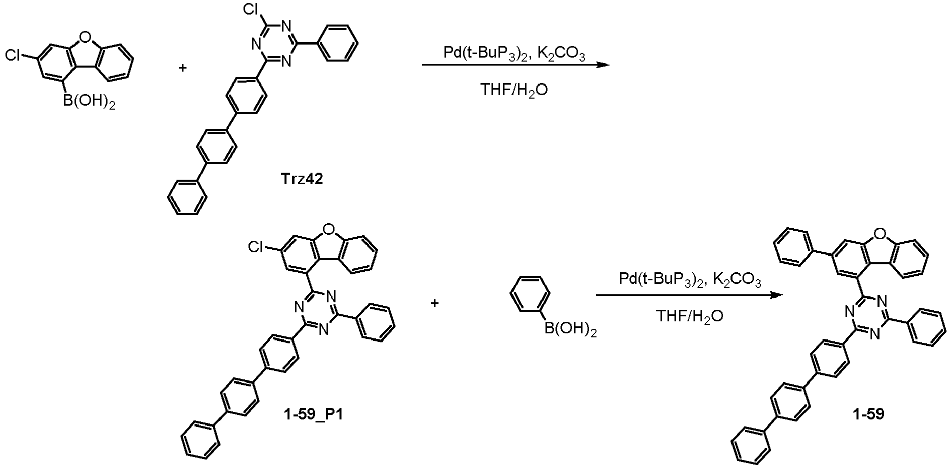

(3-Chlorodibenzo[b,d]furan-1-yl)boronic acid (15 g, 60.9 mmol) and Compound Trz42 (26.8 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.4 g of Compound 1-59_P1. (Yield: 74%, MS: [M+H]⁺= 586)

Compound 1-59_P1 (15 g, 25.6 mmol) and phenylboronic acid (3.3 g, 26.9 mmol) were added to 300 ml of THF, and the mixture was stirred and refluxed. Then, potassium carbonate (10.6 g, 76.8 mmol) was dissolved in 32 ml of water and added thereto, and the mixture was sufficiently stirred and then bis(tri-tert-butylphosphine)palladium(0) (0.1 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.6 g of Compound 1-59. (Yield: 66%, MS: [M+H]⁺= 628)

### Synthesis Example 1-60

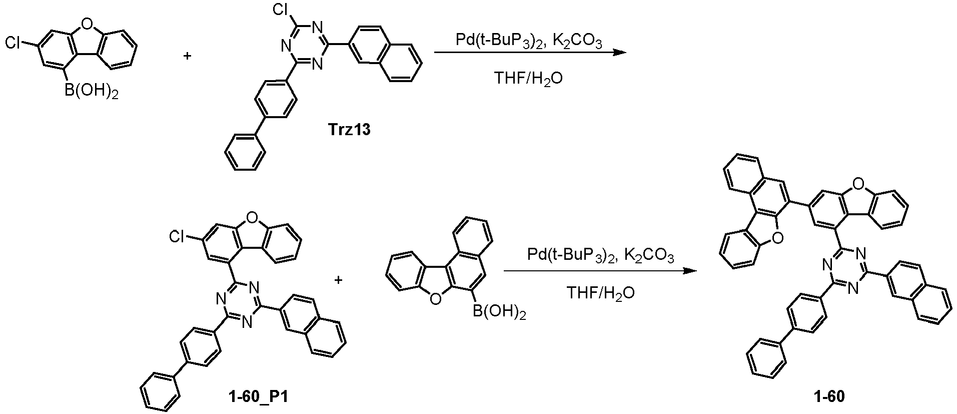

(3-Chlorodibenzo[b,d]furan-1-yl)boronic acid (15 g, 60.9 mmol) and Compound Trz13 (25.2 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 25.2 g of Compound 1-60_P1. (Yield: 74%, MS: [M+H]⁺= 560)

Compound 1-60_P1 (15 g, 26.8 mmol) and naphtho[2,1-b]benzofuran-6-ylboronic acid (7.4 g, 28.1 mmol ) were added to 300 ml of THF, and the mixture was stirred and refluxed. Then, potassium carbonate (11.1 g, 80.3 mmol) was dissolved in 33 ml of water and added thereto, and the mixture was sufficiently stirred and then bis(tri-tert-butylphosphine)palladium(0) (0.1 g, 0.3 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 14.5 g of Compound 1-60. (Yield: 73%, MS: [M+H]⁺= 742)

### Synthesis Example 1-61

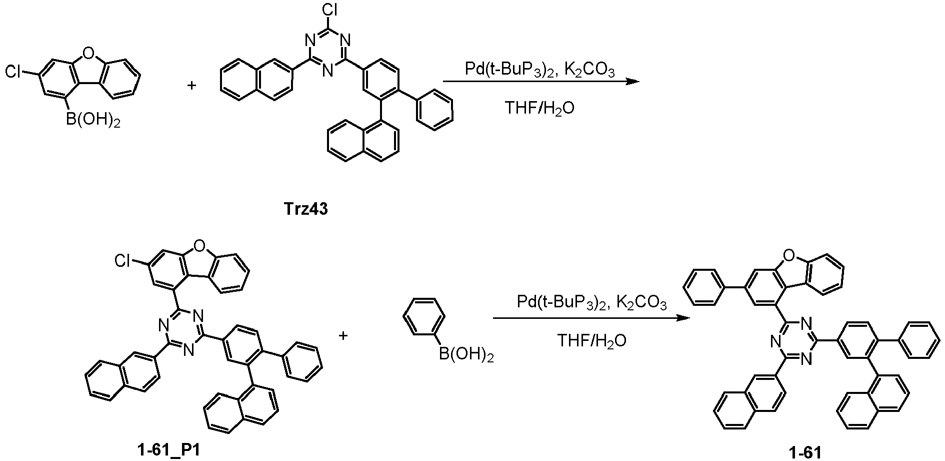

(3-Chlorodibenzo[b,d]furan-1-yl)boronic acid (15 g, 60.9 mmol) and Compound Trz43 (33.2 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 29.6 g of Compound 1-61_P1. (Yield: 71%, MS: [M+H]⁺= 686)

Compound 1-61_P1 (15 g, 21.9 mmol) and phenylboronic acid (2.8 g, 23 mmol) were added to 300 ml of THF, and the mixture was stirred and refluxed. Then, potassium carbonate (9.1 g, 65.6 mmol) was dissolved in 27 ml of water and added thereto, and the mixture was sufficiently stirred and then bis(tri-tert-butylphosphine)palladium(0) (0.1 g, 0.2 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.3 g of Compound 1-61. (Yield: 68%, MS: [M+H]⁺= 758)

### Synthesis Example 1-62

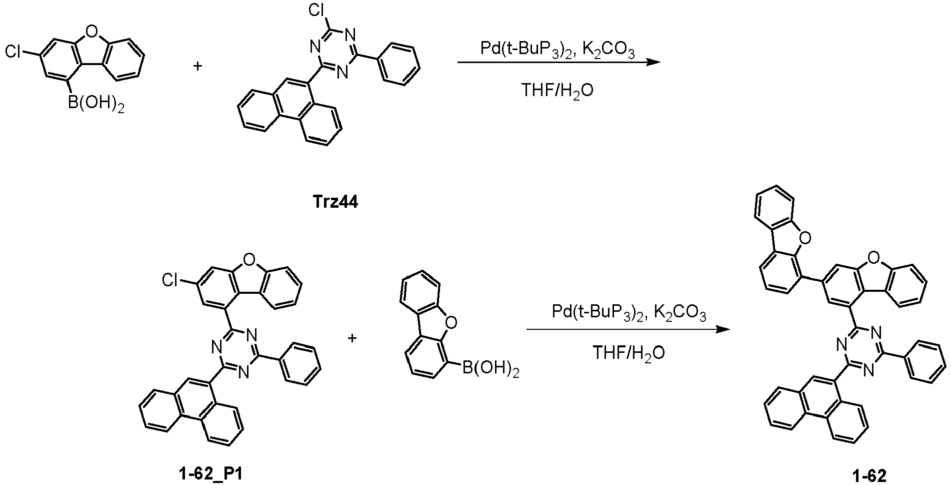

(3-Chlorodibenzo[b,d]furan-1-yl)boronic acid (15 g, 60.9 mmol) and Compound Trz44 (23.5 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.7 g of Compound 1-62_P1. (Yield: 70%, MS: [M+H]⁺= 534)

Compound 1-62_P1 (15 g, 28.1 mmol) and dibenzo[b,d]furan-4-ylboronic acid (6.3 g, 29.5 mmol) were added to 300 ml of THF, and the mixture was stirred and refluxed. Then, potassium carbonate (11.6 g, 84.3 mmol) was dissolved in 35 ml of water and added thereto, and the mixture was sufficiently stirred and then bis(tri-tert-butylphosphine)palladium(0) (0.1 g, 0.3 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.9 g of Compound 1-62. (Yield: 69%, MS: [M+H]⁺= 666)

### Synthesis Example 1-63

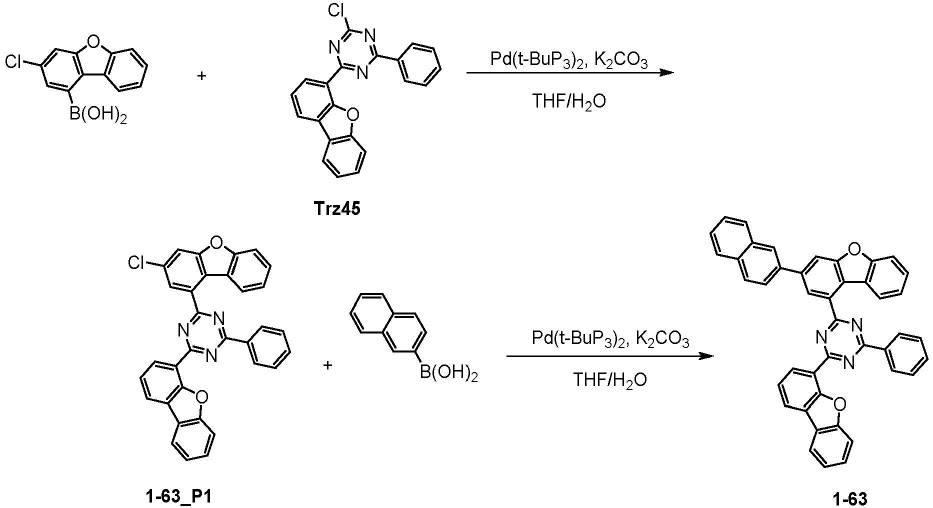

(3-Chlorodibenzo[b,d]furan-1-yl)boronic acid (15 g, 60.9 mmol) and Compound Trz45 (22.9 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21.3 g of Compound 1-63_P1. (Yield: 67%, MS: [M+H]⁺= 524)

Compound 1-63_P1 (15 g, 28.6 mmol) and naphthalen-2-ylboronic acid (5.2 g, 30.1 mmol) were added to 300 ml of THF, and the mixture was stirred and refluxed. Then, potassium carbonate (11.9 g, 85.9 mmol) was dissolved in 36 ml of water and added thereto, and the mixture was sufficiently stirred and then bis(tri-tert-butylphosphine)palladium(0) (0.1 g, 0.3 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.7 g of Compound 1-63. (Yield: 72%, MS: [M+H]⁺= 616)

### Synthesis Example 1-64

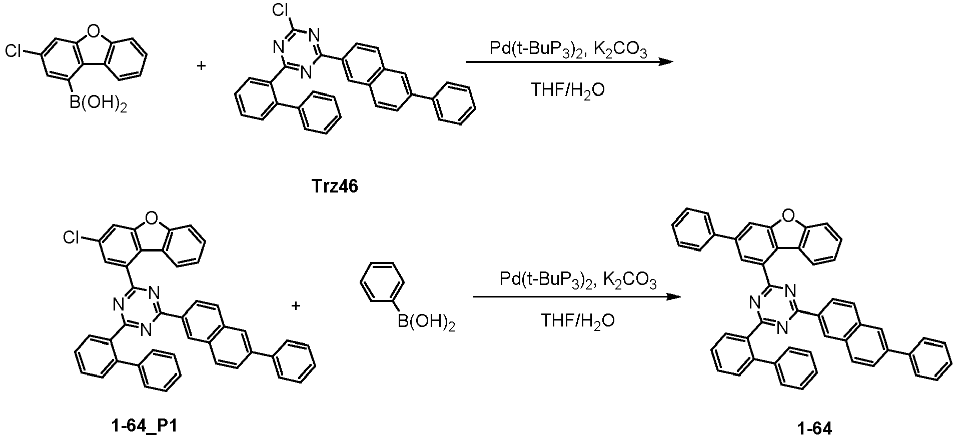

(3-Chlorodibenzo[b,d]furan-1-yl)boronic acid (15 g, 60.9 mmol) and Compound Trz46 (30 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 25.5 g of Compound 1-64_P1. (Yield: 66%, MS: [M+H]⁺= 636)

Compound 1-64_P1 (15 g, 23.6 mmol) and phenylboronic acid (3 g, 24.8 mmol) were added to 300 ml of THF, and the mixture was stirred and refluxed. Then, potassium carbonate (9.8 g, 70.7 mmol) was dissolved in 29 ml of water and added thereto, and the mixture was sufficiently stirred and then bis(tri-tert-butylphosphine)palladium(0) (0.1 g, 0.2 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.7 g of Compound 1-64. (Yield: 67%, MS: [M+H]⁺= 678)

### Synthesis Example 1-65

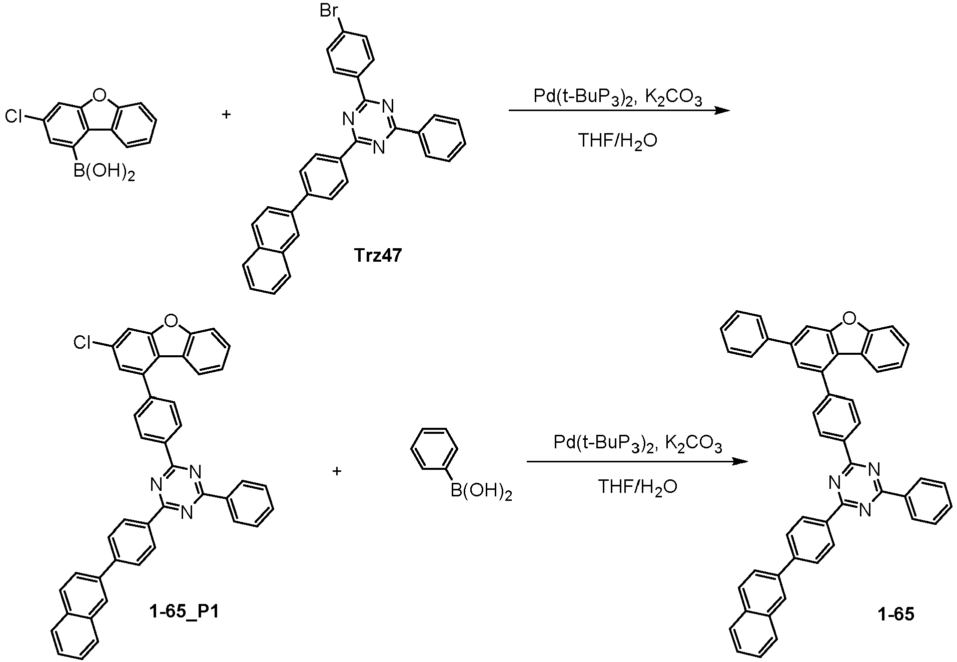

(3-Chlorodibenzo[b,d]furan-1-yl)boronic acid (15 g, 60.9 mmol) and Compound Trz47 (32.9 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.3 g of Compound 1-65_P1. (Yield: 68%, MS: [M+H]⁺= 636)

Compound 1-65_P1 (15 g, 23.6 mmol) and phenylboronic acid (3 g, 24.8 mmol) were added to 300 ml of THF, and the mixture was stirred and refluxed. Then, potassium carbonate (9.8 g, 70.7 mmol) was dissolved in 29 ml of water and added thereto, and the mixture was sufficiently stirred and then bis(tri-tert-butylphosphine)palladium(0) (0.1 g, 0.2 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.5 g of Compound 1-65. (Yield: 66%, MS: [M+H]⁺= 678)

### Synthesis Example 1-66

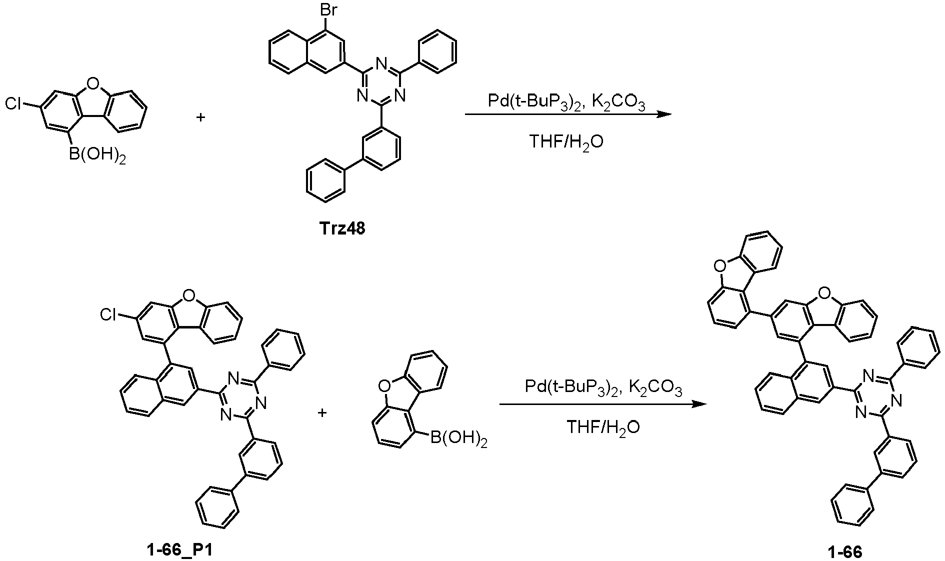

(3-Chlorodibenzo[b,d]furan-1-yl)boronic acid (15 g, 60.9 mmol) and Compound Trz48 (32.9 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 25.9g of Compound 1-66_P1. (Yield: 67%, MS: [M+H]⁺= 636)

Compound 1-66_P1 (15 g, 23.6 mmol) and dibenzo[b,d]furan-1-ylboronic acid (5.2 g, 24.8 mmol) were added to 300 ml of THF, and the mixture was stirred and refluxed. Then, potassium carbonate (9.8 g, 70.7 mmol) was dissolved in 29 ml of water and added thereto, and the mixture was sufficiently stirred and then bis(tri-tert-butylphosphine)palladium(0) (0.1 g, 0.2 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.1 g of Compound 1-66. (Yield: 67%, MS: [M+H]⁺= 768)

### Synthesis Example 1-67

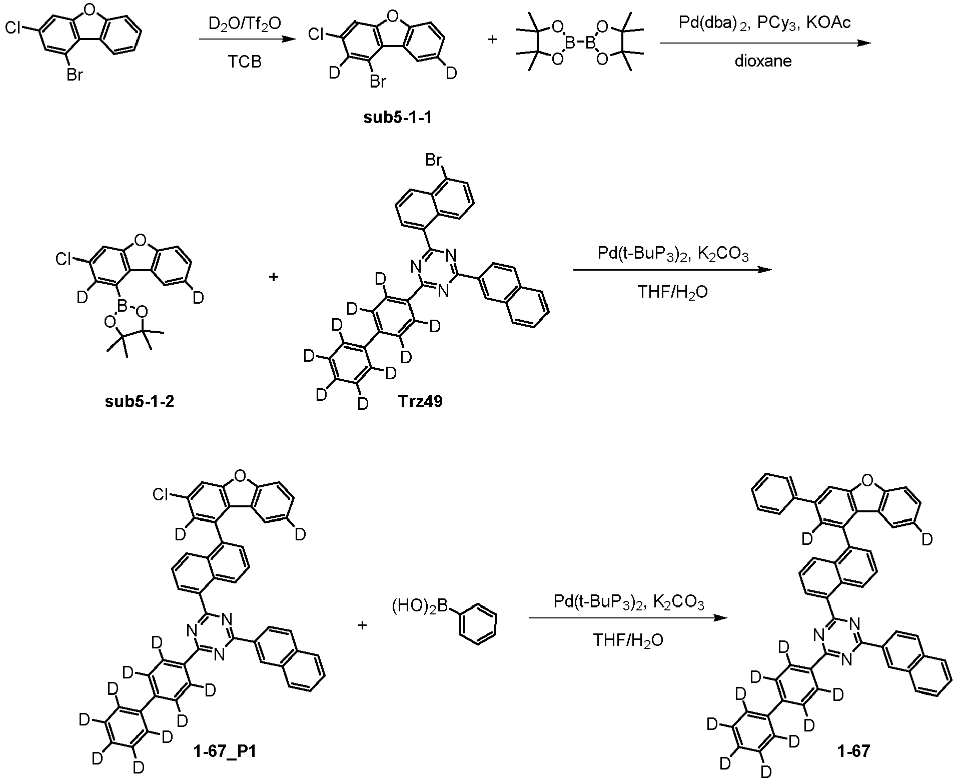

Trifluoromethanesulfonic anhydride (30.1 g, 106.6 mmol) and deuterium oxide (10.7 g, 532.8 mmol) were added at 0°C and stirred for 5 hours to prepare a solution. 1-Bromo-3-chlorodibenzo[b,d]furan (15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-3-chlorodibenzo[b,d]furan and 1,2,4-trichlorobenzene, and the mixture was stirred while heating to 140°C and then keeping that temperature. After the reaction for 4 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6 g of Compound sub5-1-1. (Yield: 40%, MS: [M+H]⁺= 283)

Compound sub5-1-1 (15 g, 52.9 mmol) and bis(pinacolato)diboron (14.8 g, 58.2 mmol ) were added to 300ml of 1,4-dioxane, and the mixture was stirred under reflux. Then, potassium acetate (7.8 g, 79.4 mmol) was added thereto, and the mixture was sufficiently stirred and then bis(dibenzylideneacetone)palladium(0) (0.9 g, 1.6 mmol) and tricyclohexylphosphine (0.9 g, 3.2 mmol) were added. After the reaction for 6 hours, the reaction mixture was cooled to room temperature, and the organic layer was separated using chloroform and water, and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 9.8 g of Compound sub5-1-2. (Yield: 56%, MS: [M+H]⁺= 331)

Compound sub5-1-2 (15 g, 45.4 mmol) and Compound Trz49 (27.3 g, 47.6 mmol) were added to 300 ml of THF, and the mixture was stirred and refluxed. Then, potassium carbonate (18.8 g, 136.1 mmol) was dissolved in 56 ml of water and added thereto, and the mixture was sufficiently stirred and then bis(tri-tert-butylphosphine)palladium(0) (0.2 g, 0.5 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21.8 g of Compound 1-67_P1. (Yield: 69%, MS: [M+H]⁺= 698)

Compound 1-67_P1 (15 g, 21.5 mmol) and phenylboronic acid (2.8 g, 22.6 mmol) were added to 300 ml of THF, and the mixture was stirred and refluxed. Then, potassium carbonate (8.9 g, 64.5 mmol) was dissolved in 27 ml of water and added thereto, and the mixture was sufficiently stirred and then bis(tri-tert-butylphosphine)palladium(0) (0.1 g, 0.2 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.6 g of Compound 1-67. (Yield: 73%, MS: [M+H]⁺= 739)

### Synthesis Example 1-68

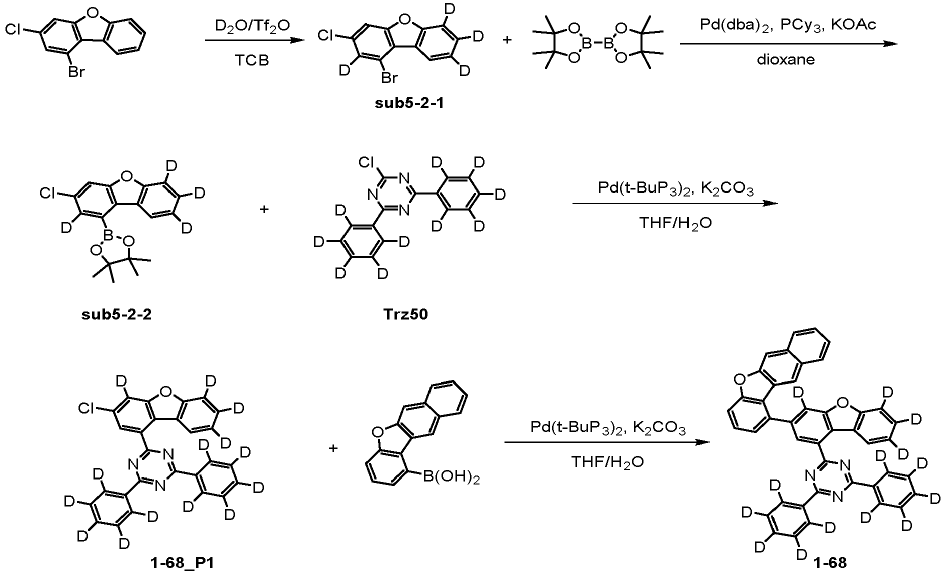

Trifluoromethanesulfonic anhydride (60.1 g, 213.1 mmol) and deuterium oxide (21.4 g, 1065.6 mmol) were added at 0°C and stirred for 5 hours to prepare a solution. 1-Bromo-3-chlorodibenzo[b,d]furan(15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-3-chlorodibenzo[b,d]furan and 1,2,4-trichlorobenzene, and the mixture was stirred while heating to 140°C and then keeping that temperature. After the reaction for 10 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.2 g of Compound sub5-2-1. (Yield: 41%, MS: [M+H]⁺= 285)

Compound sub5-2-1 (15 g, 52.9 mmol) and bis(pinacolato)diboron (14.8 g, 58.2 mmol ) were added to 300ml of 1,4-dioxane, and the mixture was stirred under reflux. Then, potassium acetate (7.8 g, 79.4 mmol) was added thereto, and the mixture was sufficiently stirred and then bis(dibenzylideneacetone)palladium(0) (0.9 g, 1.6 mmol) and tricyclohexylphosphine (0.9 g, 3.2 mmol) were added. After the reaction for 6 hours, the reaction mixture was cooled to room temperature, and the organic layer was separated using chloroform and water, and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.8 g of Compound sub5-2-2. (Yield: 62%, MS: [M+H]⁺= 331)

Compound sub5-2-2 (15 g, 45.1 mmol) and Compound Trz50 (13.2 g, 47.4 mmol) were added to 300 ml of THF, and the mixture was stirred and refluxed. Then, potassium carbonate (18.7 g, 135.3 mmol) was dissolved in 56 ml of water and added thereto, and the mixture was sufficiently stirred and then bis(tri-tert-butylphosphine)palladium(0) (0.2 g, 0.5 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.1 g of Compound 1-68_P1. (Yield: 65%, MS: [M+H]⁺= 448)

Compound 1-68_P1 (15 g, 33.5 mmol) and naphtho[2,3-b]benzofuran-1-ylboronic acid (9.2 g, 35.2 mmol) were added to 300 ml of THF, and the mixture was stirred and refluxed. Then, potassium carbonate (13.9 g, 100.5 mmol) was dissolved in 42 ml of water and added thereto, and the mixture was sufficiently stirred and then bis(tri-tert-butylphosphine)palladium(0) (0.2 g, 0.3 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 15.6 g of Compound 1-68. (Yield: 74%, MS: [M+H]⁺= 630)

### Synthesis Example 1-69

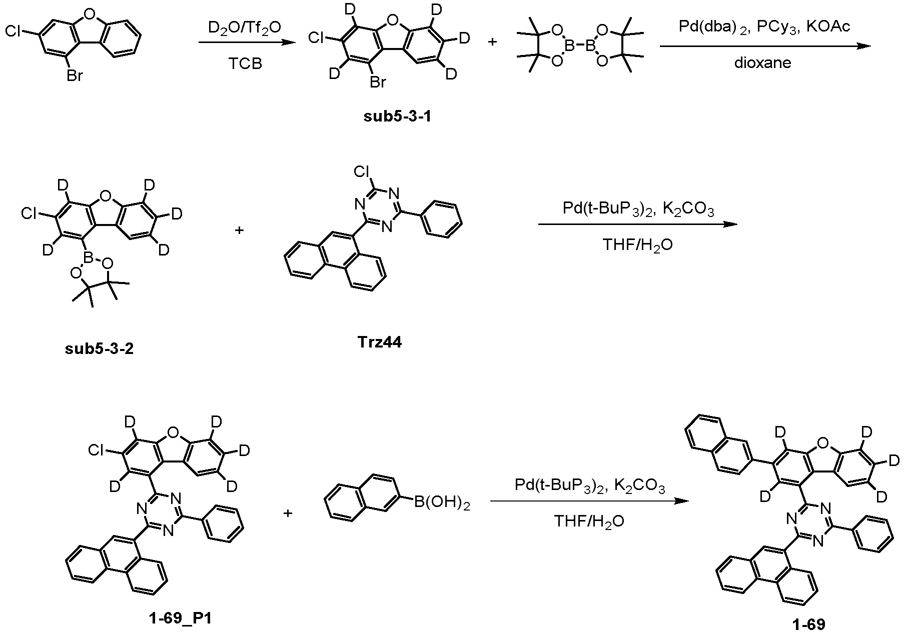

Trifluoromethanesulfonic anhydride (75.2 g, 266.4 mmol) and deuterium oxide (26.7 g, 1332 mmol) were added at 0°C and stirred for 5 hours to prepare a solution. 1-Bromo-3-chlorodibenzo[b,d]furan(15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-3-chlorodibenzo[b,d]furan and 1,2,4-trichlorobenzene, and the mixture was stirred while heating to 140°C and then keeping that temperature. After the reaction for 12 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 5.6 g of Compound ub5-3-1. (Yield: 37%, MS: [M+H]⁺= 286)

Compound sub5-3-1 (15 g, 52.3 mmol) and bis(pinacolato)diboron (14.6 g, 57.6 mmol) were added to 300ml of 1 ,4-dioxane, and the mixture was stirred under reflux. Then, potassium acetate (7.7 g, 78.5 mmol) was added thereto, and the mixture was sufficiently stirred and then bis(dibenzylideneacetone)palladium(0) (0.9 g, 1.6 mmol) and tricyclohexylphosphine (0.9 g, 3.1 mmol) were added. After the reaction for 6 hours, the reaction mixture was cooled to room temperature, and the organic layer was separated using chloroform and water, and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12 g of Compound sub5-3-2. (Yield: 69%, MS: [M+H]⁺= 334)

Compound sub5-3-2 (15 g, 45.1 mmol) and Compound Trz44 (17.4 g, 47.2 mmol) were added to 300 ml of THF, and the mixture was stirred and refluxed. Then, potassium carbonate (18.6 g, 134.9 mmol) was dissolved in 56 ml of water and added thereto, and the mixture was sufficiently stirred and then bis(tri-tert-butylphosphine)palladium(0) (0.2 g, 0.4 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 17.2 g of Compound 1-69_P1. (Yield: 71%, MS: [M+H]⁺= 539)

Compound 1-69_P1 (15 g, 27.8 mmol) and naphthalen-2-ylboronic acid (5 g, 29.2 mmol) were added to 300 ml of THF, and the mixture was stirred and refluxed. Then, potassium carbonate (11.5 g, 83.5 mmol) was dissolved in 35 ml of water and added thereto, and the mixture was sufficiently stirred and then bis(tri-tert-butylphosphine)palladium(0) (0.1 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.3 g of Compound 1-69. (Yield: 70%, MS: [M+H]⁺= 631)

### Synthesis Example 1-70

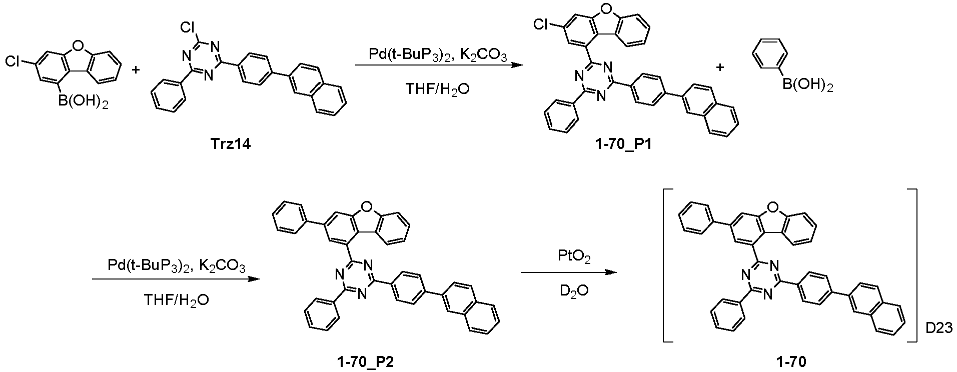

(3-Chlorodibenzo[b,d]furan-1-yl)boronic acid (15 g, 60.9 mmol) and Compound Trz14 (25.2 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.8 g of Compound 1-70_P1. (Yield: 67%, MS: [M+H]⁺= 560)

Compound 1-70_P1 (15 g, 26.8 mmol) and phenylboronic acid (3.4 g, 28.1 mmol) were added to 300 ml of THF, and the mixture was stirred and refluxed. Then, potassium carbonate (11.1 g, 80.3 mmol) was dissolved in 33 ml of water and added thereto, and the mixture was sufficiently stirred and then bis(tri-tert-butylphosphine)palladium(0) (0.1 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.9 g of Compound 1-70_P2. (Yield: 68%, MS: [M+H]⁺= 602)

Compound 1-70_P2 (10 g, 16.6 mmol), PtO₂ (1.1 g, 5 mmol) and D₂O (83 ml) were added to a shaker tube, and then the tube was sealed and heated at 250°C and 600 psi for 12 hours. After completion of the reaction, chloroform was added, and the reaction solution was transferred to a separatory funnel, and extracted. The extract was dried over MgSO₄ and concentrated, and then the sample was purified by silica gel column chromatography to prepare 4 g of Compound 1-70. (Yield: 39%, MS: [M+H]⁺= 626)

### Synthesis Example 1-71

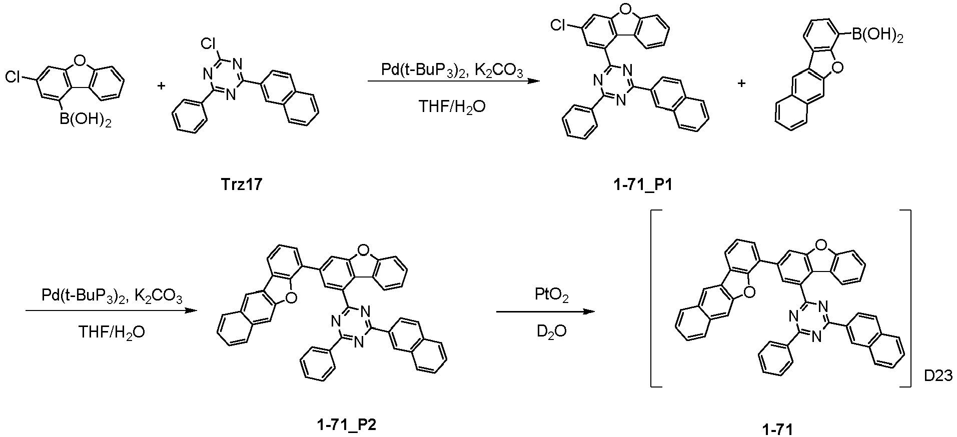

(3-Chlorodibenzo[b,d]furan-1-yl)boronic acid (15 g, 60.9 mmol) and Compound Trz17 (20.3 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21.2 g of Compound 1-71_P1. (Yield: 72%, MS: [M+H]⁺= 484)

Compound 1-71_P1 (15 g, 31 mmol) and naphtho[2,3-b]benzofuran-4-ylboronic acid (8.5 g, 32.5 mmol) were added to 300 ml of THF, and the mixture was stirred and refluxed. Then, potassium carbonate (12.9 g, 93 mmol) was dissolved in 39 ml of water and added thereto, and the mixture was sufficiently stirred and then bis(tri-tert-butylphosphine)palladium(0) (0.2 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 14.2 g of Compound 1-71_P2. (Yield: 69%, MS: [M+H]⁺= 666)

Compound 1-71_P2 (10 g, 15 mmol), PtO₂ (1 g, 4.5 mmol) and D₂O (75 ml) were added to a shaker tube, and then the tube was sealed and heated at 250°C and 600 psi for 12 hours. After completion of the reaction, chloroform was added, and the reaction solution was transferred to a separatory funnel, and extracted. The extract was dried over MgSO₄ and concentrated, and then the sample was purified by silica gel column chromatography to prepare 3.8 g of Compound 1-71. (Yield: 37%, MS: [M+H]⁺=690)

### Synthesis Example 1-72

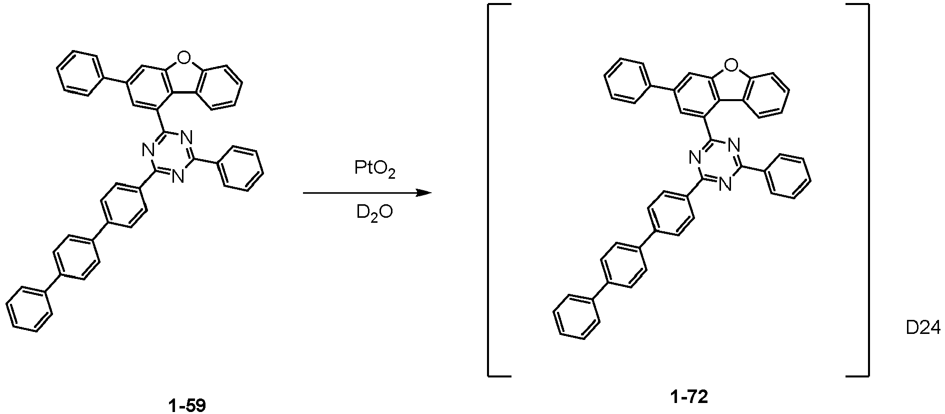

Compound 1-59 (10 g, 15.9 mmol), PtO₂ (1.1 g, 4.8 mmol) and D₂O (80 ml) were added to a shaker tube, and then the tube was sealed and heated at 250°C and 600 psi for 12 hours. After completion of the reaction, chloroform was added, and the reaction solution was transferred to a separatory funnel, and extracted. The extract was dried over MgSO₄ and concentrated, and then the sample was purified by silica gel column chromatography to prepare 4 g of Compound 1-72. (Yield: 39%, MS: [M+H]⁺= 653)

### Synthesis Example 1-73

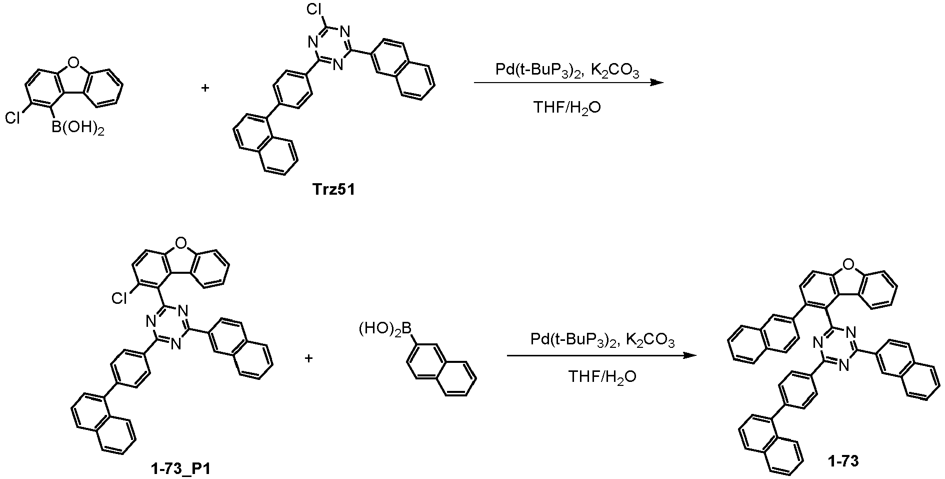

(2-Chlorodibenzo[b,d]furan-1-yl)boronic acid (15 g, 60.9 mmol) and Compound Trz51 (28.4 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 24.8 g of Compound 1-73_P1. (Yield: 67%, MS: [M+H]⁺= 610)

Compound 1-73_P1 (15 g, 24.6 mmol) and naphthalen-2-ylboronic acid (4.4 g, 25.8 mmol) were added to 300 ml of THF, and the mixture was stirred and refluxed. Then, potassium carbonate (10.2 g, 73.8 mmol) was dissolved in 31 ml of water and added thereto, and the mixture was sufficiently stirred and then bis(tri-tert-butylphosphine)palladium(0) (0.1 g, 0.2 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.1 g of Compound 1-73. (Yield: 70%, MS: [M+H]+= 702)

### Synthesis Example 1-74

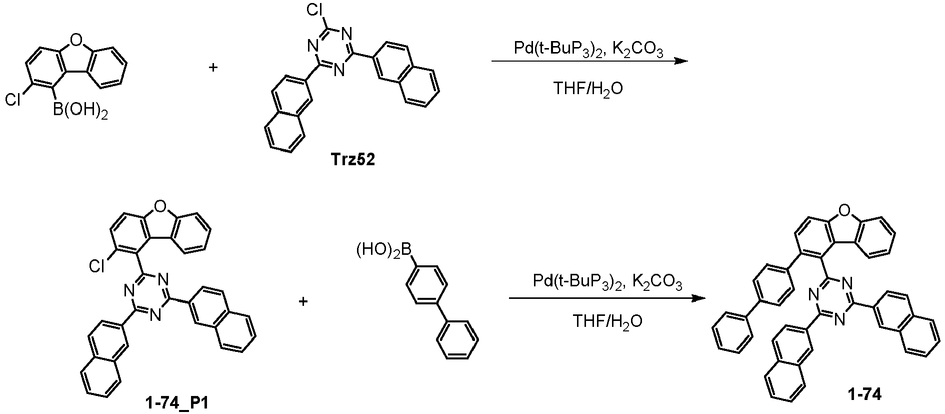

(2-Chlorodibenzo[b,d]furan-1-yl)boronic acid (15 g, 60.9 mmol) and Compound Trz52 (23.5 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.4 g of Compound 1-74_P1. (Yield: 72%, MS: [M+H]⁺= 534)

Compound 1-74_P1 (15 g, 28.1 mmol) and [1,1'-biphenyl]-4-ylboronic acid (5.8 g, 29.5 mmol) were added to 300 ml of THF, and the mixture was stirred and refluxed. Then, potassium carbonate (11.6 g, 84.3 mmol) was dissolved in 35 ml of water and added thereto, and the mixture was sufficiently stirred and then bis(tri-tert-butylphosphine)palladium(0) (0.1 g, 0.3 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.1 g of Compound 1-74. (Yield: 66%, MS: [M+H]⁺= 652)

### Synthesis Example 1-75

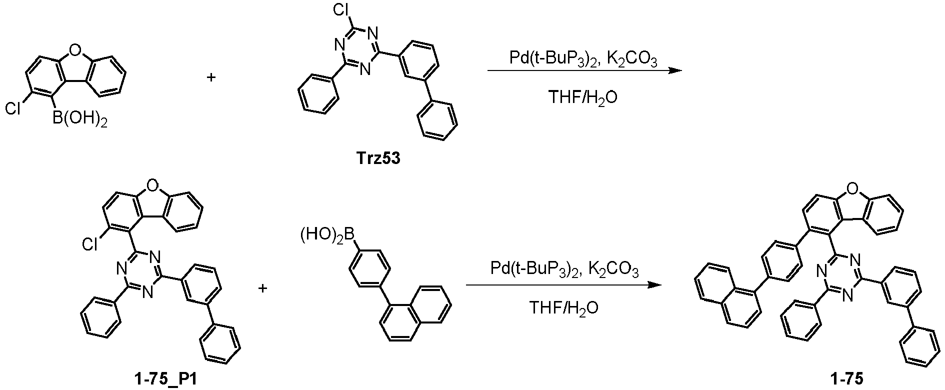

(2-Chlorodibenzo[b,d]furan-1-yl)boronic acid (15 g, 60.9 mmol) and Compound Trz53 (22 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20.1 g of Compound 1-75_P1. (Yield: 65%, MS: [M+H]⁺= 510)

Compound 1-75_P1 (15 g, 29.4 mmol) and (4-(naphthalen-1-yl)phenyl)boronic acid(7.7 g, 30.9 mmol) were added to 300 ml of THF, and the mixture was stirred and refluxed. Then, potassium carbonate (12.2 g, 88.2 mmol) was dissolved in 37 ml of water and added thereto, and the mixture was sufficiently stirred and then bis(tri-tert-butylphosphine)palladium(0) (0.2 g, 0.3 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.9 g of Compound 1-75. (Yield: 65%, MS: [M+H]⁺= 678)

### Synthesis Example 1-76

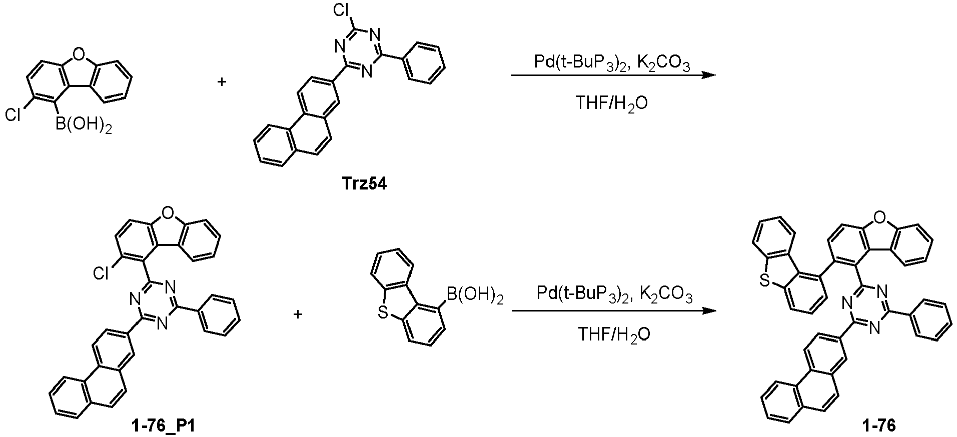

(2-Chlorodibenzo[b,d]furan-1-yl)boronic acid (15 g, 60.9 mmol) and Compound Trz54 (23.5 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23 g of Compound 1-76_P1. (Yield: 71%, MS: [M+H]⁺= 534)

Compound 1-76_P1 (15 g, 28.1 mmol) and dibenzo[b,d]thiophen-1-ylboronic acid (6.7 g, 29.5 mmol) were added to 300 ml of THF, and the mixture was stirred and refluxed. Then, potassium carbonate (11.6 g, 84.3 mmol) was dissolved in 35 ml of water and added thereto, and the mixture was sufficiently stirred and then bis(tri-tert-butylphosphine)palladium(0) (0.1 g, 0.3 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.4 g of Compound 1-76. (Yield: 70%, MS: [M+H]+= 682)

### Synthesis Example 1-77

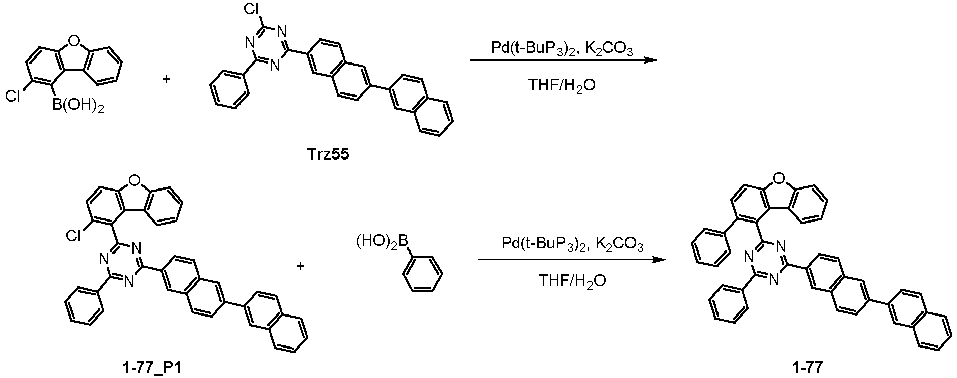

(2-Chlorodibenzo[b,d]furan-1-yl)boronic acid (15 g, 60.9 mmol) and Compound Trz55 (28.4 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.7 g of Compound 1-77_P1. (Yield: 72%, MS: [M+H]⁺= 610)

Compound 1-77_P1 (15 g, 24.6 mmol) and phenylboronic acid (3.1 g, 25.8 mmol) were added to 300 ml of THF, and the mixture was stirred and refluxed. Then, potassium carbonate (10.2 g, 73.8 mmol) was dissolved in 31 ml of water and added thereto, and the mixture was sufficiently stirred and then bis(tri-tert-butylphosphine)palladium(0) (0.1 g, 0.2 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.8 g of Compound 1-77. (Yield: 74%, MS: [M+H]⁺= 652)

### Synthesis Example 1-78

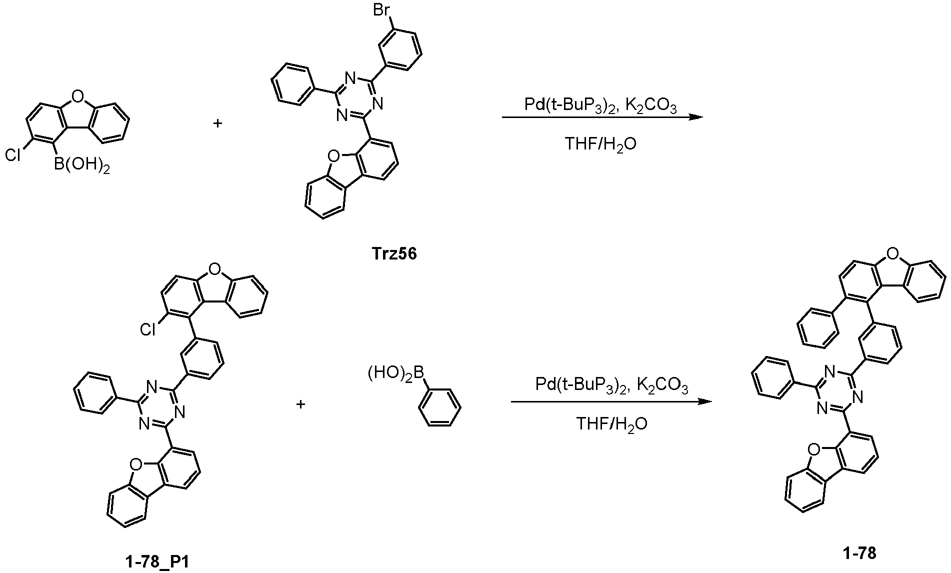

(2-Chlorodibenzo[b,d]furan-1-yl)boronic acid (15 g, 60.9 mmol) and Compound Trz56 (30.6 g, 63.9 mmol) were added to 300 ml of THF, and the mixture was stirred and refluxed. Then, potassium carbonate (25.2 g, 182.6 mmol) was dissolved in 76 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 27 g of Compound 1-78_P1. (Yield: 74%, MS: [M+H]⁺= 600)

Compound 1-78_P1 (15 g, 25 mmol) and phenylboronic acid (3.2 g, 26.2 mmol) were added to 300 ml of THF, and the mixture was stirred and refluxed. Then, potassium carbonate (10.4 g, 75 mmol) was dissolved in 31 ml of water and added thereto, and the mixture was sufficiently stirred and then bis(tri-tert-butylphosphine)palladium(0) (0.1 g, 0.2 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.5 g of Compound 1-78. (Yield: 72%, MS: [M+H]⁺= 642)

### Synthesis Example 1-79

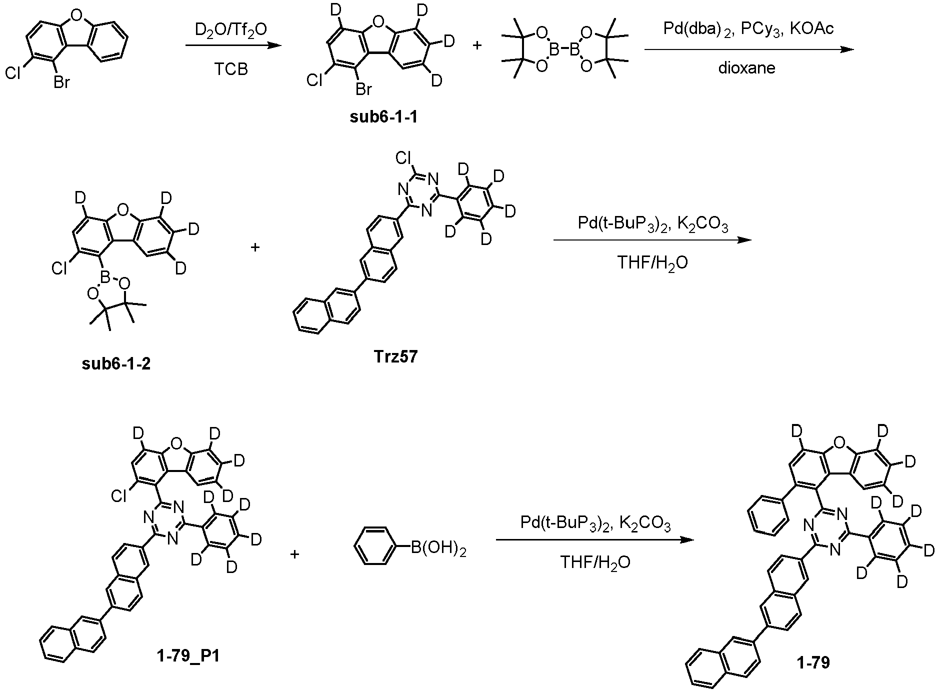

Trifluoromethanesulfonic anhydride (60.1 g, 213.1 mmol) and deuterium oxide (21.4 g, 1065.6 mmol) were added at 0°C and stirred for 5 hours to prepare a solution. 1-Bromo-2-chlorodibenzo[b,d]furan(15 g, 53.3 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of 1-bromo-2-chlorodibenzo[b,d]furan and 1,2,4-trichlorobenzene, and the mixture was stirred while heating to 140°C and then keeping that temperature. After the reaction for 10 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.1 g of Compound sub6-1-1. (Yield: 40%, MS: [M+H]⁺= 285)

Compound sub6-1-1 (15 g, 52.5 mmol) and bis(pinacolato)diboron (14.7 g, 57.8 mmol ) were added to 300ml of 1,4-dioxane, and the mixture was stirred under reflux. Then, potassium acetate (7.7 g, 78.8 mmol) was added thereto, and the mixture was sufficiently stirred and then bis(dibenzylideneacetone)palladium(0) (0.9 g, 1.6 mmol) and tricyclohexylphosphine (0.9 g, 3.2 mmol) were added. After the reaction for 5 hours, the reaction mixture was cooled to room temperature, and the organic layer was separated using chloroform and water, and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.5 g of Compound sub6-1-2. (Yield: 60%, MS: [M+H]⁺= 333)

Compound sub6-1-2 (15 g, 45.1 mmol) and Compound Trz57 (21.3 g, 47.4 mmol) were added to 300 ml of THF, and the mixture was stirred and refluxed. Then, potassium carbonate (18.7 g, 135.3 mmol) was dissolved in 56 ml of water and added thereto, and the mixture was sufficiently stirred and then bis(tri-tert-butylphosphine)palladium(0) (0.2 g, 0.5 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 18.1 g of Compound 1-79_P1. (Yield: 65%, MS: [M+H]⁺= 619)

Compound 1-79_P1 (15 g, 24.2 mmol) and phenylboronic acid(3.1 g, 25.4 mmol) were added to 300 ml of THF, and the mixture was stirred and refluxed. Then, potassium carbonate (10 g, 72.7 mmol) was dissolved in 30 ml of water and added thereto, and the mixture was sufficiently stirred and then bis(tri-tert-butylphosphine)palladium(0) (0.1 g, 0.2 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11 g of Compound 1-79. (Yield: 69%, MS: [M+H]⁺= 661)

### Synthesis Example 1-80

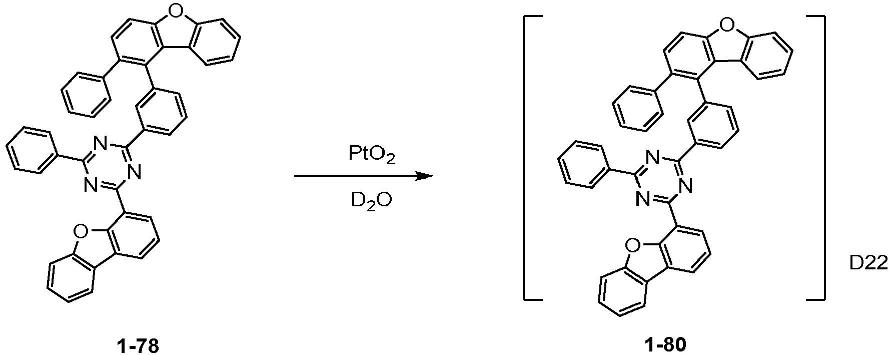

Compound 1-78 (10 g, 15.6 mmol), PtO₂ (1.1 g, 4.7 mmol) and D₂O (78 ml) were added to a shaker tube, and then the tube was sealed and heated at 250°C and 600 psi for 12 hours. After completion of the reaction, chloroform was added, and the reaction solution was transferred to a separatory funnel, and extracted. The extract was dried over MgSO₄ and concentrated, and then the sample was purified by silica gel column chromatography to prepare 4.3 g of Compound 1-80. (Yield: 42%, MS: [M+H]⁺= 665)

### Synthesis Example 2-1

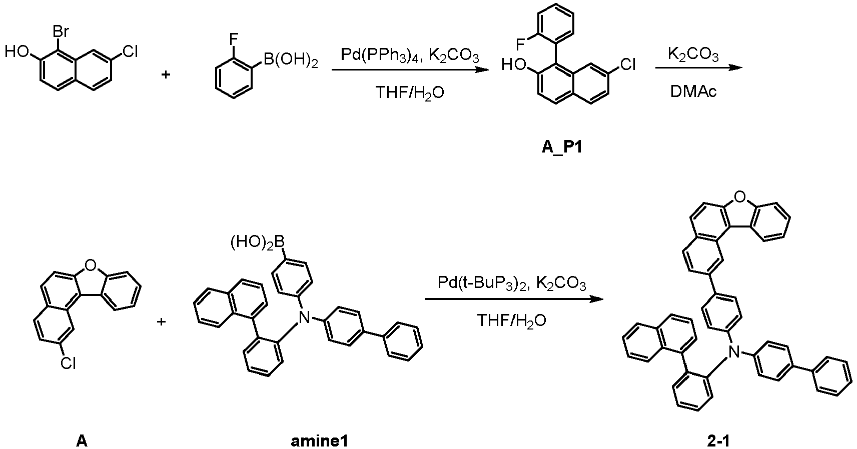

1-Bromo-7-chloronaphthalen-2-ol (15 g, 58.3 mmol) and (2-fluorophenyl)boronic acid (8.6 g, 61.2 mmol) were added to 300 ml of THF, and the mixture was stirred and refluxed. Then, potassium carbonate (24.2 g, 174.8 mmol) was dissolved in 72 ml of water and added thereto, and the mixture was sufficiently stirred and then tetrakis(triphenylphosphine)palladium(0) (0.7 g, 0.6 mmol) was added. After the reaction for 6 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.4 g of Compound A_P1. (Yield: 78%, MS: [M+H]⁺= 273)

Compound A_P1 (15 g, 55 mmol) and potassium carbonate (22.8 g, 165 mmol) were added to 150 ml of DMAc, and the mixture was stirred and refluxed. After the reaction for 5 hours, the reaction mixture was cooled to room temperature, poured into 300 ml of water, solidified and filtered to obtain a solid. This was again dissolved in chloroform, washed twice with water, the organic layer was separated, anhydrous magnesium sulfate was added, stirred, filtered, and the filtrate was distilled under reduced pressure. The concentrated compound was purified by silica gel column chromatography to prepare 8.5 g of Compound A. (Yield 61%, MS: [M+H]⁺= 253)

Compound A (15 g, 59.4 mmol) and Compound amine1 (30.6 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 27.6 g of Compound 2-1. (Yield: 70%, MS: [M+H]⁺= 664)

### Synthesis Example 2-2

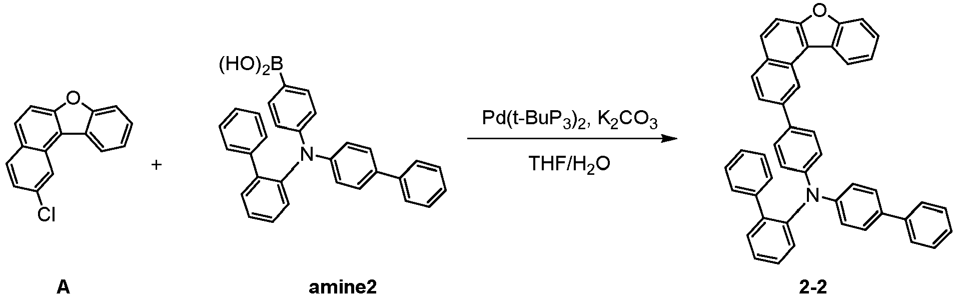

Compound A (15 g, 59.4 mmol) and Compound amine2 (27.5 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.2 g of Compound 2-2. (Yield: 72%, MS: [M+H]+= 614)

### Synthesis Example 2-3

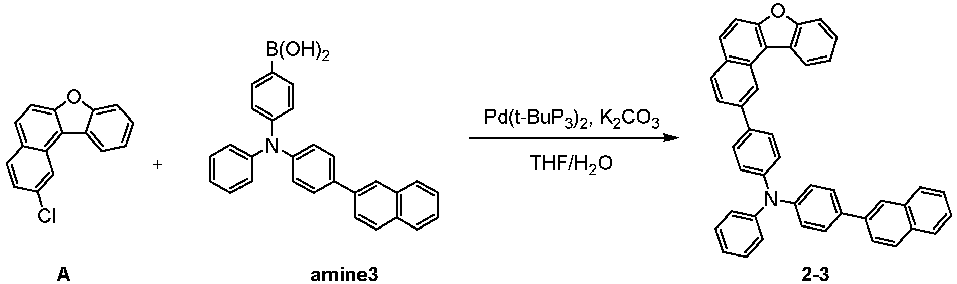

Compound A (15 g, 59.4 mmol) and Compound amine3 (25.9 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.4 g of Compound 2-3. (Yield: 67%, MS: [M+H]⁺= 588)

### Synthesis Example 2-4

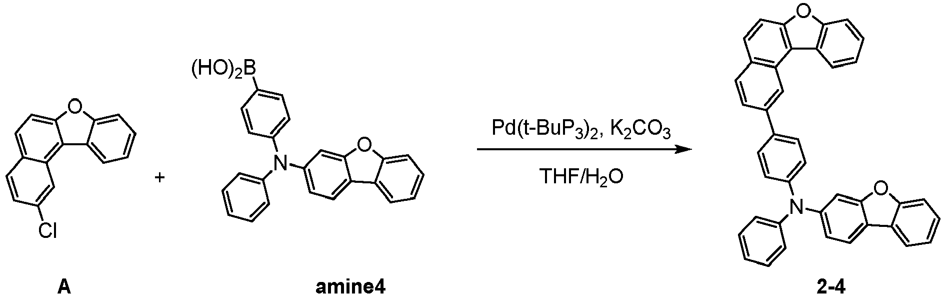

Compound A (15 g, 59.4 mmol) and Compound amine4 (23.6 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 24.2 g of Compound 2-4. (Yield: 74%, MS: [M+H]⁺= 552)

### Synthesis Example 2-5

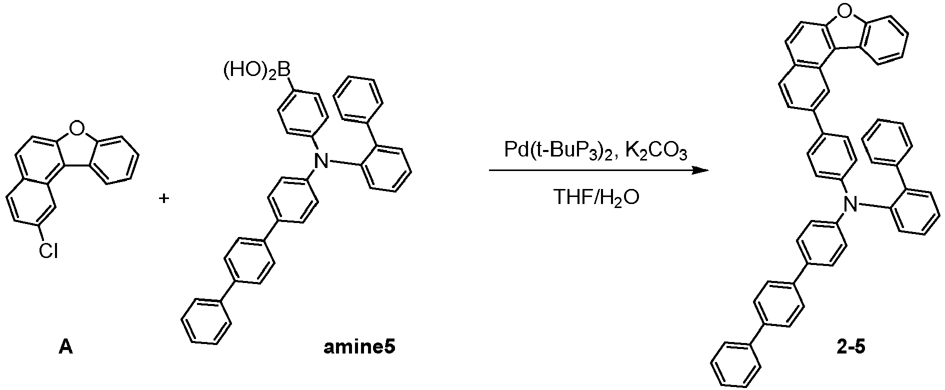

Compound A (15 g, 59.4 mmol) and Compound amine5 (32.3 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.6 g of Compound 2-5. (Yield: 65%, MS: [M+H]⁺= 690)

### Synthesis Example 2-6

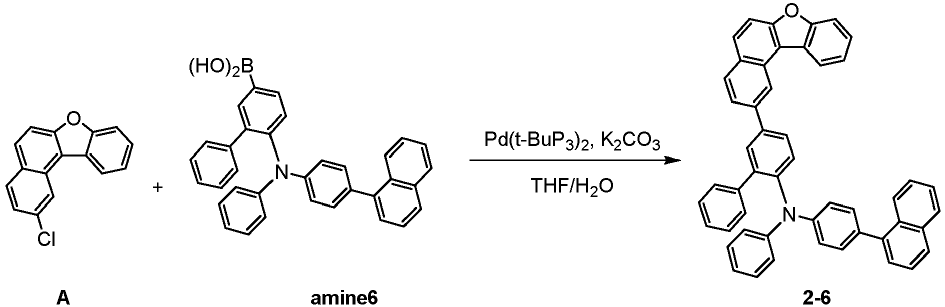

Compound A (15 g, 59.4 mmol) and Compound amine6 (30.6 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 29.1 g of Compound 2-6. (Yield: 74%, MS: [M+H]⁺= 664)

### Synthesis Example 2-7

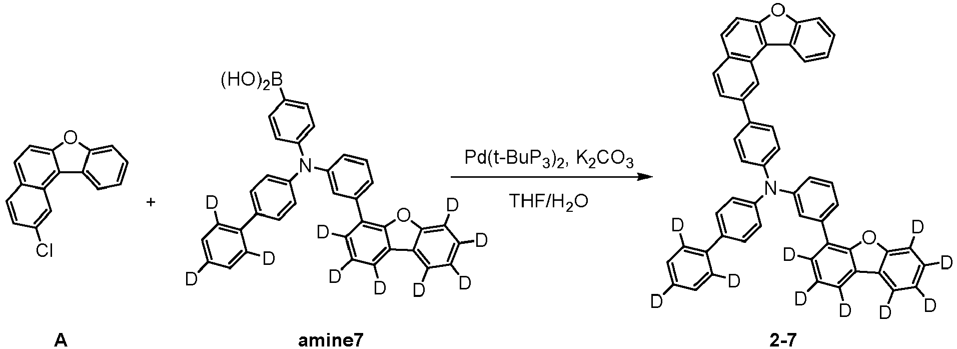

Compound A (15 g, 59.4 mmol) and Compound amine7 (33.7 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 27.9 g of Compound 2-7. (Yield: 66%, MS: [M+H]⁺= 714)

### Synthesis Example 2-8

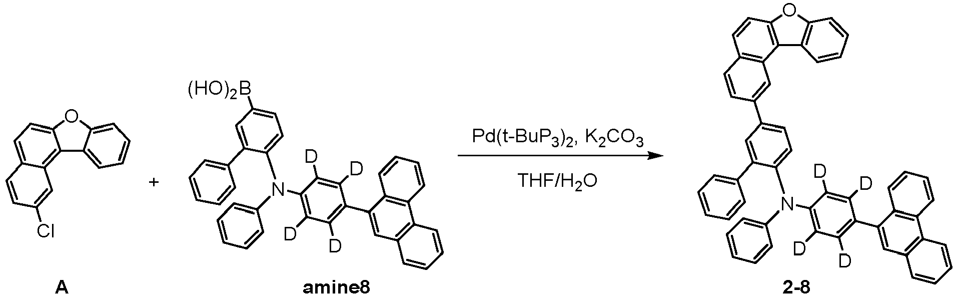

Compound A (15 g, 59.4 mmol) and Compound amine8 (34 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 30.7 g of Compound 2-8. (Yield: 72%, MS: [M+H]⁺= 718)

### Synthesis Example 2-9

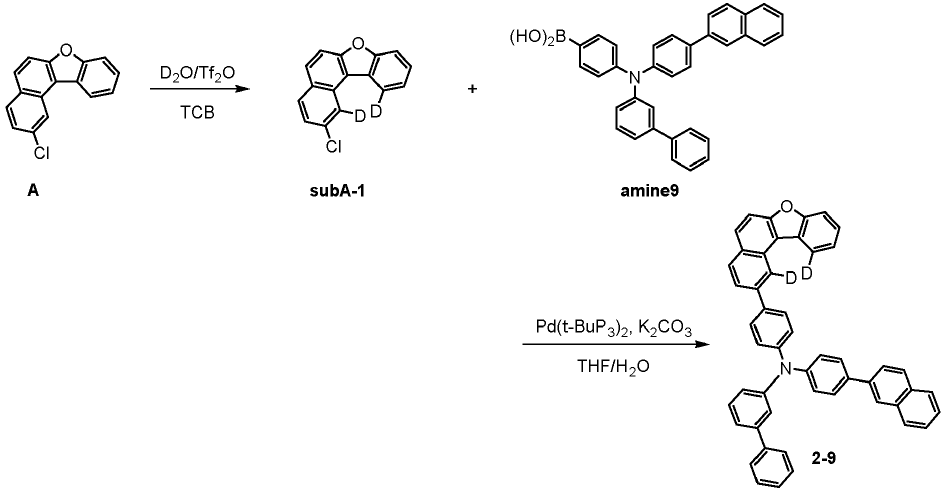

Trifluoromethanesulfonic anhydride (33.5 g, 118.7 mmol) and deuterium oxide (11.9 g, 593.6 mmol) were added at 0°C and stirred for 5 hours to prepare a solution. Compound A (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of Compound A and 1,2,4-trichlorobenzene, and the mixture was stirred while heating to 140°C and then keeping that temperature. After the reaction for 3 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 5.4 g of compound subA-1. (Yield: 36%, MS: [M+H]⁺= 255)

Compound subA-1 (15 g, 59.6 mmol) and Compound amine9 (30.7 g, 62.6 mmol) were added to 300 ml of THF, and the mixture was stirred and refluxed. Then, potassium carbonate (24.7 g, 178.8 mmol) was dissolved in 74 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 28.9 g of Compound 2-9. (Yield: 73%, MS: [M+H]⁺= 666)

### Synthesis Example 2-10

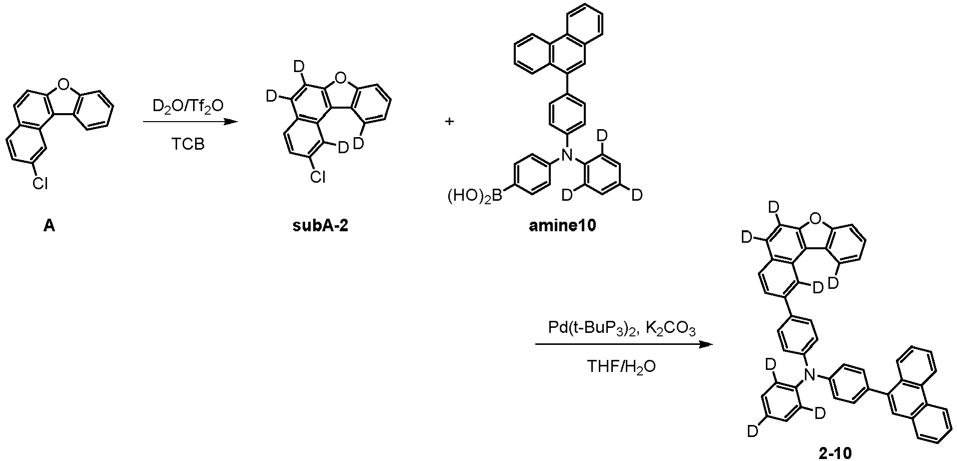

Trifluoromethanesulfonic anhydride (67 g, 237.4 mmol) and deuterium oxide (23.8 g, 1187.2 mmol) were added at 0°C and stirred for 6 hours to prepare a solution. Compound A (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of Compound A and 1,2,4-trichlorobenzene, and the mixture was stirred while heating to 140°C and then keeping that temperature. After the reaction for 10 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.2 g of Compound subA-2. (Yield: 41%, MS: [M+H]⁺= 258)

Compound subA-2 (15 g, 58.9 mmol) and Compound amine10 (29 g, 61.8 mmol) were added to 300 ml of THF, and the mixture was stirred and refluxed. Then, potassium carbonate (24.4 g, 176.7 mmol) was dissolved in 73 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 25.4 g of Compound 2-10. (Yield: 67%, MS: [M+H]⁺= 645)

### Synthesis Example 2-11

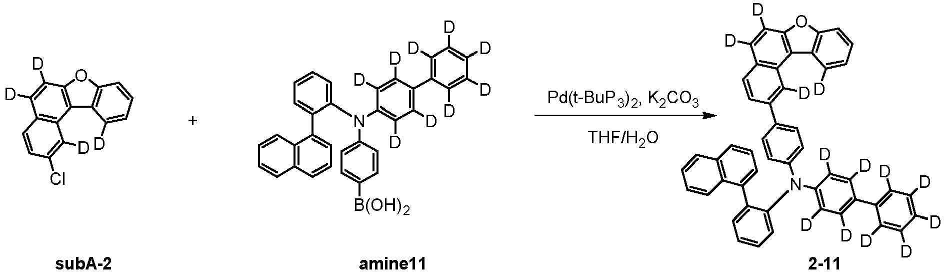

Compound subA-2 (15 g, 58.9 mmol) and Compound amine11 (30.9 g, 61.8 mmol) were added to 300 ml of THF, and the mixture was stirred and refluxed. Then, potassium carbonate (24.4 g, 176.7 mmol) was dissolved in 73 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.3 g of Compound 2-11. (Yield: 66%, MS: [M+H]⁺= 677)

### Synthesis Example 2-12

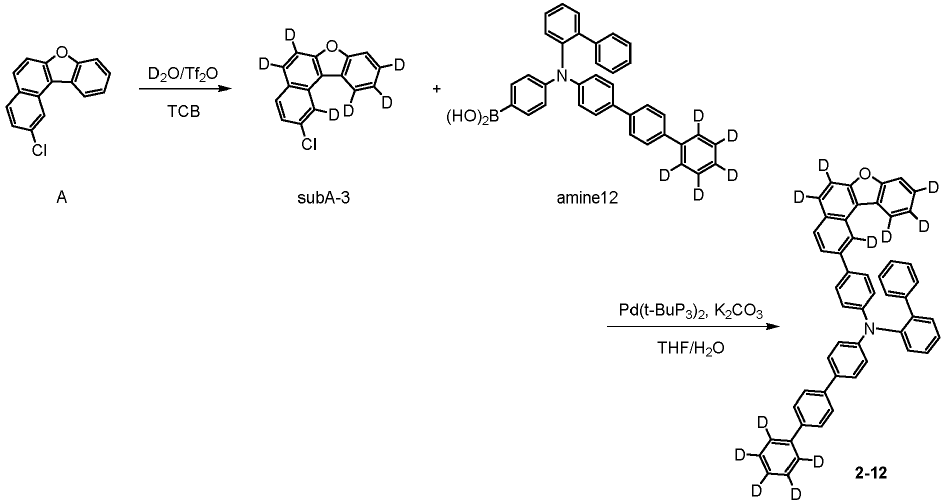

Trifluoromethanesulfonic anhydride (83.7 g, 296.8 mmol) and deuterium oxide (29.7 g, 1484 mmol) were added at 0°C and stirred for 6 hours to prepare a solution. Compound A (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of compound A and 1,2,4-trichlorobenzene, and the mixture was stirred while heating to 140°C and then keeping that temperature. After the reaction for 14 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.9 g of Compound subA-3. (Yield: 45%, MS: [M+H]⁺= 259)

Compound subA-3 (15 g, 58 mmol) and Compound amine12 (31.8 g, 60.9 mmol) were added to 300 ml of THF, and the mixture was stirred and refluxed. Then, potassium carbonate (24 g, 173.9 mmol) was dissolved in 72 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.4 g of Compound 2-12. (Yield: 65%, MS: [M+H]⁺= 701)

### Synthesis Example 2-13

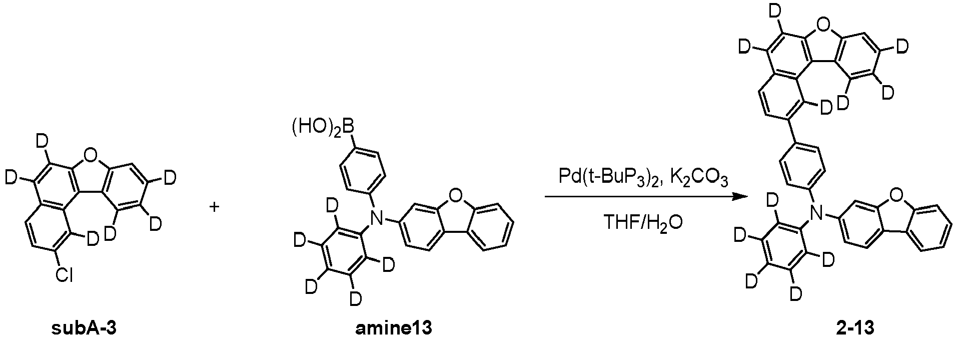

Compound subA-3 (15 g, 58 mmol) and Compound amine13 (23.4 g, 60.9 mmol) were added to 300 ml of THF, and the mixture was stirred and refluxed. Then, potassium carbonate (24 g, 173.9 mmol) was dissolved in 72 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21.5 g of Compound 2-13. (Yield: 66%, MS: [M+H]⁺= 563)

### Synthesis Example 2-14

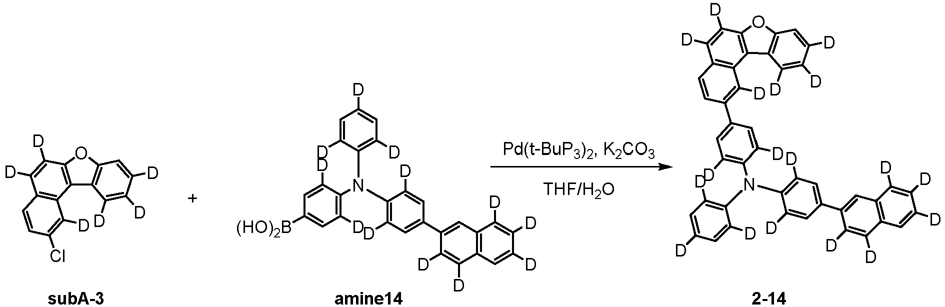

Compound subA-3 (15 g, 58 mmol) and Compound amine14 (26 g, 60.9 mmol) were added to 300 ml of THF, and the mixture was stirred and refluxed. Then, potassium carbonate (24 g, 173.9 mmol) was dissolved in 72 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 25.3 g of Compound 2-14. (Yield: 72%, MS: [M+H]⁺= 606)

### Synthesis Example 2-15

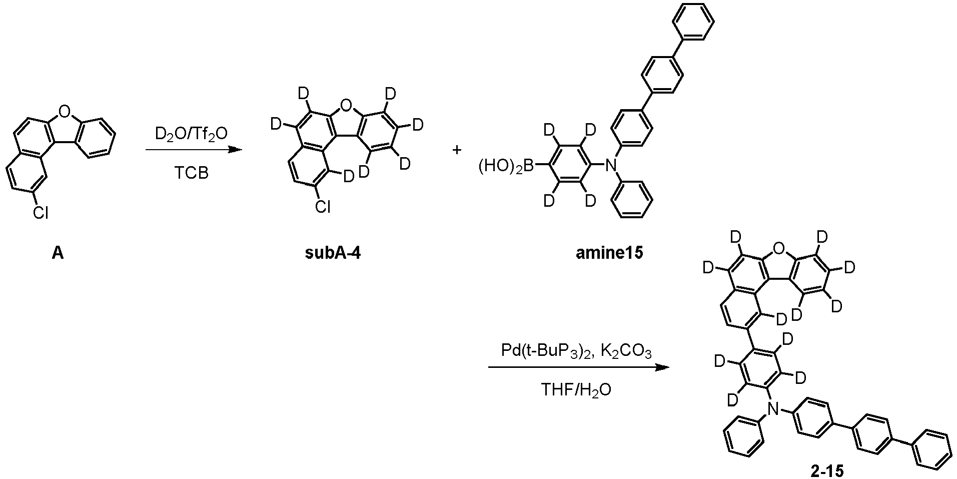

Trifluoromethanesulfonic anhydride (117.2 g, 415.5 mmol) and deuterium oxide (41.6 g, 2077.6 mmol) were added at 0°C and stirred for 6 hours to prepare a solution. Compound A (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of Compound A and 1,2,4-trichlorobenzene, and the mixture was stirred while heating to 140°C and then keeping that temperature. After the reaction for 20 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 5.8 g of Compound subA-4. (Yield: 38%, MS: [M+H]⁺= 260)

Compound subA-4 (15 g, 57.8 mmol) and Compound amine15 (27 g, 60.6 mmol) were added to 300 ml of THF, and the mixture was stirred and refluxed. Then, potassium carbonate (23.9 g, 173.3 mmol) was dissolved in 72 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.8 g of Compound 2-15. (Yield: 66%, MS: [M+H]⁺= 625)

### Synthesis Example 2-16

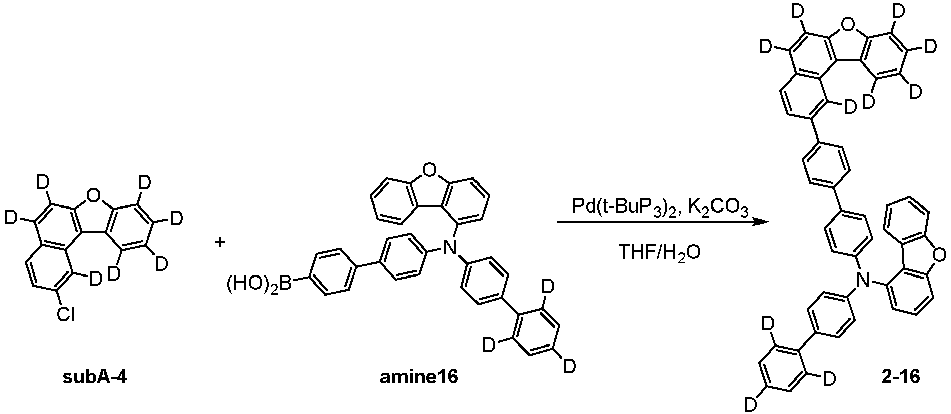

Compound subA-4 (15 g, 57.8 mmol ) and Compound amine16 (32.4 g, 60.6 mmol) were added to 300 ml of THF, and the mixture was stirred and refluxed. Then, potassium carbonate (23.9 g, 173.3 mmol) was dissolved in 72 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.8 g of Compound 2-16. (Yield: 65%, MS: [M+H]⁺= 714)

### Synthesis Example 2-17

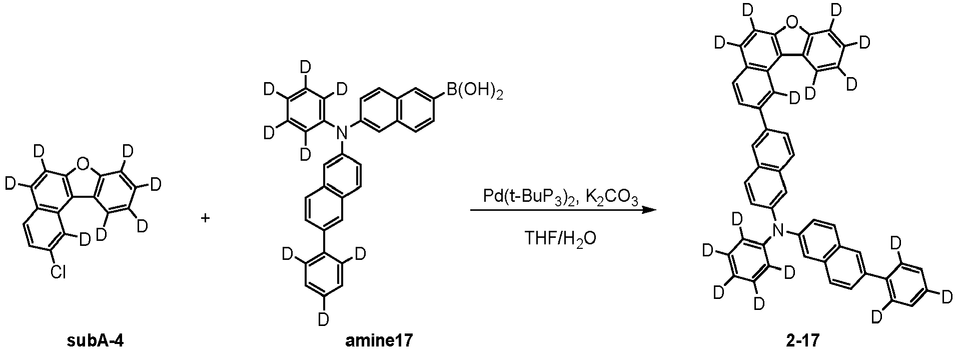

Compound subA-4 (15 g, 57.8 mmol) and Compound amine17 (28.7 g, 60.6 mmol) were added to 300 ml of THF, and the mixture was stirred and refluxed. Then, potassium carbonate (23.9 g, 173.3 mmol) was dissolved in 72 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 24.9 g of Compound 2-17. (Yield: 66%, MS: [M+H]⁺= 653)

### Synthesis Example 2-18

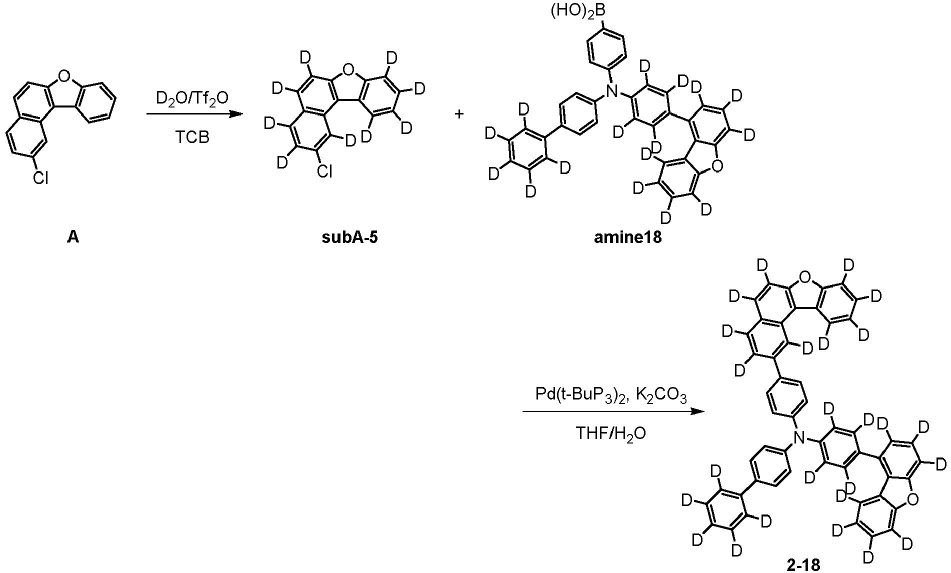

Trifluoromethanesulfonic anhydride (150.7 g, 534.2 mmol) and deuterium oxide (53.5 g, 2671.2 mmol) were added at 0°C and stirred for 6 hours to prepare a solution. Compound A (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of compound A and 1,2,4-trichlorobenzene, and the mixture was stirred while heating to 140°C and then keeping that temperature. After the reaction for 28 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.5 g of Compound subA-5. (Yield: 42%, MS: [M+H]⁺= 262)

Compound subA-5 (15 g, 57.3 mmol) and Compound amine18 (32.9 g, 60.2 mmol) were added to 300 ml of THF, and the mixture was stirred and refluxed. Then, potassium carbonate (23.8 g, 171.9 mmol) was dissolved in 71 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 31.3 g of Compound 2-18. (Yield: 75%, MS: [M+H]⁺= 729)

### Synthesis Example 2-19

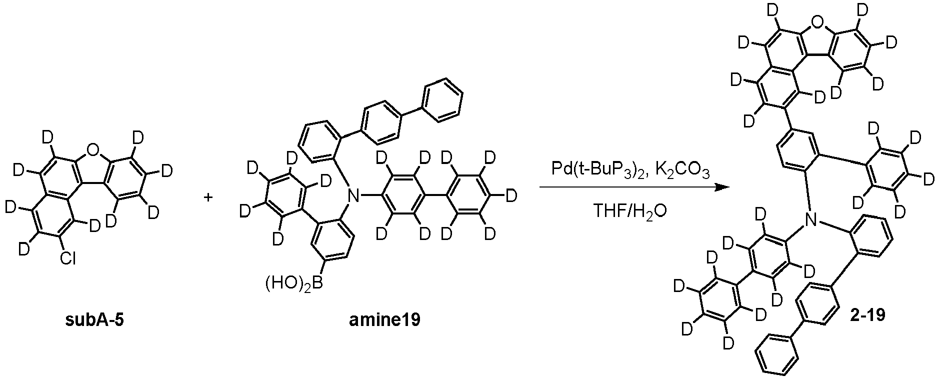

Compound subA-5 (15 g, 57.3 mmol) and Compound amine19 (36.6 g, 60.2 mmol) were added to 300 ml of THF, and the mixture was stirred and refluxed. Then, potassium carbonate (23.8 g, 171.9 mmol) was dissolved in 71 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 30.3 g of Compound 2-19. (Yield: 67%, MS: [M+H]⁺= 789)

### Synthesis Example 2-20

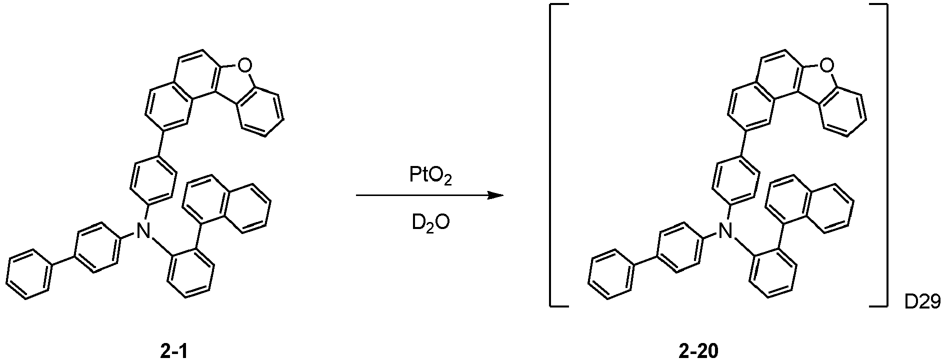

Compound 2-1(10 g, 15.1 mmol), PtO₂ (1 g, 4.5 mmol) and D₂O (75 ml) were added to a shaker tube, and then the tube was sealed and heated at 250°C and 600 psi for 12 hours. After completion of the reaction, chloroform was added, and the reaction solution was transferred to a separatory funnel, and extracted. The extract was dried over MgSO₄ and concentrated, and then the sample was purified by silica gel column chromatography to prepare 3.2 g of Compound 2-20. (Yield: 31%, MS: [M+H]⁺= 694)

### Synthesis Example 2-21

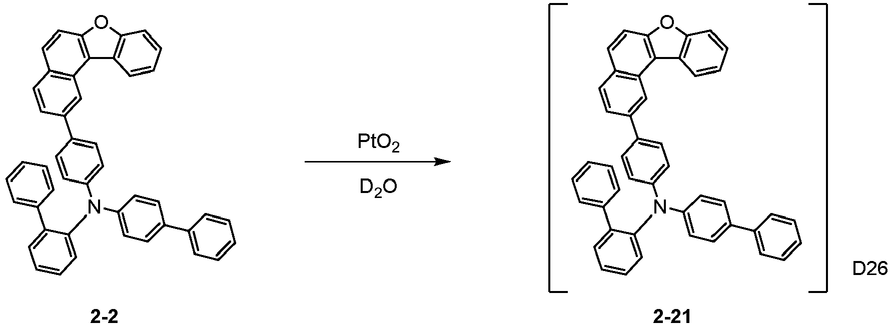

Compound 2-2 (10 g, 16.3 mmol), PtO₂ (1.1 g, 4.9 mmol) and D₂O (81 ml) were added to a shaker tube, and then the tube was sealed and heated at 250°C and 600 psi for 12 hours. After completion of the reaction, chloroform was added, and the reaction solution was transferred to a separatory funnel, and extracted. The extract was dried over MgSO₄ and concentrated, and then the sample was purified by silica gel column chromatography to prepare 4.7 g of Compound 2-21. (Yield: 45%, MS: [M+H]⁺= 641)

### Synthesis Example 2-22

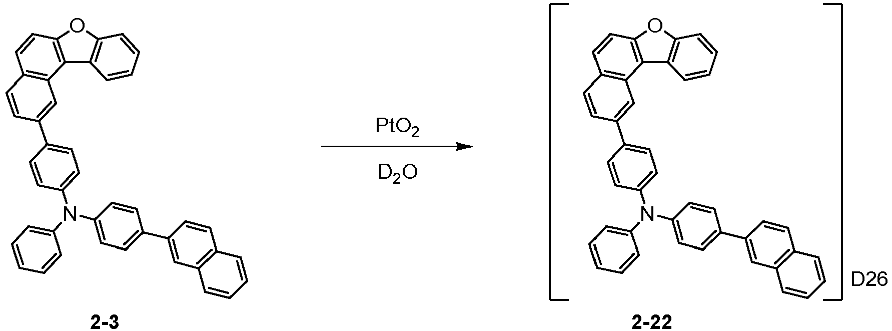

Compound 2-3 (10 g, 17 mmol), PtO₂ (1.2 g, 5.1 mmol) and D₂O (85 ml) were added to a shaker tube, and then the tube was sealed and heated at 250°C and 600 psi for 12 hours. After completion of the reaction, chloroform was added, and the reaction solution was transferred to a separatory funnel, and extracted. The extract was dried over MgSO₄ and concentrated, and then the sample was purified by silica gel column chromatography to prepare 4.4 g of Compound 2-22. (Yield: 42%, MS: [M+H]⁺= 615)

### Synthesis Example 2-23

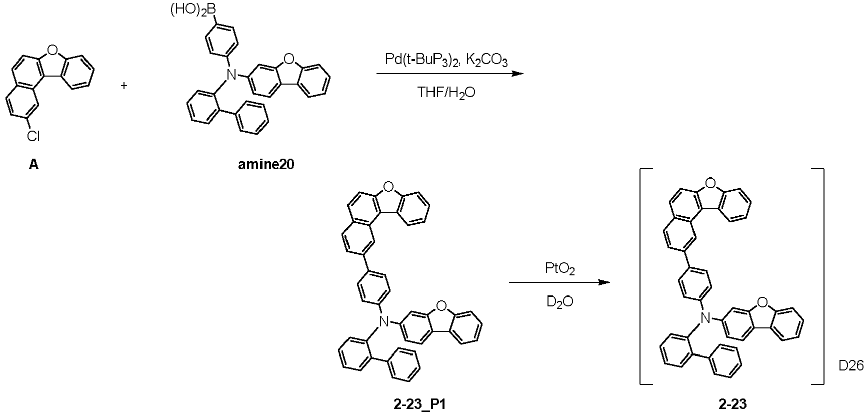

Compound A (15 g, 59.4 mmol) and Compound amine20 (28.4 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 24.6 g of Compound 2-23_P1. (Yield: 66%, MS: [M+H]⁺= 628)

Compound 2-23_P1 (10 g, 15.9 mmol), PtO₂(1.1 g, 4.8 mmol) and D₂O (80 ml) were added to a shaker tube, and then the tube was sealed and heated at 250°C and 600 psi for 12 hours. After completion of the reaction, chloroform was added, and the reaction solution was transferred to a separatory funnel, and extracted. The extract was dried over MgSO₄ and concentrated, and then the sample was purified by silica gel column chromatography to prepare 4.4 g of Compound 2-23. (Yield: 42%, MS: [M+H]⁺= 655)

### Synthesis Example 2-24

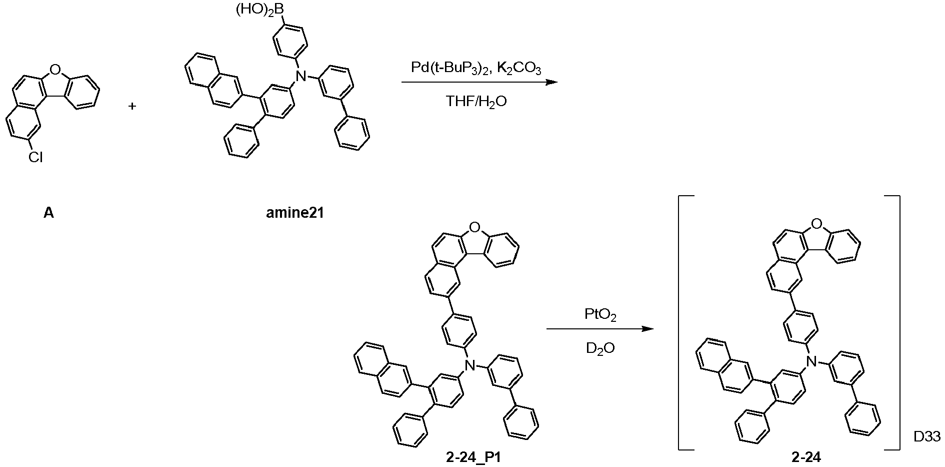

Compound A (15 g, 59.4 mmol) and Compound amine21 (35.4 g, 62.3 mmol) were added to 300 ml of THF, and the mixture was stirred and refluxed. Then, potassium carbonate (24.6 g, 178.1 mmol ) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 28.5 g of Compound 2-24_P1. (Yield: 65%, MS: [M+H]⁺= 740)

Compound 2-24_P1 (10 g, 13.5 mmol), PtO₂ (0.9 g, 4.1 mmol) and D₂O (68 ml) were added to a shaker tube, and then the tube was sealed and heated at 250°C and 600 psi for 12 hours. After completion of the reaction, chloroform was added, and the reaction solution was transferred to a separatory funnel, and extracted. The extract was dried over MgSO₄ and concentrated, and then the sample was purified by silica gel column chromatography to prepare 4.4 g of Compound 2-24. (Yield: 42%, MS: [M+H]⁺= 774)

### Synthesis Example 2-25

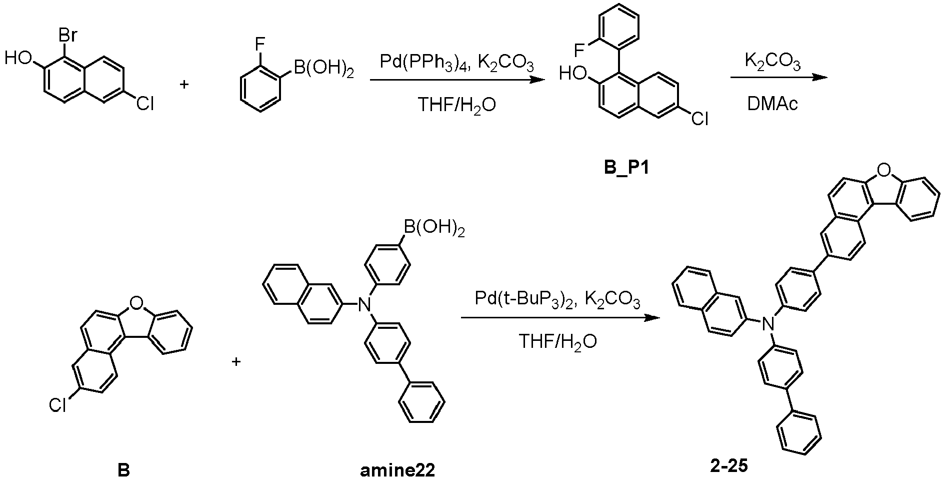

1-Bromo-6-chloronaphthalen-2-ol (15 g, 58.3 mmol) and (2-fluorophenyl)boronic acid (8.6 g, 61.2 mmol) were added to 300 ml of THF, and the mixture was stirred and refluxed. Then, potassium carbonate (24.2 g, 174.8 mmol) was dissolved in 72 ml of water and added thereto, and the mixture was sufficiently stirred and then bis(tri-tert-butylphosphine)palladium(0) (0.7 g, 0.6 mmol) was added. After the reaction for 6 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.5 g of Compound B_P1. (Yield: 66%, MS: [M+H]⁺= 273)

Compound B_P1(15 g, 55 mmol) and potassium carbonate(22.8 g, 165 mmol) were added to 150 ml of DMAc, and the mixture was stirred and refluxed. After the reaction for 5 hours, the reaction mixture was cooled to room temperature, poured into 300 ml of water, solidified and filtered to obtain a solid. This was again dissolved in chloroform, washed twice with water, the organic layer was separated, anhydrous magnesium sulfate was added, stirred, filtered, and the filtrate was distilled under reduced pressure. The concentrated compound was purified by silica gel column chromatography to prepare 8.5 g of Compound B. (Yield 65%, MS: [M+H]⁺= 253)

Compound B (15 g, 59.4 mmol) and Compound amine22 (25.9 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.7 g of Compound 2-25. (Yield: 68%, MS: [M+H]⁺= 588)

### Synthesis Example 2-26

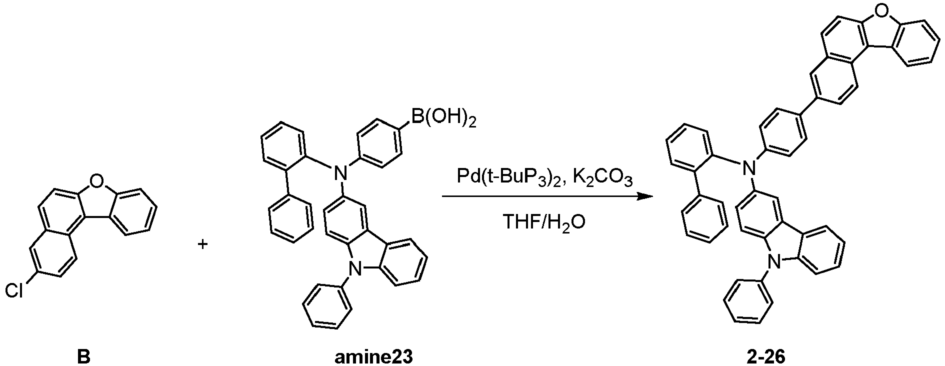

Compound B (15 g, 59.4 mmol) and Compound amine23 (33.1 g, 62.3 mmol) were added to 300 ml of THF, and the mixture was stirred and refluxed. Then, potassium carbonate (24.6 g, 178.1 mol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 27.9 g of Compound 2-26. (Yield: 67%, MS: [M+H]⁺= 703)

### Synthesis Example 2-27

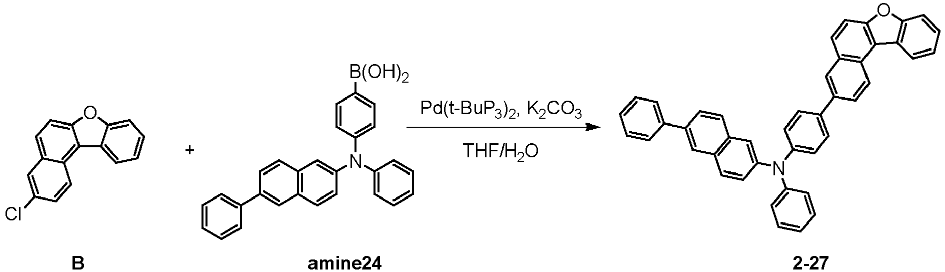

Compound B (15 g, 59.4 mmol) and Compound amine24 (25.9 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 25.4g of Compound 2-27. (Yield: 73%, MS: [M+H]⁺= 588)

### Synthesis Example 2-28

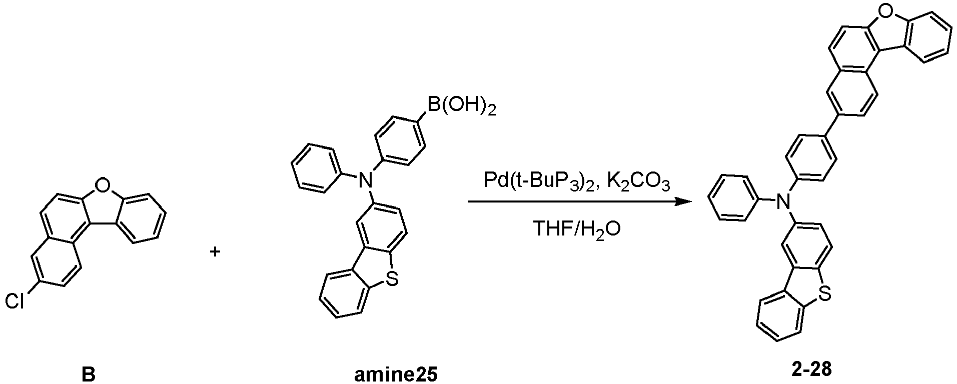

Compound B (15 g, 59.4 mmol) and Compound amine25 (24.6 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.9 g of Compound 2-28. (Yield: 68%, MS: [M+H]⁺= 568)

### Synthesis Example 2-29

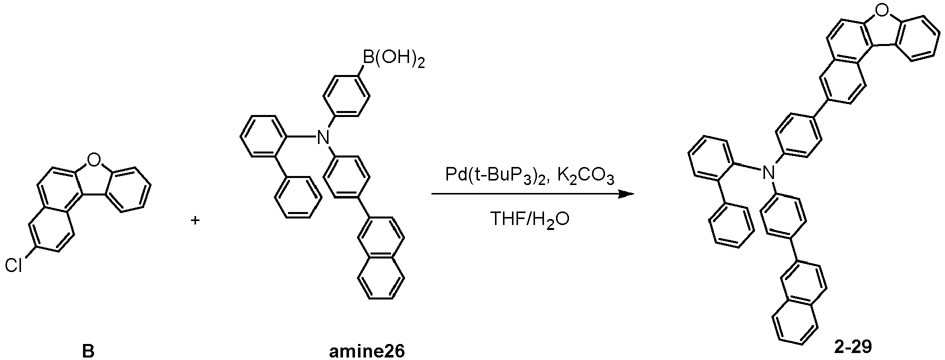

Compound B (15 g, 59.4 mmol) and Compound amine26 (30.6 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.4 g of Compound 2-29. (Yield: 67%, MS: [M+H]⁺= 664)

### Synthesis Example 2-30

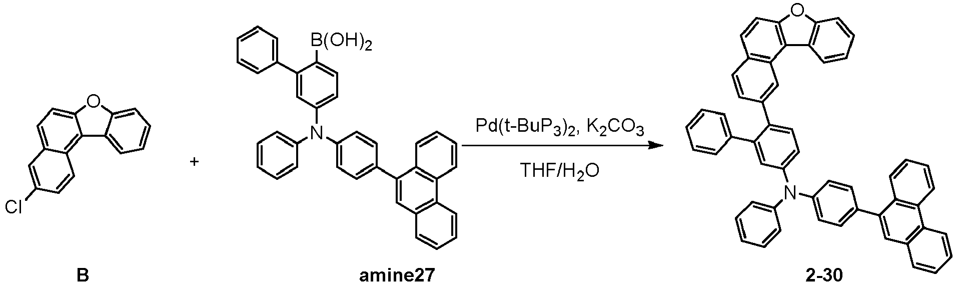

Compound B (15 g, 59.4 mmol) and Compound amine27 (33.7 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 29.6 g of Compound 2-30. (Yield: 70%, MS: [M+H]⁺= 714)

### Synthesis Example 2-31

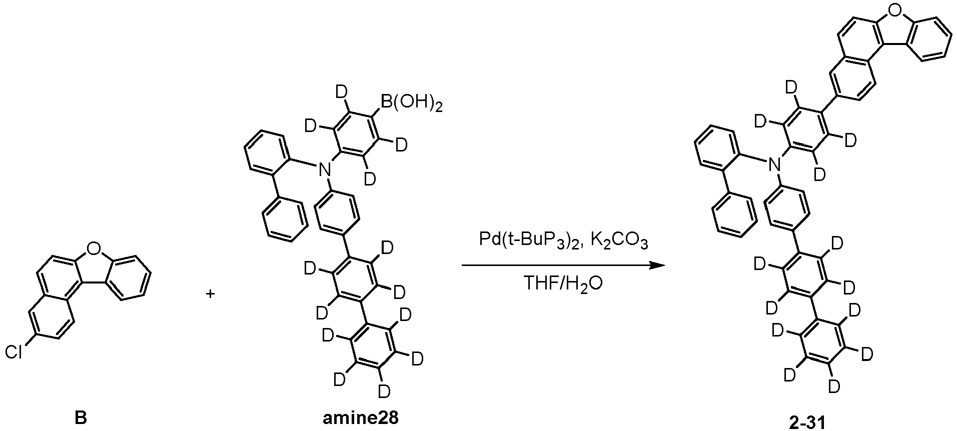

Compound B (15 g, 59.4 mmol) and Compound amine28 (33.1 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 27.5 g of Compound 2-31. (Yield: 66%, MS: [M+H]⁺= 703)

### Synthesis Example 2-32

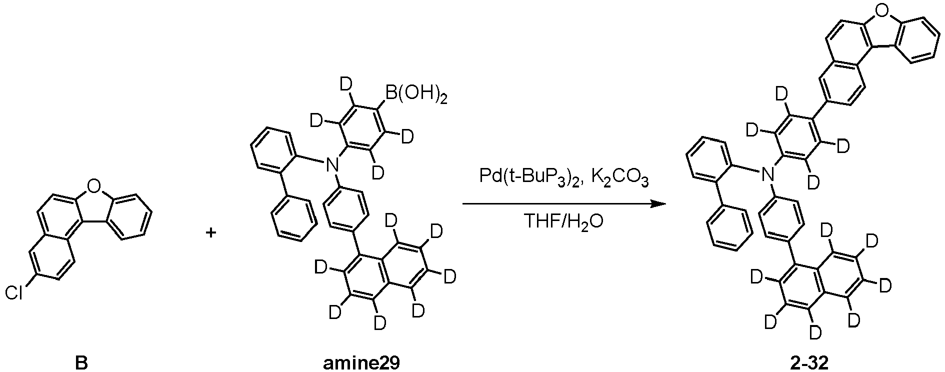

Compound B (15 g, 59.4 mmol) and Compound amine29 (31.3 g, 62.3 mmol) added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26 g of Compound 2-32. (Yield: 65%, MS: [M+H]⁺= 675)

### Synthesis Example 2-33

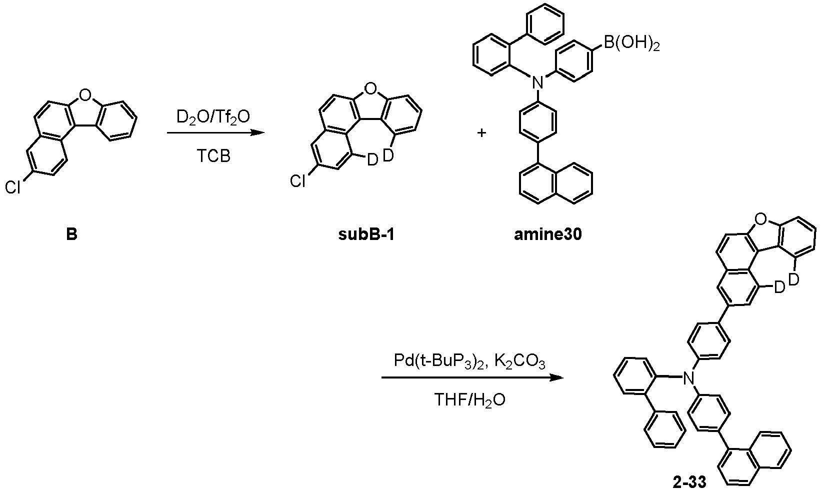

Trifluoromethanesulfonic anhydride (33.5 g, 118.7 mmol) and deuterium oxide (11.9 g, 593.6 mmol) were added at 0°C and stirred for 5 hours to prepare a solution. Compound B (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of compound A and 1,2,4-trichlorobenzene, and the mixture was stirred while heating to 140°C and then keeping that temperature. After the reaction for 4 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.5 g of Compound subB-1. (Yield: 43%, MS: [M+H]⁺= 255)

Compound subB-1 (15 g, 58.9 mmol) and Compound amine30 (30.4 g, 61.8 mmol) were added to 300 ml of THF, and the mixture was stirred and refluxed. Then, potassium carbonate (24.4 g, 176.7 mmol) was dissolved in 73 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 27.8 g of Compound 2-33. (Yield: 71%, MS: [M+H]⁺= 666)

### Synthesis Example 2-34

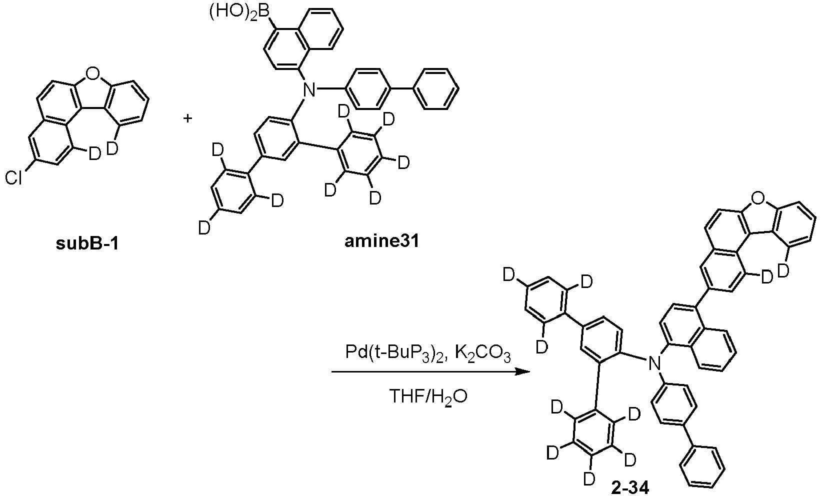

Compound subB-1 (15 g, 58.9 mmol) and Compound amine31 (35.6 g, 61.8 mmol) were added to 300 ml of THF, and the mixture was stirred and refluxed. Then, potassium carbonate (24.4 g, 176.7 mmol) was dissolved in 73 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 33.1 g of Compound 2-34. (Yield: 75%, MS: [M+H]⁺= 750)

### Synthesis Example 2-35

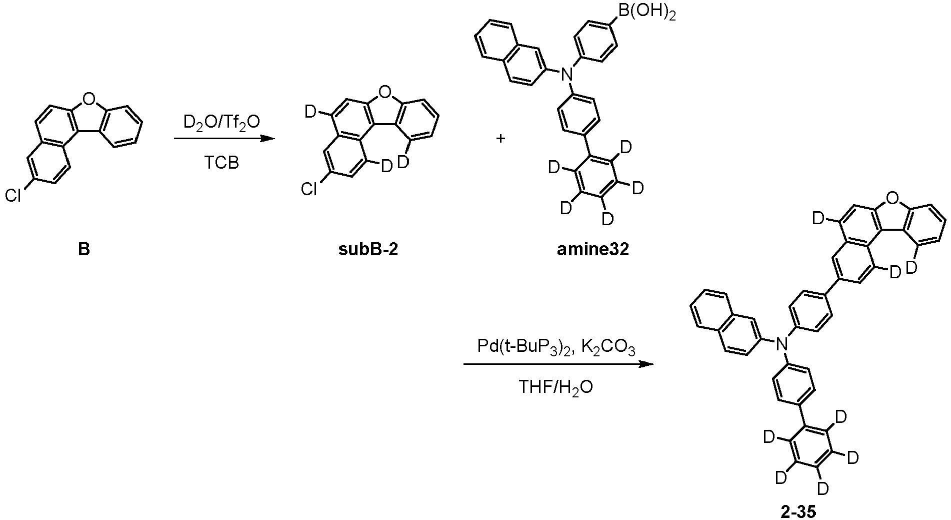

Trifluoromethanesulfonic anhydride (50.2 g, 178.1 mmol) and deuterium oxide (17.8 g, 890.4 mmol) were added at 0°C and stirred for 6 hours to prepare a solution. Compound B (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of compound A and 1,2,4-trichlorobenzene, and the mixture was stirred while heating to 140°C and then keeping that temperature. After the reaction for 7 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.7 g of Compound subB-2. (Yield: 44%, MS: [M+H]⁺= 256)

Compound subB-2 (15 g, 58.7 mmol) and Compound amine32 (25.9 g, 61.6 mmol) were added to 300 ml of THF, and the mixture was stirred and refluxed. Then, potassium carbonate (24.3 g, 176 mmol) was dissolved in 73 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.2 g of Compound 2-35. (Yield: 75%, MS: [M+H]⁺= 596)

### Synthesis Example 2-36

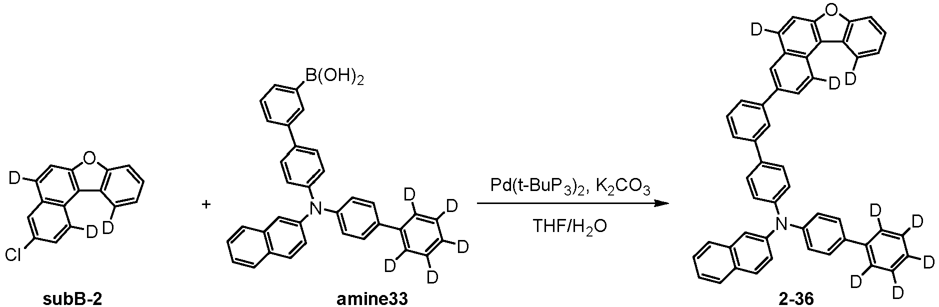

Compound subB-2 (15 g, 58.7 mmol) and Compound amine33 (30.6 g, 61.6 mmol) were added to 300 ml of THF, and the mixture was stirred and refluxed. Then, potassium carbonate (24.3 g, 176 mmol) was dissolved in 73 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 27.6 g of Compound 2-36. (Yield: 70%, MS: [M+H]⁺= 672)

### Synthesis Example 2-37

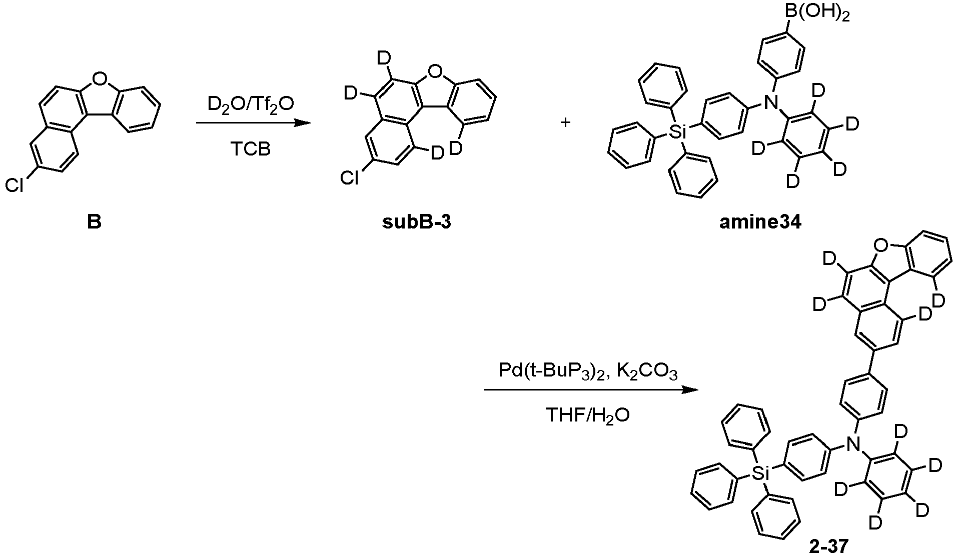

Trifluoromethanesulfonic anhydride (67 g, 237.4 mmol) and deuterium oxide (23.8 g, 1187.2 mmol) were added at 0°C and stirred for 6 hours to prepare a solution. Compound B (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of compound B and 1,2,4-trichlorobenzene, and the mixture was stirred while heating to 140°C and then keeping that temperature. After the reaction for 10 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 5.9 g of Compound subB-3. (Yield: 39%, MS: [M+H]⁺= 258)

Compound subB-3 (15 g, 58.4 mmol) and Compound amine34 (33.9 g, 61.4 mmol) were added to 300 ml of THF, and the mixture was stirred and refluxed. Then, potassium carbonate (24.2 g, 175.3 mmol) was dissolved in 73 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 30.6 g of Compound 2-37. (Yield: 72%, MS: [M+H]⁺= 729)

### Synthesis Example 2-38

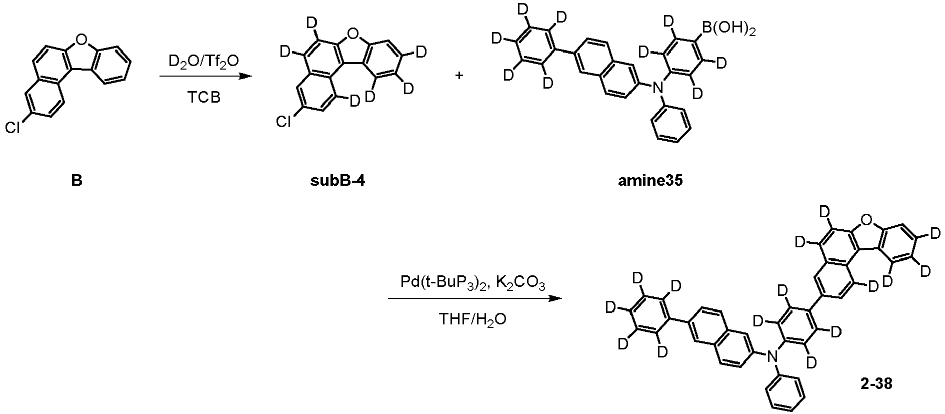

Trifluoromethanesulfonic anhydride (100.5 g, 356.2 mmol) and deuterium oxide (35.7 g, 1780.8 mmol) were added at 0°C and stirred for 6 hours to prepare a solution. Compound B (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of compound B and 1,2,4-trichlorobenzene, and the mixture was stirred while heating to 140°C and then keeping that temperature. After the reaction for 17 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 5.4 g of Compound subB-4. (Yield: 35%, MS: [M+H]⁺= 259)

Compound subB-4 (15 g, 58 mmol) and Compound amine35 (25.8 g, 60.9 mmol) were added to 300 ml of THF, and the mixture was stirred and refluxed. Then, potassium carbonate (24 g, 173.9 mmol) was dissolved in 72 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.7 g of Compound 2-38. (Yield: 65%, MS: [M+H]⁺= 603)

### Synthesis Example 2-39

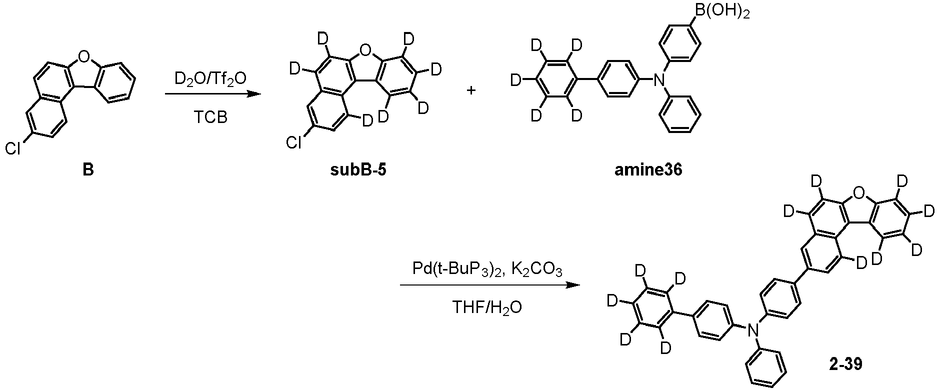

Trifluoromethanesulfonic anhydride (117.2 g, 415.5 mmol) and deuterium oxide (41.6 g, 2077.6 mmol) were added at 0°C and stirred for 6 hours to prepare a solution. Compound B (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of compound B and 1,2,4-trichlorobenzene, and the mixture was stirred while heating to 140°C and then keeping that temperature. After the reaction for 21 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 5.7 g of compound subB-5. (Yield: 37%, MS: [M+H]⁺= 260)

Compound subB-5 (15 g, 57.8 mmol) and Compound amine36 (22.5 g, 60.6 mmol) were added to 300 ml of THF, and the mixture was stirred and refluxed. Then, potassium carbonate (23.9 g, 173.3 mmol) was dissolved in 72 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.2 g of Compound 2-39. (Yield: 70%, MS: [M+H]⁺= 550)

### Synthesis Example 2-40

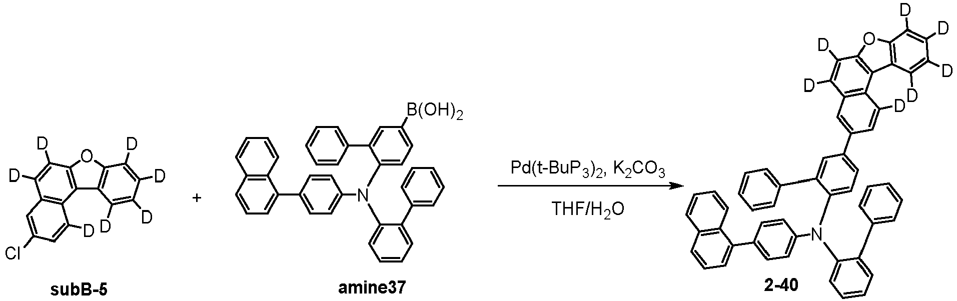

Compound subB-5 (15 g, 57.8 mmol) and Compound amine37 (34.4 g, 60.6 mmol) were added to 300 ml of THF, and the mixture was stirred and refluxed. Then, potassium carbonate (23.9 g, 173.3 mmol) was dissolved in 72 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 30.2 g of Compound 2-40. (Yield: 70%, MS: [M+H]⁺= 747)

### Synthesis Example 2-41

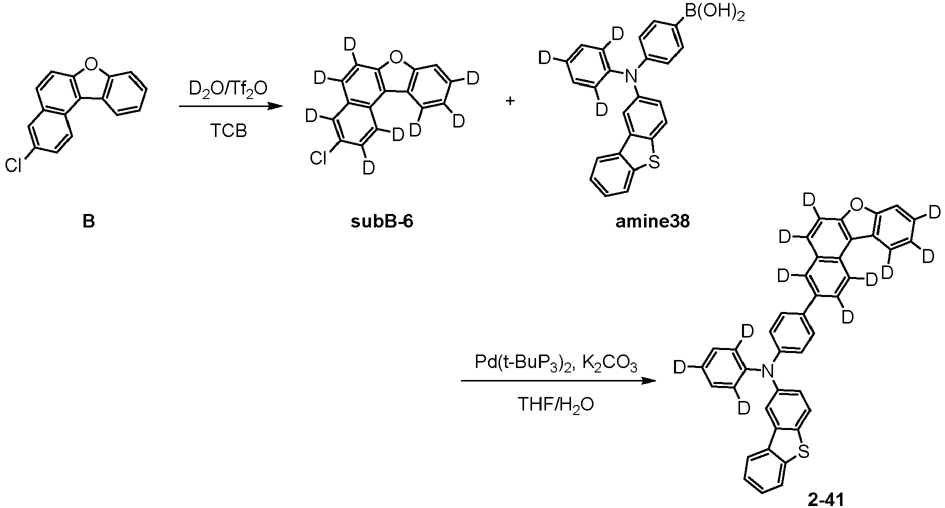

Trifluoromethanesulfonic anhydride (134 g, 474.9 mmol) and deuterium oxide (47.6 g, 2374.4 mmol) were added at 0°C and stirred for 6 hours to prepare a solution. Compound B (15 g, 59.4 mmol) was added to 120 ml of 1,2,4-trichlorobenzene, and the mixture was stirred. Then, the prepared mixed solution of trifluoromethanesulfonic anhydride and deuterium oxide was slowly added dropwise to the mixed solution of compound B and 1,2,4-trichlorobenzene, and the mixture was stirred while heating to 140°C and then keeping that temperature. After the reaction for 25 hours, the reaction mixture was cooled to room temperature, and the organic layer and the aqueous layer were separated. Then, the organic layer was neutralized with an aqueous potassium carbonate solution. After washing twice with water, the organic layer was separated, anhydrous magnesium sulfate was added thereto, stirred, then filtered, and the filtrate was distilled under reduced pressure. The concentrated compound was purified by silica gel column chromatography to prepare 6.6 g of Compound subB-6. (Yield: 43%, MS: [M+H]⁺= 261)

Compound subB-6 (15 g, 57.5 mmol) and Compound amine38 (24.1 g, 60.4 mmol) were added to 300 ml of THF, and the mixture was stirred and refluxed. Then, potassium carbonate (23.9 g, 172.6 mmol) was dissolved in 72 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.3 g of Compound 2-41. (Yield: 67%, MS: [M+H]⁺= 579)

### Synthesis Example 2-42

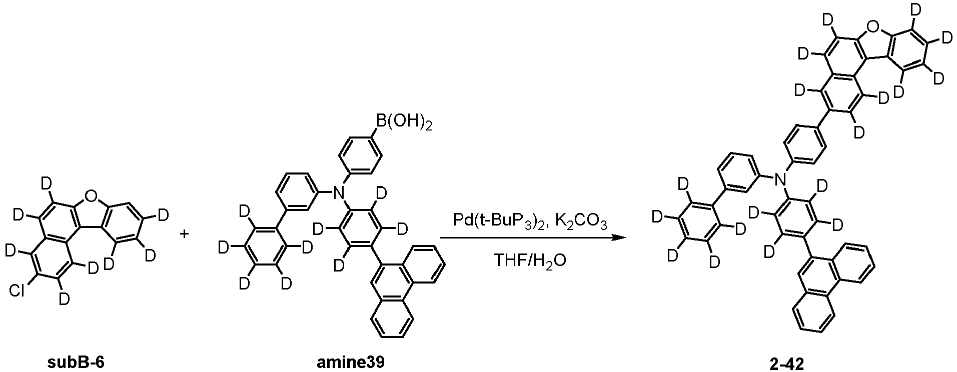

Compound subB-6 (15 g, 57.5 mmol) and Compound amine39 (33.3 g, 60.4 mmol) were added to 300 ml of THF, and the mixture was stirred and refluxed. Then, potassium carbonate (23.9 g, 172.6 mmol) was dissolved in 72 ml of water and added thereto, and the mixture was sufficiently stirred and then bis(tri-tert-butylphosphine)palladium(0) (0.3 g, 0.6 mmol) was added. After the reaction for 3 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 30.3 g of Compound 2-42. (Yield: 72%, MS: [M+H]⁺= 732)

### Synthesis Example 2-43

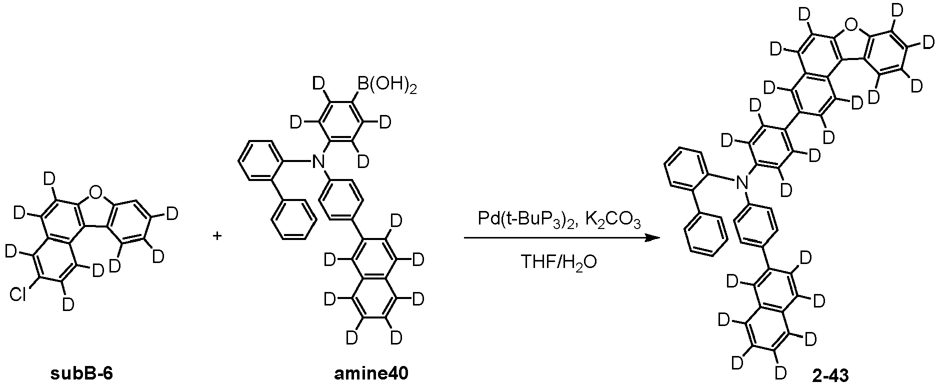

Compound subB-6 (15 g, 57.5 mmol) and Compound amine40 (30.3 g, 60.4 mmol) were added to 300 ml of THF, and the mixture was stirred and refluxed. Then, potassium carbonate (23.9 g, 172.6 mmol) was dissolved in 72 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.7 g of Compound 2-43. (Yield: 68%, MS: [M+H]⁺= 684)

### Synthesis Example 2-44

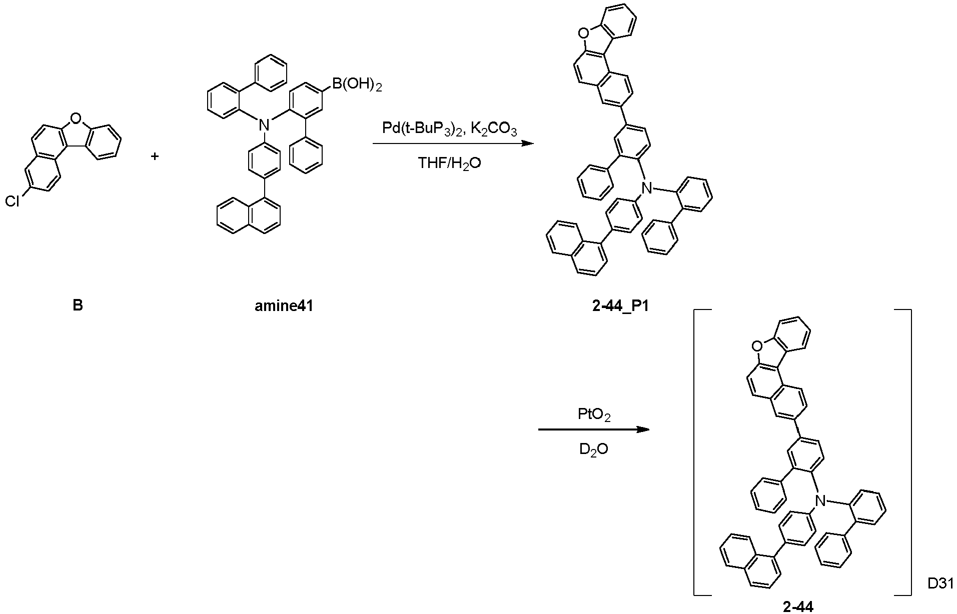

Compound B (15 g, 59.4 mmol) and Compound amine41 (35.4 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 32.5 g of Compound 2-44_P1. (Yield: 74%, MS: [M+H]+= 740)

Compound 2-44_P1 (10 g, 13.5 mmol), PtO₂ (0.9 g, 4.1 mmol) and D₂O (68 ml) were added to a shaker tube, and then the tube was sealed and heated at 250°C and 600 psi for 12 hours. After completion of the reaction, chloroform was added, and the reaction solution was transferred to a separatory funnel, and extracted. The extract was dried over MgSO₄ and concentrated, and then the sample was purified by silica gel column chromatography to prepare 4.6 g of Compound 2-44. (Yield: 44%, MS: [M+H]⁺= 772)

### Synthesis Example 2-45

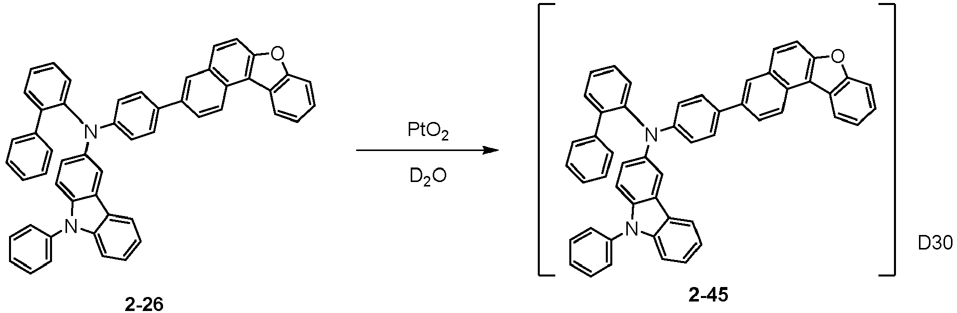

Compound 2-26 (10 g, 14.2 mmol), PtO₂ (1 g, 4.3 mmol), D₂O (71 ml) were added to a shaker tube, and then the tube was sealed and heated at 250°C and 600 psi for 12 hours. After completion of the reaction, chloroform was added, and the reaction solution was transferred to a separatory funnel, and extracted. The extract was dried over MgSO₄ and concentrated, and then the sample was purified by silica gel column chromatography to prepare 3.4 g of Compound 2-45. (Yield: 33%, MS: [M+H]⁺= 734)

### Synthesis Example 2-46

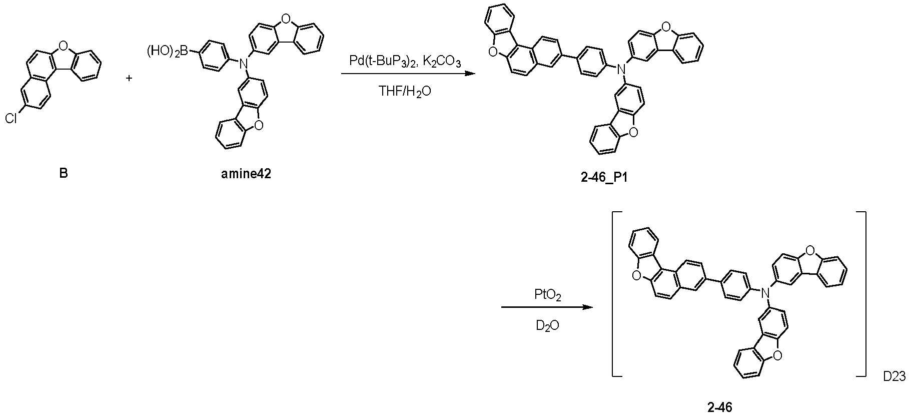

Compound B (15 g, 59.4 mmol) and Compound amine42 (29.3 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 4 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 27.8 g of Compound 2-46_P1. (Yield: 73%, MS: [M+H]⁺= 642)

Compound 2-46_P1 (10 g, 15.6 mmol), PtO₂ (1.1 g, 4.7 mmol) and D₂O (78 ml) were added to a shaker tube, and then the tube was sealed and heated at 250°C and 600 psi for 12 hours. After completion of the reaction, chloroform was added, and the reaction solution was transferred to a separatory funnel, and extracted. The extract was dried over MgSO₄ and concentrated, and then the sample was purified by silica gel column chromatography to prepare 3.2 g of Compound 2-46. (Yield: 31%, MS: [M+H]⁺= 666)

### Synthesis Example 2-47

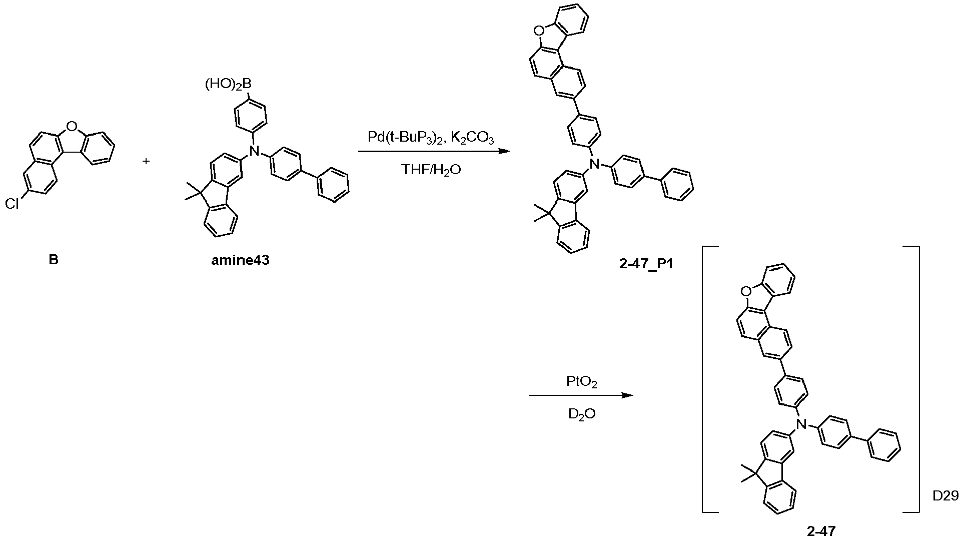

Compound B (15 g, 59.4 mmol) and Compound amine43 (30 g, 62.3 mmol) were added to 300 ml of THF, and the mixture was stirred and refluxed. Then, potassium carbonate (24.6 g, 178.1 mmol) was dissolved in 74 ml of water and added thereto, and the mixture was sufficiently stirred and then bis(tri-tert-butylphosphine)palladium(0) (0.3 g, 0.6 mmol) was added. After the reaction for 5 hours, the reaction mixture was cooled to room temperature, and the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.4 g of Compound 2-47_P1. (Yield: 68%, MS: [M+H]⁺= 654)

Compound 2-47_P1 (10 g, 15.3 mmol), PtO₂ (1 g, 4.6 mmol) and D₂O (76 ml) were added to a shaker tube, and then the tube was sealed and heated at 250°C and 600 psi for 12 hours. After completion of the reaction, chloroform was added, and the reaction solution was transferred to a separatory funnel, and extracted. The extract was dried over MgSO₄ and concentrated, and then the sample was purified by silica gel column chromatography to prepare 4.6 g of Compound 2-47. (Yield: 44%, MS: [M+H]⁺= 684)

### Example 1

A glass substrate on which a thin film of ITO (indium tin oxide) was coated in a thickness of 1000 Å was put into distilled water containing the detergent dissolved therein and washed by the ultrasonic wave. In this case, the used detergent was a product commercially available from Fisher Co. and the distilled water was one which had been twice filtered by using a filter commercially available from Millipore Co. The ITO was washed for 30 minutes, and ultrasonic washing was then repeated twice for 10 minutes by using distilled water. After the washing with distilled water was completed, the substrate was ultrasonically washed with isopropyl alcohol, acetone, and methanol solvent, and dried, after which it was transported to a plasma cleaner. Then, the substrate was cleaned with oxygen plasma for 5 minutes, and then transferred to a vacuum evaporator.

On the ITO transparent electrode thus prepared, the following compound HI-1 was formed in a thickness of 1150Å as a hole injection layer, but the following compound A-1 was p-doped at a concentration of 1.5 wt.%. The following compound HT-1 was vacuum deposited on the hole injection layer to form a hole transport layer with a film thickness of 800Å. Then, the following compound EB-1 was vacuum deposited on the hole transport layer to a film thickness of 150 Å to form an electron blocking layer. Then, the previously prepared Compound 1-1, Compound 2-2 and Compound Dp-7 were vacuum deposited in a weight ratio of 49:49:2 on the EB-1 deposited film to form a red light emitting layer with a film thickness of 400 Å. The following compound HB-1 was vacuum deposited on the light emitting layer to a film thickness of 30 Å to form a hole blocking layer. The following compound ET-1 and the following compound LiQ were vacuum deposited in a weight ratio of 2:1 on the hole blocking layer to form an electron injection and transport layer with a film thickness of 300Å. Lithium fluoride (LiF) and aluminum were sequentially deposited to have a thickness of 12Å and 1,00Å, respectively, on the electron injection and transport layer, thereby forming a cathode.

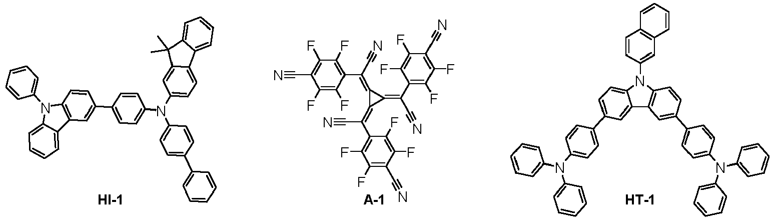

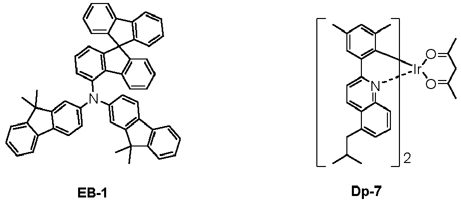

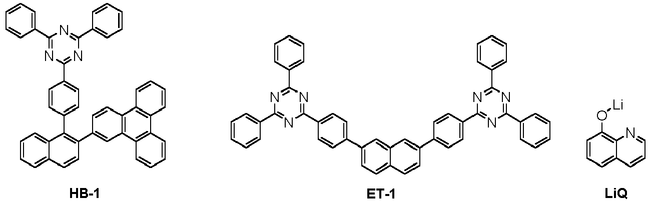

In the above-mentioned processes, the deposition rates of the organic materials were maintained at 0.4 to 0.7 Å/sec, the deposition rates of lithium fluoride and the aluminum of the cathode were maintained at 0.3 Å/sec and 2 Å/sec, respectively, and the degree of vacuum during the deposition was maintained at 2×10⁻⁷ to 5×10⁻⁶ torr, thereby manufacturing an organic light emitting device.

### Examples 2 to 245

The organic light emitting devices were manufactured in the same manner as in Example 1, except that in the organic light emitting device of Example 1, the compound represented by Chemical Formula 1 and the compound represented by Chemical Formula 2 shown in Tables 1 to 6 below were co-deposited and used in a weight ratio of 1:1 instead of Compound 1-1 and Compound 2-2 as the first host and the second host.

### Comparative Examples 1 to 60

The organic light emitting devices were manufactured in the same manner as in Example 1, except that in the organic light emitting device of Example 1, the following Comparative Compounds A-1 to A-12 were used instead of Compound 1-1 as the first host, and the compound represented by Chemical Formula 2 shown in Tables 7 and 8 below was used instead of Compound 2-2 as the second host, which were co-deposited and used in a weight ratio of 1:1. Specific structures of Compounds A-1 to A-12 are as follows.

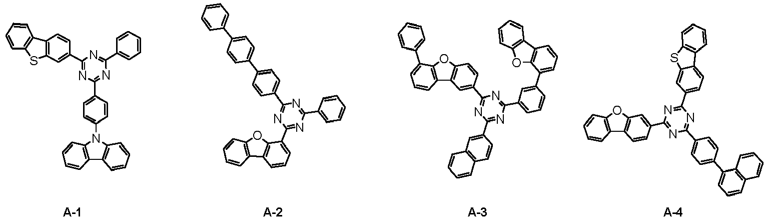

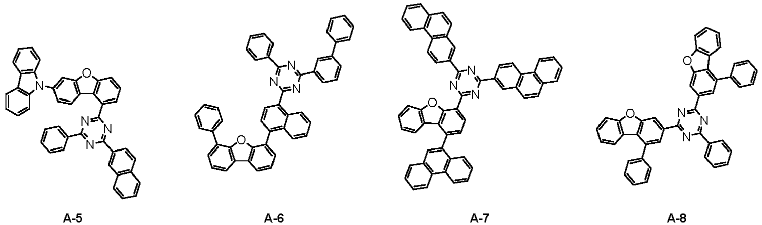

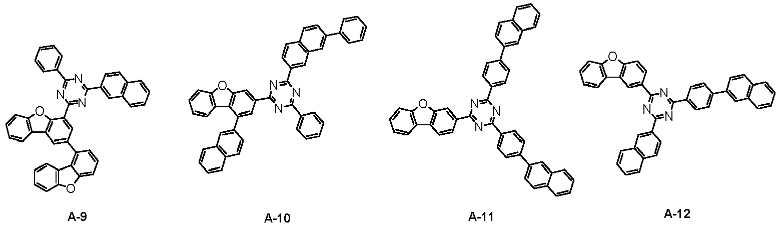

### Comparative Examples 61 to 172

The organic light emitting devices were manufactured in the same manner as in Example 1, except that in the organic light emitting device of Example 1, the compound represented by Chemical Formula 1 shown in Tables 9 to 11 below was used instead of Compound 1-1 as the first host, and the following Comparative Compounds B-1 to B-14 was used instead of Compound 2-2 as the second host, which were co-deposited and used in a weight ratio of 1:1. Specific structures of Compounds B-1 to B-14 are as follows.

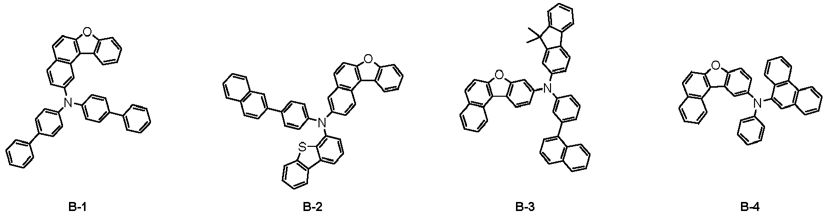

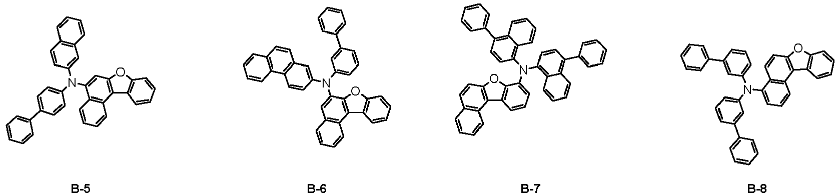

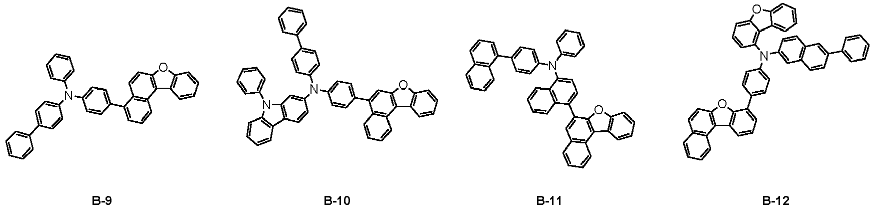

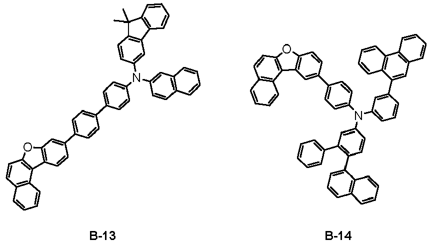

### Experimental Example

The voltage and efficiency were measured (based on 15 mA/cm²) by applying a current to the organic light emitting devices manufactured in Examples 1 to 245 and Comparative Examples 1 to 172, and the results are shown in Tables 1 to 11 below. Lifetime T95 was measured based on 7000 nits, and T95 means the time required for the lifetime to be reduced to 95% of the initial lifetime.

**[Table 1]**

| Category | First host | Second host | Driving voltage(V) | Efficiency (cd/A) | Lifetime T95(hr) | Luminescent color |
|---|---|---|---|---|---|---|
| Example 1 | Compound 1-1 | Compound 2-1 | 3.42 | 24.03 | 317 | Red |
| Example 2 | | Compound 2-13 | 3.38 | 23.49 | 313 | Red |
| Example 3 | | Compound 2-24 | 3.41 | 23.92 | 320 | Red |
| Example 4 | | Compound 2-30 | 3.47 | 23.57 | 323 | Red |
| Example 5 | | Compound 2-39 | 3.43 | 23.96 | 324 | Red |
| Example 6 | Compound 1-3 | Compound 2-2 | 3.55 | 24.03 | 288 | Red |
| Example 7 | | Compound 2-10 | 3.59 | 23.49 | 277 | Red |
| Example 8 | | Compound 2-22 | 3.57 | 23.50 | 312 | Red |
| Example 9 | | Compound 2-31 | 3.58 | 23.57 | 276 | Red |
| Example 10 | | Compound 2-40 | 3.54 | 23.96 | 287 | Red |
| Example 11 | Compound 1-4 | Compound 2-3 | 3.60 | 23.13 | 284 | Red |
| Example 12 | | Compound 2-15 | 3.52 | 23.15 | 305 | Red |
| Example 13 | | Compound 2-21 | 3.60 | 22.80 | 289 | Red |
| Example 14 | | Compound 2-34 | 3.57 | 22.88 | 284 | Red |
| Example 15 | | Compound 2-41 | 3.53 | 23.61 | 283 | Red |
| Example 16 | Compound 1-7 | Compound 2-4 | 3.59 | 21.96 | 230 | Red |
| Example 17 | | Compound 2-14 | 3.59 | 21.49 | 247 | Red |
| Example 18 | | Compound 2-25 | 3.61 | 21.93 | 243 | Red |
| Example 19 | | Compound 2-33 | 3.63 | 21.27 | 250 | Red |
| Example 20 | | Compound 2-42 | 3.59 | 21.82 | 234 | Red |
| Example 21 | Compound 1-8 | Compound 2-5 | 3.60 | 21.94 | 255 | Red |
| Example 22 | | Compound 2-13 | 3.63 | 21.49 | 223 | Red |
| Example 23 | | Compound 2-26 | 3.61 | 21.21 | 244 | Red |
| Example 24 | | Compound 2-34 | 3.59 | 21.42 | 235 | Red |
| Example 25 | | Compound 2-43 | 3.62 | 21.64 | 255 | Red |
| Example 26 | Compound 1-9 | Compound 2-3 | 3.45 | 22.00 | 244 | Red |
| Example 27 | | Compound 2-16 | 3.51 | 22.21 | 266 | Red |
| Example 28 | | Compound 2-24 | 3.47 | 22.85 | 240 | Red |
| Example 29 | | Compound 2-36 | 3.45 | 22.53 | 263 | Red |
| Example 30 | | Compound 2-47 | 3.51 | 22.13 | 255 | Red |
| Example 31 | Compound 1-11 | Compound 2-6 | 3.40 | 24.60 | 318 | Red |
| Example 32 | | Compound 2-14 | 3.41 | 23.53 | 302 | Red |
| Example 33 | | Compound 2-27 | 3.37 | 24.55 | 336 | Red |
| Example 34 | | Compound 2-34 | 3.47 | 24.01 | 299 | Red |
| Example 35 | | Compound 2-45 | 3.44 | 23.55 | 299 | Red |
| Example 36 | Compound 1-13 | Compound 2-9 | 3.42 | 24.45 | 297 | Red |
| Example 37 | | Compound 2-19 | 3.40 | 24.00 | 333 | Red |
| Example 38 | | Compound 2-29 | 3.42 | 24.20 | 302 | Red |
| Example 39 | | Compound 2-39 | 3.37 | 23.76 | 316 | Red |
| Example 40 | | Compound 2-45 | 3.43 | 24.50 | 300 | Red |
| Example 41 | Compound 1-16 | Compound 2-10 | 3.59 | 21.96 | 230 | Red |
| Example 42 | | Compound 2-20 | 3.59 | 21.49 | 247 | Red |
| Example 43 | | Compound 2-30 | 3.61 | 21.93 | 243 | Red |
| Example 44 | | Compound 2-40 | 3.63 | 21.27 | 250 | Red |
| Example 45 | | Compound 2-47 | 3.59 | 21.82 | 234 | Red |

**[Table 2]**

| Category | First host | Second host | Driving voltage(V) | Efficiency (cd/A) | Lifetime T95(hr) | Luminescent color |
|---|---|---|---|---|---|---|
| Example 46 | Compound 1-17 | Compound 2-1 | 3.60 | 21.94 | 251 | Red |
| Example 47 | | Compound 2-11 | 3.59 | 21.96 | 283 | Red |
| Example 48 | | Compound 2-22 | 3.61 | 21.21 | 244 | Red |
| Example 49 | | Compound 2-30 | 3.59 | 21.42 | 235 | Red |
| Example 50 | | Compound 2-39 | 3.62 | 21.64 | 255 | Red |
| Example 51 | Compound 1-18 | Compound 2-2 | 3.58 | 22.00 | 230 | Red |
| Example 52 | | Compound 2-12 | 3.54 | 22.21 | 247 | Red |
| Example 53 | | Compound 2-22 | 3.61 | 22.85 | 243 | Red |
| Example 54 | | Compound 2-31 | 3.58 | 22.53 | 250 | Red |
| Example 55 | | Compound 2-40 | 3.55 | 22.13 | 234 | Red |
| Example 56 | Compound 1-19 | Compound 2-3 | 3.48 | 24.18 | 305 | Red |
| Example 57 | | Compound 2-13 | 3.45 | 24.52 | 337 | Red |
| Example 58 | | Compound 2-23 | 3.42 | 24.48 | 323 | Red |
| Example 59 | | Compound 2-32 | 3.43 | 24.49 | 314 | Red |
| Example 60 | | Compound 2-41 | 3.46 | 24.32 | 314 | Red |
| Example 61 | Compound 1-21 | Compound 2-4 | 3.57 | 24.10 | 290 | Red |
| Example 62 | | Compound 2-14 | 3.61 | 23.90 | 287 | Red |
| Example 63 | | Compound 2-24 | 3.58 | 22.86 | 302 | Red |
| Example 64 | | Compound 2-33 | 3.53 | 23.02 | 304 | Red |
| Example 65 | | Compound 2-42 | 3.59 | 23.26 | 290 | Red |
| Example 66 | Compound 1-23 | Compound 2-5 | 3.57 | 22.84 | 253 | Red |
| Example 67 | | Compound 2-15 | 3.61 | 22.17 | 229 | Red |
| Example 68 | | Compound 2-25 | 3.58 | 22.53 | 241 | Red |
| Example 69 | | Compound 2-34 | 3.53 | 23.01 | 255 | Red |
| Example 70 | | Compound 2-43 | 3.59 | 22.88 | 235 | Red |
| Example 71 | Compound 1-24 | Compound 2-6 | 3.60 | 22.64 | 255 | Red |
| Example 72 | | Compound 2-16 | 3.53 | 22.93 | 227 | Red |
| Example 73 | | Compound 2-26 | 3.59 | 22.42 | 238 | Red |
| Example 74 | | Compound 2-36 | 3.56 | 22.92 | 249 | Red |
| Example 75 | | Compound 2-44 | 3.61 | 22.47 | 243 | Red |
| Example 76 | Compound 1-25 | Compound 2-7 | 3.52 | 22.16 | 264 | Red |
| Example 77 | | Compound 2-17 | 3.49 | 22.78 | 253 | Red |
| Example 78 | | Compound 2-27 | 3.46 | 22.78 | 263 | Red |
| Example 79 | | Compound 2-37 | 3.45 | 22.04 | 257 | Red |
| Example 80 | | Compound 2-45 | 3.45 | 22.19 | 241 | Red |
| Example 81 | Compound 1-28 | Compound 2-3 | 3.46 | 24.15 | 341 | Red |
| Example 82 | | Compound 2-18 | 3.38 | 24.11 | 324 | Red |
| Example 83 | | Compound 2-28 | 3.46 | 24.44 | 322 | Red |
| Example 84 | | Compound 2-38 | 3.45 | 24.35 | 318 | Red |
| Example 85 | | Compound 2-42 | 3.39 | 24.50 | 318 | Red |
| Example 86 | Compound 1-29 | Compound 2-9 | 3.48 | 23.56 | 318 | Red |
| Example 87 | | Compound 2-19 | 3.47 | 23.61 | 302 | Red |
| Example 88 | | Compound 2-29 | 3.45 | 24.24 | 332 | Red |
| Example 89 | | Compound 2-39 | 3.41 | 23.92 | 314 | Red |
| Example 90 | | Compound 2-45 | 3.43 | 23.80 | 327 | Red |

**[Table 3]**

| Category | First host | Second host | Driving voltage(V) | Efficiency (cd/A) | Lifetime T95(hr) | Luminescent color |
|---|---|---|---|---|---|---|
| Example 91 | Compound 1-30 | Compound 2-10 | 3.52 | 23.90 | 271 | Red |
| Example 92 | | Compound 2-22 | 3.53 | 23.92 | 308 | Red |
| Example 93 | | Compound 2-30 | 3.58 | 23.82 | 297 | Red |
| Example 94 | | Compound 2-40 | 3.58 | 23.75 | 297 | Red |
| Example 95 | | Compound 2-47 | 3.58 | 24.02 | 276 | Red |
| Example 96 | Compound 1-32 | Compound 2-1 | 3.55 | 22.90 | 273 | Red |
| Example 97 | | Compound 2-11 | 3.54 | 22.89 | 306 | Red |
| Example 98 | | Compound 2-21 | 3.54 | 23.30 | 300 | Red |
| Example 99 | | Compound 2-30 | 3.56 | 24.08 | 275 | Red |
| Example 100 | | Compound 2-39 | 3.60 | 24.01 | 286 | Red |
| Example 101 | Compound 1-33 | Compound 2-2 | 3.52 | 22.85 | 285 | Red |
| Example 102 | | Compound 2-14 | 3.52 | 22.87 | 279 | Red |
| Example 103 | | Compound 2-22 | 3.53 | 22.90 | 282 | Red |
| Example 104 | | Compound 2-31 | 3.54 | 22.96 | 263 | Red |
| Example 105 | | Compound 2-40 | 3.45 | 22.71 | 235 | Red |
| Example 106 | Compound 1-36 | Compound 2-3 | 3.53 | 22.97 | 260 | Red |
| Example 107 | | Compound 2-13 | 3.50 | 22.89 | 277 | Red |
| Example 108 | | Compound 2-23 | 3.45 | 22.38 | 243 | Red |
| Example 109 | | Compound 2-32 | 3.49 | 22.09 | 245 | Red |
| Example 110 | | Compound 2-41 | 3.49 | 22.78 | 260 | Red |
| Example 111 | Compound 1-38 | Compound 2-4 | 3.56 | 22.05 | 225 | Red |
| Example 112 | | Compound 2-14 | 3.53 | 22.62 | 223 | Red |
| Example 113 | | Compound 2-24 | 3.56 | 22.11 | 240 | Red |
| Example 114 | | Compound 2-33 | 3.54 | 22.68 | 222 | Red |
| Example 115 | | Compound 2-42 | 3.53 | 22.99 | 251 | Red |
| Example 116 | Compound 1-40 | Compound 2-5 | 3.55 | 22.03 | 231 | Red |
| Example 117 | | Compound 2-15 | 3.58 | 22.55 | 224 | Red |
| Example 118 | | Compound 2-25 | 3.56 | 22.09 | 230 | Red |
| Example 119 | | Compound 2-34 | 3.60 | 22.47 | 252 | Red |
| Example 120 | | Compound 2-43 | 3.54 | 22.63 | 240 | Red |
| Example 121 | Compound 1-42 | Compound 2-6 | 3.61 | 20.59 | 297 | Red |
| Example 122 | | Compound 2-16 | 3.45 | 20.43 | 295 | Red |
| Example 123 | | Compound 2-26 | 3.62 | 20.18 | 285 | Red |
| Example 124 | | Compound 2-36 | 3.48 | 20.64 | 286 | Red |
| Example 125 | | Compound 2-44 | 3.55 | 20.38 | 275 | Red |
| Example 126 | Compound 1-44 | Compound 2-2 | 3.38 | 24.38 | 322 | Red |
| Example 127 | | Compound 2-14 | 3.46 | 24.59 | 338 | Red |
| Example 128 | | Compound 2-27 | 3.37 | 23.78 | 326 | Red |
| Example 129 | | Compound 2-37 | 3.48 | 23.94 | 309 | Red |
| Example 130 | | Compound 2-45 | 3.40 | 23.78 | 326 | Red |
| Example 131 | Compound 1-45 | Compound 2-8 | 3.38 | 23.56 | 332 | Red |
| Example 132 | | Compound 2-18 | 3.46 | 23.96 | 308 | Red |
| Example 133 | | Compound 2-28 | 3.37 | 23.52 | 326 | Red |
| Example 134 | | Compound 2-38 | 3.48 | 23.12 | 309 | Red |
| Example 135 | | Compound 2-42 | 3.40 | 23.72 | 326 | Red |

**[Table 4]**

| Category | First host | Second host | Driving voltage(V) | Efficiency (cd/A) | Lifetime T95(hr) | Luminescent color |
|---|---|---|---|---|---|---|
| Example 136 | Compound 1-47 | Compound 2-9 | 3.37 | 22.86 | 340 | Red |
| Example 137 | | Compound 2-19 | 3.43 | 23.96 | 303 | Red |
| Example 138 | | Compound 2-29 | 3.48 | 24.01 | 306 | Red |
| Example 139 | | Compound 2-39 | 3.38 | 23.50 | 321 | Red |
| Example 140 | | Compound 2-45 | 3.42 | 23.88 | 323 | Red |
| Example 141 | Compound 1-49 | Compound 2-10 | 3.51 | 22.73 | 243 | Red |
| Example 142 | | Compound 2-20 | 3.47 | 22.32 | 276 | Red |
| Example 143 | | Compound 2-30 | 3.47 | 22.78 | 251 | Red |
| Example 144 | | Compound 2-40 | 3.53 | 22.09 | 246 | Red |
| Example 145 | | Compound 2-47 | 3.46 | 22.20 | 251 | Red |
| Example 146 | Compound 1-51 | Compound 2-1 | 3.49 | 22.48 | 239 | Red |
| Example 147 | | Compound 2-11 | 3.48 | 22.50 | 273 | Red |
| Example 148 | | Compound 2-21 | 3.45 | 22.99 | 236 | Red |
| Example 149 | | Compound 2-30 | 3.54 | 22.80 | 262 | Red |
| Example 150 | | Compound 2-39 | 3.50 | 22.52 | 271 | Red |
| Example 151 | Compound 1-52 | Compound 2-2 | 3.60 | 22.73 | 240 | Red |
| Example 152 | | Compound 2-12 | 3.56 | 22.32 | 232 | Red |
| Example 153 | | Compound 2-22 | 3.59 | 22.78 | 251 | Red |
| Example 154 | | Compound 2-31 | 3.60 | 22.09 | 232 | Red |
| Example 155 | | Compound 2-40 | 3.53 | 22.20 | 235 | Red |
| Example 156 | Compound 1-52 | Compound 2-2 | 3.57 | 22.48 | 239 | Red |
| Example 157 | | Compound 2-12 | 3.57 | 22.89 | 237 | Red |
| Example 158 | | Compound 2-22 | 3.53 | 22.99 | 241 | Red |
| Example 159 | | Compound 2-31 | 3.57 | 22.80 | 252 | Red |
| Example 160 | | Compound 2-40 | 3.53 | 22.52 | 255 | Red |
| Example 161 | Compound 1-53 | Compound 2-3 | 3.61 | 21.53 | 256 | Red |
| Example 162 | | Compound 2-13 | 3.63 | 21.36 | 232 | Red |
| Example 163 | | Compound 2-23 | 3.63 | 21.99 | 231 | Red |
| Example 164 | | Compound 2-32 | 3.62 | 21.68 | 232 | Red |
| Example 165 | | Compound 2-41 | 3.59 | 21.81 | 235 | Red |
| Example 166 | Compound 1-56 | Compound 2-4 | 3.42 | 24.19 | 311 | Red |
| Example 167 | | Compound 2-14 | 3.45 | 24.63 | 374 | Red |
| Example 168 | | Compound 2-22 | 3.42 | 24.17 | 336 | Red |
| Example 169 | | Compound 2-33 | 3.46 | 24.50 | 333 | Red |
| Example 170 | | Compound 2-42 | 3.46 | 24.42 | 315 | Red |
| Example 171 | Compound 1-58 | Compound 2-4 | 3.47 | 24.16 | 323 | Red |
| Example 172 | | Compound 2-15 | 3.46 | 24.20 | 331 | Red |
| Example 173 | | Compound 2-25 | 3.42 | 24.02 | 313 | Red |
| Example 174 | | Compound 2-34 | 3.42 | 24.23 | 326 | Red |
| Example 175 | | Compound 2-43 | 3.41 | 24.08 | 323 | Red |
| Example 176 | Compound 1-59 | Compound 2-6 | 3.42 | 23.24 | 311 | Red |
| Example 177 | | Compound 2-16 | 3.48 | 23.05 | 338 | Red |
| Example 178 | | Compound 2-26 | 3.42 | 23.29 | 336 | Red |
| Example 179 | | Compound 2-36 | 3.46 | 24.00 | 333 | Red |
| Example 180 | | Compound 2-44 | 3.46 | 23.57 | 315 | Red |

**[Table 5]**

| Category | First host | Second host | Driving voltage(V) | Efficiency (cd/A) | Lifetime T95(hr) | Luminescent color |
|---|---|---|---|---|---|---|
| Example 181 | Compound 1-60 | Compound 2-7 | 3.47 | 23.20 | 323 | Red |
| Example 182 | | Compound 2-17 | 3.46 | 23.82 | 331 | Red |
| Example 183 | | Compound 2-23 | 3.42 | 23.39 | 313 | Red |
| Example 184 | | Compound 2-37 | 3.42 | 23.49 | 326 | Red |
| Example 185 | | Compound 2-45 | 3.41 | 23.13 | 323 | Red |
| Example 186 | Compound 1-62 | Compound 2-8 | 3.54 | 22.45 | 266 | Red |
| Example 187 | | Compound 2-18 | 3.49 | 23.03 | 273 | Red |
| Example 188 | | Compound 2-28 | 3.50 | 22.22 | 244 | Red |
| Example 189 | | Compound 2-38 | 3.48 | 22.69 | 267 | Red |
| Example 190 | | Compound 2-42 | 3.50 | 22.05 | 269 | Red |
| Example 191 | Compound 1-65 | Compound 2-9 | 3.59 | 21.38 | 231 | Red |
| Example 192 | | Compound 2-19 | 3.62 | 21.29 | 223 | Red |
| Example 193 | | Compound 2-29 | 3.60 | 21.12 | 230 | Red |
| Example 194 | | Compound 2-39 | 3.61 | 21.61 | 228 | Red |
| Example 195 | | Compound 2-45 | 3.63 | 21.88 | 254 | Red |
| Example 196 | Compound 1-66 | Compound 2-2 | 3.61 | 21.60 | 253 | Red |
| Example 197 | | Compound 2-10 | 3.62 | 21.42 | 254 | Red |
| Example 198 | | Compound 2-22 | 3.61 | 21.40 | 287 | Red |
| Example 199 | | Compound 2-31 | 3.59 | 21.86 | 246 | Red |
| Example 200 | | Compound 2-40 | 3.62 | 21.12 | 228 | Red |
| Example 201 | Compound 1-68 | Compound 2-3 | 3.48 | 24.16 | 337 | Red |
| Example 202 | | Compound 2-13 | 3.37 | 24.12 | 306 | Red |
| Example 203 | | Compound 2-23 | 3.48 | 23.75 | 332 | Red |
| Example 204 | | Compound 2-32 | 3.39 | 24.03 | 329 | Red |
| Example 205 | | Compound 2-41 | 3.44 | 24.19 | 311 | Red |
| Example 206 | Compound 1-69 | Compound 2-4 | 3.58 | 22.83 | 270 | Red |
| Example 207 | | Compound 2-14 | 3.59 | 23.47 | 298 | Red |
| Example 208 | | Compound 2-25 | 3.60 | 24.09 | 273 | Red |
| Example 210 | | Compound 2-33 | 3.52 | 23.96 | 279 | Red |
| Example 210 | | Compound 2-42 | 3.61 | 23.88 | 283 | Red |
| Example 211 | Compound 1-70 | Compound 2-5 | 3.58 | 23.68 | 279 | Red |
| Example 212 | | Compound 2-13 | 3.52 | 22.89 | 313 | Red |
| Example 213 | | Compound 2-25 | 3.60 | 23.13 | 291 | Red |
| Example 214 | | Compound 2-34 | 3.59 | 22.96 | 304 | Red |
| Example 215 | | Compound 2-43 | 3.56 | 22.88 | 292 | Red |
| Example 216 | Compound 1-72 | Compound 2-3 | 3.63 | 21.21 | 280 | Red |
| Example 217 | | Compound 2-16 | 3.63 | 21.21 | 263 | Red |
| Example 218 | | Compound 2-28 | 3.62 | 21.16 | 254 | Red |
| Example 219 | | Compound 2-36 | 3.63 | 21.76 | 263 | Red |
| Example 220 | | Compound 2-44 | 3.61 | 21.23 | 241 | Red |
| Example 221 | Compound 1-75 | Compound 2-9 | 3.62 | 21.58 | 252 | Red |
| Example 222 | | Compound 2-19 | 3.61 | 22.03 | 236 | Red |
| Example 223 | | Compound 2-29 | 3.61 | 21.94 | 235 | Red |
| Example 224 | | Compound 2-39 | 3.63 | 21.40 | 228 | Red |
| Example 225 | | Compound 2-45 | 3.62 | 22.05 | 245 | Red |

**[Table 6]**

| Category | First host | Second host | Driving voltage(V) | Efficiency (cd/A) | Lifetime T95(hr) | Luminescent color |
|---|---|---|---|---|---|---|
| Example 226 | Compound 1-76 | Compound 2-10 | 3.52 | 22.41 | 249 | Red |
| Example 227 | | Compound 2-20 | 3.45 | 22.55 | 266 | Red |
| Example 228 | | Compound 2-30 | 3.54 | 23.06 | 276 | Red |
| Example 229 | | Compound 2-40 | 3.54 | 22.35 | 255 | Red |
| Example 230 | | Compound 2-47 | 3.48 | 22.79 | 277 | Red |
| Example 231 | Compound 1-77 | Compound 2-1 | 3.38 | 24.11 | 338 | Red |
| Example 232 | | Compound 2-11 | 3.37 | 24.09 | 367 | Red |
| Example 233 | | Compound 2-21 | 3.41 | 23.96 | 309 | Red |
| Example 234 | | Compound 2-30 | 3.41 | 24.26 | 297 | Red |
| Example 235 | | Compound 2-39 | 3.38 | 23.53 | 320 | Red |
| Example 236 | Compound 1-79 | Compound 2-2 | 3.41 | 23.69 | 324 | Red |
| Example 237 | | Compound 2-12 | 3.45 | 24.07 | 325 | Red |
| Example 238 | | Compound 2-22 | 3.40 | 24.23 | 295 | Red |
| Example 239 | | Compound 2-31 | 3.39 | 24.55 | 335 | Red |
| Example 240 | | Compound 2-40 | 3.39 | 23.83 | 301 | Red |
| Example 241 | Compound 1-80 | Compound 2-3 | 3.60 | 23.70 | 303 | Red |
| Example 242 | | Compound 2-13 | 3.56 | 23.64 | 287 | Red |
| Example 243 | | Compound 2-23 | 3.55 | 23.68 | 281 | Red |
| Example 244 | | Compound 2-32 | 3.53 | 23.03 | 273 | Red |
| Example 245 | | Compound 2-41 | 3.59 | 22.94 | 282 | Red |

**[Table 7]**

| Category | First host | Second host | Driving voltage(V) | Efficiency (cd/A) | Lifetime T95(hr) | Luminescent color |
|---|---|---|---|---|---|---|
| Comparative Example 1 | Compound A-1 | Compound 2-2 | 3.94 | 18.16 | 163 | Red |
| Comparative Example 2 | | Compound 2-11 | 3.94 | 17.89 | 163 | Red |
| Comparative Example 3 | | Compound 2-21 | 3.93 | 18.14 | 198 | Red |
| Comparative Example 4 | | Compound 2-30 | 3.92 | 17.83 | 171 | Red |
| Comparative Example 5 | | Compound 2-39 | 3.88 | 18.18 | 176 | Red |
| Comparative Example 6 | Compound A-2 | Compound 2-2 | 3.89 | 17.39 | 154 | Red |
| Comparative Example 7 | | Compound 2-10 | 3.93 | 17.73 | 182 | Red |
| Comparative Example 8 | | Compound 2-22 | 3.89 | 18.20 | 176 | Red |
| Comparative Example 9 | | Compound 2-31 | 3.92 | 17.66 | 177 | Red |
| Comparative Example 10 | | Compound 2-40 | 3.93 | 17.93 | 179 | Red |
| Comparative Example 11 | Compound A-3 | Compound 2-3 | 4.11 | 16.20 | 98 | Red |
| Comparative Example 12 | | Compound 2-13 | 4.14 | 15.92 | 128 | Red |
| Comparative Example 13 | | Compound 2-23 | 4.23 | 14.82 | 141 | Red |
| Comparative Example 14 | | Compound 2-32 | 4.19 | 14.62 | 175 | Red |
| Comparative Example 15 | | Compound 2-41 | 4.14 | 15.44 | 169 | Red |
| Comparative Example 16 | Compound A-4 | Compound 2-4 | 4.14 | 14.57 | 133 | Red |
| Comparative Example 17 | | Compound 2-14 | 4.07 | 15.79 | 179 | Red |
| Comparative Example 18 | | Compound 2-25 | 4.07 | 16.34 | 130 | Red |
| Comparative Example 19 | | Compound 2-33 | 4.11 | 15.45 | 187 | Red |
| Comparative Example 20 | | Compound 2-42 | 4.15 | 15.86 | 174 | Red |
| Comparative Example 21 | Compound A-5 | Compound 2-5 | 3.93 | 17.93 | 159 | Red |
| Comparative Example 22 | | Compound 2-13 | 3.93 | 18.02 | 173 | Red |
| Comparative Example 23 | | Compound 2-25 | 3.89 | 17.40 | 158 | Red |
| Comparative Example 24 | | Compound 2-34 | 3.92 | 17.87 | 171 | Red |
| Comparative Example 25 | | Compound 2-43 | 3.94 | 17.54 | 185 | Red |
| Comparative Example 26 | Compound A-6 | Compound 2-3 | 3.92 | 17.80 | 134 | Red |
| Comparative Example 27 | | Compound 2-16 | 3.95 | 17.84 | 182 | Red |
| Comparative Example 28 | | Compound 2-28 | 3.90 | 18.03 | 143 | Red |
| Comparative Example 29 | | Compound 2-36 | 3.90 | 18.16 | 171 | Red |
| Comparative Example 30 | | Compound 2-44 | 3.89 | 17.86 | 189 | Red |

**[Table 8]**

| Category | First host | Second host | Driving voltage(V) | Efficiency (cd/A) | Lifetime T95(hr) | Luminescent color |
|---|---|---|---|---|---|---|
| Comparative Example 31 | Compound A-7 | Compound 2-2 | 3.91 | 17.41 | 139 | Red |
| Comparative Example 32 | | Compound 2-14 | 3.88 | 17.46 | 179 | Red |
| Comparative Example 33 | | Compound 2-27 | 3.94 | 17.88 | 140 | Red |
| Comparative Example 34 | | Compound 2-34 | 3.89 | 17.89 | 186 | Red |
| Comparative Example 35 | | Compound 2-45 | 3.95 | 17.44 | 172 | Red |
| Comparative Example 36 | Compound A-8 | Compound 2-4 | 3.91 | 17.20 | 141 | Red |
| Comparative Example 37 | | Compound 2-16 | 3.89 | 16.54 | 179 | Red |
| Comparative Example 38 | | Compound 2-22 | 3.93 | 16.63 | 186 | Red |
| Comparative Example 39 | | Compound 2-35 | 3.88 | 17.43 | 172 | Red |
| Comparative Example 40 | | Compound 2-42 | 3.89 | 17.45 | 187 | Red |
| Comparative Example 41 | Compound A-9 | Compound 2-9 | 3.88 | 18.08 | 151 | Red |
| Comparative Example 42 | | Compound 2-19 | 3.88 | 18.10 | 175 | Red |
| Comparative Example 43 | | Compound 2-29 | 3.93 | 17.35 | 144 | Red |
| Comparative Example 44 | | Compound 2-39 | 3.92 | 17.37 | 172 | Red |
| Comparative Example 45 | | Compound 2-45 | 3.89 | 17.56 | 188 | Red |
| Comparative Example 46 | Compound A-10 | Compound 2-10 | 3.91 | 17.49 | 179 | Red |
| Comparative Example 47 | | Compound 2-20 | 3.94 | 17.51 | 173 | Red |
| Comparative Example 48 | | Compound 2-30 | 3.92 | 17.75 | 147 | Red |
| Comparative Example 49 | | Compound 2-40 | 3.91 | 17.61 | 182 | Red |
| Comparative Example 50 | | Compound 2-47 | 3.89 | 18.01 | 177 | Red |
| Comparative Example 51 | Compound A-11 | Compound 2-1 | 3.87 | 16.62 | 165 | Red |
| Comparative Example 52 | | Compound 2-11 | 3.88 | 16.61 | 199 | Red |
| Comparative Example 53 | | Compound 2-21 | 3.92 | 16.47 | 174 | Red |
| Comparative Example 54 | | Compound 2-30 | 3.88 | 16.84 | 121 | Red |
| Comparative Example 55 | | Compound 2-39 | 3.94 | 16.52 | 180 | Red |
| Comparative Example 56 | Compound A-12 | Compound 2-2 | 4.15 | 16.06 | 86 | Red |
| Comparative Example 57 | | Compound 2-12 | 4.19 | 14.82 | 147 | Red |
| Comparative Example 58 | | Compound 2-22 | 4.21 | 14.56 | 125 | Red |
| Comparative Example 59 | | Compound 2-31 | 4.12 | 16.26 | 146 | Red |
| Comparative Example 60 | | Compound 2-40 | 4.22 | 14.94 | 155 | Red |

**[Table 9]**

| Category | First host | Second host | Driving voltage(V) | Efficiency (cd/A) | Lifetime T95(hr) | Luminescent color |
|---|---|---|---|---|---|---|
| Comparative Example 61 | Compound 1-1 | Compound B-1 | 4.11 | 15.23 | 150 | Red |
| Comparative Example 62 | Compound 1-13 | | 4.16 | 14.90 | 161 | Red |
| Comparative Example 63 | Compound 1-25 | | 4.07 | 14.67 | 116 | Red |
| Comparative Example 64 | Compound 1-40 | | 4.07 | 16.07 | 117 | Red |
| Comparative Example 65 | Compound 1-53 | | 4.10 | 15.60 | 128 | Red |
| Comparative Example 66 | Compound 1-3 | | 4.06 | 15.05 | 112 | Red |
| Comparative Example 67 | Compound 1-16 | | 4.05 | 15.73 | 124 | Red |
| Comparative Example 68 | Compound 1-28 | | 4.14 | 15.47 | 153 | Red |
| Comparative Example 69 | Compound 1-42 | Compound B-2 | 4.13 | 15.23 | 85 | Red |
| Comparative Example 70 | Compound 1-56 | | 4.14 | 14.90 | 143 | Red |
| Comparative Example 71 | Compound 1-4 | | 4.09 | 14.67 | 85 | Red |
| Comparative Example 72 | Compound 1-17 | | 4.10 | 16.07 | 91 | Red |
| Comparative Example 73 | Compound 1-29 | | 4.15 | 15.60 | 121 | Red |
| Comparative Example 74 | Compound 1-44 | | 4.17 | 15.05 | 130 | Red |
| Comparative Example 75 | Compound 1-69 | | 4.16 | 15.73 | 94 | Red |
| Comparative Example 76 | Compound 1-7 | | 4.14 | 15.47 | 112 | Red |
| Comparative Example 77 | Compound 1-18 | Compound B-3 | 3.94 | 17.02 | 151 | Red |
| Comparative Example 78 | Compound 1-30 | | 3.92 | 16.55 | 158 | Red |
| Comparative Example 79 | Compound 1-59 | | 3.95 | 16.48 | 150 | Red |
| Comparative Example 80 | Compound 1-70 | | 3.94 | 16.70 | 160 | Red |
| Comparative Example 81 | Compound 1-7 | | 3.91 | 17.26 | 159 | Red |
| Comparative Example 82 | Compound 1-19 | | 3.95 | 17.17 | 174 | Red |
| Comparative Example 83 | Compound 1-32 | | 3.93 | 16.76 | 146 | Red |
| Comparative Example 84 | Compound 1-47 | | 3.88 | 17.50 | 163 | Red |
| Comparative Example 85 | Compound 1-72 | Compound B-4 | 4.12 | 16.01 | 135 | Red |
| Comparative Example 86 | Compound 1-9 | | 4.05 | 14.92 | 126 | Red |
| Comparative Example 87 | Compound 1-21 | | 4.07 | 14.63 | 116 | Red |
| Comparative Example 88 | Compound 1-49 | | 4.12 | 15.67 | 110 | Red |
| Comparative Example 89 | Compound 1-62 | | 4.09 | 15.72 | 118 | Red |
| Comparative Example 90 | Compound 1-75 | | 4.12 | 14.55 | 129 | Red |
| Comparative Example 91 | Compound 1-11 | | 4.09 | 14.69 | 163 | Red |
| Comparative Example 92 | Compound 1-36 | | 4.07 | 16.33 | 126 | Red |
| Comparative Example 93 | Compound 1-51 | Compound B-5 | 3.89 | 18.17 | 161 | Red |
| Comparative Example 94 | Compound 1-65 | | 3.88 | 18.02 | 164 | Red |
| Comparative Example 95 | Compound 1-76 | | 3.88 | 17.83 | 168 | Red |
| Comparative Example 96 | Compound 1-12 | | 3.88 | 17.96 | 167 | Red |
| Comparative Example 97 | Compound 1-24 | | 3.92 | 17.70 | 162 | Red |
| Comparative Example 98 | Compound 1-52 | | 3.89 | 17.95 | 178 | Red |
| Comparative Example 99 | Compound 1-66 | | 3.88 | 17.58 | 173 | Red |
| Comparative Example 100 | Compound 1-77 | | 3.92 | 17.42 | 194 | Red |

**[Table 10]**

| Category | First host | Second host | Driving voltage(V) | Efficiency (cd/A) | Lifetime T95(hr) | Luminescent color |
|---|---|---|---|---|---|---|
| Comparative Example 101 | Compound 1-33 | Compound B-6 | 3.91 | 17.66 | 174 | Red |
| Comparative Example 102 | Compound 1-45 | | 3.90 | 17.85 | 179 | Red |
| Comparative Example 103 | Compound 1-58 | | 3.89 | 18.11 | 188 | Red |
| Comparative Example 104 | Compound 1-60 | | 3.90 | 18.09 | 164 | Red |
| Comparative Example 105 | Compound 1-80 | | 3.92 | 17.58 | 170 | Red |
| Comparative Example 106 | Compound 1-1 | | 3.88 | 17.49 | 197 | Red |
| Comparative Example 107 | Compound 1-13 | | 3.92 | 17.34 | 164 | Red |
| Comparative Example 108 | Compound 1-25 | | 3.88 | 17.41 | 164 | Red |
| Comparative Example 109 | Compound 1-40 | Compound B-7 | 4.09 | 14.80 | 121 | Red |
| Comparative Example 110 | Compound 1-53 | | 4.11 | 15.64 | 132 | Red |
| Comparative Example 111 | Compound 1-3 | | 4.12 | 14.91 | 134 | Red |
| Comparative Example 112 | Compound 1-16 | | 4.13 | 16.32 | 133 | Red |
| Comparative Example 113 | Compound 1-28 | | 4.08 | 16.39 | 161 | Red |
| Comparative Example 114 | Compound 1-42 | | 4.06 | 14.77 | 120 | Red |
| Comparative Example 115 | Compound 1-56 | | 4.05 | 15.22 | 168 | Red |
| Comparative Example 116 | Compound 1-4 | | 4.07 | 15.89 | 124 | Red |
| Comparative Example 117 | Compound 1-17 | Compound B-8 | 3.92 | 16.63 | 154 | Red |
| Comparative Example 118 | Compound 1-29 | | 3.95 | 17.29 | 180 | Red |
| Comparative Example 119 | Compound 1-44 | | 3.92 | 17.13 | 187 | Red |
| Comparative Example 120 | Compound 1-69 | | 3.94 | 16.68 | 148 | Red |
| Comparative Example 121 | Compound 1-7 | | 3.88 | 17.07 | 160 | Red |
| Comparative Example 122 | Compound 1-18 | | 3.91 | 16.62 | 153 | Red |
| Comparative Example 123 | Compound 1-30 | | 3.92 | 16.32 | 163 | Red |
| Comparative Example 124 | Compound 1-59 | | 3.91 | 17.22 | 143 | Red |
| Comparative Example 125 | Compound 1-70 | Compound B-9 | 4.07 | 14.59 | 153 | Red |
| Comparative Example 126 | Compound 1-7 | | 4.16 | 15.82 | 161 | Red |
| Comparative Example 127 | Compound 1-19 | | 4.17 | 15.29 | 189 | Red |
| Comparative Example 128 | Compound 1-32 | | 4.10 | 15.50 | 161 | Red |
| Comparative Example 129 | Compound 1-47 | | 4.15 | 14.61 | 169 | Red |
| Comparative Example 130 | Compound 1-72 | | 4.08 | 16.26 | 163 | Red |
| Comparative Example 131 | Compound 1-9 | | 4.17 | 15.68 | 172 | Red |
| Comparative Example 132 | Compound 1-21 | | 4.12 | 15.28 | 159 | Red |
| Comparative Example 133 | Compound 1-49 | Compound B-10 | 3.91 | 18.04 | 170 | Red |
| Comparative Example 134 | Compound 1-62 | | 3.95 | 17.43 | 166 | Red |
| Comparative Example 135 | Compound 1-75 | | 3.91 | 18.06 | 165 | Red |
| Comparative Example 136 | Compound 1-11 | | 3.89 | 18.19 | 193 | Red |
| Comparative Example 137 | Compound 1-36 | | 3.93 | 17.67 | 178 | Red |
| Comparative Example 138 | Compound 1-51 | | 3.94 | 17.47 | 164 | Red |
| Comparative Example 139 | Compound 1-65 | | 3.89 | 18.05 | 173 | Red |
| Comparative Example 140 | Compound 1-76 | | 3.95 | 17.51 | 167 | Red |

**[Table 11]**

| Category | First host | Second host | Driving voltage(V) | Efficiency (cd/A) | Lifetime T95(hr) | Luminescent color |
|---|---|---|---|---|---|---|
| Comparative Example 141 | Compound 1-12 | Compound B-11 | 3.95 | 17.64 | 163 | Red |
| Comparative Example 142 | Compound 1-24 | | 3.93 | 17.42 | 180 | Red |
| Comparative Example 143 | Compound 1-52 | | 3.92 | 17.88 | 175 | Red |
| Comparative Example 144 | Compound 1-66 | | 3.88 | 17.92 | 174 | Red |
| Comparative Example 145 | Compound 1-77 | | 3.91 | 17.55 | 195 | Red |
| Comparative Example 146 | Compound 1-23 | | 3.90 | 17.91 | 167 | Red |
| Comparative Example 147 | Compound 1-38 | | 3.94 | 17.80 | 172 | Red |
| Comparative Example 148 | Compound 1-68 | | 3.93 | 17.83 | 193 | Red |
| Comparative Example 149 | Compound 1-79 | Compound B-12 | 3.94 | 17.89 | 201 | Red |
| Comparative Example 150 | Compound 1-1 | | 3.90 | 17.59 | 193 | Red |
| Comparative Example 151 | Compound 1-13 | | 3.88 | 17.99 | 189 | Red |
| Comparative Example 152 | Compound 1-25 | | 3.92 | 17.34 | 172 | Red |
| Comparative Example 153 | Compound 1-40 | | 3.90 | 18.19 | 169 | Red |
| Comparative Example 154 | Compound 1-53 | | 3.89 | 18.12 | 161 | Red |
| Comparative Example 155 | Compound 1-3 | | 3.92 | 17.55 | 167 | Red |
| Comparative Example 156 | Compound 1-16 | | 3.92 | 17.63 | 167 | Red |
| Comparative Example 157 | Compound 1-28 | Compound B-13 | 3.91 | 17.10 | 193 | Red |
| Comparative Example 158 | Compound 1-42 | | 3.92 | 16.44 | 154 | Red |
| Comparative Example 159 | Compound 1-56 | | 3.90 | 16.53 | 195 | Red |
| Comparative Example 160 | Compound 1-4 | | 3.88 | 17.23 | 155 | Red |
| Comparative Example 161 | Compound 1-17 | | 3.94 | 16.89 | 158 | Red |
| Comparative Example 162 | Compound 1-29 | | 3.88 | 17.06 | 185 | Red |
| Comparative Example 163 | Compound 1-44 | | 3.89 | 16.56 | 193 | Red |
| Comparative Example 164 | Compound 1-69 | | 3.89 | 16.65 | 153 | Red |
| Comparative Example 165 | Compound 1-7 | Compound B-14 | 4.05 | 15.97 | 154 | Red |
| Comparative Example 166 | Compound 1-18 | | 4.06 | 15.04 | 163 | Red |
| Comparative Example 167 | Compound 1-30 | | 4.11 | 16.25 | 161 | Red |
| Comparative Example 168 | Compound 1-59 | | 4.12 | 14.53 | 172 | Red |
| Comparative Example 169 | Compound 1-70 | | 4.14 | 15.98 | 163 | Red |
| Comparative Example 170 | Compound 1-7 | | 4.12 | 16.29 | 170 | Red |
| Comparative Example 171 | Compound 1-19 | | 4.14 | 16.19 | 188 | Red |
| Comparative Example 172 | Compound 1-32 | | 4.05 | 15.59 | 151 | Red |

When a current was applied to the organic light emitting devices manufactured in Examples 1 to 245 and Comparative Examples 1 to 172, the results shown in Table 1 to Table 11 were obtained.

When Comparative Example Compounds A-1 to A-12 and the compound represented by Chemical Formula 2 of the present disclosure were co-deposited together and used as a red light emitting layer as shown in Table 7 and Table 8, the result showed that generally, the driving voltage increased and the efficiency and lifetime decreased as compared with one embodiment of the present disclosure. Even when Comparative Example Compounds B-1 to B-14 and the compound represented by Chemical Formula 1 of the present disclosure were co-deposited together and used as a red light emitting layer as shown in Table 9 to Table 11, the result showed that the driving voltage increased and the efficiency and lifetime decreased.

From the above results, it can be inferred that the reason why the driving voltage is improved and the efficiency and lifetime are increased is that when the compound of Chemical Formula 1 which is the first host of the present disclosure and the Compound of Chemical Formula 2 which is the second host of the present disclosure were used in combination, energy transfer to the red dopant in the red light emitting layer is well made favorable.

Therefore, it can be confirmed that since the combination of the compound represented by Chemical Formula 1 and the compound represented by Chemical Formula 2 of the present disclosure achieves a more stable balance in the light emitting layer than the combination with the comparative example compound, electrons and holes combine to form excitons, which is greatly increased in efficiency and lifetime. From this, it was confirmed that when the compound represented by Chemical Formula 1 and the compound represented by Chemical Formula 2 of the present disclosure were co-deposited and used as a host for the red light emitting layer, the driving voltage, luminous efficiency, and lifetime characteristics of the organic light emitting device could be improved.

**<Description of Symbols>**

| | | | |
|---|---|---|---|
| 1: | substrate | 2: | anode |
| 3: | light emitting layer | 4: | cathode |
| 5: | hole injection layer | 6: | hole transport layer |
| 7: | electron blocking layer | 8: | hole blocking layer |
| 9: | electron injection and transport layer | | |

## Claims

1. An organic light emitting device comprising
an anode;
a cathode; and
a light emitting layer interposed between the anode and the cathode,
wherein the light emitting layer includes a compound represented by the following Chemical Formula 1 and a compound represented by the following Chemical Formula 2: 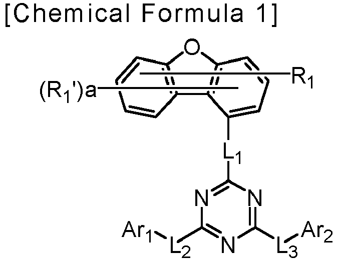 in the Chemical Formula 1,
Ar₁ and Ar₂ are each independently a substituted or unsubstituted C₆₋₆₀ aryl; or a substituted or unsubstituted C₂₋₆₀ heteroaryl containing at least one selected from the group consisting of N, O, and S.
L₁ to L₃ are each independently a single bond; or a substituted or unsubstituted C₆₋₆₀ arylene,
each R₁ is independently a substituted or unsubstituted C₆₋₆₀ aryl;
or a substituted or unsubstituted C₂₋₆₀ heteroaryl containing at least one selected from the group consisting of N, O, and S,
each R₁' is independently hydrogen or deuterium, and
a is an integer of 0 to 6, 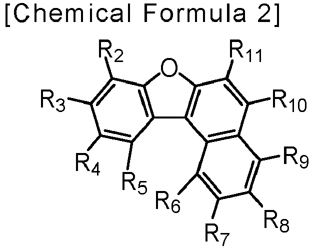 in the Chemical Formula 2,
R₂ to R₆ and R₉ to R₁₁ are each independently hydrogen or deuterium,
any one of R₇ and R₈ is 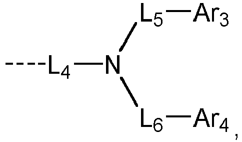 the rest is hydrogen or deuterium,
Ar₃ and Ar₄ are each independently a substituted or unsubstituted C₆₋₆₀ aryl; or a substituted or unsubstituted C₂₋₆₀ heteroaryl containing at least one selected from the group consisting of N, O, and S,
L₄ is a substituted or unsubstituted phenylene, a substituted or unsubstituted biphenyldiyl, or a substituted or unsubstituted naphthalenediyl, and
L₅ and L₆ are each independently a single bond; a substituted or unsubstituted C₆₋₆₀ arylene; or a substituted or unsubstituted C₂₋₆₀ heteroarylene containing at least one selected from the group consisting of N, O, and S.

2. The organic light emitting device according to claim 1, wherein
the compound represented by Chemical Formula 1 is represented by any one of the following Chemical Formula 1-1 and Chemical Formula 1-2 : 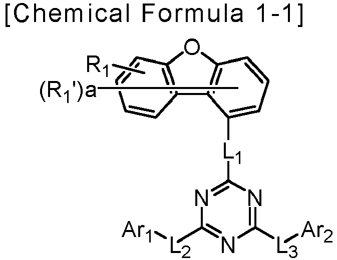 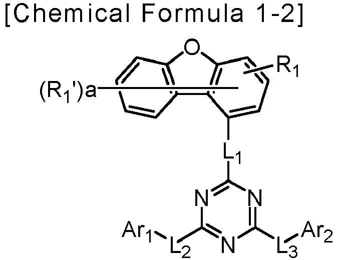 in the Chemical Formula 1-1 and Chemical Formula 1-2,
Ar₁ and Ar₂, L₁ to L₃, R₁, R₁' and a are as defined in claim 1.

3. The organic light emitting device according to claim 1, wherein
Ar₁ and Ar₂ are each independently phenyl, biphenylyl, terphenylyl, naphthyl, phenanthrenyl, dibenzofuranyl, or dibenzothiophenyl, and
the hydrogens of Ar₁ and Ar₂ are each independently unsubstituted or substituted with deuterium.

4. The organic light emitting device according to claim 1, wherein
L₁ to L₃ are each independently a single bond, phenylene, biphenyldiyl, or naphthalenediyl, and
the hydrogens of L₁ to L₃ are each independently unsubstituted or substituted with deuterium.

5. The organic light emitting device according to claim 1, wherein
each R₁ is independently phenyl, biphenylyl, terphenylyl, naphthyl, phenanthrenyl, triphenylenyl, naphthyl phenyl, phenyl naphthyl, fluoranthenyl, dibenzofuranyl, dibenzothiophenyl, benzonaphthofuranyl, or benzonaphthothiophenyl, and
the hydrogens of the R₁ s are each independently unsubstituted or substituted with deuterium.

6. The organic light emitting device according to claim 1, wherein
the compound represented by Chemical Formula 1 is any one selected from the group consisting of:

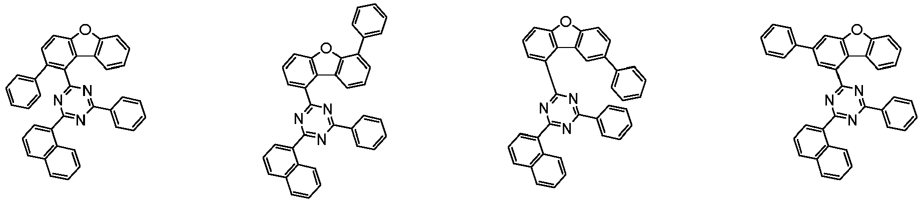

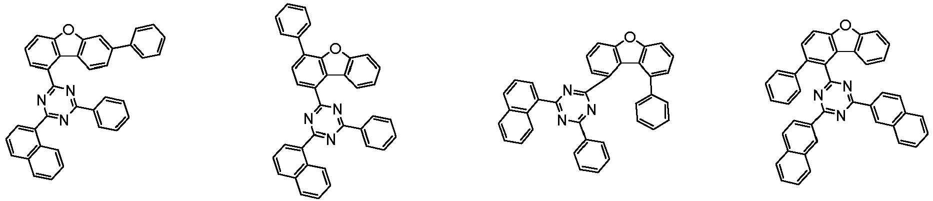

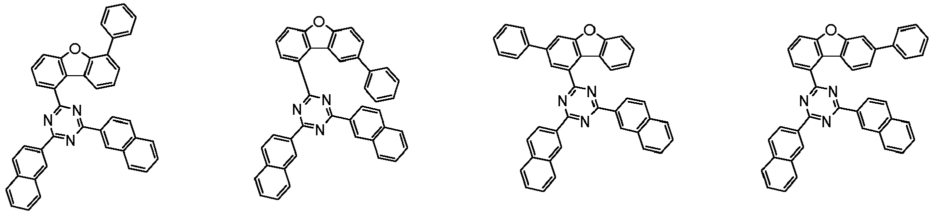

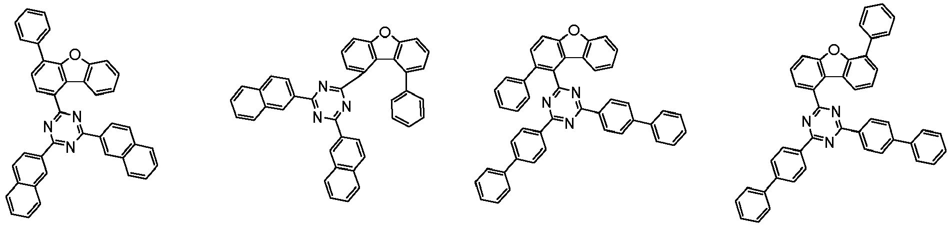

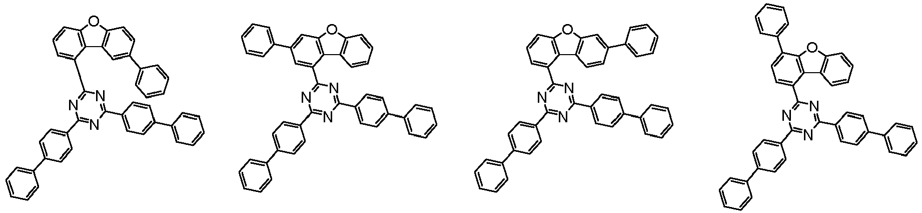

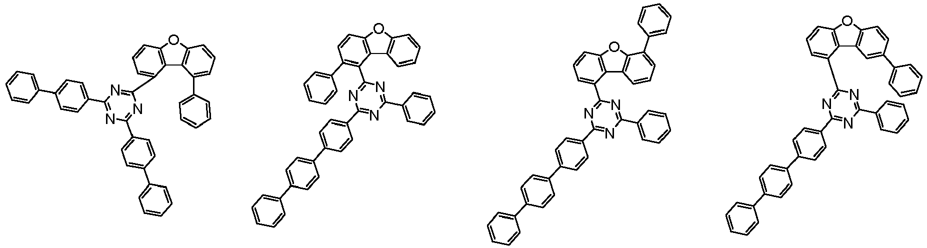

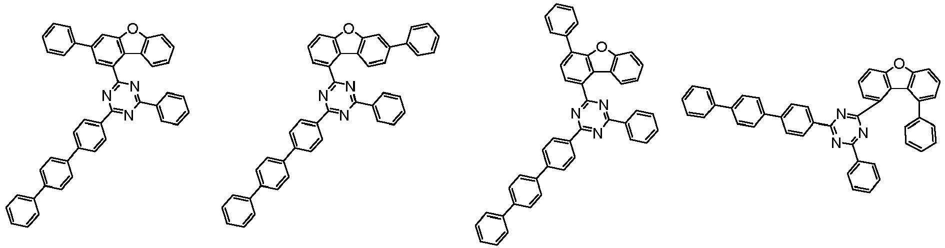

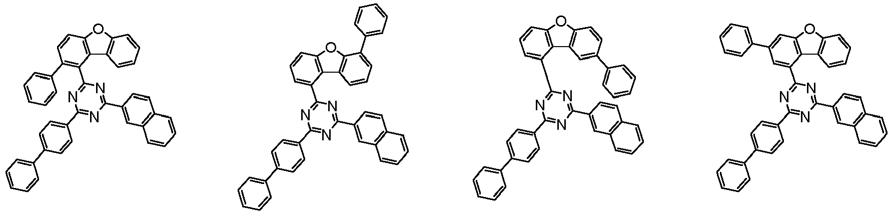

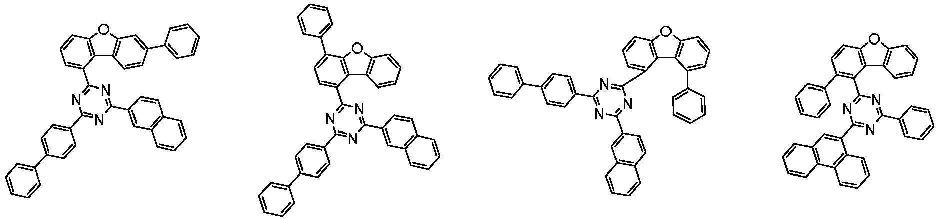

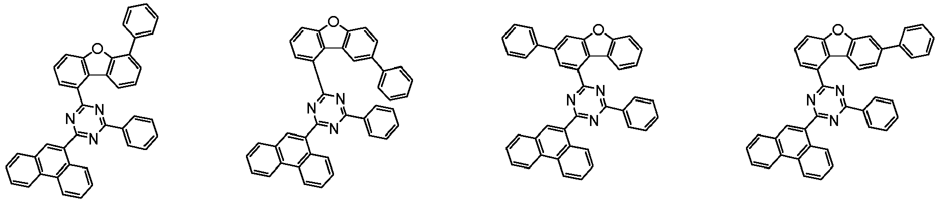

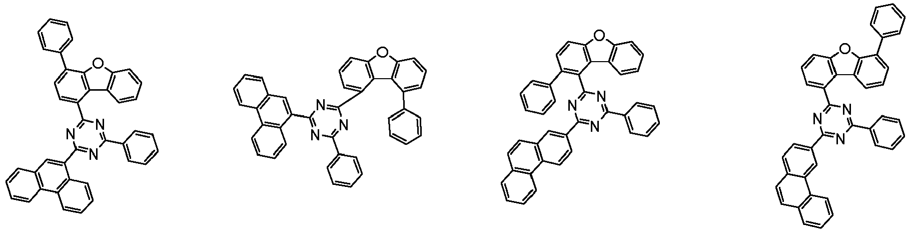

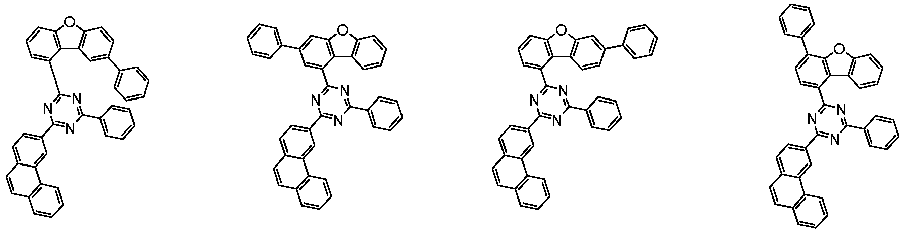

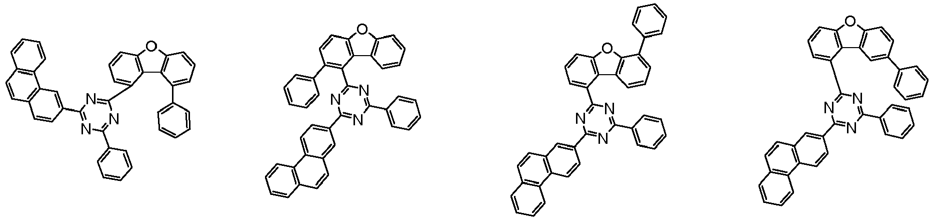

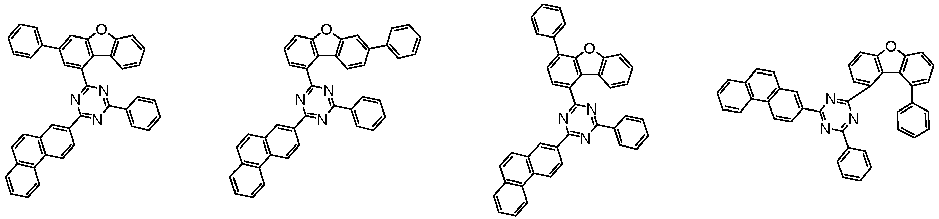

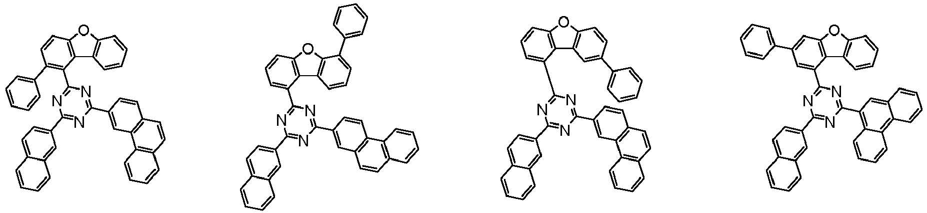

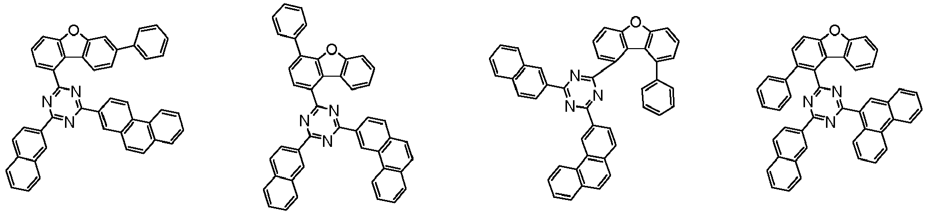

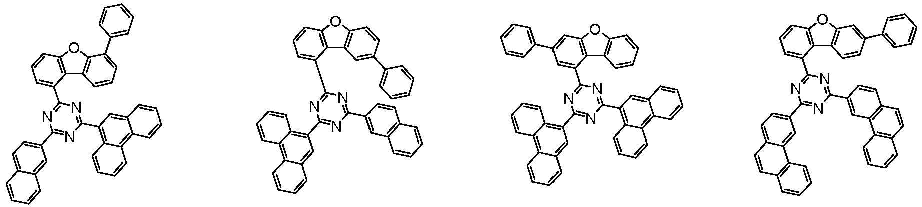

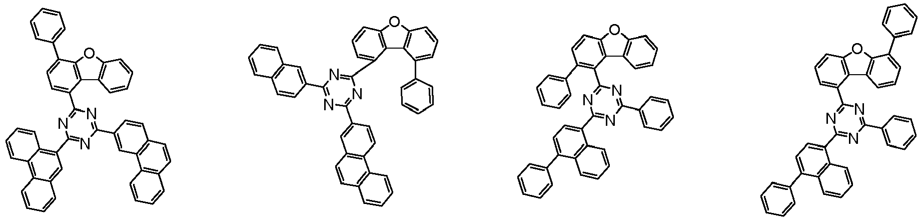

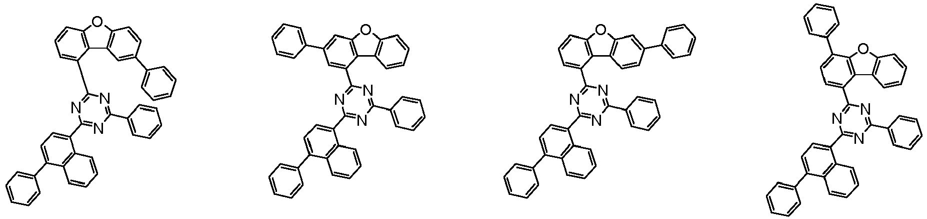

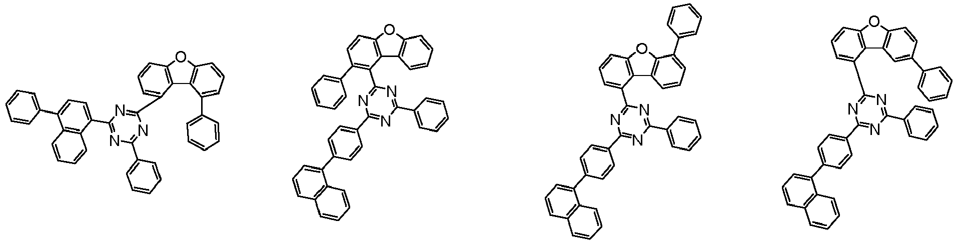

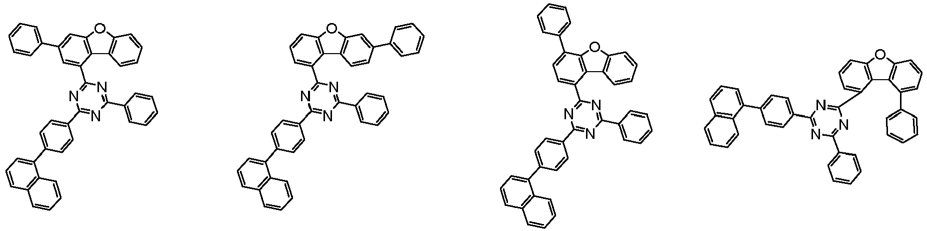

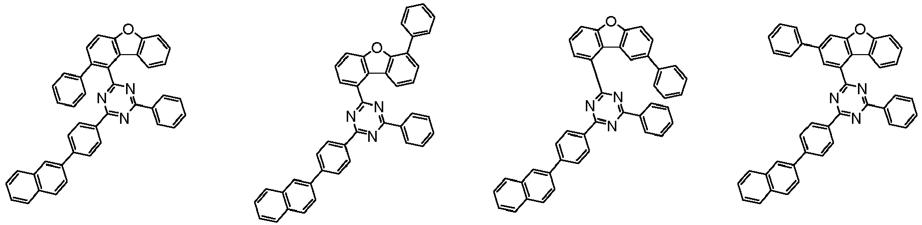

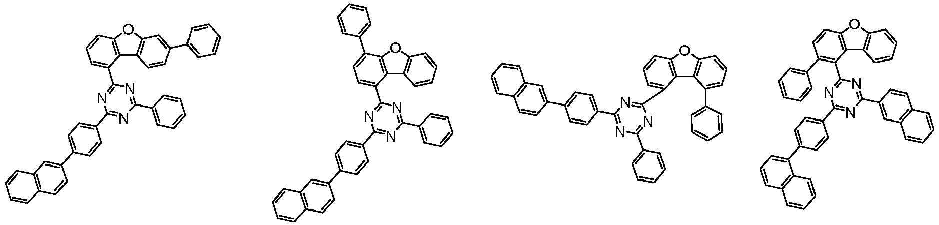

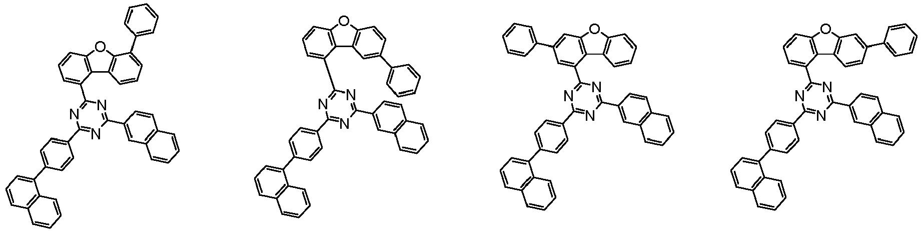

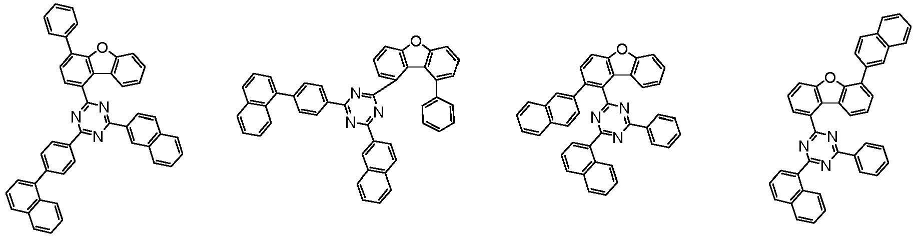

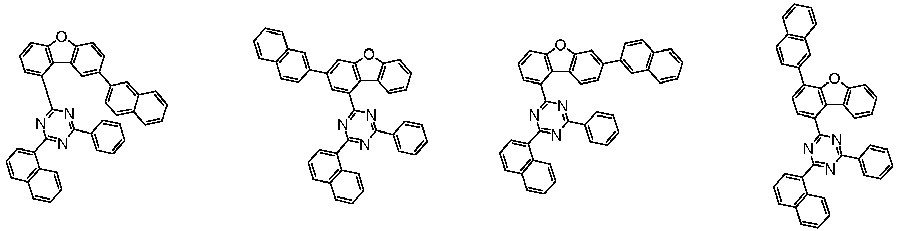

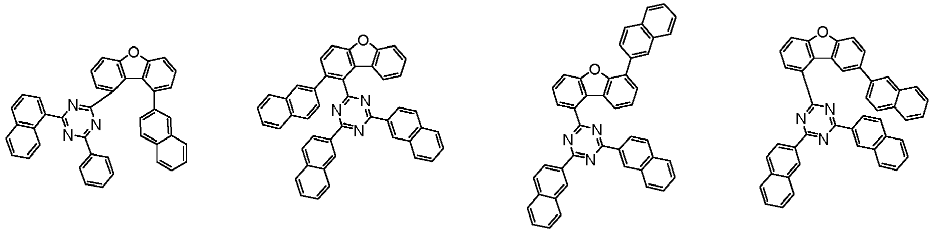

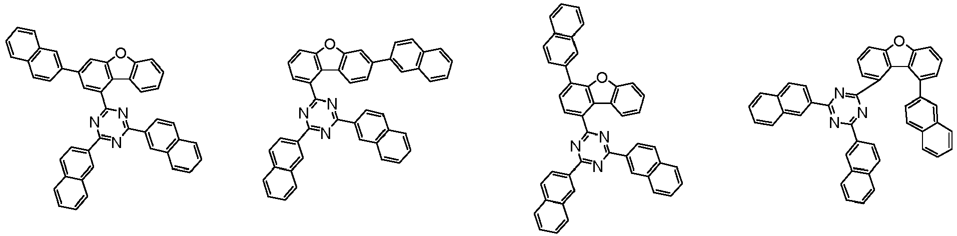

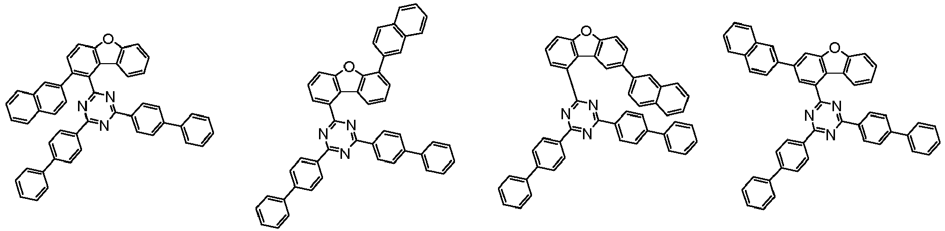

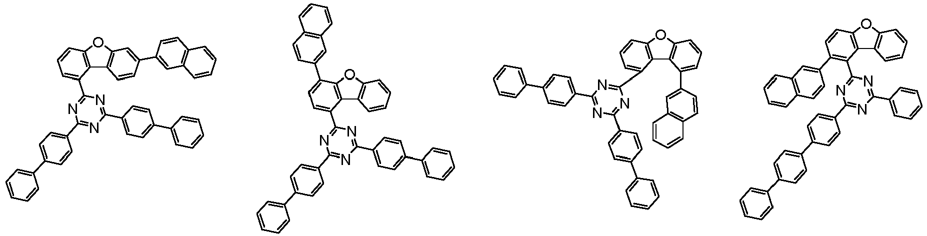

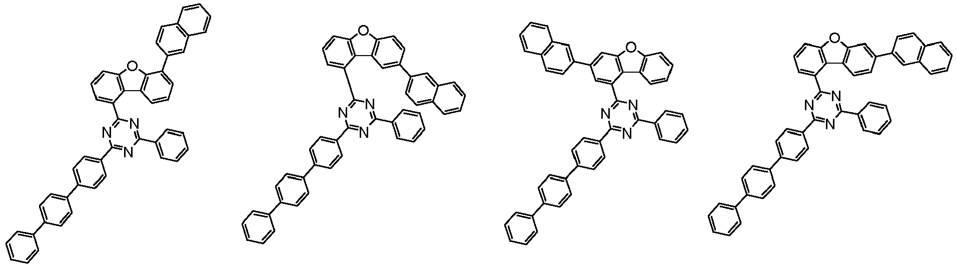

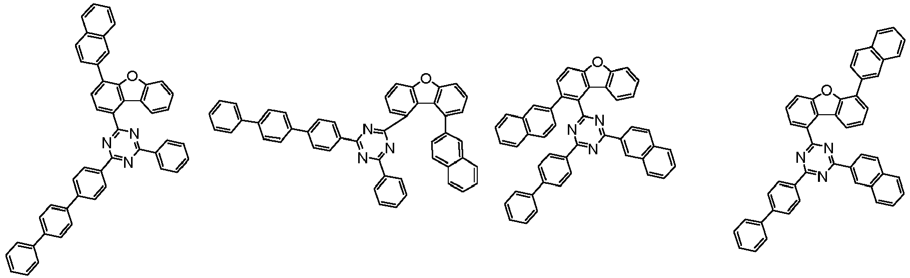

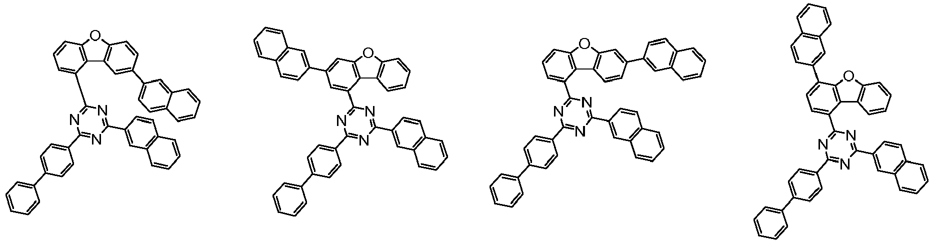

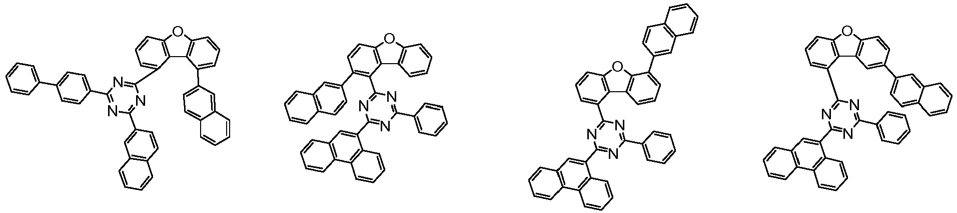

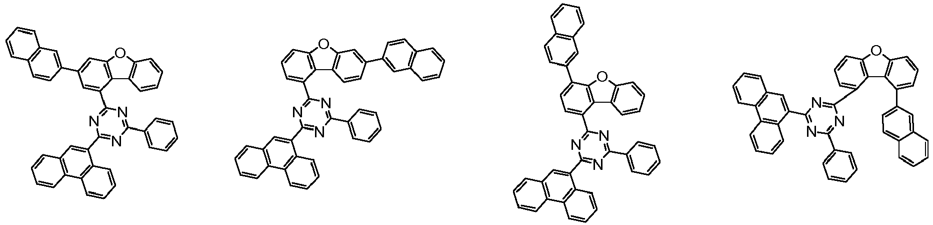

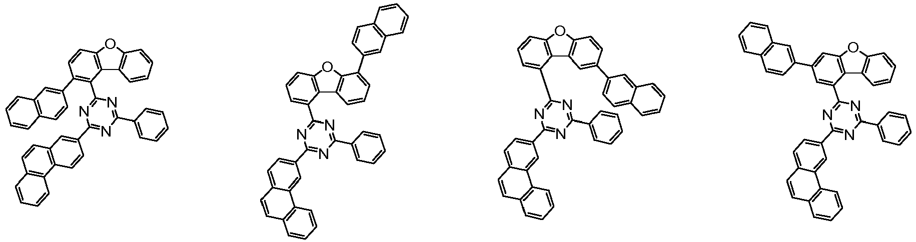

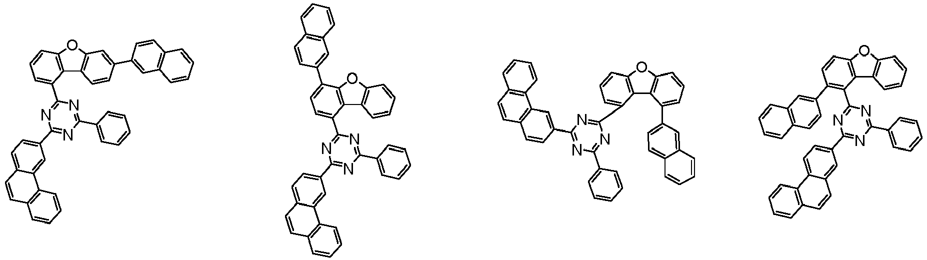

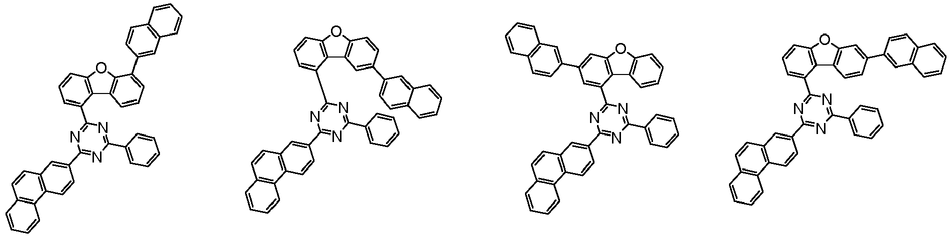

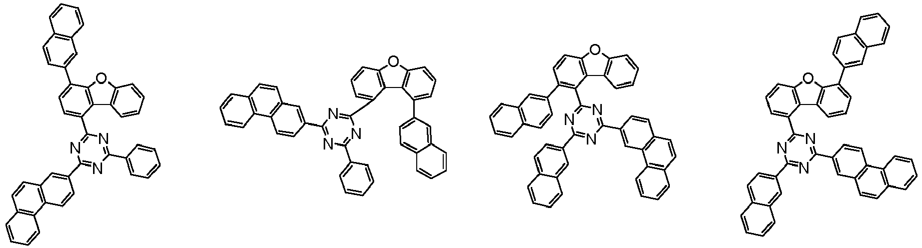

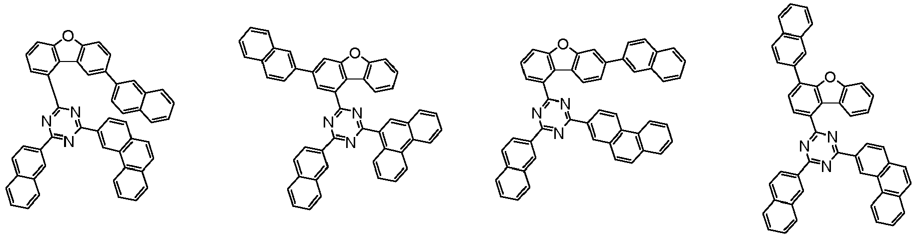

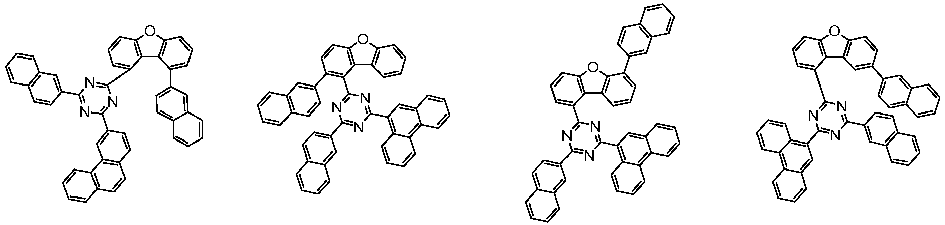

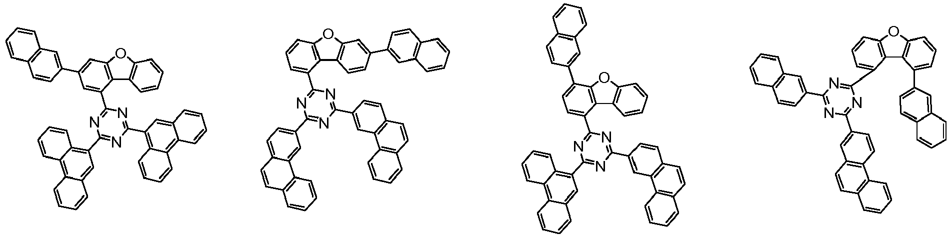

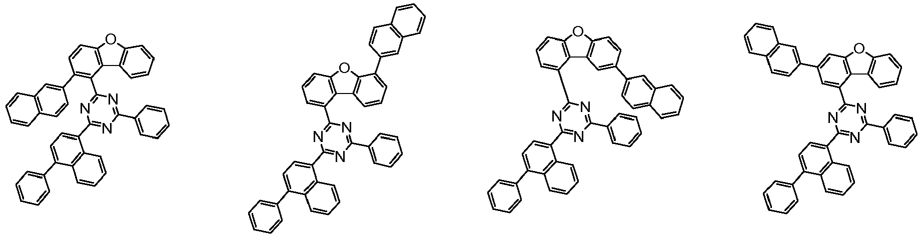

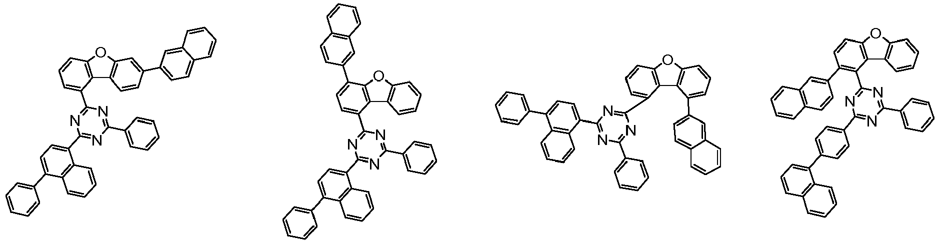

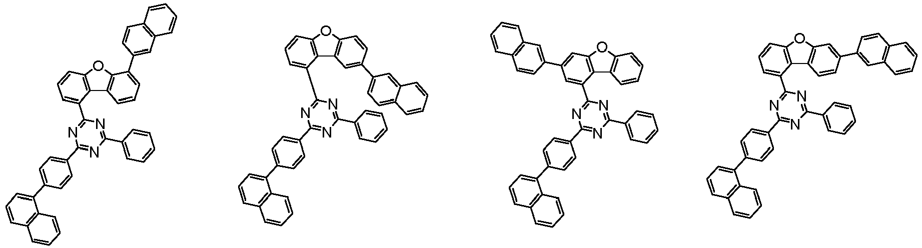

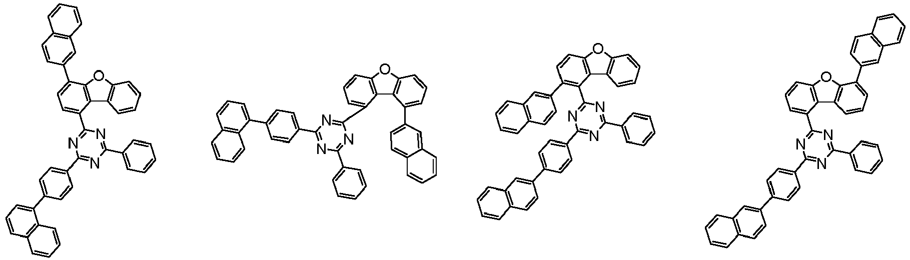

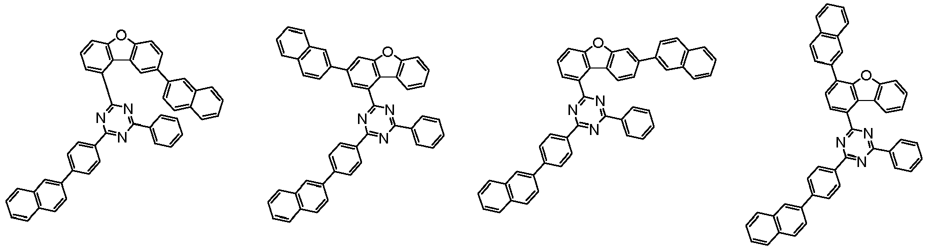

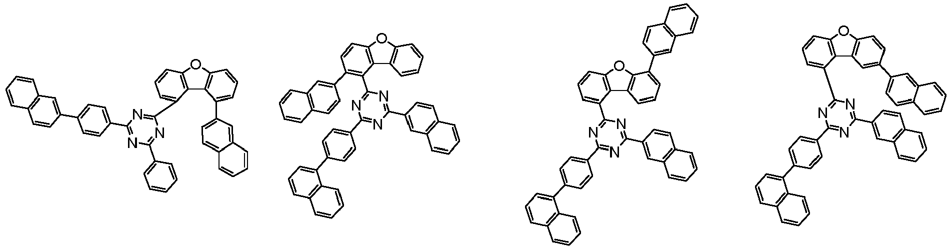

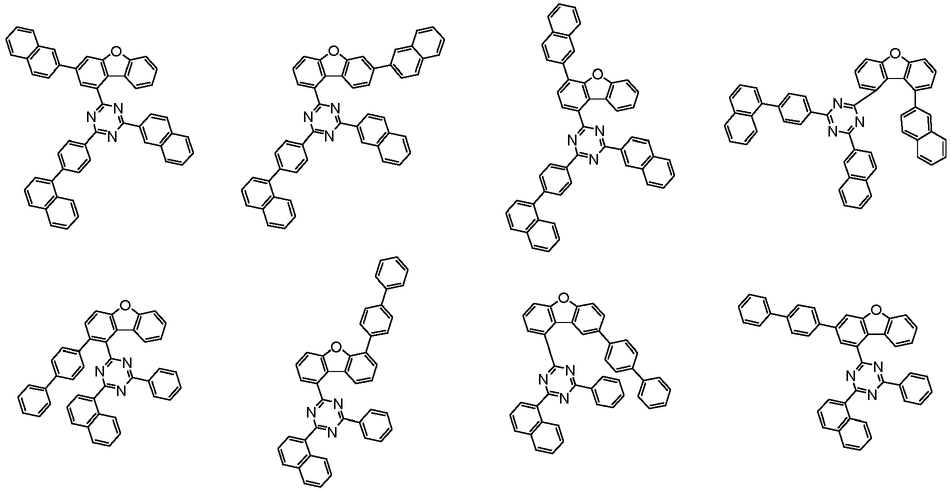

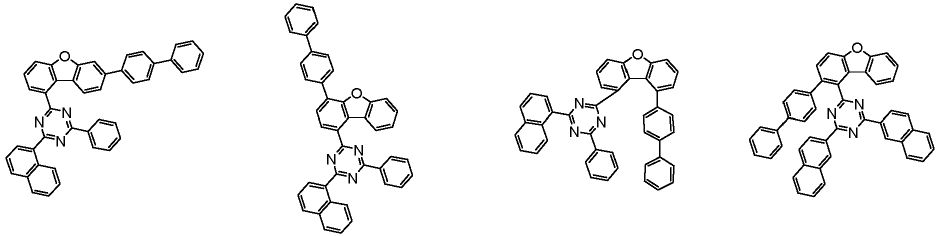

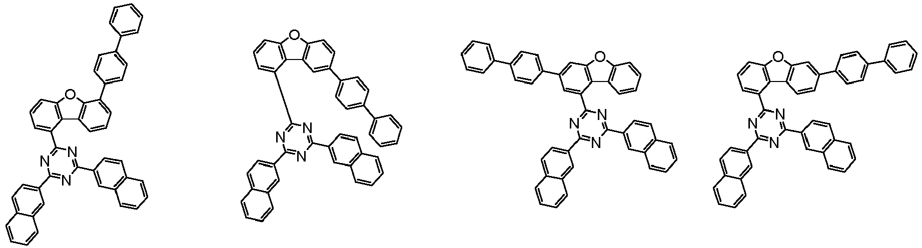

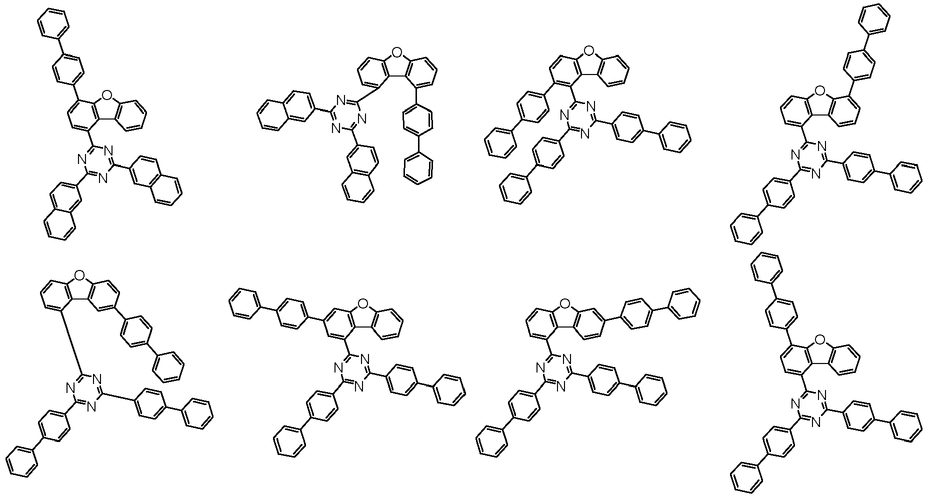

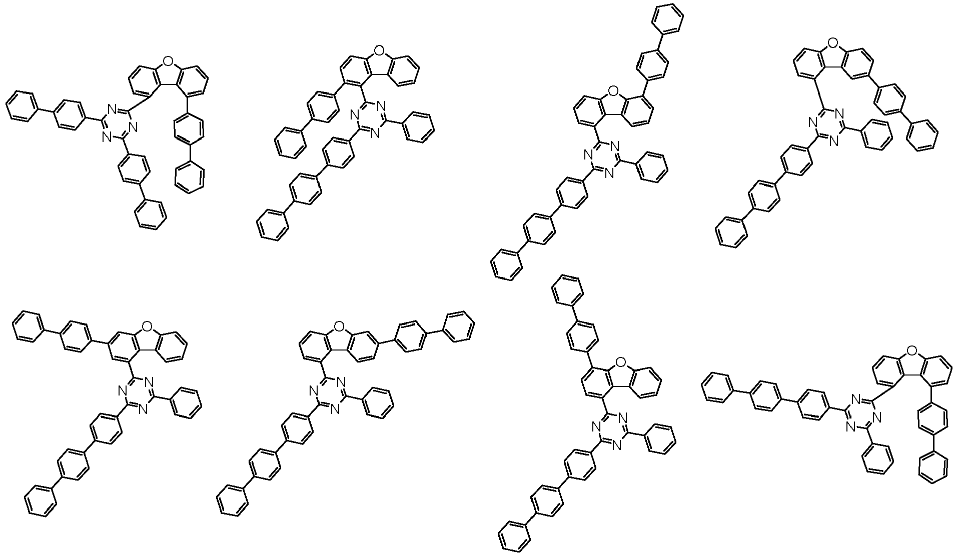

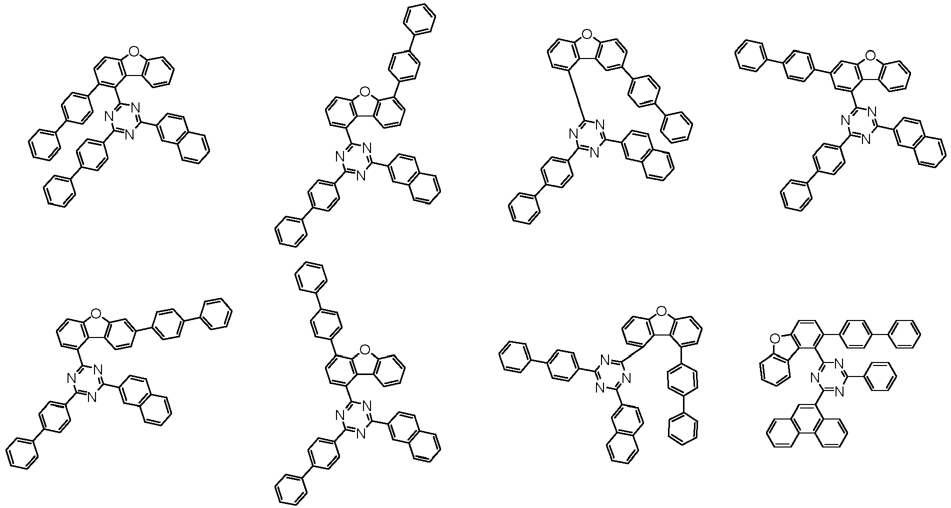

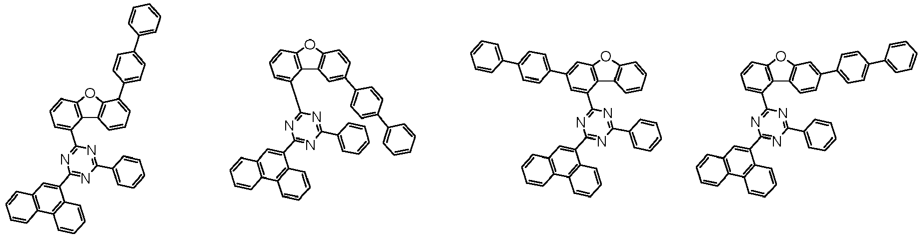

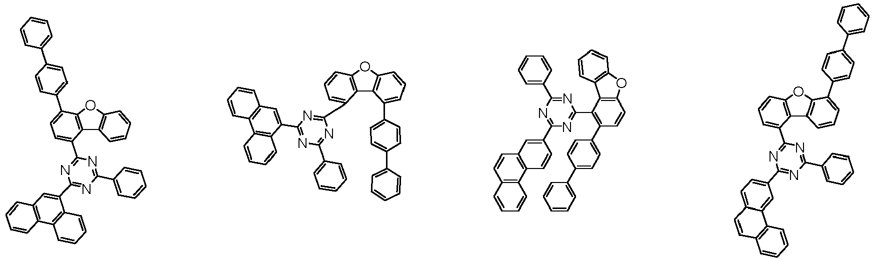

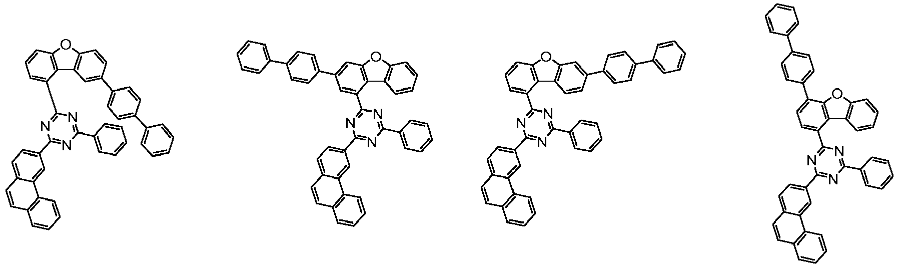

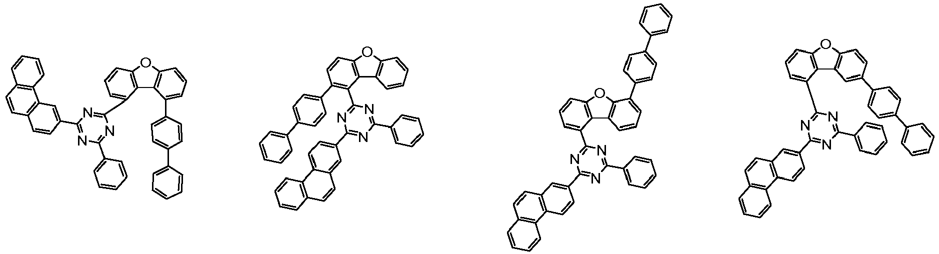

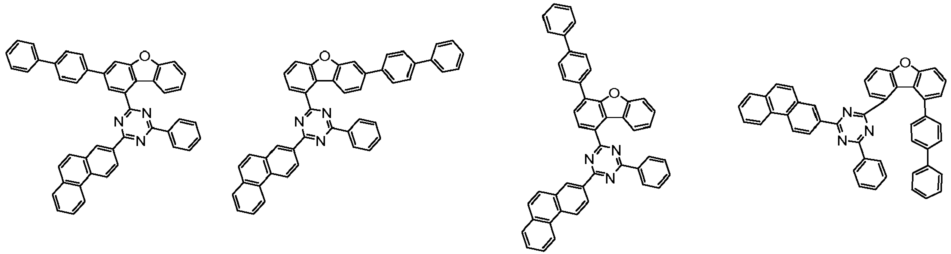

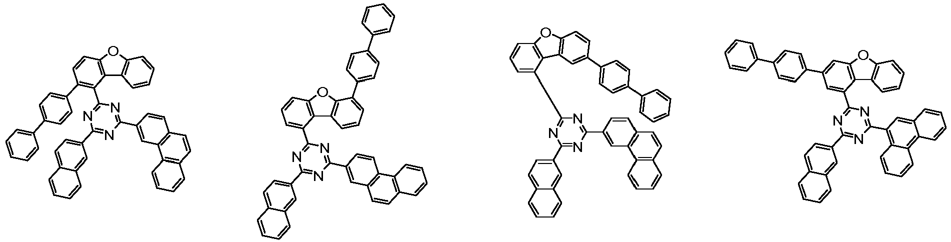

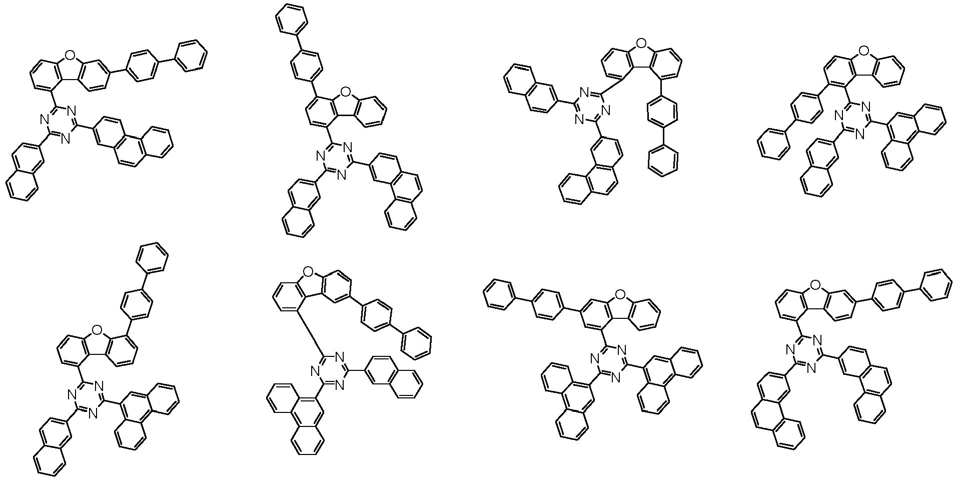

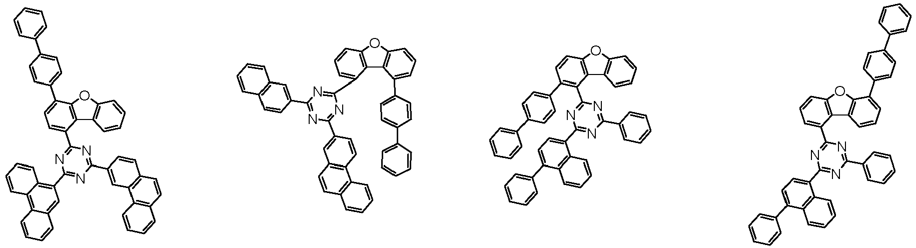

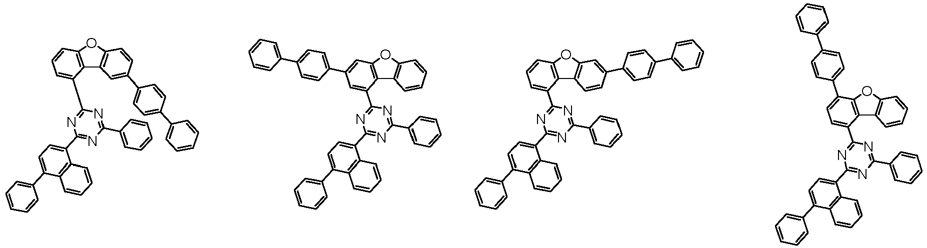

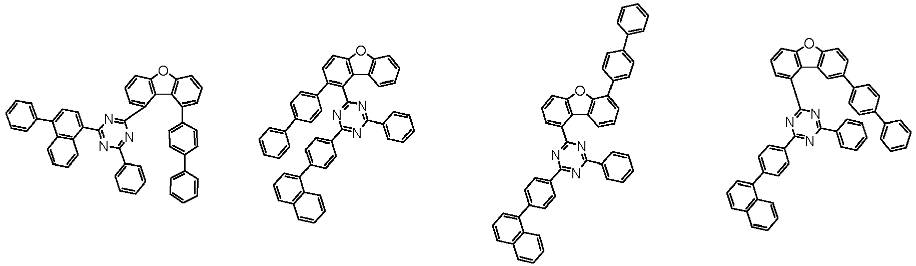

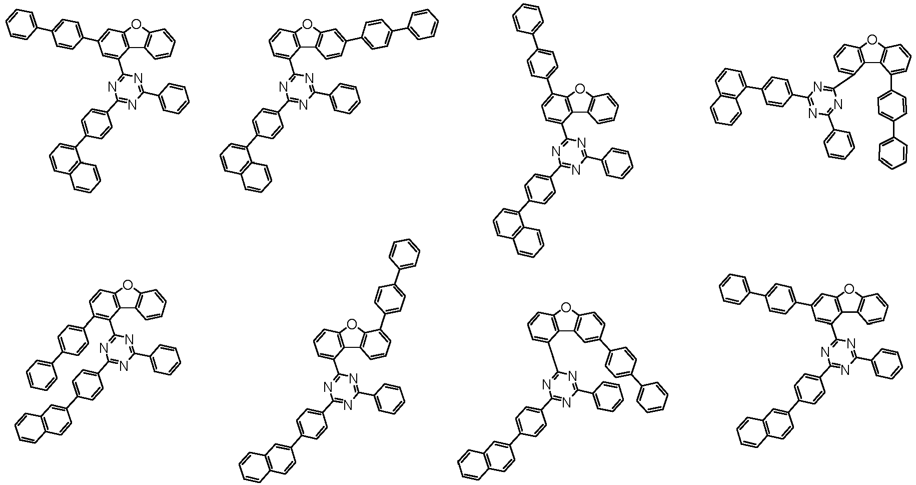

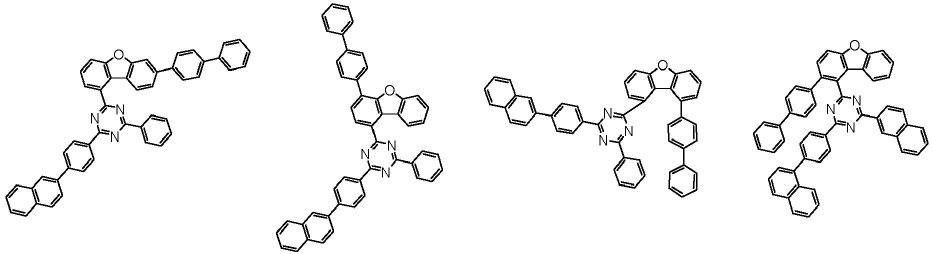

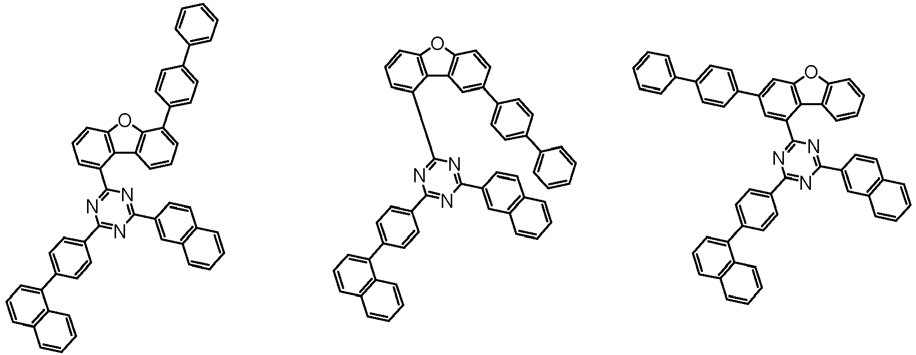

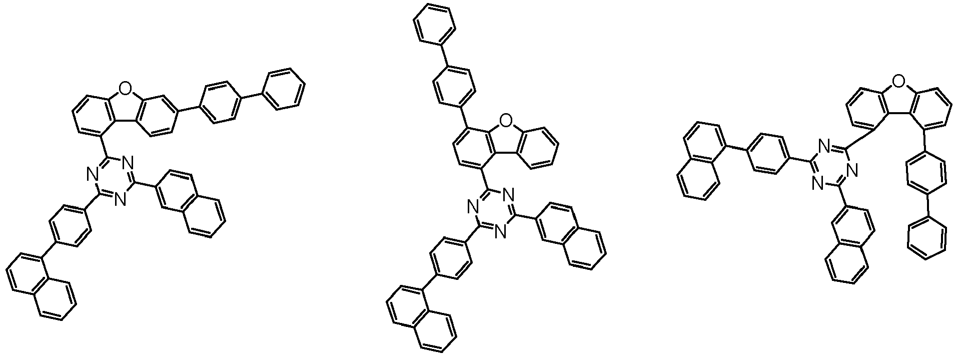

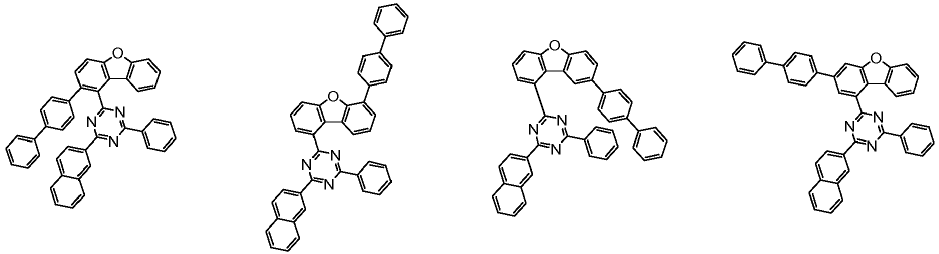

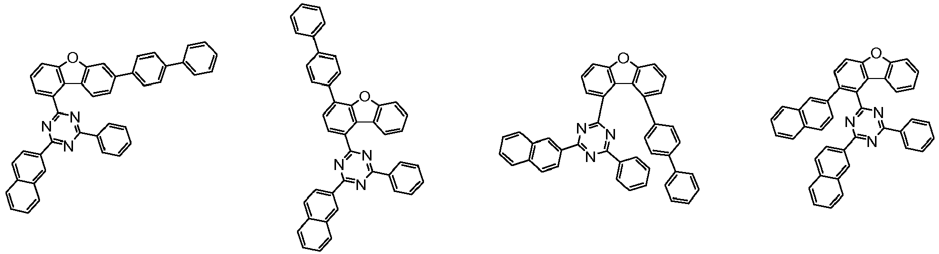

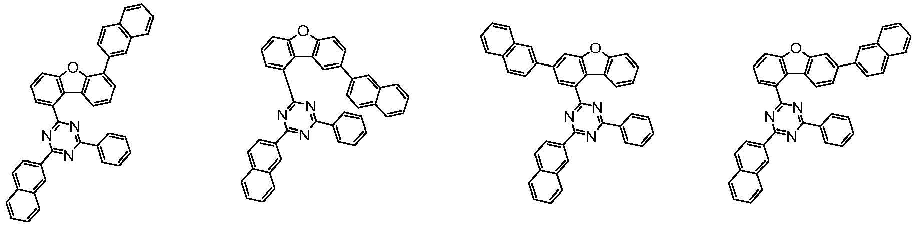

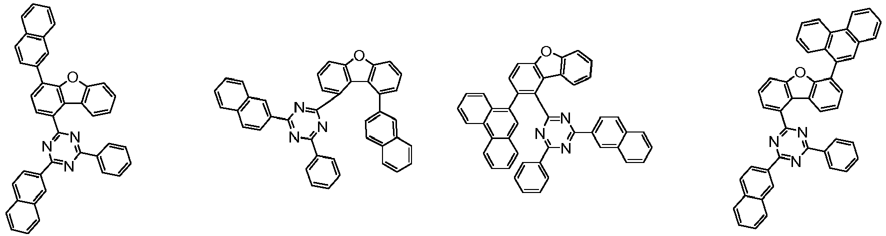

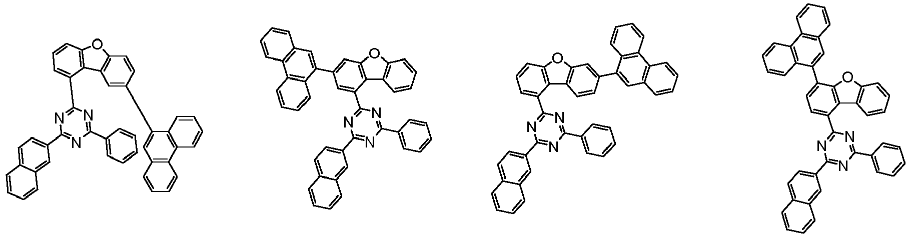

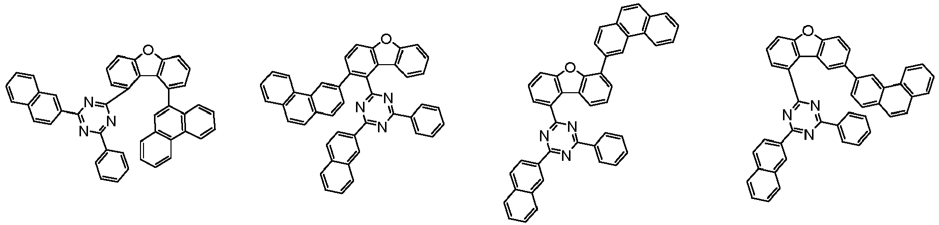

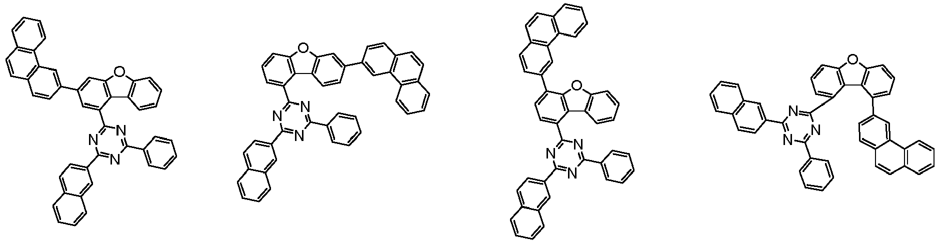

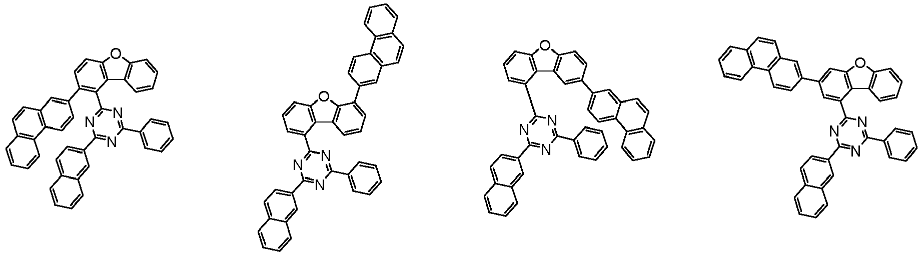

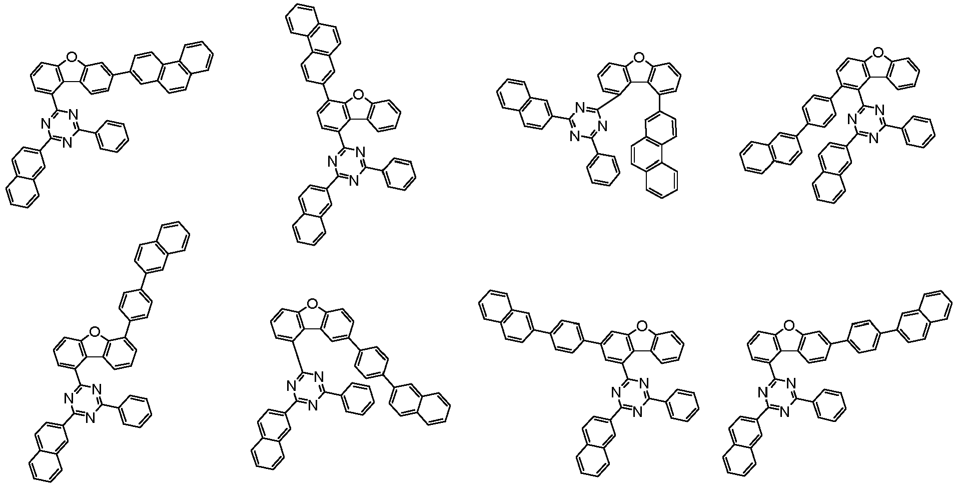

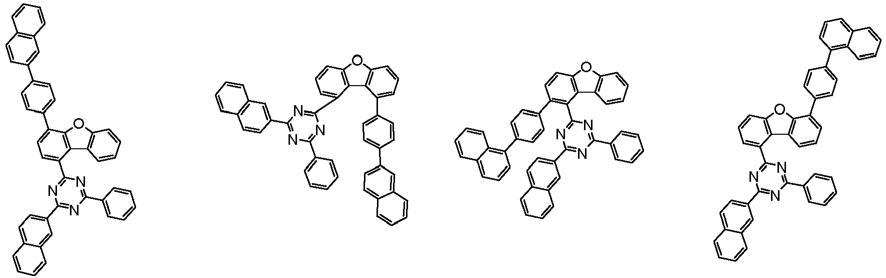

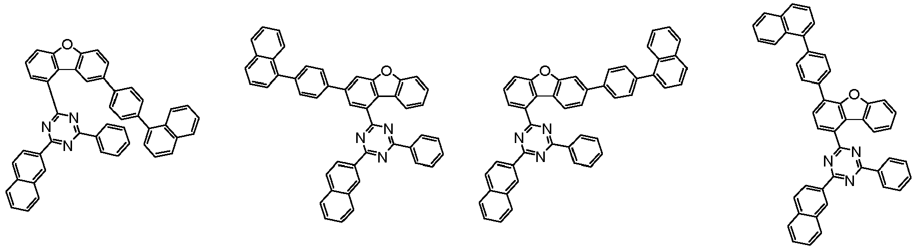

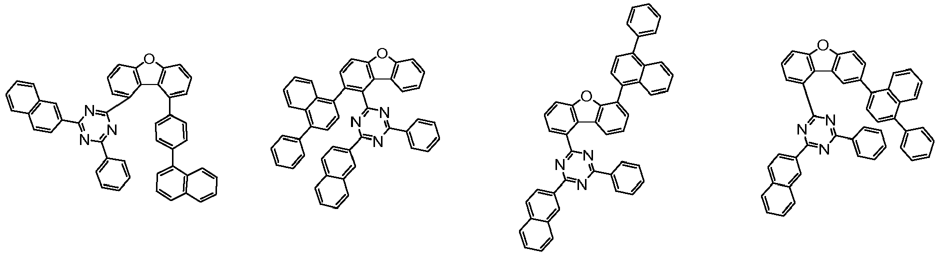

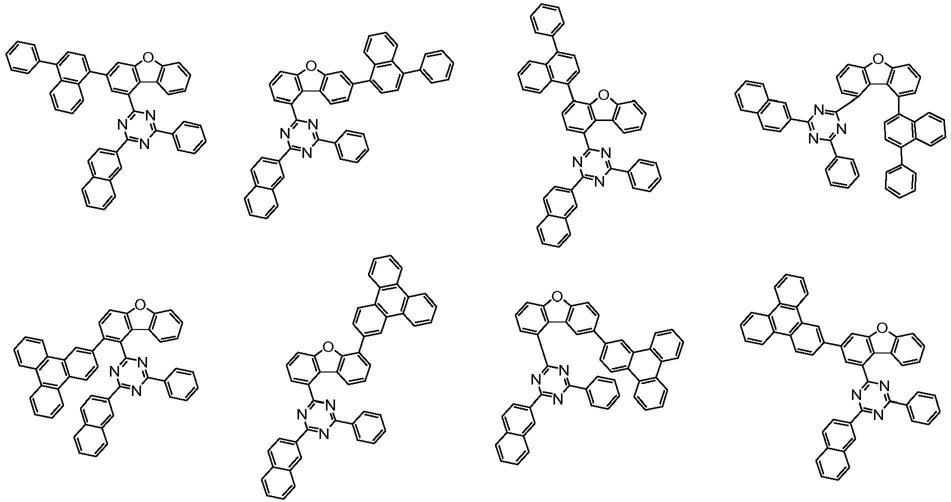

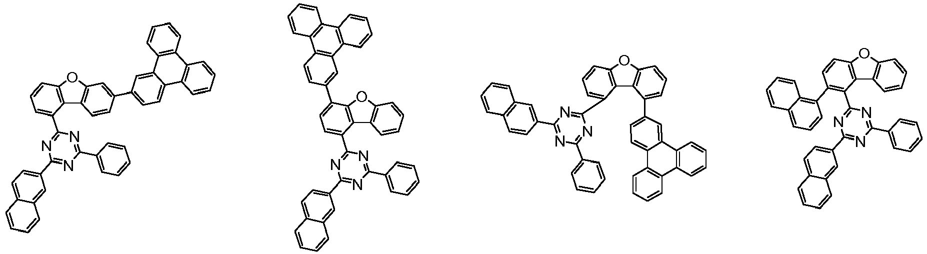

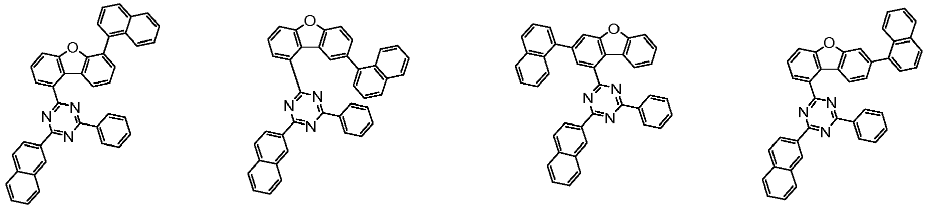

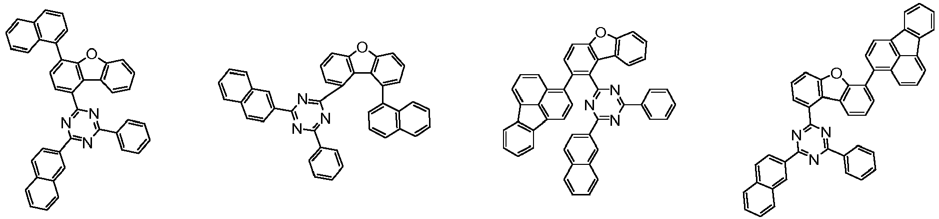

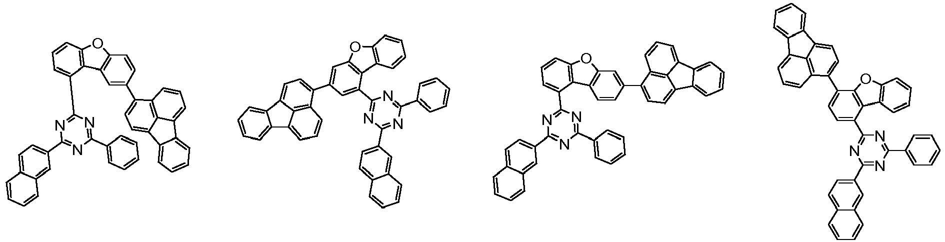

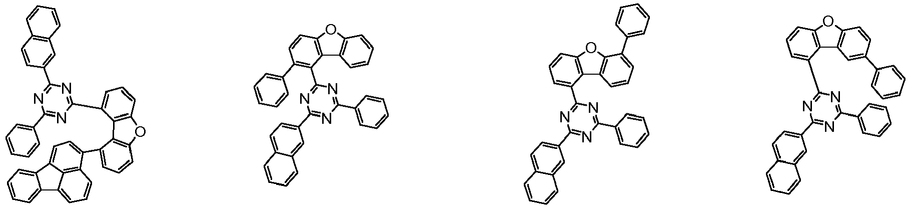

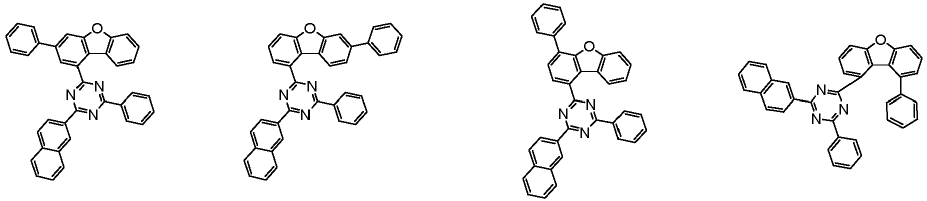

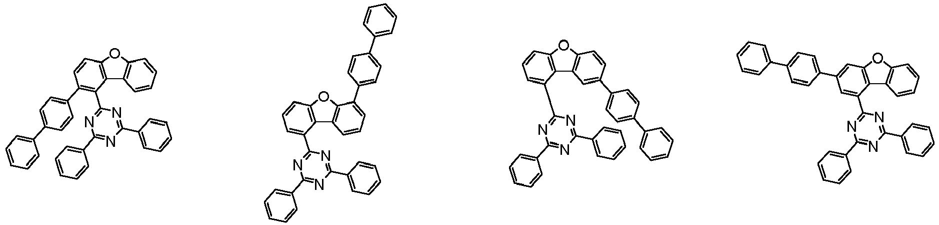

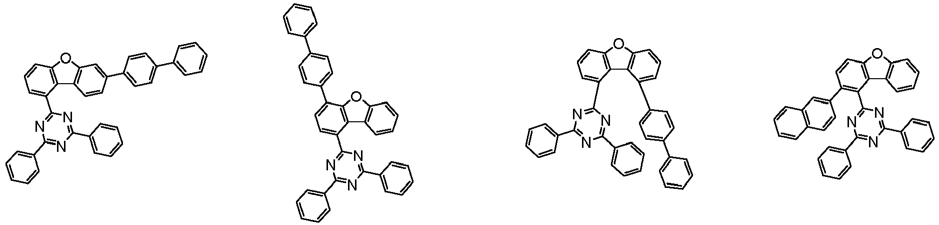

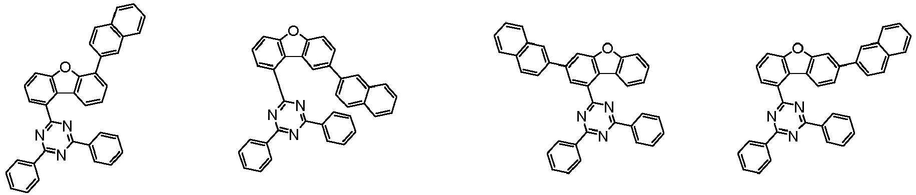

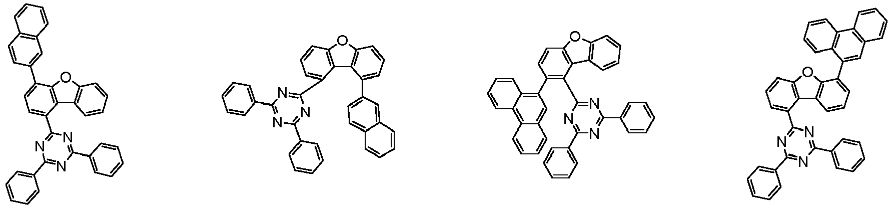

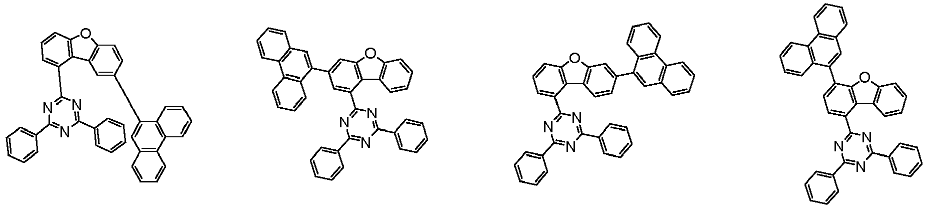

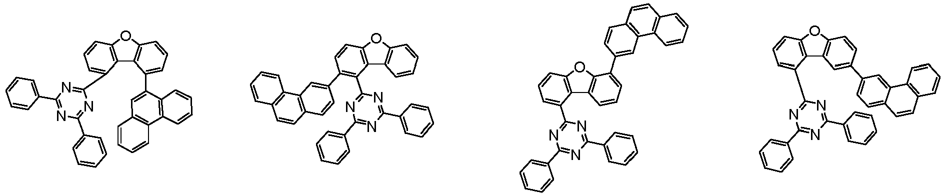

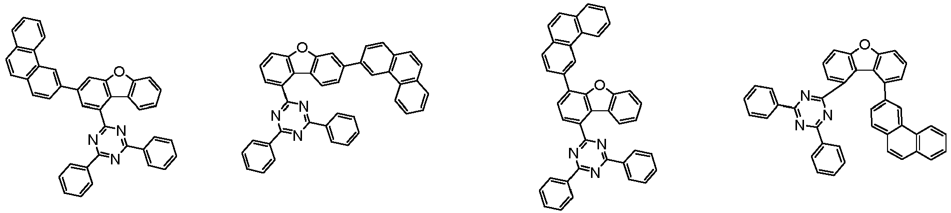

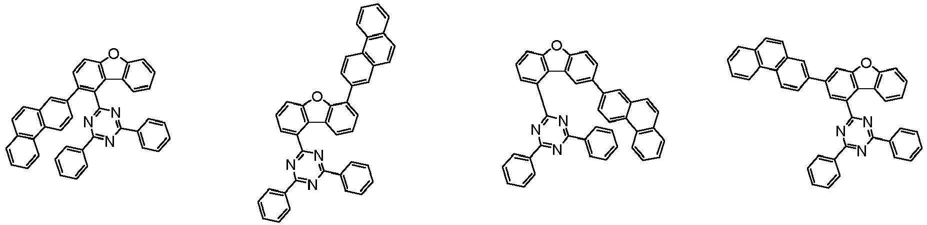

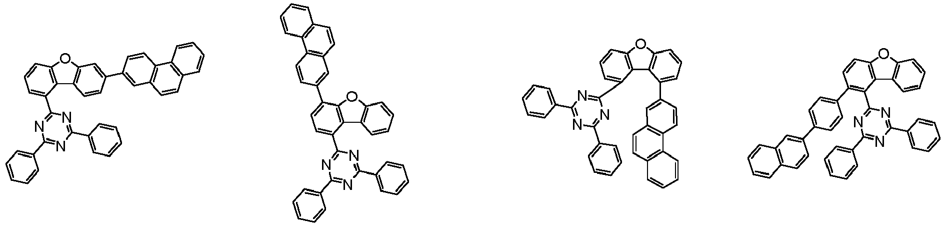

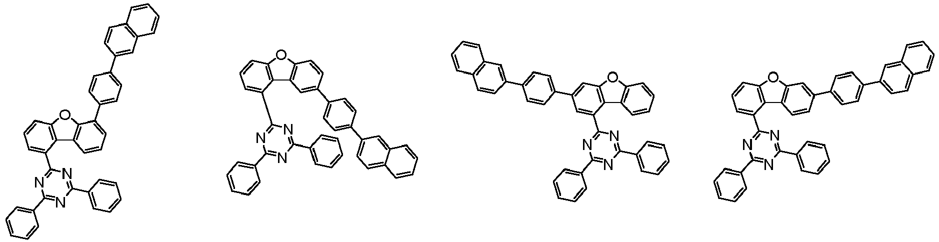

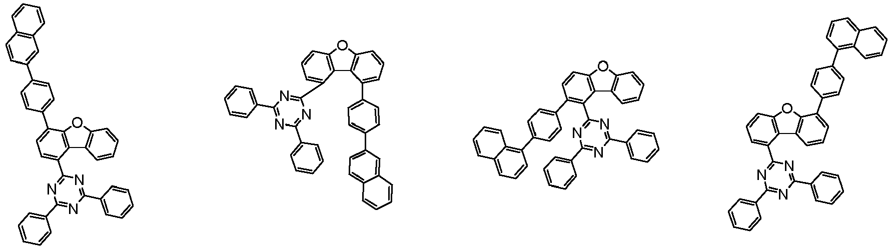

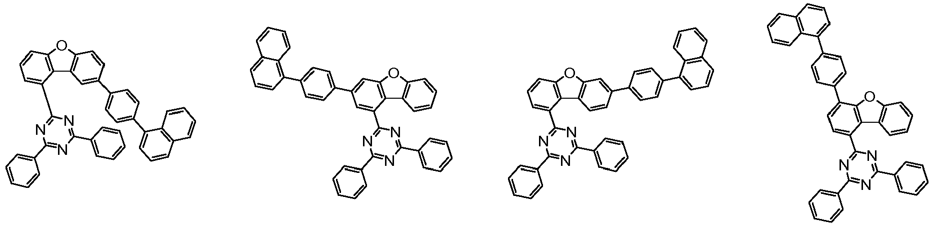

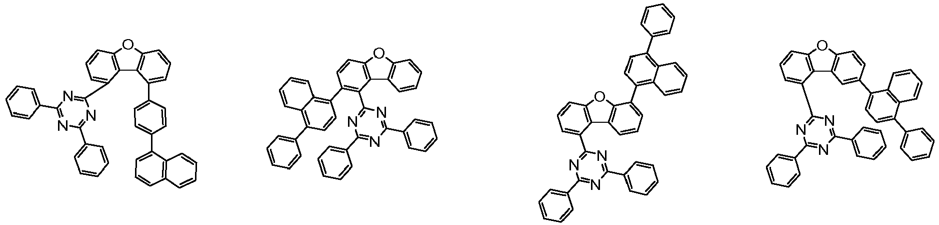

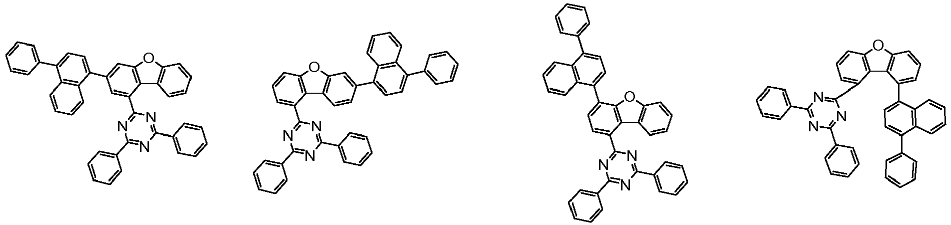

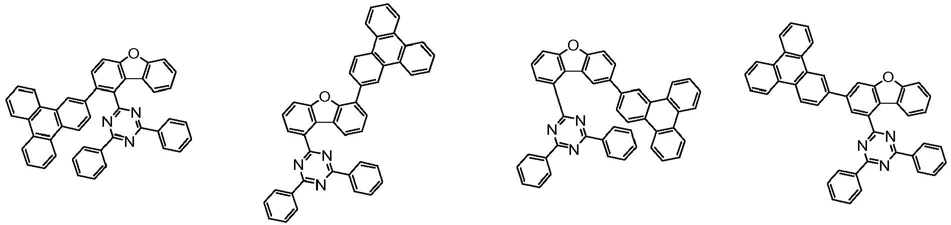

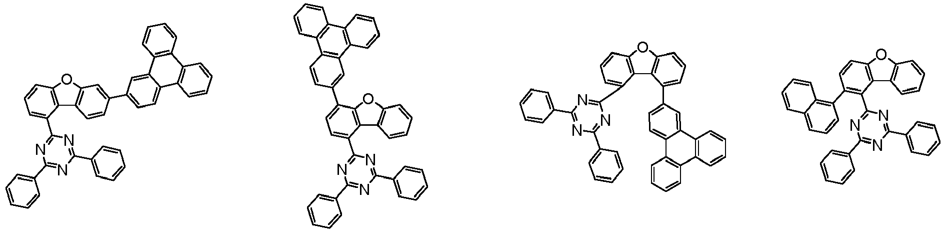

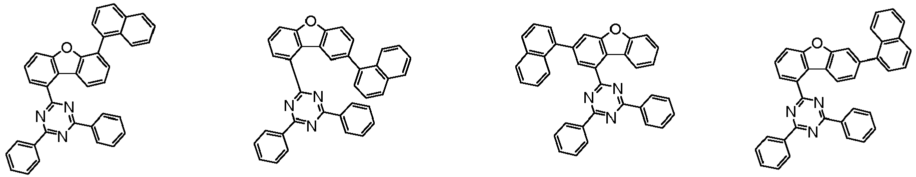

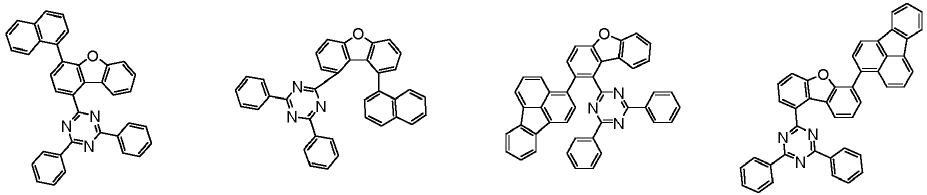

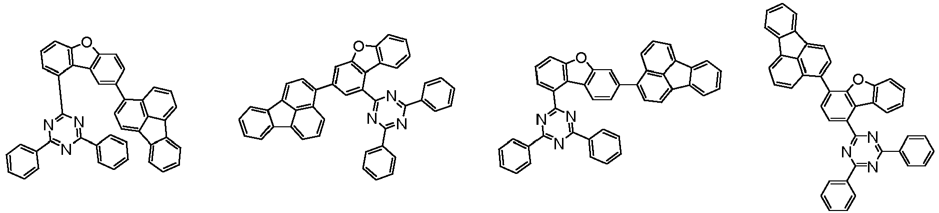

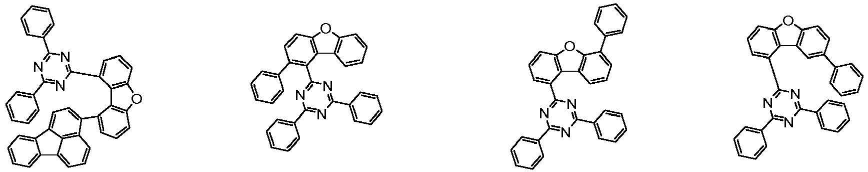

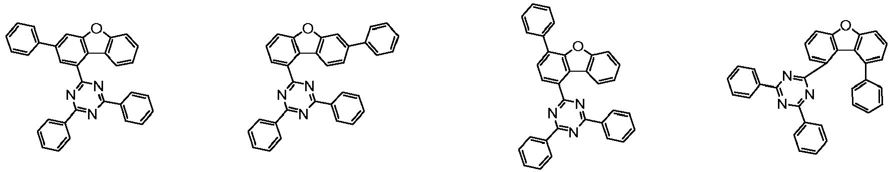

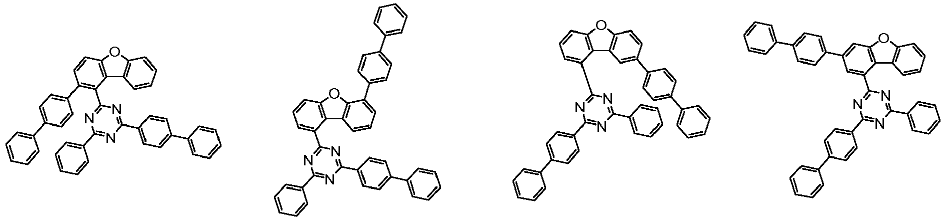

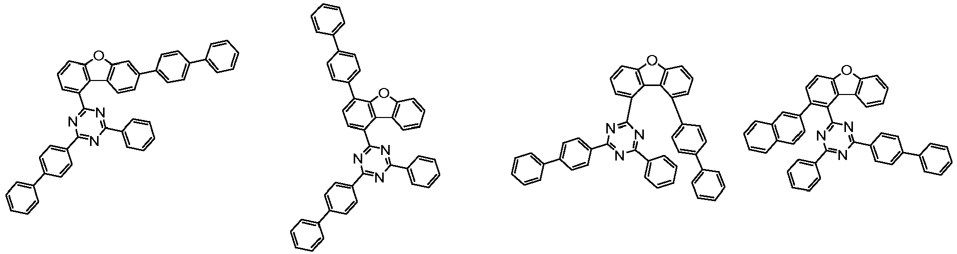

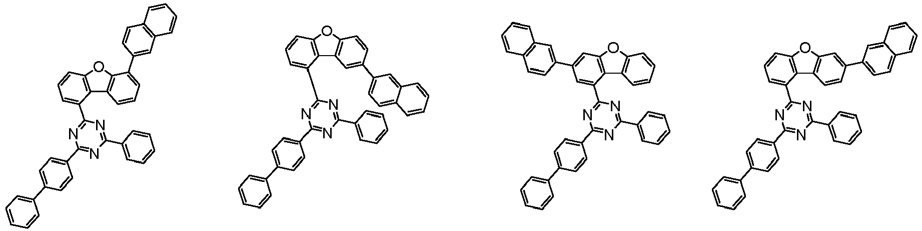

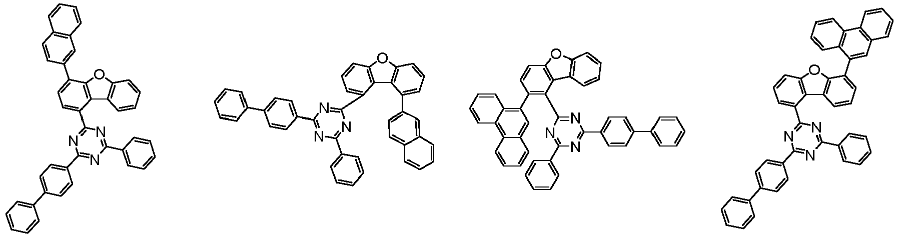

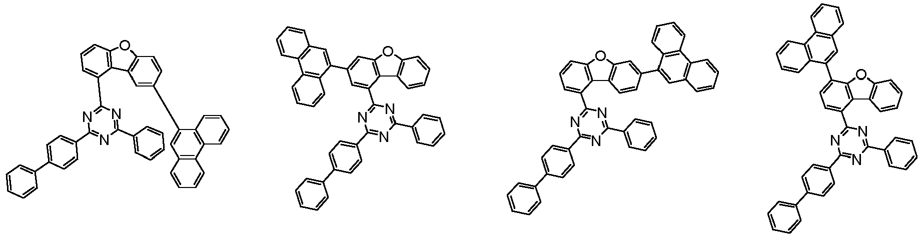

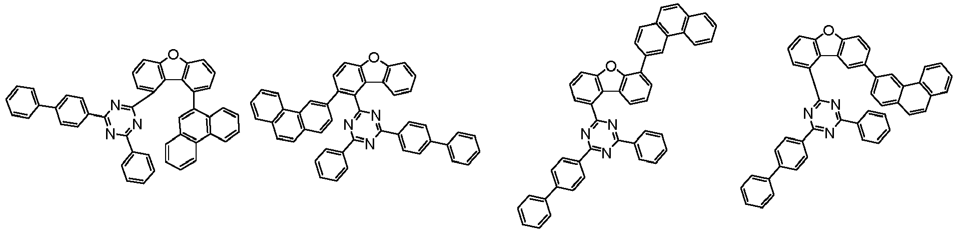

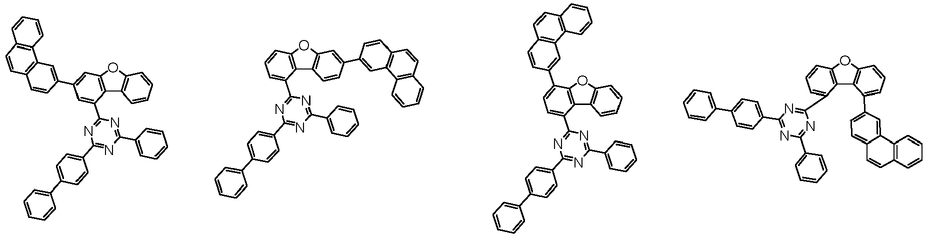

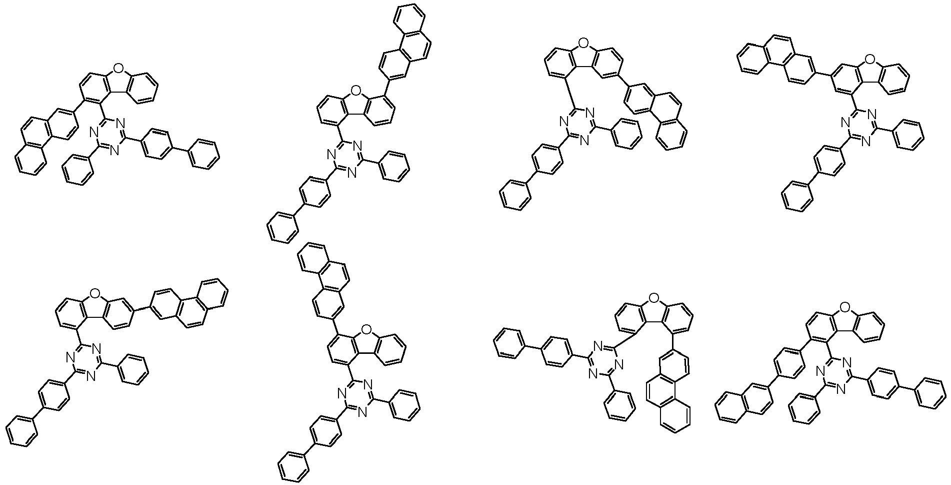

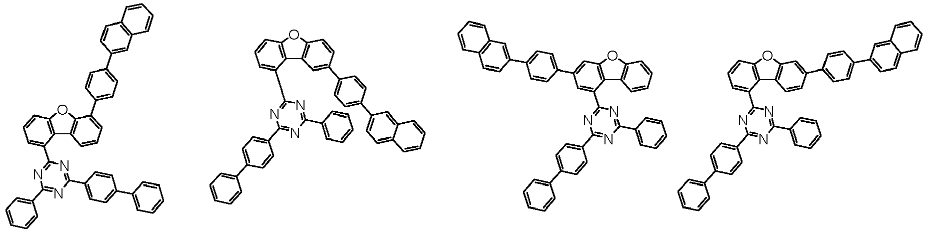

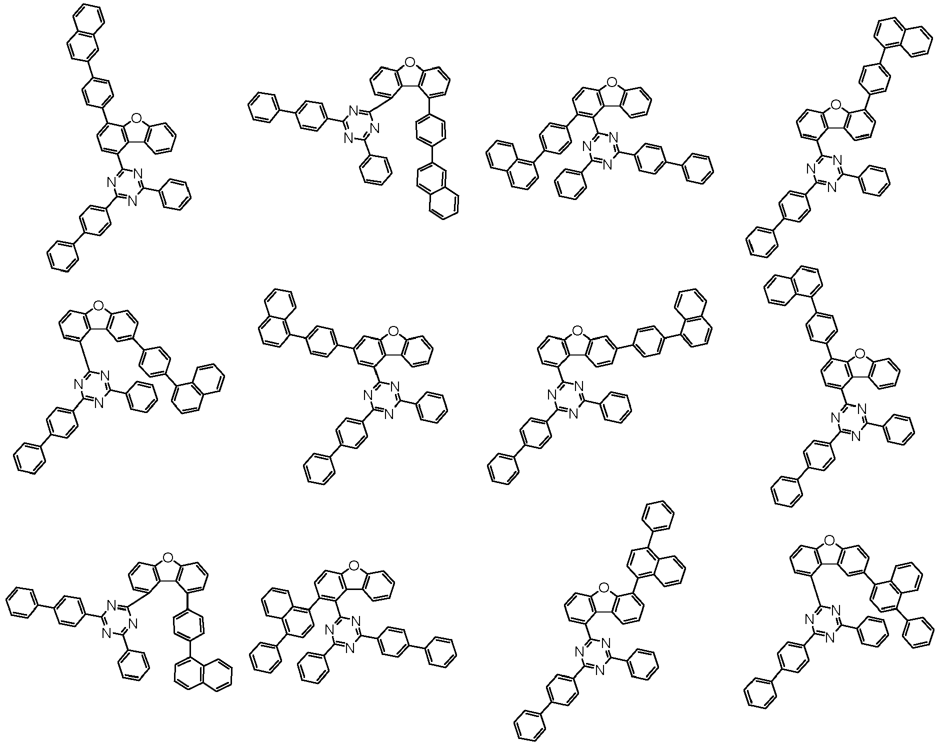

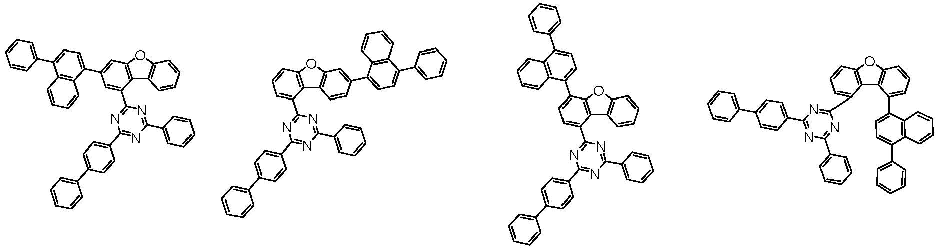

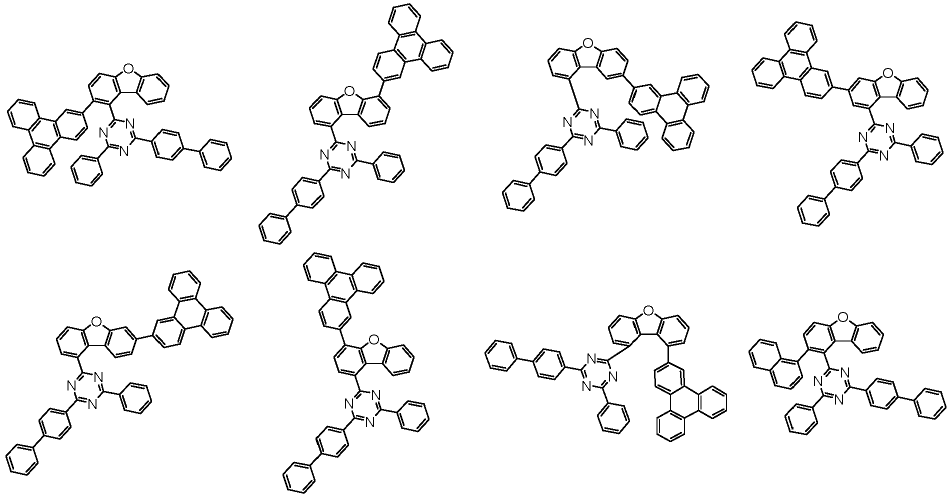

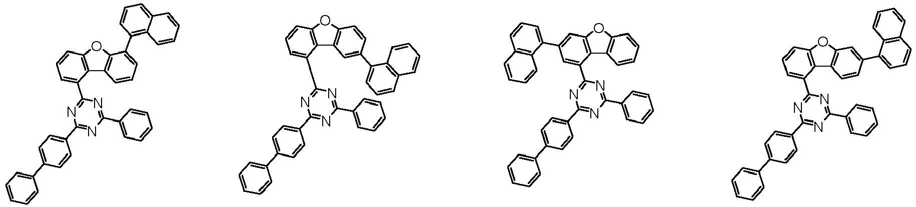

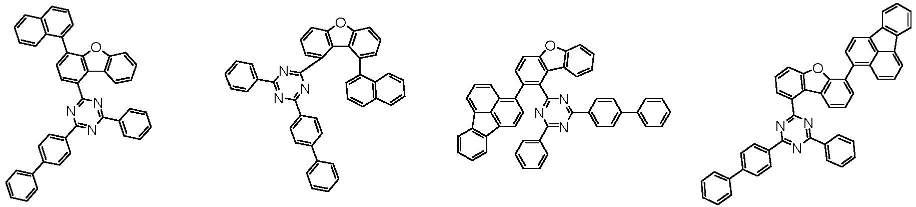

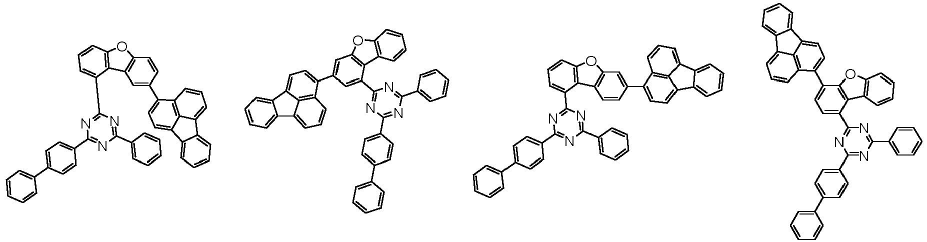

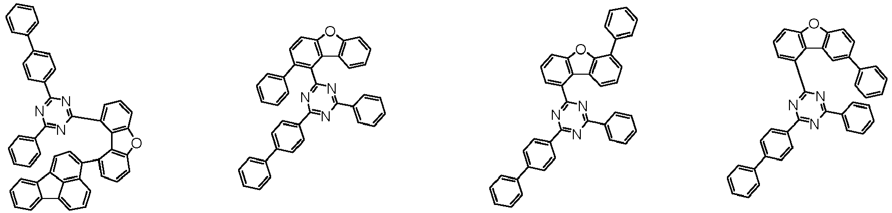

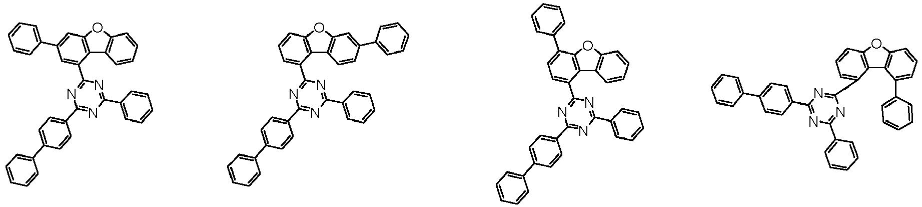

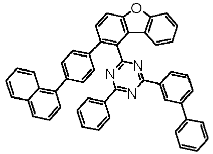

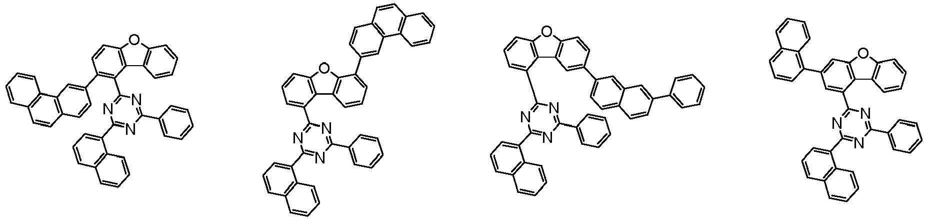

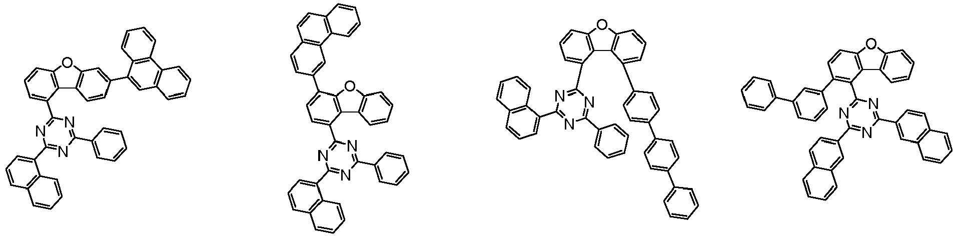

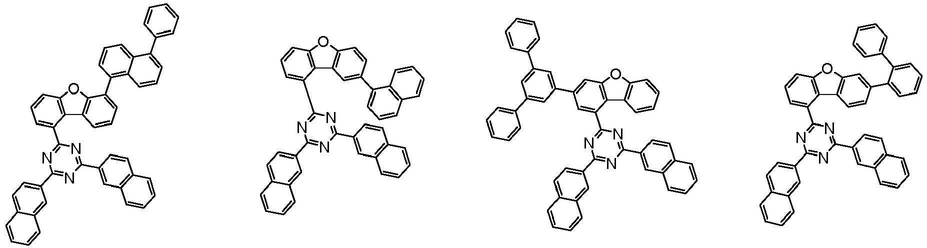

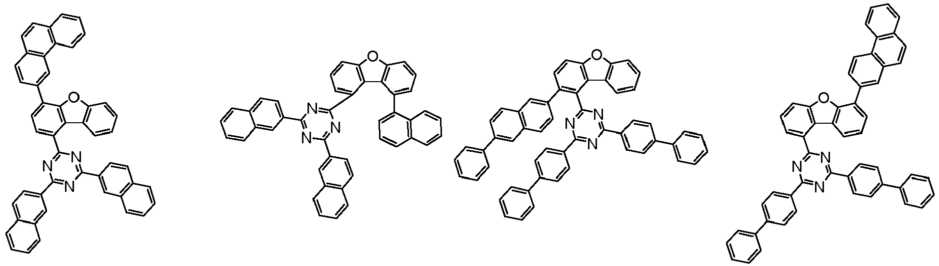

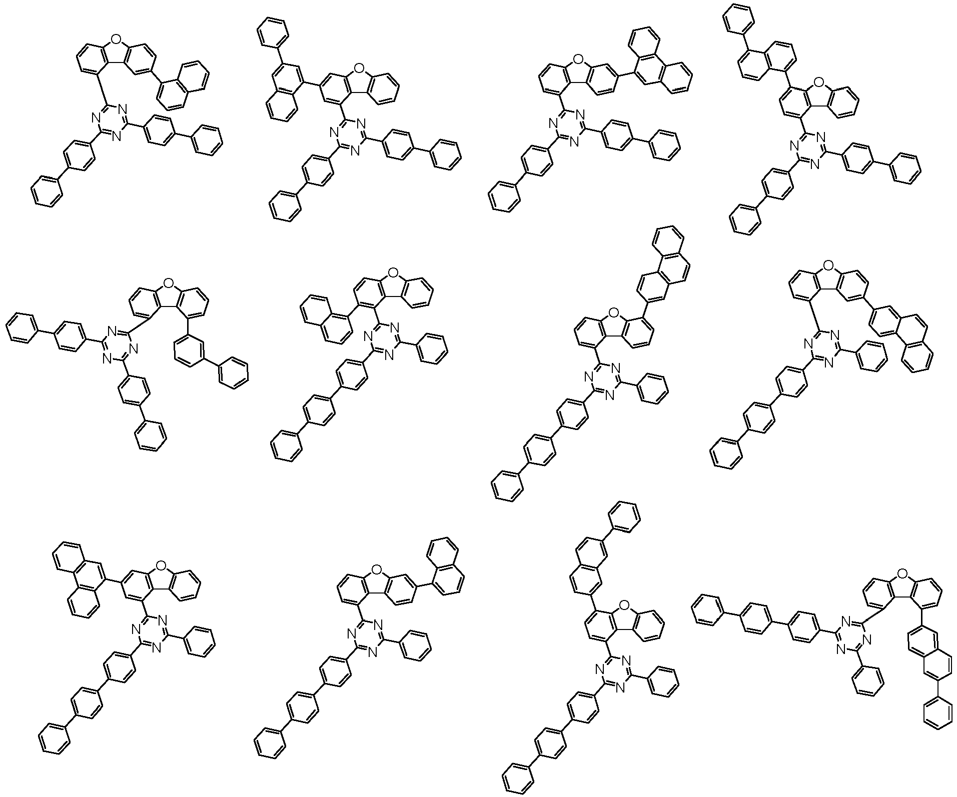

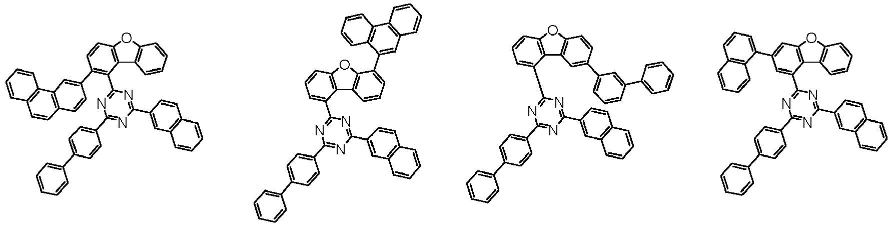

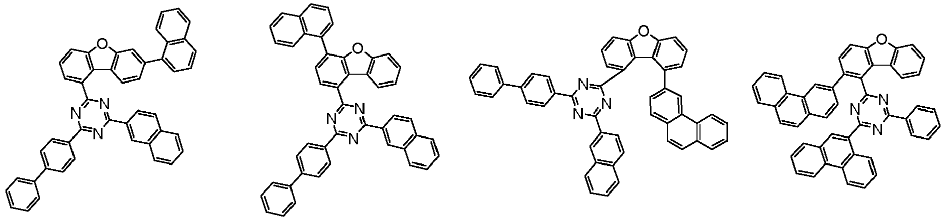

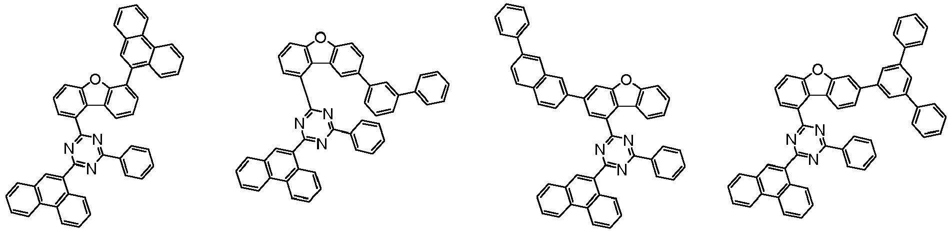

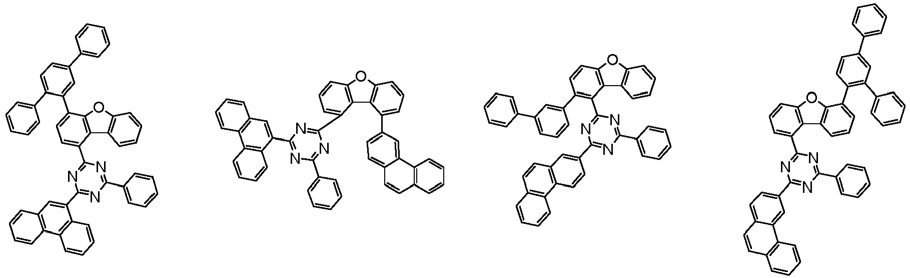

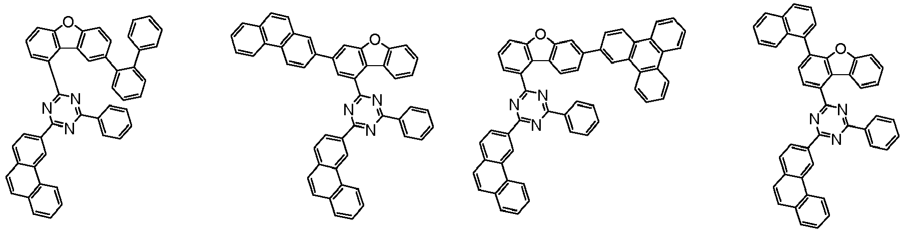

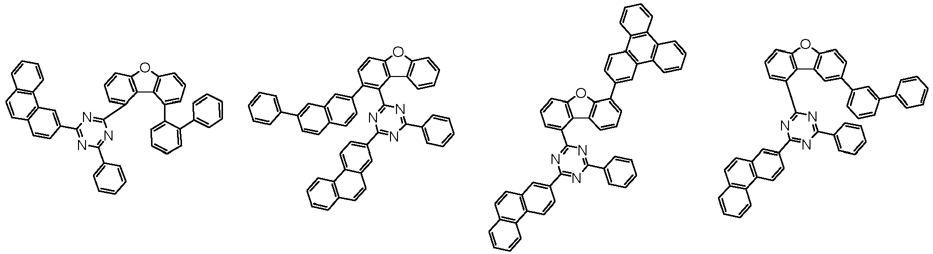

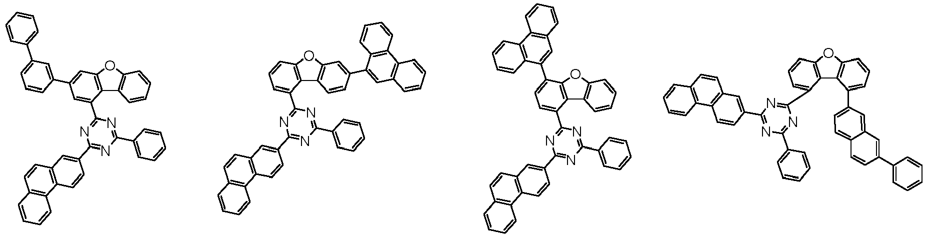

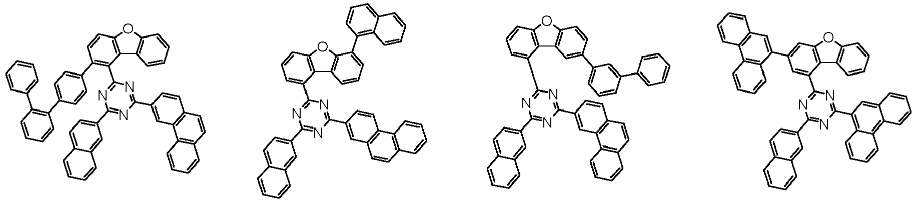

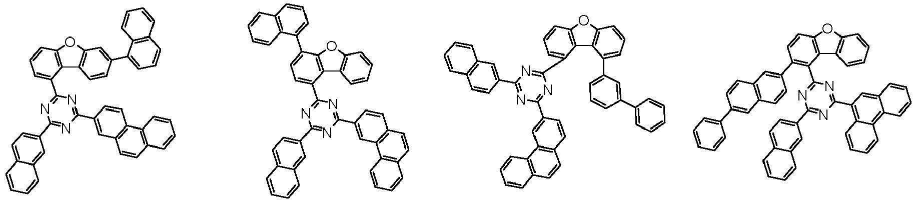

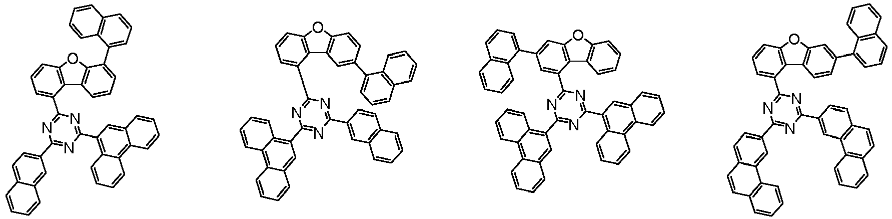

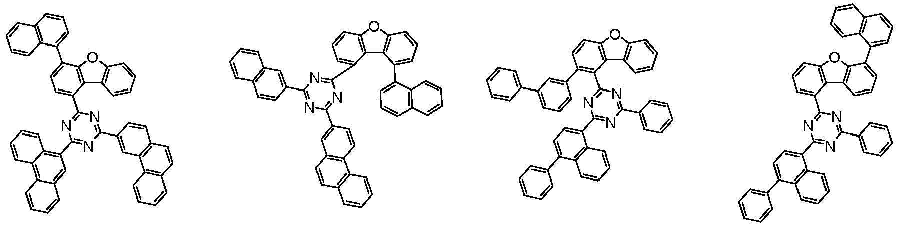

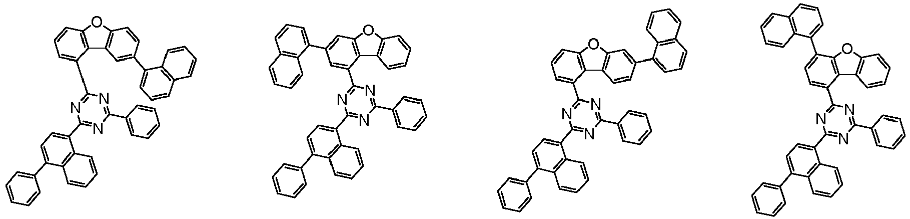

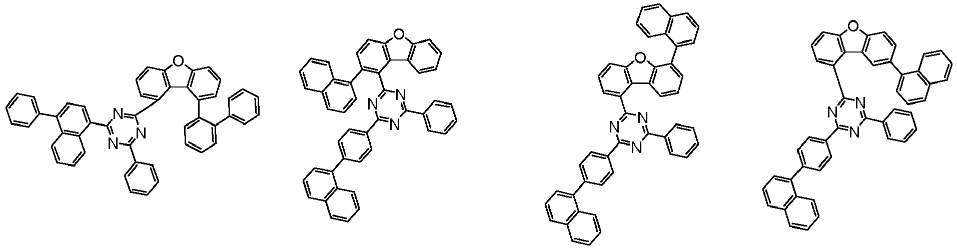

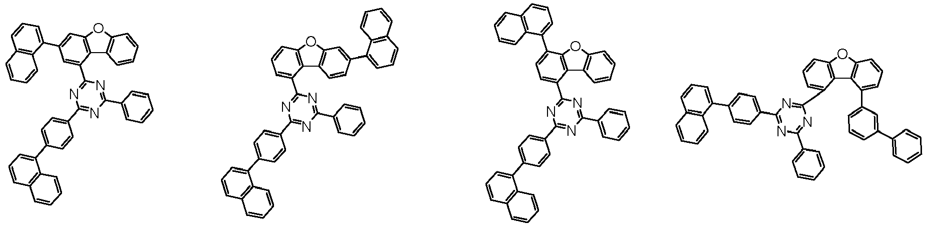

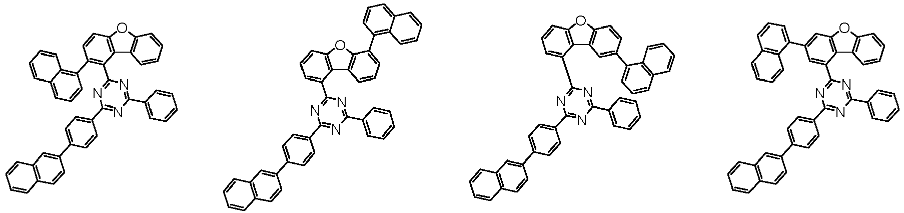

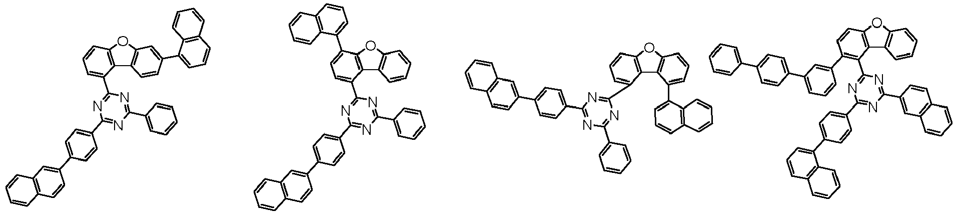

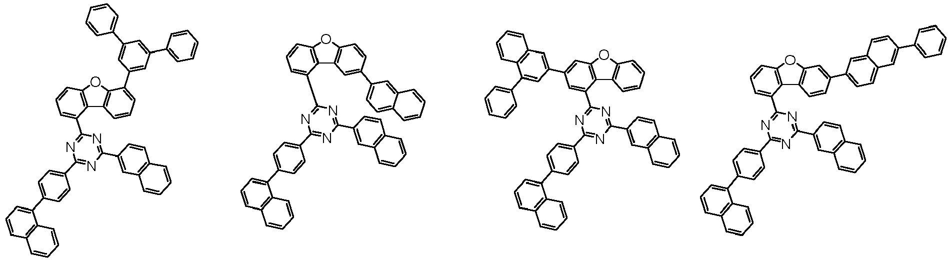

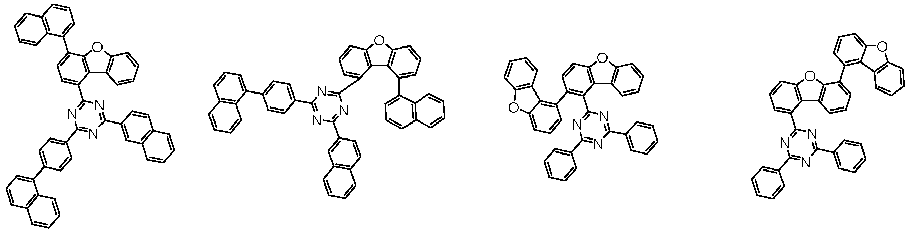

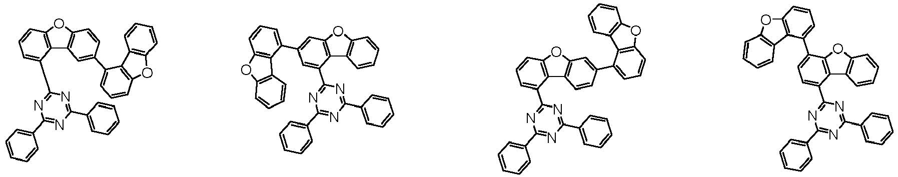

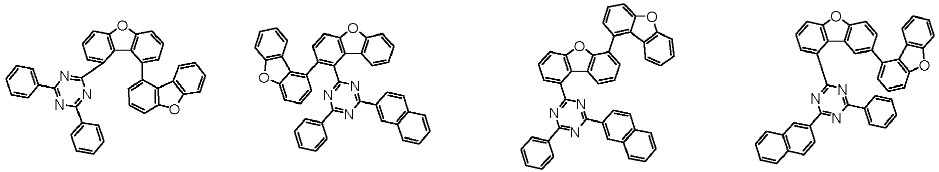

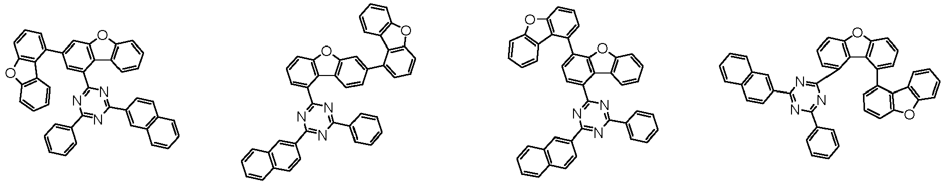

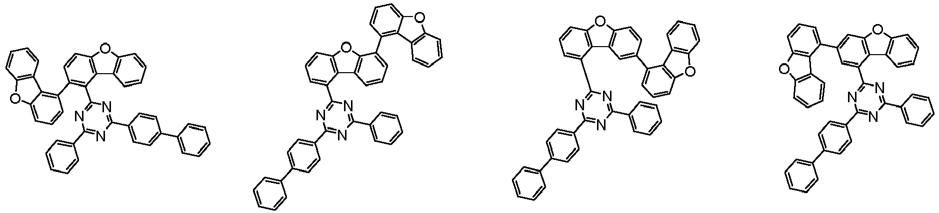

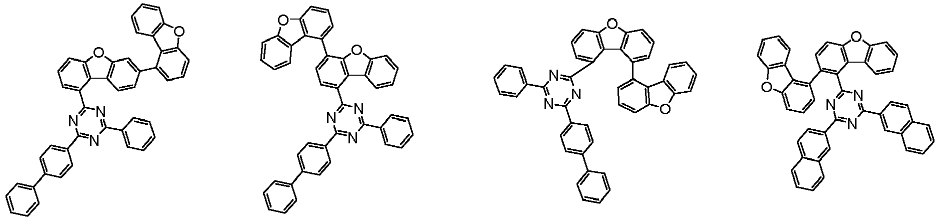

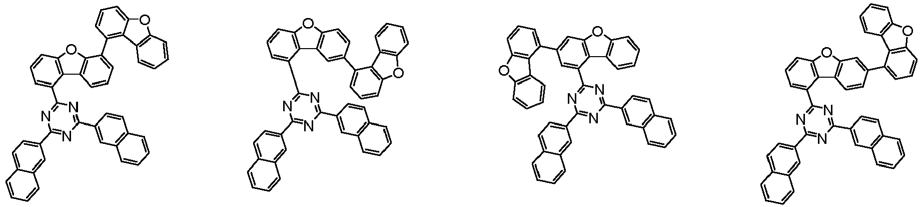

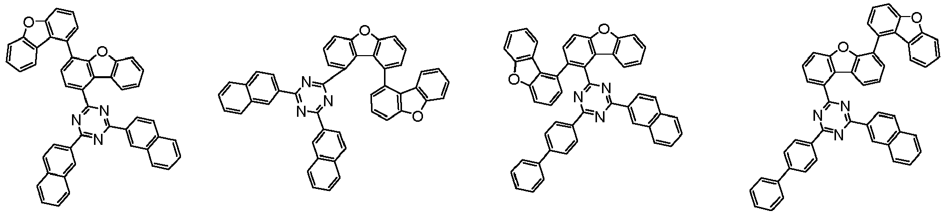

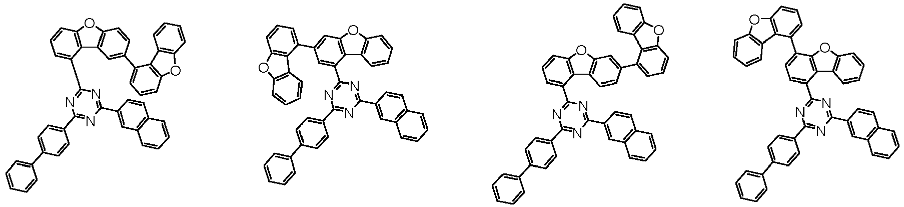

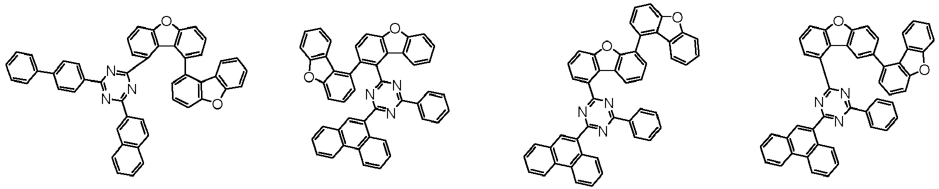

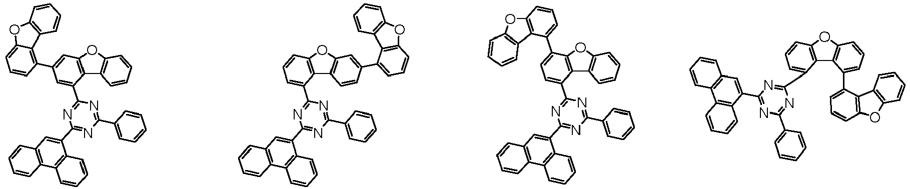

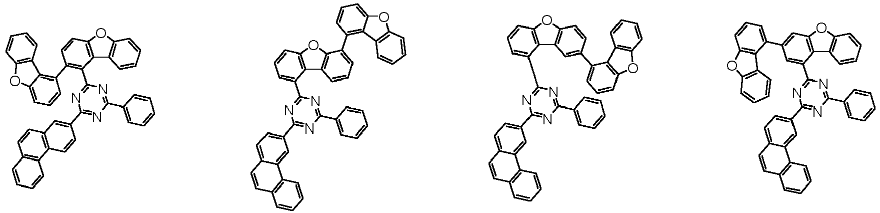

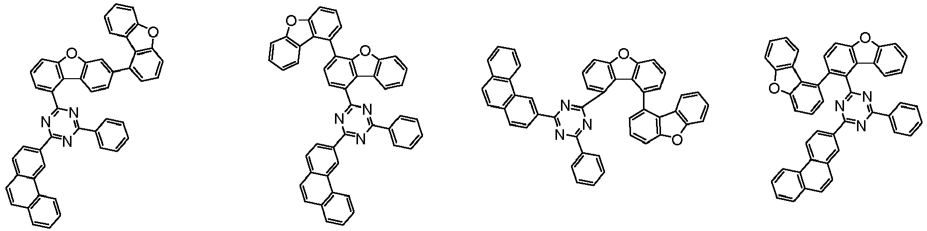

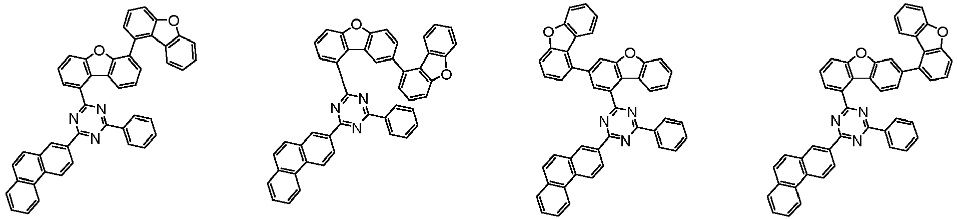

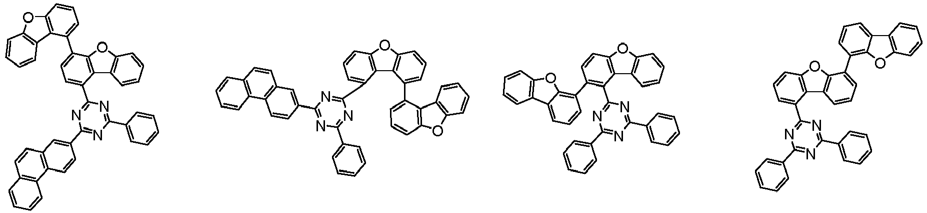

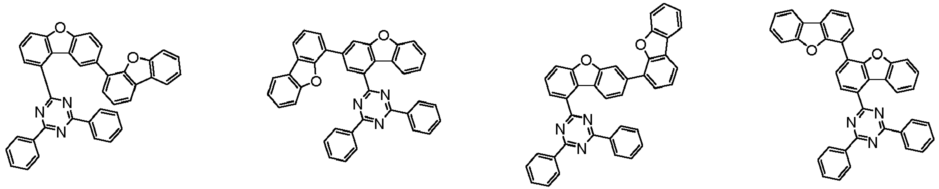

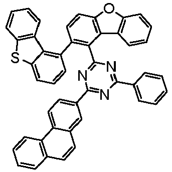

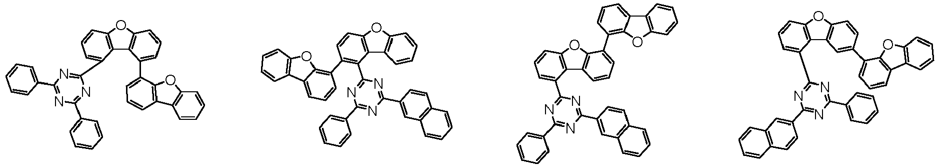

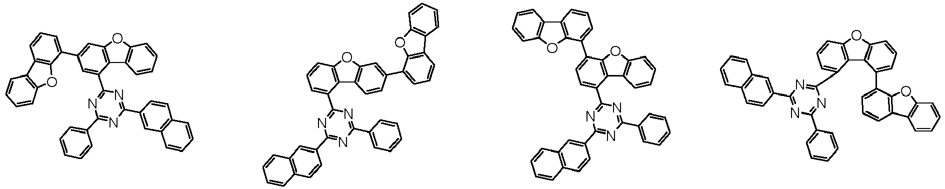

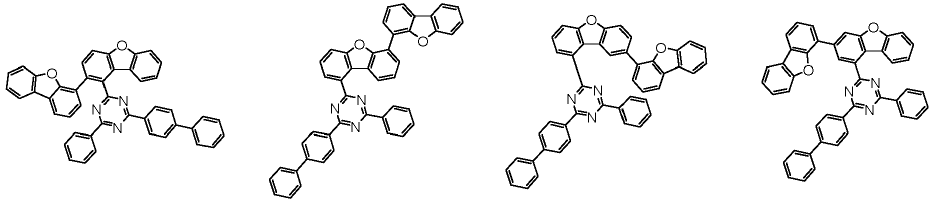

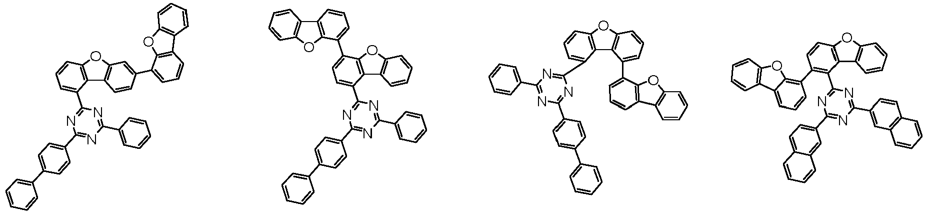

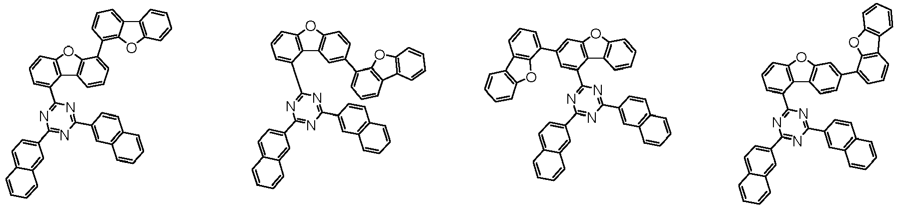

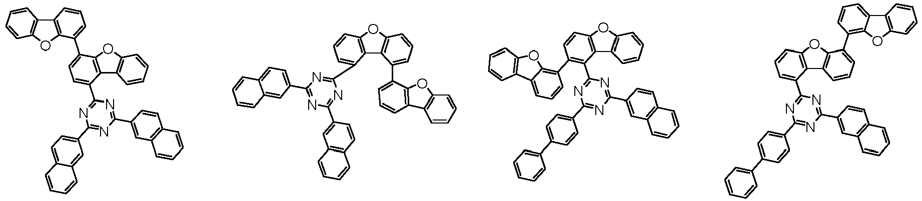

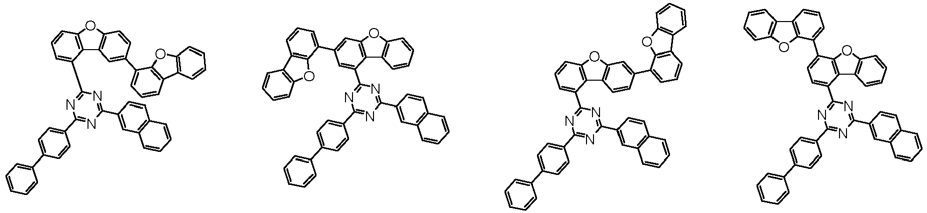

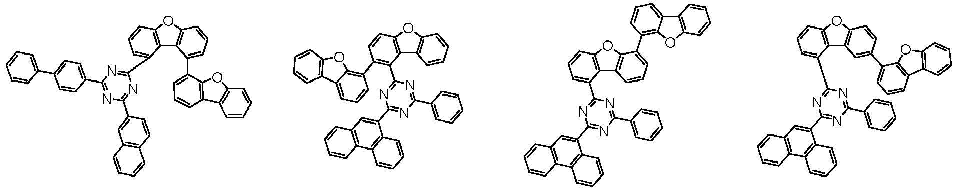

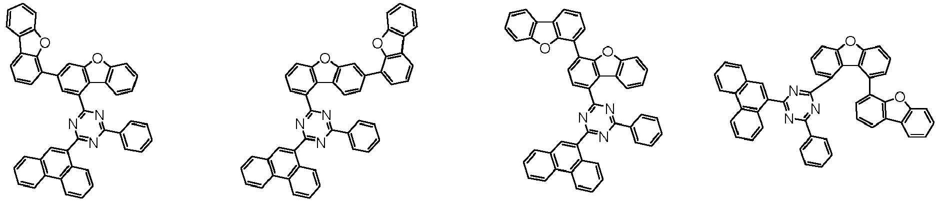

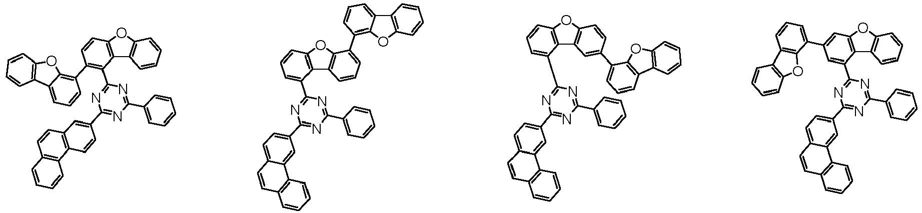

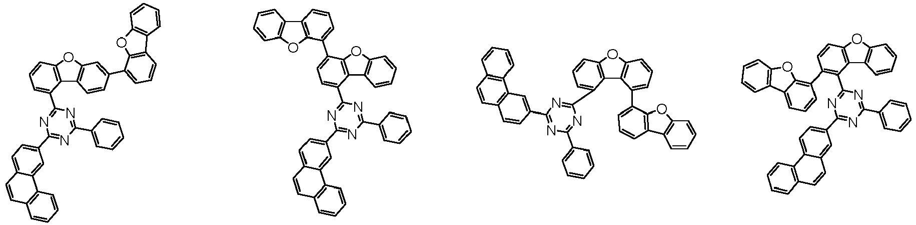

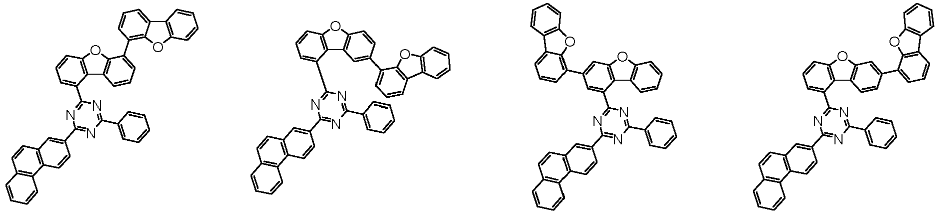

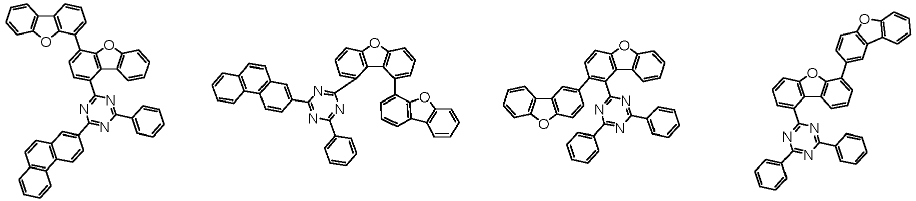

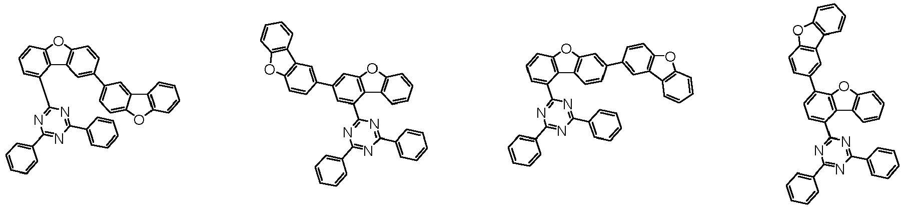

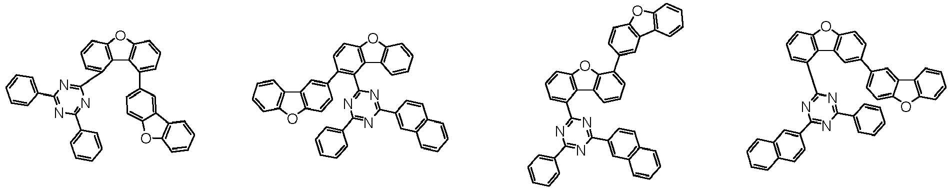

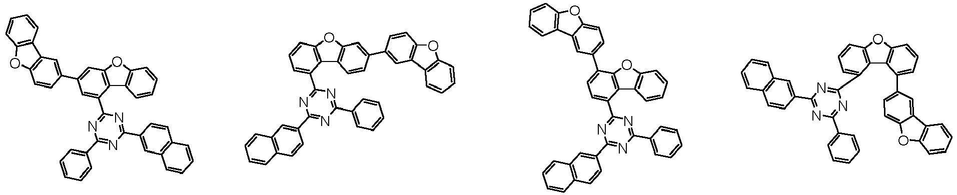

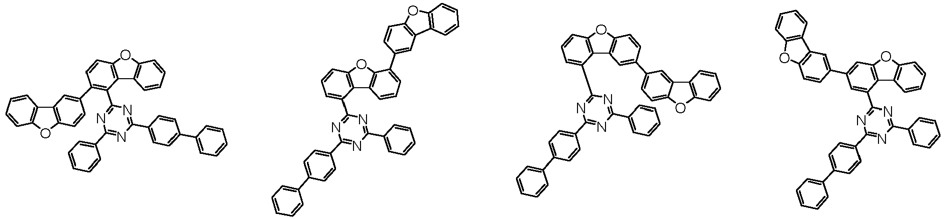

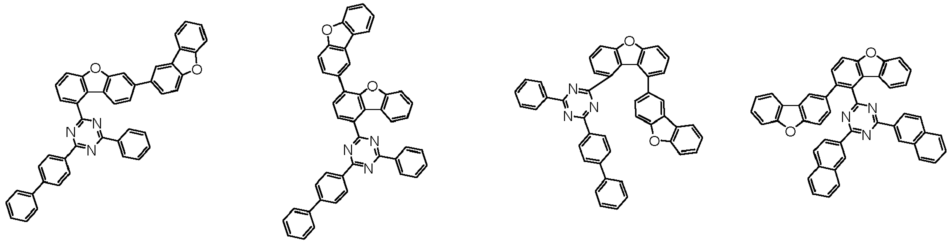

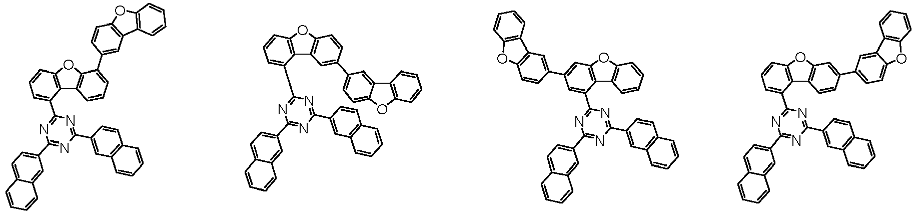

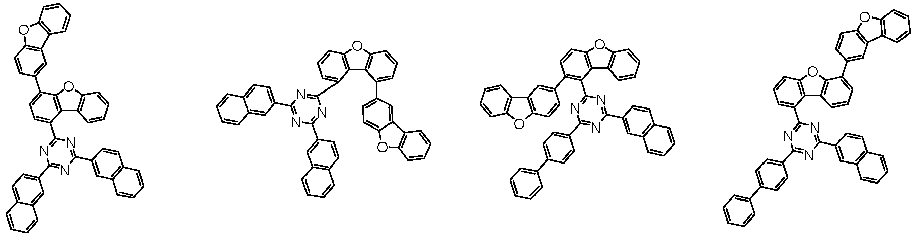

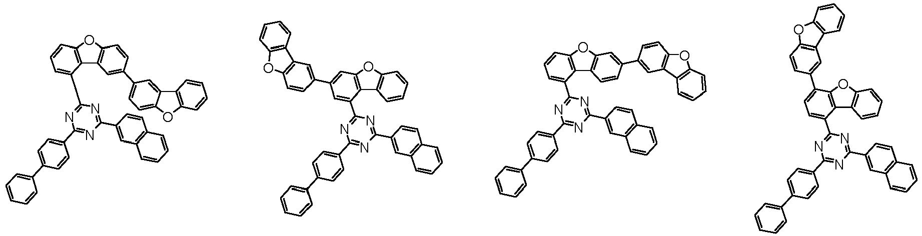

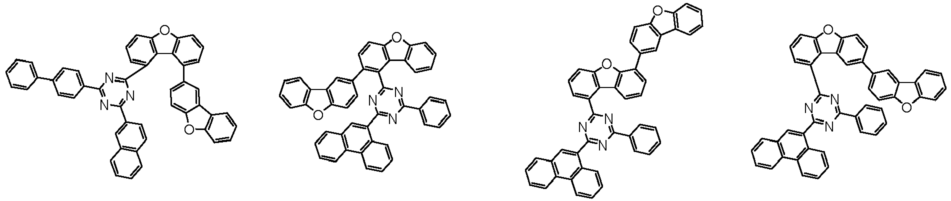

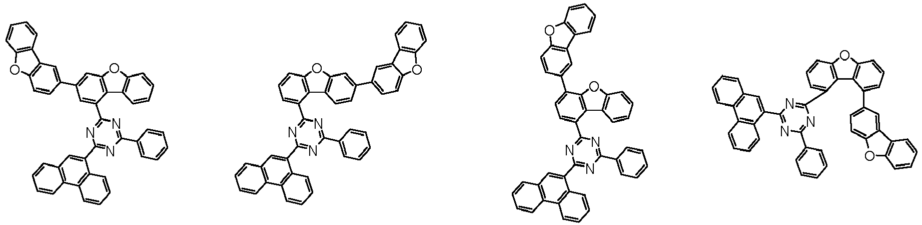

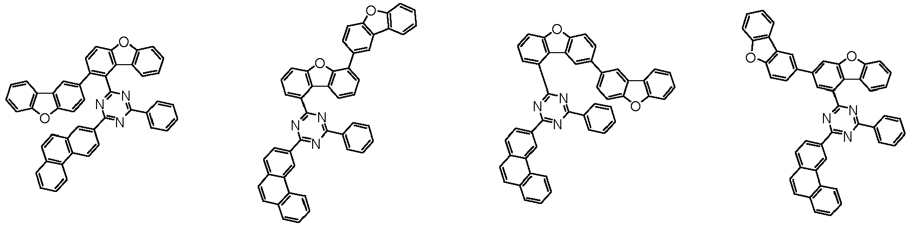

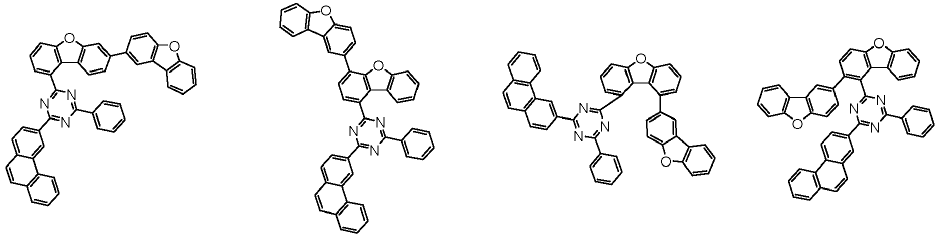

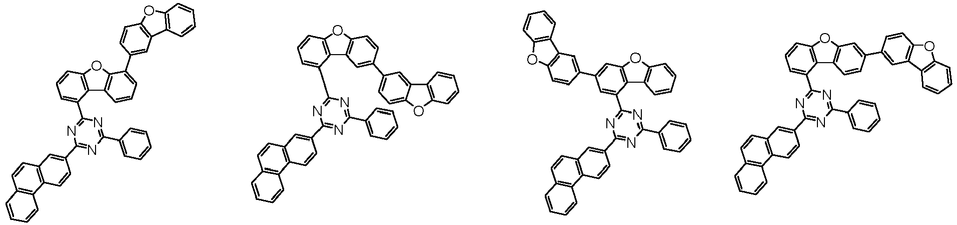

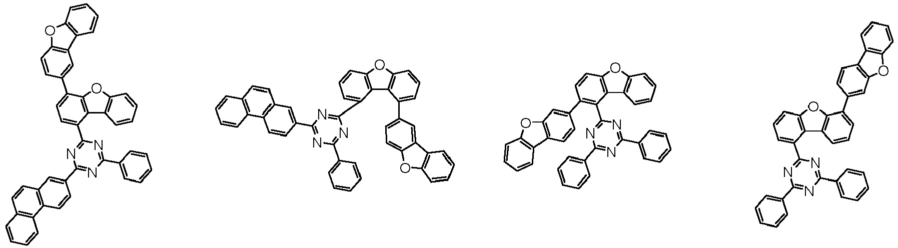

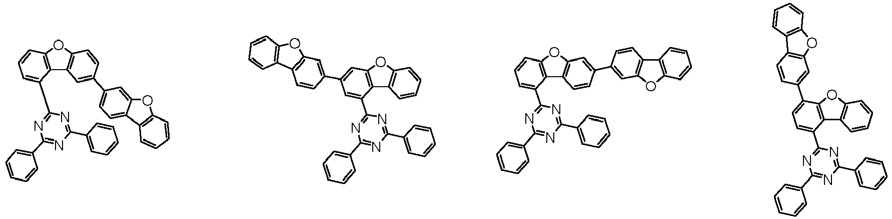

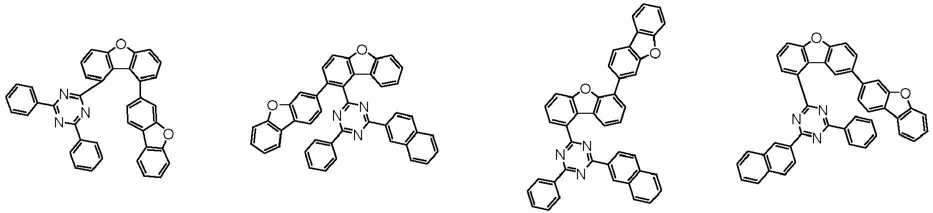

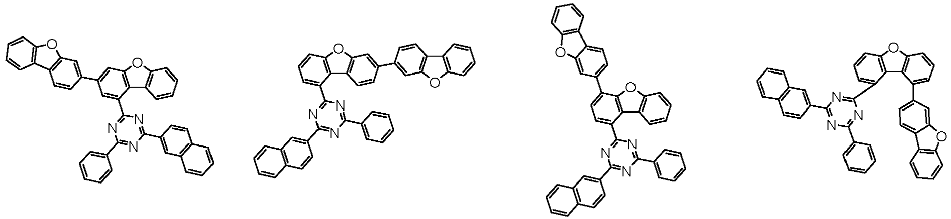

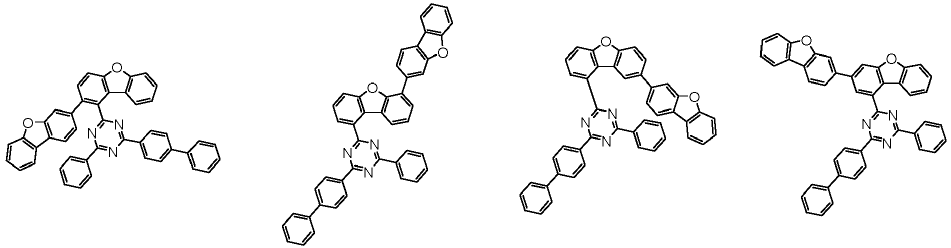

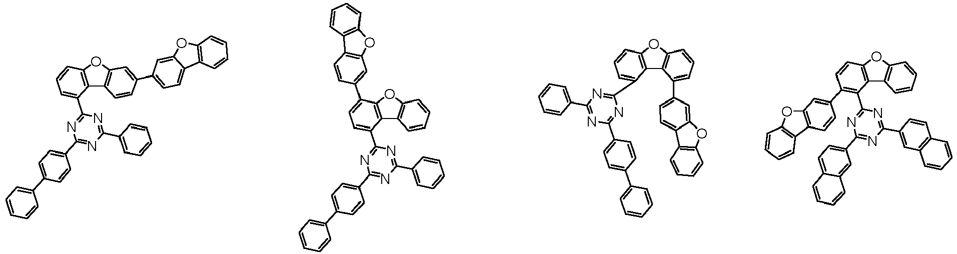

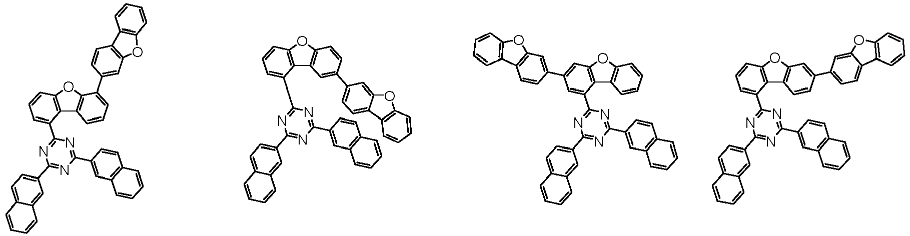

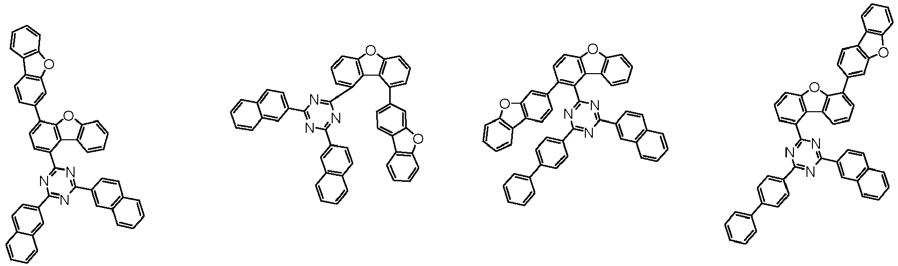

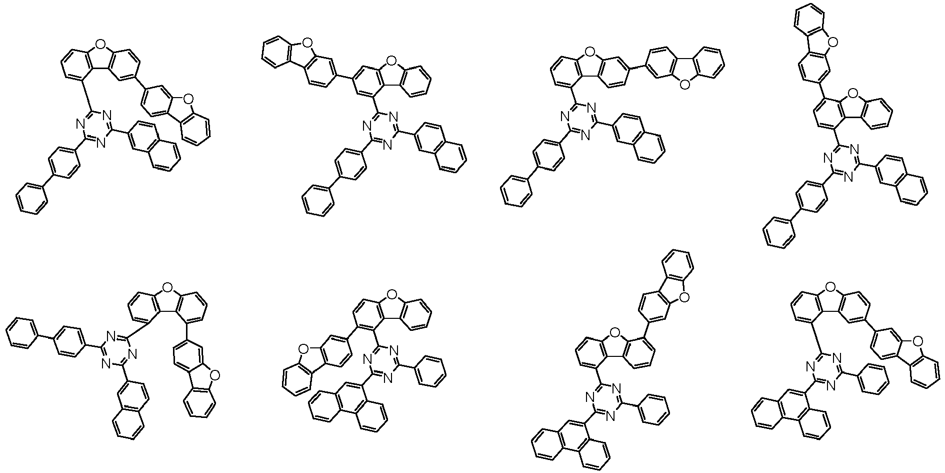

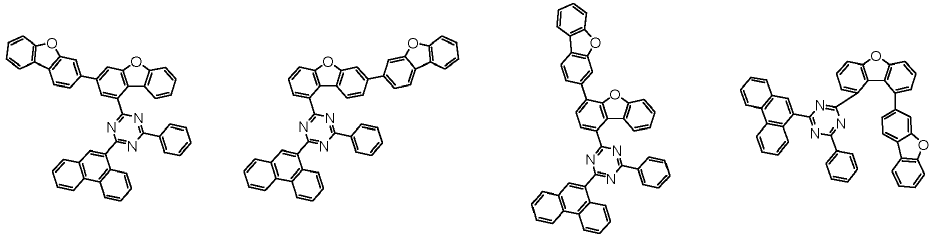

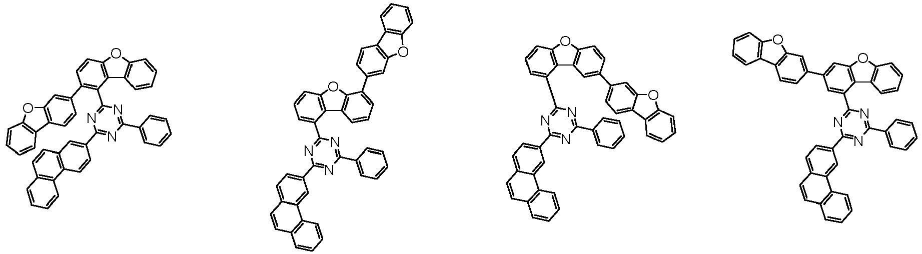

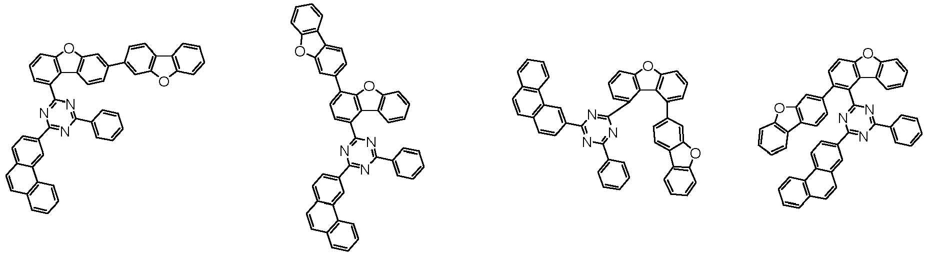

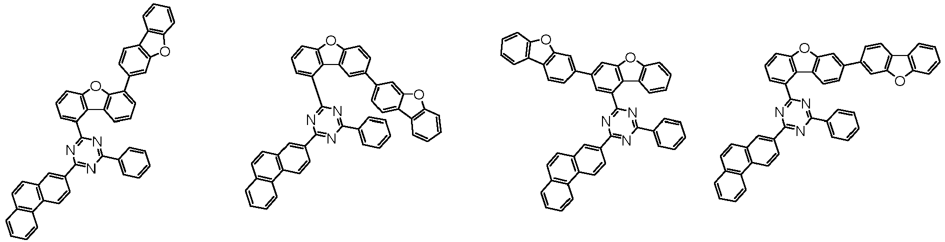

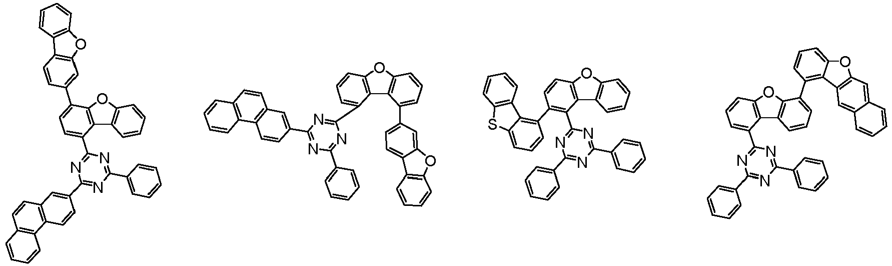

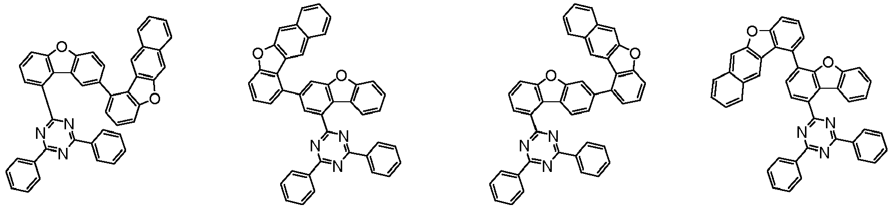

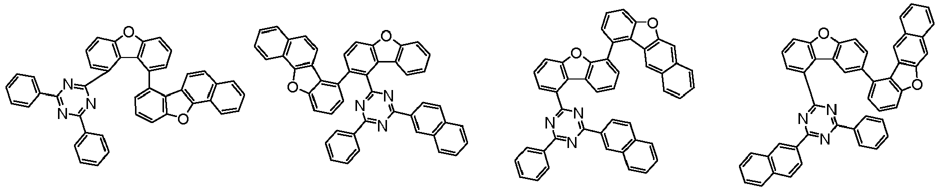

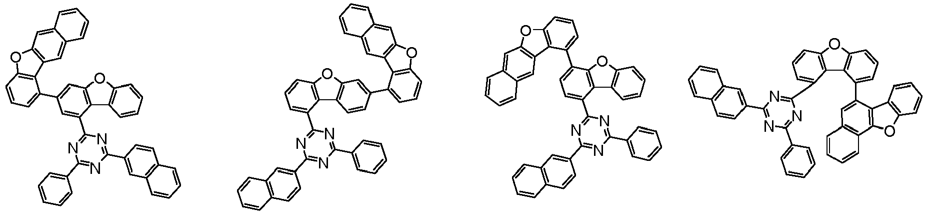

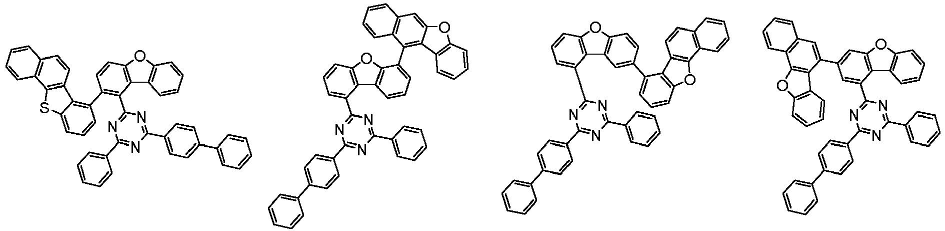

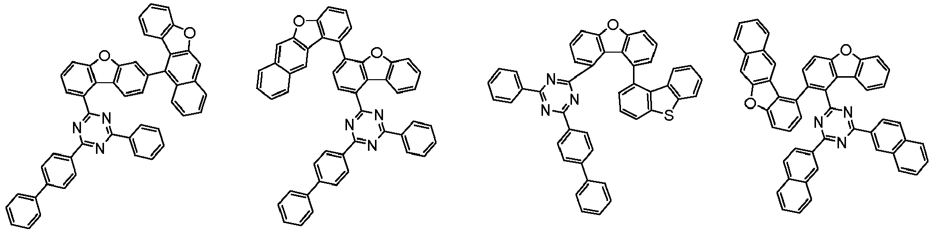

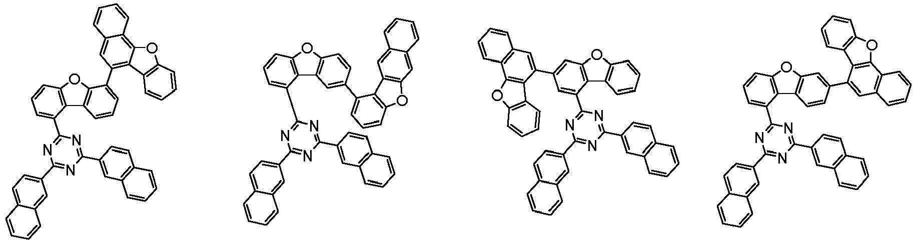

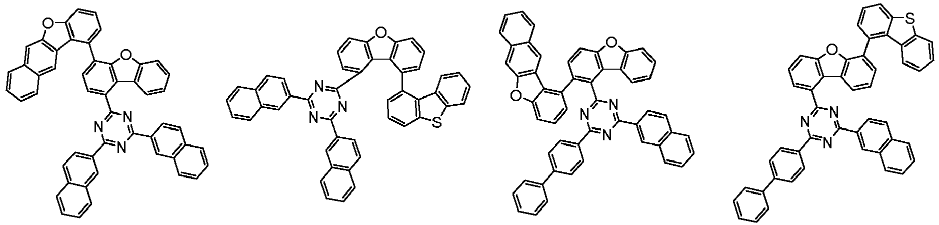

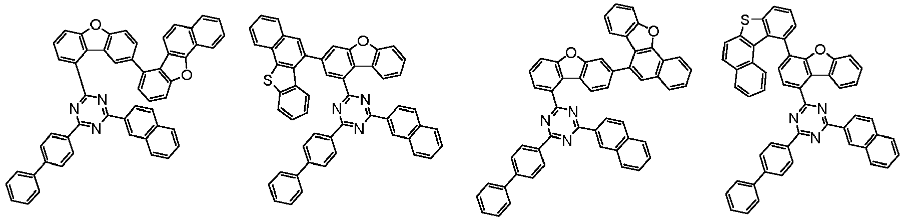

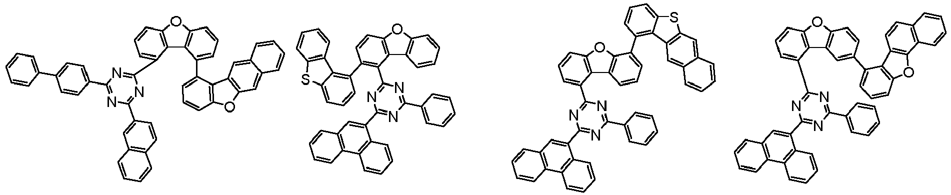

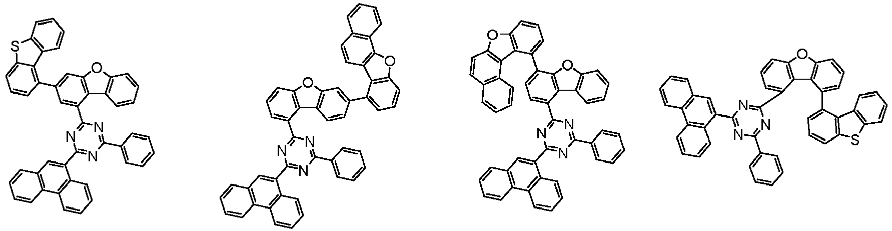

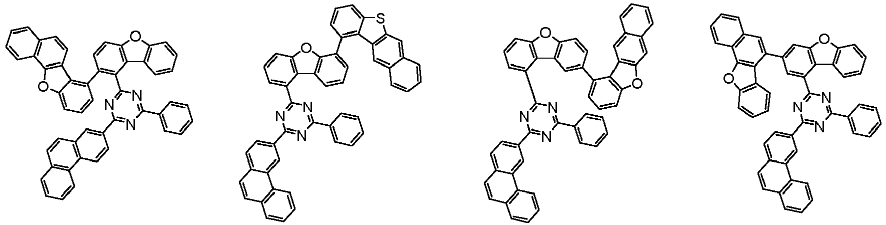

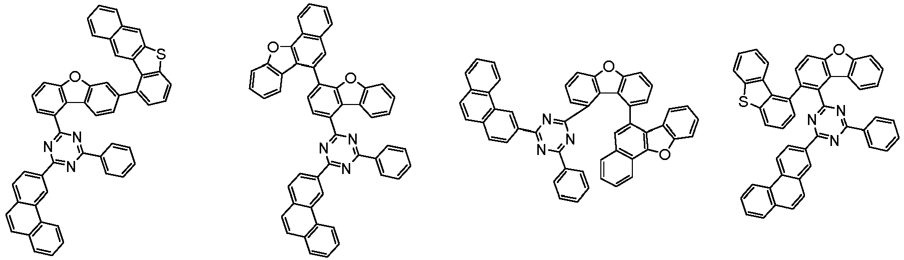

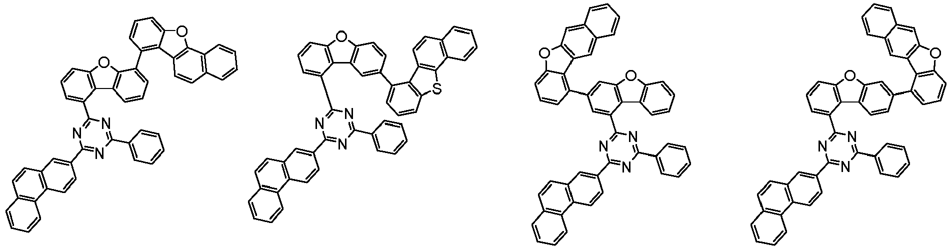

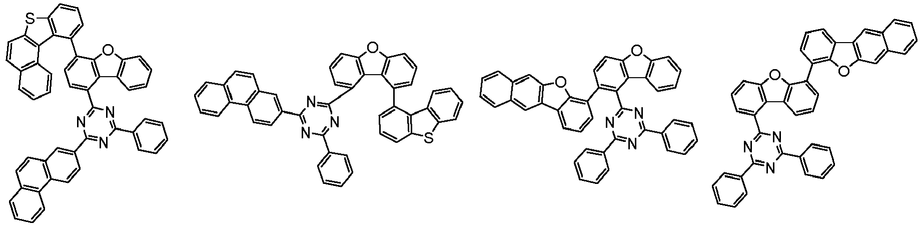

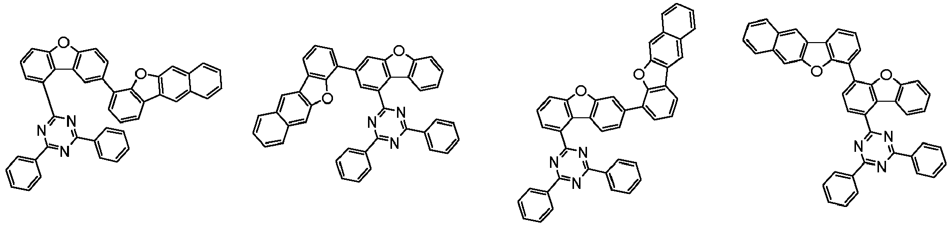

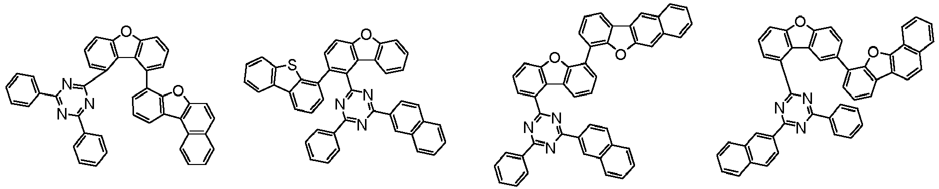

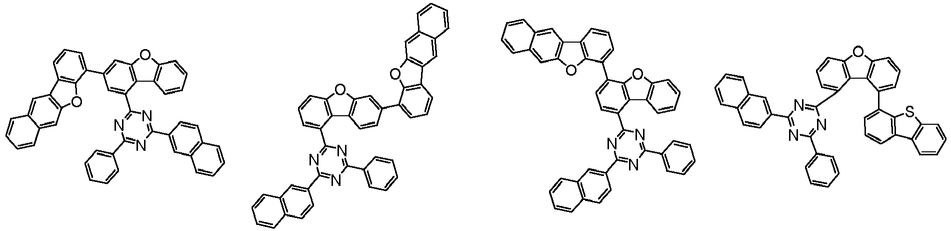

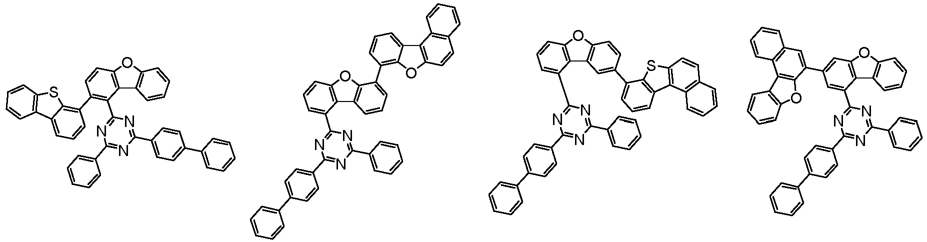

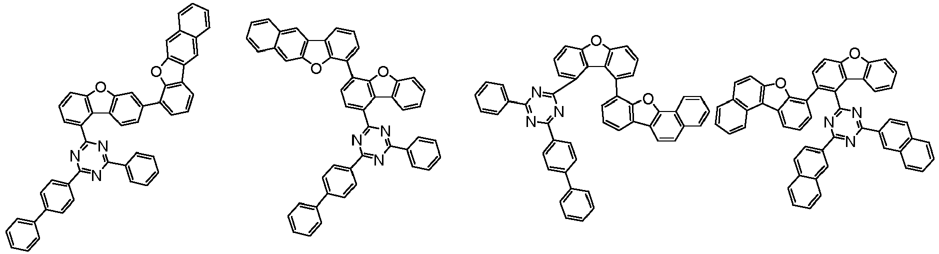

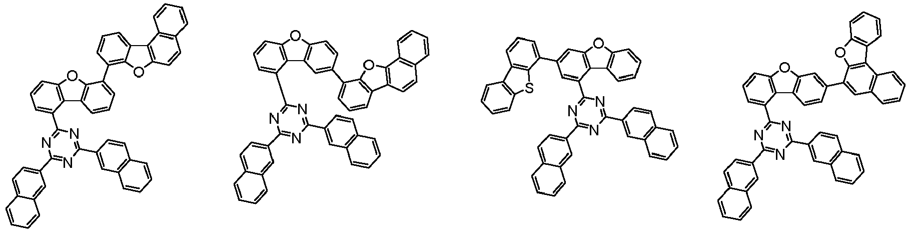

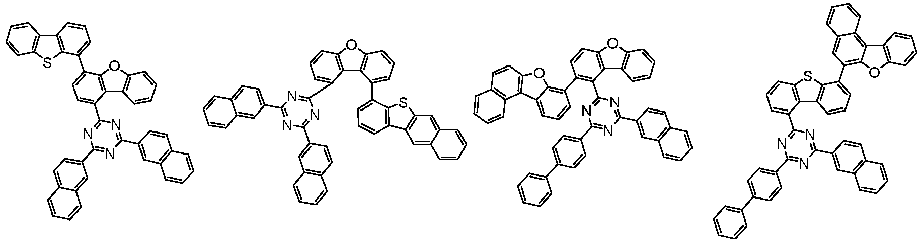

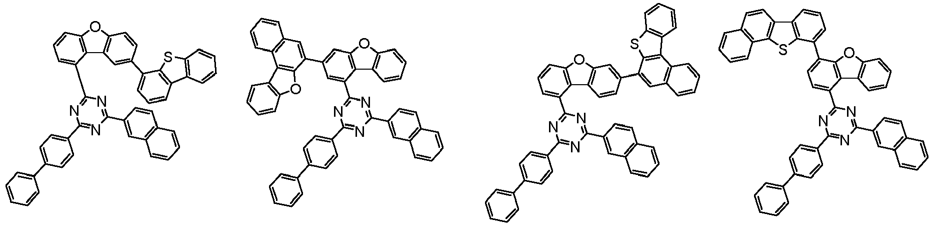

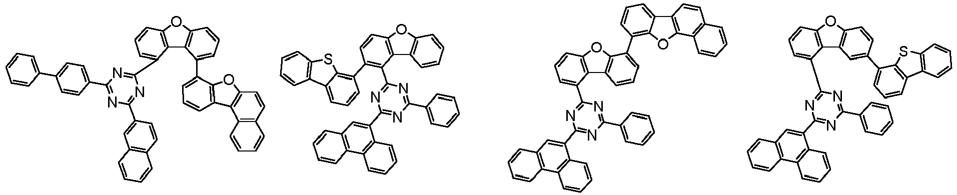

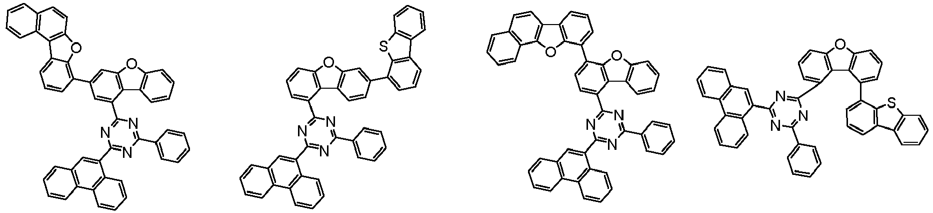

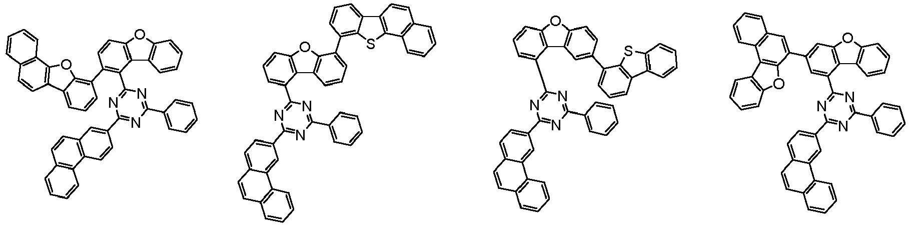

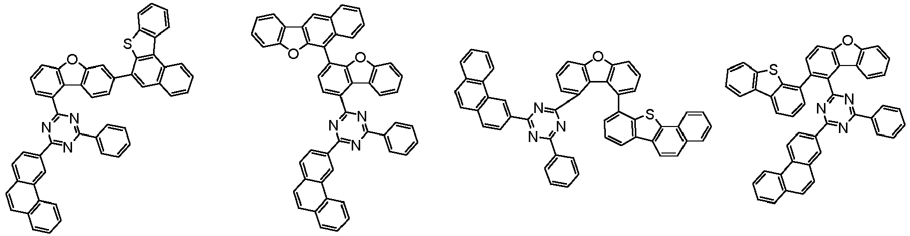

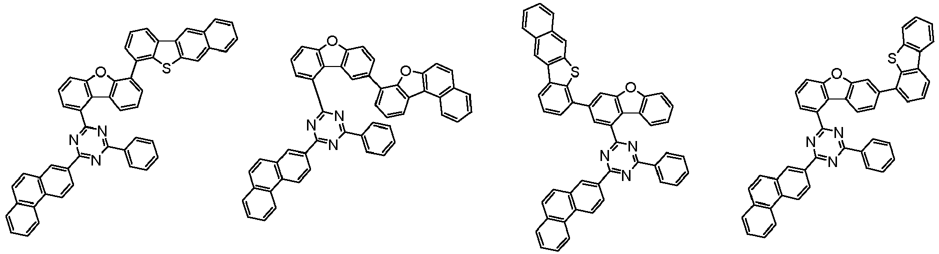

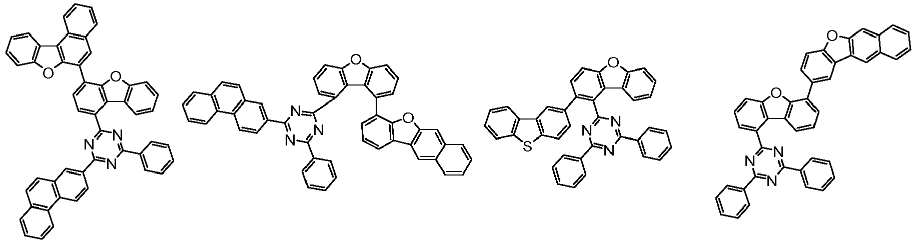

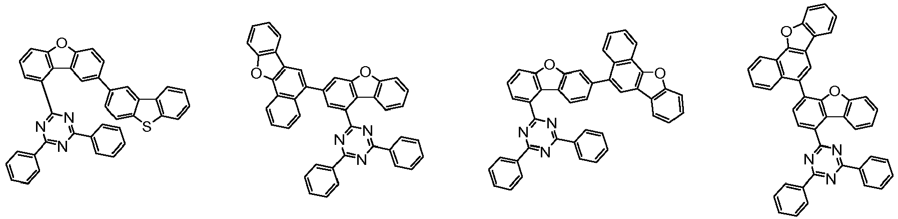

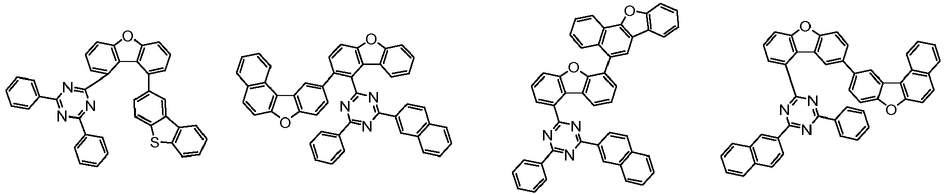

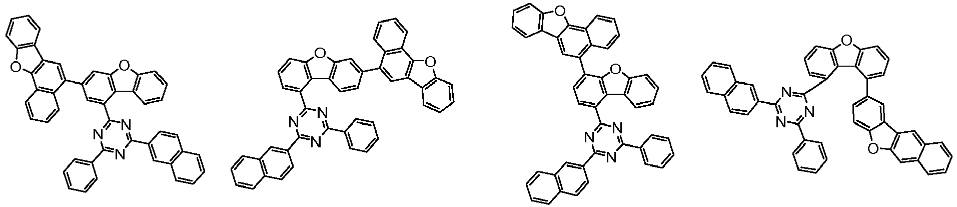

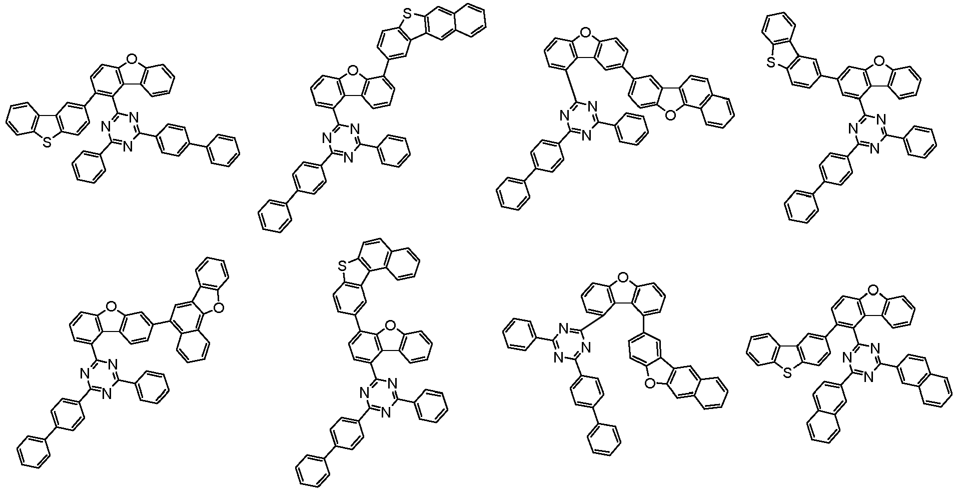

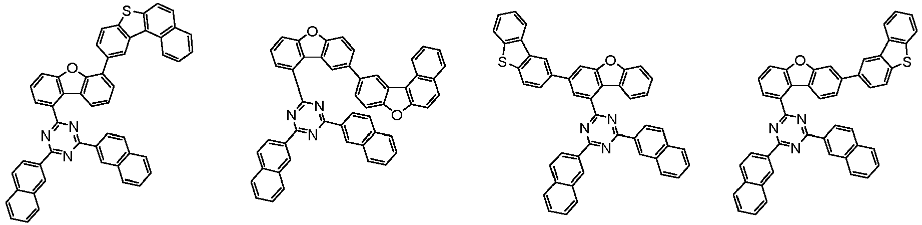

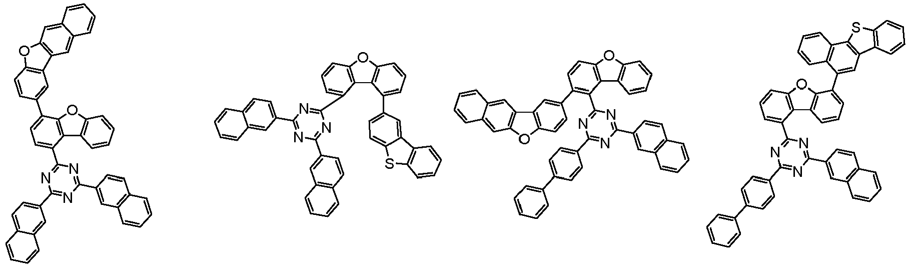

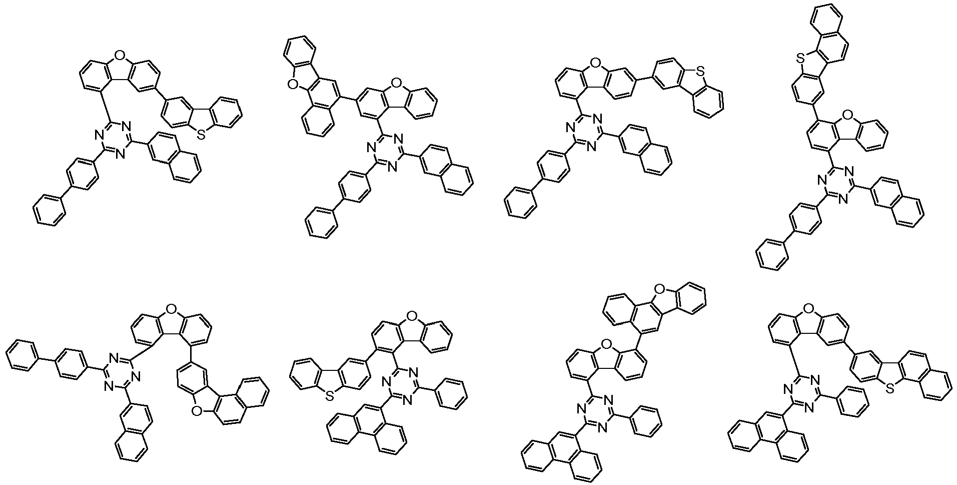

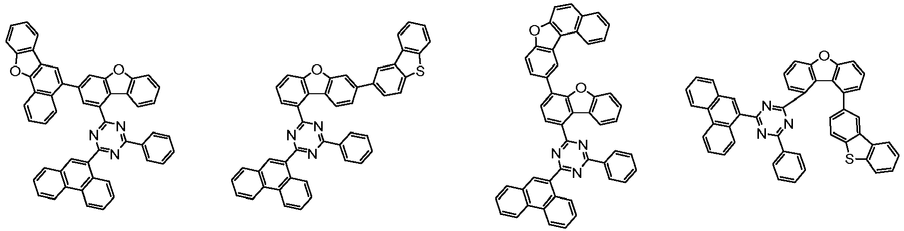

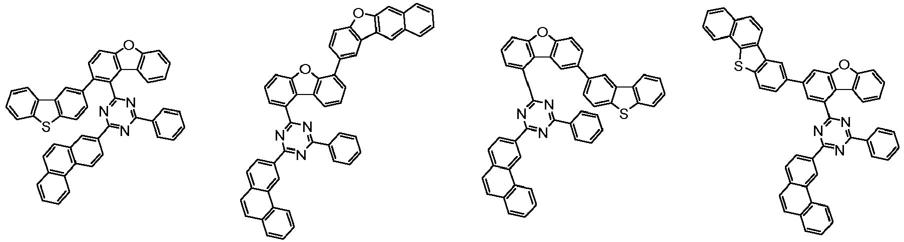

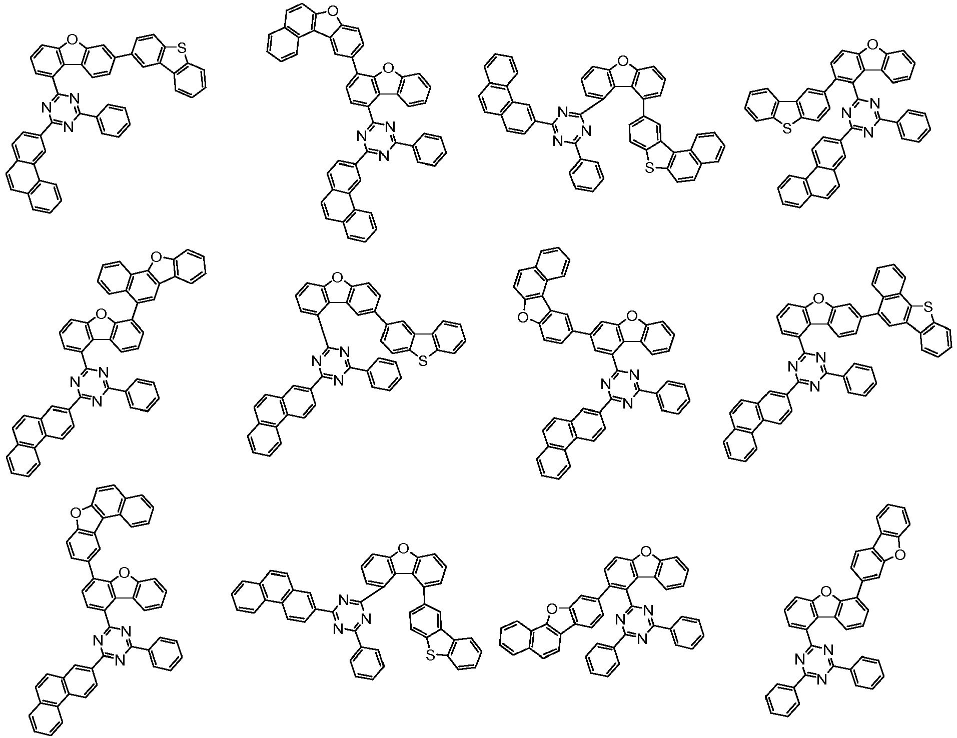

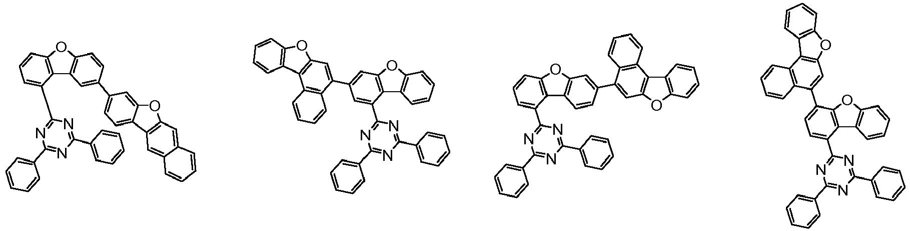

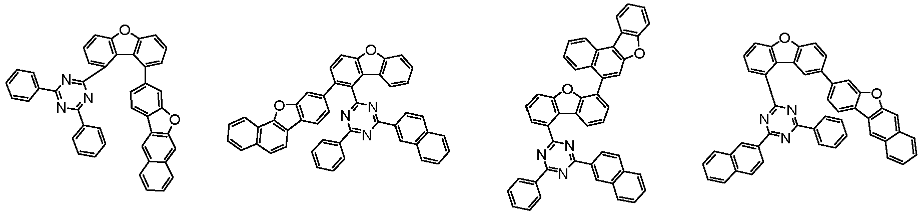

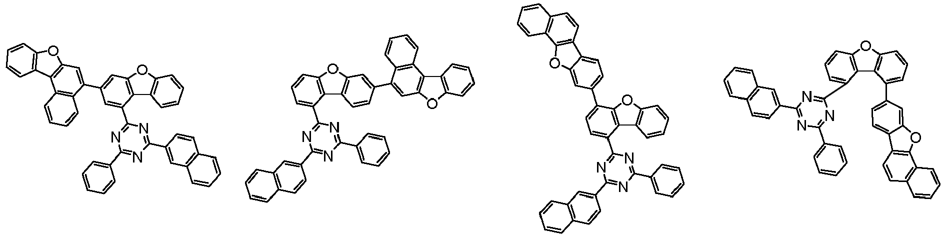

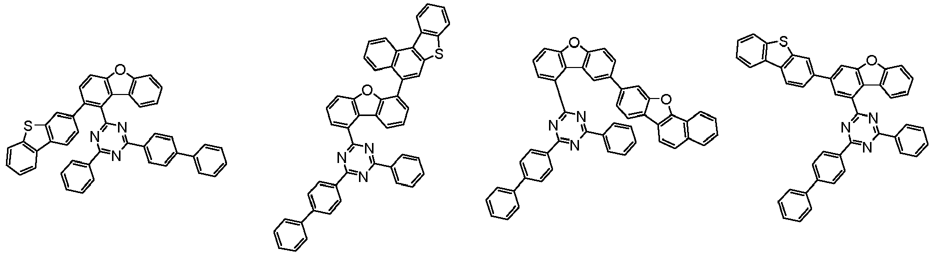

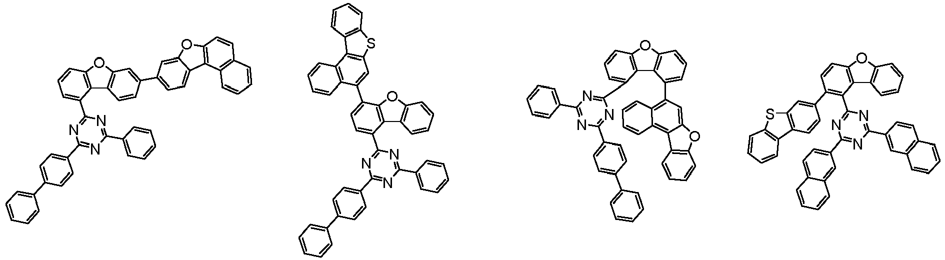

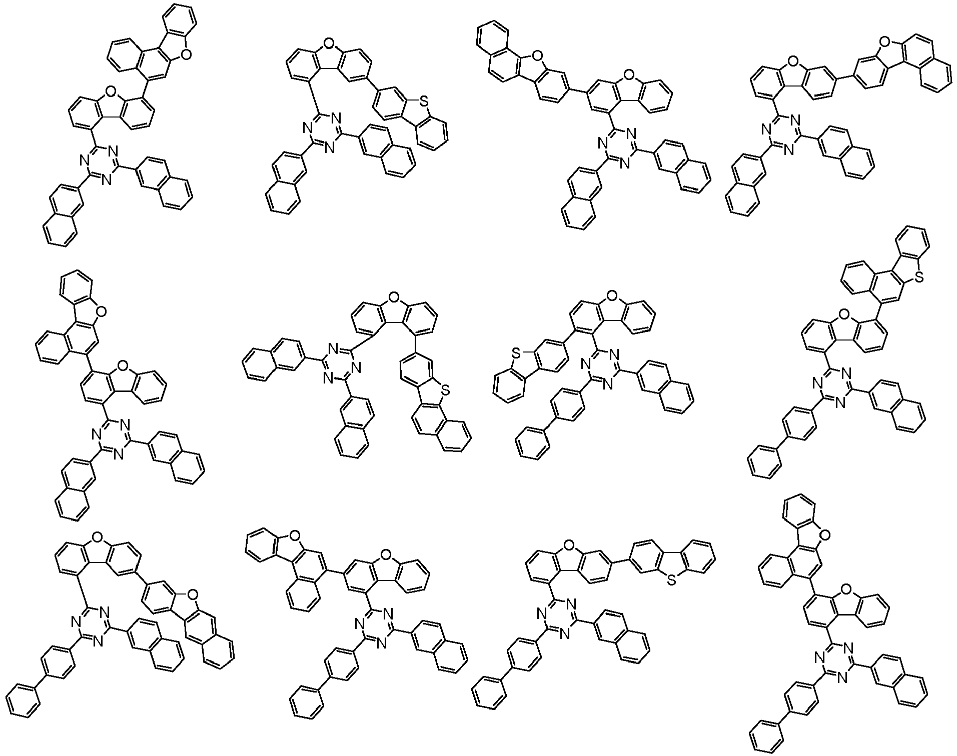

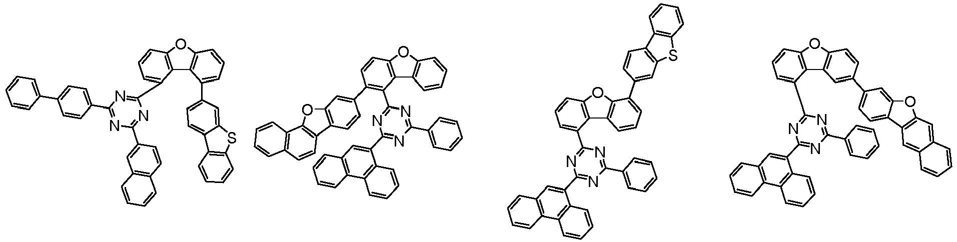

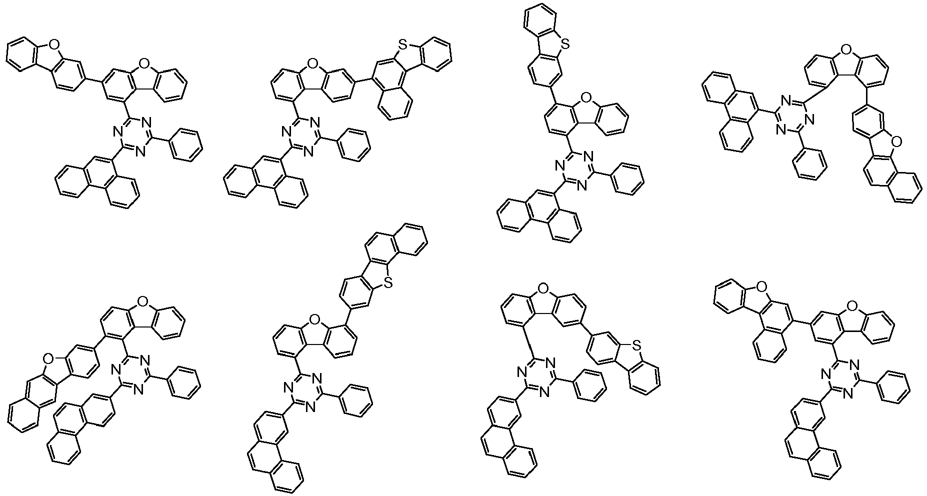

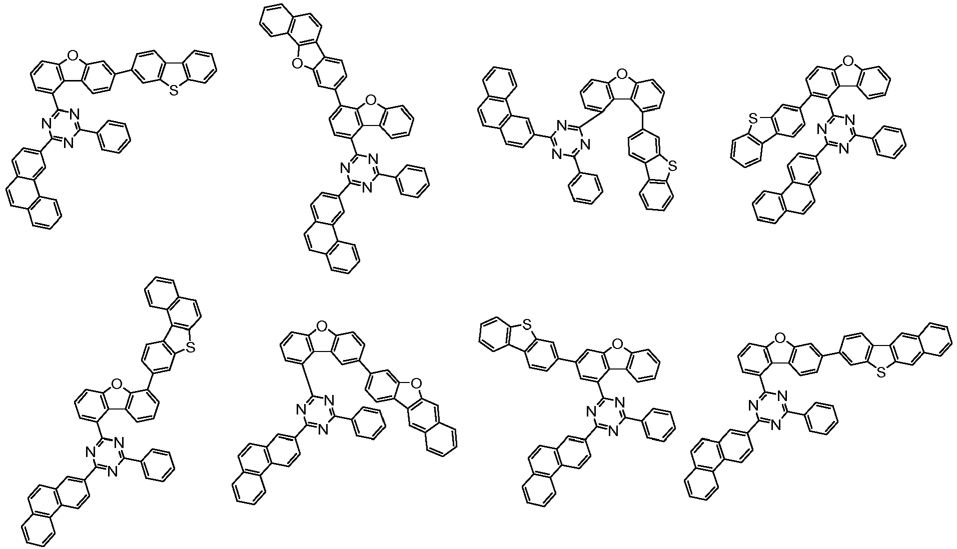

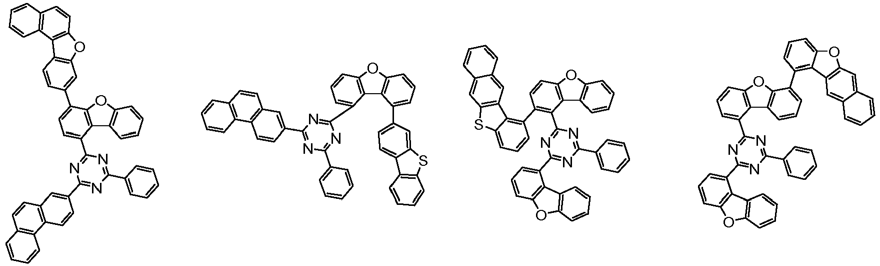

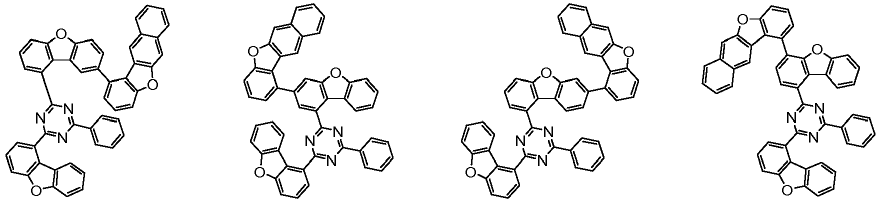

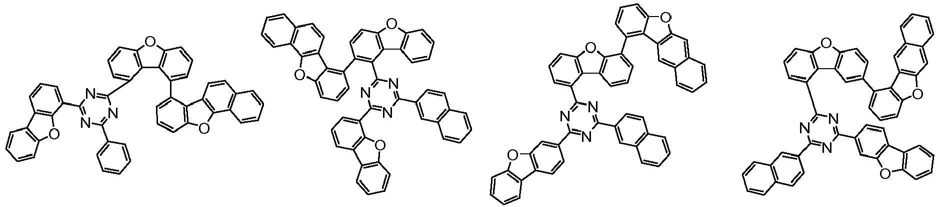

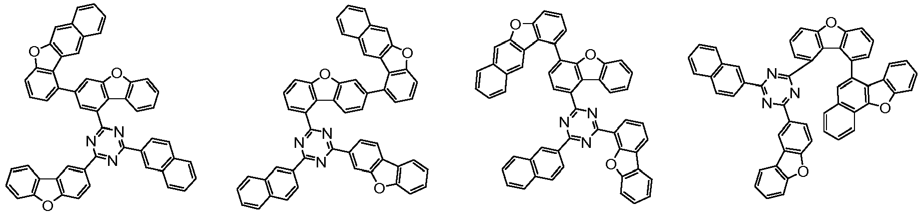

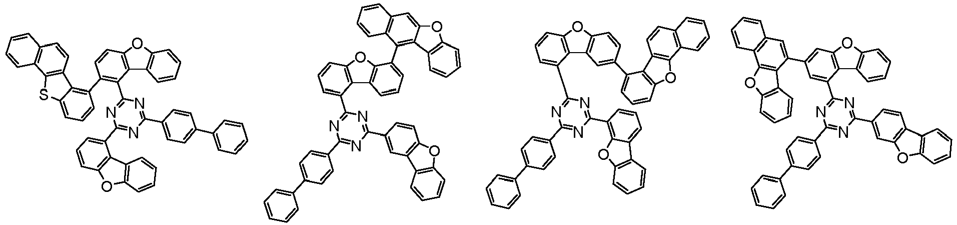

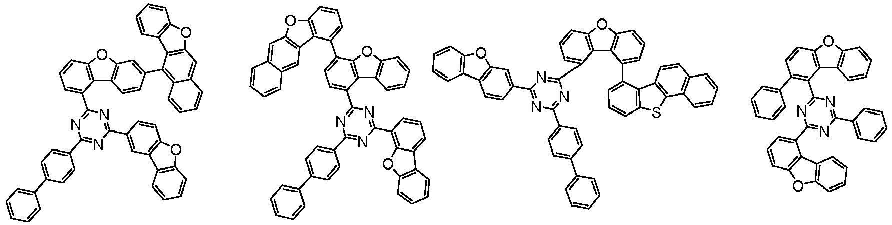

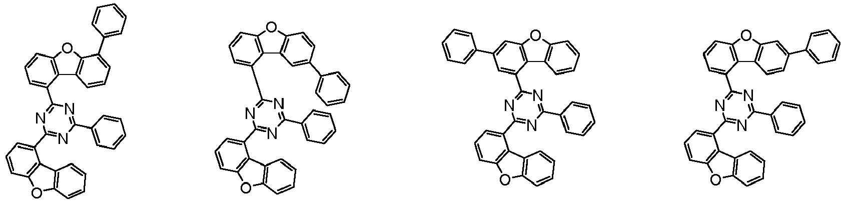

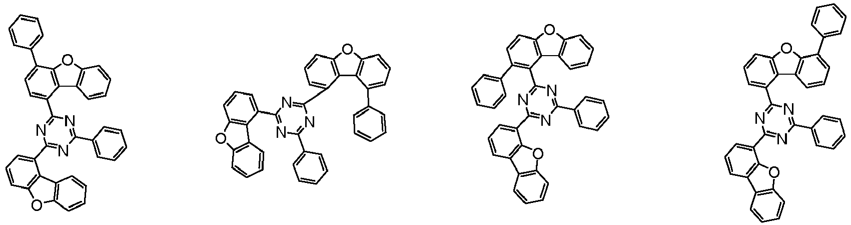

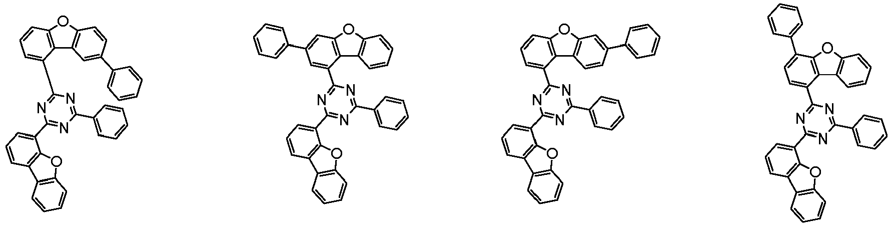

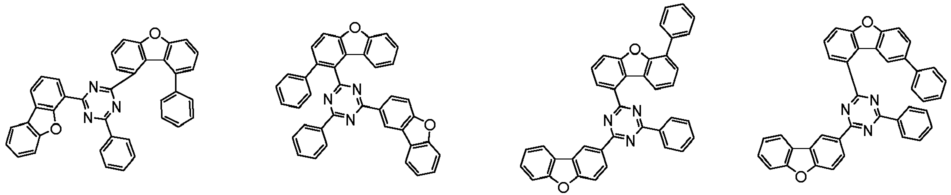

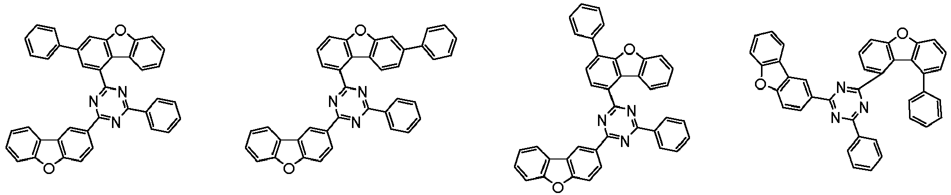

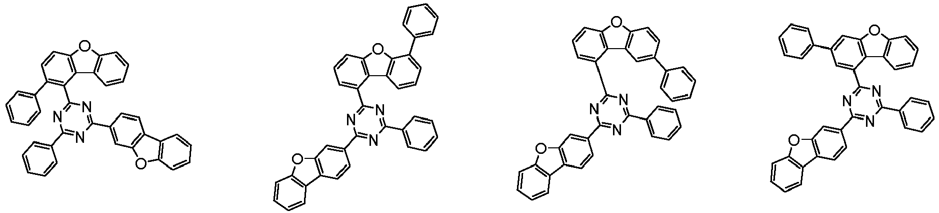

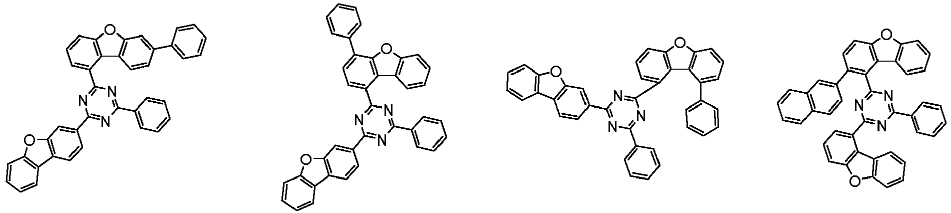

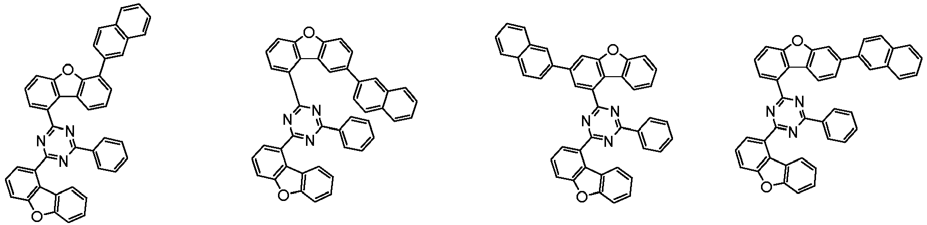

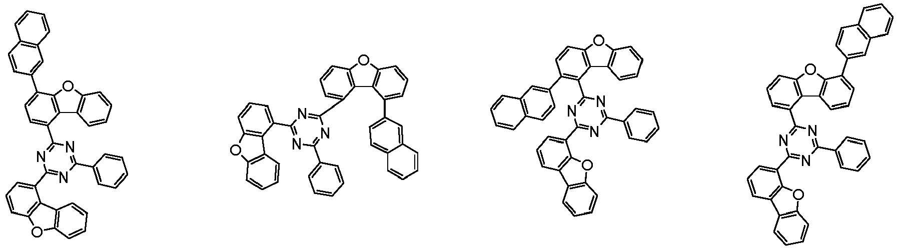

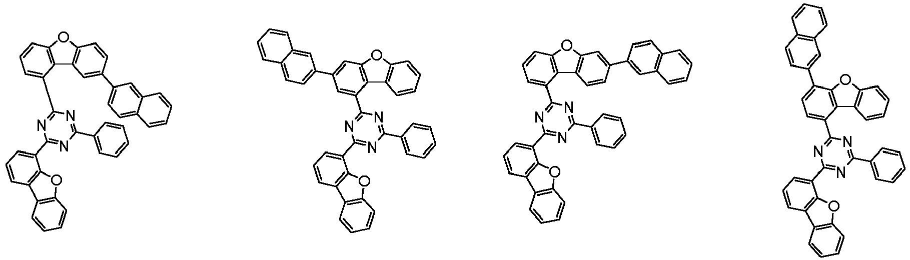

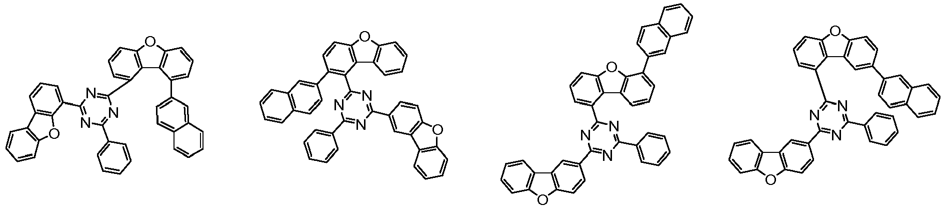

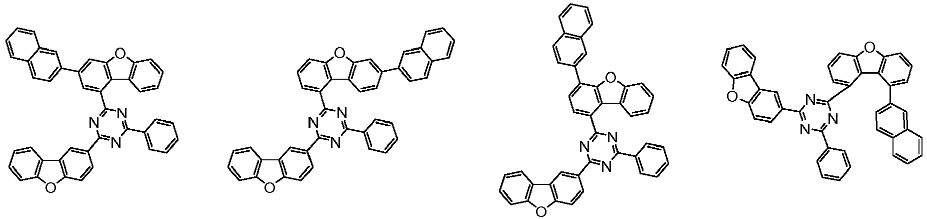

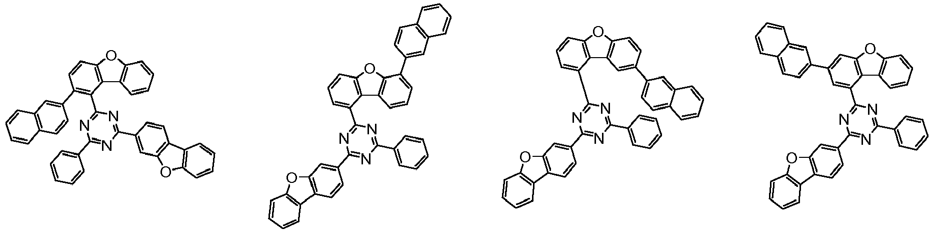

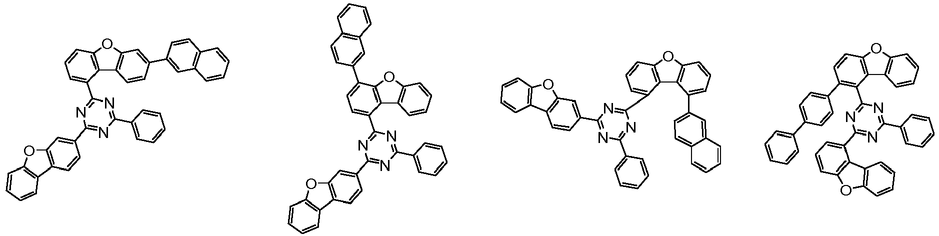

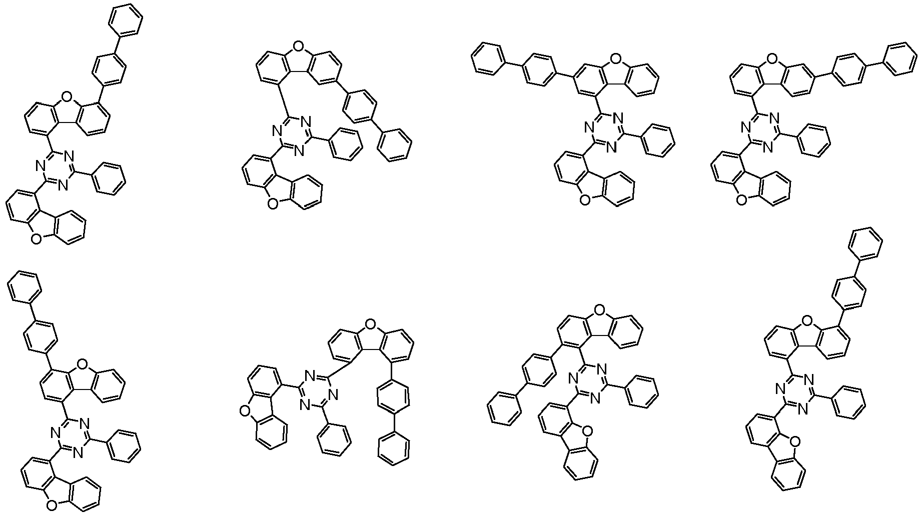

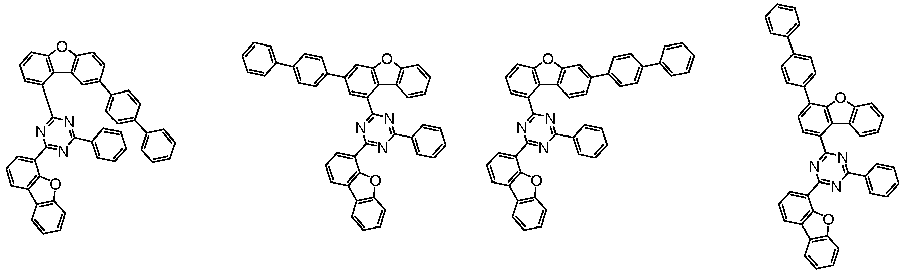

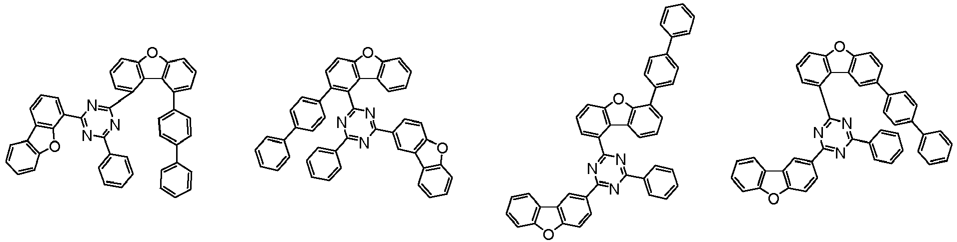

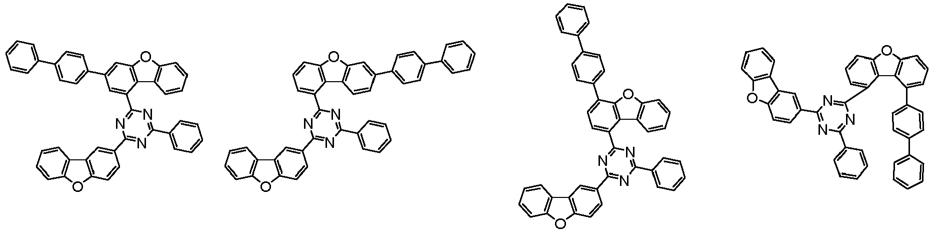

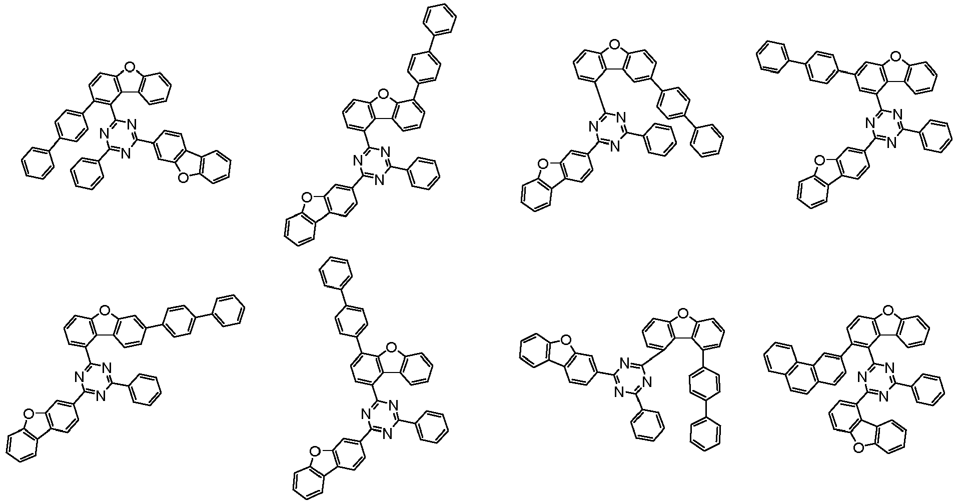

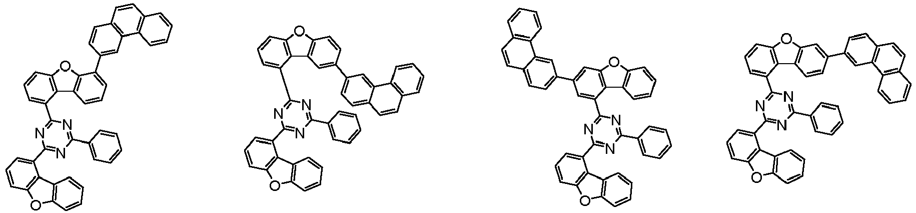

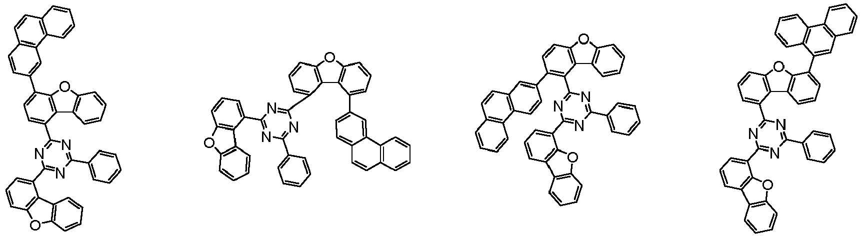

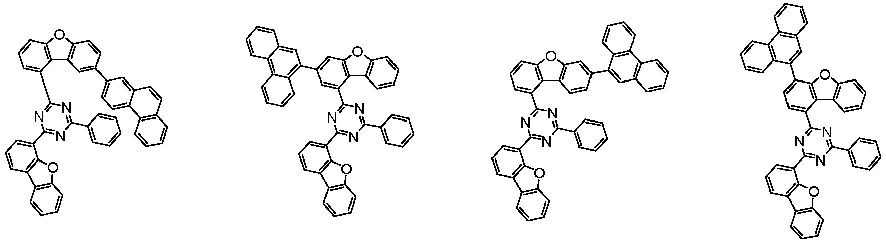

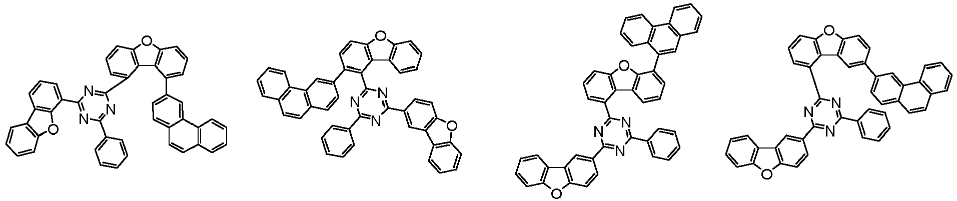

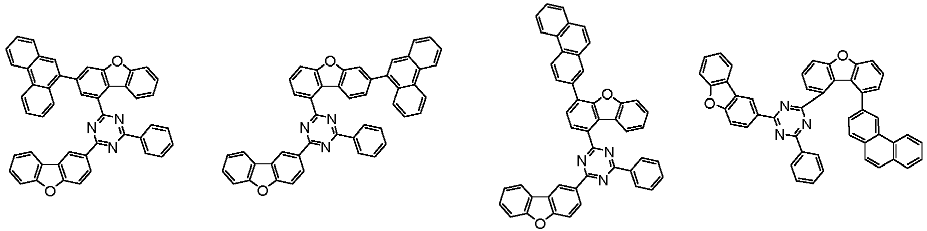

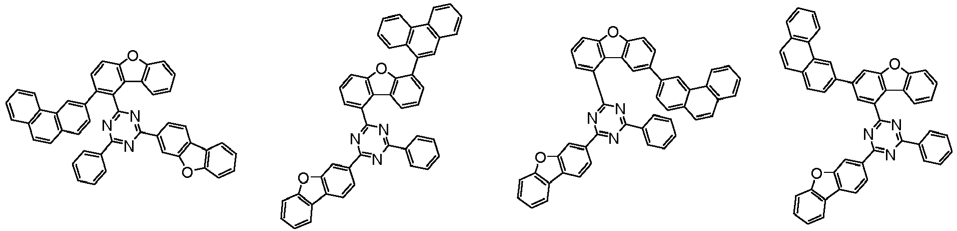

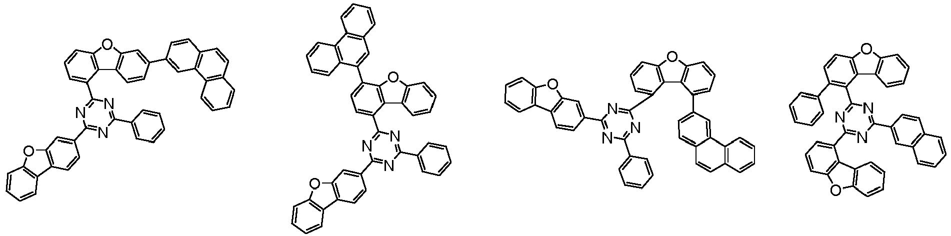

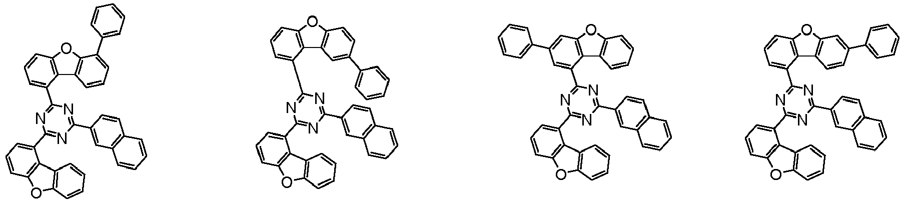

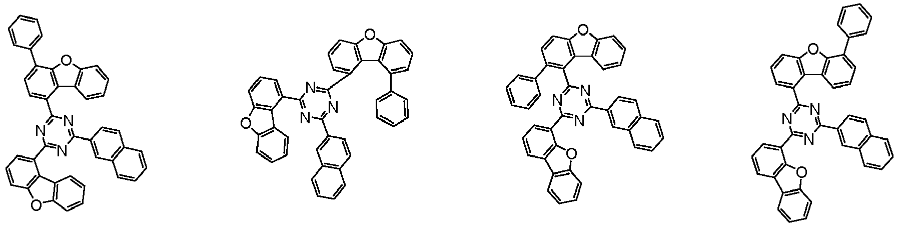

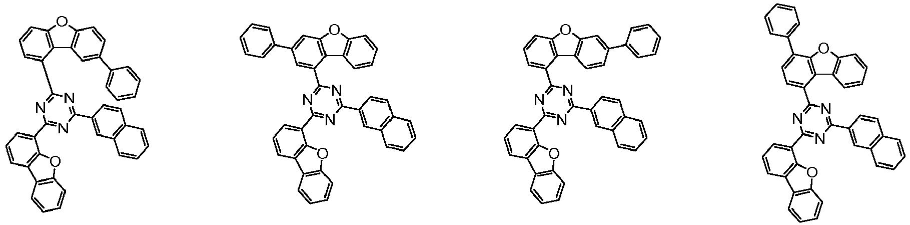

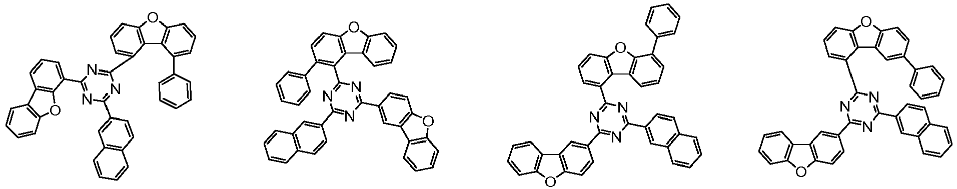

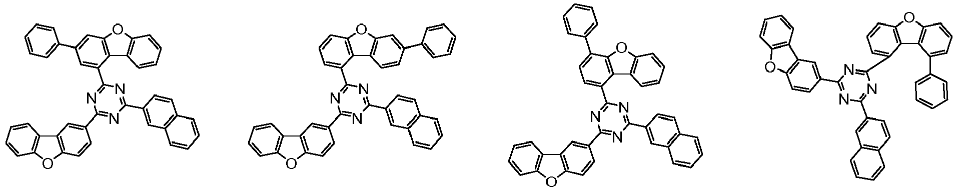

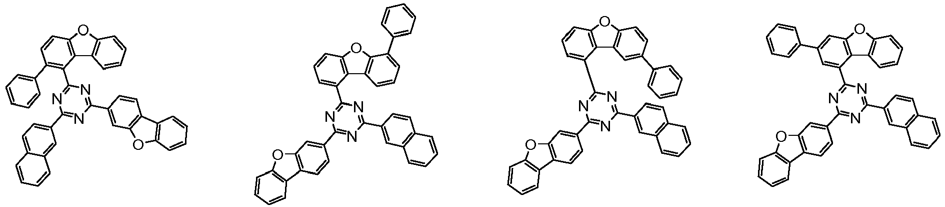

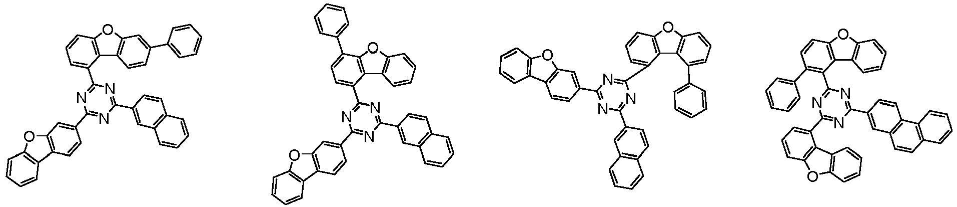

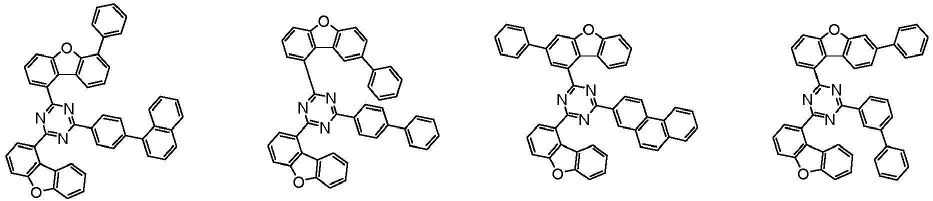

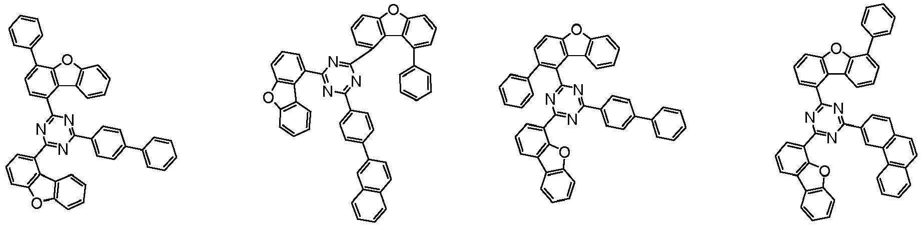

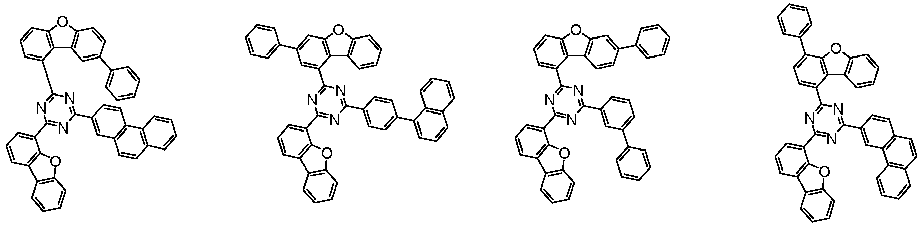

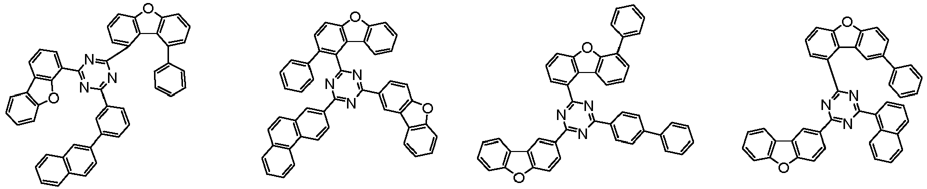

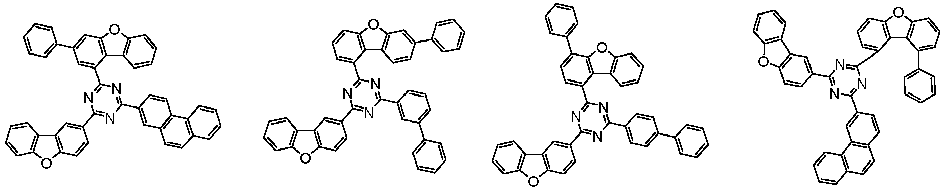

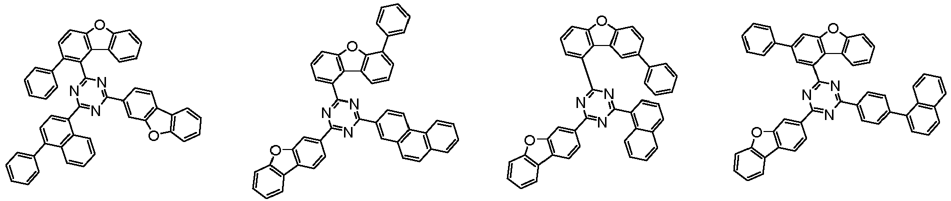

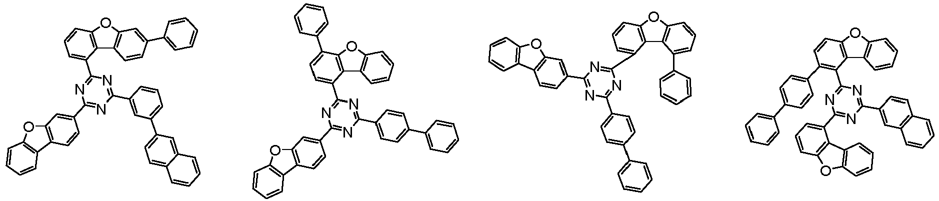

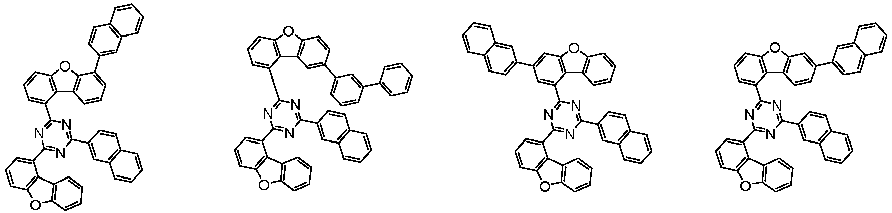

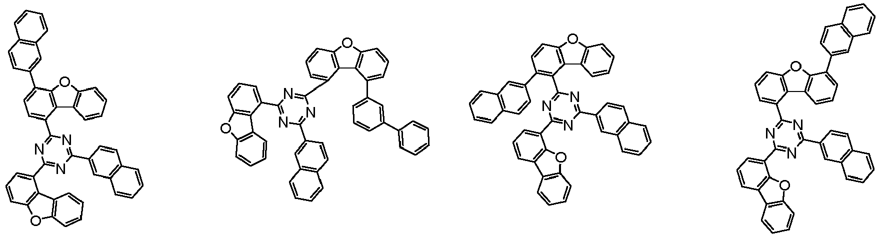

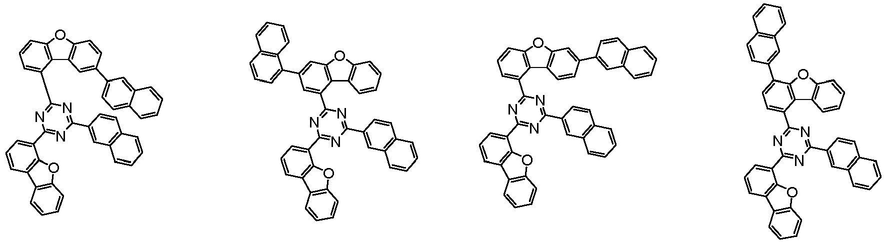

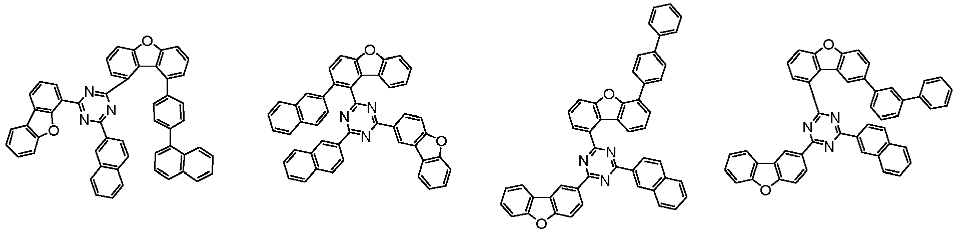

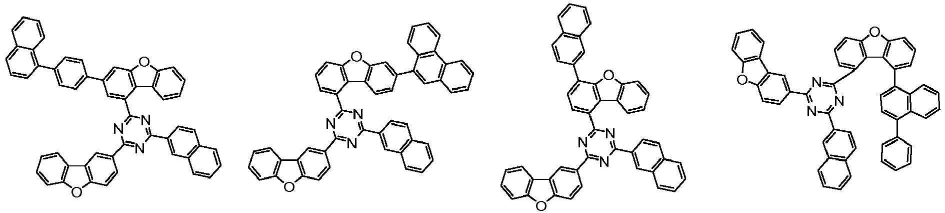

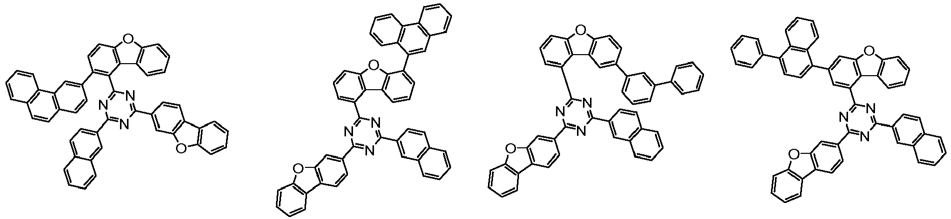

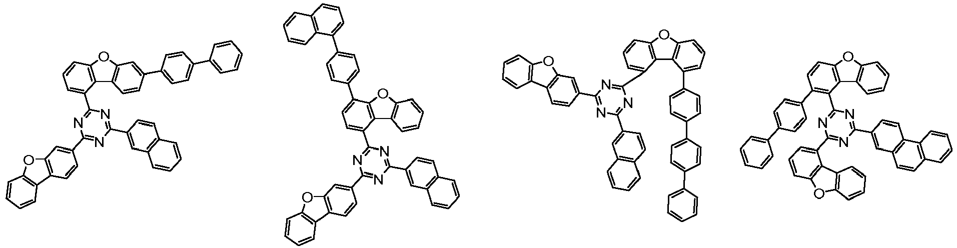

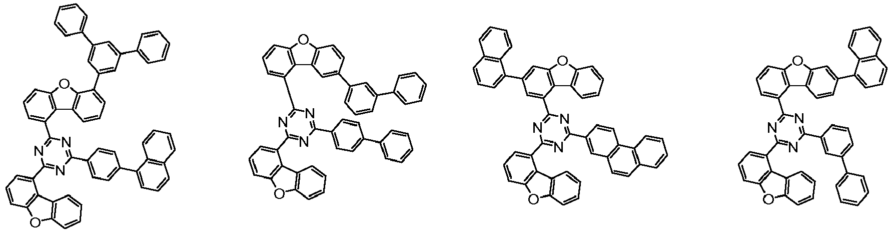

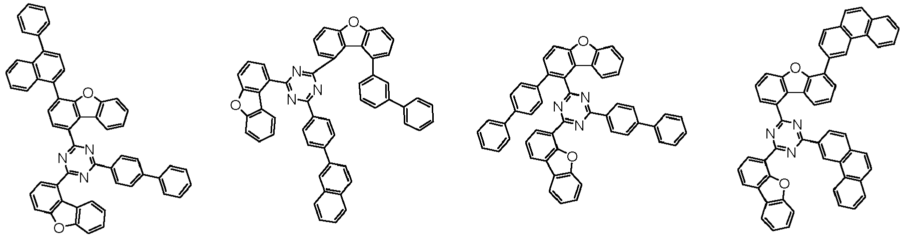

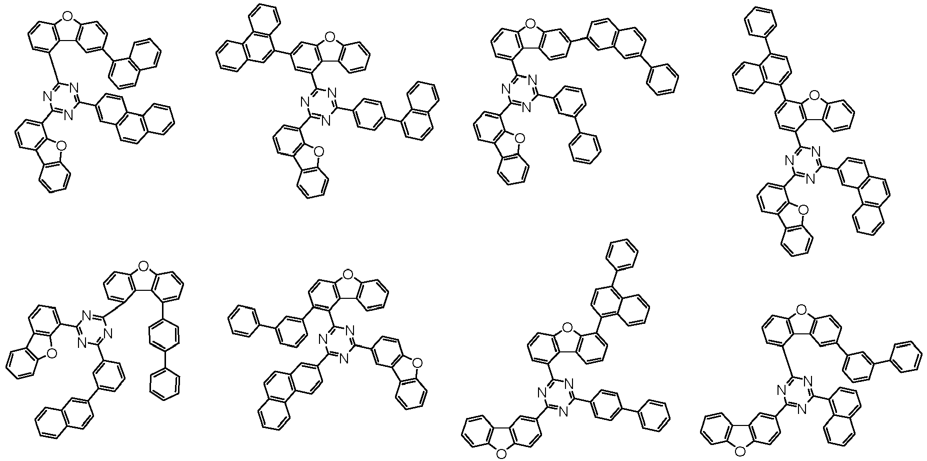

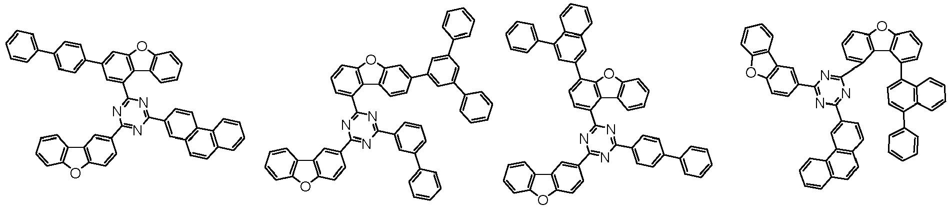

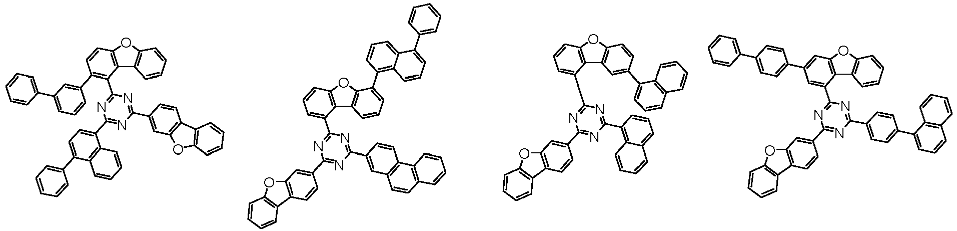

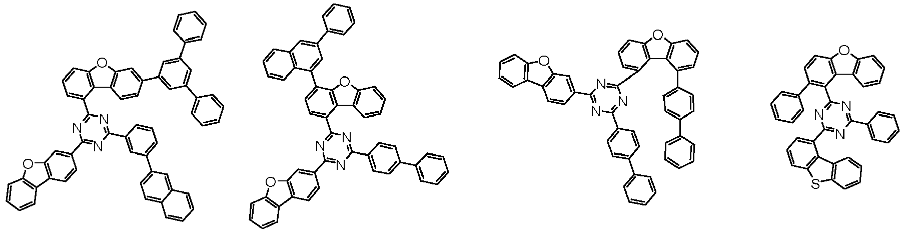

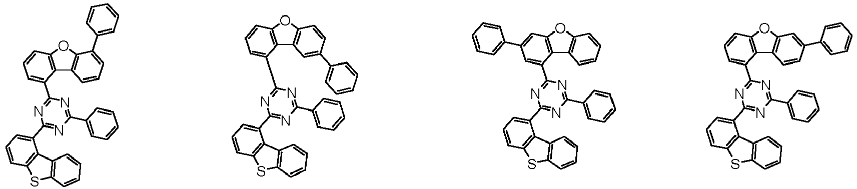

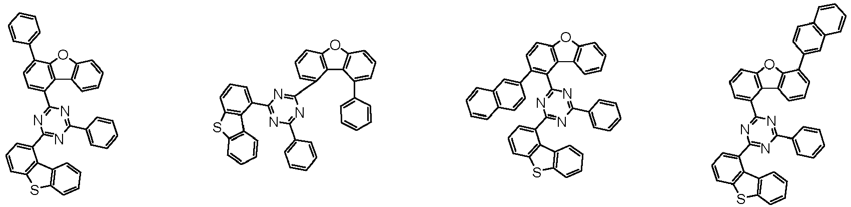

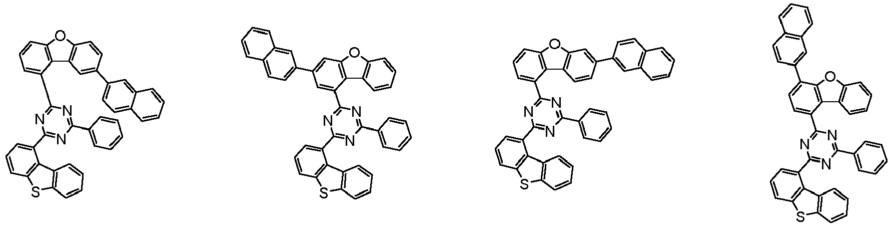

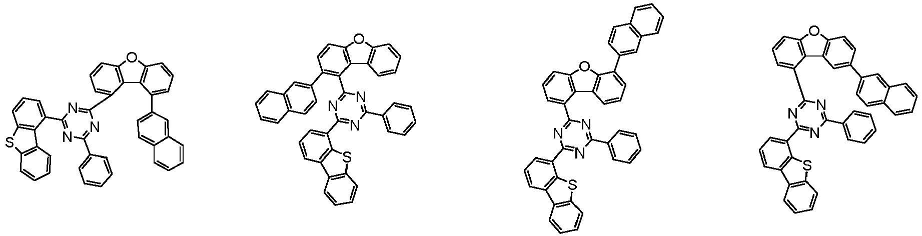

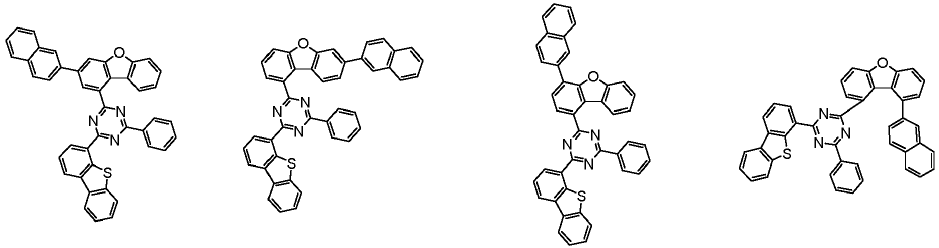

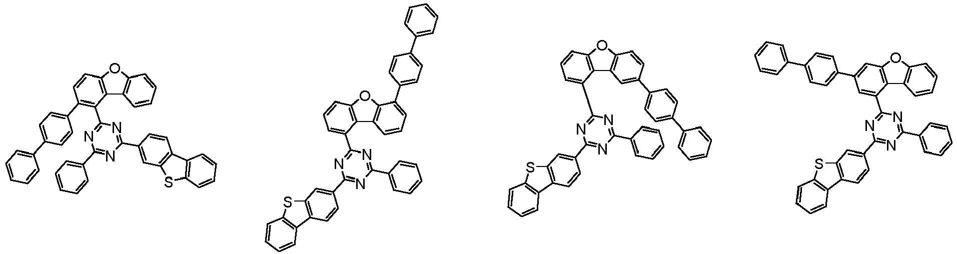

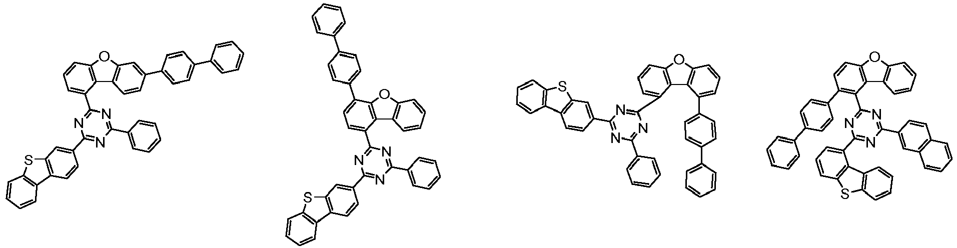

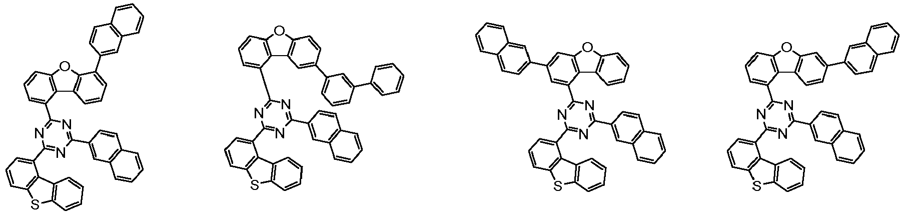

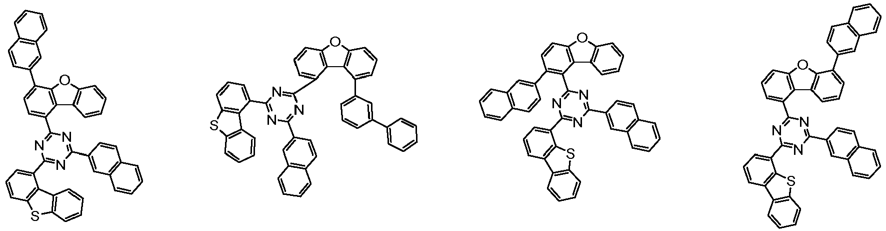

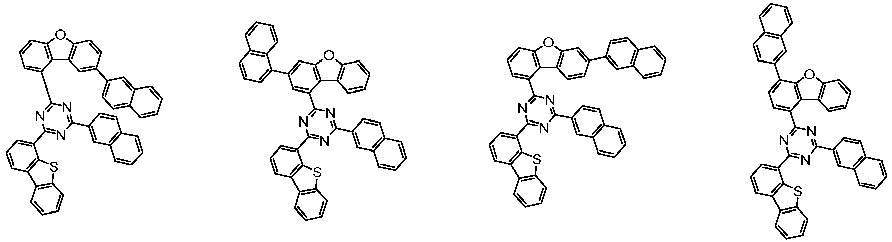

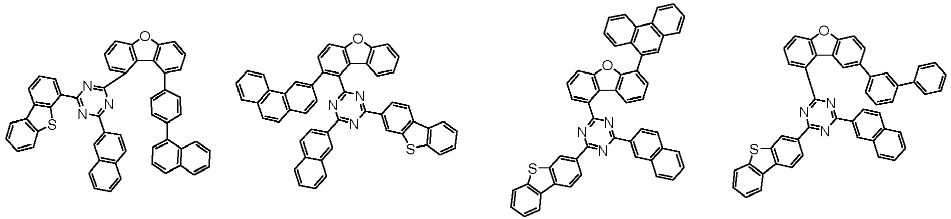

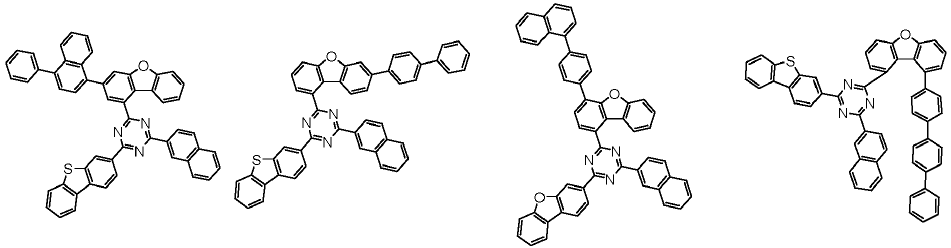

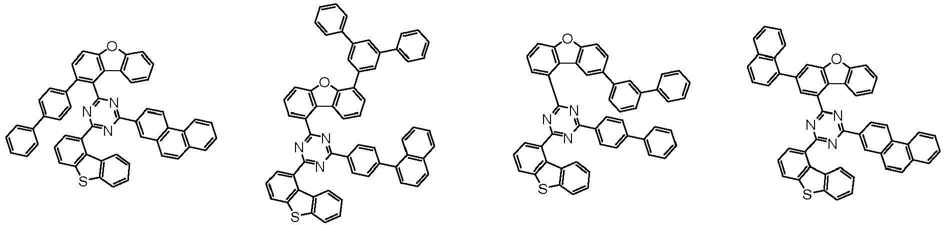

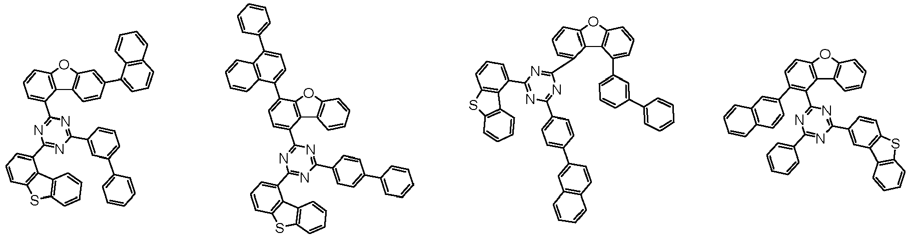

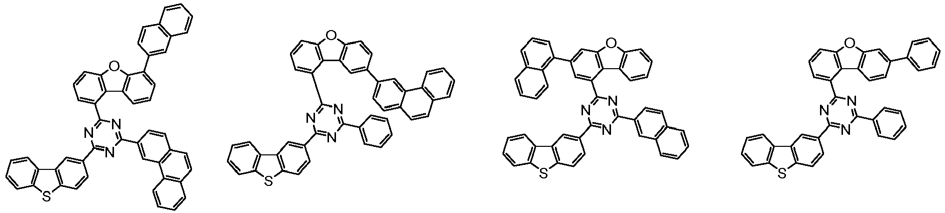

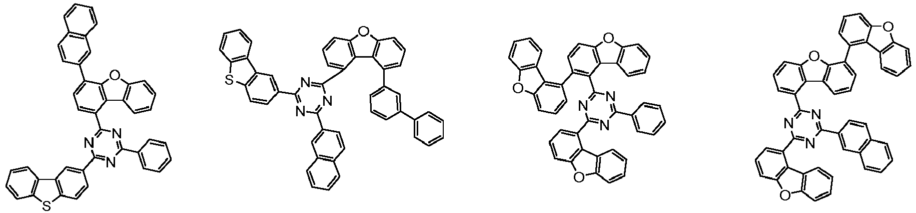

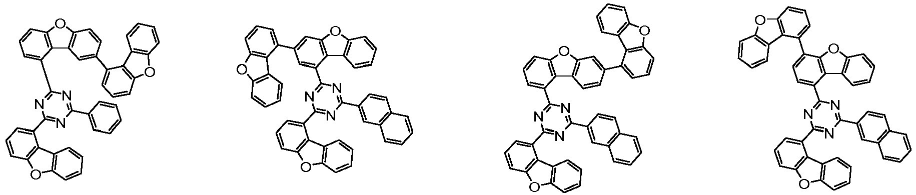

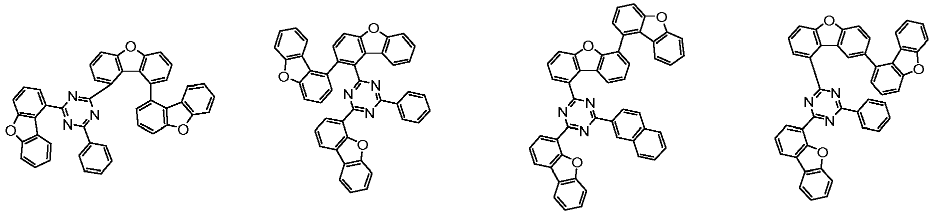

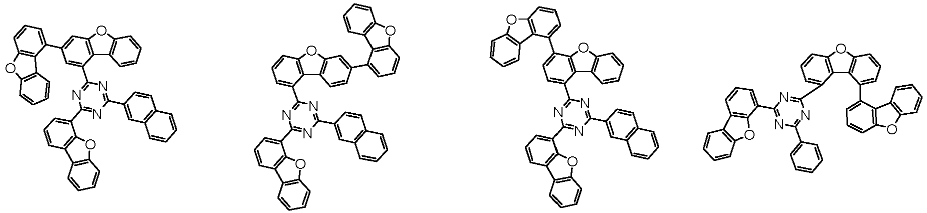

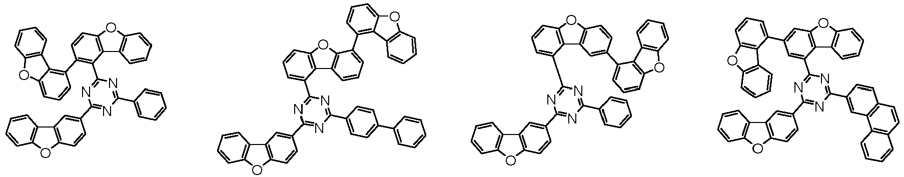

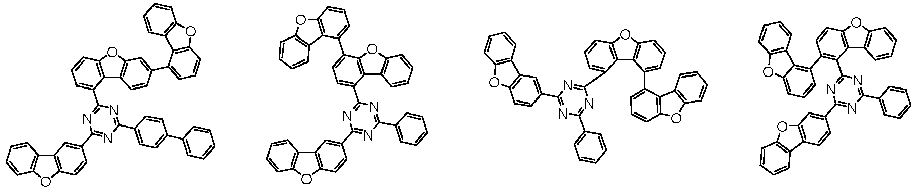

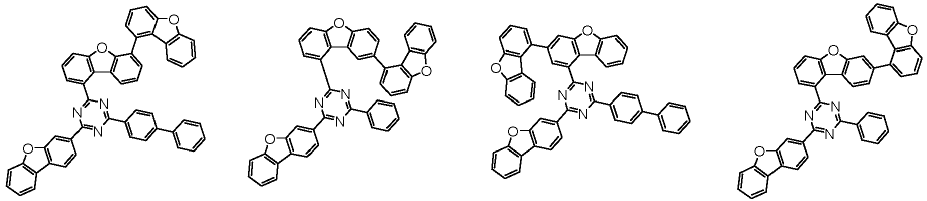

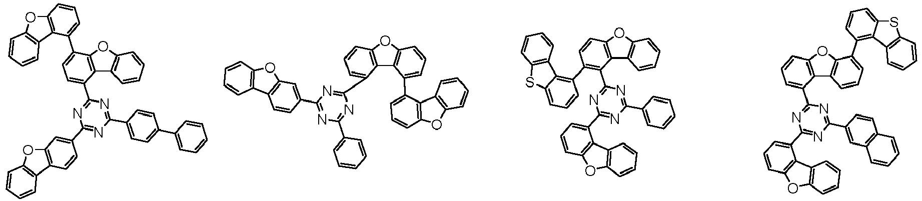

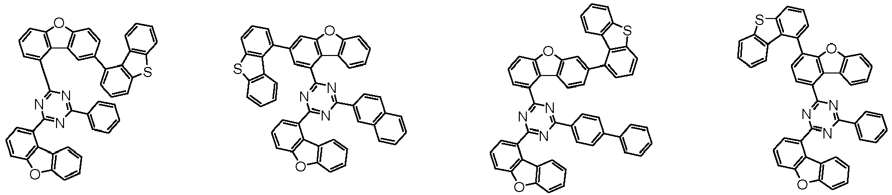

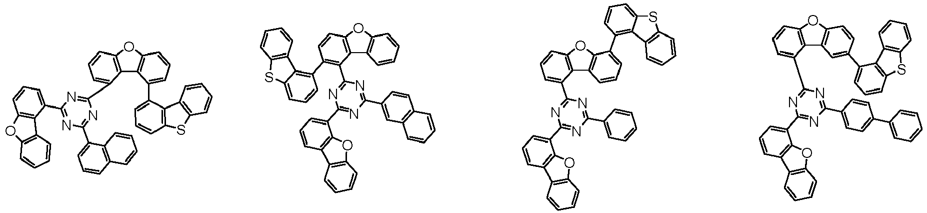

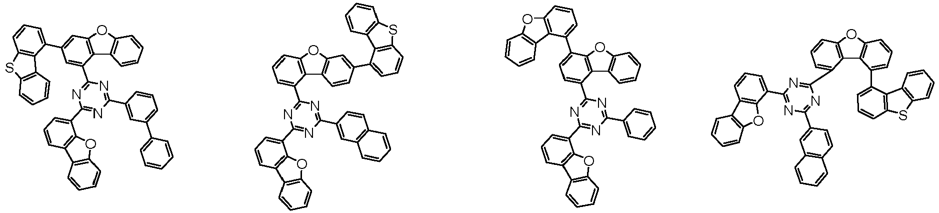

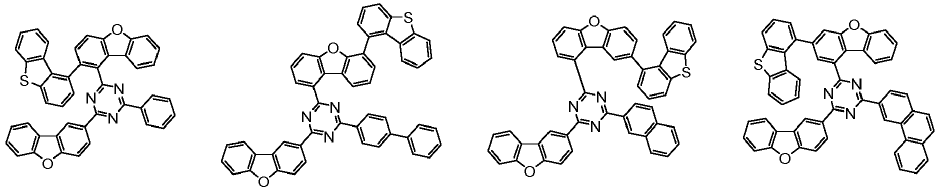

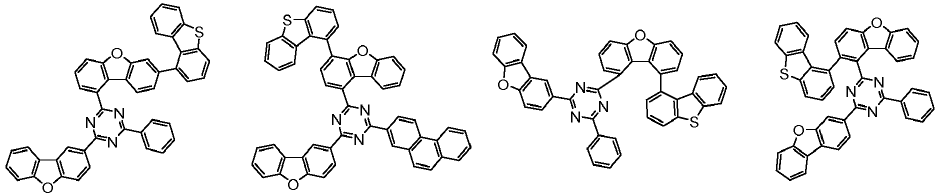

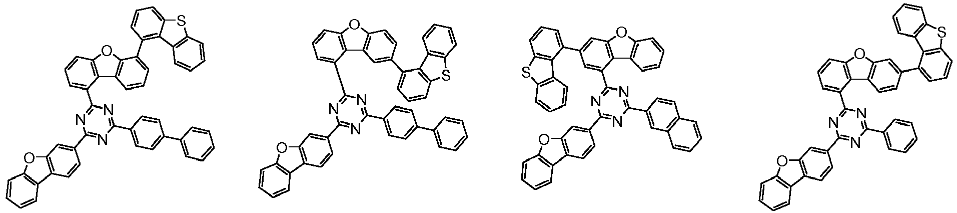

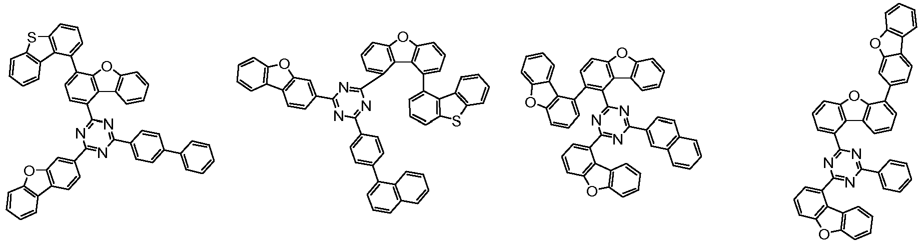

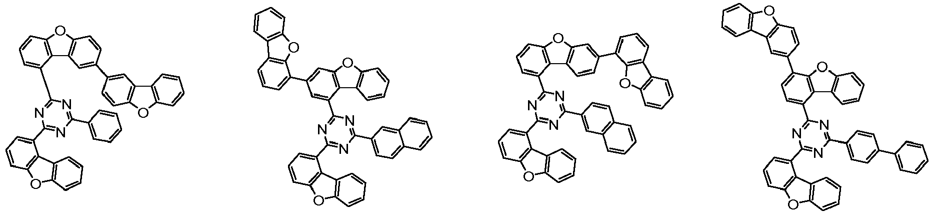

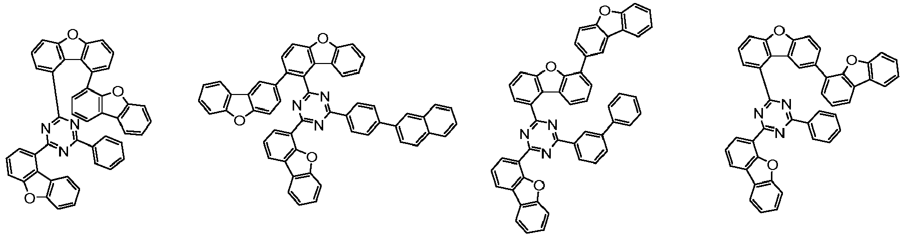

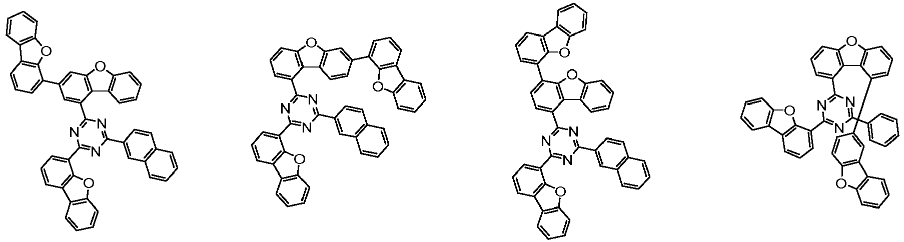

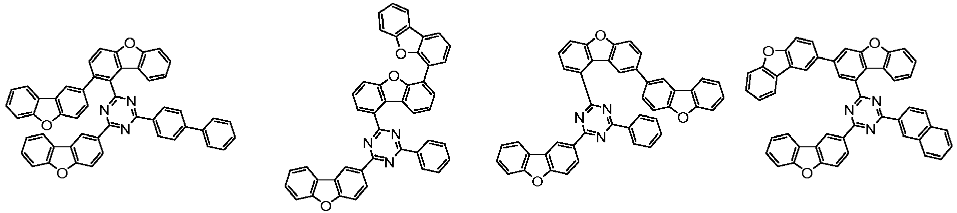

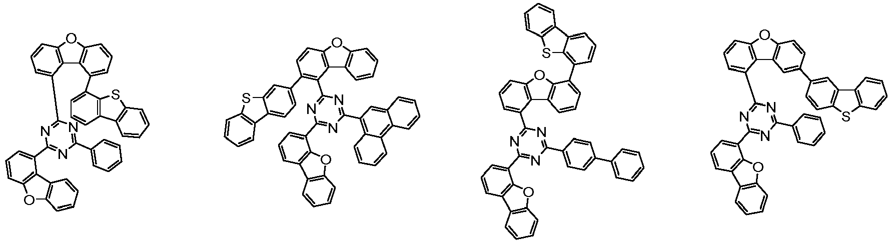

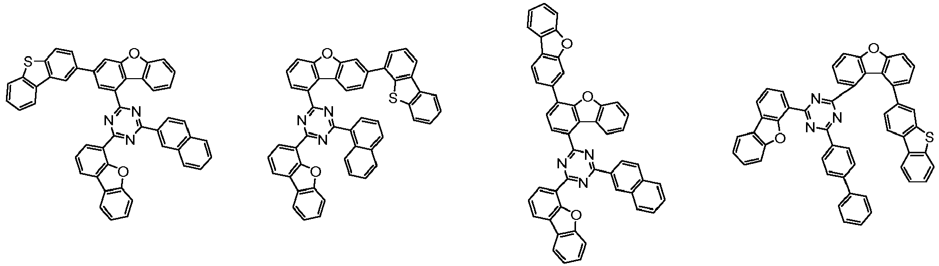

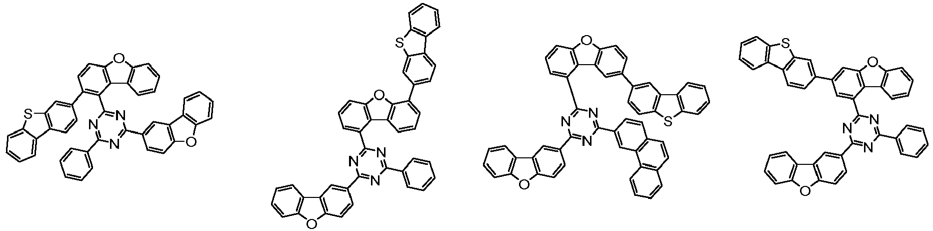

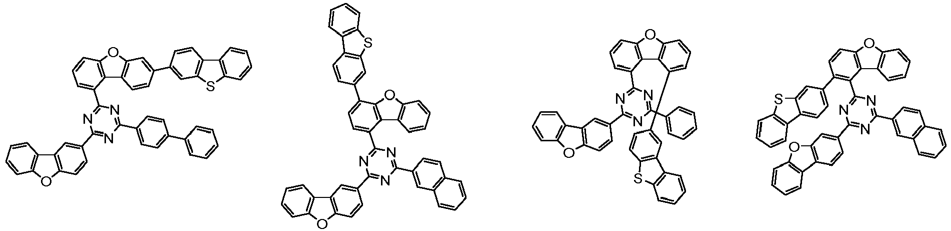

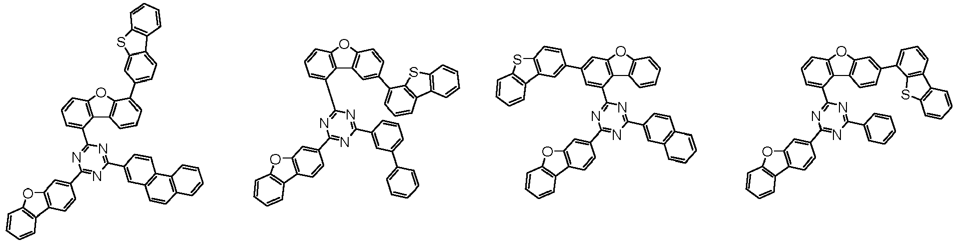

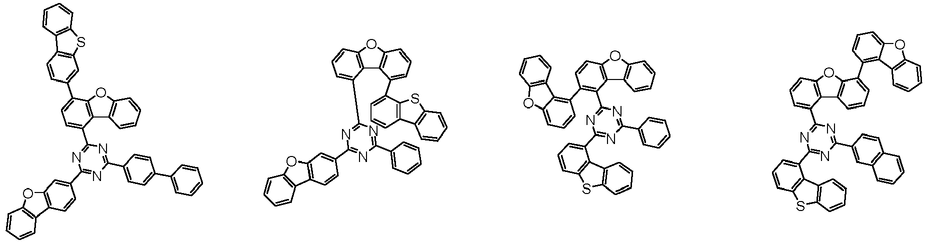

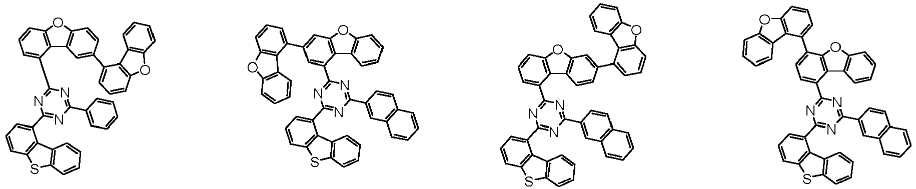

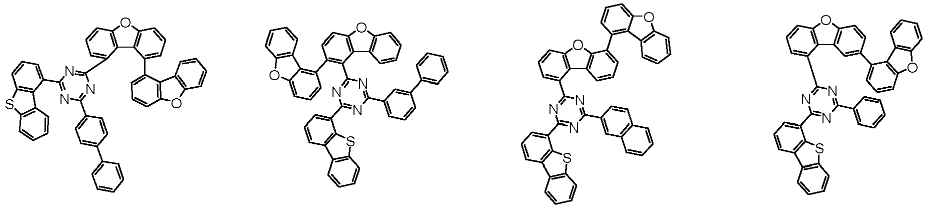

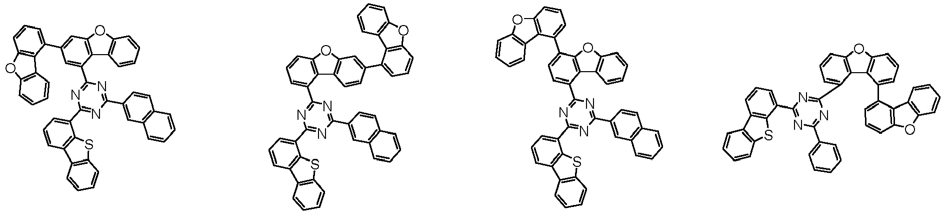

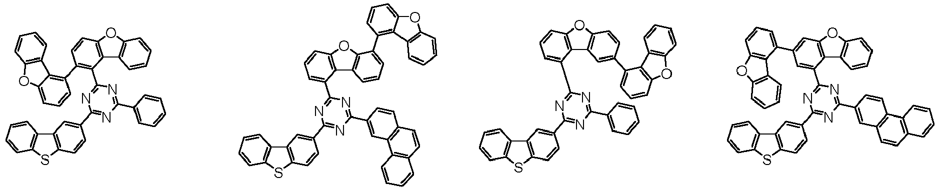

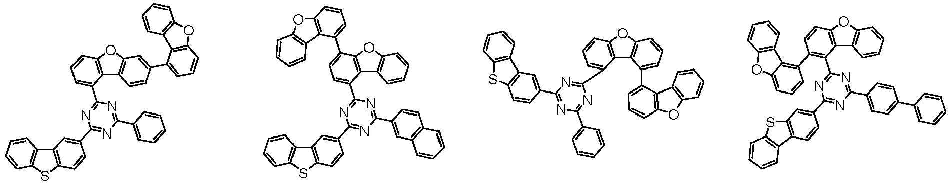

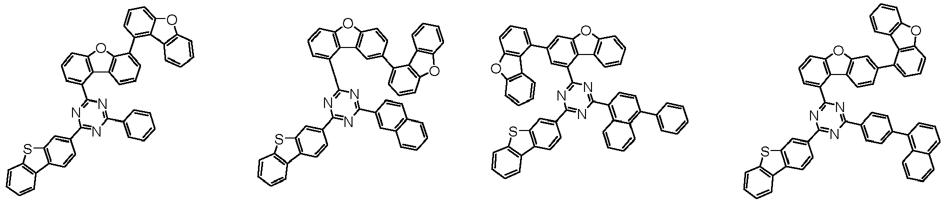

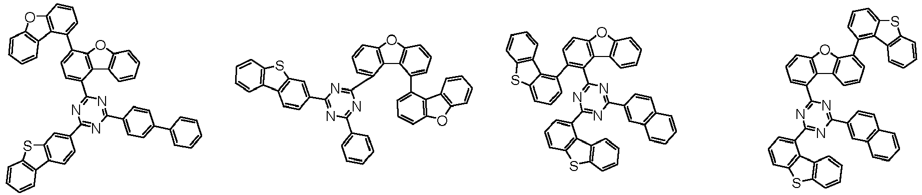

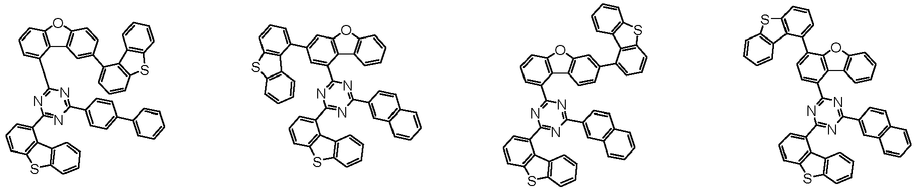

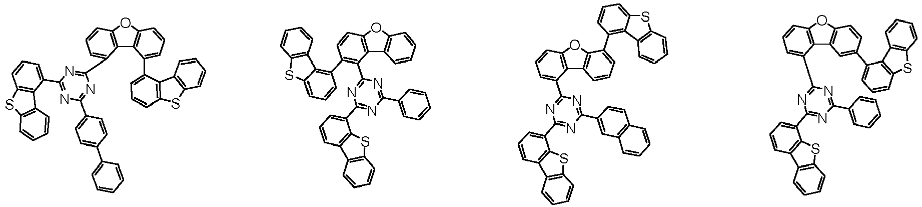

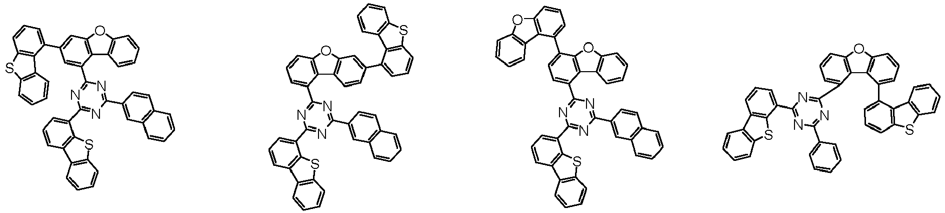

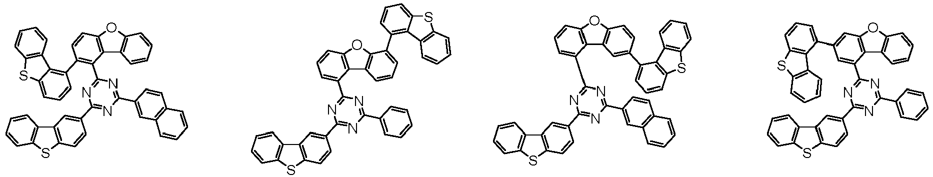

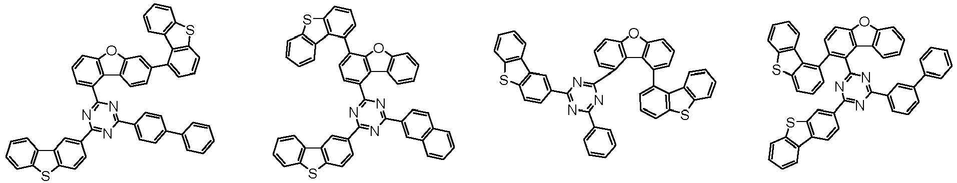

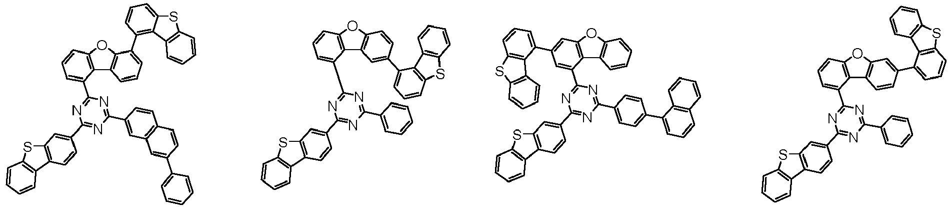

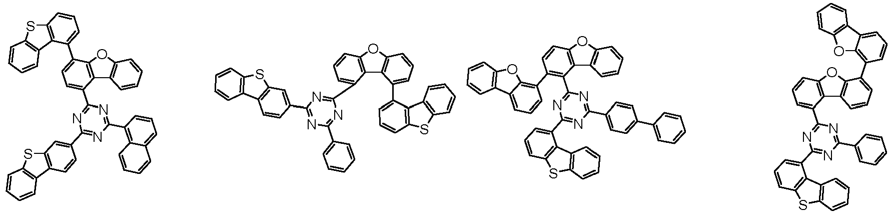

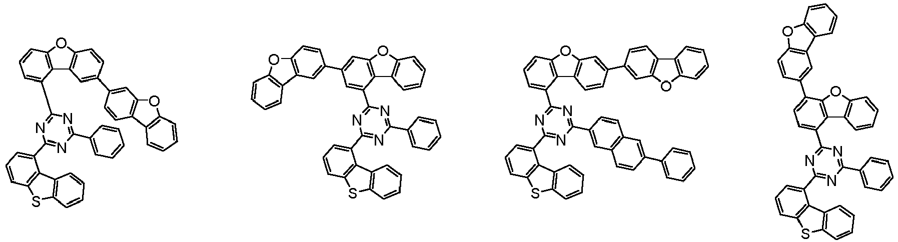

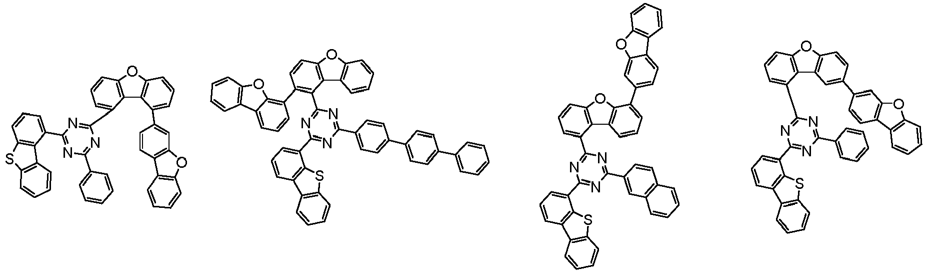

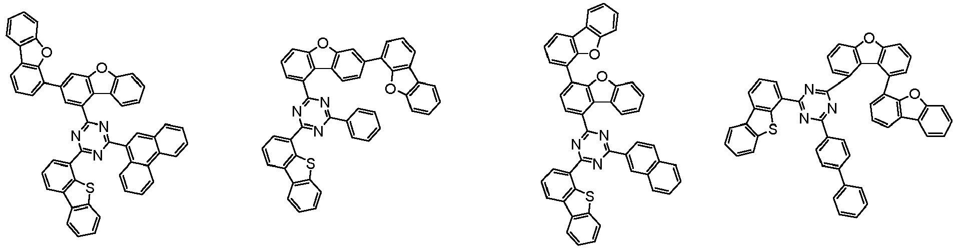

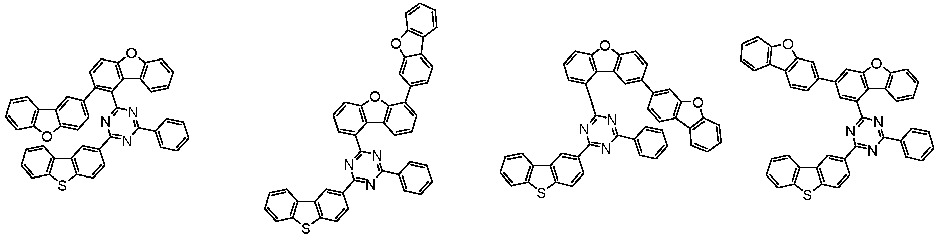

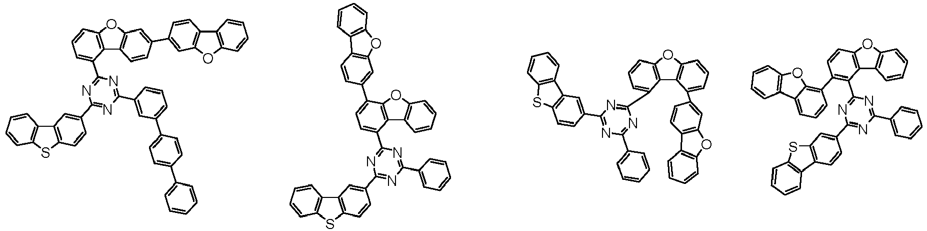

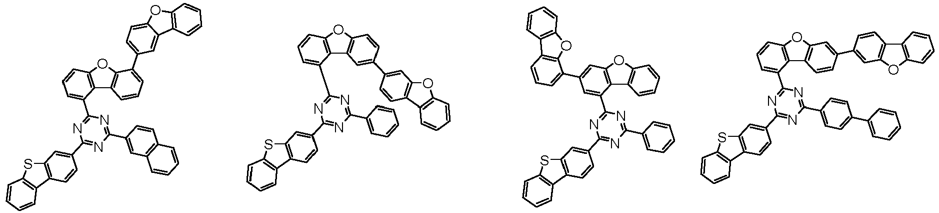

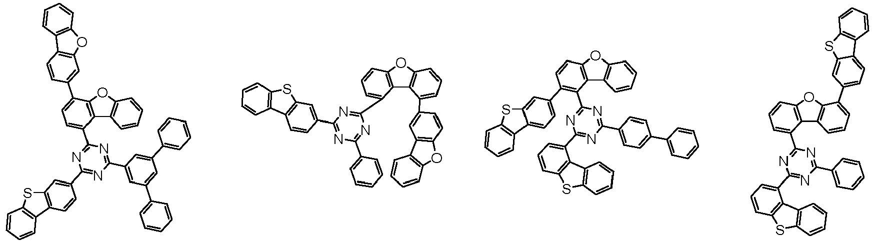

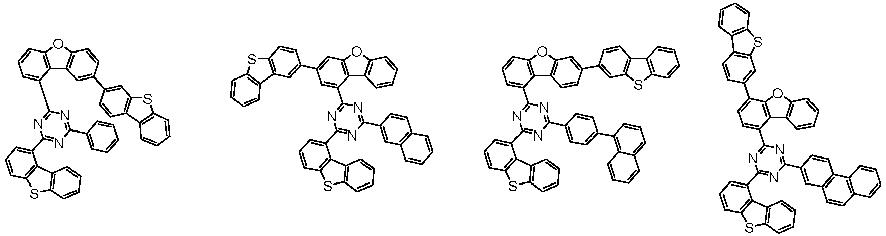

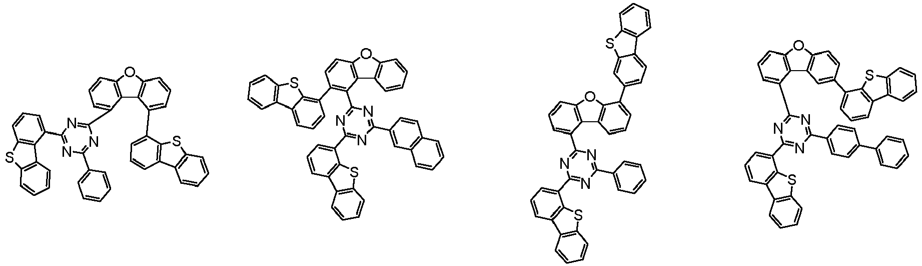

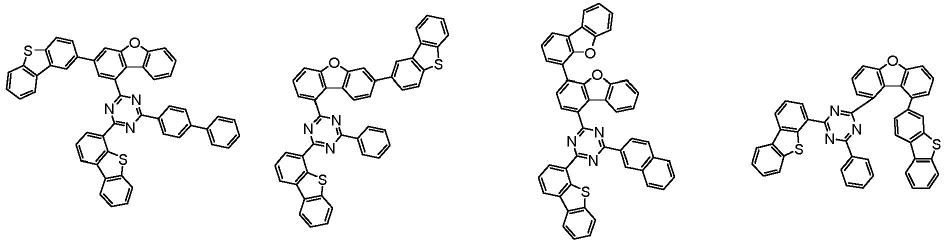

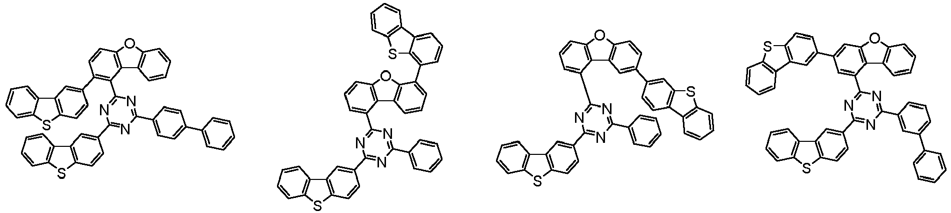

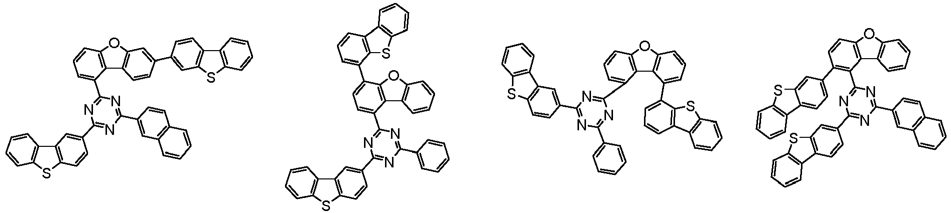

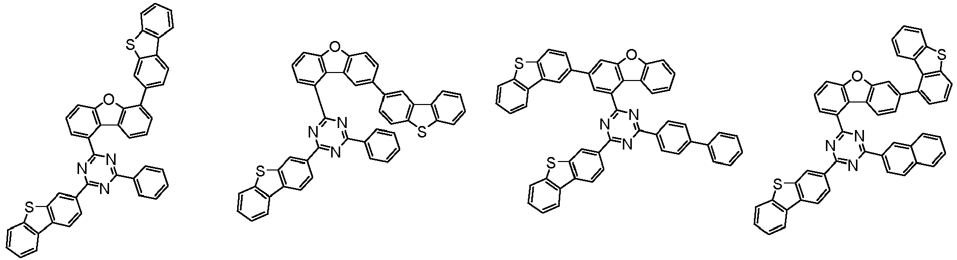

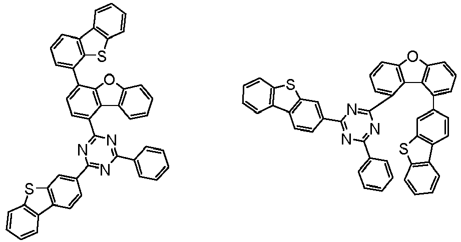

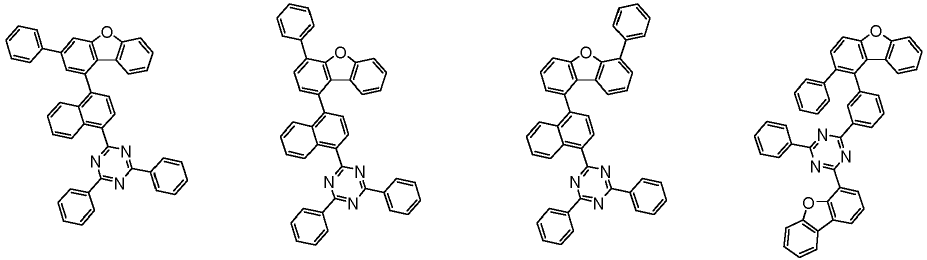

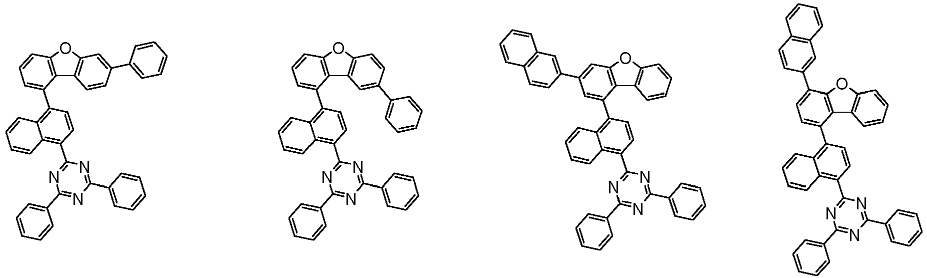

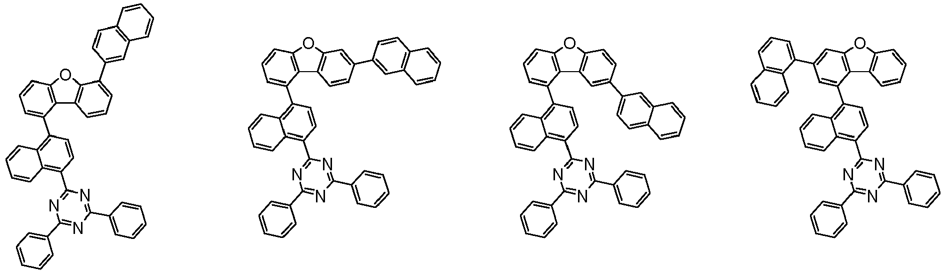

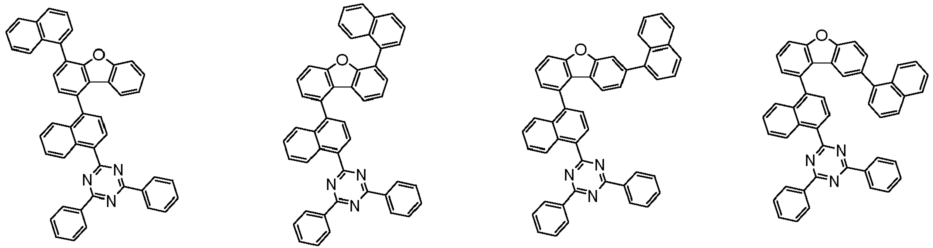

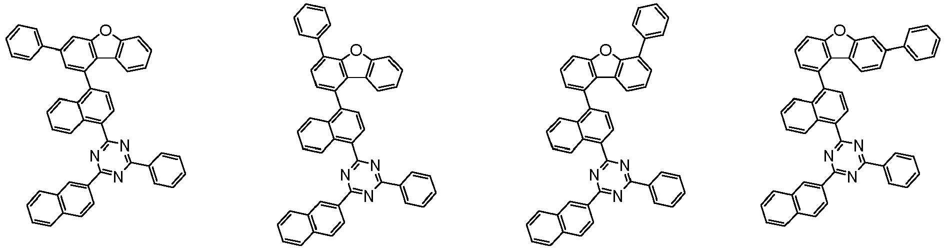

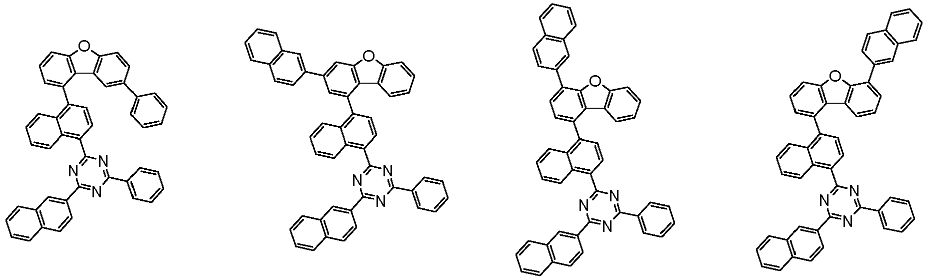

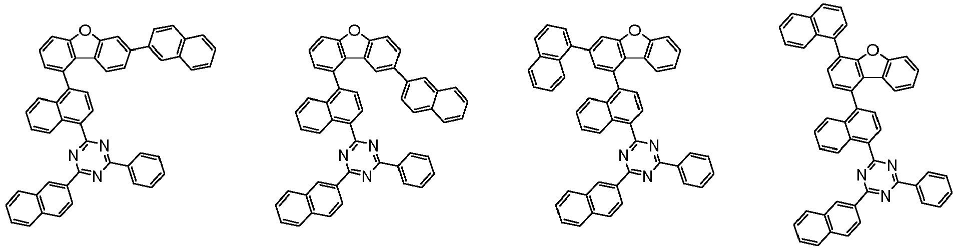

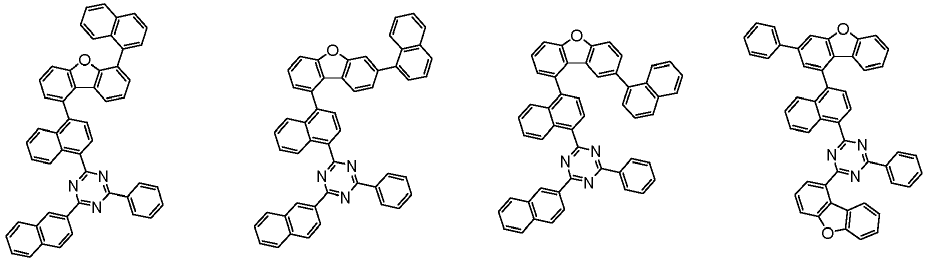

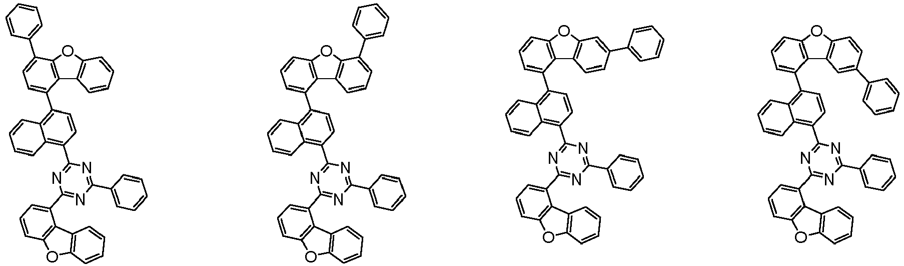

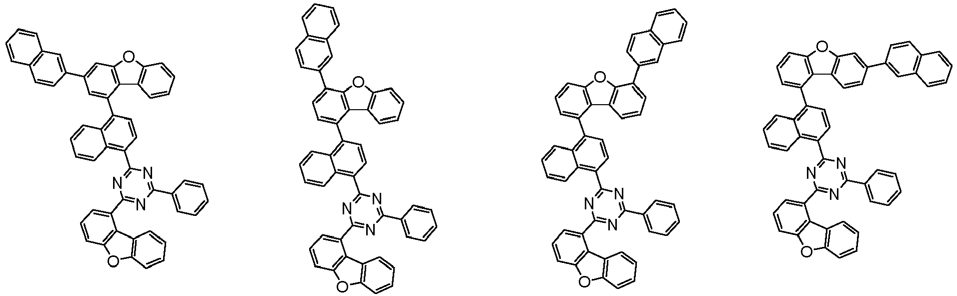

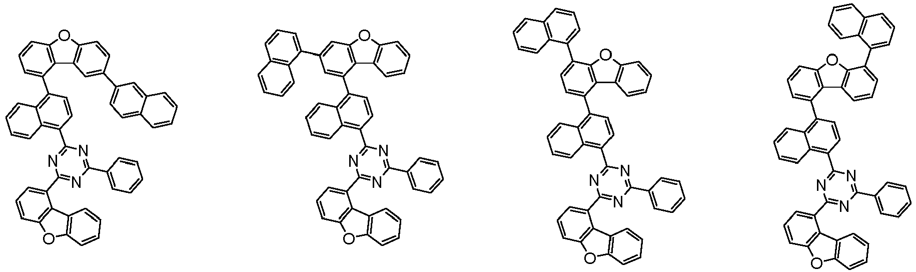

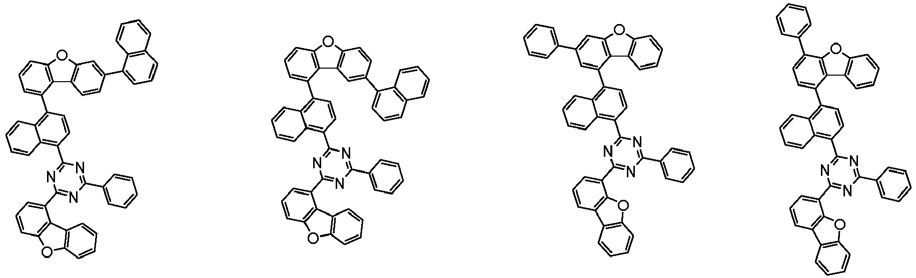

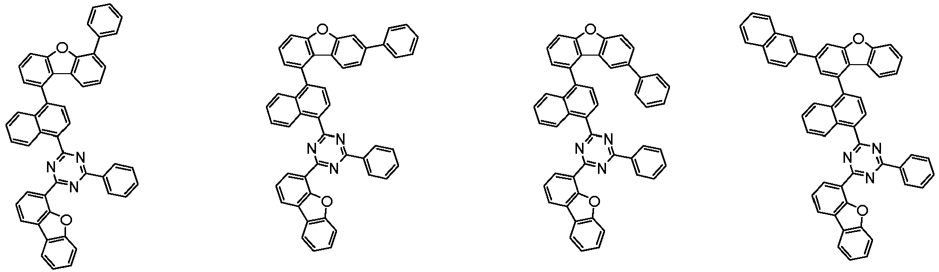

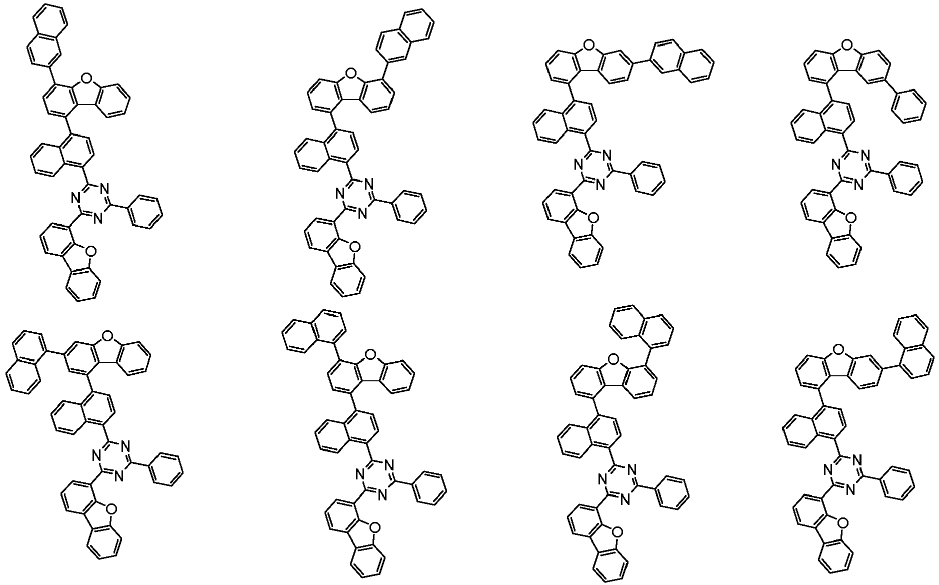

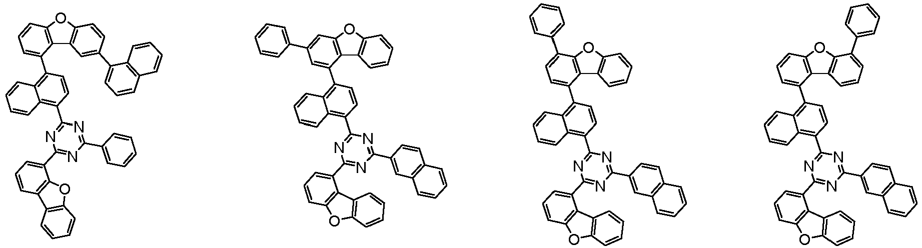

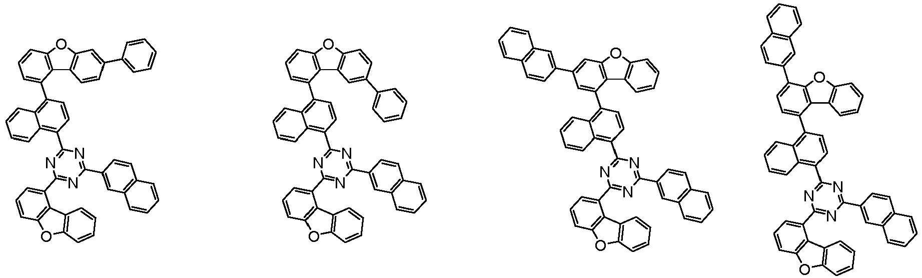

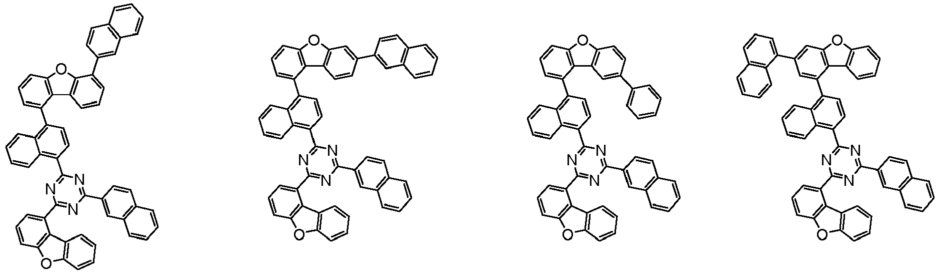

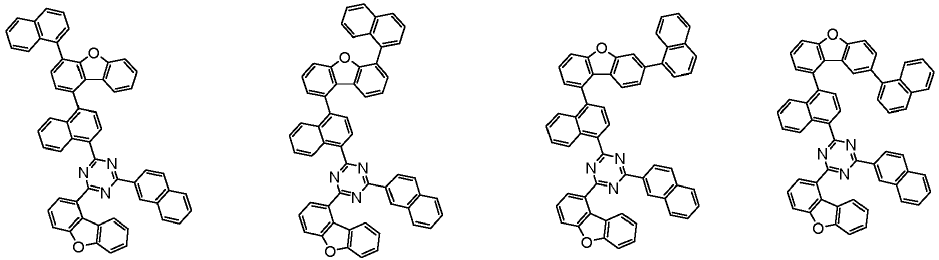

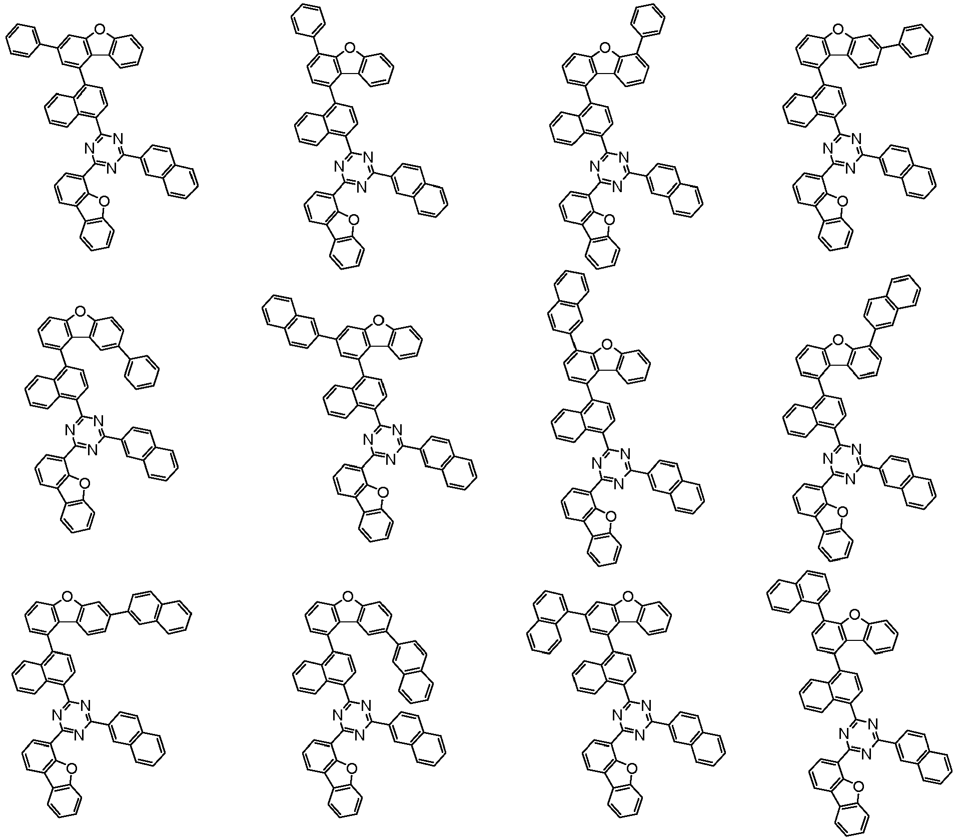

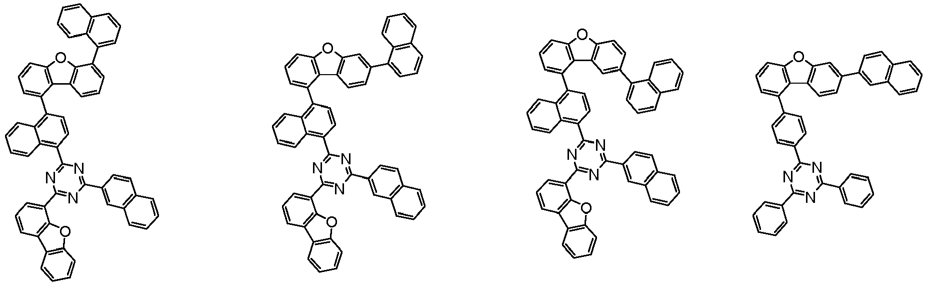

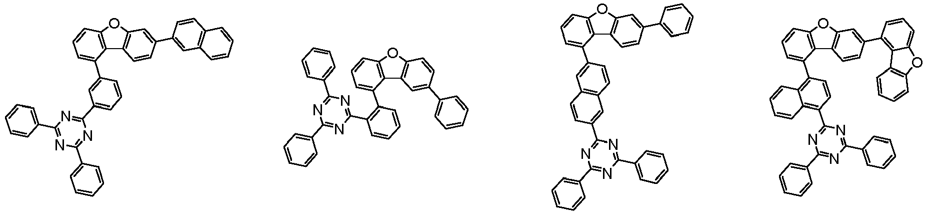

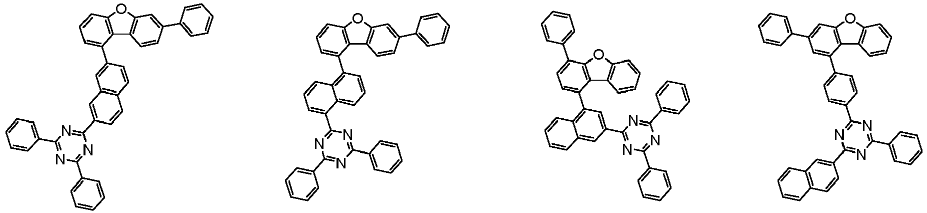

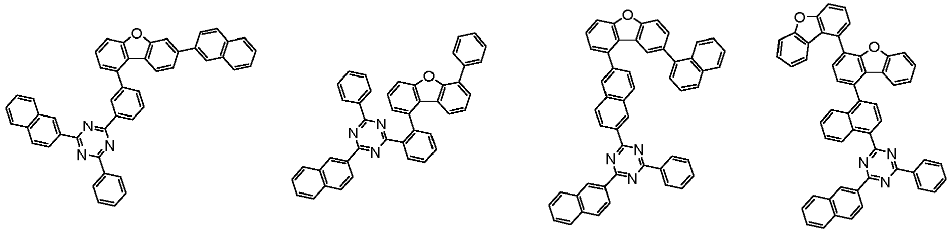

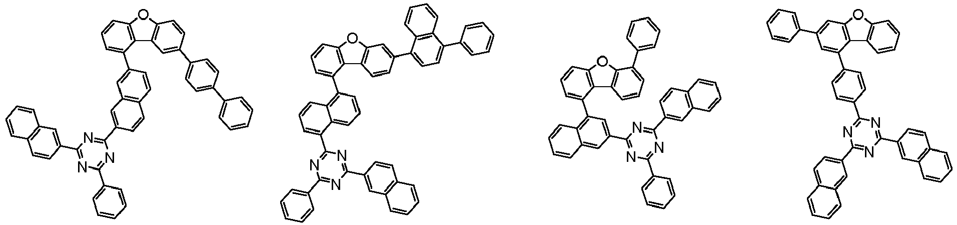

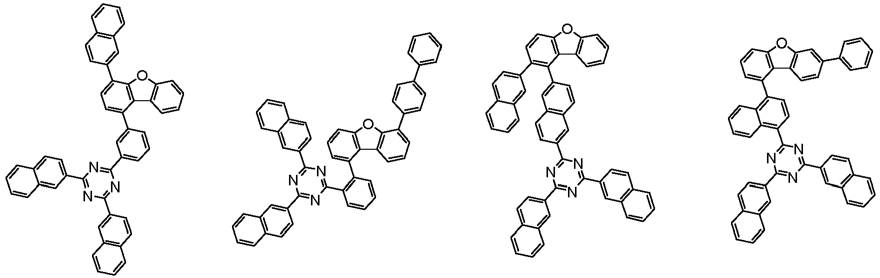

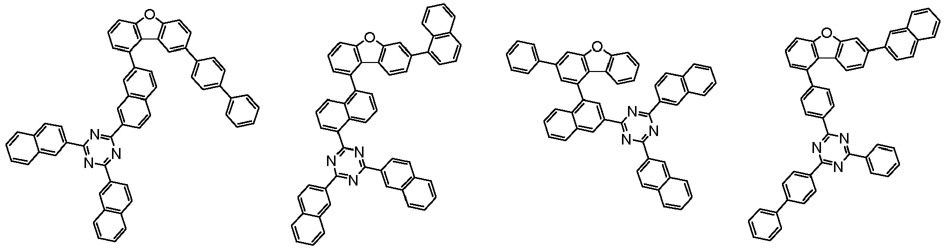

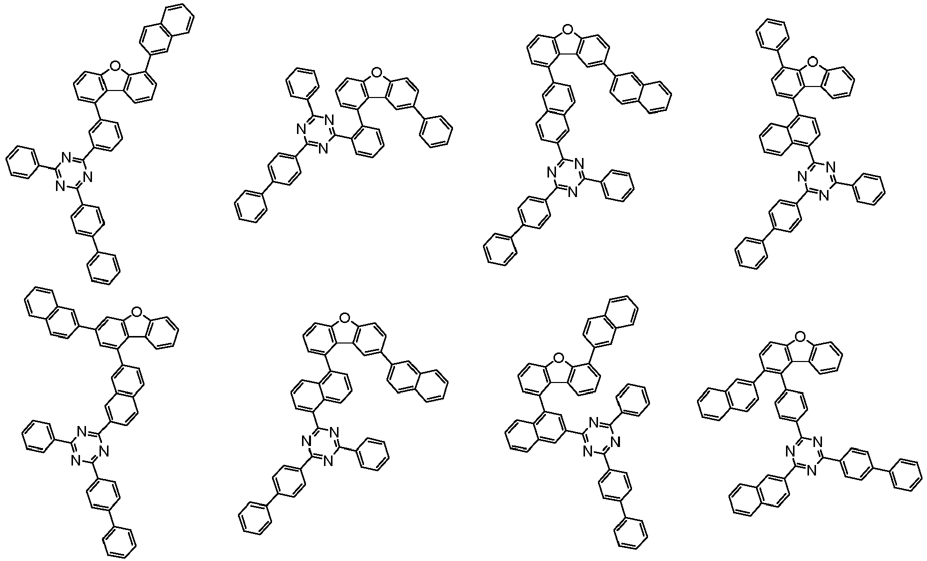

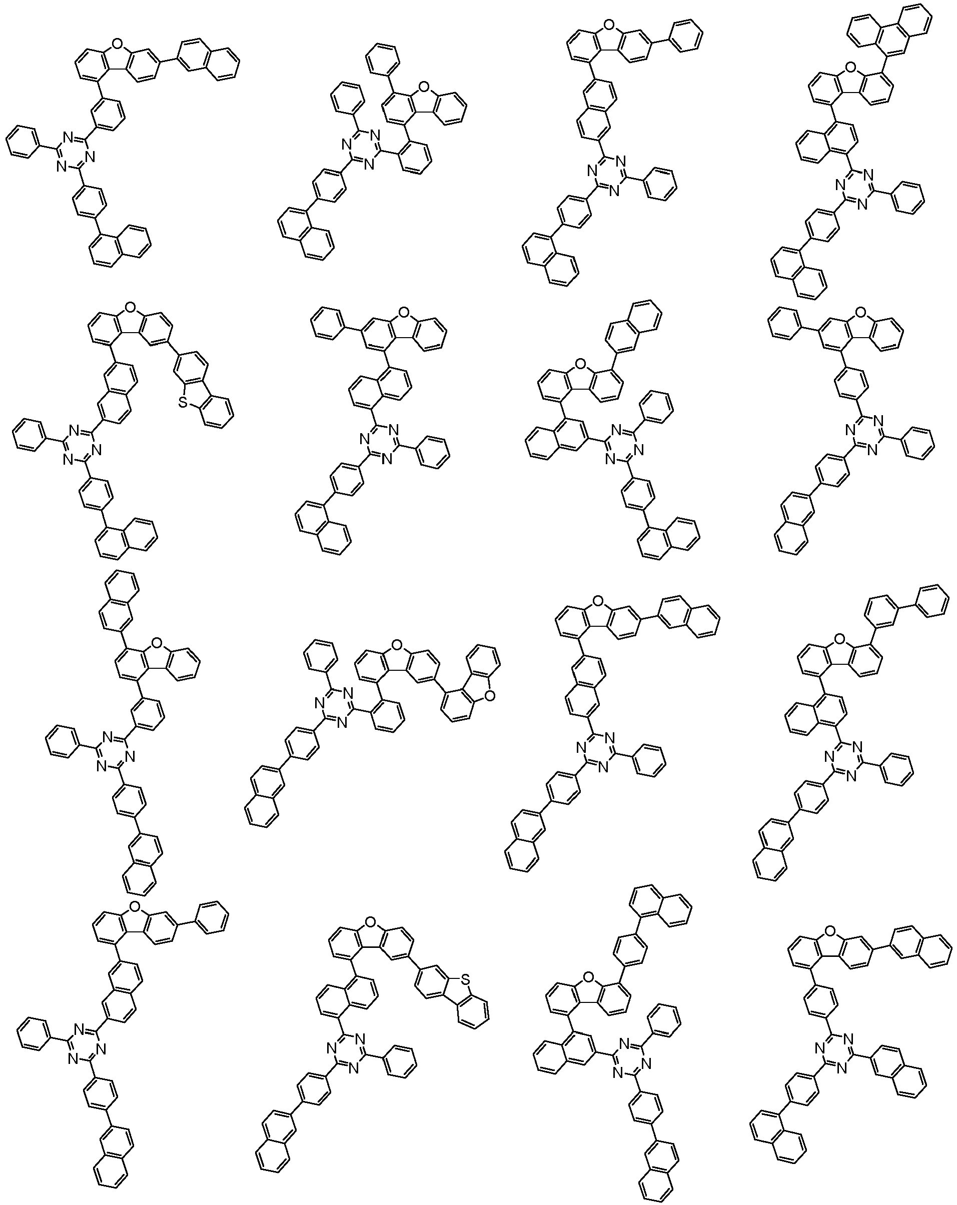

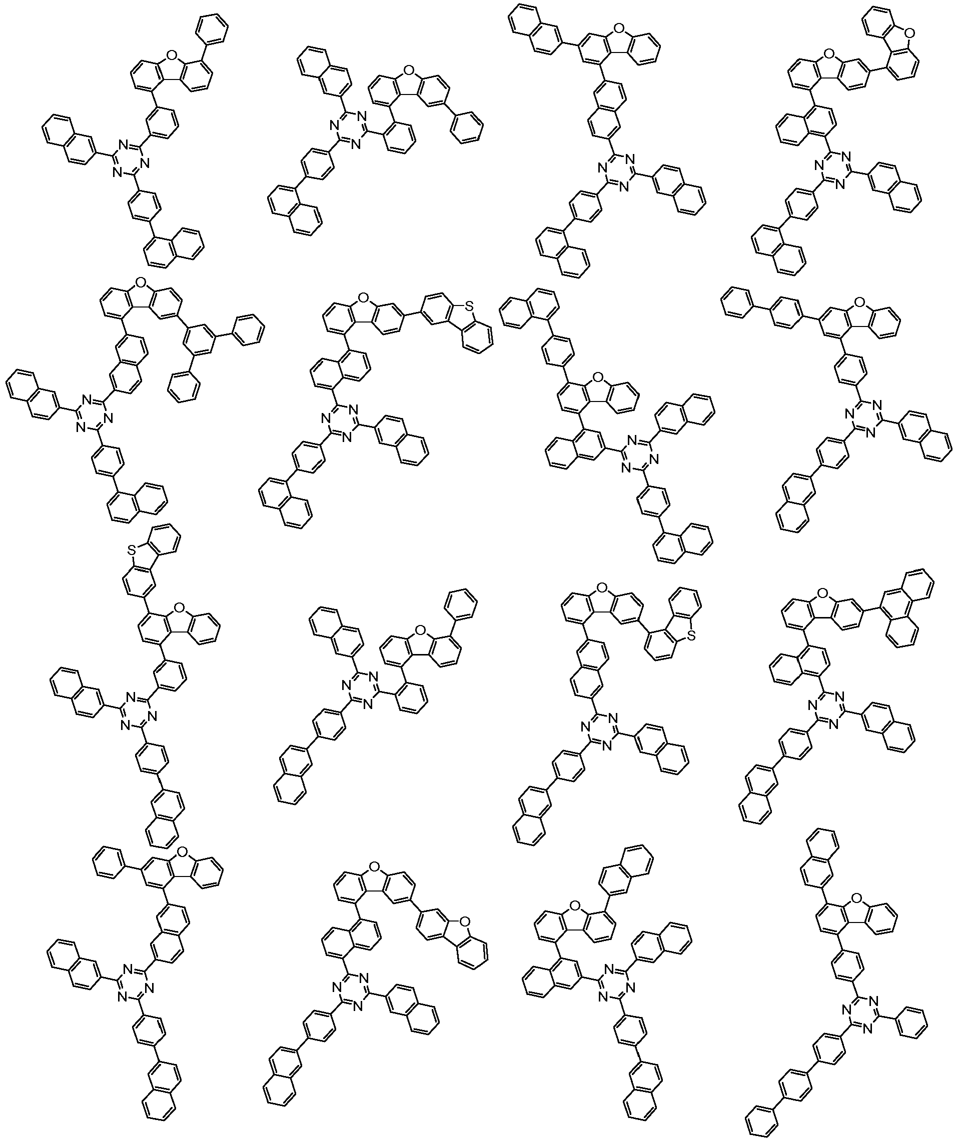

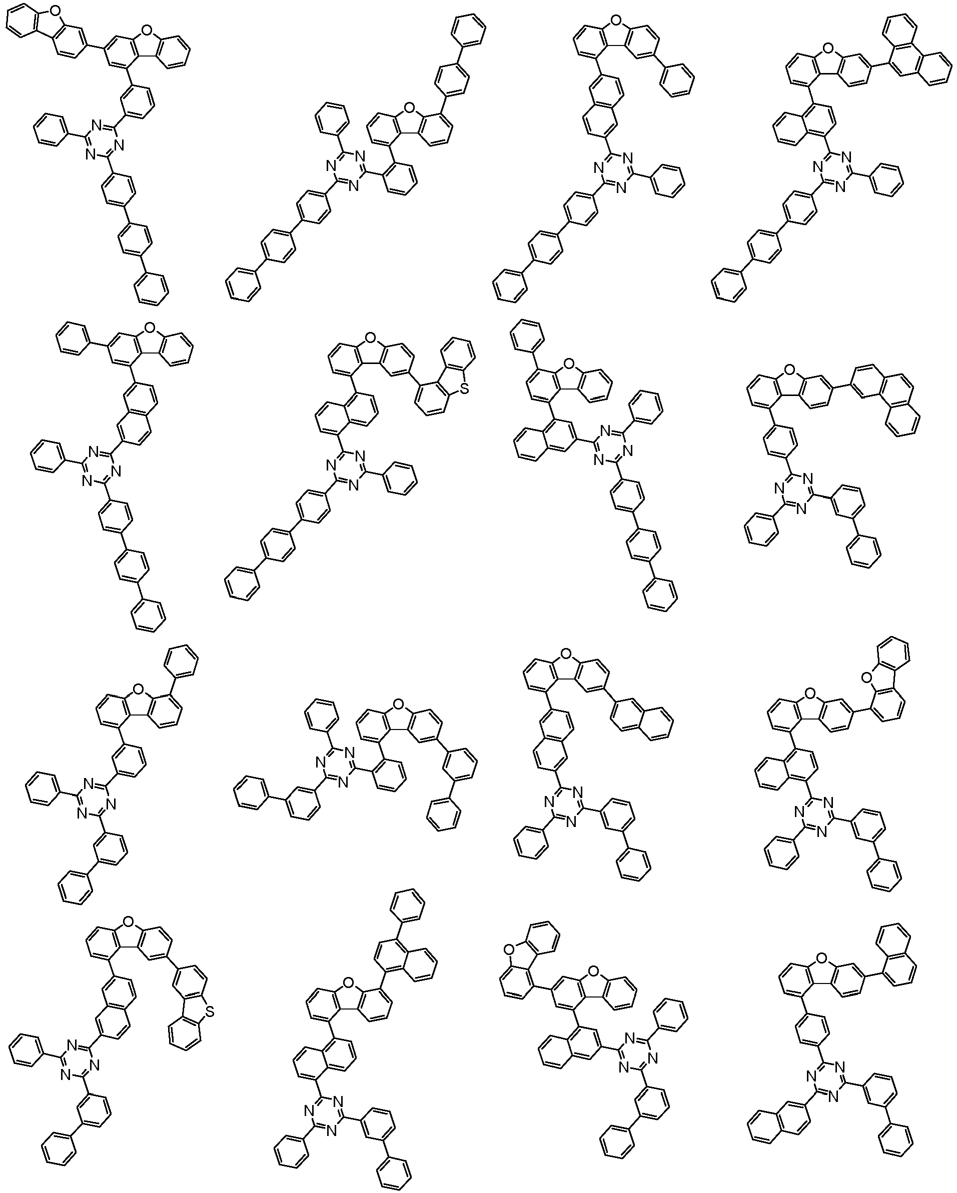

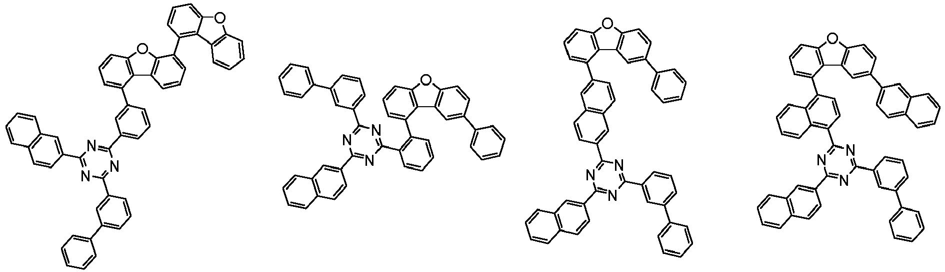

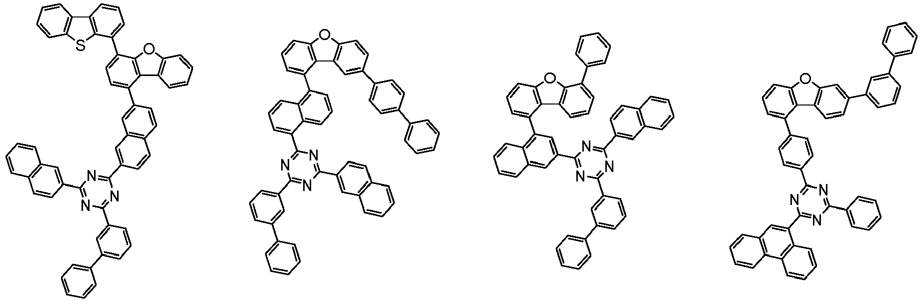

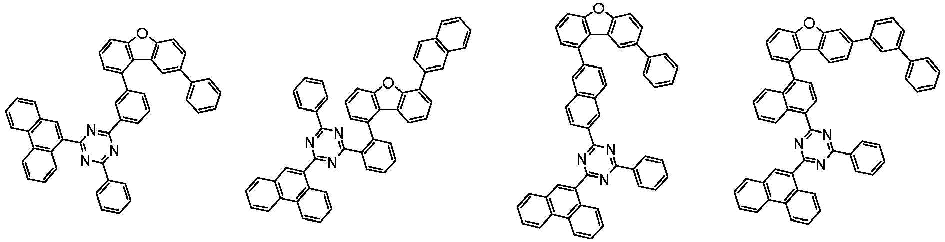

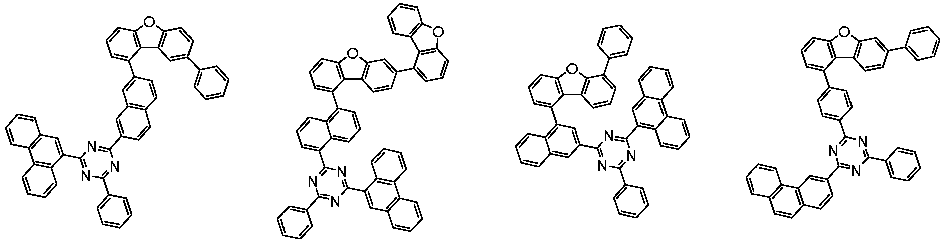

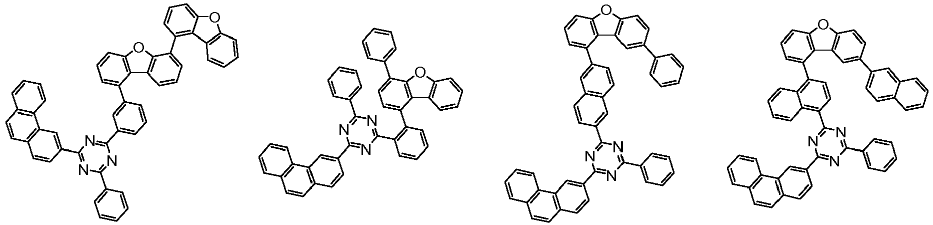

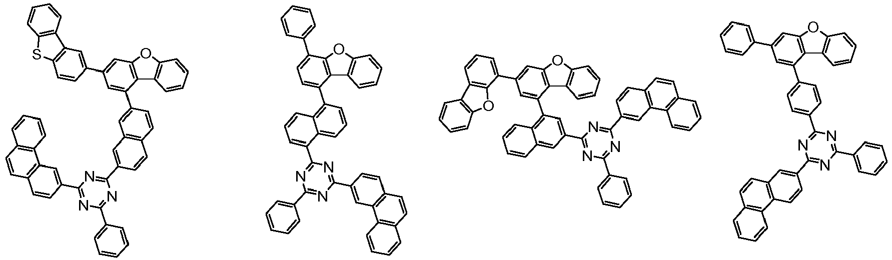

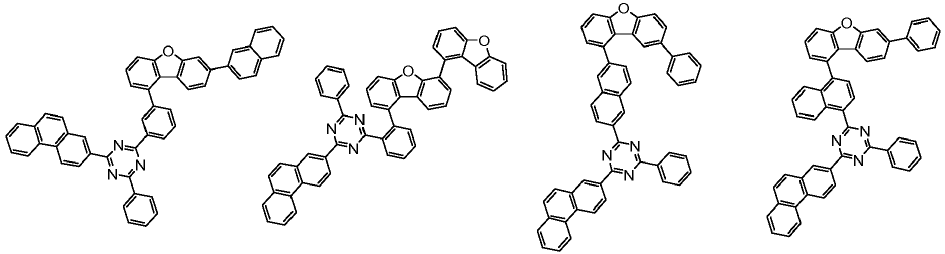

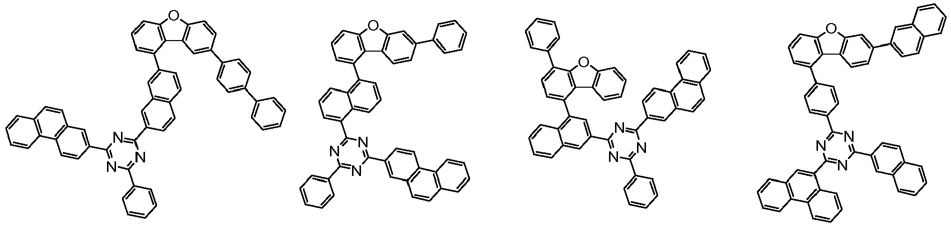

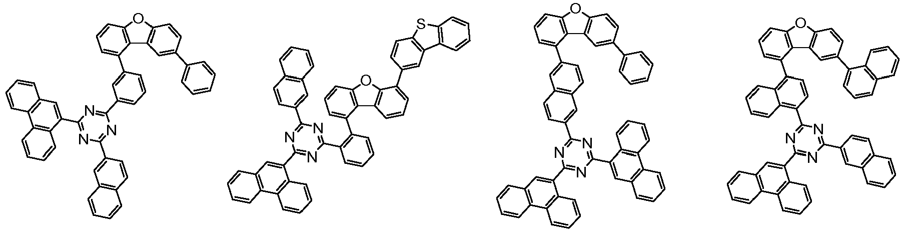

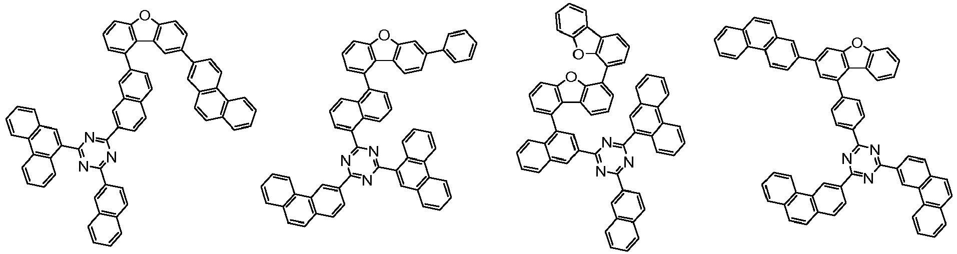

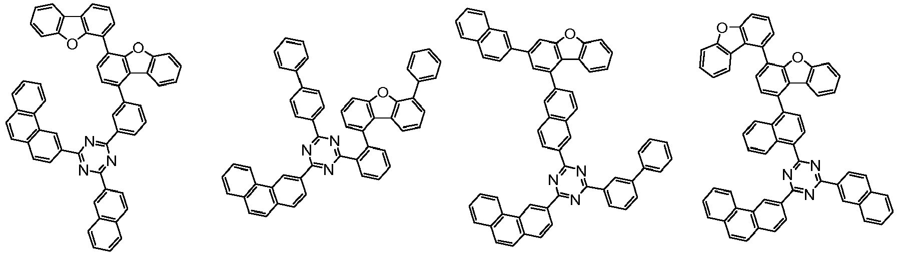

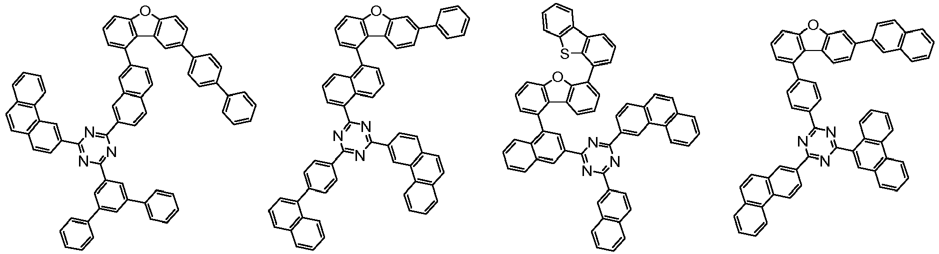

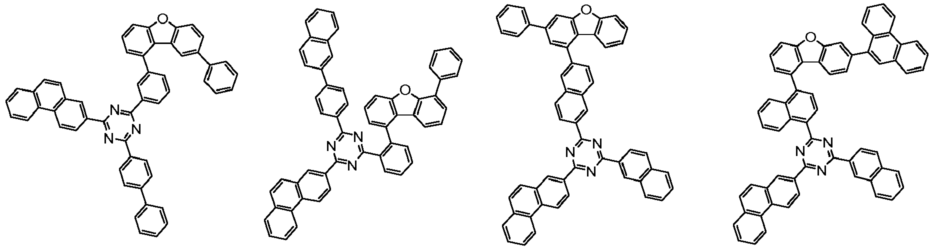

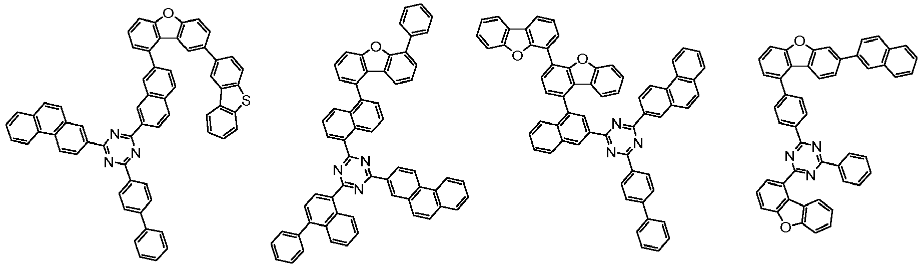

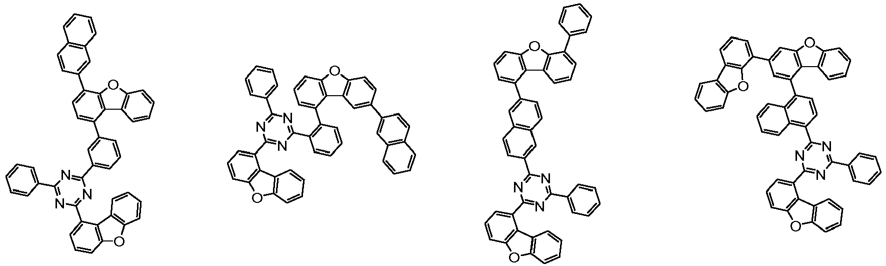

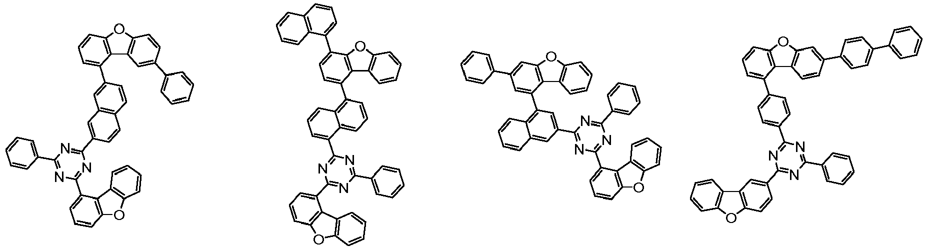

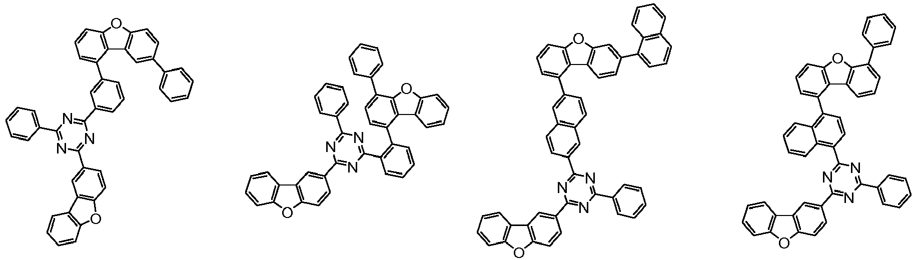

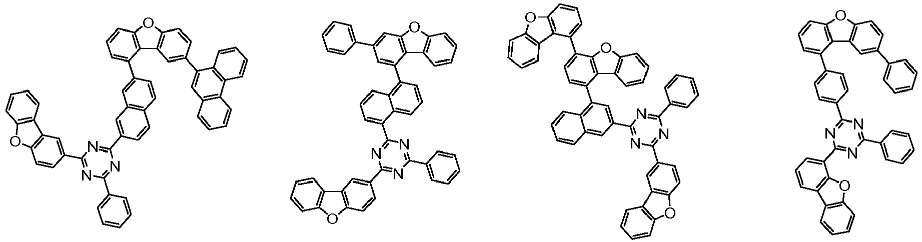

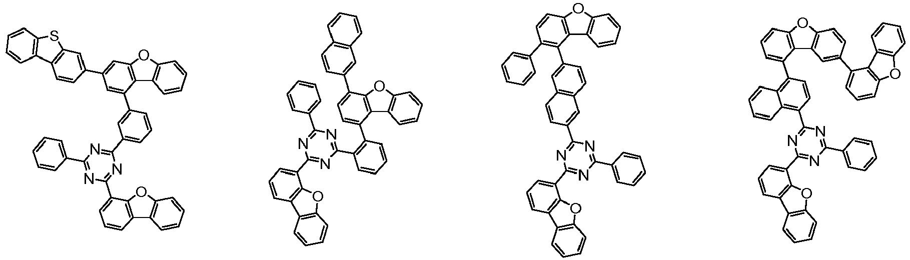

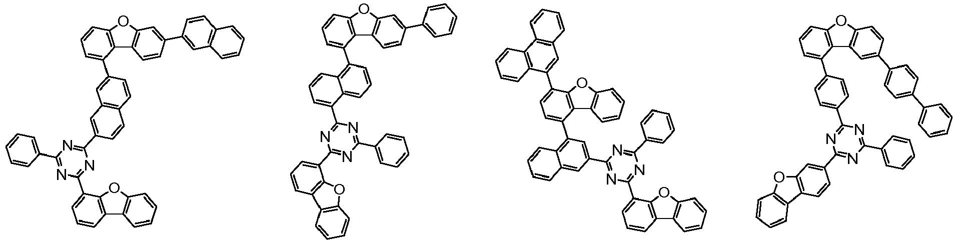

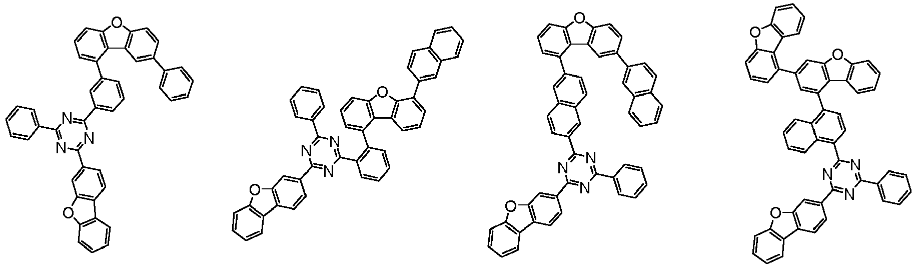

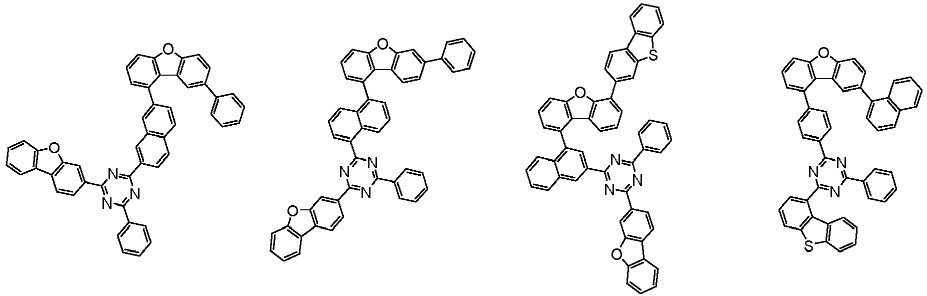

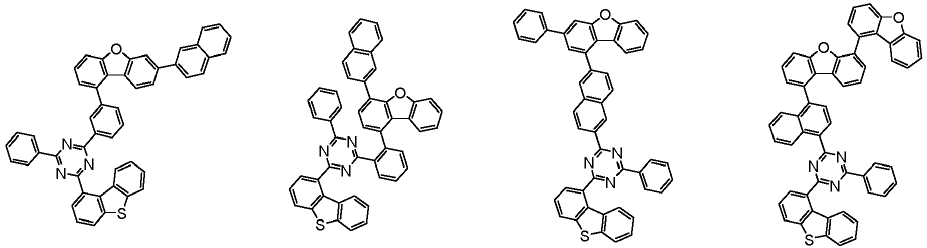

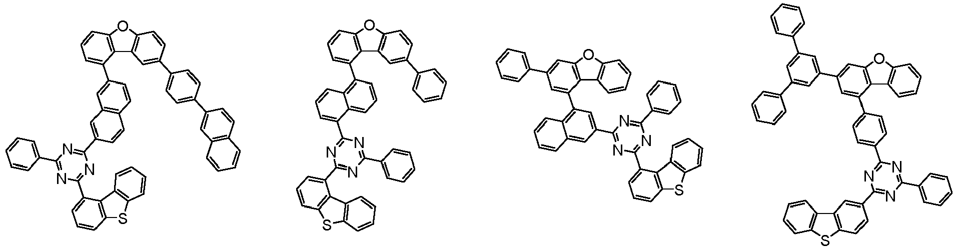

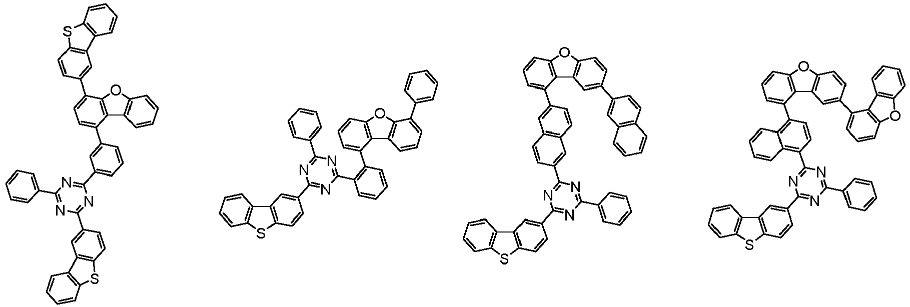

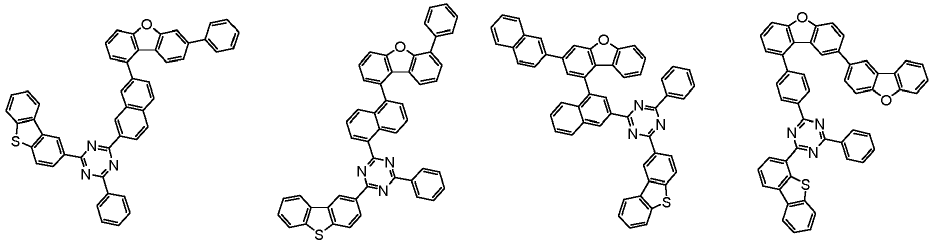

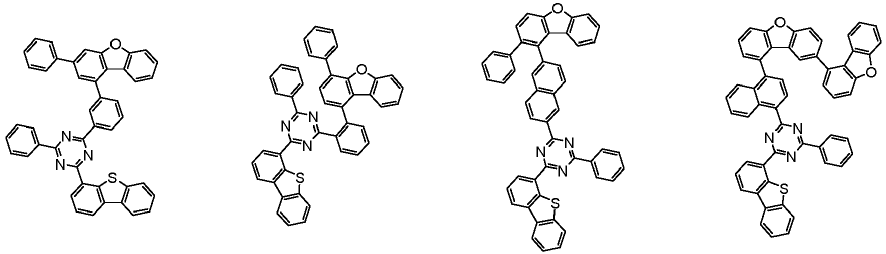

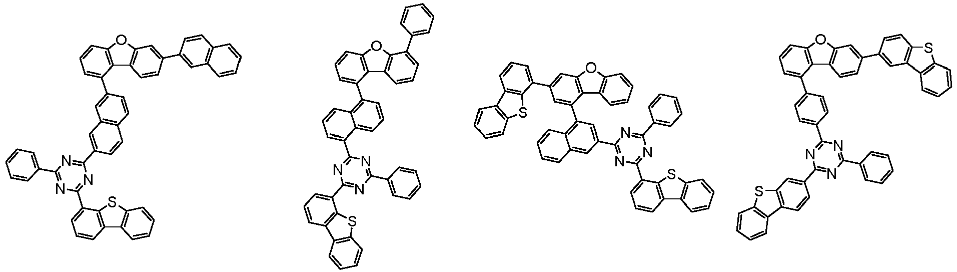

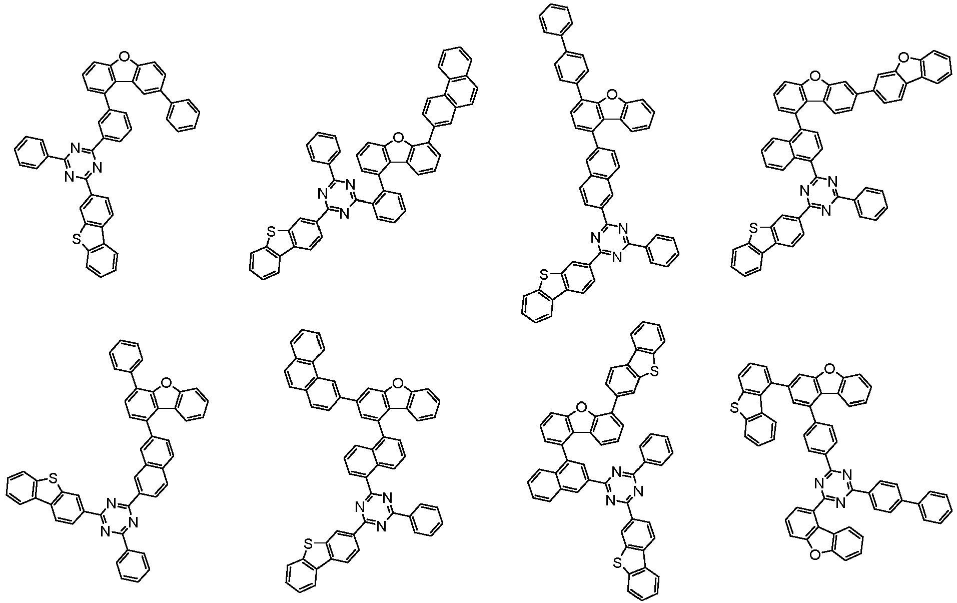

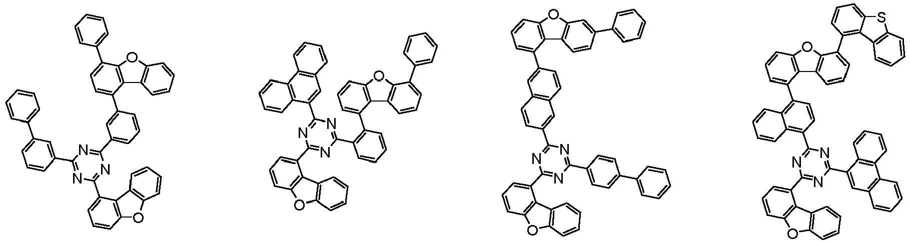

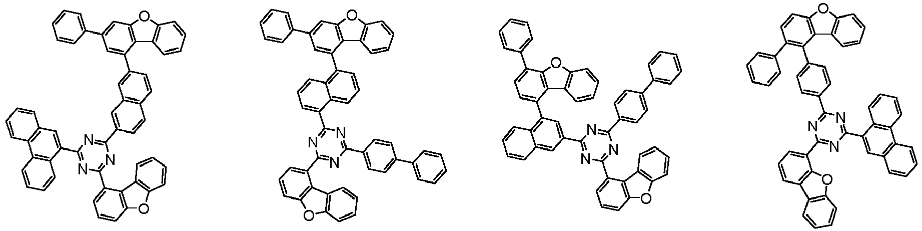

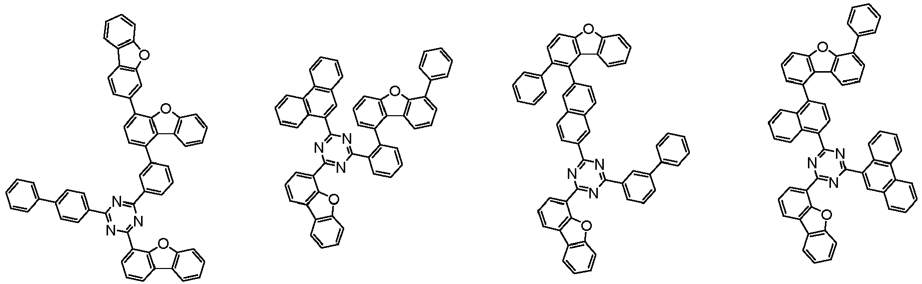

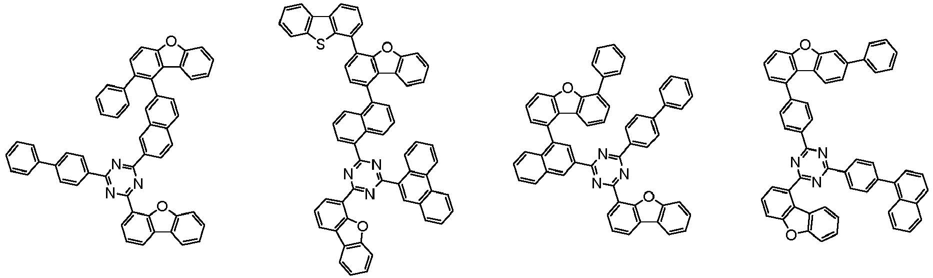

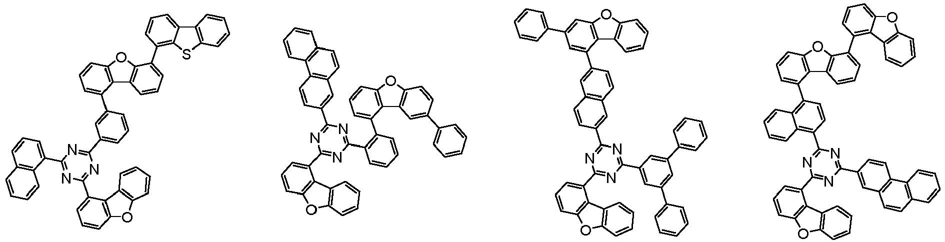

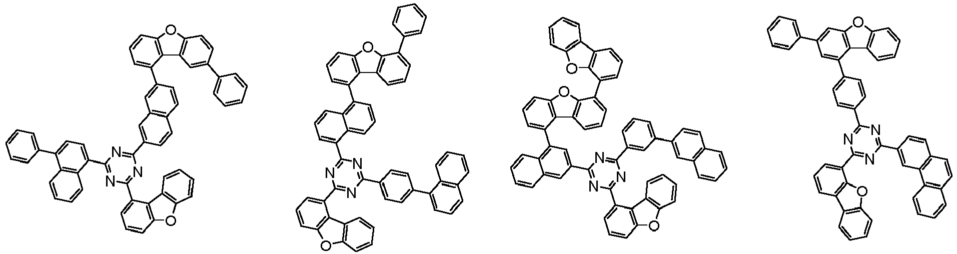

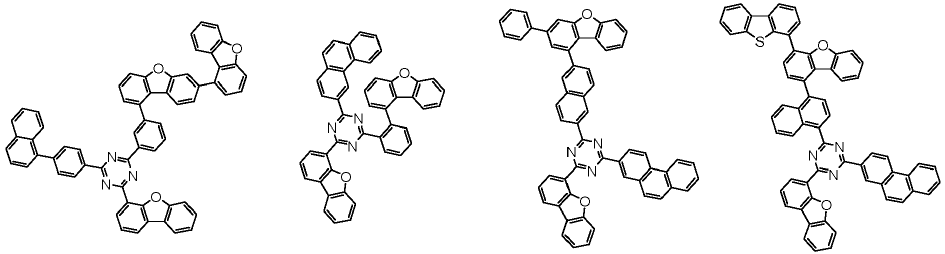

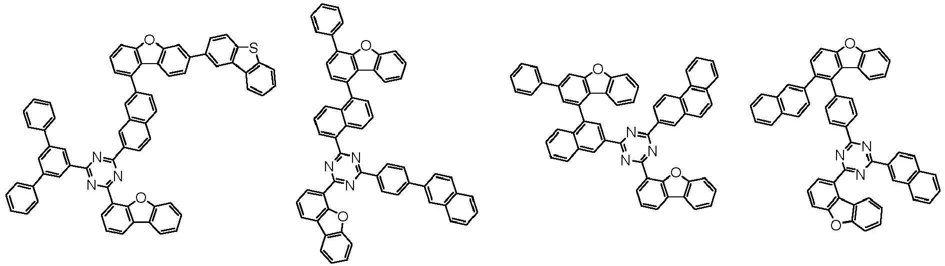

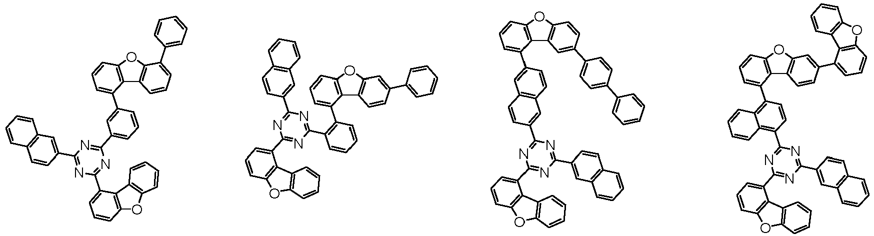

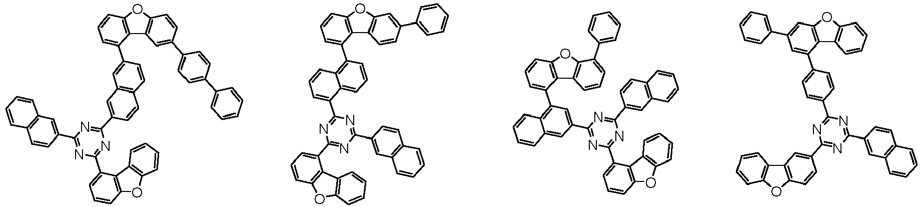

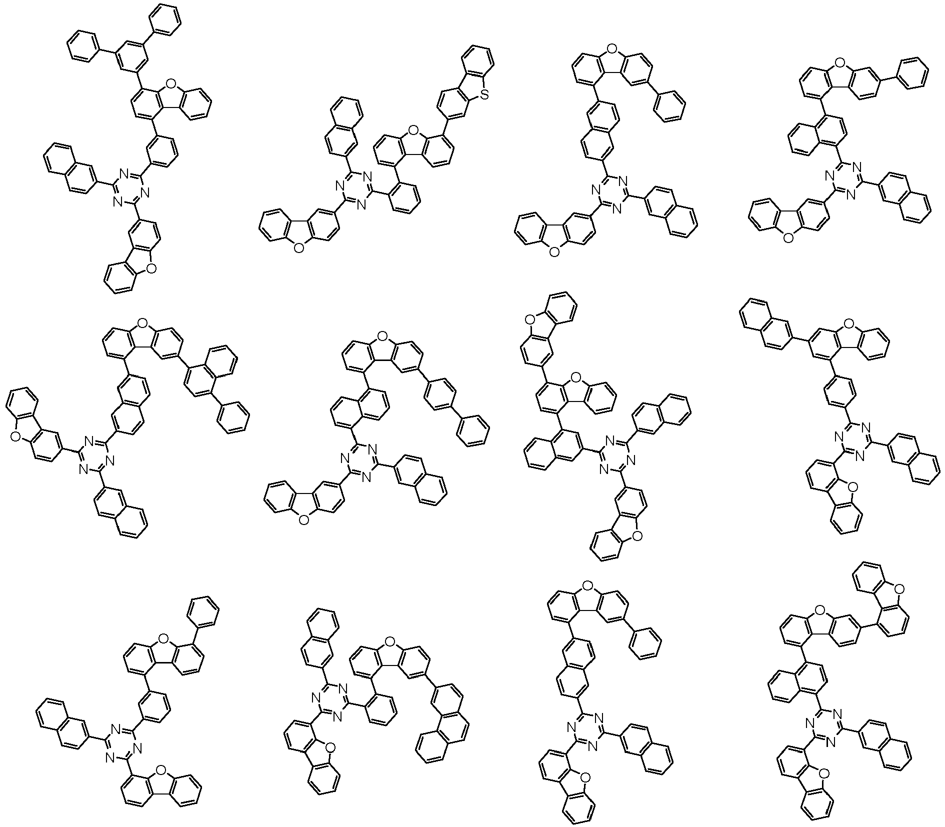

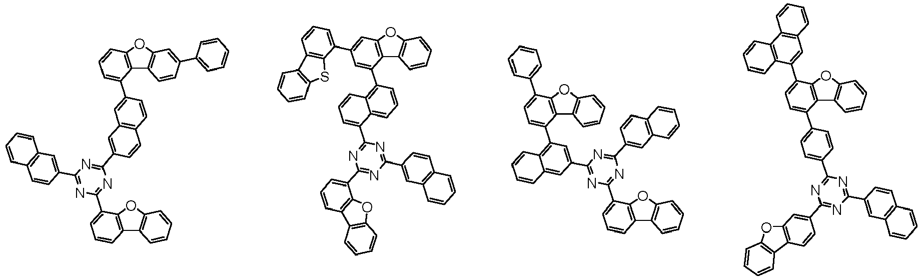

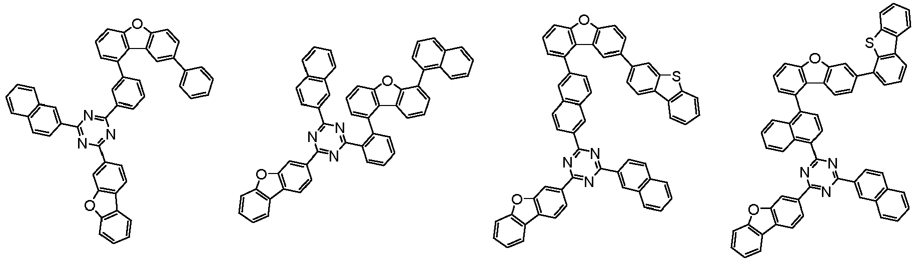

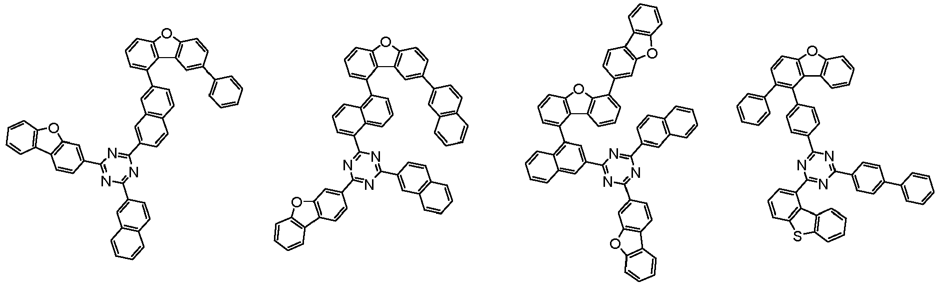

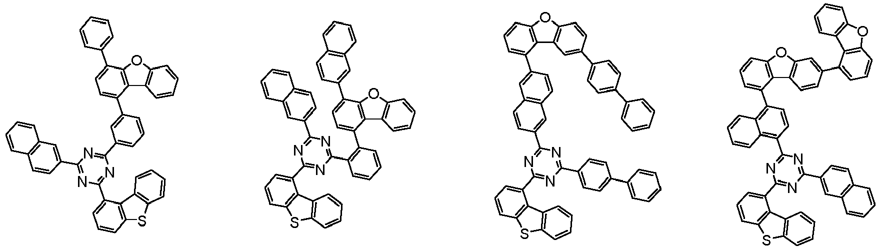

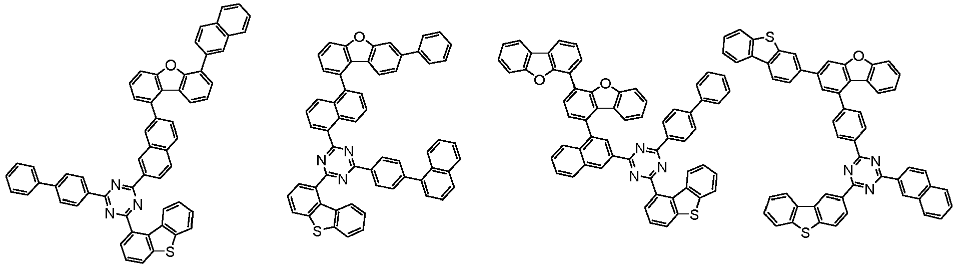

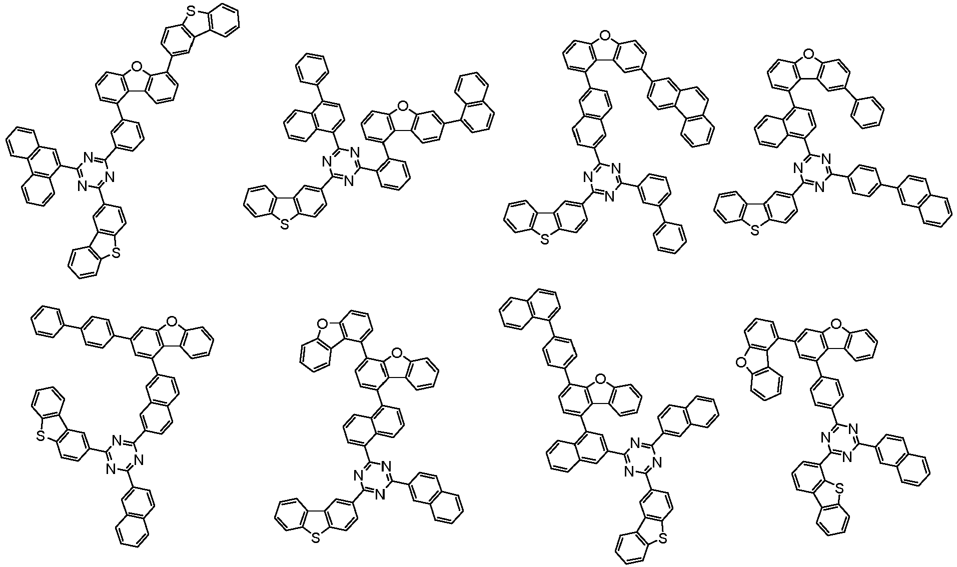

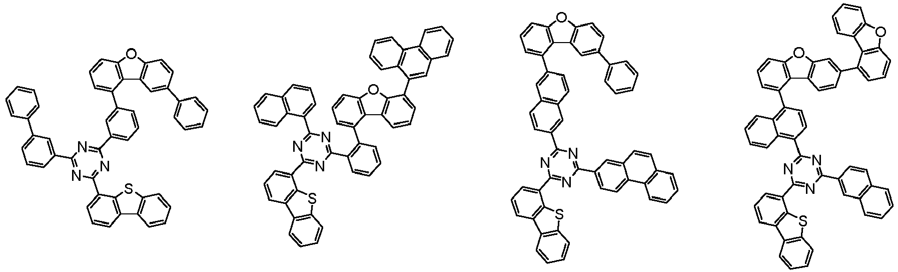

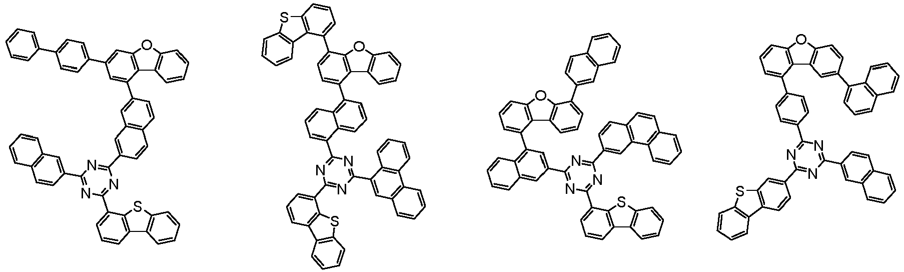

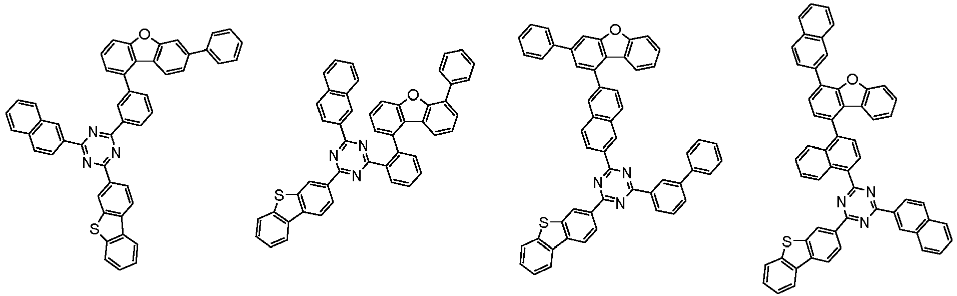

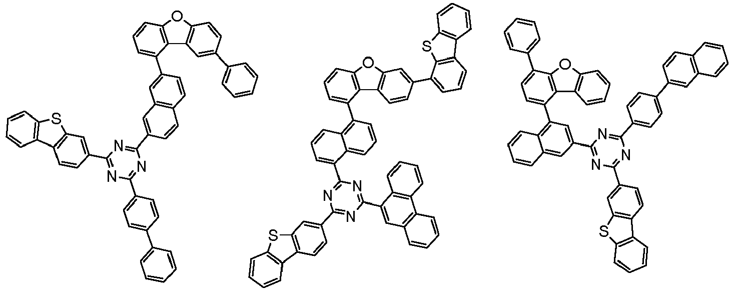

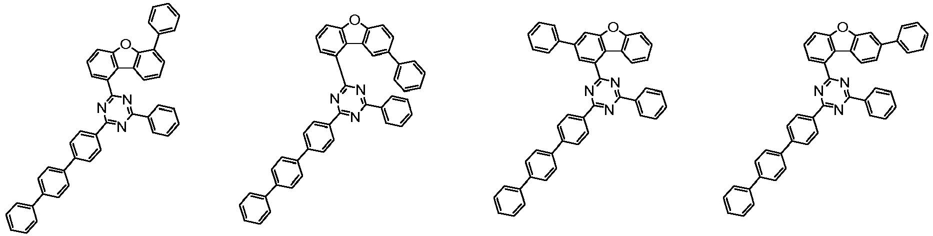

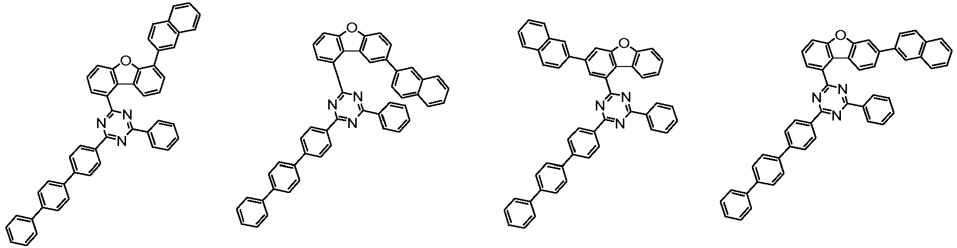

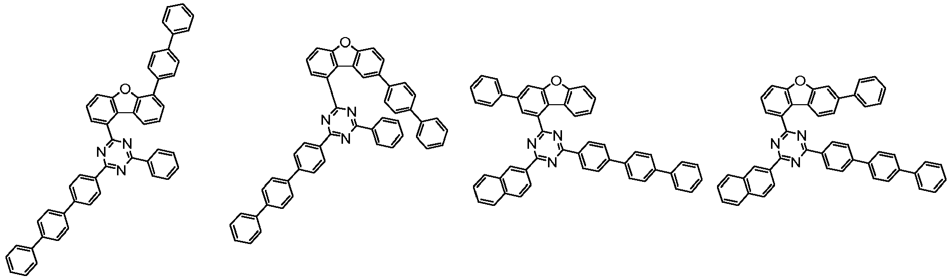

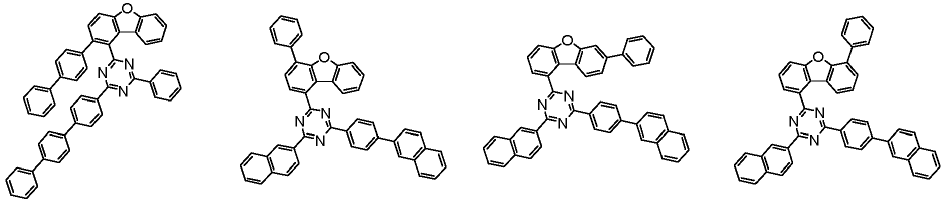

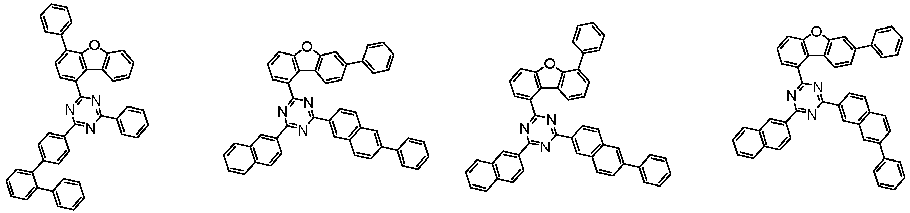

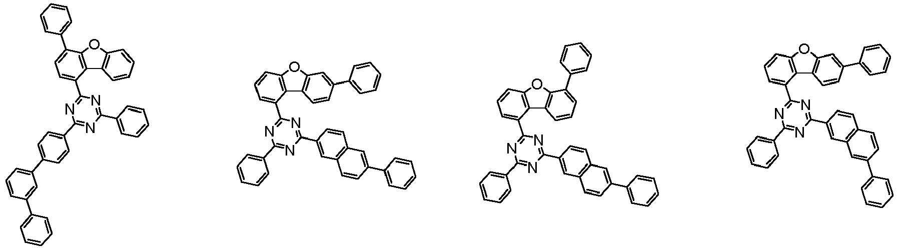

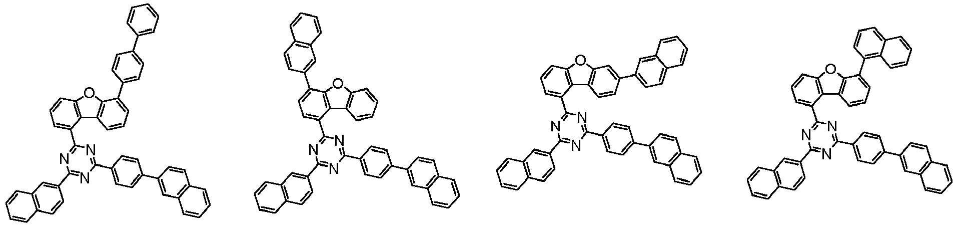

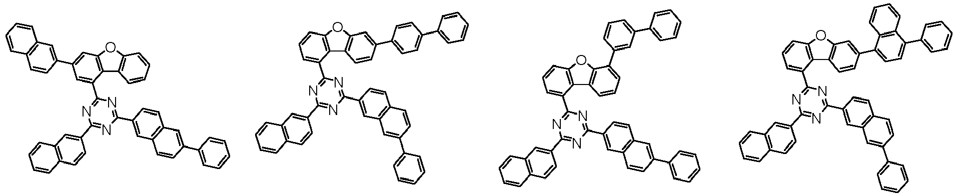

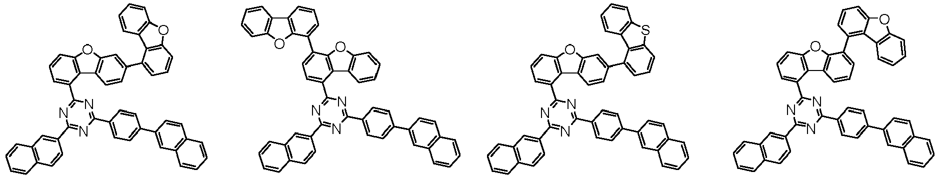

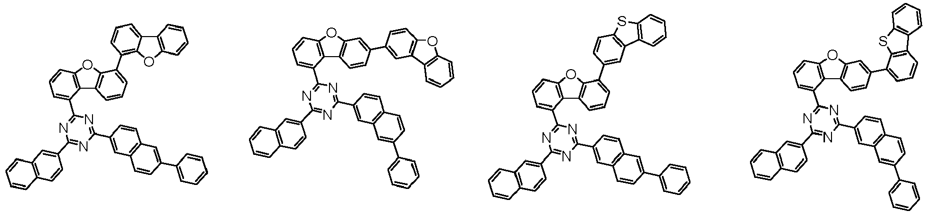

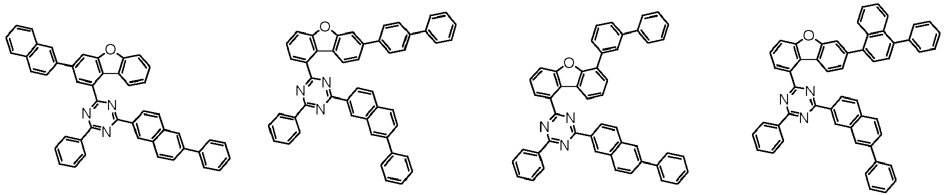

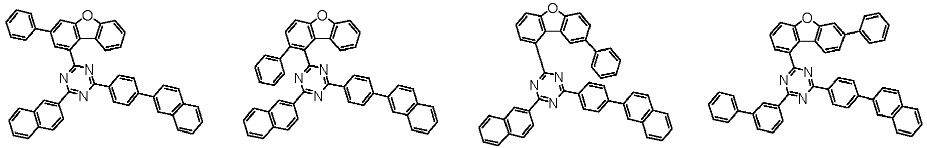

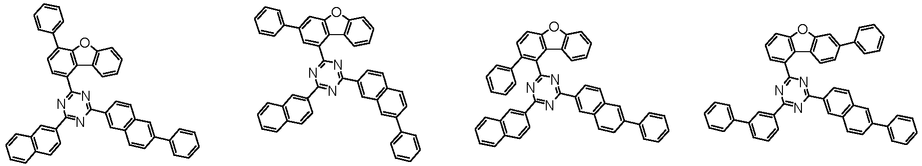

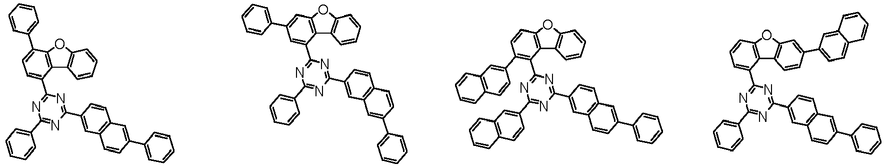

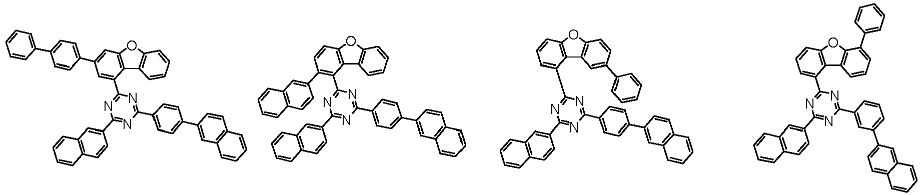

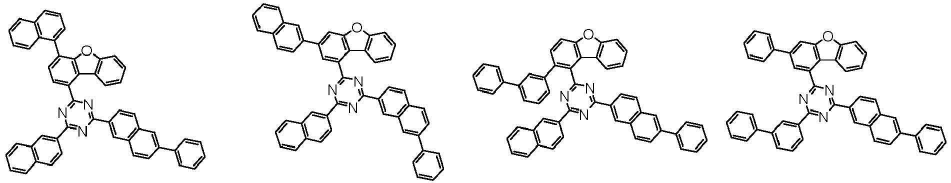

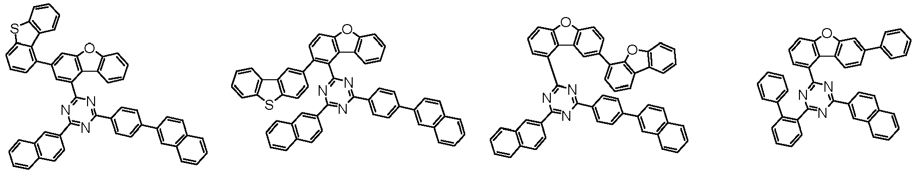

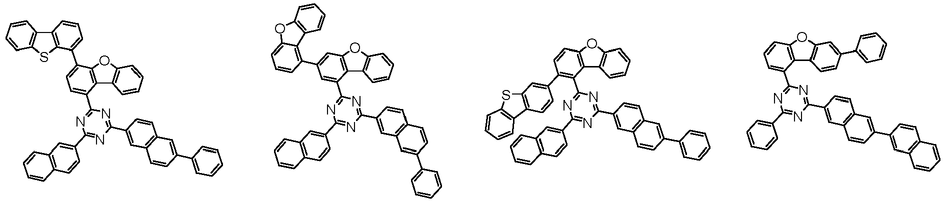

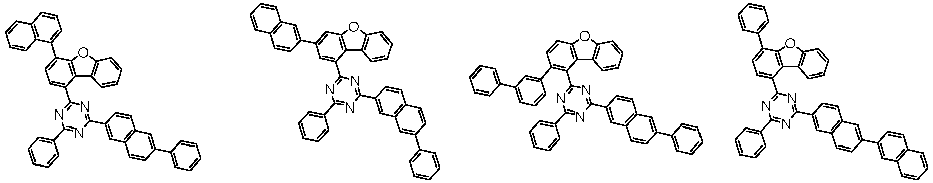

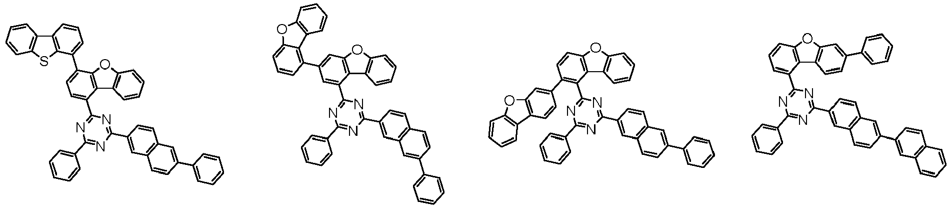

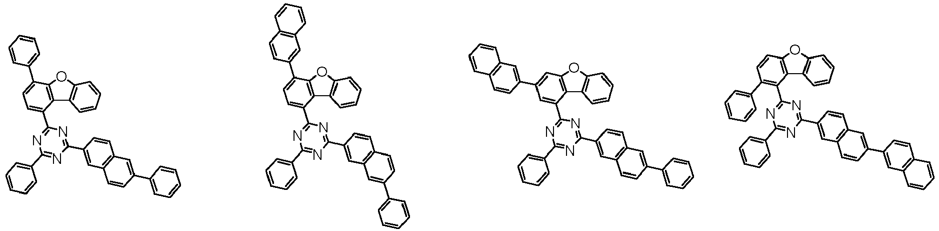

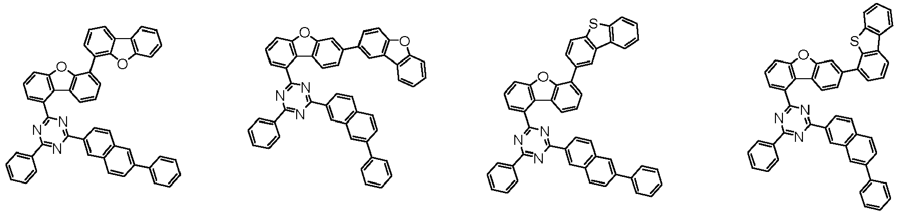

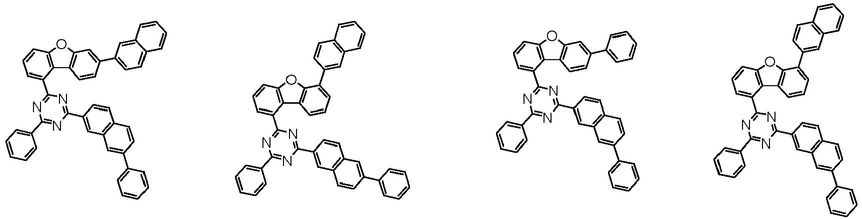

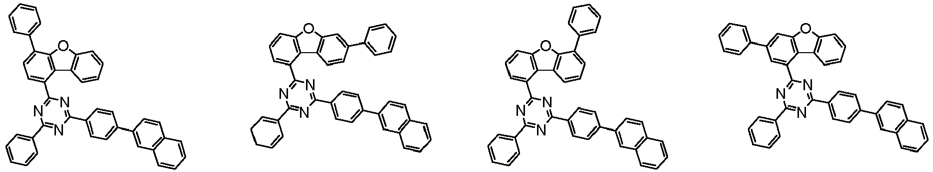

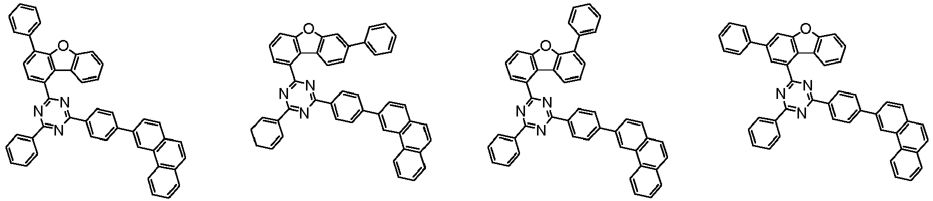

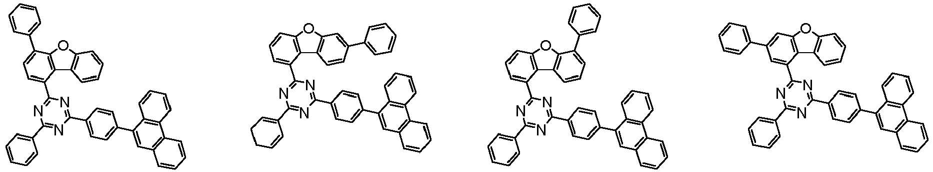

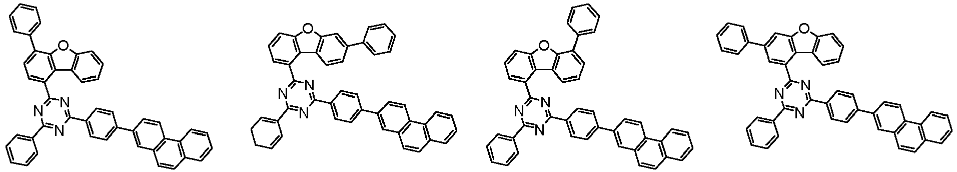

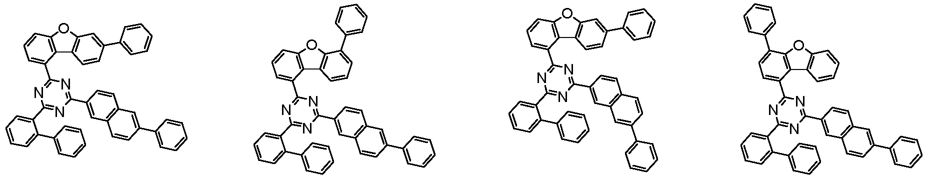

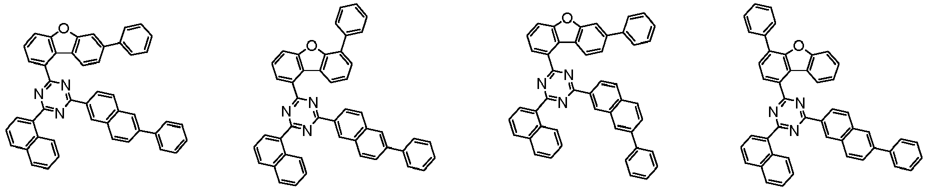

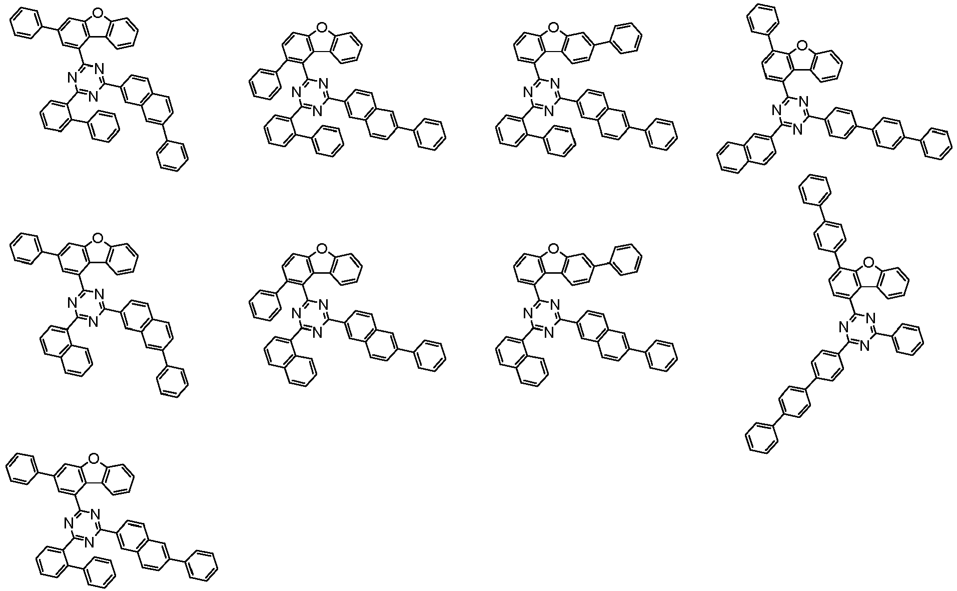

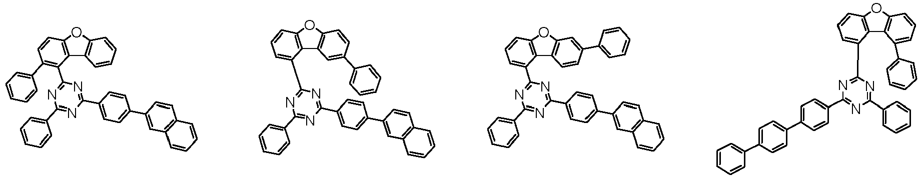

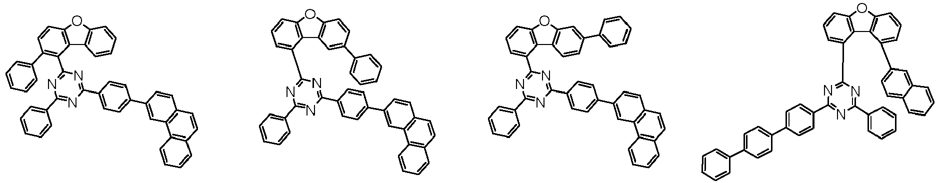

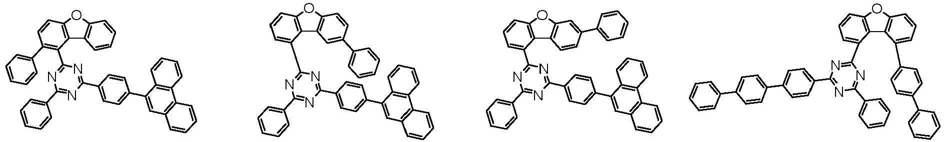

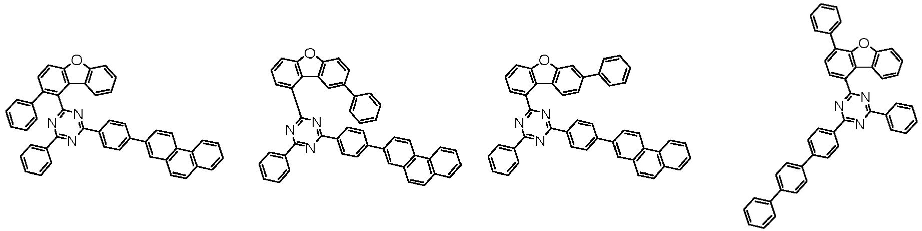

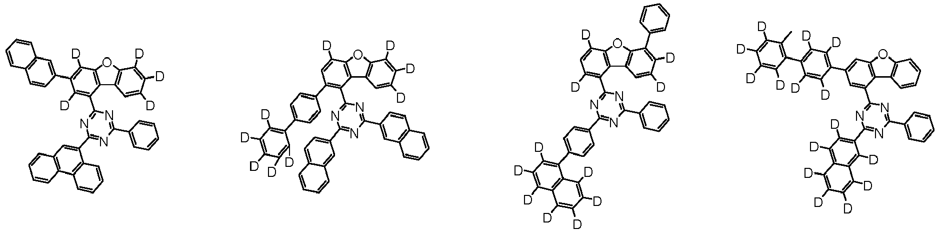

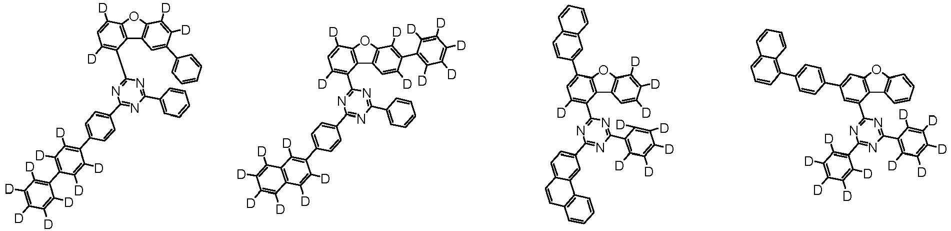

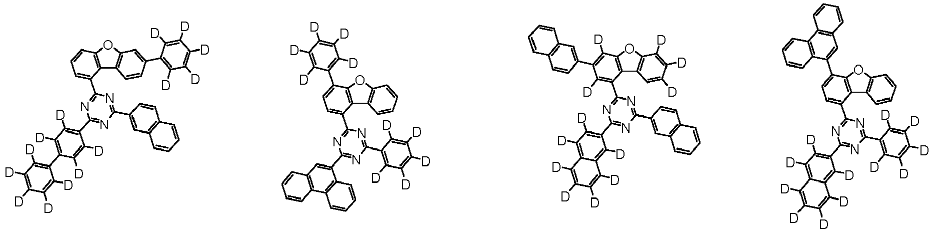

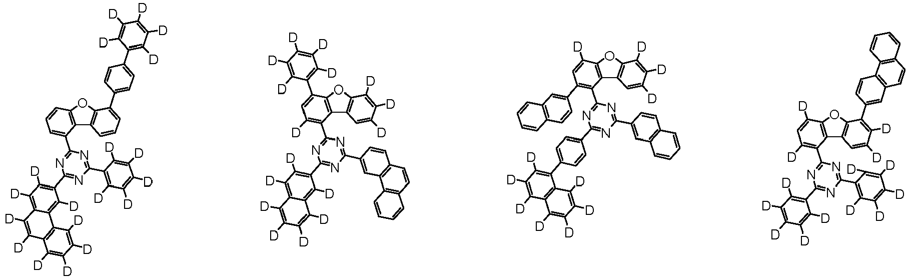

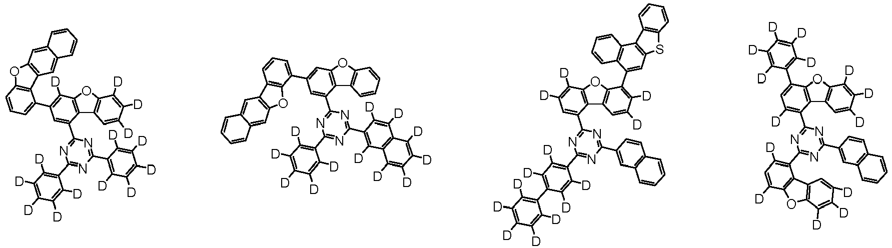

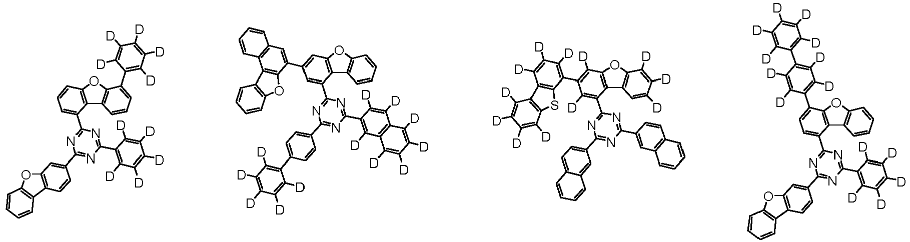

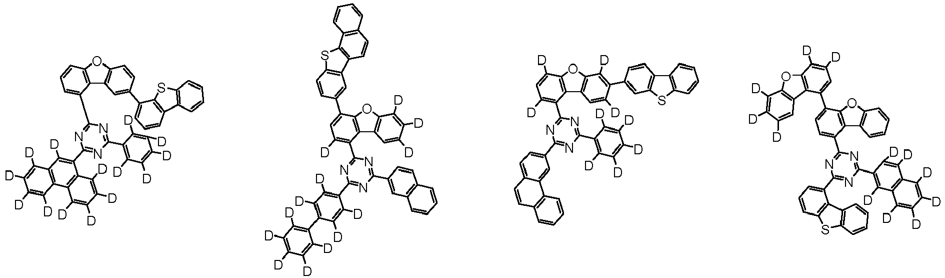

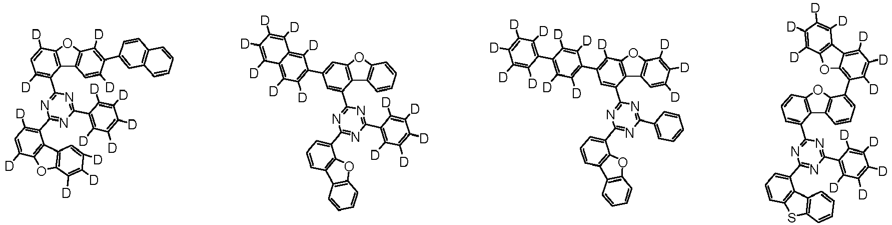

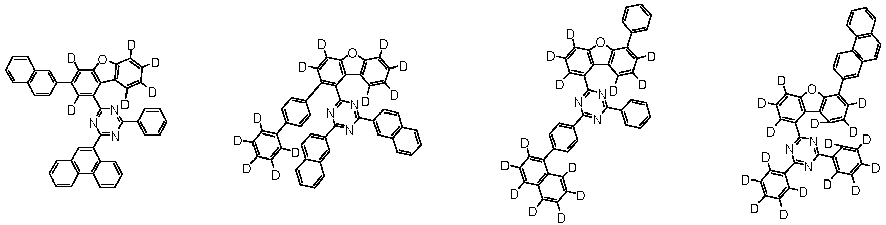

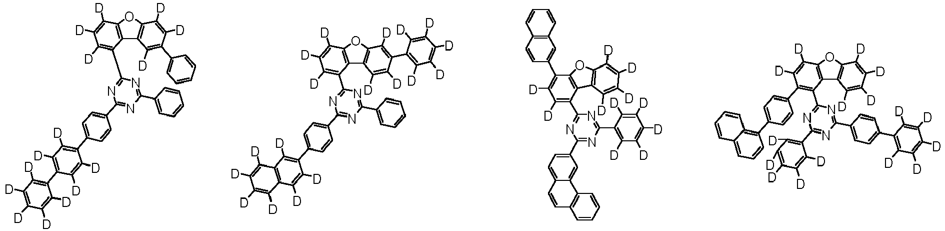

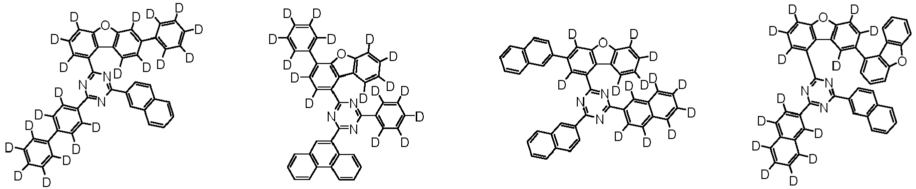

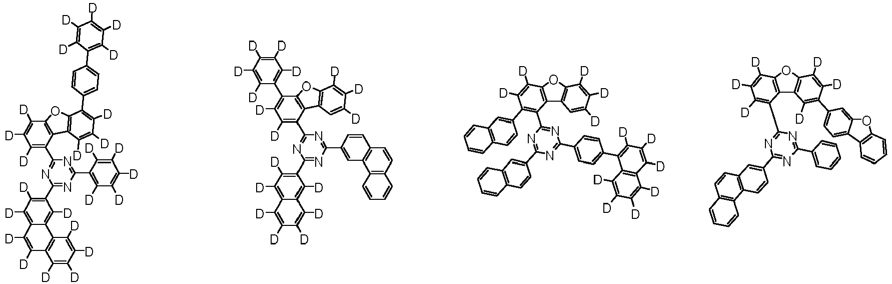

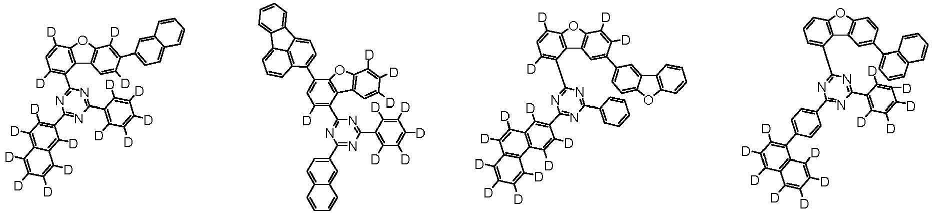

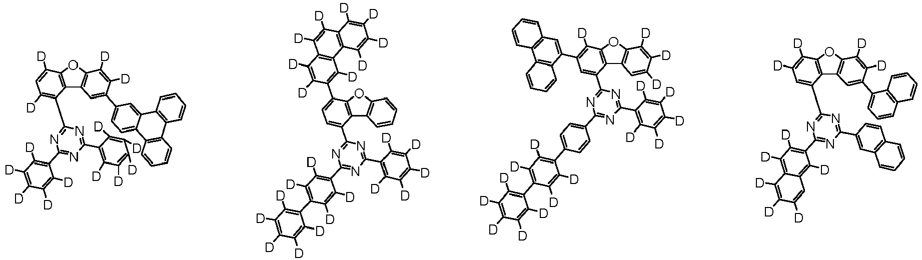

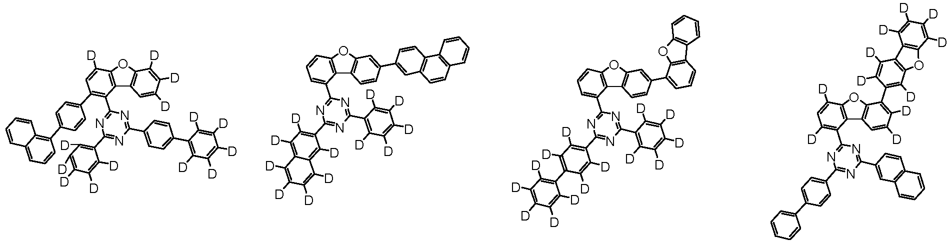

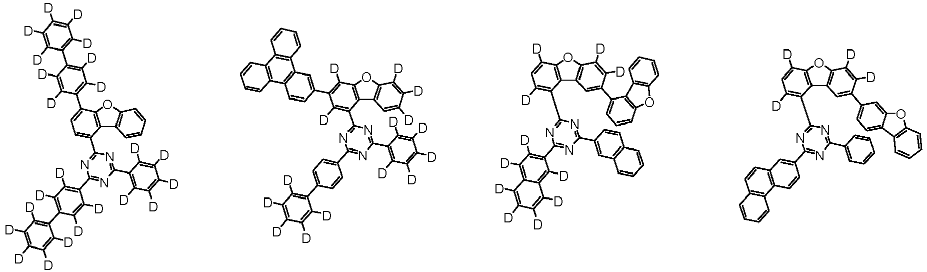

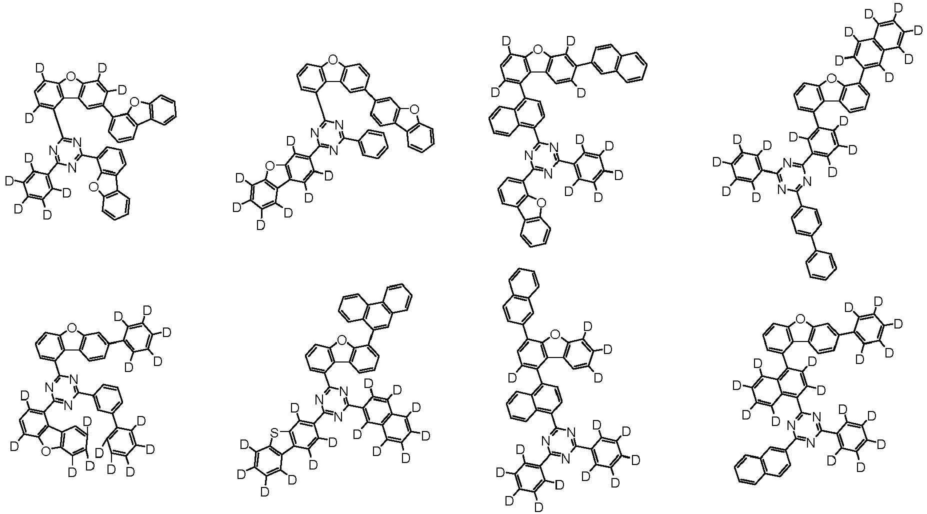

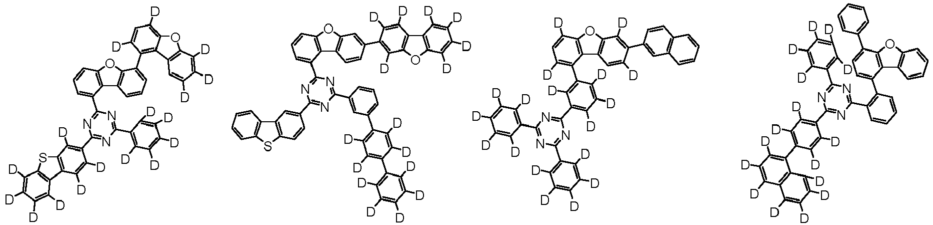

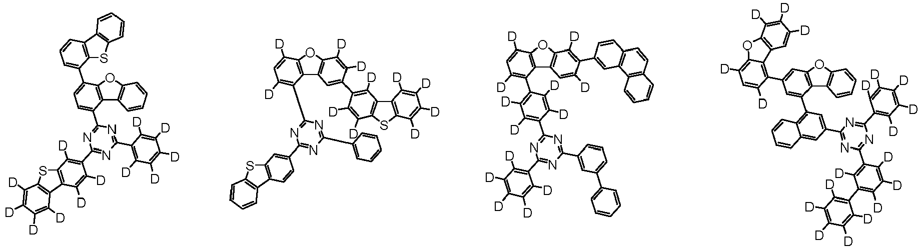

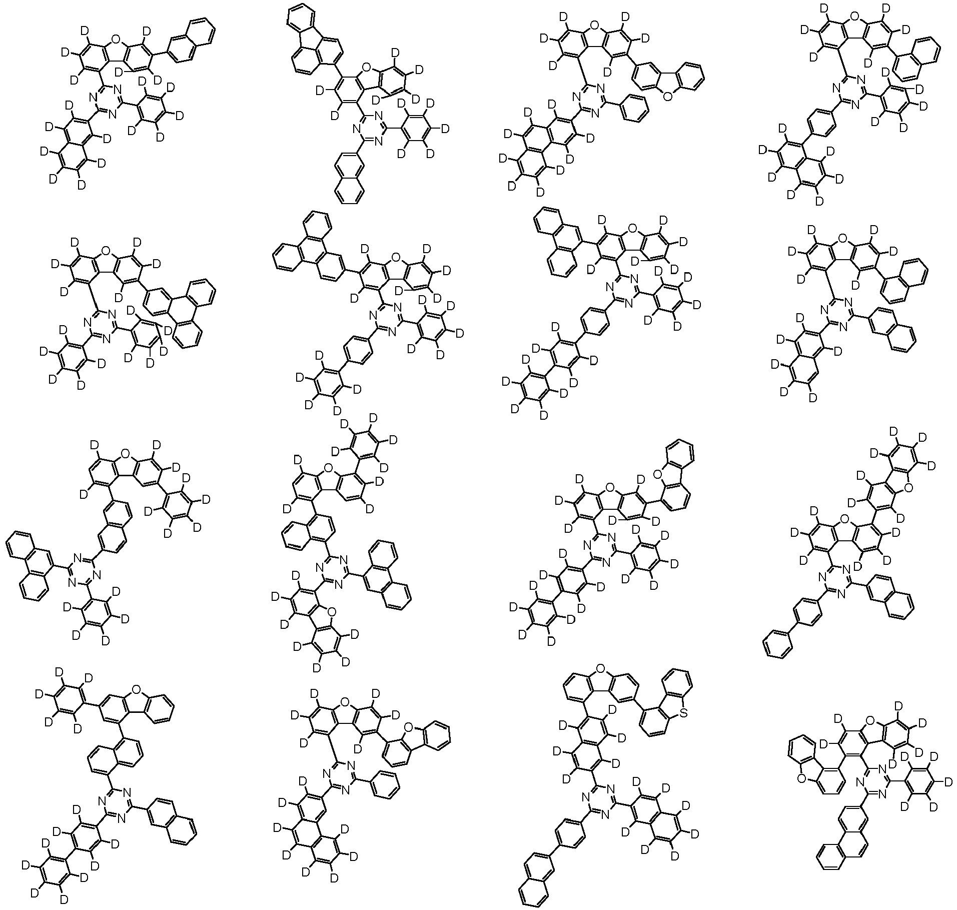

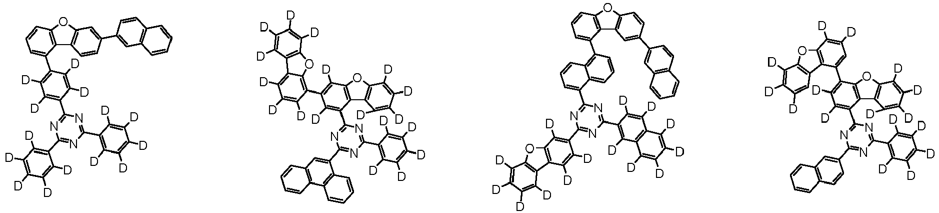

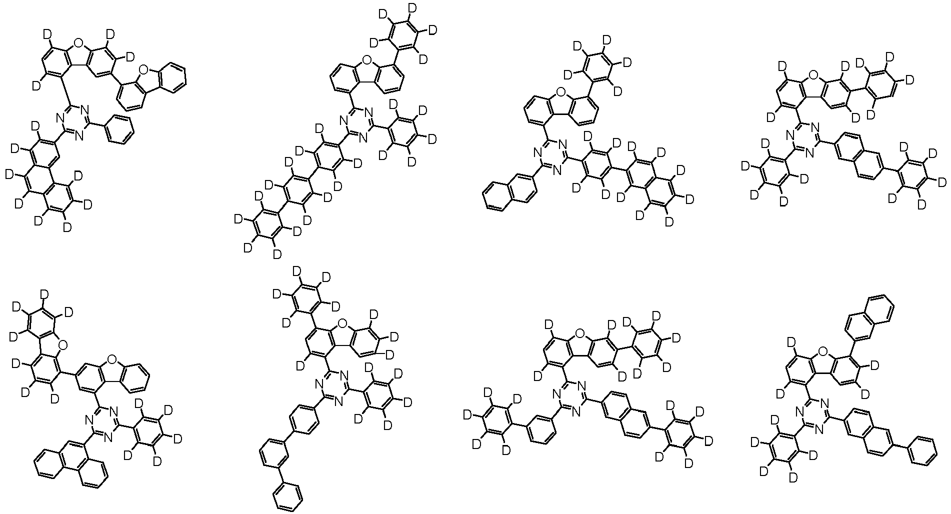

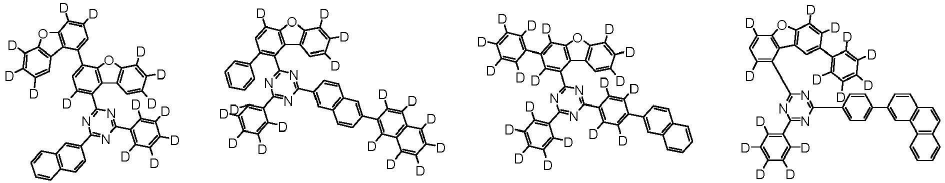

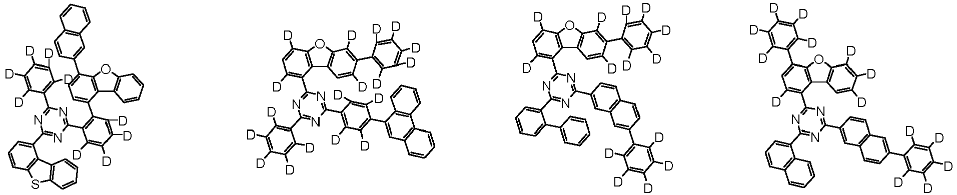

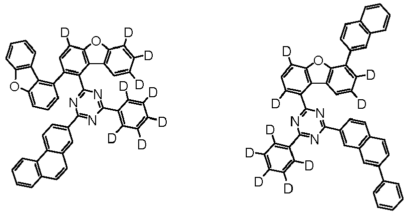

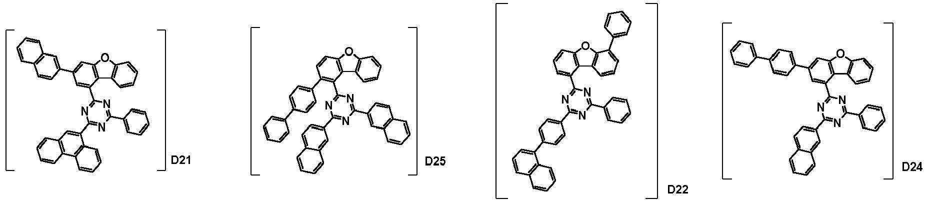

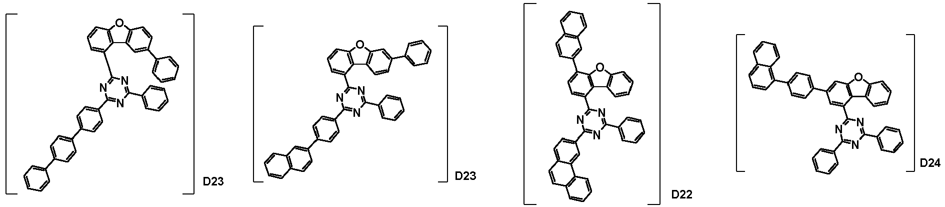

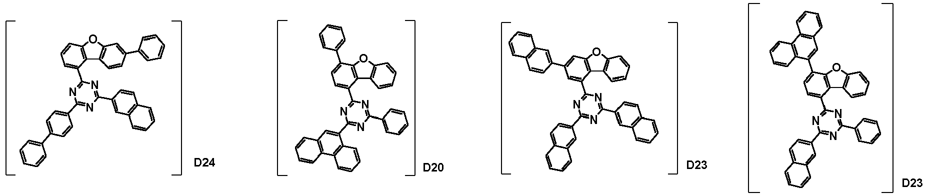

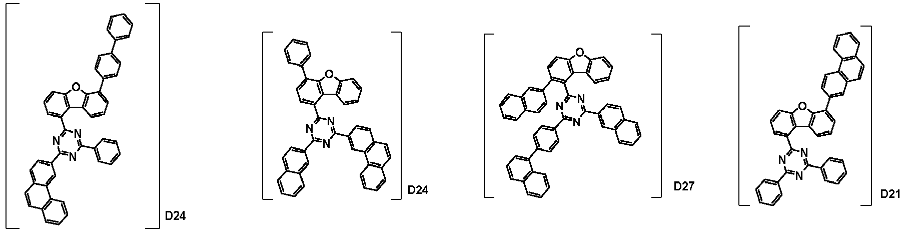

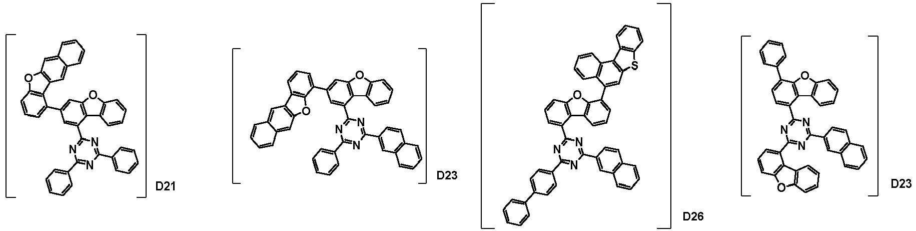

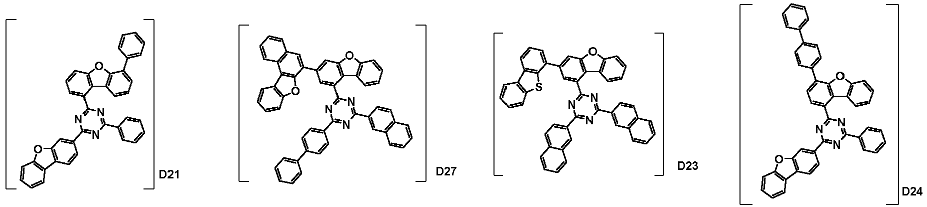

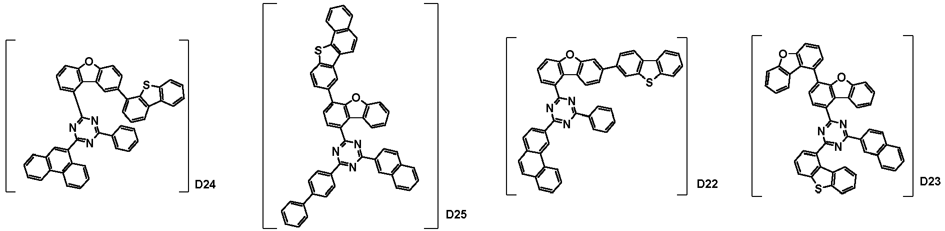

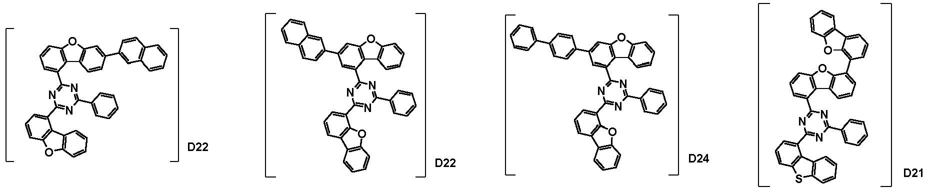

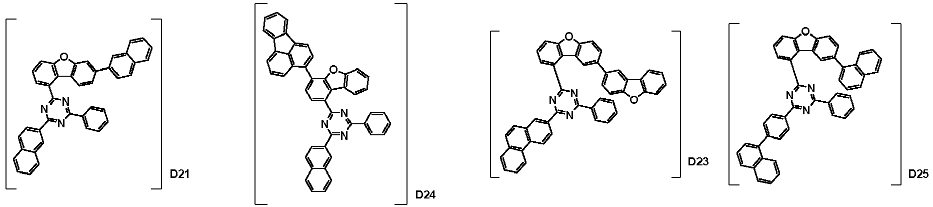

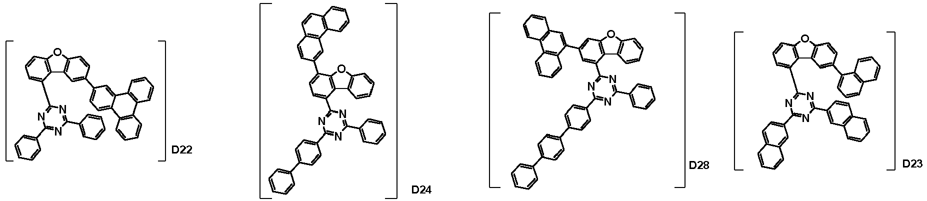

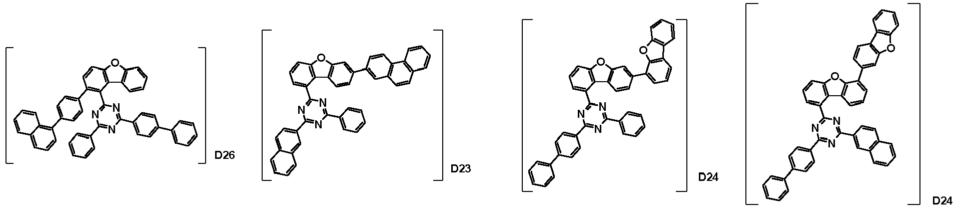

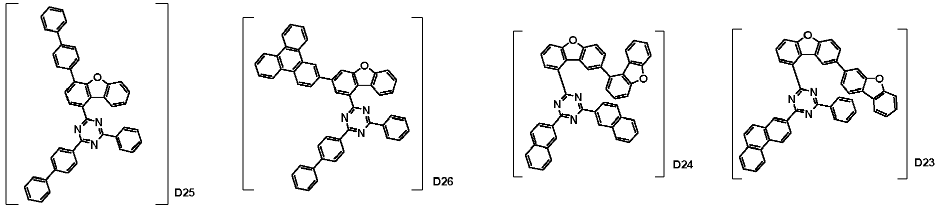

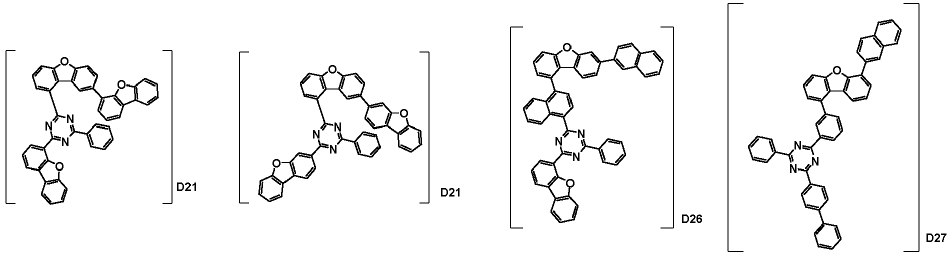

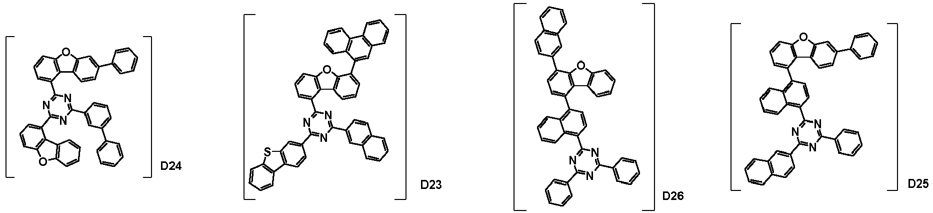

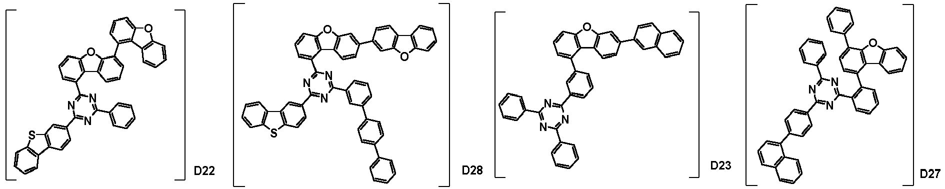

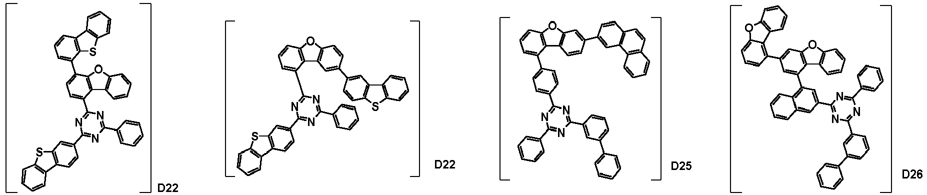

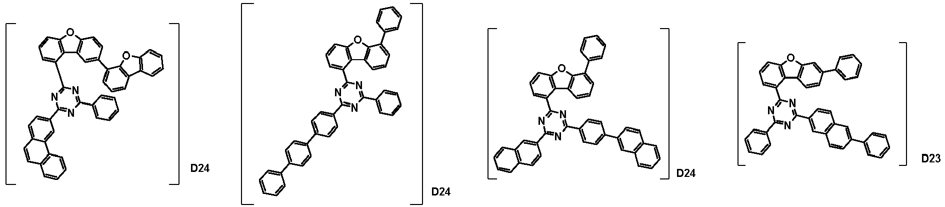

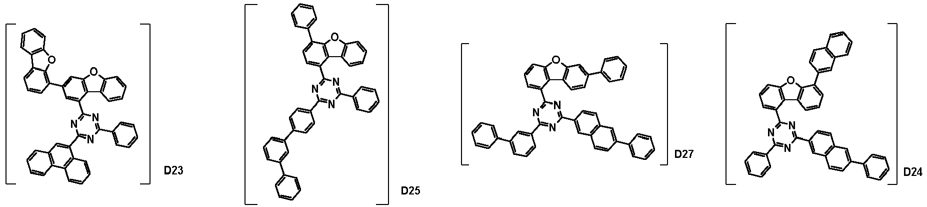

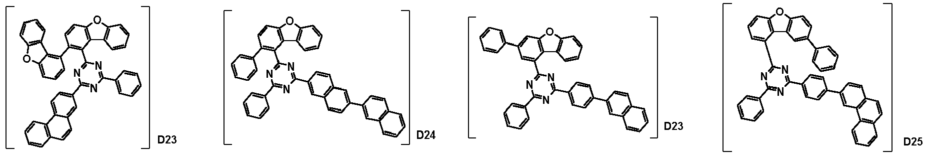

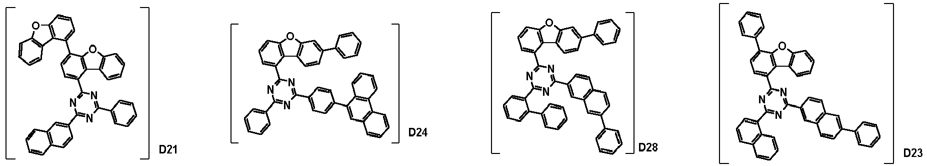

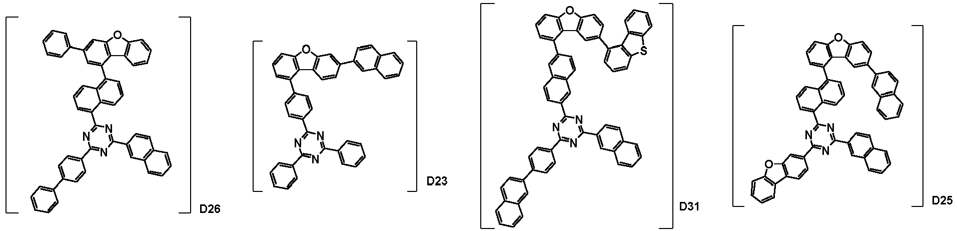

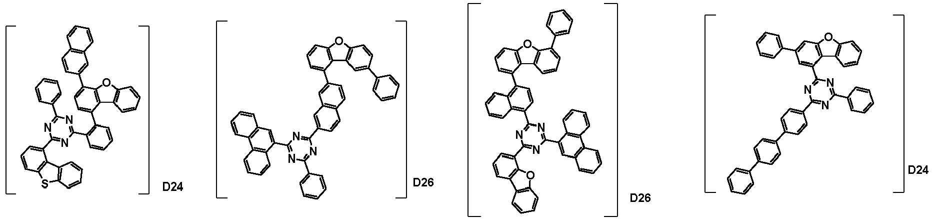

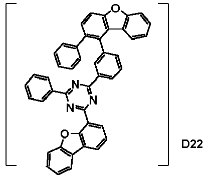

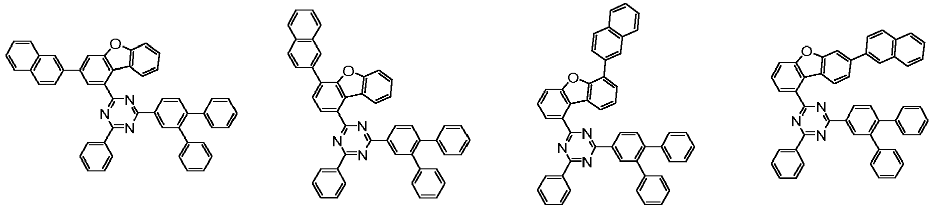

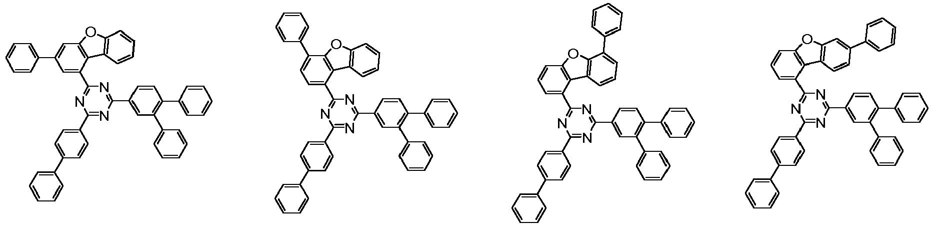

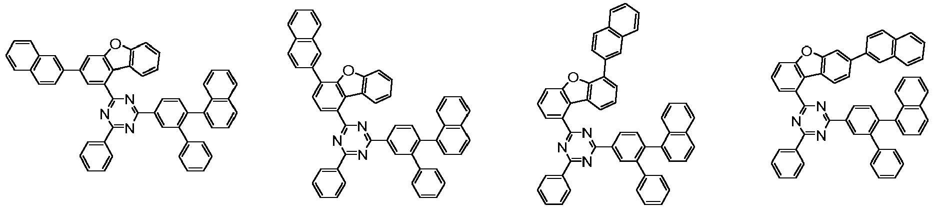

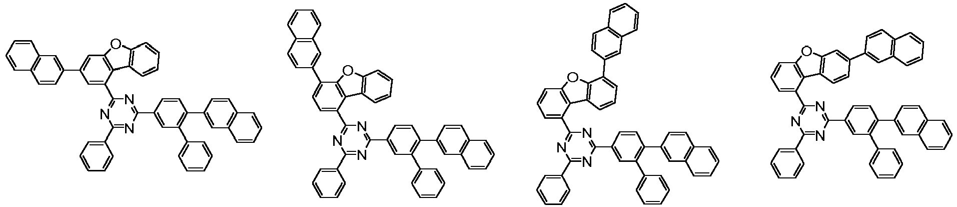

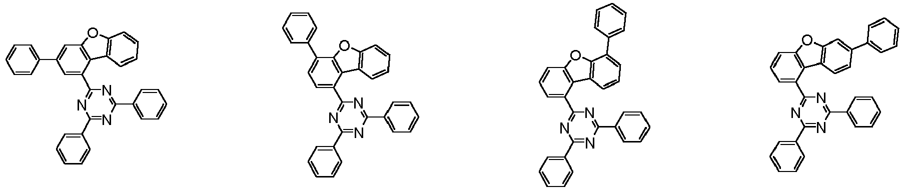

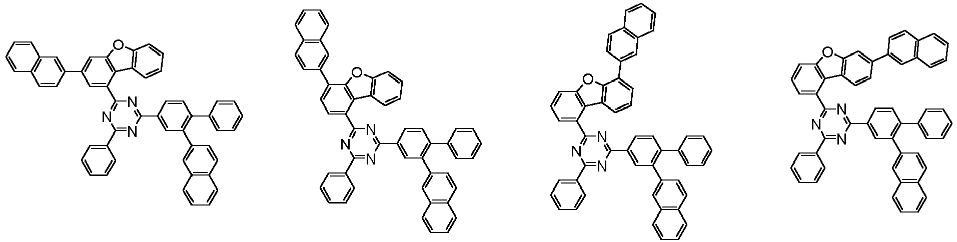

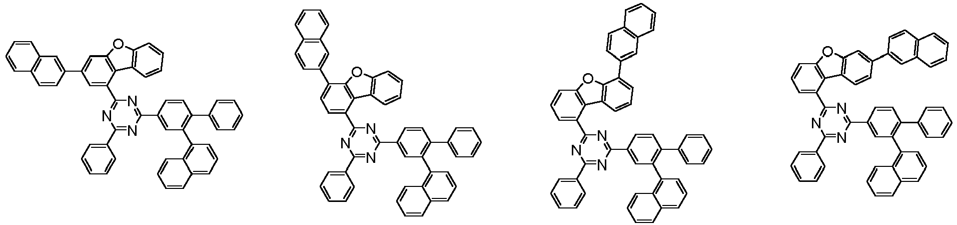

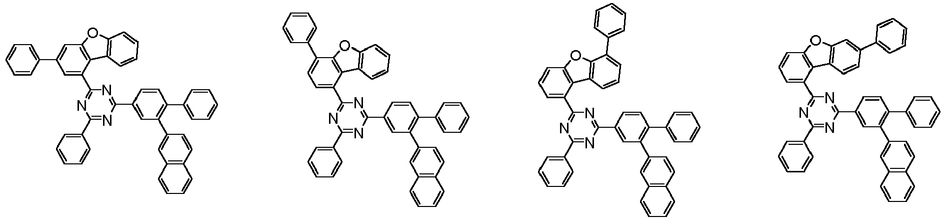

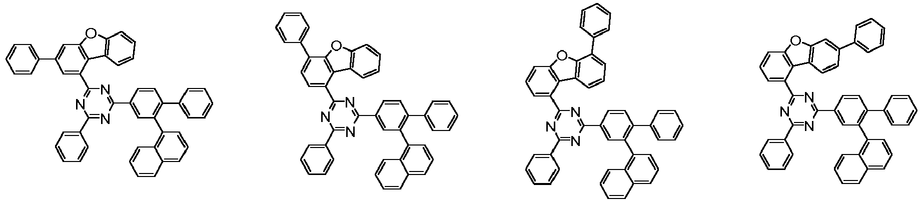

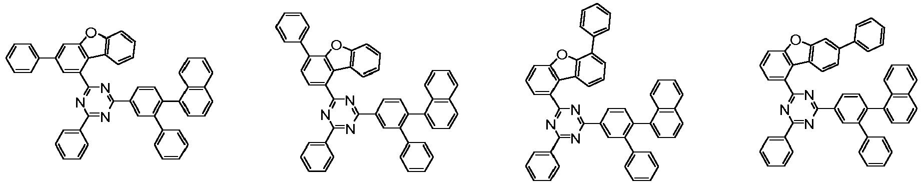

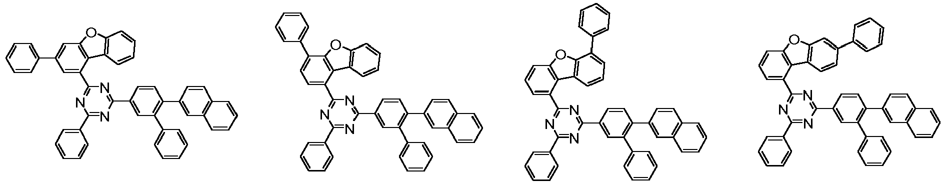

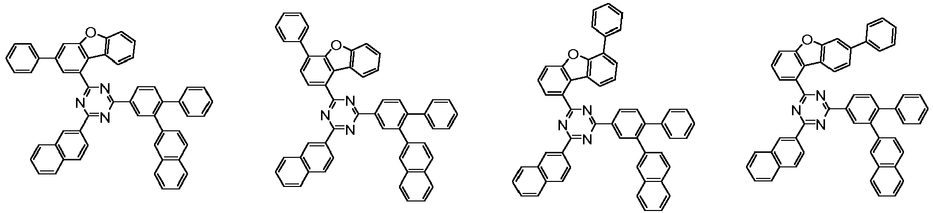

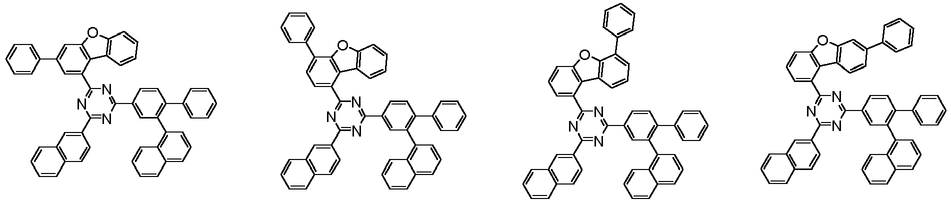

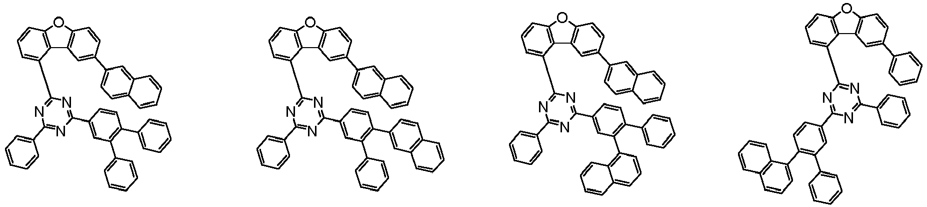

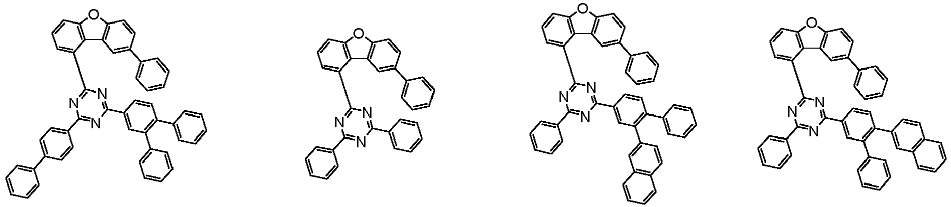

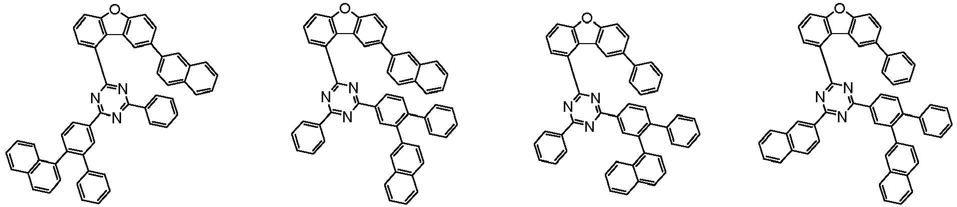

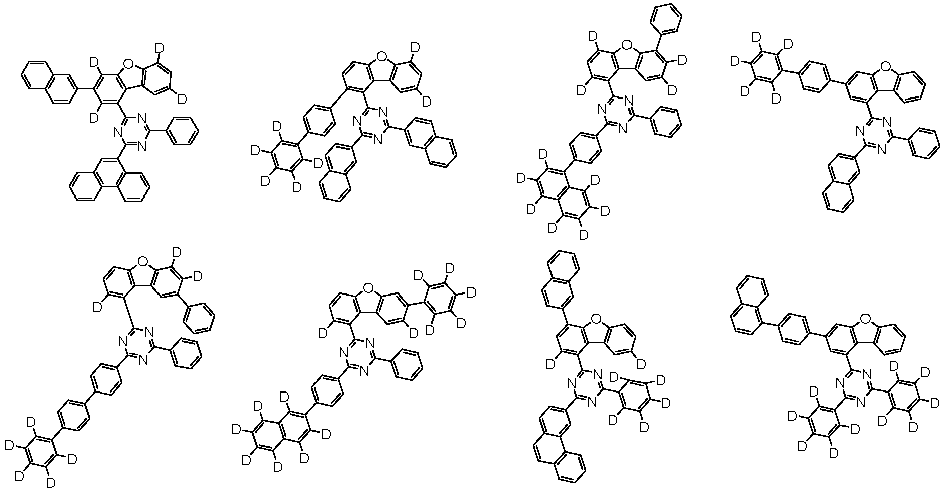

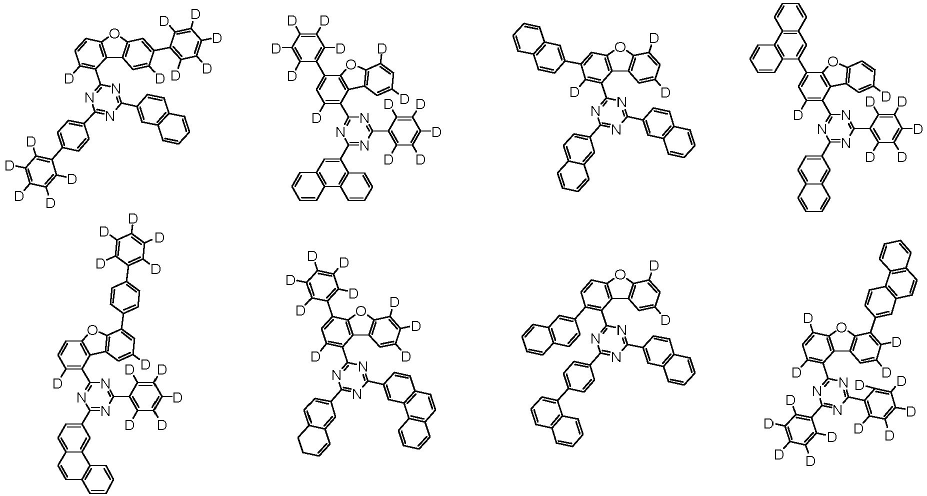

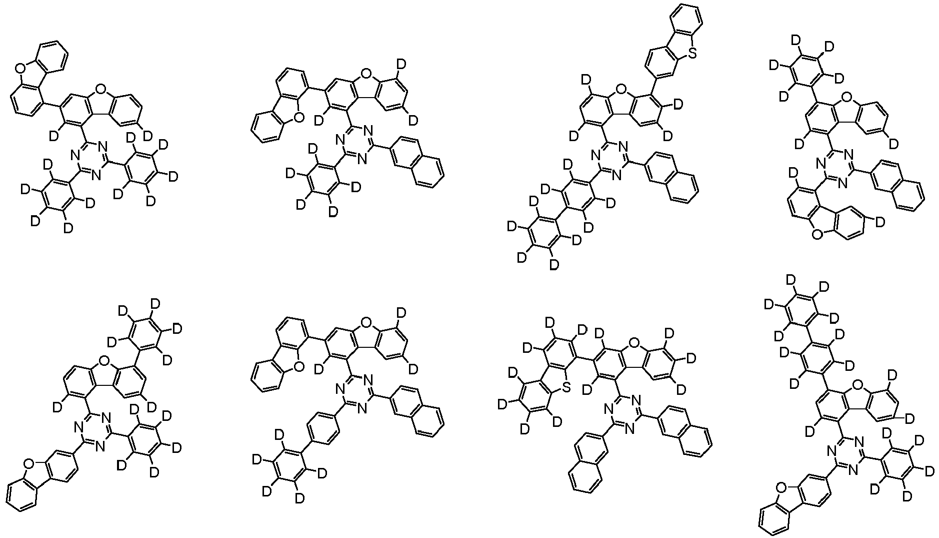

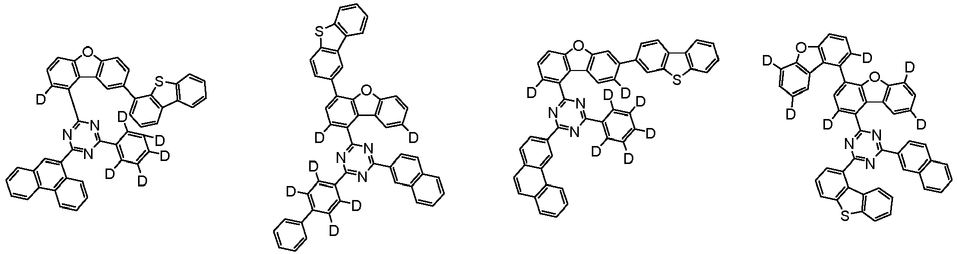

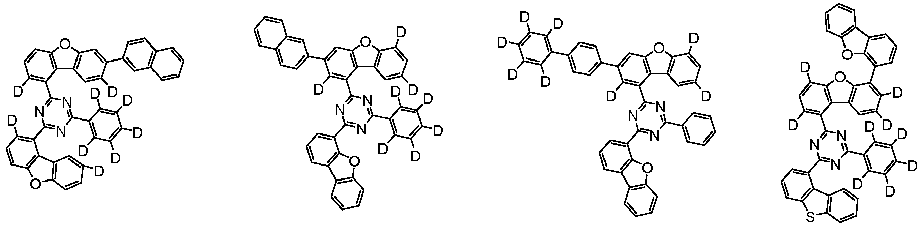

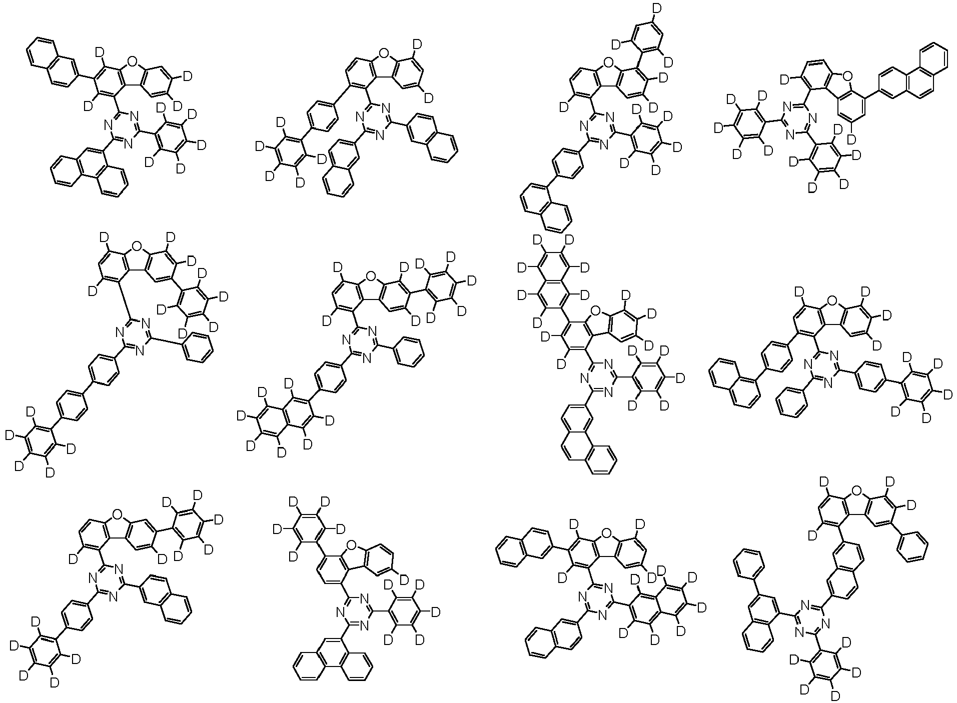

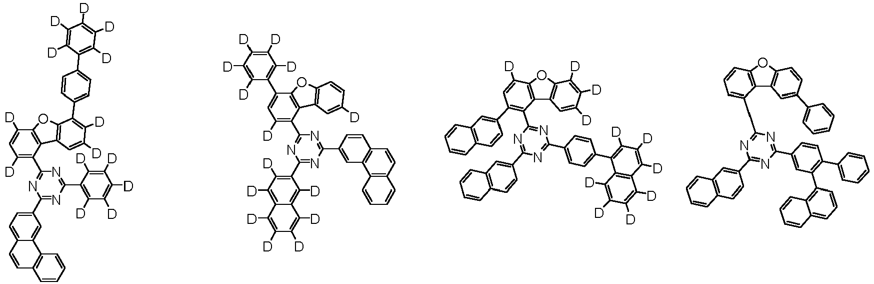

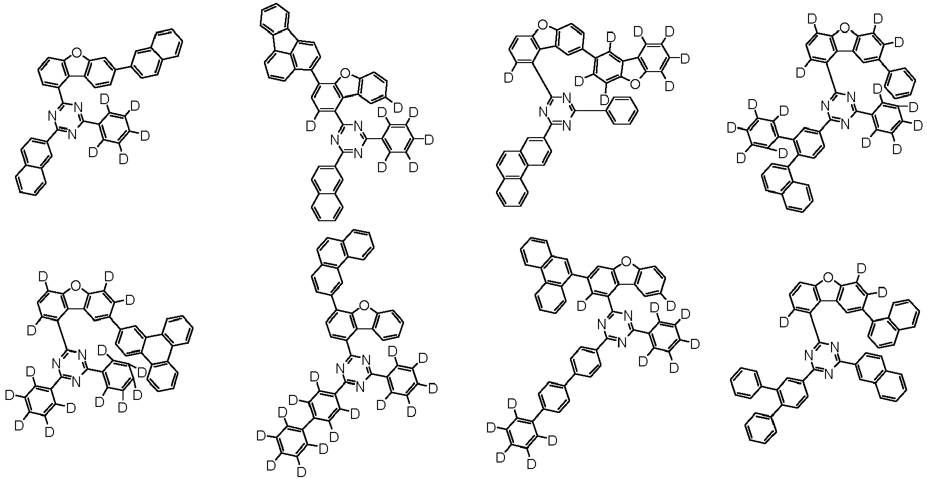

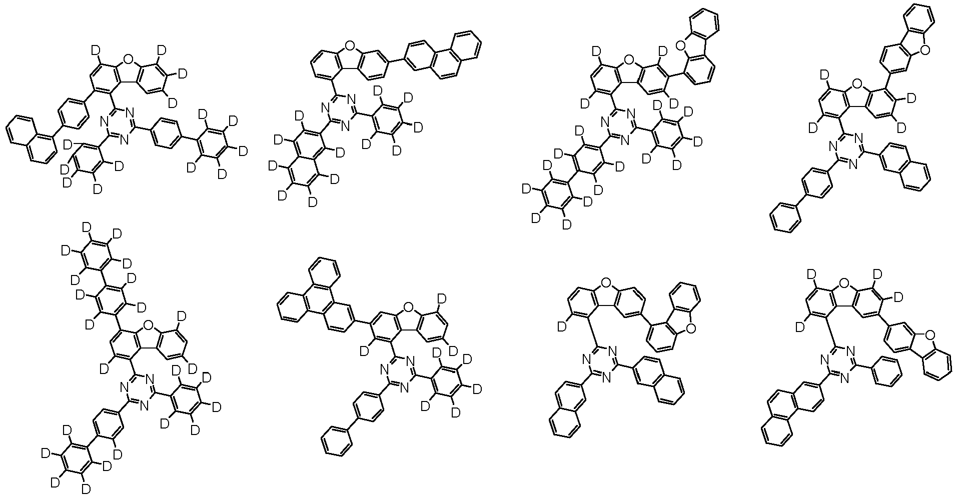

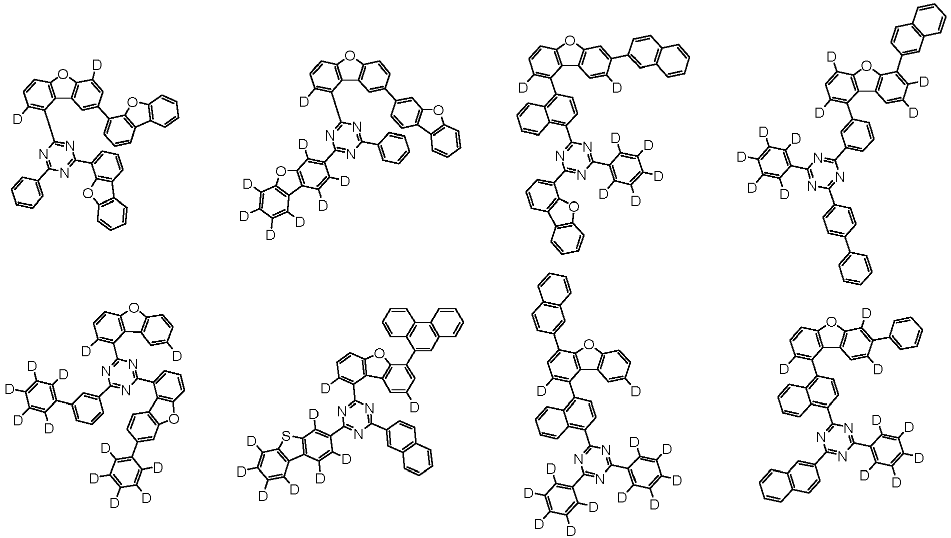

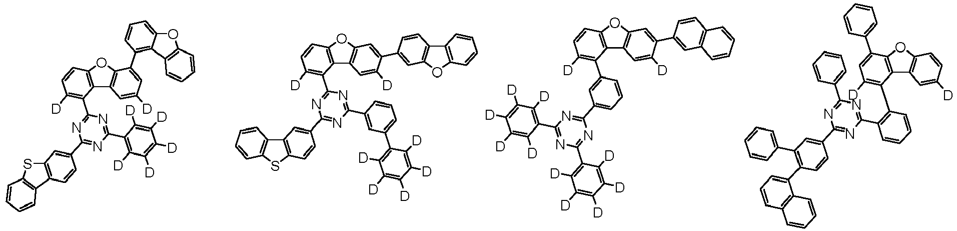

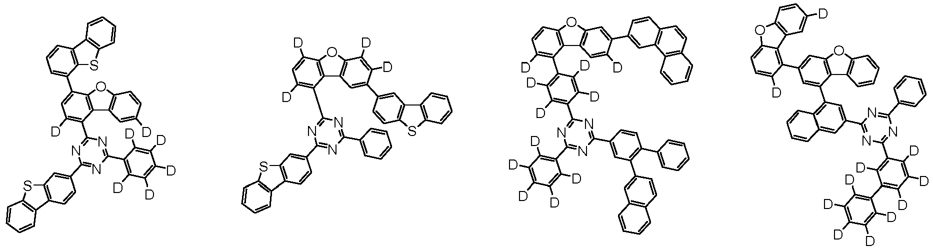

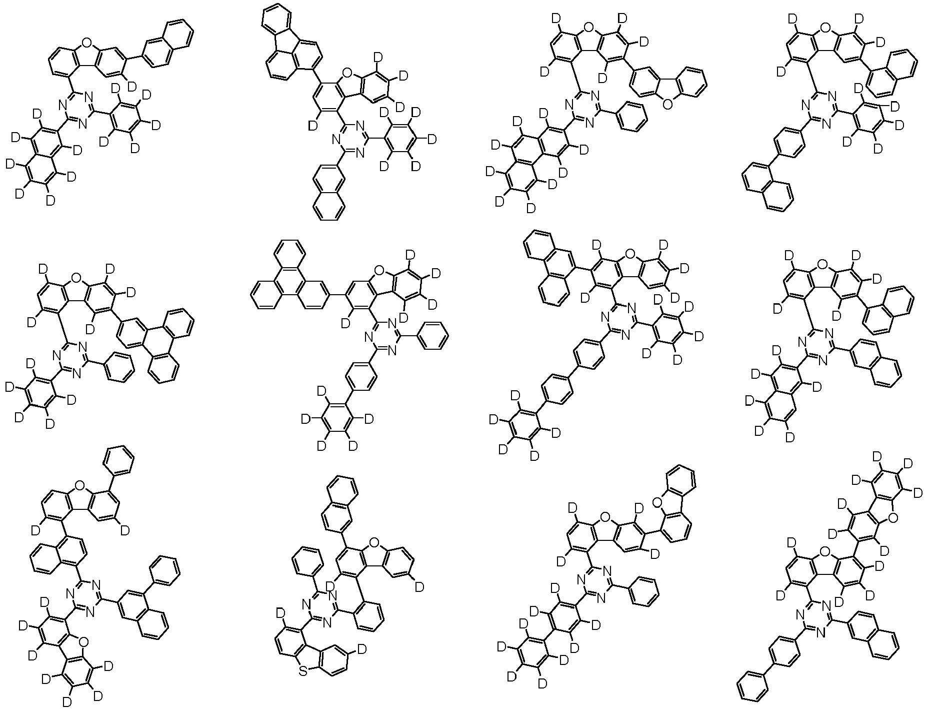

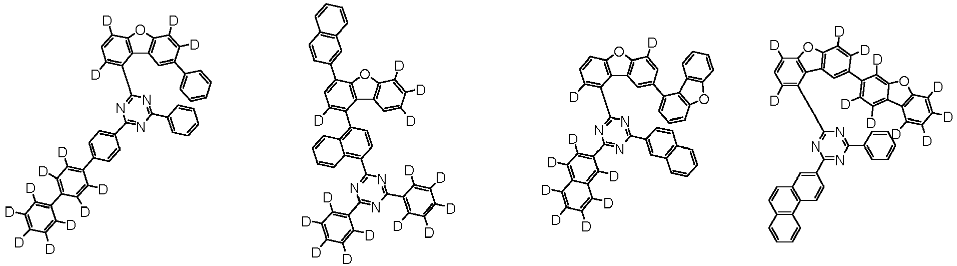

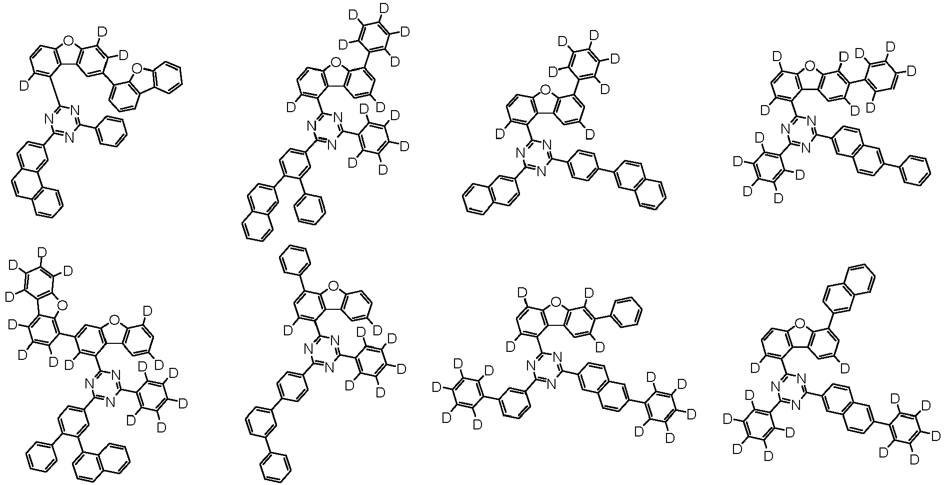

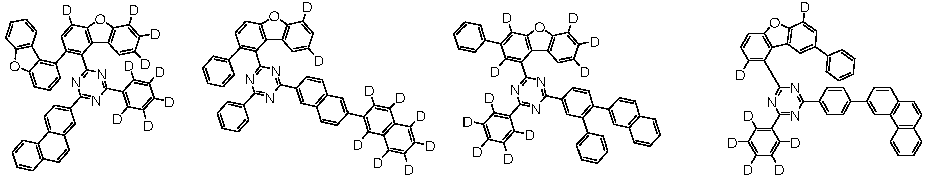

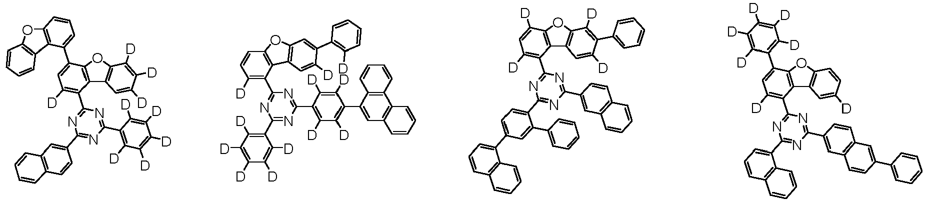

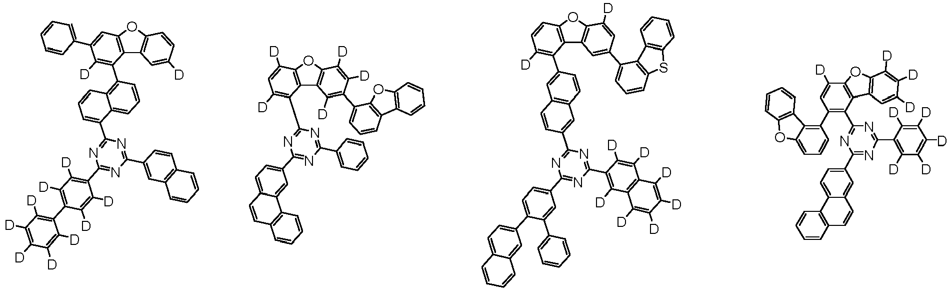

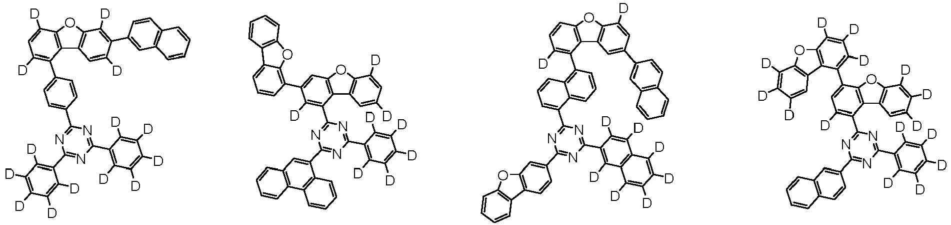

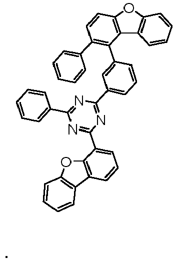

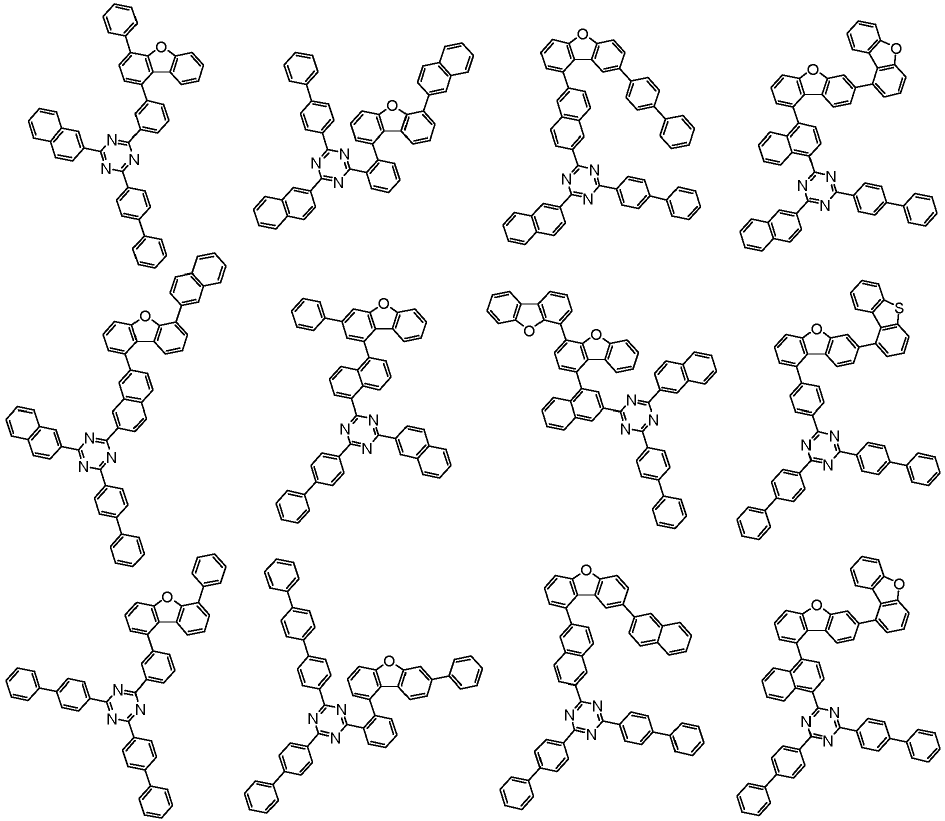

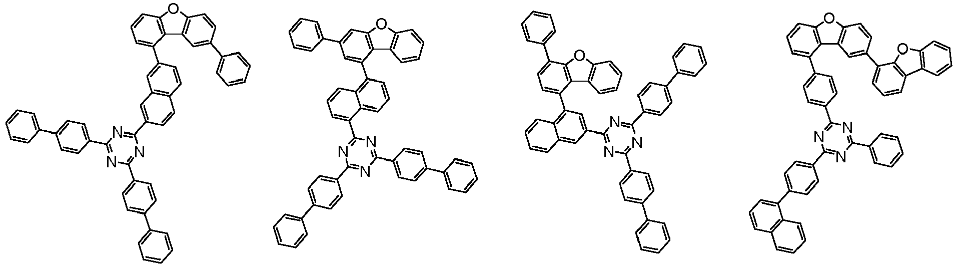

7. The organic light emitting device according to claim 1, wherein
Ar₃ and Ar₄ are each independently phenyl, triphenylsilyl phenyl, biphenylyl, terphenylyl, naphthyl, phenyl naphthyl, phenanthrenyl, dibenzofuranyl, dibenzothiophenyl, phenyl carbazolyl, or dimethylfluorenyl, and
the hydrogens of the Ar₃ and Ar₄ are each independently unsubstituted or substituted with deuterium.

8. The organic light emitting device according to claim 1, wherein
L₄ is phenylene, biphenyldiyl, biphenyldiyl substituted with phenyl, or naphthalenediyl, and
the hydrogens of the L₄ are each independently unsubstituted or substituted with deuterium.

9. The organic light emitting device according to claim 1, wherein
L₅ and L₆ are each independently a single bond, phenylene, biphenyldiyl, naphthalenediyl, or carbazolediyl, and
the hydrogens of the L₅ and L₆ are each independently unsubstituted or substituted with deuterium.

10. The organic light emitting device according to claim 1, wherein
the compound represented by Chemical Formula 2 is any one selected from the group consisting of:
